# EUROPEAN PATENT SPECIFICATION

(11) **EP 4 174 078 B1**
(45) Date of publication and mention of the grant of the patent: **04.12.2024**
(21) Application number: 22203974.5
(22) Date of filing: 26.10.2022
(51) Int. Cl.: C07F 15/00, C09K 11/06, H10K 50/11, H10K 85/30

(54) **ELECTROLUMINESCENT MATERIAL AND DEVICE THEREOF**
ELEKTROLUMINESZENTES MATERIAL UND VORRICHTUNG DAFÜR
MATÉRIAU ÉLECTROLUMINESCENT ET DISPOSITIF ASSOCIÉ

(30) Priority: 29.10.2021 CN 202111270497; 09.09.2022 CN 202211093543
(43) Date of publication of application: 03.05.2023
(73) Proprietor: Beijing Summer Sprout Technology Co., Ltd., Beijing 102308 (CN)
(72) Inventor: ZHANG, Qi, Beijing, 102308 (CN); ZHANG, Cuifang, Beijing, 102308 (CN); LU, Nannan, Beijing, 102308 (CN); KWONG, Chi Yuen Raymond, Beijing, 102308 (CN); XIA, Chuanjun, Beijing, 102308 (CN); ZHANG, Han, Beijing, 102308 (CN); LU, Xueyu, Beijing, 102308 (CN)
(74) Representative: Ricker, Mathias

(56) References cited:
- CN-A- 110 698 518
- CN-A- 110 790 797

## Description

### TECHNICAL FIELD

The present disclosure relates to compounds for organic electronic devices such as organic light-emitting devices. More particularly, the present disclosure relates to a metal complex comprising a ligand having a structure of Formula 1 and an electroluminescent device and a compound combination comprising the metal complex.

### BACKGROUND

Organic electronic devices include, but are not limited to, the following types: organic light-emitting diodes (OLEDs), organic field-effect transistors (O-FETs), organic light-emitting transistors (OLETs), organic photovoltaic devices (OPVs), dye-sensitized solar cells (DSSCs), organic optical detectors, organic photoreceptors, organic field-quench devices (OFQDs), light-emitting electrochemical cells (LECs), organic laser diodes and organic plasmon emitting devices.

In 1987, Tang and Van Slyke of Eastman Kodak reported a bilayer organic electroluminescent device, which comprises an arylamine hole transporting layer and a tris-8-hydroxyquinolato-aluminum layer as the electron and emitting layer (Applied Physics Letters, 1987, 51 (12): 913-915). Once a bias is applied to the device, green light was emitted from the device. This device laid the foundation for the development of modern organic light-emitting diodes (OLEDs). State-of-the-art OLEDs may comprise multiple layers such as charge injection and transporting layers, charge and exciton blocking layers, and one or multiple emissive layers between the cathode and anode. Since the OLED is a self-emitting solid state device, it offers tremendous potential for display and lighting applications. In addition, the inherent properties of organic materials, such as their flexibility, may make them well suited for particular applications such as fabrication on flexible substrates.

The OLED can be categorized as three different types according to its emitting mechanism. The OLED invented by Tang and van Slyke is a fluorescent OLED. It only utilizes singlet emission. The triplets generated in the device are wasted through nonradiative decay channels. Therefore, the internal quantum efficiency (IQE) of the fluorescent OLED is only 25%. This limitation hindered the commercialization of OLED. In 1997, Forrest and Thompson reported phosphorescent OLED, which uses triplet emission from heavy metal containing complexes as the emitter. As a result, both singlet and triplets can be harvested, achieving 100% IQE. The discovery and development of phosphorescent OLED contributed directly to the commercialization of active-matrix OLED (AMOLED) due to its high efficiency. Recently, Adachi achieved high efficiency through thermally activated delayed fluorescence (TADF) of organic compounds. These emitters have small singlet-triplet gap that makes the transition from triplet back to singlet possible. In the TADF device, the triplet excitons can go through reverse intersystem crossing to generate singlet excitons, resulting in high IQE.

OLEDs can also be classified as small molecule and polymer OLEDs according to the forms of the materials used. A small molecule refers to any organic or organometallic material that is not a polymer. The molecular weight of the small molecule can be large as long as it has well defined structure. Dendrimers with well-defined structures are considered as small molecules. Polymer OLEDs include conjugated polymers and non-conjugated polymers with pendant emitting groups. Small molecule OLED can become the polymer OLED if post polymerization occurred during the fabrication process.

There are various methods for OLED fabrication. Small molecule OLEDs are generally fabricated by vacuum thermal evaporation. Polymer OLEDs are fabricated by solution process such as spin-coating, inkjet printing, and slit printing. If the material can be dissolved or dispersed in a solvent, the small molecule OLED can also be produced by solution process.

The emitting color of the OLED can be achieved by emitter structural design. An OLED may comprise one emitting layer or a plurality of emitting layers to achieve desired spectrum. In the case of green, yellow, and red OLEDs, phosphorescent emitters have successfully reached commercialization. Blue phosphorescent device still suffers from non-saturated blue color, short device lifetime, and high operating voltage. Commercial full-color OLED displays normally adopt a hybrid strategy, using fluorescent blue and phosphorescent yellow, or red and green. At present, efficiency roll-off of phosphorescent OLEDs at high brightness remains a problem. In addition, it is desirable to have more saturated emitting color, higher efficiency, and longer device lifetime.

CN 110 790 797 A discloses an organic phosphorus luminescent material of general formula (I) as shown below: 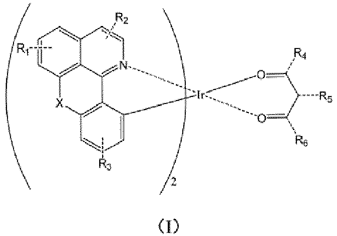 wherein R₁, R₂, R₃, R₄, R₅ and R₆ each are selected from hydrogen, deuterium, halogen, cyano, nitro, hydroxyl, amino, sulfonic acid group, sulfonyl, phosphoryl, substituted or unsubstituted C1-C60 alkyl, substituted or unsubstituted C6-C60 aryl, substituted or unsubstituted C3-C30 cycloalkyl, substituted or unsubstituted C1-C60 alkoxy, substituted or unsubstituted C1-C60 alkylamino, substituted or unsubstituted C2-C60 alkenyl, substituted or unsubstituted C2-C60 alkynyl, substituted or unsubstituted C5-C60 heterocyclic group, substituted or unsubstituted C10-C60 fused ring group, substituted or unsubstituted C5-C60 spirocyclic group; and X is O or S.

CN 110 698 518 A discloses an organic phosphorus light-emitting material and a preparation method thereof, wherein the organic phosphorus light-emitting material has a structural general formula as follows: 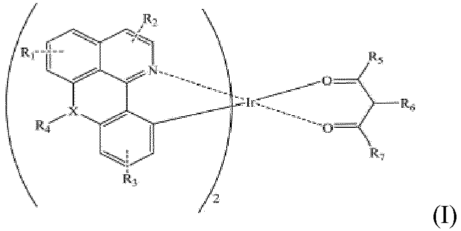 in the formula I, R₁, R₂, R₃, R₄, R₅, R₆ and R₇ are selected from a hydrogen atom, a deuterium atom, halogen, cyano, nitro, hydroxyl, amino, sulfonic acid group, sulfonyl, phosphoryl, substituted or unsubstituted C1-C60 alkyl, substituted or unsubstituted C6-C60 aryl, substituted or unsubstituted C3-C30 cycloalkyl, substituted or unsubstituted C1-C60 alkoxy, substituted or unsubstituted C1-C60 alkylamino, substituted or unsubstituted C2-C60 alkenyl, substituted or unsubstituted C2-C60 alkynyl, substituted or unsubstituted C5-C60 heterocyclic group, substituted or unsubstituted C10-C60 fused ring group, and substituted or unsubstituted C5-C60 spirocyclic group, and X in the formula I is N or P.

Phosphorescent metal complexes can be used as phosphorescent doping materials of light-emitting layers and applied to the field of organic electroluminescence lighting or display. The currently developed metal complexes still have various deficiencies in performance when used in electroluminescent devices. To meet the increasing requirements of the industry such as lower voltage, higher device efficiency, an emitted color within a particular wavelength range, a more saturated emitted color, and a longer device lifetime, the research and development related to metal complexes still needs to be deepened.

### SUMMARY

The present disclosure aims to provide a series of metal complexes each comprising a ligand having a structure of Formula 1 to solve at least part of the above-mentioned problems. The metal complexes may be used as light-emitting materials in organic electroluminescent devices. These new metal complexes, while maintaining a very narrow full width at half maximum, can better adjust an emitted color of the device, achieve a deeper red light emission, enable a driving voltage of the device to be reduced or maintained at a low voltage level, and significantly improve device efficiency. This novel type of metal complex can provide better device performance.

According to an embodiment of the present disclosure, disclosed is a metal complex, which comprises a metal M and a ligand Lₐ coordinated to the metal M, wherein the metal M is selected from a metal with a relative atomic mass greater than 40, and the ligand Lₐ has a structure represented by Formula 1: 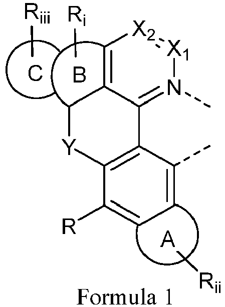
wherein the ring A and the ring B are each independently selected from a five-membered unsaturated carbocyclic ring, an aromatic ring having 6 to 30 carbon atoms or a heteroaromatic ring having 3 to 30 carbon atoms; and the ring C is selected from an aromatic ring having 6 to 30 carbon atoms or a heteroaromatic ring having 6 to 30 ring atoms;
Rᵢ and Rᵢᵢ represent, at each occurrence identically or differently, mono-substitution, multiple substitutions or non-substitution; and Rᵢᵢᵢ represents, at each occurrence identically or differently, mono-substitution or multiple substitutions;
Y is selected from SiR_{y}R_{y}, GeR_{y}R_{y}, O, S or Se;
when two R_{y} are present at the same time, the two R_{y} may be identical or different;
X₁ and X₂ are, at each occurrence identically or differently, selected from CRₓ or N;
R, Rᵢ, Rᵢᵢ, Rₓ and R_{y} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
wherein substituted alkyl, substituted cycloalkyl, substituted heteroalkyl, substituted heterocyclic group, substituted arylalkyl, substituted alkoxy, substituted aryloxy, substituted alkenyl, substituted aryl, substituted heteroaryl, substituted alkylsilyl, substituted arylsilyl, substituted alkylgermanyl, substituted arylgermanyl, and substituted amino are substituted with one or more groups selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl group having 6 to 20 carbon atoms, unsubstituted alkylgermanyl group having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof; and
adjacent substituents Rᵢ, Rₓ, R_{y}, R, Rᵢᵢ and Rᵢᵢᵢ are optionally joined to form a ring.

According to another embodiment of the present disclosure, further disclosed is an electroluminescent device, which comprises an anode, a cathode and an organic layer disposed between the anode and the cathode, wherein the organic layer comprises a metal complex, which comprises a metal M and a ligand Lₐ coordinated to the metal M, wherein the metal M is selected from a metal with a relative atomic mass greater than 40, and the ligand Lₐ has a structure represented by Formula 1: 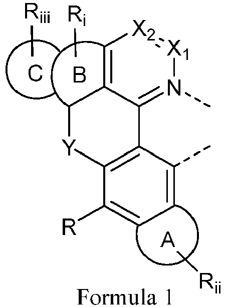
wherein the ring A and the ring B are each independently selected from a five-membered unsaturated carbocyclic ring, an aromatic ring having 6 to 30 carbon atoms or a heteroaromatic ring having 3 to 30 carbon atoms; and the ring C is selected from an aromatic ring having 6 to 30 carbon atoms or a heteroaromatic ring having 6 to 30 ring atoms;
Rᵢ and Rᵢᵢ represent, at each occurrence identically or differently, mono-substitution, multiple substitutions or non-substitution; and Rᵢᵢᵢ represents, at each occurrence identically or differently, mono-substitution or multiple substitutions;
Y is selected from SiR_{y}R_{y}, GeR_{y}R_{y}, O, S or Se;
when two R_{y} are present at the same time, the two R_{y} may be identical or different;
X₁ and X₂ are, at each occurrence identically or differently, selected from CRₓ or N;
R, Rᵢ, Rᵢᵢ, Rₓ and R_{y} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
wherein substituted alkyl, substituted cycloalkyl, substituted heteroalkyl, substituted heterocyclic group, substituted arylalkyl, substituted alkoxy, substituted aryloxy, substituted alkenyl, substituted aryl, substituted heteroaryl, substituted alkylsilyl, substituted arylsilyl, substituted alkylgermanyl, substituted arylgermanyl, and substituted amino are substituted with one or more groups selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl group having 6 to 20 carbon atoms, unsubstituted alkylgermanyl group having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof; and
adjacent substituents Rᵢ, Rₓ, R_{y}, R, Rᵢᵢ and Rᵢᵢᵢ are optionally joined to form a ring.

According to another embodiment of the present disclosure, further disclosed is a compound combination, which comprises the metal complex in the preceding embodiment.

The new metal complexes each having a polycyclic ligand, which are disclosed by the present disclosure, may be used as the light-emitting materials in the electroluminescent devices. These new metal complexes, while maintaining a very narrow full width at half maximum, can better adjust the emitted color of the device, achieve a deeper red light emission, enable the driving voltage of the device to be reduced or maintained at a low voltage level, and significantly improve the device efficiency. This new type of metal complex can provide better device performance.

### BRIEF DESCRIPTION OF DRAWINGS

FIG. 1 is a schematic diagram of an organic light-emitting apparatus that may comprise a metal complex and a compound combination disclosed herein.
FIG. 2 is a schematic diagram of another organic light-emitting apparatus that may comprise a metal complex and a compound combination disclosed herein.
FIG. 3 is a structure diagram of a typical top-emitting OLED device that may comprise a metal complex and a compound combination disclosed herein.

### DETAILED DESCRIPTION

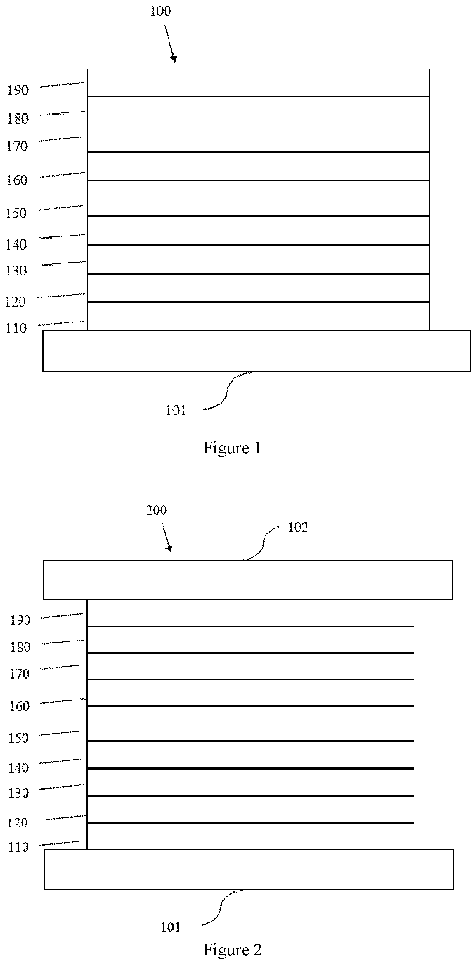

OLEDs can be fabricated on various types of substrates such as glass, plastic, and metal foil. FIG. 1 schematically shows an organic light-emitting device 100 without limitation. The figures are not necessarily drawn to scale. Some of the layers in the figures can also be omitted as needed. Device 100 may include a substrate 101, an anode 110, a hole injection layer 120, a hole transport layer 130, an electron blocking layer 140, an emissive layer 150, a hole blocking layer 160, an electron transport layer 170, an electron injection layer 180 and a cathode 190. Device 100 may be fabricated by depositing the layers described in order. The properties and functions of these various layers, as well as example materials, are described in more detail in U.S. Pat. No. 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F4-TCNQ at a molar ratio of 50:1, as disclosed in U.S. Patent Application Publication No. 2003/0230980. Examples of host materials are disclosed in U.S. Pat. No. 6,303,238 to Thompson et al.. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including composite cathodes having a thin layer of metal such as Mg:Ag with an overlying transparent, electrically-conductive, sputter-deposited ITO layer. The theory and use of blocking layers are described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

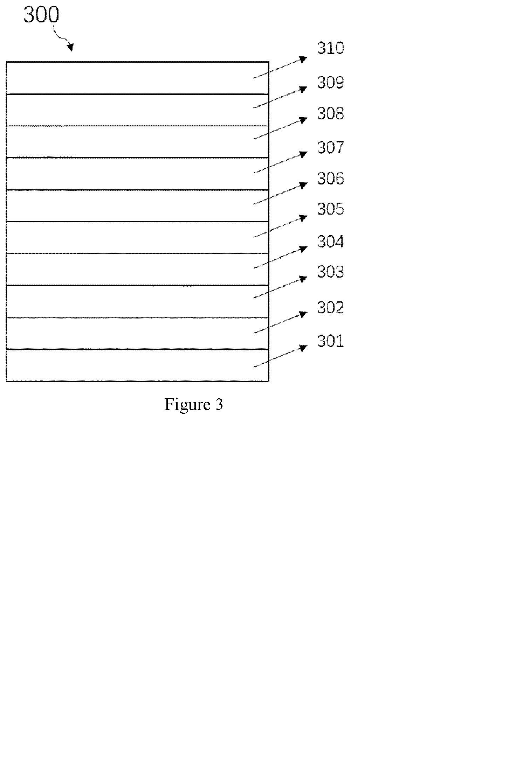

A structure of a typical top-emitting OLED device is shown in FIG. 3. An OLED device 300 comprises an anode layer 301, a hole injection layer (HIL) 302, a first hole transport layer (HTL1) 303, a second hole transport layer (HTL2) 304 (also referred to as a prime layer), an emissive layer (EML) 305, a hole blocking layer (HBL) 306 (as an optional layer), an electron transport layer (ETL) 307, an electron injection layer (EIL) 308, a cathode layer 309 and a capping layer 310. The anode layer 301 is a material or a combination of materials having a high reflectivity, including but not limited to Ag, Al, Ti, Cr, Pt, Ni, TiN and a combination of the above materials with ITO and/or MoOx (molybdenum oxide). Generally, the reflectivity of the anode is greater than 50%; preferably, the reflectivity of the anode is greater than 70%; more preferably, the reflectivity of the anode is greater than 80%. The cathode layer 309 should be a translucent or transparent conductive material, including but not limited to a MgAg alloy, MoOx, Yb, Ca, ITO, IZO or a combination thereof and having an average transmittance of greater than 15% for light having a wavelength in a visible region; preferably, the average transmittance for the light having the wavelength in the visible region is greater than 20%; more preferably, the average transmittance for the light having the wavelength in the visible region is greater than 25%.

The layered structure described above is provided by way of non-limiting examples. Functional OLEDs may be achieved by combining the various layers described in different ways, or layers may be omitted entirely. It may also include other layers not specifically described. Within each layer, a single material or a mixture of multiple materials can be used to achieve optimum performance. Any functional layer may include several sublayers. For example, the emissive layer may have two layers of different emitting materials to achieve desired emission spectrum.

In one embodiment, an OLED may be described as having an "organic layer" disposed between a cathode and an anode. This organic layer may include a single layer or multiple layers.

An OLED can be encapsulated by a barrier layer. FIG. 2 schematically shows an organic light emitting device 200 without limitation. FIG. 2 differs from FIG. 1 in that the organic light emitting device include a barrier layer 102, which is above the cathode 190, to protect it from harmful species from the environment such as moisture and oxygen. Any material that can provide the barrier function can be used as the barrier layer such as glass or organic-inorganic hybrid layers. The barrier layer should be placed directly or indirectly outside of the OLED device. Multilayer thin film encapsulation was described in U.S. Pat. No. 7,968,146.

Devices fabricated in accordance with embodiments of the present disclosure can be incorporated into a wide variety of consumer products that have one or more of the electronic component modules (or units) incorporated therein. Some examples of such consumer products include flat panel displays, monitors, medical monitors, televisions, billboards, lights for interior or exterior illumination and/or signaling, heads-up displays, fully or partially transparent displays, flexible displays, smart phones, tablets, phablets, wearable devices, smart watches, laptop computers, digital cameras, camcorders, viewfinders, micro-displays, 3-D displays, vehicles displays, and vehicle tail lights.

The materials and structures described herein may be used in other organic electronic devices listed above.

As used herein, "top" means furthest away from the substrate, while "bottom" means closest to the substrate. Where a first layer is described as "disposed over" a second layer, the first layer is disposed further away from the substrate. There may be other layers between the first and second layers, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the transition between the triplet states and the singlet excited states. Compounds that are capable of generating E-type delayed fluorescence are required to have very small singlet-triplet gaps to convert between energy states. Thermal energy can activate the transition from the triplet state back to the singlet state. This type of delayed fluorescence is also known as thermally activated delayed fluorescence (TADF). A distinctive feature of TADF is that the delayed component increases as temperature rises. If the reverse intersystem crossing (RISC) rate is fast enough to minimize the non-radiative decay from the triplet state, the fraction of back populated singlet excited states can potentially reach 75%. The total singlet fraction can be 100%, far exceeding 25% of the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔE_{S-T}). Organic, non-metal containing, donor-acceptor luminescent materials may be able to achieve this. The emission in these materials is generally characterized as a donor-acceptor charge-transfer (CT) type emission. The spatial separation of the HOMO and LUMO in these donor-acceptor type compounds generally results in small ΔE_{S-T}. These states may involve CT states. Generally, donor-acceptor luminescent materials are constructed by connecting an electron donor moiety such as amino- or carbazole-derivatives and an electron acceptor moiety such as N-containing six-membered aromatic rings.

### Definition of terms of substituents

Halogen or halide - as used herein includes fluorine, chlorine, bromine, and iodine.

Alkyl - as used herein includes both straight and branched chain alkyl groups. Alkyl may be alkyl having 1 to 20 carbon atoms, preferably alkyl having 1 to 12 carbon atoms, and more preferably alkyl having 1 to 6 carbon atoms. Examples of alkyl groups include a methyl group, an ethyl group, a propyl group, an isopropyl group, a n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neopentyl group, a 1-methylpentyl group, a 2-methylpentyl group, a 1-pentylhexyl group, a 1-butylpentyl group, a 1-heptyloctyl group, and a 3-methylpentyl group. Of the above, preferred are a methyl group, an ethyl group, a propyl group, an isopropyl group, a n-butyl group, an s-butyl group, an isobutyl group, a t-butyl group, an n-pentyl group, a neopentyl group, and an n-hexyl group. Additionally, the alkyl group may be optionally substituted.

Cycloalkyl - as used herein includes cyclic alkyl groups. The cycloalkyl groups may be those having 3 to 20 ring carbon atoms, preferably those having 4 to 10 carbon atoms. Examples of cycloalkyl include cyclobutyl, cyclopentyl, cyclohexyl, 4-methylcyclohexyl, 4,4-dimethylcylcohexyl, 1-adamantyl, 2-adamantyl, 1-norbornyl, 2-norbornyl, and the like. Of the above, preferred are cyclopentyl, cyclohexyl, 4-methylcyclohexyl, and 4,4-dimethylcylcohexyl. Additionally, the cycloalkyl group may be optionally substituted.

Heteroalkyl - as used herein, includes a group formed by replacing one or more carbons in an alkyl chain with a hetero-atom(s) selected from the group consisting of a nitrogen atom, an oxygen atom, a sulfur atom, a selenium atom, a phosphorus atom, a silicon atom, a germanium atom, and a boron atom. Heteroalkyl may be those having 1 to 20 carbon atoms, preferably those having 1 to 10 carbon atoms, and more preferably those having 1 to 6 carbon atoms. Examples of heteroalkyl include methoxymethyl, ethoxymethyl, ethoxyethyl, methylthiomethyl, ethylthiomethyl, ethylthioethyl, methoxymethoxymethyl, ethoxymethoxymethyl, ethoxyethoxyethyl, hydroxymethyl, hydroxyethyl, hydroxypropyl, mercaptomethyl, mercaptoethyl, mercaptopropyl, aminomethyl, aminoethyl, aminopropyl, dimethylaminomethyl, trimethylgermanylmethyl, trimethylgermanylethyl, trimethylgermanylisopropyl, dimethylethylgermanylmethyl, dimethylisopropylgermanylmethyl, tert-butyldimethylgermanylmethyl, triethylgermanylmethyl, triethylgermanylethyl, triisopropylgermanylmethyl, triisopropylgermanylethyl, trimethylsilylmethyl, trimethylsilylethyl, trimethylsilylisopropyl, triisopropylsilylmethyl, and triisopropylsilylethyl. Additionally, the heteroalkyl group may be optionally substituted. Additionally, the heteroalkyl group may be optionally substituted.

Alkenyl - as used herein includes straight chain, branched chain, and cyclic alkene groups. Alkenyl may be those having 2 to 20 carbon atoms, preferably those having 2 to 10 carbon atoms. Examples of alkenyl include vinyl, 1-propenyl group, 1-butenyl, 2-butenyl, 3-butenyl, 1,3-butandienyl, 1-methylvinyl, styryl, 2,2-diphenylvinyl, 1,2-diphenylvinyl, 1-methylallyl, 1,1-dimethylallyl, 2-methylallyl, 1-phenylallyl, 2-phenylallyl, 3-phenylallyl, 3,3-diphenylallyl, 1,2-dimethylallyl, 1-phenyl-1-butenyl, 3-phenyl-1-butenyl, cyclopentenyl, cyclopentadienyl, cyclohexenyl, cycloheptenyl, cycloheptatrienyl, cyclooctenyl, cyclooctatetraenyl, and norbornenyl. Additionally, the alkenyl group may be optionally substituted.

Alkynyl - as used herein includes straight chain alkynyl groups. Alkynyl may be those having 2 to 20 carbon atoms, preferably those having 2 to 10 carbon atoms. Examples of alkynyl groups include ethynyl, propynyl, propargyl, 1-butynyl, 2-butynyl, 3-butynyl, 1-pentynyl, 2-pentynyl, 3,3-dimethyl-1-butynyl, 3-ethyl-3-methyl-1-pentynyl, 3,3-diisopropyl-1-pentynyl, phenylethynyl, phenylpropynyl, etc. Of the above, preferred are ethynyl, propynyl, propargyl, 1-butynyl, 2-butynyl, 3-butynyl, 1-pentynyl, and phenylethynyl. Additionally, the alkynyl group may be optionally substituted.

Aryl or an aromatic group - as used herein includes non-condensed and condensed systems. Aryl may be those having 6 to 30 carbon atoms, preferably those having 6 to 20 carbon atoms, and more preferably those having 6 to 12 carbon atoms. Examples of aryl groups include phenyl, biphenyl, terphenyl, triphenylene, tetraphenylene, naphthalene, anthracene, phenalene, phenanthrene, fluorene, pyrene, chrysene, perylene, and azulene, preferably phenyl, biphenyl, terphenyl, triphenylene, fluorene, and naphthalene. Examples of non-condensed aryl groups include phenyl, biphenyl-2-yl, biphenyl-3-yl, biphenyl-4-yl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-(2-phenylpropyl)phenyl, 4'-methylbiphenylyl, 4"-t-butyl-p-terphenyl-4-yl, o-cumenyl, m-cumenyl, p-cumenyl, 2,3-xylyl, 3,4-xylyl, 2,5-xylyl, mesityl, and m-quarterphenyl. Additionally, the aryl group may be optionally substituted.

Heterocyclic groups or heterocycle - as used herein include non-aromatic cyclic groups. Non-aromatic heterocyclic groups include saturated heterocyclic groups having 3 to 20 ring atoms and unsaturated non-aromatic heterocyclic groups having 3 to 20 ring atoms, where at least one ring atom is selected from the group consisting of a nitrogen atom, an oxygen atom, a sulfur atom, a selenium atom, a silicon atom, a phosphorus atom, a germanium atom, and a boron atom. Preferred non-aromatic heterocyclic groups are those having 3 to 7 ring atoms, each of which includes at least one hetero-atom such as nitrogen, oxygen, silicon, or sulfur. Examples of non-aromatic heterocyclic groups include oxiranyl, oxetanyl, tetrahydrofuranyl, tetrahydropyranyl, dioxolanyl, dioxanyl, aziridinyl, dihydropyrrolyl, tetrahydropyrrolyl, piperidinyl, oxazolidinyl, morpholinyl, piperazinyl, oxepinyl, thiepinyl, azepinyl, and tetrahydrosilolyl. Additionally, the heterocyclic group may be optionally substituted.

Heteroaryl - as used herein, includes non-condensed and condensed hetero-aromatic groups having 1 to 5 hetero-atoms, where at least one hetero-atom is selected from the group consisting of a nitrogen atom, an oxygen atom, a sulfur atom, a selenium atom, a silicon atom, a phosphorus atom, a germanium atom, and a boron atom. A hetero-aromatic group is also referred to as heteroaryl. Heteroaryl may be those having 3 to 30 carbon atoms, preferably those having 3 to 20 carbon atoms, and more preferably those having 3 to 12 carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridoindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Alkoxy - as used herein, is represented by -O-alkyl, -O-cycloalkyl, -O-heteroalkyl, or - O-heterocyclic group. Examples and preferred examples of alkyl, cycloalkyl, heteroalkyl, and heterocyclic groups are the same as those described above. Alkoxy groups may be those having 1 to 20 carbon atoms, preferably those having 1 to 6 carbon atoms. Examples of alkoxy groups include methoxy, ethoxy, propoxy, butoxy, pentyloxy, hexyloxy, cyclopropyloxy, cyclobutyloxy, cyclopentyloxy, cyclohexyloxy, tetrahydrofuranyloxy, tetrahydropyranyloxy, methoxypropyloxy, ethoxyethyloxy, methoxymethyloxy, and ethoxymethyloxy. Additionally, the alkoxy group may be optionally substituted.

Aryloxy - as used herein, is represented by -O-aryl or -O-heteroaryl. Examples and preferred examples of aryl and heteroaryl are the same as those described above. Aryloxy groups may be those having 6 to 30 carbon atoms, preferably those having 6 to 20 carbon atoms. Examples of aryloxy groups include phenoxy and biphenyloxy. Additionally, the aryloxy group may be optionally substituted.

Arylalkyl - as used herein, contemplates alkyl substituted with an aryl group. Arylalkyl may be those having 7 to 30 carbon atoms, preferably those having 7 to 20 carbon atoms, and more preferably those having 7 to 13 carbon atoms. Examples of arylalkyl groups include benzyl, 1-phenylethyl, 2-phenylethyl, 1-phenylisopropyl, 2-phenylisopropyl, phenyl-t-butyl, alpha-naphthylmethyl, 1-alpha-naphthylethyl, 2-alpha-naphthylethyl, 1-alpha-naphthylisopropyl, 2-alpha-naphthylisopropyl, beta-naphthylmethyl, 1-beta-naphthylethyl, 2-beta-naphthylethyl, 1-beta-naphthylisopropyl, 2-beta-naphthylisopropyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, and 1-chloro-2-phenylisopropyl. Of the above, preferred are benzyl, p-cyanobenzyl, m-cyanobenzyl, o-cyanobenzyl, 1-phenylethyl, 2-phenylethyl, 1-phenylisopropyl, and 2-phenylisopropyl. Additionally, the arylalkyl group may be optionally substituted.

Alkylsilyl - as used herein, contemplates a silyl group substituted with an alkyl group. Alkylsilyl groups may be those having 3 to 20 carbon atoms, preferably those having 3 to 10 carbon atoms. Examples of alkylsilyl groups include trimethylsilyl, triethylsilyl, methyldiethylsilyl, ethyldimethylsilyl, tripropylsilyl, tributylsilyl, triisopropylsilyl, methyldiisopropylsilyl, dimethylisopropylsilyl, tri-t-butylsilyl, triisobutylsilyl, dimethyl t-butylsilyl, and methyldi-t-butylsilyl. Additionally, the alkylsilyl group may be optionally substituted.

Arylsilyl - as used herein, contemplates a silyl group substituted with an aryl group. Arylsilyl groups may be those having 6 to 30 carbon atoms, preferably those having 8 to 20 carbon atoms. Examples of arylsilyl groups include triphenylsilyl, phenyldibiphenylylsilyl, diphenylbiphenylsilyl, phenyldiethylsilyl, diphenylethylsilyl, phenyldimethylsilyl, diphenylmethylsilyl, phenyldiisopropylsilyl, diphenylisopropylsilyl, diphenylbutylsilyl, diphenylisobutylsilyl, diphenyl t-butylsilyl. Additionally, the arylsilyl group may be optionally substituted.

Alkylgermanyl - as used herein contemplates a germanyl substituted with an alkyl group. The alkylgermanyl may be those having 3 to 20 carbon atoms, preferably those having 3 to 10 carbon atoms. Examples of alkylgermanyl include trimethylgermanyl, triethylgermanyl, methyldiethylgermanyl, ethyldimethylgermanyl, tripropylgermanyl, tributylgermanyl, triisopropylgermanyl, methyldiisopropylgermanyl, dimethylisopropylgermanyl, tri-t-butylgermanyl, triisobutylgermanyl, dimethyl-t-butylgermanyl, and methyldi-t-butylgermanyl. Additionally, the alkylgermanyl may be optionally substituted.

Arylgermanyl - as used herein contemplates a germanyl substituted with at least one aryl group or heteroaryl group. Arylgermanyl may be those having 6 to 30 carbon atoms, preferably those having 8 to 20 carbon atoms. Examples of arylgermanyl include triphenylgermanyl, phenyldibiphenylylgermanyl, diphenylbiphenylgermanyl, phenyldiethylgermanyl, diphenylethylgermanyl, phenyldimethylgermanyl, diphenylmethylgermanyl, phenyldiisopropylgermanyl, diphenylisopropylgermanyl, diphenylbutylgermanyl, diphenylisobutylgermanyl, and diphenyl-t-butylgermanyl. Additionally, the arylgermanyl may be optionally substituted.

The term "aza" in azadibenzofuran, azadibenzothiophene, etc. means that one or more of C-H groups in the respective aromatic fragment are replaced by a nitrogen atom. For example, azatriphenylene encompasses dibenzo[f,h]quinoxaline, dibenzo[f,h]quinoline and other analogs with two or more nitrogens in the ring system. One of ordinary skill in the art can readily envision other nitrogen analogs of the aza-derivatives described above, and all such analogs are intended to be encompassed by the terms as set forth herein.

In the present disclosure, unless otherwise defined, when any term of the group consisting of substituted alkyl, substituted cycloalkyl, substituted heteroalkyl, substituted heterocyclic group, substituted arylalkyl, substituted alkoxy, substituted aryloxy, substituted alkenyl, substituted alkynyl, substituted aryl, substituted heteroaryl, substituted alkylsilyl, substituted arylsilyl, substituted alkylgermanyl, substituted arylgermanyl, substituted amino, substituted acyl, substituted carbonyl, a substituted carboxylic acid group, a substituted ester group, substituted sulfinyl, substituted sulfonyl, and substituted phosphino is used, it means that any group of alkyl, cycloalkyl, heteroalkyl, heterocyclic group, arylalkyl, alkoxy, aryloxy, alkenyl, alkynyl, aryl, heteroaryl, alkylsilyl, arylsilyl, alkylgermanyl, arylgermanyl, amino, acyl, carbonyl, a carboxylic acid group, an ester group, sulfinyl, sulfonyl, and phosphino may be substituted with one or more groups selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl group having 6 to 20 carbon atoms, unsubstituted alkylgermanyl group having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or an attached fragment are considered to be equivalent.

In the compounds mentioned in the present disclosure, hydrogen atoms may be partially or fully replaced by deuterium. Other atoms such as carbon and nitrogen can also be replaced by their other stable isotopes. The replacement by other stable isotopes in the compounds may be preferred due to its enhancements of device efficiency and stability.

In the compounds mentioned in the present disclosure, multiple substitutions refer to a range that includes di-substitutions, up to the maximum available substitutions. When substitution in the compounds mentioned in the present disclosure represents multiple substitutions (including di-, tri-, and tetra-substitutions, etc.), that means the substituent may exist at a plurality of available substitution positions on its linking structure, the substituents present at a plurality of available substitution positions may have the same structure or different structures.

In the compounds mentioned in the present disclosure, adjacent substituents in the compounds cannot be joined to form a ring unless otherwise explicitly defined, for example, adjacent substituents can be optionally joined to form a ring. In the compounds mentioned in the present disclosure, the expression that adjacent substituents can be optionally joined to form a ring includes a case where adjacent substituents may be joined to form a ring and a case where adjacent substituents are not joined to form a ring. When adjacent substituents can be optionally joined to form a ring, the ring formed may be monocyclic or polycyclic (including spirocyclic, endocyclic, fusedcyclic, and etc.), as well as alicyclic, heteroalicyclic, aromatic, or heteroaromatic. In such expression, adjacent substituents may refer to substituents bonded to the same atom, substituents bonded to carbon atoms which are directly bonded to each other, or substituents bonded to carbon atoms which are more distant from each other. Preferably, adjacent substituents refer to substituents bonded to the same carbon atom and substituents bonded to carbon atoms which are directly bonded to each other.

The expression that adjacent substituents can be optionally joined to form a ring is also intended to mean that two substituents bonded to the same carbon atom are joined to each other via a chemical bond to form a ring, which can be exemplified by the following formula:

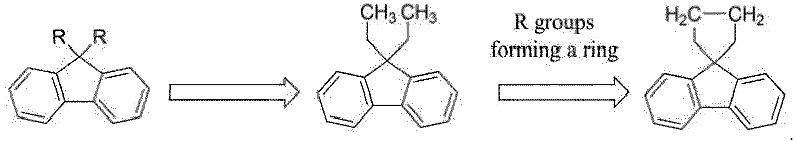

The expression that adjacent substituents can be optionally joined to form a ring is also intended to mean that two substituents bonded to carbon atoms which are directly bonded to each other are joined to each other via a chemical bond to form a ring, which can be exemplified by the following formula:

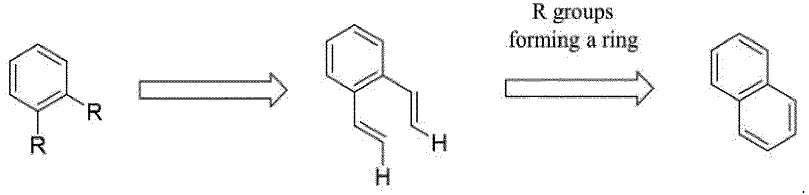

The expression that adjacent substituents can be optionally joined to form a ring is also intended to mean that two substituents bonded to further distant carbon atoms are joined to each other via a chemical bond to form a ring, which can be exemplified by the following formula:

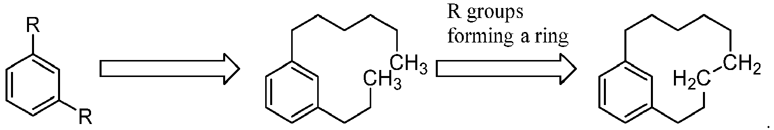

Furthermore, the expression that adjacent substituents can be optionally joined to form a ring is also intended to mean that, in the case where one of the two substituents bonded to carbon atoms which are directly bonded to each other represents hydrogen, the second substituent is bonded at a position at which the hydrogen atom is bonded, thereby forming a ring. This is exemplified by the following formula:

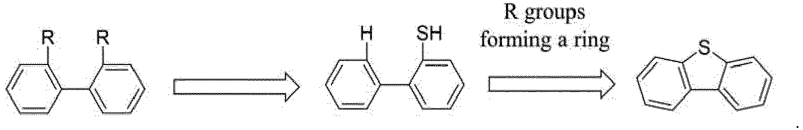

According to an embodiment of the present disclosure, disclosed is a metal complex, which comprises a metal M and a ligand Lₐ coordinated to the metal M, wherein the metal M is selected from a metal with a relative atomic mass greater than 40, and the ligand Lₐ has a structure represented by Formula 1: 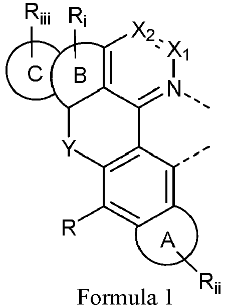
wherein the ring A and the ring B are each independently selected from a five-membered unsaturated carbocyclic ring, an aromatic ring having 6 to 30 carbon atoms or a heteroaromatic ring having 3 to 30 carbon atoms; and the ring C is selected from an aromatic ring having 6 to 30 carbon atoms or a heteroaromatic ring having 6 to 30 ring atoms;
Rᵢ and Rᵢᵢ represent, at each occurrence identically or differently, mono-substitution, multiple substitutions or non-substitution; and Rᵢᵢᵢ represents, at each occurrence identically or differently, mono-substitution, multiple substitutions or non-substitution;
Y is selected from SiR_{y}R_{y}, GeR_{y}R_{y}, O, S or Se;
when two R_{y} are present at the same time, the two R_{y} may be identical or different;
X₁ and X₂ are, at each occurrence identically or differently, selected from CRₓ or N;
R, Rᵢ, Rᵢᵢ, Rₓ and R_{y} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
wherein substituted alkyl, substituted cycloalkyl, substituted heteroalkyl, substituted heterocyclic group, substituted arylalkyl, substituted alkoxy, substituted aryloxy, substituted alkenyl, substituted aryl, substituted heteroaryl, substituted alkylsilyl, substituted arylsilyl, substituted alkylgermanyl, substituted arylgermanyl, and substituted amino are substituted with one or more groups selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl group having 6 to 20 carbon atoms, unsubstituted alkylgermanyl group having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof; and
adjacent substituents Rᵢ, Rₓ, R_{y}, R, Rᵢᵢ and Rᵢᵢᵢ are optionally joined to form a ring.

In the present disclosure, the expression that adjacent substituents Rᵢ, Rₓ, R_{y}, R, Rᵢᵢ and Rᵢᵢᵢ are optionally joined to form a ring is intended to mean that any one or more of groups of adjacent substituents, such as two substituents Rᵢ, two substituents Rᵢᵢ, two substituents Rᵢᵢᵢ, two substituents R_{y}, two substituents Rₓ, substituents Rᵢ and Rₓ, substituents Rᵢ and Rᵢᵢᵢ, substituents R and R_{y}, and substituents Rᵢᵢᵢ and R, are joined to form a ring. Obviously, it is possible that none of these substituents are joined to form a ring.

According to an embodiment of the present disclosure, wherein Rᵢᵢᵢ represents, at each occurrence identically or differently, mono-substitution or multiple substitutions; and
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof.

According to an embodiment of the present disclosure, wherein the metal complex optionally comprises other ligand(s) which may be optionally joined to the Lₐ to form a tridentate ligand, a tetradentate ligand, a pentadentate ligand or a hexadentate ligand.

According to an embodiment of the present disclosure, wherein the ring A and/or the ring B are each independently selected from a five-membered unsaturated carbocyclic ring, an aromatic ring having 6 to 18 carbon atoms or a heteroaromatic ring having 3 to 18 carbon atoms; and the ring C is selected from an aromatic ring having 6 to 18 carbon atoms or a heteroaromatic ring having 6 to 18 ring atoms.

According to an embodiment of the present disclosure, wherein the ring A and/or the ring B are each independently selected from a five-membered unsaturated carbocyclic ring, an aromatic ring having 6 to 10 carbon atoms or a heteroaromatic ring having 3 to 10 carbon atoms; and the ring C is selected from an aromatic ring having 6 to 10 carbon atoms or a heteroaromatic ring having 6 to 10 ring atoms.

According to an embodiment of the present disclosure, wherein the Lₐ is selected from a structure represented by any one of Formula 2 to Formula 17: 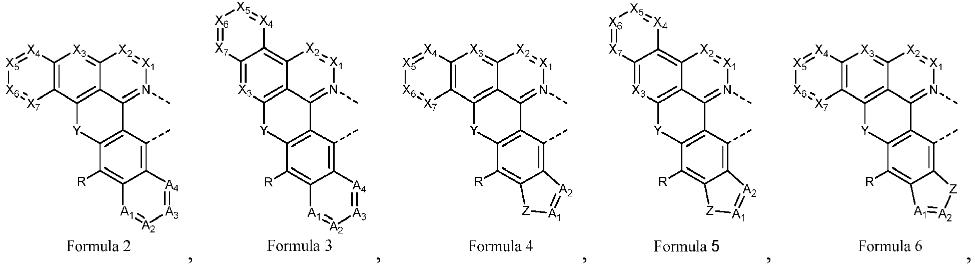 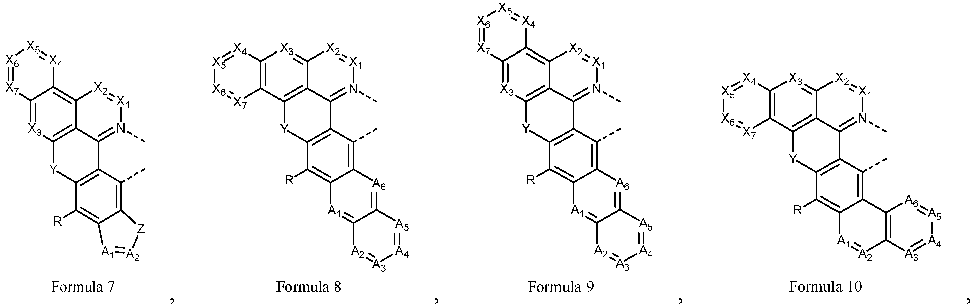 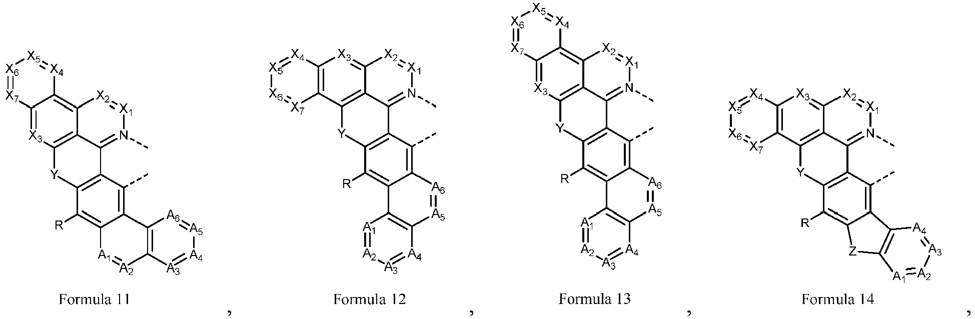 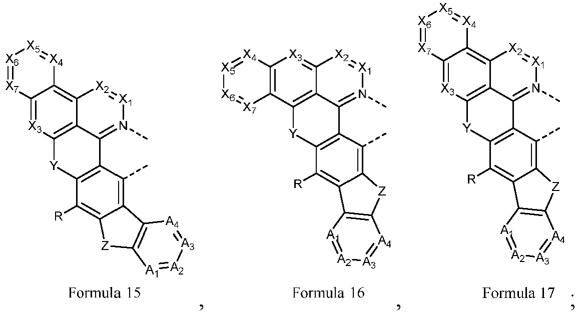 wherein
in Formula 2 to Formula 17, X₁ and X₂ are, at each occurrence identically or differently, selected from CRₓ or N; X₃ is selected from CRᵢ or N; A₁ to A₆ are, at each occurrence identically or differently, selected from CRᵢᵢ or N; X₄ to X₇ are, at each occurrence identically or differently, selected from CH, CRᵢᵢᵢ or N, and at least one of X₄ to X₇ is selected from CRᵢᵢᵢ;
Z is, at each occurrence identically or differently, selected from CRᵢᵥRᵢᵥ, SiRᵢᵥRᵢᵥ, PRᵢᵥ, O, S or NRᵢᵥ; when two Rᵢᵥ are present at the same time, the two Rᵢᵥ are identical or different; for example, when Z is selected from CRᵢᵥRᵢᵥ, the two Rᵢᵥ are identical or different; in another example, when Z is selected from SiRᵢᵥRᵢᵥ, the two Rᵢᵥ are identical or different;
Y is selected from SiR_{y}R_{y}, O, S or Se; when two R_{y} are present at the same time, the two R_{y} may be identical or different; for example, when Y is selected from SiR_{y}R_{y}, the two R_{y} are identical or different;
R, Rₓ, R_{y}, Rᵢ, Rᵢᵢ and Rᵢᵥ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents Rᵢ, Rₓ, R_{y}, R, Rᵢᵢ, Rᵢᵢᵢ and Rᵢᵥ can be optionally joined to form a ring.

According to an embodiment of the present disclosure, wherein Lₐ is selected from a structure represented by Formula 2 or Formula 3.

According to an embodiment of the present disclosure, wherein Lₐ is selected from a structure represented by Formula 3.

According to an embodiment of the present disclosure, wherein, in Formula 2 to Formula 17, at least one of X₁ to Xₙ and/or A₁ to Aₘ is selected from N, wherein Xₙ corresponds to one with the largest serial number among X₁ to X₇ in any one of Formula 2 to Formula 17, and Aₘ corresponds to one with the largest serial number among A₁ to A₆ in any one of Formula 2 to Formula 17. For example, in Formula 3, Xₙ corresponds to X₇ whose serial number is the largest among X₁ to X₇ in Formula 3, and Aₘ corresponds to A₄ whose serial number is the largest among A₁ to A₆ in Formula 3, that is, in Formula 3, at least one of X₁ to X₇ and/or A₁ to A₄ is selected from N.

According to an embodiment of the present disclosure, wherein, in Formula 2 to Formula 17, at least one of X₁ to Xₙ is selected from N, wherein Xₙ corresponds to one with the largest serial number among X₁ to X₇ in any one of Formula 2 to Formula 17.

According to an embodiment of the present disclosure, wherein, in Formula 2 to Formula 17, X₂ is N.

According to an embodiment of the present disclosure, wherein, in Formula 2 to Formula 17, X₁ and X₂ are each independently selected from CRₓ; X₃ is selected from CRi; A₁ to A₆ are each independently selected from CRᵢᵢ; X₄ to X₇ are, at each occurrence identically or differently, selected from CH or CRᵢᵢᵢ, and at least one of X₄ to X₇ is selected from CRᵢᵢᵢ; adjacent substituents Rₓ, Ri, Rᵢᵢ and Rᵢᵢᵢ can be optionally joined to form a ring.

In the present disclosure, the expression that adjacent substituents Rₓ, Rᵢ, Rᵢᵢ and Rᵢᵢᵢ can be optionally joined to form a ring is intended to mean that any one or more of groups of adjacent substituents, such as two substituents Rᵢᵢ, two substituents Rᵢᵢᵢ, two substituents Rₓ, substituents Rᵢ and Rᵢᵢᵢ, and substituents Rᵢ and Rₓ, can be joined to form a ring. Obviously, it is possible that none of these substituents are joined to form a ring.

According to an embodiment of the present disclosure, wherein, in Formula 2 to Formula 17, X₁ and X₂ are each independently selected from CRₓ; X₃ is selected from CRi; A₁ to A₆ are each independently selected from CRᵢᵢ; X₄ to X₇ are, at each occurrence identically or differently, selected from CH or CRᵢᵢᵢ, and at least one of X₄ to X₇ is selected from CRᵢᵢᵢ; and the Rₓ, Rᵢ and Rᵢᵢ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group and combinations thereof; and
adjacent substituents Rₓ, Ri, Rᵢᵢ and Rᵢᵢᵢ can be optionally joined to form a ring.

According to an embodiment of the present disclosure, wherein, in Formula 2 to Formula 17, X₁ and X₂ are each independently selected from CRₓ; X₃ is selected from CRi; A₁ to A₄ are each independently selected from CRᵢᵢ; X₄ to X₇ are, at each occurrence identically or differently, selected from CH or CRᵢᵢᵢ, and at least one of X₄ to X₇ is selected from CRᵢᵢᵢ; and at least one or two of the Rₓ, Rᵢ and Rᵢᵢ is(are), at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group and combinations thereof;
Rᵢᵢᵢ is, at each occurrence identically or differently, selected from the group consisting of: deuterium, fluorine, methyl, ethyl, isopropyl, isobutyl, t-butyl, neopentyl, cyclopentyl, cyclopentylmethyl, cyclohexyl, norbornyl, adamantyl, trimethylsilyl, isopropyldimethylsilyl, phenyldimethylsilyl, trifluoromethyl, a cyano group, phenyl and combinations thereof; and
adjacent substituents Rₓ, Rᵢ, Rᵢᵢ and Rᵢᵢᵢ can be optionally joined to form a ring.

In this embodiment, the expression that at least one or two of the Rₓ, Rᵢ and Rᵢᵢ is(are), at each occurrence identically or differently, selected from the group of substituents is intended to mean that at least one or two substituents in the group consisting of two substituents Rₓ, all substituents Rᵢ and all substituents Rᵢᵢ is(are), at each occurrence identically or differently, selected from the group of substituents.

According to an embodiment of the present disclosure, wherein, in Formula 2 to Formula 17, at least one or two of A₁ to A₆ is(are) selected from CRᵢᵢ; X₃ is selected from CRᵢ.

According to an embodiment of the present disclosure, wherein, in Formula 2 to Formula 17, at least one or two of A₁ to A₆ is(are) selected from CRᵢᵢ, and the Rᵢᵢ is, at each occurrence identically or differently, selected from deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group or a combination thereof; and
X₃ is selected from CRi, and the Rᵢ is, at each occurrence identically or differently, selected from hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group or a combination thereof.

According to an embodiment of the present disclosure, wherein, in Formula 2 to Formula 17, at least one or two of A₁ to A₆ is selected from CRᵢᵢ, and the Rᵢᵢ is, at each occurrence identically or differently, selected from the group consisting of: deuterium, fluorine, methyl, ethyl, isopropyl, isobutyl, t-butyl, neopentyl, cyclopentyl, cyclopentylmethyl, cyclohexyl, norbornyl, adamantyl, trimethylsilyl, isopropyldimethylsilyl, phenyldimethylsilyl, trifluoromethyl, a cyano group, phenyl and combinations thereof; and
X₃ is selected from CRi, wherein the Rᵢ is, at each occurrence identically or differently, selected from the group consisting of: hydrogen, deuterium, fluorine, methyl, ethyl, isopropyl, isobutyl, t-butyl, neopentyl, cyclopentyl, cyclopentylmethyl, cyclohexyl, norbornyl, adamantyl, trimethylsilyl, isopropyldimethylsilyl, phenyldimethylsilyl, trifluoromethyl, a cyano group, phenyl and combinations thereof.

According to an embodiment of the present disclosure, wherein, in Formula 2 to Formula 17, R is selected from hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof.

According to an embodiment of the present disclosure, wherein, in Formula 2 to Formula 17, R is selected from hydrogen, deuterium, fluorine, methyl, ethyl, isopropyl, isobutyl, t-butyl, neopentyl, cyclopentyl, cyclopentylmethyl, cyclohexyl, deuterated methyl, deuterated ethyl, deuterated isopropyl, deuterated isobutyl, deuterated t-butyl, deuterated neopentyl, deuterated cyclopentyl, deuterated cyclopentylmethyl, deuterated cyclohexyl, trimethylsilyl or a combination thereof.

According to an embodiment of the present disclosure, wherein, in Formula 2 to Formula 17, Y is selected from O or S.

According to an embodiment of the present disclosure, wherein, in Formula 2 to Formula 17, Y is selected from O.

According to an embodiment of the present disclosure, wherein, in Formula 2 to Formula 17, X₁ and X₂ are each independently selected from CRₓ.

According to an embodiment of the present disclosure, wherein, in Formula 2 to Formula 17, X₁ is selected from CRₓ, and X₂ is selected from CRₓ or N.

According to an embodiment of the present disclosure, wherein, in Formula 2 to Formula 17, X₁ is selected from CRₓ, and X₂ is selected from CRₓ or N; and the Rₓ is, at each occurrence identically or differently, selected from hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof.

According to an embodiment of the present disclosure, wherein, the ligand Lₐ has a structure represented by Formula 18: 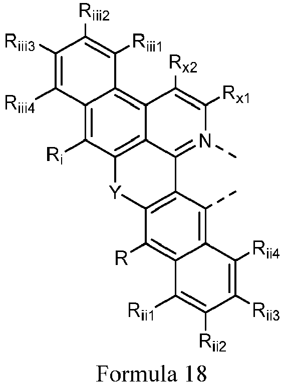
wherein in Formula 18,
Y is selected from O or S;
Rₓ₁, Rₓ₂, Rᵢ, Rᵢᵢ₁, Rᵢᵢ₂, Rᵢᵢ₃, Rᵢᵢ₄, R, Rᵢᵢᵢ₁, Rᵢᵢᵢ₂, Rᵢᵢᵢ₃ and Rᵢᵢᵢ₄ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
at least one of Rᵢᵢᵢ₁, Rᵢᵢᵢ₂, Rᵢᵢᵢ₃ and Rᵢᵢᵢ₄ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof.

According to an embodiment of the present disclosure, wherein, the ligand Lₐ has a structure represented by Formula 18: 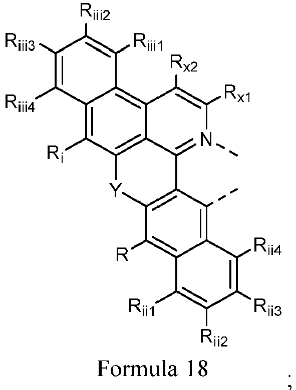
wherein in Formula 18,
Y is selected from O or S;
one or two of Rₓ₁ and Rₓ₂ and/or at least one or two of Rᵢᵢ₁, Rᵢᵢ₂, Rᵢᵢ₃ and Rᵢᵢ₄ is(are), at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof; R is selected from halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof; and
at least one or two of Rᵢᵢᵢ₁, Rᵢᵢᵢ₂, Rᵢᵢᵢ₃ and Rᵢᵢᵢ₄ is(are), at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof.

According to an embodiment of the present disclosure, wherein, the ligand Lₐ has a structure represented by Formula 18: 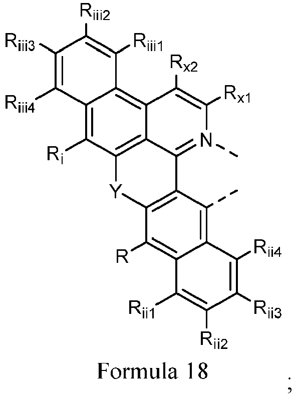
wherein in Formula 18,
Y is selected from O or S;
one or two of Rₓ₁ and Rₓ₂ and/or at least one or two of Rᵢᵢ₁, Rᵢᵢ₂, Rᵢᵢ₃ and Rᵢᵢ₄ is(are), at each occurrence identically or differently, selected from the group consisting of: substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof; R is selected from substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof;
at least one or two of Rᵢᵢᵢ, Rᵢᵢᵢ₂, Rᵢᵢᵢ₃ and Rᵢᵢᵢ₄ is(are), at each occurrence identically or differently, selected from the group consisting of: substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof.

According to an embodiment of the present disclosure, wherein, in Formula 18,
Y is selected from O or S;
at least one or two of Rᵢᵢᵢ₁, Rᵢᵢᵢ₂, Rᵢᵢᵢ₃ and Rᵢᵢᵢ₄, and at least one or two of Rᵢᵢ₁, Rᵢᵢ₂, Rᵢᵢ₃ and Rᵢᵢ₄ are, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof; and
R is selected from the group consisting of: halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof.

According to an embodiment of the present disclosure, wherein, in Formula 18,
Y is selected from O or S;
at least one or two of Rᵢᵢᵢ₁, Rᵢᵢᵢ₂, Rᵢᵢᵢ₃ and Rᵢᵢᵢ₄, and at least one or two of Rᵢᵢ₁, Rᵢᵢ₂, Rᵢᵢ₃ and Rᵢᵢ₄ are, at each occurrence identically or differently, selected from the group consisting of: substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof; and
R is selected from the group consisting of: substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof.

According to an embodiment of the present disclosure, wherein, in Formula 18, one (for example, Rᵢᵢᵢ or Rᵢᵢ₂ or Rᵢᵢ₃) or two (for example, Rᵢᵢᵢ and Rᵢᵢ₂, Rᵢᵢ₂ and Rᵢᵢ₃, or Rᵢᵢᵢ and Rᵢᵢ₃) of Rᵢᵢ₁, Rᵢᵢ₂ and Rᵢᵢ₃ is(are), at each occurrence identically or differently, selected from the group consisting of: substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof.

According to an embodiment of the present disclosure, wherein, in Formula 18, at least one of Rₓ₁, Rₓ₂, Riiii, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ and R is, at each occurrence identically or differently, selected from the group consisting of: substituted or unsubstituted alkyl having 3 to 20 carbon atoms, substituted or unsubstituted cycloalkyl having 3 to 20 ring carbon atoms, substituted or unsubstituted alkylsilyl having 3 to 20 carbon atoms and combinations thereof.

In this embodiment, the expression that at least one of Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ and R is, at each occurrence identically or differently, selected from the group of substituents is intended to mean that at least one of Rₓ₁ and Rₓ₂ is, at each occurrence identically or differently, selected from the group of substituents, and/or that at least one of Rᵢᵢᵢ₁, Rᵢᵢᵢ₂, Rᵢᵢᵢ₃ and Rᵢᵢᵢ₄ is, at each occurrence identically or differently, selected from the group of substituents, and/or that at least one of Rᵢᵢ₁, Rᵢᵢ₂, Rᵢᵢ₃ and Rᵢᵢ₄ is, at each occurrence identically or differently, selected from the group of substituents, and/or that R is selected from the group of substituents.

According to an embodiment of the present disclosure, wherein, in Formula 18, at least one of Rᵢᵢᵢ₂, Rᵢᵢᵢ₃, Rᵢᵢᵢ, Rᵢᵢ₂, Rᵢᵢ₃ and R is, at each occurrence identically or differently, selected from the group consisting of: substituted or unsubstituted alkyl having 3 to 20 carbon atoms, substituted or unsubstituted cycloalkyl having 3 to 20 ring carbon atoms, substituted or unsubstituted alkylsilyl having 3 to 20 carbon atoms and combinations thereof.

In this embodiment, the expression that at least one of Rᵢᵢᵢ₂, Rᵢᵢᵢ₃, Rᵢᵢ₁, Rᵢᵢ₂, Rᵢᵢ₃ and R is, at each occurrence identically or differently, selected from the group of substituents is intended to mean that at least one of Rᵢᵢᵢ₂ and Rᵢᵢᵢ₃ is, at each occurrence identically or differently, selected from the group of substituents, and/or that at least one of Rᵢᵢ₁, Rᵢᵢ₂ and Rᵢᵢ₃ is, at each occurrence identically or differently, selected from the group of substituents, and/or that R is selected from the group of substituents.

According to an embodiment of the present disclosure, wherein, in Formula 18, at least one of Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ and R is, at each occurrence identically or differently, selected from the group consisting of: substituted or unsubstituted alkyl having 3 to 10 carbon atoms, substituted or unsubstituted cycloalkyl having 3 to 10 ring carbon atoms and combinations thereof.

In this embodiment, the expression that at least one of Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ and R is, at each occurrence identically or differently, selected from the group of substituents is intended to mean that at least one of Rₓ₁ and Rₓ₂ is, at each occurrence identically or differently, selected from the group of substituents, and/or that at least one of Rᵢᵢᵢ₁, Rᵢᵢᵢ₂, Rᵢᵢᵢ₃ and Rᵢᵢᵢ₄ is, at each occurrence identically or differently, selected from the group of substituents, and/or that at least one of Rᵢᵢ₁, Rᵢᵢ₂, Rᵢᵢ₃ and Rᵢᵢ₄ is, at each occurrence identically or differently, selected from the group of substituents, and/or that R is selected from the group of substituents.

According to an embodiment of the present disclosure, wherein, Lₐ is, at each occurrence identically or differently, selected from the group consisting of Lₐ₁ to Lₐ₁₉₀₄, wherein the specific structures of Lₐ₁ to Lₐ₁₉₀₄ are referred to claim 10.

According to an embodiment of the present disclosure, wherein, Lₐ is, at each occurrence identically or differently, selected from the group consisting of Lₐ₁ to Lₐ₁₉₀₆, wherein the specific structures of Lₐ₁ to Lₐ₁₉₀₄ are referred to claim 10, and L_{a190S} and Lₐ₁₉₀₆ are as follows:

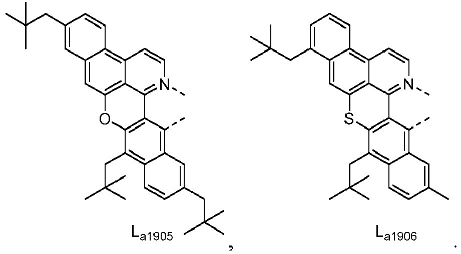

According to an embodiment of the present disclosure, wherein, hydrogens in the structures of the Lₐ₁ to Lₐ₁₉₀₄ can be partially or fully substituted with deuterium.

According to an embodiment of the present disclosure, wherein, hydrogens in the structures of the Lₐ₁ to Lₐ₁₉₀₆ can be partially or fully substituted with deuterium.

According to an embodiment of the present disclosure, wherein, the metal complex has a structure of M(Lₐ)ₘ(L_{b})ₙ(L_{c})_{q};
wherein the metal M is selected from a metal with a relative atomic mass greater than 40; Lₐ, L_{b} and L_{c} are a first ligand, a second ligand and a third ligand of the complex, respectively; m is 1, 2 or 3, n is 0, 1 or 2, q is 0, 1 or 2, and m+n+q is equal to an oxidation state of the metal M; when m is greater than 1, a plurality of Lₐ are identical or different; when n is 2, two L_{b} are identical or different; when q is 2, two L_{c} are identical or different;
Lₐ, L_{b} and L_{c} can be optionally joined to form a multidentate ligand; for example, Lₐ, L_{b} and L_{c} can be optionally joined to form a tetradentate ligand or a hexadentate ligand; it is possible that none of Lₐ, L_{b} and L_{c} are joined to form a multidentate ligand;
L_{b} and L_{c} are, at each occurrence identically or differently, selected from the group consisting of the following structures: 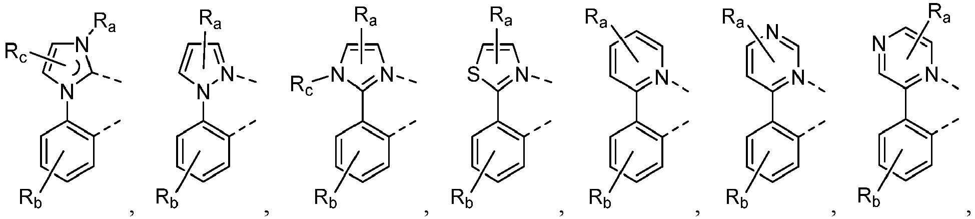 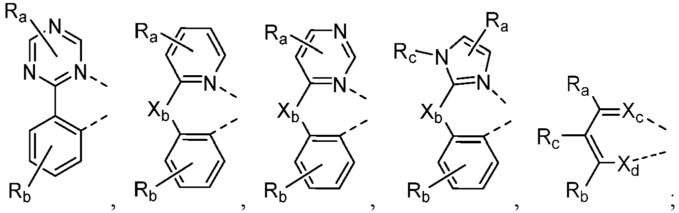
wherein Rₐ, R_{b} and R_{c} represent, at each occurrence identically or differently, mono-substitution, multiple substitutions or non-substitution;
X_{b} is, at each occurrence identically or differently, selected from the group consisting of: O, S, Se, NR_{N1} and CR_{C1}R_{C2};
X_{c} and X_{d} are, at each occurrence identically or differently, selected from the group consisting of: O, S, Se and NR_{N2};
Rₐ, R_{b}, R_{c}, R_{N1}, R_{N2}, R_{C1} and R_{C2} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents Rₐ, R_{b}, R_{c}, R_{N1}, R_{N2}, R_{C1} and R_{C2} can be optionally joined to form a ring.

In this embodiment, the expression that adjacent substituents Rₐ, R_{b}, R_{c}, R_{N1}, R_{N2}, R_{C1} and R_{C2} can be optionally joined to form a ring is intended to mean that any one or more of groups of adjacent substituents, such as two substituents Rₐ, two substituents R_{b}, two substituents R_{c}, substituents Rₐ and R_{b}, substituents Rₐ and R_{c}, substituents R_{b} and R_{c}, substituents Rₐ and R_{N1}, substituents R_{b} and R_{N1}, substituents R_{c} and R_{N1}, substituents Rₐ and R_{C1}, substituents Rₐ and R_{C2}, substituents R_{b} and R_{C1}, substituents R_{b} and R_{C2}, substituents R_{c} and R_{C1}, substituents R_{c} and R_{C2}, substituents Rₐ and R_{N2}, substituents R_{b} and R_{N2}, and substituents R_{C1} and R_{C2}, can be joined to form a ring. Obviously, it is possible that none of these substituents are joined to form a ring.

In this embodiment, the expression that Lₐ, L_{b} and L_{c} can be optionally joined to form a multidentate ligand is intended to mean that any two or three of Lₐ, L_{b} and L_{c} can be joined to form a tetradentate ligand or a hexadentate ligand. Obviously, it is possible that none of Lₐ, L_{b} and L_{c} are joined to form a multidentate ligand.

According to an embodiment of the present disclosure, wherein, the metal M is selected from Ir, Rh, Re, Os, Pt, Au or Cu.

According to an embodiment of the present disclosure, wherein, the metal M is selected from Ir, Pt or Os.

According to an embodiment of the present disclosure, wherein, the metal M is Ir.

According to an embodiment of the present disclosure, wherein, L_{b} is, at each occurrence identically or differently, selected from the following structure: 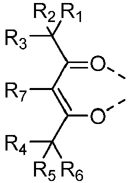 wherein R₁ to R₇ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof.

According to an embodiment of the present disclosure, wherein, L_{b} is, at each occurrence identically or differently, selected from the following structure: 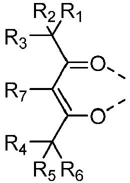 wherein at least one of R₁ to R₃ is, at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof; and/or at least one of R₄ to R₆ is, at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof.

According to an embodiment of the present disclosure, wherein, L_{b} is, at each occurrence identically or differently, selected from the following structure: 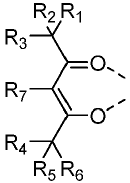 wherein at least two of R₁ to R₃ are, at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof; and/or at least two of R₄ to R₆ are, at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof.

According to an embodiment of the present disclosure, wherein, L_{b} is, at each occurrence identically or differently, selected from the following structure: 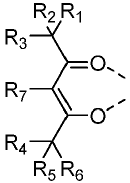 wherein at least two of R₁ to R₃ are, at each occurrence identically or differently, selected from substituted or unsubstituted alkyl having 2 to 20 carbon atoms, substituted or unsubstituted cycloalkyl having 3 to 20 ring carbon atoms, substituted or unsubstituted heteroalkyl having 2 to 20 carbon atoms or a combination thereof; and/or at least two of R₄ to R₆ are, at each occurrence identically or differently, selected from substituted or unsubstituted alkyl having 2 to 20 carbon atoms, substituted or unsubstituted cycloalkyl having 3 to 20 ring carbon atoms, substituted or unsubstituted heteroalkyl having 2 to 20 carbon atoms or a combination thereof.

According to an embodiment of the present disclosure, wherein, the metal complex has a general formula of Ir(Lₐ)ₘ(L_{b})₃₋ₘ and a structure represented by Formula 1-1 or Formula 1-2: 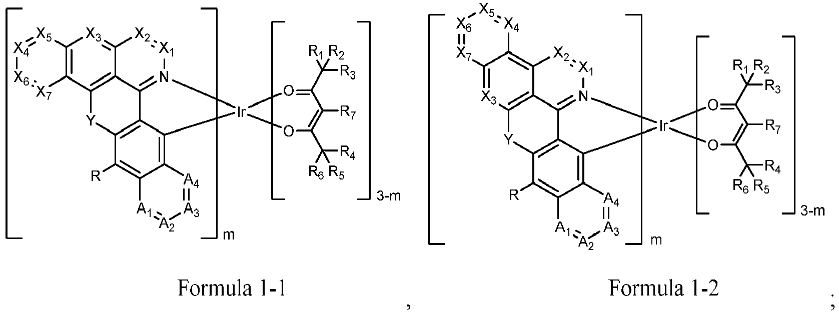 wherein
m is 1 or 2;
X₁ and X₂ are, at each occurrence identically or differently, selected from CRₓ or N; X₃ is, at each occurrence identically or differently, selected from CRᵢ or N; A₁ to A₄ are, at each occurrence identically or differently, selected from CRᵢᵢ or N; X₄ to X₇ are, at each occurrence identically or differently, selected from CH, CRᵢᵢᵢ or N, and at least one of X₄ to X₇ is selected from CRᵢᵢᵢ;
Y is selected from SiR_{y}R_{y}, O, S or Se; when two R_{y} are present at the same time, the two R_{y} are identical or different;
R, Rₓ, R_{y}, Rᵢ, Rᵢᵢ, R₁, R₂, R₃, R₄, R₅, R₆ and R₇ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents R, Rₓ, R_{y}, Rᵢ, Rᵢᵢ and Rᵢᵢᵢ can be optionally joined to form a ring; and
adjacent substituents R₁, R₂, R₃, R₄, R₅, R₆ and R₇ can be optionally joined to form a ring.

According to an embodiment of the present disclosure, wherein, at least one or two of R₁ to R₃ is(are), at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof; and/or at least one or two of R₄ to R₆ is(are), at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof.

According to an embodiment of the present disclosure, wherein, at least two of R₁ to R₃ are, at each occurrence identically or differently, selected from substituted or unsubstituted alkyl having 2 to 20 carbon atoms, substituted or unsubstituted cycloalkyl having 3 to 20 ring carbon atoms, substituted or unsubstituted heteroalkyl having 2 to 20 carbon atoms or a combination thereof; and/or at least two of R₄ to R₆ are, at each occurrence identically or differently, selected from substituted or unsubstituted alkyl having 2 to 20 carbon atoms, substituted or unsubstituted cycloalkyl having 3 to 20 ring carbon atoms, substituted or unsubstituted heteroalkyl having 2 to 20 carbon atoms or a combination thereof.

According to an embodiment of the present disclosure, wherein, L_{b} is, at each occurrence identically or differently, selected from the group consisting of L_{b1} to L_{b322}, and L_{c} is, at each occurrence identically or differently, selected from the group consisting of L_{c1} to L_{c231}, wherein the specific structures of the L_{b1} to L_{b322} and L_{c1} to L_{c231} are referred to claim 13.

According to an embodiment of the present disclosure, wherein, the metal complex has a structure of Ir(Lₐ)₂(L_{b}) or Ir(Lₐ)₂(L_{c}) or Ir(Lₐ)(L_{c})₂ or Ir(Lₐ)(L_{b})(L_{c});
wherein when the metal complex has a structure of Ir(Lₐ)₂(L_{b}), Lₐ is, at each occurrence identically or differently, selected from any one or any two of the group consisting of Lₐ₁ to Lₐ₁₉₀₄, and L_{b} is selected from any one of the group consisting of L_{b1} to L_{b322}; when the metal complex has a structure of Ir(Lₐ)₂(L_{c}), Lₐ is, at each occurrence identically or differently, selected from any one or any two of the group consisting of Lₐ₁ to Lₐ₁₉₀₄, and L_{c} is selected from any one of the group consisting of L_{c1} to L_{c231}; when the metal complex has a structure of Ir(Lₐ)(L_{c})₂, Lₐ is selected from any one of the group consisting of Lₐ₁ to Lₐ₁₉₀₄, and L_{c} is, at each occurrence identically or differently, selected from any one or any two of the group consisting of L_{c1} to L_{c231}; when the metal complex has a structure of Ir(Lₐ)(L_{b})(L_{c}), Lₐ is selected from any one of the group consisting of Lₐ₁ to Lₐ₁₉₀₄, L_{b} is selected from any one of the group consisting of L_{b1} to L_{b322}, and L_{c} is selected from any one of the group consisting of L_{c1} to L_{c231}.

According to an embodiment of the present disclosure, wherein, the metal complex is selected from the group consisting of Compound 1 to Compound 1010, wherein the specific structures of the Compound 1 to Compound 1010 are referred to claim 14.

According to an embodiment of the present disclosure, wherein, the metal complex has a structure of Ir(Lₐ)₂(L_{b}) or Ir(Lₐ)₂(L_{c}) or Ir(Lₐ)(L_{c})₂ or Ir(Lₐ)(L_{b})(L_{c});
wherein when the metal complex has a structure of Ir(Lₐ)₂(L_{b}), Lₐ is, at each occurrence identically or differently, selected from any one or any two of the group consisting of Lₐ₁ to Lₐ₁₉₀₆, and L_{b} is selected from any one of the group consisting of L_{b1} to L_{b322}; when the metal complex has a structure of Ir(Lₐ)₂(L_{c}), Lₐ is, at each occurrence identically or differently, selected from any one or any two of the group consisting of Lₐ₁ to Lₐ₁₉₀₆, and L_{c} is selected from any one of the group consisting of L_{c1} to L_{c231}; when the metal complex has a structure of Ir(Lₐ)(L_{c})₂, Lₐ is selected from any one of the group consisting of Lₐ₁ to Lₐ₁₉₀₆, and L_{c} is, at each occurrence identically or differently, selected from any one or any two of the group consisting of L_{c1} to L_{c231}; when the metal complex has a structure of Ir(Lₐ)(L_{b})(L_{c}), Lₐ is selected from any one of the group consisting of Lₐ₁ to Lₐ₁₉₀₆, L_{b} is selected from any one of the group consisting of L_{b1} to L_{b322}, and L_{c} is selected from any one of the group consisting of L_{c1} to L_{c231}.

According to an embodiment of the present disclosure, wherein, the metal complex is selected from the group consisting of Compound 1 to Compound 1028;
wherein the Compound 1 to Compound 800 and Compound 1011 to Compound 1028 each has a structure of Ir(Lₐ)₂(L_{b}), wherein the two Lₐ are identical, and the Lₐ and L_{b} are respectively selected from the structures listed in the following table:

| Compound No. | Lₐ | L_{b} | Compound No. | Lₐ | L_{b} |
|---|---|---|---|---|---|
| 1 | Lₐ₅ | L_{b1} | 2 | Lₐ₂₁ | L_{b1} |
| 3 | Lₐ₃₅ | L_{b1} | 4 | Lₐ₆₆ | L_{b1} |
| 5 | Lₐ₆₉ | L_{b1} | 6 | Lₐ₇₀ | L_{b1} |
| 7 | Lₐ₇₄ | L_{b1} | 8 | Lₐ₁₂₁ | L_{b1} |
| 9 | Lₐ₁₄₈ | L_{b1} | 10 | Lₐ₁₇₅ | L_{b1} |
| 11 | Lₐ₂₀₇ | L_{b1} | 12 | Lₐ₂₁₂ | L_{b1} |
| 13 | Lₐ₂₃₆ | L_{b1} | 14 | Lₐ₂₅₅ | L_{b1} |
| 15 | Lₐ₂₇₁ | L_{b1} | 16 | Lₐ₂₈₇ | L_{b1} |
| 17 | Lₐ₃₁₉ | L_{b1} | 18 | Lₐ₃₂₀ | L_{b1} |
| 19 | Lₐ₃₃₅ | L_{b1} | 20 | Lₐ₃₉₉ | L_{b1} |
| 21 | Lₐ₄₃₈ | L_{b1} | 22 | Lₐ₄₅₃ | L_{b1} |
| 23 | Lₐ₄₆₉ | L_{b1} | 24 | Lₐ₄₉₇ | L_{b1} |
| 25 | Lₐ₅₀₀ | L_{b1} | 26 | Lₐ₅₂₉ | L_{b1} |
| 27 | Lₐ₆₀₁ | L_{b1} | 28 | Lₐ₆₀₆ | L_{b1} |
| 29 | Lₐ₆₃₇ | L_{b1} | 30 | Lₐ₆₆₅ | L_{b1} |
| 31 | Lₐ₆₈₉ | L_{b1} | 32 | Lₐ₆₉₉ | L_{b1} |
| 33 | Lₐ₇₀₀ | L_{b1} | 34 | Lₐ₇₄₄ | L_{b1} |
| 35 | Lₐ₇₇₇ | L_{b1} | 36 | Lₐ₇₉₃ | L_{b1} |
| 37 | Lₐ₈₁₀ | L_{b1} | 38 | Lₐ₈₄₂ | L_{b1} |
| 39 | Lₐ₈₅₀ | L_{b1} | 40 | Lₐ₉₁₇ | L_{b1} |
| 41 | Lₐ₉₈₂ | L_{b1} | 42 | Lₐ₉₈₉ | L_{b1} |
| 43 | Lₐ₁₀₁₆ | L_{b1} | 44 | Lₐ₁₀₃₁ | L_{b1} |
| 45 | Lₐ₁₀₄₇ | L_{b1} | 46 | Lₐ₁₀₇₉ | L_{b1} |
| 47 | Lₐ₁₁₆₃ | L_{b1} | 47 | Lₐ₁₁₉₁ | L_{b1} |
| 49 | Lₐ₁₁₉₈ | L_{b1} | 50 | Lₐ₁₂₃₆ | L_{b1} |
| 51 | Lₐ₁₂₄₇ | L_{b1} | 52 | Lₐ₁₂₇₆ | L_{b1} |
| 53 | Lₐ₁₃₁₃ | L_{b1} | 54 | Lₐ₁₃₃₆ | L_{b1} |
| 55 | Lₐ₁₃₄₁ | L_{b1} | 56 | Lₐ₁₃₆₄ | L_{b1} |
| 57 | Lₐ₁₃₉₅ | L_{b1} | 58 | Lₐ₁₄₃₇ | L_{b1} |
| 59 | Lₐ₁₄₅₄ | L_{b1} | 60 | Lₐ₁₄₅₅ | L_{b1} |
| 61 | Lₐ₁₄₈₀ | L_{b1} | 62 | Lₐ₁₄₈₇ | L_{b1} |
| 63 | Lₐ₁₄₉₂ | L_{b1} | 64 | Lₐ₁₅₁₀ | L_{b1} |
| 65 | Lₐ₁₅₂₃ | L_{b1} | 66 | Lₐ₁₅₃₁ | L_{b1} |
| 67 | Lₐ₁₅₇₁ | L_{b1} | 68 | Lₐ₁₅₉₁ | L_{b1} |
| 69 | Lₐ₁₆₀₈ | L_{b1} | 70 | Lₐ₁₆₀₉ | L_{b1} |
| 71 | Lₐ₁₆₂₉ | L_{b1} | 72 | Lₐ₁₆₃₀ | L_{b1} |
| 73 | Lₐ₁₆₃₈ | L_{b1} | 74 | Lₐ₁₆₈₈ | L_{b1} |
| 75 | Lₐ₁₇₀₂ | L_{b1} | 76 | Lₐ₁₇₁₇ | L_{b1} |
| 77 | Lₐ₁₇₂₃ | L_{b1} | 78 | Lₐ₁₇₅₃ | L_{b1} |
| 79 | Lₐ₁₇₆₁ | L_{b1} | 80 | Lₐ₁₈₁₃ | L_{b1} |
| 81 | Lₐ₁₈₁₅ | L_{b1} | 82 | Lₐ₁₈₁₉ | L_{b1} |
| 83 | Lₐ₁₈₂₃ | L_{b1} | 84 | Lₐ₁₈₂₉ | L_{b1} |
| 85 | Lₐ₁₈₃₃ | L_{b1} | 86 | Lₐ₁₈₃₉ | L_{b1} |
| 87 | Lₐ₁₈₄₃ | L_{b1} | 88 | Lₐ₁₈₄₉ | L_{b1} |
| 89 | Lₐ₁₈₅₃ | L_{b1} | 90 | Lₐ₁₈₅₅ | L_{b1} |
| 91 | Lₐ₁₈₅₉ | L_{b1} | 92 | Lₐ₁₈₆₃ | L_{b1} |
| 93 | Lₐ₁₈₆₅ | L_{b1} | 94 | Lₐ₁₈₆₉ | L_{b1} |
| 95 | Lₐ₁₈₇₃ | L_{b1} | 96 | Lₐ₁₈₇₅ | L_{b1} |
| 97 | Lₐ₁₈₇₉ | L_{b1} | 98 | Lₐ₁₈₈₃ | L_{b1} |
| 99 | Lₐ₁₈₈₅ | L_{b1} | 100 | Lₐ₁₈₈₉ | L_{b1} |
| 101 | Lₐ₅ | L_{b31} | 102 | Lₐ₂₁ | L_{b31} |
| 103 | Lₐ₃₅ | L_{b31} | 104 | Lₐ₆₆ | L_{b31} |
| 105 | Lₐ₆₉ | L_{b31} | 106 | Lₐ₇₀ | L_{b31} |
| 107 | Lₐ₇₄ | L_{b31} | 108 | Lₐ₁₂₁ | L_{b31} |
| 109 | Lₐ₁₄₈ | L_{b31} | 110 | Lₐ₁₇₅ | L_{b31} |
| 111 | Lₐ₂₀₇ | L_{b31} | 112 | Lₐ₂₁₂ | L_{b31} |
| 113 | Lₐ₂₃₆ | L_{b31} | 114 | Lₐ₂₅₅ | L_{b31} |
| 115 | Lₐ₂₇₁ | L_{b31} | 116 | Lₐ₂₈₇ | L_{b31} |
| 117 | Lₐ₃₁₉ | L_{b31} | 118 | Lₐ₃₂₀ | L_{b31} |
| 119 | Lₐ₃₃₅ | L_{b31} | 120 | Lₐ₃₉₉ | L_{b31} |
| 121 | Lₐ₄₃₈ | L_{b31} | 122 | Lₐ₄₅₃ | L_{b31} |
| 123 | Lₐ₄₆₉ | L_{b31} | 124 | Lₐ₄₉₇ | L_{b31} |
| 125 | Lₐ₅₀₀ | L_{b31} | 126 | Lₐ₅₂₉ | L_{b31} |
| 127 | Lₐ₆₀₁ | L_{b31} | 128 | Lₐ₆₀₆ | L_{b31} |
| 129 | Lₐ₆₃₇ | L_{b31} | 130 | Lₐ₆₆₅ | L_{b31} |
| 131 | Lₐ₆₈₉ | L_{b31} | 132 | Lₐ₆₉₉ | L_{b31} |
| 133 | Lₐ₇₀₀ | L_{b31} | 134 | Lₐ₇₄₄ | L_{b31} |
| 135 | Lₐ₇₇₇ | L_{b31} | 136 | Lₐ₇₉₃ | L_{b31} |
| 137 | Lₐ₈₁₀ | L_{b31} | 138 | Lₐ₈₄₂ | L_{b31} |
| 139 | Lₐ₈₅₀ | L_{b31} | 140 | Lₐ₉₁₇ | L_{b31} |
| 141 | Lₐ₉₈₂ | L_{b31} | 142 | Lₐ₉₈₉ | L_{b31} |
| 143 | Lₐ₁₀₁₆ | L_{b31} | 144 | Lₐ₁₀₃₁ | L_{b31} |
| 145 | Lₐ₁₀₄₇ | L_{b31} | 146 | Lₐ₁₀₇₉ | L_{b31} |
| 147 | Lₐ₁₁₆₃ | L_{b31} | 148 | Lₐ₁₁₉₁ | L_{b31} |
| 149 | Lₐ₁₁₉₈ | L_{b31} | 150 | Lₐ₁₂₃₆ | L_{b31} |
| 151 | Lₐ₁₂₄₇ | L_{b31} | 152 | Lₐ₁₂₇₆ | L_{b31} |
| 153 | Lₐ₁₃₁₃ | L_{b31} | 154 | Lₐ₁₃₃₆ | L_{b31} |
| 155 | Lₐ₁₃₄₁ | L_{b31} | 156 | Lₐ₁₃₆₄ | L_{b31} |
| 157 | Lₐ₁₃₉₅ | L_{b31} | 158 | Lₐ₁₄₃₇ | L_{b31} |
| 159 | Lₐ₁₄₅₄ | L_{b31} | 160 | Lₐ₁₄₅₅ | L_{b31} |
| 161 | Lₐ₁₄₈₀ | L_{b31} | 162 | Lₐ₁₄₈₇ | L_{b31} |
| 163 | Lₐ₁₄₉₂ | L_{b31} | 164 | Lₐ₁₅₁₀ | L_{b31} |
| 165 | Lₐ₁₅₂₃ | L_{b31} | 166 | Lₐ₁₅₃₁ | L_{b31} |
| 167 | Lₐ₁₅₇₁ | L_{b31} | 168 | Lₐ₁₅₉₁ | L_{b31} |
| 169 | Lₐ₁₆₀₈ | L_{b31} | 170 | Lₐ₁₆₀₉ | L_{b31} |
| 171 | Lₐ₁₆₂₉ | L_{b31} | 172 | Lₐ₁₆₃₀ | L_{b31} |
| 173 | Lₐ₁₆₃₈ | L_{b31} | 174 | Lₐ₁₆₈₈ | L_{b31} |
| 175 | Lₐ₁₇₀₂ | L_{b31} | 176 | Lₐ₁₇₁₇ | L_{b31} |
| 177 | Lₐ₁₇₂₃ | L_{b31} | 178 | Lₐ₁₇₅₃ | L_{b31} |
| 179 | Lₐ₁₇₆₁ | L_{b31} | 180 | Lₐ₁₈₁₃ | L_{b31} |
| 181 | Lₐ₁₈₁₅ | L_{b31} | 182 | Lₐ₁₈₁₉ | L_{b31} |
| 183 | Lₐ₁₈₂₃ | L_{b31} | 184 | Lₐ₁₈₂₉ | L_{b31} |
| 185 | Lₐ₁₈₃₃ | L_{b31} | 186 | Lₐ₁₈₃₉ | L_{b31} |
| 187 | Lₐ₁₈₄₃ | L_{b31} | 188 | Lₐ₁₈₄₉ | L_{b31} |
| 189 | Lₐ₁₈₅₃ | L_{b31} | 190 | Lₐ₁₈₅₅ | L_{b31} |
| 191 | Lₐ₁₈₅₉ | L_{b31} | 192 | Lₐ₁₈₆₃ | L_{b31} |
| 193 | Lₐ₁₈₆₅ | L_{b31} | 194 | Lₐ₁₈₆₉ | L_{b31} |
| 195 | Lₐ₁₈₇₃ | L_{b31} | 196 | Lₐ₁₈₇₅ | L_{b31} |
| 197 | Lₐ₁₈₇₉ | L_{b31} | 198 | Lₐ₁₈₈₃ | L_{b31} |
| 199 | Lₐ₁₈₈₅ | L_{b31} | 200 | Lₐ₁₈₈₉ | L_{b31} |
| 201 | Lₐ₅ | L_{b88} | 202 | Lₐ₂₁ | L_{b88} |
| 203 | Lₐ₃₅ | L_{b88} | 204 | Lₐ₆₆ | L_{b88} |
| 205 | Lₐ₆₉ | L_{b88} | 206 | Lₐ₇₀ | L_{b88} |
| 207 | Lₐ₇₄ | L_{b88} | 208 | Lₐ₁₂₁ | L_{b88} |
| 209 | Lₐ₁₄₈ | L_{b88} | 210 | Lₐ₁₇₅ | L_{b88} |
| 211 | Lₐ₂₀₇ | L_{b88} | 212 | Lₐ₂₁₂ | L_{b88} |
| 213 | Lₐ₂₃₆ | L_{b88} | 214 | Lₐ₂₅₅ | L_{b88} |
| 215 | Lₐ₂₇₁ | L_{b88} | 216 | Lₐ₂₈₇ | L_{b88} |
| 217 | Lₐ₃₁₉ | L_{b88} | 218 | Lₐ₃₂₀ | L_{b88} |
| 219 | Lₐ₃₃₅ | L_{b88} | 220 | Lₐ₃₉₉ | L_{b88} |
| 221 | Lₐ₄₃₈ | L_{b88} | 222 | Lₐ₄₅₃ | L_{b88} |
| 223 | Lₐ₄₆₉ | L_{b88} | 224 | Lₐ₄₉₇ | L_{b88} |
| 225 | Lₐ₅₀₀ | L_{b88} | 226 | Lₐ₅₂₉ | L_{b88} |
| 227 | Lₐ₆₀₁ | L_{b88} | 228 | Lₐ₆₀₆ | L_{b88} |
| 229 | Lₐ₆₃₇ | L_{b88} | 230 | Lₐ₆₆₅ | L_{b88} |
| 231 | Lₐ₆₈₉ | L_{b88} | 232 | Lₐ₆₉₉ | L_{b88} |
| 233 | Lₐ₇₀₀ | L_{b88} | 234 | Lₐ₇₄₄ | L_{b88} |
| 235 | Lₐ₇₇₇ | L_{b88} | 236 | Lₐ₇₉₃ | L_{b88} |
| 237 | Lₐ₈₁₀ | L_{b88} | 238 | Lₐ₈₄₂ | L_{b88} |
| 239 | Lₐ₈₅₀ | L_{b88} | 240 | Lₐ₉₁₇ | L_{b88} |
| 241 | Lₐ₉₈₂ | L_{b88} | 242 | Lₐ₉₈₉ | L_{b88} |
| 243 | Lₐ₁₀₁₆ | L_{b88} | 244 | Lₐ₁₀₃₁ | L_{b88} |
| 245 | Lₐ₁₀₄₇ | L_{b88} | 246 | Lₐ₁₀₇₉ | L_{b88} |
| 247 | Lₐ₁₁₆₃ | L_{b88} | 248 | Lₐ₁₁₉₁ | L_{b88} |
| 249 | Lₐ₁₁₉₈ | L_{b88} | 250 | Lₐ₁₂₃₆ | L_{b88} |
| 251 | Lₐ₁₂₄₇ | L_{b88} | 252 | Lₐ₁₂₇₆ | L_{b88} |
| 253 | Lₐ₁₃₁₃ | L_{b88} | 254 | Lₐ₁₃₃₆ | L_{b88} |
| 255 | Lₐ₁₃₄₁ | L_{b88} | 256 | Lₐ₁₃₆₄ | L_{b88} |
| 257 | Lₐ₁₃₉₅ | L_{b88} | 258 | Lₐ₁₄₃₇ | L_{b88} |
| 259 | Lₐ₁₄₅₄ | L_{b88} | 260 | Lₐ₁₄₅₅ | L_{b88} |
| 261 | Lₐ₁₄₈₀ | L_{b88} | 262 | Lₐ₁₄₈₇ | L_{b88} |
| 263 | Lₐ₁₄₉₂ | L_{b88} | 264 | Lₐ₁₅₁₀ | L_{b88} |
| 265 | Lₐ₁₅₂₃ | L_{b88} | 266 | Lₐ₁₅₃₁ | L_{b88} |
| 267 | Lₐ₁₅₇₁ | L_{b88} | 268 | Lₐ₁₅₉₁ | L_{b88} |
| 269 | Lₐ₁₆₀₈ | L_{b88} | 270 | Lₐ₁₆₀₉ | L_{b88} |
| 271 | Lₐ₁₆₂₉ | L_{b88} | 272 | Lₐ₁₆₃₀ | L_{b88} |
| 273 | Lₐ₁₆₃₈ | L_{b88} | 274 | Lₐ₁₆₈₈ | L_{b88} |
| 275 | Lₐ₁₇₀₂ | L_{b88} | 276 | Lₐ₁₇₁₇ | L_{b88} |
| 277 | Lₐ₁₇₂₃ | L_{b88} | 278 | Lₐ₁₇₅₃ | L_{b88} |
| 279 | Lₐ₁₇₆₁ | L_{b88} | 280 | Lₐ₁₈₁₃ | L_{b88} |
| 281 | Lₐ₁₈₁₅ | L_{b88} | 282 | Lₐ₁₈₁₉ | L_{b88} |
| 283 | Lₐ₁₈₂₃ | L_{b88} | 284 | Lₐ₁₈₂₉ | L_{b88} |
| 285 | Lₐ₁₈₃₃ | L_{b88} | 286 | Lₐ₁₈₃₉ | L_{b88} |
| 287 | Lₐ₁₈₄₃ | L_{b88} | 288 | Lₐ₁₈₄₉ | L_{b88} |
| 289 | Lₐ₁₈₅₃ | L_{b88} | 290 | Lₐ₁₈₅₅ | L_{b88} |
| 291 | Lₐ₁₈₅₉ | L_{b88} | 292 | Lₐ₁₈₆₃ | L_{b88} |
| 293 | Lₐ₁₈₆₅ | L_{b88} | 294 | Lₐ₁₈₆₉ | L_{b88} |
| 295 | Lₐ₁₈₇₃ | L_{b88} | 296 | Lₐ₁₈₇₅ | L_{b88} |
| 297 | Lₐ₁₈₇₉ | L_{b88} | 298 | Lₐ₁₈₈₃ | L_{b88} |
| 299 | Lₐ₁₈₈₅ | L_{b88} | 300 | Lₐ₁₈₈₉ | L_{b88} |
| 301 | Lₐ₅ | L_{b122} | 302 | Lₐ₂₁ | L_{b122} |
| 303 | Lₐ₃₅ | L_{b122} | 304 | Lₐ₆₆ | L_{b122} |
| 305 | Lₐ₆₉ | L_{b122} | 306 | Lₐ₇₀ | L_{b122} |
| 307 | Lₐ₇₄ | L_{b122} | 308 | Lₐ₁₂₁ | L_{b122} |
| 309 | Lₐ₁₄₈ | L_{b122} | 310 | Lₐ₁₇₅ | L_{b122} |
| 311 | Lₐ₂₀₇ | L_{b122} | 312 | Lₐ₂₁₂ | L_{b122} |
| 313 | Lₐ₂₃₆ | L_{b122} | 314 | Lₐ₂₅₅ | L_{b122} |
| 315 | Lₐ₂₇₁ | L_{b122} | 316 | Lₐ₂₈₇ | L_{b122} |
| 317 | Lₐ₃₁₉ | L_{b122} | 318 | Lₐ₃₂₀ | L_{b122} |
| 319 | Lₐ₃₃₅ | L_{b122} | 320 | Lₐ₃₉₉ | L_{b122} |
| 321 | Lₐ₄₃₈ | L_{b122} | 322 | Lₐ₄₅₃ | L_{b122} |
| 323 | Lₐ₄₆₉ | L_{b122} | 324 | Lₐ₄₉₇ | L_{b122} |
| 325 | Lₐ₅₀₀ | L_{b122} | 326 | Lₐ₅₂₉ | L_{b122} |
| 327 | Lₐ₆₀₁ | L_{b122} | 328 | Lₐ₆₀₆ | L_{b122} |
| 329 | Lₐ₆₃₇ | L_{b122} | 330 | Lₐ₆₆₅ | L_{b122} |
| 331 | Lₐ₆₈₉ | L_{b122} | 332 | Lₐ₆₉₉ | L_{b122} |
| 333 | Lₐ₇₀₀ | L_{b122} | 334 | Lₐ₇₄₄ | L_{b122} |
| 335 | Lₐ₇₇₇ | L_{b122} | 336 | Lₐ₇₉₃ | L_{b122} |
| 337 | Lₐ₈₁₀ | L_{b122} | 338 | Lₐ₈₄₂ | L_{b122} |
| 339 | Lₐ₈₅₀ | L_{b122} | 340 | Lₐ₉₁₇ | L_{b122} |
| 341 | Lₐ₉₈₂ | L_{b122} | 342 | Lₐ₉₈₉ | L_{b122} |
| 343 | Lₐ₁₀₁₆ | L_{b122} | 344 | Lₐ₁₀₃₁ | L_{b122} |
| 345 | Lₐ₁₀₄₇ | L_{b122} | 346 | Lₐ₁₀₇₉ | L_{b122} |
| 347 | Lₐ₁₁₆₃ | L_{b122} | 348 | Lₐ₁₁₉₁ | L_{b122} |
| 349 | Lₐ₁₁₉₈ | L_{b122} | 350 | Lₐ₁₂₃₆ | L_{b122} |
| 351 | Lₐ₁₂₄₇ | L_{b122} | 352 | Lₐ₁₂₇₆ | L_{b122} |
| 353 | Lₐ₁₃₁₃ | L_{b122} | 354 | Lₐ₁₃₃₆ | L_{b122} |
| 355 | Lₐ₁₃₄₁ | L_{b122} | 356 | Lₐ₁₃₆₄ | L_{b122} |
| 357 | Lₐ₁₃₉₅ | L_{b122} | 358 | Lₐ₁₄₃₇ | L_{b122} |
| 359 | Lₐ₁₄₅₄ | L_{b122} | 360 | Lₐ₁₄₅₅ | L_{b122} |
| 361 | Lₐ₁₄₈₀ | L_{b122} | 362 | Lₐ₁₄₈₇ | L_{b122} |
| 363 | Lₐ₁₄₉₂ | L_{b122} | 364 | Lₐ₁₅₁₀ | L_{b122} |
| 365 | Lₐ₁₅₂₃ | L_{b122} | 366 | Lₐ₁₅₃₁ | L_{b122} |
| 367 | Lₐ₁₅₇₁ | L_{b122} | 368 | Lₐ₁₅₉₁ | L_{b122} |
| 369 | Lₐ₁₆₀₈ | L_{b122} | 370 | Lₐ₁₆₀₉ | L_{b122} |
| 371 | Lₐ₁₆₂₉ | L_{b122} | 372 | Lₐ₁₆₃₀ | L_{b122} |
| 373 | Lₐ₁₆₃₈ | L_{b122} | 374 | Lₐ₁₆₈₈ | L_{b122} |
| 375 | Lₐ₁₇₀₂ | L_{b122} | 376 | Lₐ₁₇₁₇ | L_{b122} |
| 377 | Lₐ₁₇₂₃ | L_{b122} | 378 | Lₐ₁₇₅₃ | L_{b122} |
| 379 | Lₐ₁₇₆₁ | L_{b122} | 380 | Lₐ₁₈₁₃ | L_{b122} |
| 381 | Lₐ₁₈₁₅ | L_{b122} | 382 | Lₐ₁₈₁₉ | L_{b122} |
| 383 | Lₐ₁₈₂₃ | L_{b122} | 384 | Lₐ₁₈₂₉ | L_{b122} |
| 385 | Lₐ₁₈₃₃ | L_{b122} | 386 | Lₐ₁₈₃₉ | L_{b122} |
| 387 | Lₐ₁₈₄₃ | L_{b122} | 388 | Lₐ₁₈₄₉ | L_{b122} |
| 389 | Lₐ₁₈₅₃ | L_{b122} | 390 | Lₐ₁₈₅₅ | L_{b122} |
| 391 | Lₐ₁₈₅₉ | L_{b122} | 392 | Lₐ₁₈₆₃ | L_{b122} |
| 393 | Lₐ₁₈₆₅ | L_{b122} | 394 | Lₐ₁₈₆₉ | L_{b122} |
| 395 | Lₐ₁₈₇₃ | L_{b122} | 396 | Lₐ₁₈₇₅ | L_{b122} |
| 397 | Lₐ₁₈₇₉ | L_{b122} | 398 | Lₐ₁₈₈₃ | L_{b122} |
| 399 | Lₐ₁₈₈₅ | L_{b122} | 400 | Lₐ₁₈₈₉ | L_{b122} |
| 401 | Lₐ₅ | L_{b126} | 402 | Lₐ₂₁ | L_{b126} |
| 403 | Lₐ₃₅ | L_{b126} | 404 | Lₐ₆₆ | L_{b126} |
| 405 | Lₐ₆₉ | L_{b126} | 406 | Lₐ₇₀ | L_{b126} |
| 407 | Lₐ₇₄ | L_{b126} | 408 | Lₐ₁₂₁ | L_{b126} |
| 409 | Lₐ₁₄₈ | L_{b126} | 410 | Lₐ₁₇₅ | L_{b126} |
| 411 | Lₐ₂₀₇ | L_{b126} | 412 | Lₐ₂₁₂ | L_{b126} |
| 413 | Lₐ₂₃₆ | L_{b126} | 414 | Lₐ₂₅₅ | L_{b126} |
| 415 | Lₐ₂₇₁ | L_{b126} | 416 | Lₐ₂₈₇ | L_{b126} |
| 417 | Lₐ₃₁₉ | L_{b126} | 418 | Lₐ₃₂₀ | L_{b126} |
| 419 | Lₐ₃₃₅ | L_{b126} | 420 | Lₐ₃₉₉ | L_{b126} |
| 421 | Lₐ₄₃₈ | L_{b126} | 422 | Lₐ₄₅₃ | L_{b126} |
| 423 | Lₐ₄₆₉ | L_{b126} | 424 | Lₐ₄₉₇ | L_{b126} |
| 425 | Lₐ₅₀₀ | L_{b126} | 426 | Lₐ₅₂₉ | L_{b126} |
| 427 | Lₐ₆₀₁ | L_{b126} | 428 | Lₐ₆₀₆ | L_{b126} |
| 429 | Lₐ₆₃₇ | L_{b126} | 430 | Lₐ₆₆₅ | L_{b126} |
| 431 | Lₐ₆₈₉ | L_{b126} | 432 | Lₐ₆₉₉ | L_{b126} |
| 433 | Lₐ₇₀₀ | L_{b126} | 434 | Lₐ₇₄₄ | L_{b126} |
| 435 | Lₐ₇₇₇ | L_{b126} | 436 | Lₐ₇₉₃ | L_{b126} |
| 437 | Lₐ₈₁₀ | L_{b126} | 438 | Lₐ₈₄₂ | L_{b126} |
| 439 | Lₐ₈₅₀ | L_{b126} | 440 | Lₐ₉₁₇ | L_{b126} |
| 441 | Lₐ₉₈₂ | L_{b126} | 442 | Lₐ₉₈₉ | L_{b126} |
| 443 | Lₐ₁₀₁₆ | L_{b126} | 444 | Lₐ₁₀₃₁ | L_{b126} |
| 445 | Lₐ₁₀₄₇ | L_{b126} | 446 | Lₐ₁₀₇₉ | L_{b126} |
| 447 | Lₐ₁₁₆₃ | L_{b126} | 448 | Lₐ₁₁₉₁ | L_{b126} |
| 449 | Lₐ₁₁₉₈ | L_{b126} | 450 | Lₐ₁₂₃₆ | L_{b126} |
| 451 | Lₐ₁₂₄₇ | L_{b126} | 452 | Lₐ₁₂₇₆ | L_{b126} |
| 453 | Lₐ₁₃₁₃ | L_{b126} | 454 | Lₐ₁₃₃₆ | L_{b126} |
| 455 | Lₐ₁₃₄₁ | L_{b126} | 456 | Lₐ₁₃₆₄ | L_{b126} |
| 457 | Lₐ₁₃₉₅ | L_{b126} | 458 | Lₐ₁₄₃₇ | L_{b126} |
| 459 | Lₐ₁₄₅₄ | L_{b126} | 460 | Lₐ₁₄₅₅ | L_{b126} |
| 461 | Lₐ₁₄₈₀ | L_{b126} | 462 | Lₐ₁₄₈₇ | L_{b126} |
| 463 | Lₐ₁₄₉₂ | L_{b126} | 464 | Lₐ₁₅₁₀ | L_{b126} |
| 465 | Lₐ₁₅₂₃ | L_{b126} | 466 | Lₐ₁₅₃₁ | L_{b126} |
| 467 | Lₐ₁₅₇₁ | L_{b126} | 468 | Lₐ₁₅₉₁ | L_{b126} |
| 469 | Lₐ₁₆₀₈ | L_{b126} | 470 | Lₐ₁₆₀₉ | L_{b126} |
| 471 | Lₐ₁₆₂₉ | L_{b126} | 472 | Lₐ₁₆₃₀ | L_{b126} |
| 473 | Lₐ₁₆₃₈ | L_{b126} | 474 | Lₐ₁₆₈₈ | L_{b126} |
| 475 | Lₐ₁₇₀₂ | L_{b126} | 476 | Lₐ₁₇₁₇ | L_{b126} |
| 477 | Lₐ₁₇₂₃ | L_{b126} | 478 | Lₐ₁₇₅₃ | L_{b126} |
| 479 | Lₐ₁₇₆₁ | L_{b126} | 480 | Lₐ₁₈₁₃ | L_{b126} |
| 481 | Lₐ₁₈₁₅ | L_{b126} | 482 | Lₐ₁₈₁₉ | L_{b126} |
| 483 | Lₐ₁₈₂₃ | L_{b126} | 484 | Lₐ₁₈₂₉ | L_{b126} |
| 485 | Lₐ₁₈₃₃ | L_{b126} | 486 | Lₐ₁₈₃₉ | L_{b126} |
| 487 | Lₐ₁₈₄₃ | L_{b126} | 488 | Lₐ₁₈₄₉ | L_{b126} |
| 489 | Lₐ₁₈₅₃ | L_{b126} | 490 | Lₐ₁₈₅₅ | L_{b126} |
| 491 | Lₐ₁₈₅₉ | L_{b126} | 492 | Lₐ₁₈₆₃ | L_{b126} |
| 493 | Lₐ₁₈₆₅ | L_{b126} | 494 | Lₐ₁₈₆₉ | L_{b126} |
| 495 | Lₐ₁₈₇₃ | L_{b126} | 496 | Lₐ₁₈₇₅ | L_{b126} |
| 497 | Lₐ₁₈₇₉ | L_{b126} | 498 | Lₐ₁₈₈₃ | L_{b126} |
| 499 | Lₐ₁₈₈₅ | L_{b126} | 500 | Lₐ₁₈₈₉ | L_{b126} |
| 501 | Lₐ₅ | L_{b135} | 502 | Lₐ₂₁ | L_{b135} |
| 503 | Lₐ₃₅ | L_{b135} | 504 | Lₐ₆₆ | L_{b135} |
| 505 | Lₐ₆₉ | L_{b135} | 506 | Lₐ₇₀ | L_{b135} |
| 507 | Lₐ₇₄ | L_{b135} | 508 | Lₐ₁₂₁ | L_{b135} |
| 509 | Lₐ₁₄₈ | L_{b135} | 510 | Lₐ₁₇₅ | L_{b135} |
| 511 | Lₐ₂₀₇ | L_{b135} | 512 | Lₐ₂₁₂ | L_{b135} |
| 513 | Lₐ₂₃₆ | L_{b135} | 514 | Lₐ₂₅₅ | L_{b135} |
| 515 | Lₐ₂₇₁ | L_{b135} | 516 | Lₐ₂₈₇ | L_{b135} |
| 517 | Lₐ₃₁₉ | L_{b135} | 518 | Lₐ₃₂₀ | L_{b135} |
| 519 | Lₐ₃₃₅ | L_{b135} | 520 | Lₐ₃₉₉ | L_{b135} |
| 521 | Lₐ₄₃₈ | L_{b135} | 522 | Lₐ₄₅₃ | L_{b135} |
| 523 | Lₐ₄₆₉ | L_{b135} | 524 | Lₐ₄₉₇ | L_{b135} |
| 525 | Lₐ₅₀₀ | L_{b135} | 526 | Lₐ₅₂₉ | L_{b135} |
| 527 | Lₐ₆₀₁ | L_{b135} | 528 | Lₐ₆₀₆ | L_{b135} |
| 529 | Lₐ₆₃₇ | L_{b135} | 530 | Lₐ₆₆₅ | L_{b135} |
| 531 | Lₐ₆₈₉ | L_{b135} | 532 | Lₐ₆₉₉ | L_{b135} |
| 533 | Lₐ₇₀₀ | L_{b135} | 534 | Lₐ₇₄₄ | L_{b135} |
| 535 | Lₐ₇₇₇ | L_{b135} | 536 | Lₐ₇₉₃ | L_{b135} |
| 537 | Lₐ₈₁₀ | L_{b135} | 538 | Lₐ₈₄₂ | L_{b135} |
| 539 | Lₐ₈₅₀ | L_{b135} | 540 | Lₐ₉₁₇ | L_{b135} |
| 541 | Lₐ₉₈₂ | L_{b135} | 542 | Lₐ₉₈₉ | L_{b135} |
| 543 | Lₐ₁₀₁₆ | L_{b135} | 544 | Lₐ₁₀₃₁ | L_{b135} |
| 545 | Lₐ₁₀₄₇ | L_{b135} | 546 | Lₐ₁₀₇₉ | L_{b135} |
| 547 | Lₐ₁₁₆₃ | L_{b135} | 548 | Lₐ₁₁₉₁ | L_{b135} |
| 549 | Lₐ₁₁₉₈ | L_{b135} | 550 | Lₐ₁₂₃₆ | L_{b135} |
| 551 | Lₐ₁₂₄₇ | L_{b135} | 552 | Lₐ₁₂₇₆ | L_{b135} |
| 553 | Lₐ₁₃₁₃ | L_{b135} | 554 | Lₐ₁₃₃₆ | L_{b135} |
| 555 | Lₐ₁₃₄₁ | L_{b135} | 556 | Lₐ₁₃₆₄ | L_{b135} |
| 557 | Lₐ₁₃₉₅ | L_{b135} | 558 | Lₐ₁₄₃₇ | L_{b135} |
| 559 | Lₐ₁₄₅₄ | L_{b135} | 560 | Lₐ₁₄₅₅ | L_{b135} |
| 561 | Lₐ₁₄₈₀ | L_{b135} | 562 | Lₐ₁₄₈₇ | L_{b135} |
| 563 | Lₐ₁₄₉₂ | L_{b135} | 564 | Lₐ₁₅₁₀ | L_{b135} |
| 565 | Lₐ₁₅₂₃ | L_{b135} | 566 | Lₐ₁₅₃₁ | L_{b135} |
| 567 | Lₐ₁₅₇₁ | L_{b135} | 568 | Lₐ₁₅₉₁ | L_{b135} |
| 569 | Lₐ₁₆₀₈ | L_{b135} | 570 | Lₐ₁₆₀₉ | L_{b135} |
| 571 | Lₐ₁₆₂₉ | L_{b135} | 572 | Lₐ₁₆₃₀ | L_{b135} |
| 573 | Lₐ₁₆₃₈ | L_{b135} | 574 | Lₐ₁₆₈₈ | L_{b135} |
| 575 | Lₐ₁₇₀₂ | L_{b135} | 576 | Lₐ₁₇₁₇ | L_{b135} |
| 577 | Lₐ₁₇₂₃ | L_{b135} | 578 | Lₐ₁₇₅₃ | L_{b135} |
| 579 | Lₐ₁₇₆₁ | L_{b135} | 580 | Lₐ₁₈₁₃ | L_{b135} |
| 581 | Lₐ₁₈₁₅ | L_{b135} | 582 | Lₐ₁₈₁₉ | L_{b135} |
| 583 | Lₐ₁₈₂₃ | L_{b135} | 584 | Lₐ₁₈₂₉ | L_{b135} |
| 585 | Lₐ₁₈₃₃ | L_{b135} | 586 | Lₐ₁₈₃₉ | L_{b135} |
| 587 | Lₐ₁₈₄₃ | L_{b135} | 588 | Lₐ₁₈₄₉ | L_{b135} |
| 589 | Lₐ₁₈₅₃ | L_{b135} | 590 | Lₐ₁₈₅₅ | L_{b135} |
| 591 | Lₐ₁₈₅₉ | L_{b135} | 592 | Lₐ₁₈₆₃ | L_{b135} |
| 593 | Lₐ₁₈₆₅ | L_{b135} | 594 | Lₐ₁₈₆₉ | L_{b135} |
| 595 | Lₐ₁₈₇₃ | L_{b135} | 596 | Lₐ₁₈₇₅ | L_{b135} |
| 597 | Lₐ₁₈₇₉ | L_{b135} | 598 | Lₐ₁₈₈₃ | L_{b135} |
| 599 | Lₐ₁₈₈₅ | L_{b135} | 600 | Lₐ₁₈₈₉ | L_{b135} |
| 601 | Lₐ₅ | L_{b165} | 602 | Lₐ₂₁ | L_{b165} |
| 603 | Lₐ₃₅ | L_{b165} | 604 | Lₐ₆₆ | L_{b165} |
| 605 | Lₐ₆₉ | L_{b165} | 606 | Lₐ₇₀ | L_{b165} |
| 607 | Lₐ₇₄ | L_{b165} | 608 | Lₐ₁₂₁ | L_{b165} |
| 609 | Lₐ₁₄₈ | L_{b165} | 610 | Lₐ₁₇₅ | L_{b165} |
| 611 | Lₐ₂₀₇ | L_{b165} | 612 | Lₐ₂₁₂ | L_{b165} |
| 613 | Lₐ₂₃₆ | L_{b165} | 614 | Lₐ₂₅₅ | L_{b165} |
| 615 | Lₐ₂₇₁ | L_{b165} | 616 | Lₐ₂₈₇ | L_{b165} |
| 617 | Lₐ₃₁₉ | L_{b165} | 618 | Lₐ₃₂₀ | L_{b165} |
| 619 | Lₐ₃₃₅ | L_{b165} | 620 | Lₐ₃₉₉ | L_{b165} |
| 621 | Lₐ₄₃₈ | L_{b165} | 622 | Lₐ₄₅₃ | L_{b165} |
| 623 | Lₐ₄₆₉ | L_{b165} | 624 | Lₐ₄₉₇ | L_{b165} |
| 625 | Lₐ₅₀₀ | L_{b165} | 626 | Lₐ₅₂₉ | L_{b165} |
| 627 | Lₐ₆₀₁ | L_{b165} | 628 | Lₐ₆₀₆ | L_{b165} |
| 629 | Lₐ₆₃₇ | L_{b165} | 630 | Lₐ₆₆₅ | L_{b165} |
| 631 | Lₐ₆₈₉ | L_{b165} | 632 | Lₐ₆₉₉ | L_{b165} |
| 633 | Lₐ₇₀₀ | L_{b165} | 634 | Lₐ₇₄₄ | L_{b165} |
| 635 | Lₐ₇₇₇ | L_{b165} | 636 | Lₐ₇₉₃ | L_{b165} |
| 637 | Lₐ₈₁₀ | L_{b165} | 638 | Lₐ₈₄₂ | L_{b165} |
| 639 | Lₐ₈₅₀ | L_{b165} | 640 | Lₐ₉₁₇ | L_{b165} |
| 641 | Lₐ₉₈₂ | L_{b165} | 642 | Lₐ₉₈₉ | L_{b165} |
| 643 | Lₐ₁₀₁₆ | L_{b165} | 644 | Lₐ₁₀₃₁ | L_{b165} |
| 645 | Lₐ₁₀₄₇ | L_{b165} | 646 | Lₐ₁₀₇₉ | L_{b165} |
| 647 | Lₐ₁₁₆₃ | L_{b165} | 648 | Lₐ₁₁₉₁ | L_{b165} |
| 649 | Lₐ₁₁₉₈ | L_{b165} | 650 | Lₐ₁₂₃₆ | L_{b165} |
| 651 | Lₐ₁₂₄₇ | L_{b165} | 652 | Lₐ₁₂₇₆ | L_{b165} |
| 653 | Lₐ₁₃₁₃ | L_{b165} | 654 | Lₐ₁₃₃₆ | L_{b165} |
| 655 | Lₐ₁₃₄₁ | L_{b165} | 656 | Lₐ₁₃₆₄ | L_{b165} |
| 657 | Lₐ₁₃₉₅ | L_{b165} | 658 | Lₐ₁₄₃₇ | L_{b165} |
| 659 | Lₐ₁₄₅₄ | L_{b165} | 660 | Lₐ₁₄₅₅ | L_{b165} |
| 661 | Lₐ₁₄₈₀ | L_{b165} | 662 | Lₐ₁₄₈₇ | L_{b165} |
| 663 | Lₐ₁₄₉₂ | L_{b165} | 664 | Lₐ₁₅₁₀ | L_{b165} |
| 665 | Lₐ₁₅₂₃ | L_{b165} | 666 | Lₐ₁₅₃₁ | L_{b165} |
| 667 | Lₐ₁₅₇₁ | L_{b165} | 668 | Lₐ₁₅₉₁ | L_{b165} |
| 669 | Lₐ₁₆₀₈ | L_{b165} | 670 | Lₐ₁₆₀₉ | L_{b165} |
| 671 | Lₐ₁₆₂₉ | L_{b165} | 672 | Lₐ₁₆₃₀ | L_{b165} |
| 673 | Lₐ₁₆₃₈ | L_{b165} | 674 | Lₐ₁₆₈₈ | L_{b165} |
| 675 | Lₐ₁₇₀₂ | L_{b165} | 676 | Lₐ₁₇₁₇ | L_{b165} |
| 677 | Lₐ₁₇₂₃ | L_{b165} | 678 | Lₐ₁₇₅₃ | L_{b165} |
| 679 | Lₐ₁₇₆₁ | L_{b165} | 680 | Lₐ₁₈₁₃ | L_{b165} |
| 681 | Lₐ₁₈₁₅ | L_{b165} | 682 | Lₐ₁₈₁₉ | L_{b165} |
| 683 | Lₐ₁₈₂₃ | L_{b165} | 684 | Lₐ₁₈₂₉ | L_{b165} |
| 685 | Lₐ₁₈₃₃ | L_{b165} | 686 | Lₐ₁₈₃₉ | L_{b165} |
| 687 | Lₐ₁₈₄₃ | L_{b165} | 688 | Lₐ₁₈₄₉ | L_{b165} |
| 689 | Lₐ₁₈₅₃ | L_{b165} | 690 | Lₐ₁₈₅₅ | L_{b165} |
| 691 | Lₐ₁₈₅₉ | L_{b165} | 692 | Lₐ₁₈₆₃ | L_{b165} |
| 693 | Lₐ₁₈₆₅ | L_{b165} | 694 | Lₐ₁₈₆₉ | L_{b165} |
| 695 | Lₐ₁₈₇₃ | L_{b165} | 696 | Lₐ₁₈₇₅ | L_{b165} |
| 697 | Lₐ₁₈₇₉ | L_{b165} | 698 | Lₐ₁₈₈₃ | L_{b165} |
| 699 | Lₐ₁₈₈₅ | L_{b165} | 700 | Lₐ₁₈₈₉ | L_{b165} |
| 701 | Lₐ₅ | L_{b212} | 702 | Lₐ₂₁ | L_{b212} |
| 703 | Lₐ₃₅ | L_{b212} | 704 | Lₐ₆₆ | L_{b212} |
| 705 | Lₐ₆₉ | L_{b212} | 706 | Lₐ₇₀ | L_{b212} |
| 707 | Lₐ₇₄ | L_{b212} | 708 | Lₐ₁₂₁ | L_{b212} |
| 709 | Lₐ₁₄₈ | L_{b212} | 710 | Lₐ₁₇₅ | L_{b212} |
| 711 | Lₐ₂₀₇ | L_{b212} | 712 | Lₐ₂₁₂ | L_{b212} |
| 713 | Lₐ₂₃₆ | L_{b212} | 714 | Lₐ₂₅₅ | L_{b212} |
| 715 | Lₐ₂₇₁ | L_{b212} | 716 | Lₐ₂₈₇ | L_{b212} |
| 717 | Lₐ₃₁₉ | L_{b212} | 718 | Lₐ₃₂₀ | L_{b212} |
| 719 | Lₐ₃₃₅ | L_{b212} | 720 | Lₐ₃₉₉ | L_{b212} |
| 721 | Lₐ₄₃₈ | L_{b212} | 722 | Lₐ₄₅₃ | L_{b212} |
| 723 | Lₐ₄₆₉ | L_{b212} | 724 | Lₐ₄₉₇ | L_{b212} |
| 725 | Lₐ₅₀₀ | L_{b212} | 726 | Lₐ₅₂₉ | L_{b212} |
| 727 | Lₐ₆₀₁ | L_{b212} | 728 | Lₐ₆₀₆ | L_{b212} |
| 729 | Lₐ₆₃₇ | L_{b212} | 730 | Lₐ₆₆₅ | L_{b212} |
| 731 | Lₐ₆₈₉ | L_{b212} | 732 | Lₐ₆₉₉ | L_{b212} |
| 733 | Lₐ₇₀₀ | L_{b212} | 734 | Lₐ₇₄₄ | L_{b212} |
| 735 | Lₐ₇₇₇ | L_{b212} | 736 | Lₐ₇₉₃ | L_{b212} |
| 737 | Lₐ₈₁₀ | L_{b212} | 738 | Lₐ₈₄₂ | L_{b212} |
| 739 | Lₐ₈₅₀ | L_{b212} | 740 | Lₐ₉₁₇ | L_{b212} |
| 741 | Lₐ₉₈₂ | L_{b212} | 742 | Lₐ₉₈₉ | L_{b212} |
| 743 | Lₐ₁₀₁₆ | L_{b212} | 744 | Lₐ₁₀₃₁ | L_{b212} |
| 745 | Lₐ₁₀₄₇ | L_{b212} | 746 | Lₐ₁₀₇₉ | L_{b212} |
| 747 | Lₐ₁₁₆₃ | L_{b212} | 748 | Lₐ₁₁₉₁ | L_{b212} |
| 749 | Lₐ₁₁₉₈ | L_{b212} | 750 | Lₐ₁₂₃₆ | L_{b212} |
| 751 | Lₐ₁₂₄₇ | L_{b212} | 752 | Lₐ₁₂₇₆ | L_{b212} |
| 753 | Lₐ₁₃₁₃ | L_{b212} | 754 | Lₐ₁₃₃₆ | L_{b212} |
| 755 | Lₐ₁₃₄₁ | L_{b212} | 756 | Lₐ₁₃₆₄ | L_{b212} |
| 757 | Lₐ₁₃₉₅ | L_{b212} | 758 | Lₐ₁₄₃₇ | L_{b212} |
| 759 | Lₐ₁₄₅₄ | L_{b212} | 760 | Lₐ₁₄₅₅ | L_{b212} |
| 761 | Lₐ₁₄₈₀ | L_{b212} | 762 | Lₐ₁₄₈₇ | L_{b212} |
| 763 | Lₐ₁₄₉₂ | L_{b212} | 764 | Lₐ₁₅₁₀ | L_{b212} |
| 765 | Lₐ₁₅₂₃ | L_{b212} | 766 | Lₐ₁₅₃₁ | L_{b212} |
| 767 | Lₐ₁₅₇₁ | L_{b212} | 768 | Lₐ₁₅₉₁ | L_{b212} |
| 769 | Lₐ₁₆₀₈ | L_{b212} | 770 | Lₐ₁₆₀₉ | L_{b212} |
| 771 | Lₐ₁₆₂₉ | L_{b212} | 772 | Lₐ₁₆₃₀ | L_{b212} |
| 773 | Lₐ₁₆₃₈ | L_{b212} | 774 | Lₐ₁₆₈₈ | L_{b212} |
| 775 | Lₐ₁₇₀₂ | L_{b212} | 776 | Lₐ₁₇₁₇ | L_{b212} |
| 777 | Lₐ₁₇₂₃ | L_{b212} | 778 | Lₐ₁₇₅₃ | L_{b212} |
| 779 | Lₐ₁₇₆₁ | L_{b212} | 780 | Lₐ₁₈₁₃ | L_{b212} |
| 781 | Lₐ₁₈₁₅ | L_{b212} | 782 | Lₐ₁₈₁₉ | L_{b212} |
| 783 | Lₐ₁₈₂₃ | L_{b212} | 784 | Lₐ₁₈₂₉ | L_{b212} |
| 785 | Lₐ₁₈₃₃ | L_{b212} | 786 | Lₐ₁₈₃₉ | L_{b212} |
| 787 | Lₐ₁₈₄₃ | L_{b212} | 788 | Lₐ₁₈₄₉ | L_{b212} |
| 789 | Lₐ₁₈₅₃ | L_{b212} | 790 | Lₐ₁₈₅₅ | L_{b212} |
| 791 | Lₐ₁₈₅₉ | L_{b212} | 792 | Lₐ₁₈₆₃ | L_{b212} |
| 793 | Lₐ₁₈₆₅ | L_{b212} | 794 | Lₐ₁₈₆₉ | L_{b212} |
| 795 | Lₐ₁₈₇₃ | L_{b212} | 796 | Lₐ₁₈₇₅ | L_{b212} |
| 797 | Lₐ₁₈₇₉ | L_{b212} | 798 | Lₐ₁₈₈₃ | L_{b212} |
| 799 | Lₐ₁₈₈₅ | L_{b212} | 800 | Lₐ₁₈₈₉ | L_{b212} |
| 1011 | Lₐ₁₀₈₁ | L_{b122} | 1012 | Lₐ₁₀₈₄ | L_{b122} |
| 1013 | Lₐ₁₄₈₈ | L_{b122} | 1014 | Lₐ₁₈₁₂ | L_{b122} |
| 1015 | Lₐ₁₉₀₅ | L_{b122} | 1016 | Lₐ₁₉₀₆ | L_{b122} |
| 1017 | Lₐ₁₀₈₁ | L_{b126} | 1018 | Lₐ₁₀₈₄ | L_{b126} |
| 1019 | Lₐ₁₄₈₈ | L_{b126} | 1020 | Lₐ₁₈₁₂ | L_{b126} |
| 1021 | Lₐ₁₉₀₅ | L_{b126} | 1022 | Lₐ₁₉₀₆ | L_{b126} |
| 1023 | Lₐ₁₀₈₁ | L_{b135} | 1024 | Lₐ₁₀₈₄ | L_{b135} |
| 1025 | Lₐ₁₄₈₈ | L_{b135} | 1026 | Lₐ₁₈₁₂ | L_{b135} |
| 1027 | Lₐ₁₉₀₅ | L_{b135} | 1028 | Lₐ₁₉₀₆ | L_{b135} |

;
wherein Compound 801 to Compound 1010 each has a structure of Ir(Lₐ)₂(L_{b}), wherein the two Lₐ are different, and the Lₐ and L_{b} are respectively selected from the structures listed in the following table:

| Compound No. | Lₐ | Lₐ | L_{b} | Compound No. | Lₐ | Lₐ | L_{b} |
|---|---|---|---|---|---|---|---|
| 801 | Lₐ₉₈₂ | Lₐ₆₉ | L_{b31} | 802 | Lₐ₉₈₂ | Lₐ₂₀₇ | L_{b31} |
| 803 | Lₐ₉₈₂ | Lₐ₃₁₉ | L_{b31} | 804 | Lₐ₉₈₂ | Lₐ₃₉₉ | L_{b31} |
| 805 | Lₐ₉₈₂ | Lₐ₈₄₂ | L_{b31} | 806 | Lₐ₉₈₂ | Lₐ₁₄₃₇ | L_{b31} |
| 807 | Lₐ₉₈₂ | Lₐ₁₅₇₁ | L_{b31} | 808 | Lₐ₉₈₂ | Lₐ₁₆₈₈ | L_{b31} |
| 809 | Lₐ₉₈₂ | Lₐ₉₈₉ | L_{b31} | 810 | Lₐ₉₈₂ | Lₐ₁₈₁₃ | L_{b31} |
| 811 | Lₐ₉₈₂ | Lₐ₈₄₂ | L_{b31} | 812 | Lₐ₁₈₈₉ | Lₐ₁₈₁₉ | L_{b31} |
| 813 | Lₐ₉₈₂ | Lₐ₁₈₄₉ | L_{b31} | 814 | Lₐ₉₈₂ | Lₐ₁₈₆₅ | L_{b31} |
| 815 | Lₐ₉₈₂ | Lₐ₁₈₇₅ | L_{b31} | 816 | Lₐ₃₁₉ | Lₐ₁₈₆₉ | L_{b31} |
| 817 | Lₐ₂₁₂ | Lₐ₁₅₇₁ | L_{b31} | 818 | Lₐ₁₆₈₈ | Lₐ₁₈₆₅ | L_{b31} |
| 819 | Lₐ₁₄₃₇ | Lₐ₁₈₂₉ | L_{b31} | 820 | Lₐ₁₈₆₅ | Lₐ₁₈₈₅ | L_{b31} |
| 821 | Lₐ₁₅₇₁ | Lₐ₁₈₅₅ | L_{b31} | 822 | Lₐ₉₈₉ | Lₐ₁₈₇₃ | L_{b31} |
| 823 | Lₐ₈₄₂ | Lₐ₁₃₈₄ | L_{b31} | 824 | Lₐ₁₈₃₃ | Lₐ₁₈₈₉ | L_{b31} |
| 825 | Lₐ₁₈₆₉ | Lₐ₂₄ | L_{b31} | 826 | Lₐ₁₈₈₉ | Lₐ₁₃₄ | L_{b31} |
| 827 | Lₐ₁₄₃₇ | Lₐ₂₁₂ | L_{b31} | 828 | Lₐ₁₄₃₇ | Lₐ₂₀₇ | L_{b31} |
| 829 | Lₐ₁₈₁₉ | Lₐ₁₈₂₃ | L_{b31} | 830 | Lₐ₁₈₆₃ | Lₐ₁₈₆₅ | L_{b31} |
| 831 | Lₐ₉₈₂ | Lₐ₆₉ | L_{b88} | 832 | Lₐ₉₈₂ | Lₐ₂₀₇ | L_{b88} |
| 833 | Lₐ₉₈₂ | Lₐ₃₁₉ | L_{b88} | 834 | Lₐ₉₈₂ | Lₐ₃₉₉ | L_{b88} |
| 835 | Lₐ₉₈₂ | Lₐ₈₄₂ | L_{b88} | 836 | Lₐ₉₈₂ | Lₐ₁₄₃₇ | L_{b88} |
| 837 | Lₐ₉₈₂ | Lₐ₁₅₇₁ | L_{b88} | 838 | Lₐ₉₈₂ | Lₐ₁₆₈₈ | L_{b88} |
| 839 | Lₐ₉₈₂ | Lₐ₉₈₉ | L_{b88} | 840 | Lₐ₉₈₂ | Lₐ₁₈₁₃ | L_{b88} |
| 841 | Lₐ₉₈₂ | Lₐ₈₄₂ | L_{b88} | 842 | Lₐ₁₈₈₉ | Lₐ₁₈₁₉ | L_{b88} |
| 843 | Lₐ₉₈₂ | Lₐ₁₈₄₉ | L_{b88} | 844 | Lₐ₉₈₂ | Lₐ₁₈₆₅ | L_{b88} |
| 845 | Lₐ₉₈₂ | Lₐ₁₈₇₅ | L_{b88} | 846 | Lₐ₃₁₉ | Lₐ₁₈₆₉ | L_{b88} |
| 847 | Lₐ₂₁₂ | Lₐ₁₅₇₁ | L_{b88} | 848 | Lₐ₁₆₈₈ | Lₐ₁₈₆₅ | L_{b88} |
| 849 | Lₐ₁₄₃₇ | Lₐ₁₈₂₉ | L_{b88} | 850 | Lₐ₁₈₆₅ | Lₐ₁₈₈₅ | L_{b88} |
| 851 | Lₐ₁₅₇₁ | Lₐ₁₈₅₅ | L_{b88} | 852 | Lₐ₉₈₉ | Lₐ₁₈₇₃ | L_{b88} |
| 853 | Lₐ₈₄₂ | Lₐ₁₃₈₄ | L_{b88} | 854 | Lₐ₁₈₃₃ | Lₐ₁₈₈₉ | L_{b88} |
| 855 | Lₐ₁₈₆₉ | Lₐ₂₄ | L_{b88} | 856 | Lₐ₁₈₈₉ | Lₐ₁₃₄ | L_{b88} |
| 857 | Lₐ₁₄₃₇ | Lₐ₂₁₂ | L_{b88} | 858 | Lₐ₁₄₃₇ | Lₐ₂₀₇ | L_{b88} |
| 859 | Lₐ₁₈₁₉ | Lₐ₁₈₂₃ | L_{b88} | 860 | Lₐ₁₈₆₃ | Lₐ₁₈₆₅ | L_{b88} |
| 861 | Lₐ₉₈₂ | Lₐ₆₉ | L_{b122} | 862 | Lₐ₉₈₂ | Lₐ₂₀₇ | L_{b122} |
| 863 | Lₐ₉₈₂ | Lₐ₃₁₉ | L_{b122} | 864 | Lₐ₉₈₂ | Lₐ₃₉₉ | L_{b122} |
| 865 | Lₐ₉₈₂ | Lₐ₈₄₂ | L_{b122} | 866 | Lₐ₉₈₂ | Lₐ₁₄₃₇ | L_{b122} |
| 867 | Lₐ₉₈₂ | Lₐ₁₅₇₁ | L_{b122} | 868 | Lₐ₉₈₂ | Lₐ₁₆₈₈ | L_{b122} |
| 869 | Lₐ₉₈₂ | Lₐ₉₈₉ | L_{b122} | 870 | Lₐ₉₈₂ | Lₐ₁₈₁₃ | L_{b122} |
| 871 | Lₐ₉₈₂ | Lₐ₈₄₂ | L_{b122} | 872 | Lₐ₁₈₈₉ | Lₐ₁₈₁₉ | L_{b122} |
| 873 | Lₐ₉₈₂ | Lₐ₁₈₄₉ | L_{b122} | 874 | Lₐ₉₈₂ | Lₐ₁₈₆₅ | L_{b122} |
| 875 | Lₐ₉₈₂ | Lₐ₁₈₇₅ | L_{b122} | 876 | Lₐ₃₁₉ | Lₐ₁₈₆₉ | L_{b122} |
| 877 | Lₐ₂₁₂ | Lₐ₁₅₇₁ | L_{b122} | 878 | Lₐ₁₆₈₈ | Lₐ₁₈₆₅ | L_{b122} |
| 879 | Lₐ₁₄₃₇ | Lₐ₁₈₂₉ | L_{b122} | 880 | Lₐ₁₈₆₅ | Lₐ₁₈₈₅ | L_{b122} |
| 881 | Lₐ₁₅₇₁ | Lₐ₁₈₅₅ | L_{b122} | 882 | Lₐ₉₈₉ | Lₐ₁₈₇₃ | L_{b122} |
| 883 | Lₐ₈₄₂ | Lₐ₁₃₈₄ | L_{b122} | 884 | Lₐ₁₈₃₃ | Lₐ₁₈₈₉ | L_{b122} |
| 885 | Lₐ₁₈₆₉ | Lₐ₂₄ | L_{b122} | 886 | Lₐ₁₈₈₉ | Lₐ₁₃₄ | L_{b122} |
| 887 | Lₐ₁₄₃₇ | Lₐ₂₁₂ | L_{b122} | 888 | Lₐ₁₄₃₇ | Lₐ₂₀₇ | L_{b122} |
| 889 | Lₐ₁₈₁₉ | Lₐ₁₈₂₃ | L_{b122} | 890 | Lₐ₁₈₆₃ | Lₐ₁₈₆₅ | L_{b122} |
| 891 | Lₐ₉₈₂ | Lₐ₆₉ | L_{b126} | 892 | Lₐ₉₈₂ | Lₐ₂₀₇ | L_{b126} |
| 893 | Lₐ₉₈₂ | Lₐ₃₁₉ | L_{b126} | 894 | Lₐ₉₈₂ | Lₐ₃₉₉ | L_{b126} |
| 895 | Lₐ₉₈₂ | Lₐ₈₄₂ | L_{b126} | 896 | Lₐ₉₈₂ | Lₐ₁₄₃₇ | L_{b126} |
| 897 | Lₐ₉₈₂ | Lₐ₁₅₇₁ | L_{b126} | 898 | Lₐ₉₈₂ | Lₐ₁₆₈₈ | L_{b126} |
| 899 | Lₐ₉₈₂ | Lₐ₉₈₉ | L_{b126} | 900 | Lₐ₉₈₂ | Lₐ₁₈₁₃ | L_{b126} |
| 901 | Lₐ₉₈₂ | Lₐ₈₄₂ | L_{b126} | 902 | Lₐ₁₈₈₉ | Lₐ₁₈₁₉ | L_{b126} |
| 903 | Lₐ₉₈₂ | Lₐ₁₈₄₉ | L_{b126} | 904 | Lₐ₉₈₂ | Lₐ₁₈₆₅ | L_{b126} |
| 905 | Lₐ₉₈₂ | Lₐ₁₈₇₅ | L_{b126} | 906 | Lₐ₃₁₉ | Lₐ₁₈₆₉ | L_{b126} |
| 907 | Lₐ₂₁₂ | Lₐ₁₅₇₁ | L_{b126} | 908 | Lₐ₁₆₈₈ | Lₐ₁₈₆₅ | L_{b126} |
| 909 | Lₐ₁₄₃₇ | Lₐ₁₈₂₉ | L_{b126} | 910 | Lₐ₁₈₆₅ | Lₐ₁₈₈₅ | L_{b126} |
| 911 | Lₐ₁₅₇₁ | Lₐ₁₈₅₅ | L_{b126} | 912 | Lₐ₉₈₉ | Lₐ₁₈₇₃ | L_{b126} |
| 913 | Lₐ₈₄₂ | Lₐ₁₃₈₄ | L_{b126} | 914 | Lₐ₁₈₃₃ | Lₐ₁₈₈₉ | L_{b126} |
| 915 | Lₐ₁₈₆₉ | Lₐ₂₄ | L_{b126} | 916 | Lₐ₁₈₈₉ | Lₐ₁₃₄ | L_{b126} |
| 917 | Lₐ₁₄₃₇ | Lₐ₂₁₂ | L_{b126} | 918 | Lₐ₁₄₃₇ | Lₐ₂₀₇ | L_{b126} |
| 919 | Lₐ₁₈₁₉ | Lₐ₁₈₂₃ | L_{b126} | 920 | Lₐ₁₈₆₃ | Lₐ₁₈₆₅ | L_{b126} |
| 921 | Lₐ₉₈₂ | Lₐ₆₉ | L_{b135} | 922 | Lₐ₉₈₂ | Lₐ₂₀₇ | L_{b135} |
| 923 | Lₐ₉₈₂ | Lₐ₃₁₉ | L_{b135} | 924 | Lₐ₉₈₂ | Lₐ₃₉₉ | L_{b135} |
| 925 | Lₐ₉₈₂ | Lₐ₈₄₂ | L_{b135} | 926 | Lₐ₉₈₂ | Lₐ₁₄₃₇ | L_{b135} |
| 927 | Lₐ₉₈₂ | Lₐ₁₅₇₁ | L_{b135} | 928 | Lₐ₉₈₂ | Lₐ₁₆₈₈ | L_{b135} |
| 929 | Lₐ₉₈₂ | Lₐ₉₈₉ | L_{b135} | 930 | Lₐ₉₈₂ | Lₐ₁₈₁₃ | L_{b135} |
| 931 | Lₐ₉₈₂ | Lₐ₈₄₂ | L_{b135} | 932 | Lₐ₁₈₈₉ | Lₐ₁₈₁₉ | L_{b135} |
| 933 | Lₐ₉₈₂ | Lₐ₁₈₄₉ | L_{b135} | 934 | Lₐ₉₈₂ | Lₐ₁₈₆₅ | L_{b135} |
| 935 | Lₐ₉₈₂ | Lₐ₁₈₇₅ | L_{b135} | 936 | Lₐ₃₁₉ | Lₐ₁₈₆₉ | L_{b135} |
| 937 | Lₐ₂₁₂ | Lₐ₁₅₇₁ | L_{b135} | 938 | Lₐ₁₆₈₈ | Lₐ₁₈₆₅ | L_{b135} |
| 939 | Lₐ₁₄₃₇ | Lₐ₁₈₂₉ | L_{b135} | 940 | Lₐ₁₈₆₅ | Lₐ₁₈₈₅ | L_{b135} |
| 941 | Lₐ₁₅₇₁ | Lₐ₁₈₅₅ | L_{b135} | 942 | Lₐ₉₈₉ | Lₐ₁₈₇₃ | L_{b135} |
| 943 | Lₐ₈₄₂ | Lₐ₁₃₈₄ | L_{b135} | 944 | Lₐ₁₈₃₃ | Lₐ₁₈₈₉ | L_{b135} |
| 945 | Lₐ₁₈₆₉ | Lₐ₂₄ | L_{b135} | 946 | Lₐ₁₈₈₉ | Lₐ₁₃₄ | L_{b135} |
| 947 | Lₐ₁₄₃₇ | Lₐ₂₁₂ | L_{b135} | 948 | Lₐ₁₄₃₇ | Lₐ₂₀₇ | L_{b135} |
| 949 | Lₐ₁₈₁₉ | Lₐ₁₈₂₃ | L_{b135} | 950 | Lₐ₁₈₆₃ | Lₐ₁₈₆₅ | L_{b135} |
| 951 | Lₐ₉₈₂ | Lₐ₆₉ | L_{b165} | 952 | Lₐ₉₈₂ | Lₐ₂₀₇ | L_{b165} |
| 953 | Lₐ₉₈₂ | Lₐ₃₁₉ | L_{b165} | 954 | Lₐ₉₈₂ | Lₐ₃₉₉ | L_{b165} |
| 955 | Lₐ₉₈₂ | Lₐ₈₄₂ | L_{b165} | 956 | Lₐ₉₈₂ | Lₐ₁₄₃₇ | L_{b165} |
| 957 | Lₐ₉₈₂ | Lₐ₁₅₇₁ | L_{b165} | 958 | Lₐ₉₈₂ | Lₐ₁₆₈₈ | L_{b165} |
| 959 | Lₐ₉₈₂ | Lₐ₉₈₉ | L_{b165} | 960 | Lₐ₉₈₂ | Lₐ₁₈₁₃ | L_{b165} |
| 961 | Lₐ₉₈₂ | Lₐ₈₄₂ | L_{b165} | 962 | Lₐ₁₈₈₉ | Lₐ₁₈₁₉ | L_{b165} |
| 963 | Lₐ₉₈₂ | Lₐ₁₈₄₉ | L_{b165} | 964 | Lₐ₉₈₂ | Lₐ₁₈₆₅ | L_{b165} |
| 965 | Lₐ₉₈₂ | Lₐ₁₈₇₅ | L_{b165} | 966 | Lₐ₃₁₉ | Lₐ₁₈₆₉ | L_{b165} |
| 967 | Lₐ₂₁₂ | Lₐ₁₅₇₁ | L_{b165} | 968 | Lₐ₁₆₈₈ | Lₐ₁₈₆₅ | L_{b165} |
| 969 | Lₐ₁₄₃₇ | Lₐ₁₈₂₉ | L_{b165} | 970 | Lₐ₁₈₆₅ | Lₐ₁₈₈₅ | L_{b165} |
| 971 | Lₐ₁₅₇₁ | Lₐ₁₈₅₅ | L_{b165} | 972 | Lₐ₉₈₉ | Lₐ₁₈₇₃ | L_{b165} |
| 973 | Lₐ₈₄₂ | Lₐ₁₃₈₄ | L_{b165} | 974 | Lₐ₁₈₃₃ | Lₐ₁₈₈₉ | L_{b165} |
| 975 | Lₐ₁₈₆₉ | Lₐ₂₄ | L_{b165} | 976 | Lₐ₁₈₈₉ | Lₐ₁₃₄ | L_{b165} |
| 977 | Lₐ₁₄₃₇ | Lₐ₂₁₂ | L_{b165} | 978 | Lₐ₁₄₃₇ | Lₐ₂₀₇ | L_{b165} |
| 979 | Lₐ₁₈₁₉ | Lₐ₁₈₂₃ | L_{b165} | 980 | Lₐ₁₈₆₃ | Lₐ₁₈₆₅ | L_{b165} |
| 981 | Lₐ₉₈₂ | Lₐ₆₉ | L_{b212} | 982 | Lₐ₉₈₂ | Lₐ₂₀₇ | L_{b212} |
| 983 | Lₐ₉₈₂ | Lₐ₃₁₉ | L_{b212} | 994 | Lₐ₉₈₂ | Lₐ₃₉₉ | L_{b212} |
| 985 | Lₐ₉₈₂ | Lₐ₈₄₂ | L_{b212} | 986 | Lₐ₉₈₂ | Lₐ₁₄₃₇ | L_{b212} |
| 987 | Lₐ₉₈₂ | Lₐ₁₅₇₁ | L_{b212} | 988 | Lₐ₉₈₂ | Lₐ₁₆₈₈ | L_{b212} |
| 989 | Lₐ₉₈₂ | Lₐ₉₈₉ | L_{b212} | 990 | Lₐ₉₈₂ | Lₐ₁₈₁₃ | L_{b212} |
| 991 | Lₐ₉₈₂ | Lₐ₈₄₂ | L_{b212} | 992 | Lₐ₁₈₈₉ | Lₐ₁₈₁₉ | L_{b212} |
| 993 | Lₐ₉₈₂ | Lₐ₁₈₄₉ | L_{b212} | 994 | Lₐ₉₈₂ | Lₐ₁₈₆₅ | L_{b212} |
| 995 | Lₐ₉₈₂ | Lₐ₁₈₇₅ | L_{b212} | 996 | Lₐ₃₁₉ | Lₐ₁₈₆₉ | L_{b212} |
| 997 | Lₐ₂₁₂ | Lₐ₁₅₇₁ | L_{b212} | 998 | Lₐ₁₆₈₈ | Lₐ₁₈₆₅ | L_{b212} |
| 999 | Lₐ₁₄₃₇ | Lₐ₁₈₂₉ | L_{b212} | 1000 | Lₐ₁₈₆₅ | Lₐ₁₈₈₅ | L_{b212} |
| 1001 | Lₐ₁₅₇₁ | Lₐ₁₈₅₅ | L_{b212} | 1002 | Lₐ₉₈₉ | Lₐ₁₈₇₃ | L_{b212} |
| 1003 | Lₐ₈₄₂ | Lₐ₁₃₈₄ | L_{b212} | 1004 | Lₐ₁₈₃₃ | Lₐ₁₈₈₉ | L_{b212} |
| 1005 | Lₐ₁₈₆₉ | Lₐ₂₄ | L_{b212} | 1006 | Lₐ₁₈₈₉ | Lₐ₁₃₄ | L_{b212} |
| 1007 | Lₐ₁₄₃₇ | Lₐ₂₁₂ | L_{b212} | 1008 | Lₐ₁₄₃₇ | Lₐ₂₀₇ | L_{b212} |
| 1009 | Lₐ₁₈₁₉ | Lₐ₁₈₂₃ | L_{b212} | 1010 | Lₐ₁₈₆₃ | Lₐ₁₈₆₅ | L_{b212} |

According to an embodiment of the present disclosure, further disclosed is an electroluminescent device, which comprises
an anode,
a cathode and
an organic layer disposed between the anode and the cathode, wherein the organic layer comprises a metal complex whose specific structure is as shown in any one of the preceding embodiments.

According to an embodiment of the present disclosure, in the electroluminescent device, the organic layer is a light-emitting layer, and the metal complex is a light-emitting material.

According to an embodiment of the present disclosure, the electroluminescent device emits red light.

According to an embodiment of the present disclosure, the electroluminescent device emits white light.

According to an embodiment of the present disclosure, in the electroluminescent device, the organic layer is a light-emitting layer, wherein the light-emitting layer further comprises at least one host material.

According to an embodiment of the present disclosure, in the electroluminescent device, the at least one host material comprises at least one chemical group selected from the group consisting of: benzene, pyridine, pyrimidine, triazine, carbazole, azacarbazole, indolocarbazole, dibenzothiophene, aza-dibenzothiophene, dibenzofuran, azadibenzofuran, dibenzoselenophene, triphenylene, azatriphenylene, fluorene, silafluorene, naphthalene, quinoline, isoquinoline, quinazoline, quinoxaline, phenanthrene, azaphenanthrene and combinations thereof.

According to another embodiment of the present disclosure, further disclosed is a compound combination, which comprises a metal complex whose specific structure is as shown in any one of the preceding embodiments.

### Combination with Other Materials

The materials described in the present disclosure for a particular layer in an organic light emitting device can be used in combination with various other materials present in the device. The combinations of these materials are described in more detail in U.S. Pat. App. No. 20160359122 at paragraphs 0132-0161. The materials described or referred to the disclosure are non-limiting examples of materials that may be useful in combination with the compounds disclosed herein, and one of skill in the art can readily consult the literature to identify other materials that may be useful in combination.

The materials described herein as useful for a particular layer in an organic light emitting device may be used in combination with a variety of other materials present in the device. For example, the emissive dopants disclosed herein may be used in combination with a wide variety of hosts, transport layers, blocking layers, injection layers, electrodes and other layers that may be present. The combination of these materials is described in detail in paragraphs 0080-0101 of U.S. Pat. App. No. 20150349273. The materials described or referred to the disclosure are non-limiting examples of materials that may be useful in combination with the compounds disclosed herein, and one of skill in the art can readily consult the literature to identify other materials that may be useful in combination.

In the embodiments of material synthesis, all reactions were performed under nitrogen protection unless otherwise stated. All reaction solvents were anhydrous and used as received from commercial sources. Synthetic products were structurally confirmed and tested for properties using one or more conventional equipment in the art (including, but not limited to, nuclear magnetic resonance instrument produced by BRUKER, liquid chromatograph produced by SHIMADZU, liquid chromatograph-mass spectrometry produced by SHIMADZU, gas chromatograph-mass spectrometry produced by SHIMADZU, differential Scanning calorimeters produced by SHIMADZU, fluorescence spectrophotometer produced by SHANGHAI LENGGUANG TECH., electrochemical workstation produced by WUHAN CORRTEST, and sublimation apparatus produced by ANHUI BEQ, etc.) by methods well known to the persons skilled in the art. In the embodiments of the device, the characteristics of the device were also tested using conventional equipment in the art (including, but not limited to, evaporator produced by ANGSTROM ENGINEERING, optical testing system produced by SUZHOU FSTAR, life testing system produced by SUZHOU FSTAR, and ellipsometer produced by BEIJING ELLITOP, etc.) by methods well known to the persons skilled in the art. As the persons skilled in the art are aware of the above-mentioned equipment use, test methods and other related contents, the inherent data of the sample can be obtained with certainty and without influence, so the above related contents are not further described in this present disclosure.

### Material Synthesis Example

The method for preparing a compound in the present disclosure is not limited herein. Typically, the following compounds are used as examples without limitation, and synthesis routes and preparation methods thereof are described below.

### Synthesis Example 1: Synthesis of Compound 341

### Step 1: Synthesis of Intermediate 3

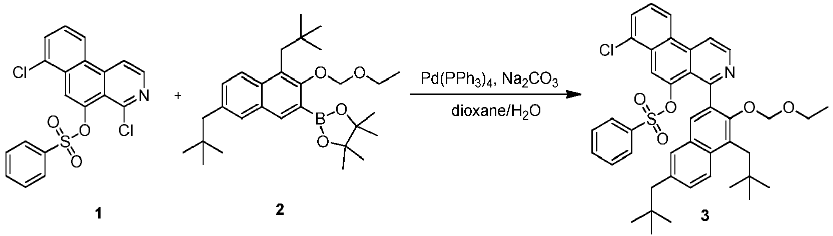

Intermediate **1** (2.1 g, 5.2 mmol), Intermediate 2 (2.43 g, 5.2 mmol), tetrakis(triphenylphosphine)palladium (0.295 g, 0.26 mmol), sodium carbonate (0.818 g, 7.7 mmol), 1,4-dioxane (20 mL) and water (5 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:3, v/v) to obtain Intermediate **3** as a white solid (2.9 g, with a yield of 78.5%).

### Step 2: Synthesis of Intermediate 4

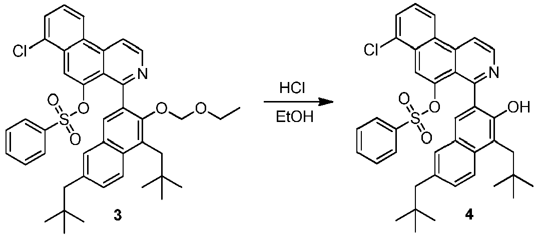

Intermediate **3** (2.9 g, 4.1 mmol) was dissolved in 10 mL of ethanol, and then 10 mL of 2 M HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times and pumped to dryness to obtain Intermediate **4** as a yellow solid (2.6 g, with a yield of 97.2%).

### Step 3: Synthesis of Intermediate 5

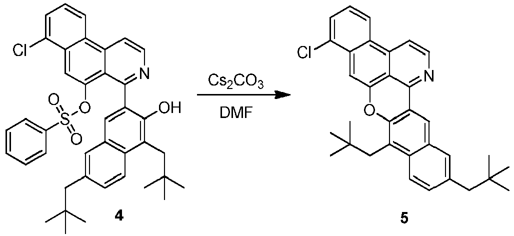

Intermediate **4** (2.6 g, 4.0 mmol), cesium carbonate (2.6 g, 8 mmol) and DMF (40 mL) were heated to 135 °C under nitrogen protection and reacted overnight. After TLC showed that the reaction was completed, the system was cooled to room temperature. 100 mL of water was added thereto, and a large amount of yellow solids were precipitated from the solution. The solids were filtered, washed with water several times and dried to obtain Intermediate **5** as a yellow solid (2 g, with a yield of 99.9%).

### Step 4: Synthesis of Intermediate 6

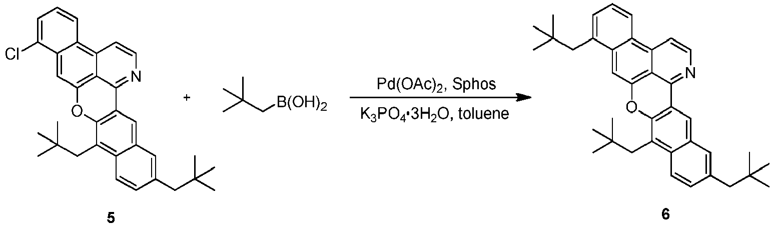

Intermediate **5** (2 g, 4 mmol), neopentylboronic acid (935 mg, 8 mmol), palladium acetate (90 mg, 0.4 mmol), Sphos (328 mg, 0.8 mmol), potassium phosphate trihydrate (3.2 g, 12 mmol) and toluene (30 mL) were heated to reflux and reacted overnight under nitrogen protection. After TLC showed that the reaction was completed, the system was cooled to room temperature. The solution was poured into a funnel filled with Celite and filtered. The filtrate was collected and subjected to rotary evaporation to dryness to obtain a crude product. The crude product was isolated through silica gel column chromatography (eluent: ethyl acetate:petroleum ether = 1:20, v/v) to obtain Intermediate **6** as a yellow solid (2 g, with a yield of 94.4%).

### Step 5: Synthesis of an iridium dimer

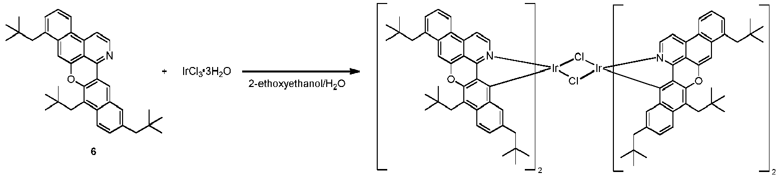

A mixture of Intermediate **6** (1.1 g, 2.08 mmol), iridium trichloride trihydrate (293 mg, 0.83 mmol), 2-ethoxyethanol (18 mL) and water (6 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 6: Synthesis of Compound 341

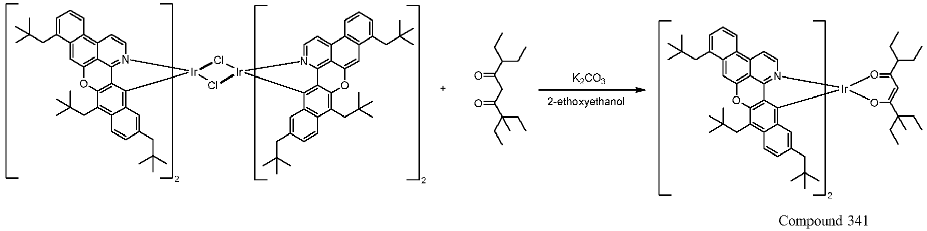

The solution of the iridium dimer in ethoxyethanol obtained in the previous step, 3,7-diethyl-3-methylnonane-4,6-dione (271 mg, 1.2 mmol) and potassium carbonate (0.57 g, 4.15 mmol) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.27 g of Compound 341 with a yield of 22%. The structure of the compound was confirmed through LC-MS as the target product with a molecular weight of 1474.8.

### Synthesis Example 2: Synthesis of Compound 441

### Step 1: Synthesis of Compound 441

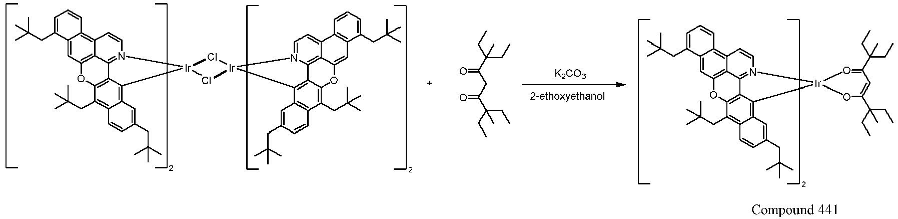

The solution of the iridium dimer in ethoxyethanol obtained in step 5 of Synthesis Example 1, 3,7-diethyl-3,7-dimethylnonane-4,6-dione (58 mg, 0.24 mmol) and potassium carbonate (0.11 g, 0.8 mmol) were added to a 50 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.05 g of Compound 441 with a yield of 21%. The structure of the compound was confirmed through LC-MS as the target product with a molecular weight of 1488.8.

### Synthesis Example 3: Synthesis of Compound 442

### Step 1: Synthesis of Intermediate 8

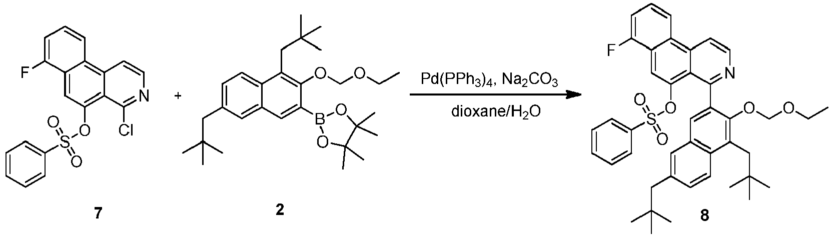

Intermediate **7** (1.6 g, 4.1 mmol), Intermediate **2** (1.93 g, 4.1 mmol), tetrakis(triphenylphosphine)palladium (0.237 g, 0.2 mmol), sodium carbonate (0.652 g, 6.2 mmol), 1,4-dioxane (16 mL) and water (4 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:3, v/v) to obtain Intermediate **8** as a white solid (2.46 g, with a yield of 86.5%).

### Step 2: Synthesis of Intermediate 9

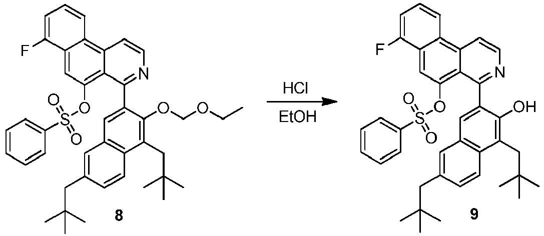

Intermediate **8** (2.46 g, 3.5 mmol) was dissolved in 10 mL of ethanol, and then 10 mL of 2 M HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times and pumped to dryness to obtain Intermediate **9** as a yellow solid (2.32 g, with a yield of 99.9%).

### Step 3: Synthesis of Intermediate 10

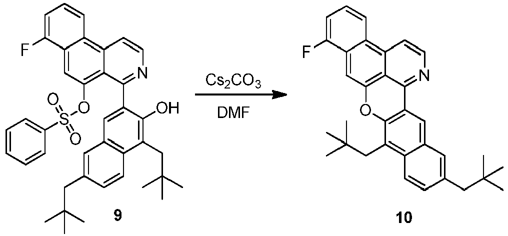

Intermediate **9** (2.32 g, 3.65 mmol), cesium carbonate (3.56 g, 10.9 mmol) and DMF (35 mL) were heated to 135 °C under nitrogen protection and reacted overnight. After TLC showed that the reaction was completed, the system was cooled to room temperature. 100 mL of water was added thereto, and a large amount of yellow solids were precipitated from the solution. The solids were filtered, washed with water several times and dried to obtain Intermediate **10** as a yellow solid (1.4 g, with a yield of 80.3%).

### Step 4: Synthesis of an iridium dimer

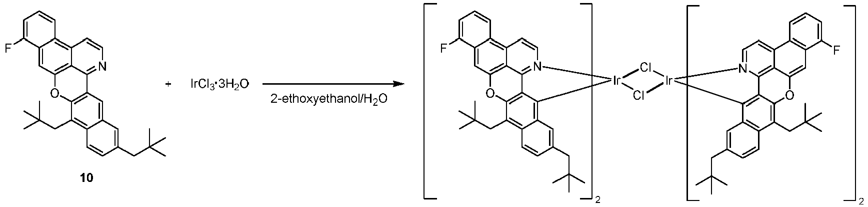

A mixture of Intermediate **10** (1.4 g, 2.93 mmol), iridium trichloride trihydrate (344 mg, 0.98 mmol), 2-ethoxyethanol (21 mL) and water (7 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 5: Synthesis of Compound 442

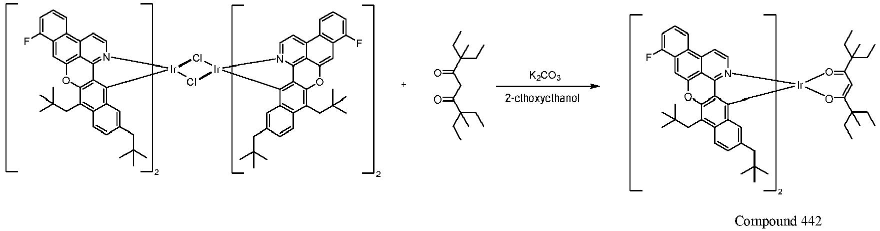

The solution of the iridium dimer in ethoxyethanol obtained in the previous step, 3,7-diethyl-3,7-dimethylnonane-4,6-dione (353 mg, 1.47 mmol) and potassium carbonate (0.67 g, 4.9 mmol) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.88 g of Compound 442 with a yield of 64.8%. The product was further purified through column chromatography. The structure of the compound was confirmed through LC-MS as the target product with a molecular weight of 1384.6.

### Synthesis Example 4: Synthesis of Compound 438

### Step 1: Synthesis of Intermediate 12

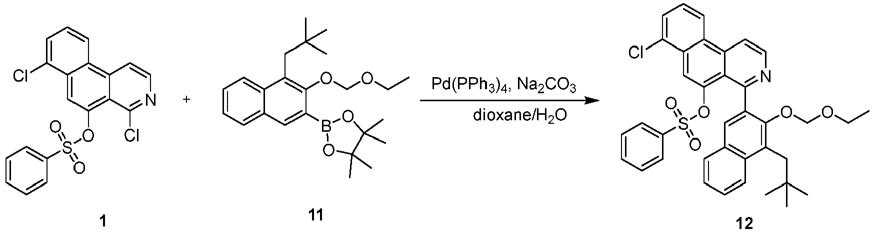

Intermediate **1** (1.45 g, 3.59 mmol), Intermediate **11** (1.43 g, 3.59 mmol), tetrakis(triphenylphosphine)palladium (0.27 g, 0.18 mmol), sodium carbonate (0.57 g, 5.4 mmol), 1,4-dioxane (16 mL) and water (4 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction solution, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:2, v/v) to obtain Intermediate **12** as a white solid (2.2 g, with a yield of 95.7%).

### Step 2: Synthesis of Intermediate 13

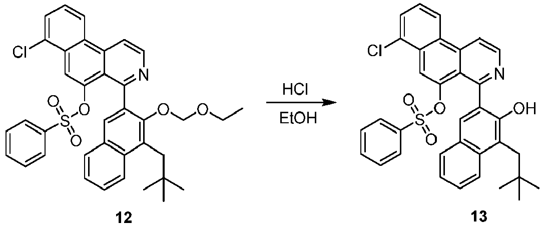

Intermediate **12** (2.2 g, 3.4 mmol) was dissolved in 10 mL of ethanol, and then 10 mL of 2 M HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times and pumped to dryness to obtain Intermediate **13** as a yellow solid (1.8 g, with a yield of 99.8%).

### Step 3: Synthesis of Intermediate 14

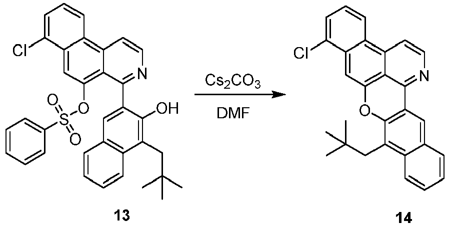

Intermediate **13** (1.8 g, 3.4 mmol), cesium carbonate (2.2 g, 6.8 mmol) and DMF (30 mL) were heated to 135 °C under nitrogen protection and reacted overnight. After TLC showed that the reaction was completed, the system was cooled to room temperature. 100 mL of water was added thereto, and a large amount of yellow solids were precipitated from the solution. The solids were filtered, washed with water several times and dried to obtain Intermediate **14** as a yellow solid (1.2 g, with a yield of 83.2%).

### Step 4: Synthesis of Intermediate 15

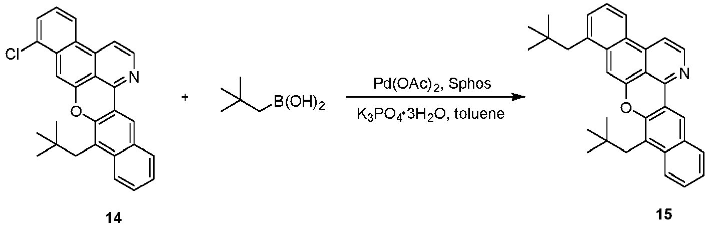

Intermediate **14** (1.2 g, 2.83 mmol), neopentylboronic acid (656 mg, 5.66 mmol), palladium acetate (32 mg, 0.14 mmol), Sphos (116 mg, 0.28 mmol), potassium phosphate trihydrate (2.26 g, 8.49 mmol) and toluene (20 mL) were heated to reflux and reacted overnight under nitrogen protection. After TLC showed that the reaction was completed, the system was cooled to room temperature. The solution was poured into a funnel filled with Celite and filtered. The filtrate was collected and subjected to rotary evaporation to dryness to obtain a crude product. The crude product was isolated through silica gel column chromatography (eluent: ethyl acetate:petroleum ether = 1:20, v/v) to obtain Intermediate **15** as a yellow solid (0.88 g, with a yield of 67.5%).

### Step 5: Synthesis of an iridium dimer

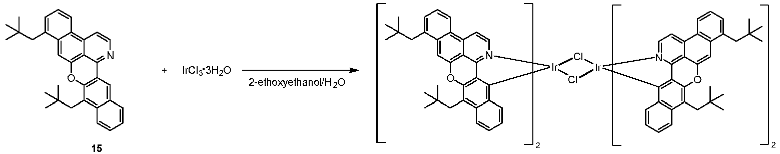

A mixture of Intermediate **15** (0.88 g, 1.91 mmol), iridium trichloride trihydrate (193 mg, 0.55 mmol), 2-ethoxyethanol (18 mL) and water (6 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 6: Synthesis of Compound 438

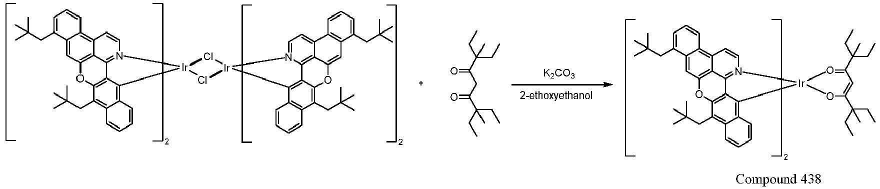

The solution of the iridium dimer in ethoxyethanol obtained in the previous step, 3,7-diethyl-3,7-dimethylnonane-4,6-dione (200 mg, 0.83 mmol) and potassium carbonate (0.38 g, 2.75 mmol) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.41 g of Compound 438 with a yield of 55.3%. The structure of the compound was confirmed through LC-MS as the target product with a molecular weight of 1348.7.

### Synthesis Example 5: Synthesis of Compound 446

### Step 1: Synthesis of Intermediate 17

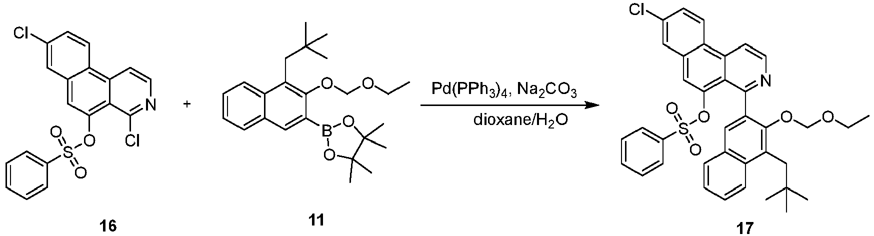

Intermediate **16** (1.45 g, 3.59 mmol), Intermediate **11** (1.43 g, 3.59 mmol), tetrakis(triphenylphosphine)palladium (0.27 g, 0.18 mmol), sodium carbonate (0.57 g, 5.4 mmol), 1,4-dioxane (16 mL) and water (4 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:2, v/v) to obtain Intermediate 17 as a white solid (2.0 g, with a yield of 90%).

### Step 2: Synthesis of Intermediate 18

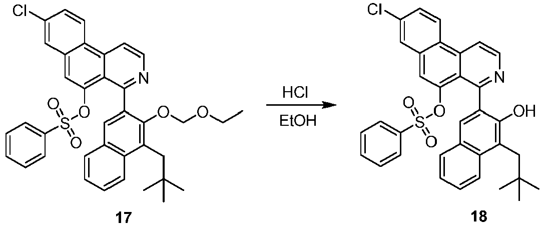

Intermediate **17** (2.2 g, 3.4 mmol) was dissolved in 10 mL of ethanol, and then 10 mL of 2 M HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times and pumped to dryness to obtain Intermediate **18** as a yellow solid (1.8 g, with a yield of 99.8%).

### Step 3: Synthesis of Intermediate 19

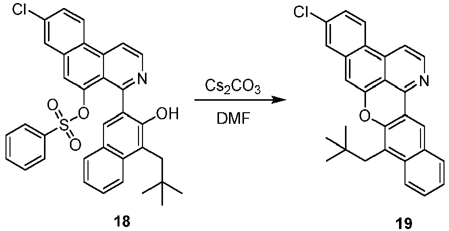

Intermediate **18** (1.8 g, 3.4 mmol), cesium carbonate (2.2 g, 6.8 mmol) and DMF (35 mL) were heated to 135 °C under nitrogen protection and reacted overnight. After TLC showed that the reaction was completed, the system was cooled to room temperature. 100 mL of water was added thereto, and a large amount of yellow solids were precipitated from the solution. The solids were filtered, washed with water several times and dried to obtain Intermediate 19 as a yellow solid (1.2 g, with a yield of 83.2%).

### Step 4: Synthesis of Intermediate 20

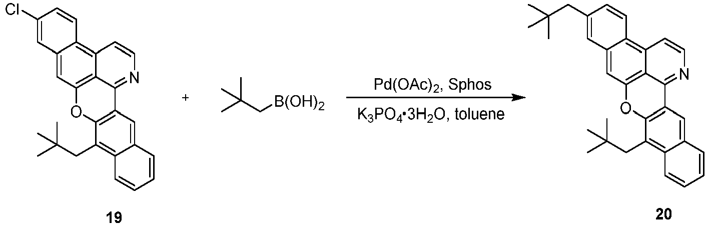

Intermediate **19** (1.2 g, 2.83 mmol), neopentylboronic acid (656 mg, 5.66 mmol), palladium acetate (32 mg, 0.14 mmol), Sphos (116 mg, 0.28 mmol), potassium phosphate trihydrate (2.26 g, 8.49 mmol) and toluene (20 mL) were heated to reflux and reacted overnight under nitrogen protection. After TLC showed that the reaction was completed, the system was cooled to room temperature. The solution was poured into a funnel filled with Celite and filtered. The filtrate was collected and subjected to rotary evaporation to dryness to obtain a crude product. The crude product was isolated through silica gel column chromatography (eluent: ethyl acetate:petroleum ether = 1:50, v/v) to obtain Intermediate **20** as a yellow solid (0.88 g, with a yield of 67.5%).

### Step 5: Synthesis of an iridium dimer

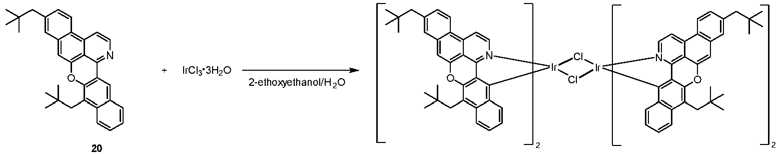

A mixture of Intermediate **20** (0.51 g, 1.1 mmol), iridium trichloride trihydrate (130 mg, 0.37 mmol), 2-ethoxyethanol (27 mL) and water (9 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 6: Synthesis of Compound 446

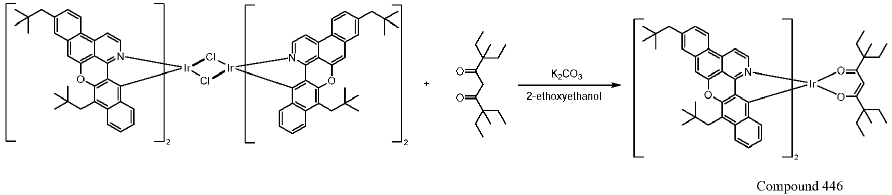

The solution of the iridium dimer in ethoxyethanol obtained in the previous step, 3,7-diethyl-3,7-dimethylnonane-4,6-dione (130 mg, 0.55 mmol) and potassium carbonate (0.26 g, 1.85 mmol) were added to a 100 mL round-bottom flask and reacted at 50 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.24 g of Compound 446 with a yield of 48%. The structure of the compound was confirmed through LC-MS as the target product with a molecular weight of 1348.7.

### Synthesis Example 6: Synthesis of Compound 1021

### Step 1: Synthesis of Intermediate 21

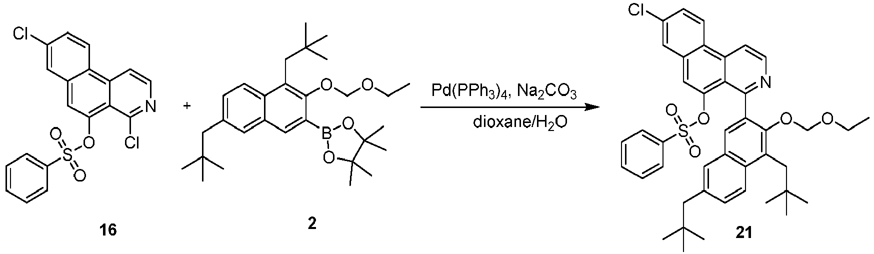

Intermediate **16** (1.89 g, 4.68 mmol), Intermediate **2** (2.18 g, 4.67 mmol), tetrakis(triphenylphosphine)palladium (0.27 g, 0.23 mmol), sodium carbonate (0.74 g, 7 mmol), 1,4-dioxane (28 mL) and water (7 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:2, v/v) to obtain Intermediate **21** as a white solid (2.3 g, with a yield of 70%).

### Step 2: Synthesis of Intermediate 22

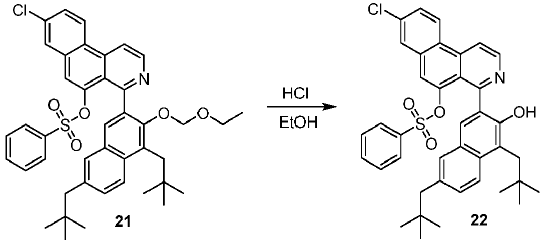

Intermediate **21** (4.5 g, 6.34 mmol) was dissolved in 30 mL of ethanol, and then 30 mL of 2 M HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times and pumped to dryness to obtain Intermediate **22** as a yellow solid (3.1 g, with a yield of 99.8%).

### Step 3: Synthesis of Intermediate 23

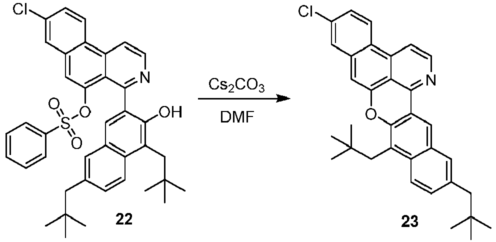

Intermediate **22** (3.1 g, 6.34 mmol), cesium carbonate (5.16 g, 15.8 mmol) and DMF (50 mL) were heated to 135 °C under nitrogen protection and reacted overnight. After TLC showed that the reaction was completed, the system was cooled to room temperature. 100 mL of water was added thereto, and a large amount of yellow solids were precipitated from the solution. The solids were filtered, washed with water several times and dried to obtain Intermediate **23** as a yellow solid (5.5 g, with a yield of 88%).

### Step 4: Synthesis of Intermediate 24

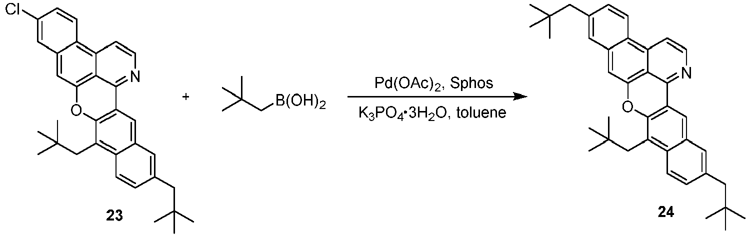

Intermediate **23** (3.13 g, 6.3 mmol), neopentylboronic acid (2.21 g, 19 mmol), palladium acetate (144 mg, 0.64 mmol), Sphos (525 mg, 1.28 mmol), potassium phosphate trihydrate (5.1 g, 19.02 mmol) and toluene (30 mL) were heated to reflux and reacted overnight under nitrogen protection. After TLC showed that the reaction was completed, the system was cooled to room temperature. The solution was poured into a funnel filled with Celite and filtered. The filtrate was collected and subjected to rotary evaporation to dryness to obtain a crude product. The crude product was isolated through silica gel column chromatography (eluent: ethyl acetate:petroleum ether = 1:20, v/v) to obtain Intermediate **24** as a yellow solid (2.6 g, with a yield of 75%).

### Step 5: Synthesis of an iridium dimer

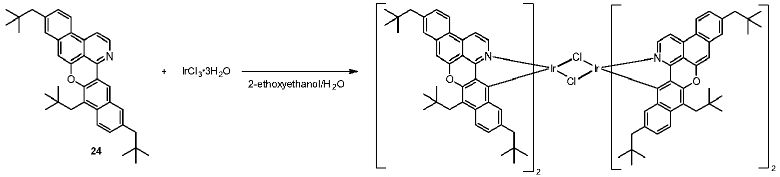

A mixture of Intermediate **24** (1.6 g, 3 mmol), iridium trichloride trihydrate (356 mg, 1 mmol), 2-ethoxyethanol (36 mL) and water (12 mL) was refluxed under a nitrogen atmosphere for 24 h. The system was cooled to room temperature and filtered. The solids were washed with methanol and dried under a vacuum condition so that an iridium dimer was obtained, which was used in the next step without further purification.

### Step 6: Synthesis of Compound 1021

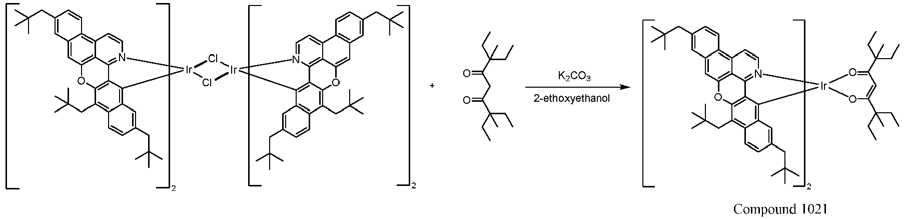

The iridium dimer obtained in the previous step, 3,7-diethyl-3,7-dimethylnonane-4,6-dione (360 mg, 1.5 mmol), potassium carbonate (0.69 g, 5 mmol) and 2-ethoxyethanol (35 mL) were added to a 100 mL round-bottom flask and reacted at 50 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.1 g of Compound 1021 with a yield of 6%. The structure of the compound was confirmed through LC-MS as the target product with a molecular weight of 1488.8.

### Synthesis Example 7: Synthesis of Compound 405

### Step 1: Synthesis of Intermediate 26

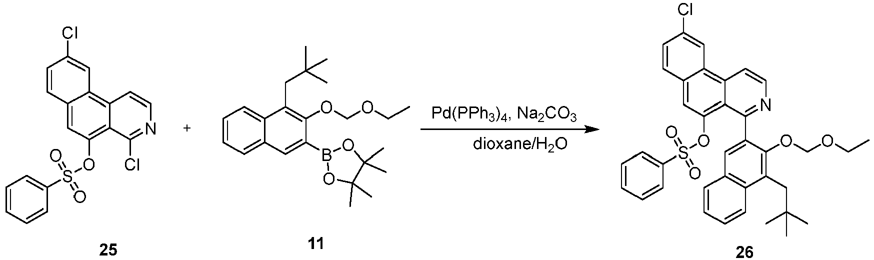

Intermediate **25** (1.45 g, 3.59 mmol), Intermediate **11** (1.43 g, 3.59 mmol), tetrakis(triphenylphosphine)palladium (0.27 g, 0.18 mmol), sodium carbonate (0.57 g, 5.4 mmol), 1,4-dioxane (16 mL) and water (4 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:2, v/v) to obtain Intermediate **26** as a white solid (2.2 g, with a yield of 95.7%).

### Step 2: Synthesis of Intermediate 27

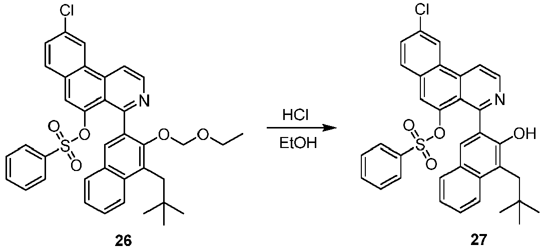

Intermediate **26** (2.2 g, 3.4 mmol) was dissolved in 10 mL of ethanol, and then 10 mL of 2 M HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times and pumped to dryness to obtain Intermediate **27** as a yellow solid (1.8 g, with a yield of 99.8%).

### Step 3: Synthesis of Intermediate 28

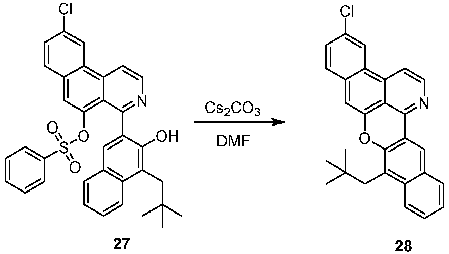

Intermediate **27** (1.8 g, 3.4 mmol), cesium carbonate (2.2 g, 6.8 mmol) and DMF (35 mL) were heated to 135 °C under nitrogen protection and reacted overnight. After TLC showed that the reaction was completed, the system was cooled to room temperature. 100 mL of water was added thereto, and a large amount of yellow solids were precipitated from the solution. The solids were filtered, washed with water several times and dried to obtain Intermediate **28** as a yellow solid (1.2 g, with a yield of 83.2%).

### Step 4: Synthesis of Intermediate 29

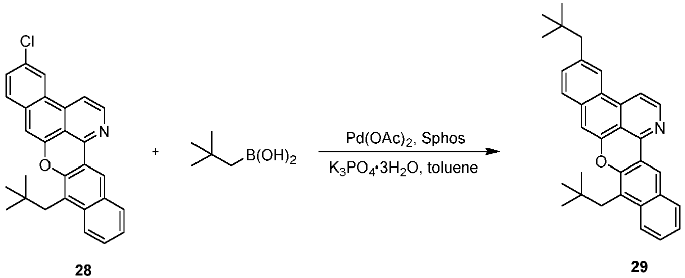

Intermediate **28** (1.2 g, 2.83 mmol), neopentylboronic acid (656 mg, 5.66 mmol), palladium acetate (32 mg, 0.14 mmol), Sphos (116 mg, 0.28 mmol), potassium phosphate trihydrate (2.26 g, 8.49 mmol) and toluene (20 mL) were heated to reflux and reacted overnight under nitrogen protection. After TLC showed that the reaction was completed, the system was cooled to room temperature. The solution was poured into a funnel filled with Celite and filtered. The filtrate was collected and subjected to rotary evaporation to dryness to obtain a crude product. The crude product was isolated through silica gel column chromatography (eluent: ethyl acetate:petroleum ether = 1:50, v/v) to obtain Intermediate **29** as a yellow solid (0.88 g, with a yield of 67.5%).

### Step 5: Synthesis of an iridium dimer

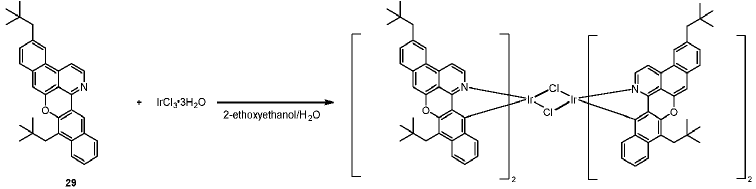

A mixture of Intermediate **29** (0.88 g, 1.91 mmol), iridium trichloride trihydrate (193 mg, 0.55 mmol), 2-ethoxyethanol (18 mL) and water (6 mL) was refluxed under a nitrogen atmosphere for 24 h. The system was cooled to room temperature and filtered so that 210 mg of iridium dimer was obtained, which was used in the next step without further purification.

### Step 6: Synthesis of Compound 405

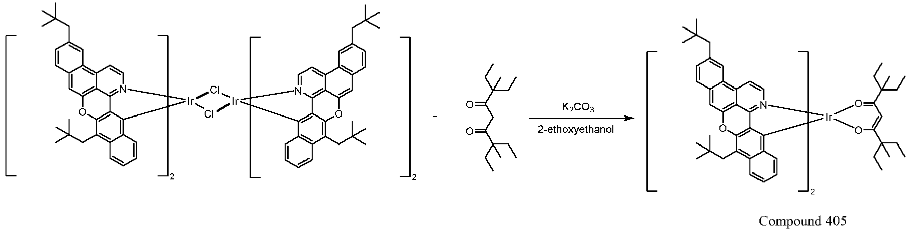

The iridium dimer (210 mg, 0.114 mmol) obtained in the previous step, 3,7-diethyl-3,7-dimethylnonane-4,6-dione (165 mg, 0.69 mmol), potassium carbonate (0.1 g, 1.35 mmol) and ethoxyethanol (10 mL) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.1 g of Compound 405 with a yield of 13.5%. The structure of the compound was confirmed through LC-MS as the target product with a molecular weight of 1348.7.

### Synthesis Example 8: Synthesis of Compound 205

### Step 1: Synthesis of Compound 205

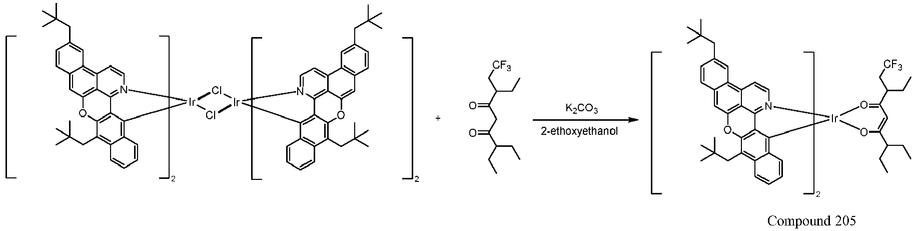

The iridium dimer (210 mg, 0.114 mmol) obtained in step 5 of Synthesis Example 7, 3,7-diethyl-1,1,1-trifluorononane-4,6-dione (184 mg, 0.69 mmol), potassium carbonate (0.1 g, 1.35 mmol) and ethoxyethanol (10 mL) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.1 g of Compound 205 with a yield of 13.2%. The structure of the compound was confirmed through LC-MS as the target product with a molecular weight of 1374.6.

### Synthesis Example 9: Synthesis of Compound 1019

### Step 1: Synthesis of Intermediate 31

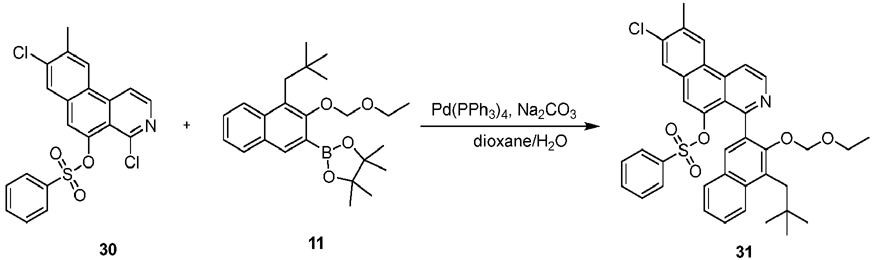

Intermediate **30** (2.2 g, 5.2 mmol), Intermediate **11** (2.43 g, 5.2 mmol), tetrakis(triphenylphosphine)palladium (0.295 g, 0.26 mmol), sodium carbonate (0.818 g, 7.7 mmol), 1,4-dioxane (20 mL) and water (5 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:3, v/v) to obtain Intermediate **31** as a white solid (2.9 g, with a yield of 76.5%).

### Step 2: Synthesis of Intermediate 32

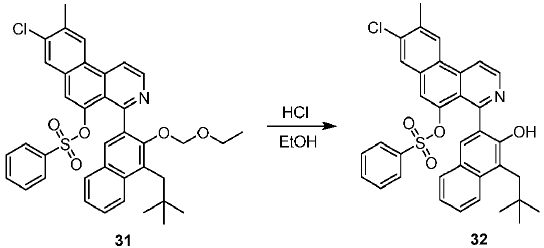

Intermediate **31** (2.9 g, 4.1 mmol) was dissolved in 10 mL of ethanol, and then 10 mL of 2 M HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times, and pumped to obtain Intermediate **32** as a yellow solid (2.7 g, with a yield of 97.2%).

### Step 3: Synthesis of Intermediate 33

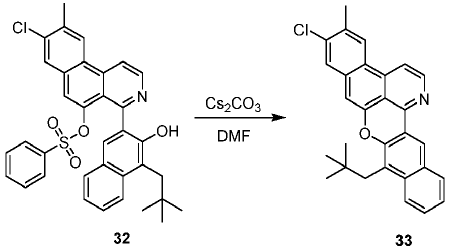

Intermediate **32** (2.7 g, 4.0 mmol), cesium carbonate (2.6 g, 8 mmol) and DMF (40 mL) were heated to 135 °C under nitrogen protection and reacted overnight. After TLC showed that the reaction was completed, the system was cooled to room temperature. 100 mL of water was added thereto, and a large amount of yellow solids were precipitated from the solution. The solids were filtered, washed with water several times and dried to obtain Intermediate **33** as a yellow solid (2 g, with a yield of 98.4%).

### Step 4: Synthesis of Intermediate 34

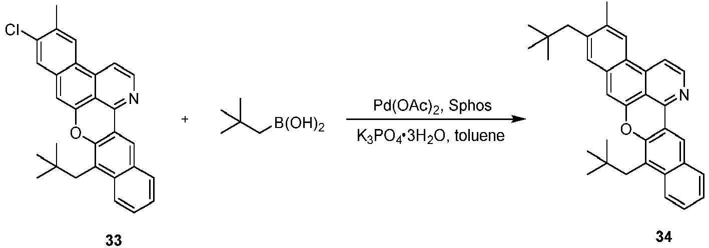

Intermediate **33** (2 g, 3.94 mmol), neopentylboronic acid (914 mg, 7.88 mmol), palladium acetate (90 mg, 0.4 mmol), Sphos (328 mg, 0.8 mmol), potassium phosphate trihydrate (3.2 g, 12 mmol) and toluene (30 mL) were heated to reflux and reacted overnight under nitrogen protection. After TLC showed that the reaction was completed, the system was cooled to room temperature. The solution was poured into a funnel filled with Celite and filtered. The filtrate was collected and subjected to rotary evaporation to dryness to obtain a crude product. The crude product was isolated through silica gel column chromatography (eluent: ethyl acetate:petroleum ether = 1:20, v/v) to obtain Intermediate **34** as a yellow solid (1.1 g, with a yield of 50.6%).

### Step 5: Synthesis of an iridium dimer

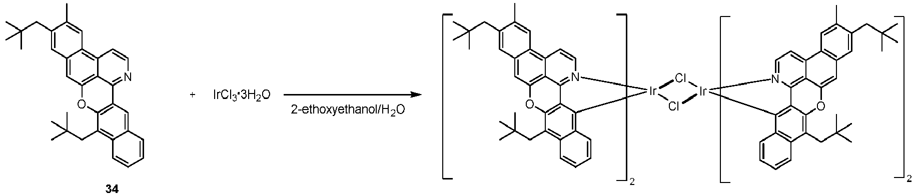

A mixture of Intermediate **34** (1.1 g, 2.02 mmol), iridium trichloride trihydrate (293 mg, 0.83 mmol), 2-ethoxyethanol (18 mL) and water (6 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 6: Synthesis of Compound 1019

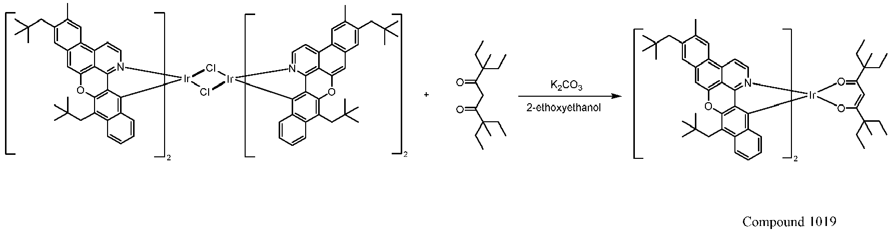

The solution of the iridium dimer in ethoxyethanol obtained in the previous step, 3,7-diethyl-3,7-dimethylnonane-4,6-dione (271 mg, 1.2 mmol) and potassium carbonate (0.57 g, 4.15 mmol) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.22 g of Compound 1019 with a yield of 17.5%. The structure of the compound was confirmed through LC-MS as the target product with a molecular weight of 1376.7.

### Synthesis Example 10: Synthesis of Compound 447

### Step 1: Synthesis of Intermediate 36

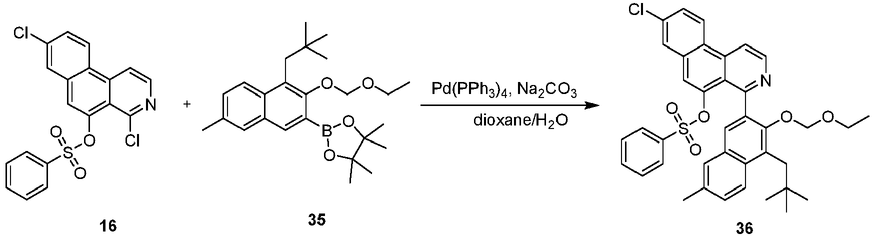

Intermediate **16** (2.61 g, 6.47 mmol), Intermediate **35** (2.67 g, 6.47 mmol), tetrakis(triphenylphosphine)palladium (0.37 g, 0.32 mmol), sodium carbonate (1.03 g, 9.7 mmol), 1,4-dioxane (52 mL) and water (13 mL) were added to a round-bottom flask. Then, the reaction was heated to 90 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:2, v/v) to obtain the target product Intermediate **36** as a white solid (3.1 g, 72%).

### Step 2: Synthesis of Intermediate 37

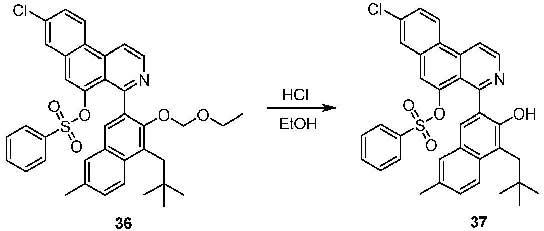

Intermediate **36** (3.12 g, 4.77 mmol) was dissolved in 20 mL of ethanol, and then 20 mL of 2 N HCl was added thereto, and then the reaction was heated to reflux and stirred overnight. After TLC showed that the reaction was completed, the system was cooled to room temperature. Then, a saturated solution of sodium carbonate was added to adjust the pH to neutral. A large amount of yellow solids were precipitated from the solution. The solids were filtered, washed with water several times, and pumped to dryness to obtain the target product Intermediate **37** as a yellow solid (2.74 g, 96%).

### Step 3: Synthesis of Intermediate 38

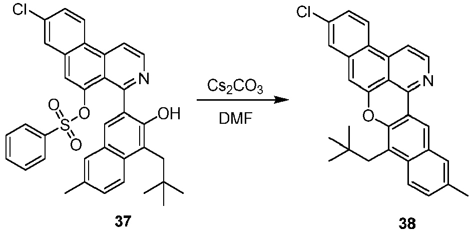

Intermediate **37** (2.74 g, 4.6 mmol), cesium carbonate (3.89 g, 11.93 mmol) and DMF (40 mL) were heated to 135 °C under nitrogen protection and reacted overnight. After TLC showed that the reaction was completed, the system was cooled to room temperature. Water was added to the solution until a large amount of yellow solids were precipitated from the solution. The solids were filtered, washed with water several times and pumped to dryness to obtain the target product Intermediate **38** as a yellow solid (1.84 g, 91%).

### Step 4: Synthesis of Intermediate 39

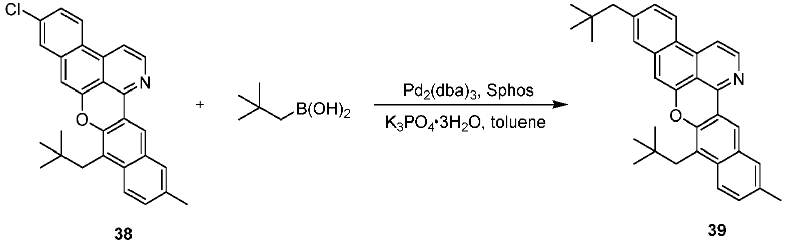

Intermediate **38** (0.56 g, 1.27 mmol), neopentylboronic acid (0.42 g, 3.81 mmol), Pd₂(dba)₃ (0.058 g, 0.06 mmol), Sphos (0.052 g, 0.127 mmol), potassium phosphate trihydrate (1.02 g, 3.81 mmol) and toluene (15 mL) were heated to reflux and reacted overnight under nitrogen protection. After TLC showed that the reaction was completed, the system was cooled to room temperature. The solution was poured into a funnel filled with Celite and filtered. The filtrate was collected and subjected to rotary evaporation to dryness to obtain a crude product. The crude product was isolated through silica gel column chromatography (eluent: ethyl acetate:petroleum ether = 1:100, v/v) to obtain the target product Intermediate **39** as a yellow solid (0.58 g, 95%).

### Step 5: Synthesis of an iridium dimer

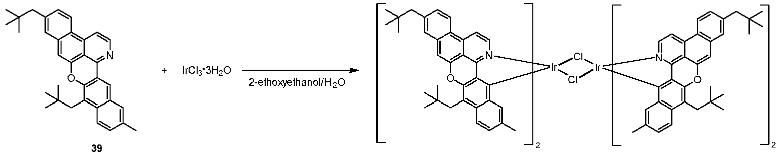

A mixture of Intermediate **39** (0.58 g, 1.23 mmol), iridium trichloride trihydrate (0.12 g, 0.35 mmol), 2-ethoxyethanol (36 mL) and water (12 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 6: Synthesis of Compound 447

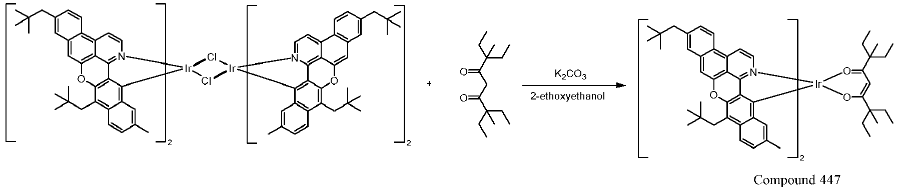

The solution of the iridium dimer in ethoxyethanol obtained in the previous step, 3,7-diethyl-3,7-dimethylnonane-4,6-dione (0.13 g, 0.53 mmol), potassium carbonate (0.69 g, 5 mmol) and 2-ethoxyethanol (35 mL) were added to a round-bottom flask and reacted at 50 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.18 g of Compound 447 with a yield of 37%. The structure of the compound was confirmed through LC-MS as the target product with a molecular weight of 1376.7.

### Synthesis Example 11: Synthesis of Compound 1020

### Step 1: Synthesis of an iridium dimer

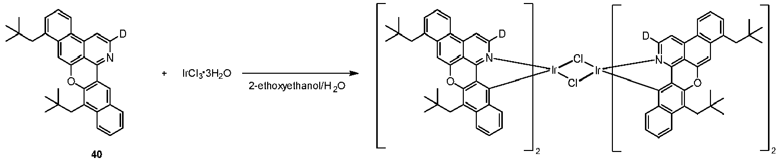

A mixture of Intermediate **40** (1 g, 2.17 mmol), iridium trichloride trihydrate (293 mg, 0.83 mmol), 2-ethoxyethanol (18 mL) and water (6 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 2: Synthesis of Compound 1020

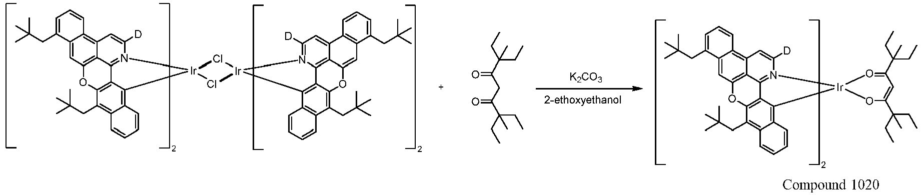

The solution of the iridium dimer in ethoxyethanol obtained in the previous step, 3,7-diethyl-3,7-dimethylnonane-4,6-dione (271 mg, 1.2 mmol) and potassium carbonate (0.57 g, 4.15 mmol) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.45 g of Compound 1020 with a yield of 40.1%. The structure of the compound was confirmed through LC-MS as the target product with a molecular weight of 13 50.7.

### Synthesis Example 12: Synthesis of Compound 1018

### Step 1: Synthesis of Intermediate 41

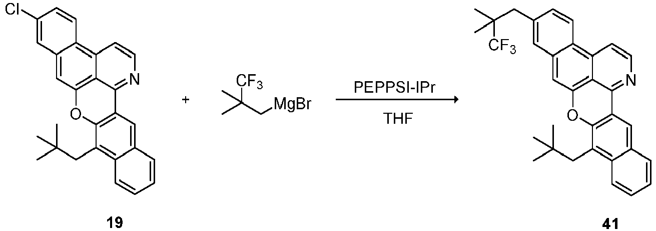

Intermediate **19** (344 mg, 0.81 mmol) and [1,3-bis(2,6-diisopropylphenyl)imidazol-2-ylidene](3-chloropyridyl)palladium dichloride (28 mg, 0.04 mmol) were dissolved in THF (5 mL). 2 mol/L of 3,3,3-trifluoro-2,2-dimethylpropylmagnesium bromide in THF (4 mL) was added thereto under nitrogen protection and reacted at 45 °C. The reaction was monitored through LC-MS and stopped until Intermediate **19** disappeared. An aqueous solution of ammonium chloride was added to quench the reaction, and the solution was extracted with EA. The organic phases were collected, dried, subjected to rotary evaporation to remove the solvent and isolated through silica gel column chromatography (eluent: ethyl acetate:petroleum ether = 1:100, v/v) to obtain Intermediate **41** (248 mg, with a yield of 60%).

### Step 2: Synthesis of an iridium dimer

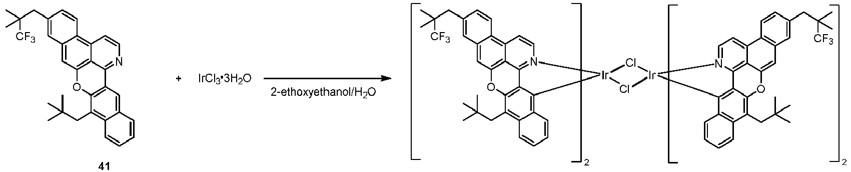

A mixture of Intermediate **41** (0.28 g, 0.54 mmol), iridium trichloride trihydrate (50 mg, 0.14 mmol), 2-ethoxyethanol (15 mL) and water (5 mL) was refluxed under a nitrogen atmosphere for 24 h. The system was cooled to room temperature and filtered. The solids were collected and washed with methanol three times. The solvent was removed under a vacuum condition, and an iridium dimer as a red solid was collected, which was used in the next step without further purification.

### Step 3: Synthesis of Compound 1018

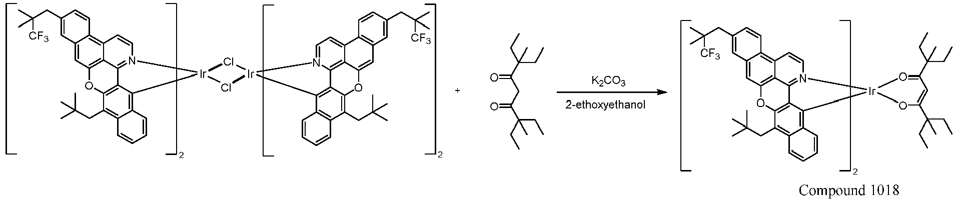

The iridium dimer obtained in the previous step, 3,7-diethyl-3,7-dimethylnonane-4,6-dione (51 mg, 0.21 mmol), potassium carbonate (98 mg, 0.71 mmol) and ethoxyethanol (15 mL) were added to a 100 mL round-bottom flask and reacted at 50 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.1 g of Compound 1018 with a yield of 49%. The structure of the compound was confirmed through LC-MS as the target product with a molecular weight of 1456.6.

### Synthesis Example 13: Synthesis of Compound 452

### Step 1: Synthesis of Intermediate 44

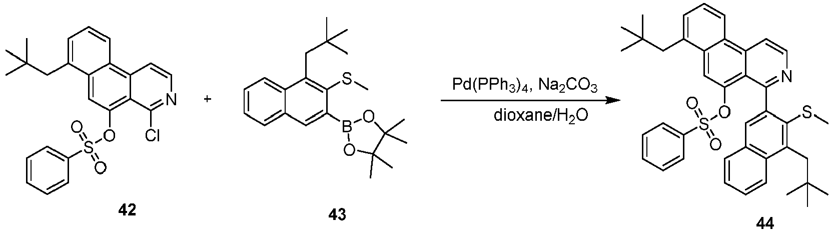

Intermediate **42** (418 mg, 0.95 mmol), Intermediate **43** (370 mg, 1 mmol), tetrakis(triphenylphosphine)palladium (55 mg, 0.048 mmol), sodium carbonate (151 mg, 1.43 mmol), 1,4-dioxane (8 mL) and water (2 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:3, v/v) to obtain Intermediate **44** as a white solid (500 mg, with a yield of 81.3%).

### Step 2: Synthesis of Intermediate 45

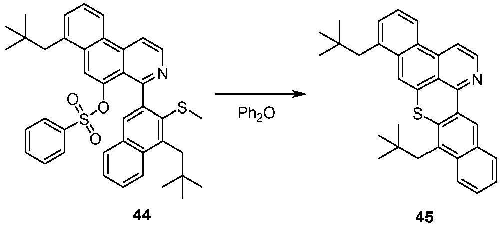

Intermediate **44** (500 mg, 0.77 mmol) and diphenyl ether (4 mL) were heated to 180 °C under nitrogen protection and reacted overnight. After TLC showed that the reaction was completed, the system was cooled to room temperature. The crude product was isolated through silica gel column chromatography (eluent: ethyl acetate:petroleum ether = 1:20, v/v) to obtain Intermediate **45** as a yellow solid (110 mg, with a yield of 30%).

### Step 3: Synthesis of an iridium dimer

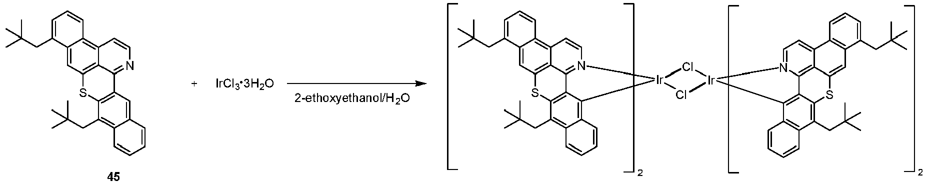

A mixture of Intermediate **45** (110 mg, 0.23 mmol), iridium trichloride trihydrate (25 mg, 0.077 mmol), 2-ethoxyethanol (6 mL) and water (2 mL) was refluxed under a nitrogen atmosphere for 24 h. The system was cooled to room temperature and subjected to rotary evaporation to carefully remove water in the solution, so that a solution of an iridium dimer in ethoxyethanol was obtained, which was used in the next step without further purification.

### Step 4: Synthesis of Compound 452

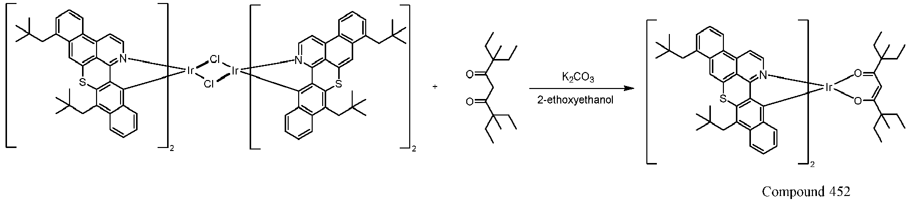

The solution of the iridium dimer in ethoxyethanol obtained in the previous step, 3,7-diethyl-3,7-dimethylnonane-4,6-dione (111 mg, 0.46 mmol) and potassium carbonate (159 mg, 1.15 mmol) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.04 g of Compound 452 with a yield of 37.6%. The structure of the compound was confirmed through LC-MS as the target product with a molecular weight of 13 80.6.

### Synthesis Example 14: Synthesis of Compound 1017

### Step 1: Synthesis of Intermediate 47

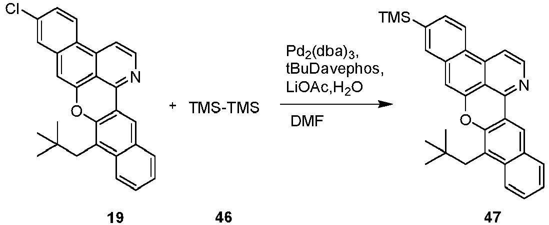

Intermediate **19** (0.5 g, 1.18 mmol), Intermediate **46** (346 mg, 2.36 mmol), Pd₂(dba)₃ (12 mg, 0.012 mmol), tBuDavephos (21 mg, 0.06 mmol), lithium acetate (0.39 g, 5.9 mmol), water (43 mg, 2.36 mmol) and DMF (30 mL) were added to a reaction tube, sealed under nitrogen protection, heated to 150 °C and reacted overnight. After the reaction was completed, the system was cooled to room temperature and subjected to rotary evaporation to dryness to obtain a crude product. The crude product was isolated through silica gel column chromatography to obtain Intermediate **47** as a yellow solid (0.4 g, 73.5%).

### Step 2: Synthesis of an iridium dimer

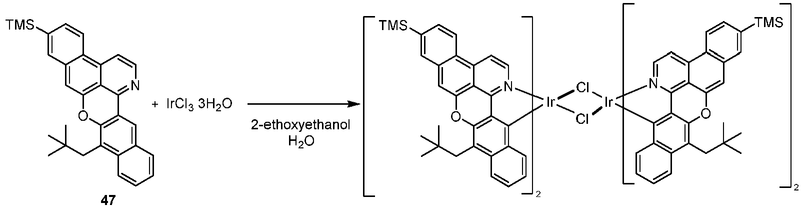

A mixture of Intermediate **47** (0.7 g, 1.52 mmol), iridium trichloride trihydrate (0.18 g, 0.5 mmol), 2-ethoxyethanol (27 mL) and water (9 mL) was refluxed under a nitrogen atmosphere for 24 h. The system was cooled to room temperature and filtered. The solids were washed with methanol and dried so that an iridium dimer was obtained, which was used in the next step without further purification.

### Step 3: Synthesis of Compound 1017

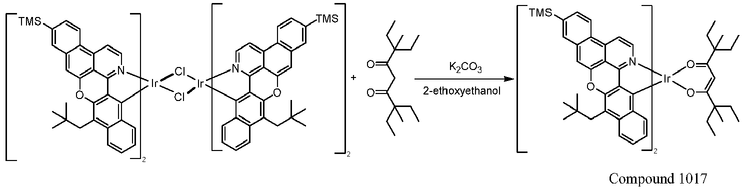

The iridium dimer obtained in the previous step, 3,7-diethyl-3,7-dimethylnonane-4,6-dione (0.18 g, 0.76 mmol), potassium carbonate (0.35 g, 2.53 mmol) and 2-ethoxyethanol (10 mL) were added to a 100 mL round-bottom flask and reacted at 50 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.37 g of Compound 1017 with a yield of 54%. The structure of the compound was confirmed through LC-MS as the target product with a molecular weight of 13 52.6.

### Synthesis Example 15: Synthesis of Compound 1022

### Step 1: Synthesis of Intermediate 49

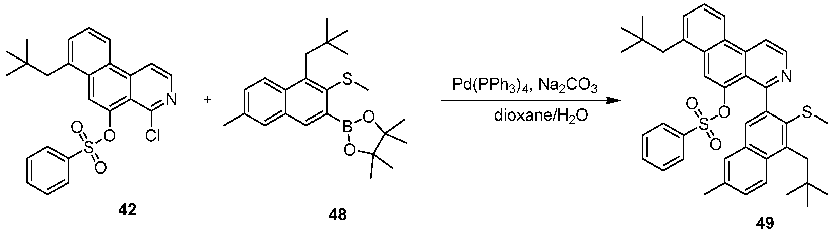

Intermediate **42** (600 mg, 1.37 mmol), Intermediate **48** (546 mg, 1.43 mmol), tetrakis(triphenylphosphine)palladium (79 mg, 0.069 mmol), sodium carbonate (218 mg, 2.06 mmol), 1,4-dioxane (8 mL) and water (2 mL) were added to a 100 mL round-bottom flask. Then, the reaction was heated to 80 °C under nitrogen protection and stirred overnight. After TLC showed that the reaction was completed, the system was cooled to room temperature. Ethyl acetate was added to the reaction, layers were separated, and the aqueous phase was extracted with ethyl acetate. The organic phases were combined, dried and subjected to rotary evaporation to dryness to obtain a crude product. The crude product was isolated through silica gel column chromatography (eluent: ethyl acetate:petroleum ether = 1:3, v/v) to obtain Intermediate **49** as a white solid (620 mg, with a yield of 68.4%).

### Step 2: Synthesis of Intermediate 50

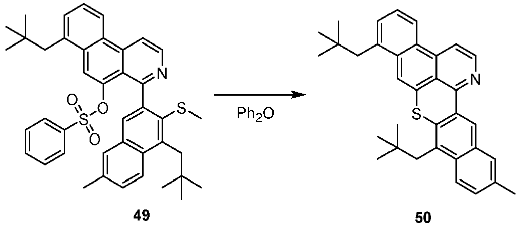

Intermediate **49** (620 mg, 0.94 mmol) and diphenyl ether (5 mL) were heated to 140 °C under nitrogen protection and reacted overnight. After TLC showed that the reaction was completed, the system was cooled to room temperature. The crude product was isolated through silica gel column chromatography (eluent: ethyl acetate:petroleum ether = 1:20, v/v) to obtain Intermediate **50** as a yellow solid (260 mg, with a yield of 56.5%).

### Step 3: Synthesis of an iridium dimer

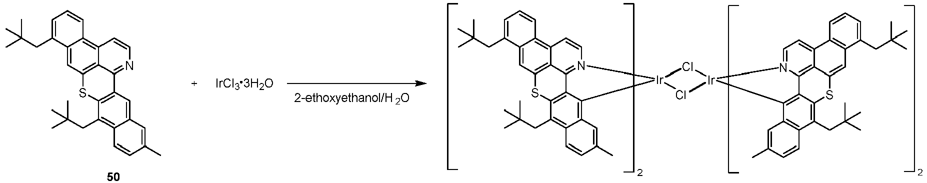

A mixture of Intermediate **50** (260 mg, 0.53 mmol), iridium trichloride trihydrate (62 mg, 0.18 mmol), 2-ethoxyethanol (9 mL) and water (3 mL) was refluxed under a nitrogen atmosphere for 24 h. The system was cooled to room temperature and subjected to rotary evaporation to carefully remove water in the solution so that a solution of an iridium dimer in ethoxyethanol was obtained, which was used in the next step without further purification.

### Step 4: Synthesis of Compound 1022

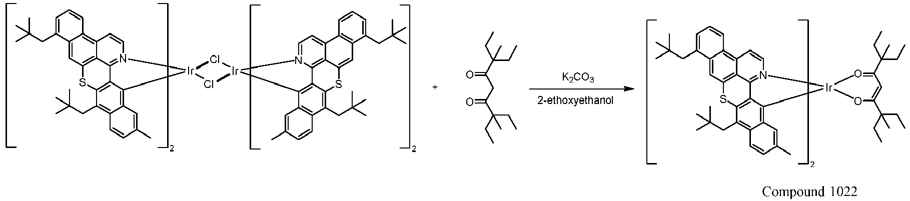

The solution of the iridium dimer in ethoxyethanol obtained in the previous step, 3,7-diethyl-3,7-dimethylnonane-4,6-dione (86 mg, 0.36 mmol) and potassium carbonate (124 mg, 0.9 mmol) were added to a 100 mL round-bottom flask and reacted at 60 °C for 24 h under nitrogen protection. Then, the system was poured into a funnel filled with Celite to be filtered and washed with ethanol. The obtained solids were added with dichloromethane and the filtrate was collected. Ethanol was added and the resulting solution was concentrated, but not to dryness. The residue was filtered to obtain 0.08 g of Compound 1022 with a yield of 31.5%. The structure of the compound was confirmed through LC-MS as the target product with a molecular weight of 1408.6.

Those skilled in the art will appreciate that the above preparation methods are merely exemplary. Those skilled in the art can obtain other compound structures of the present disclosure through the modifications of the preparation methods.

With a special design of a ligand structure, the metal complexes of the present disclosure achieve a deeper red light emission. The following photoluminescence (PL) spectroscopy data further proves that this deeper red light emission is an unexpected superior effect.

### Photoluminescence Spectrum Data

The photoluminescence (PL) spectroscopy data of the compounds of the present disclosure and the comparative compounds was measured using a fluorescence spectrophotometer LENGGUANG F98 produced by SHANGHAI LENGGUANG TECHNOLOGY CO., LTD. Samples of the compounds of the present disclosure or the comparative compounds were prepared into solutions each with a concentration of 3×10⁻⁵ mol/L by using HPLC-grade toluene and then excited at room temperature (298 K) using light with a wavelength of 500 nm, and their emission spectrums were measured. Measurement results are shown in Table 1.

**Table 1 Photoluminescence spectrum data**

| No. | Sample No. | Maximum Emission Wavelength λₘₐₓ (nm) |
|---|---|---|
| 1 | Compound RD-A | 623 |
| 2 | Compound RD-B | 619 |
| 3 | Compound RD | 619 |
| 4 | Compound 442 | 631 |
| 5 | Compound 341 | 622 |
| 6 | Compound 441 | 622 |

The structures of the related compounds of the present disclosure and comparative compounds are shown as follows:

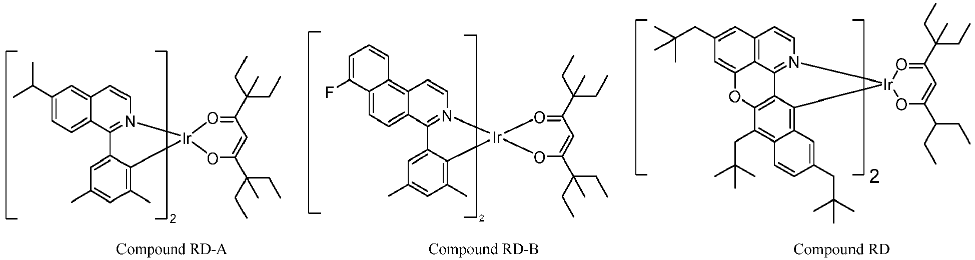

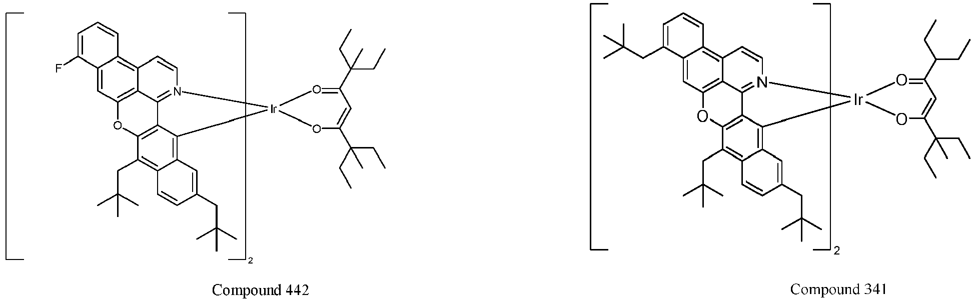

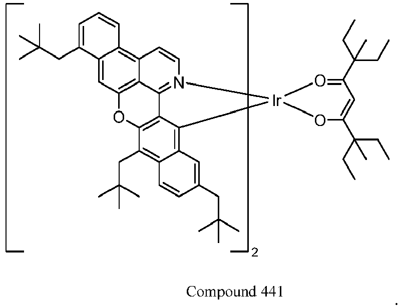

### Discussion

A phenylisoquinoline ligand is a type of ligand structure that is widely studied and applied in the related art, especially in the field of red phosphorescent metal complexes. In the researches, it has been found that introduction of an additional fused ring structure on the isoquinoline ring of this type of ligand leads to a significant blue-shifted emission wavelength, as can be seen, for example, from the data in Table 1, that the maximum emission wavelength of Compound RD-B comprising a phenyl benzoisoquinoline ligand is blue-shifted by 4 nm over that of Compound RD-A. In the present disclosure, a fused ring structure is also introduced into the ligand structures of Compound 442, Compound 341 and Compound 441 of the present disclosure at the same position of the isoquinoline ring. However, the maximum emission wavelengths of Compound 442, Compound 341 and Compound 441 each have a significant red shift over that of Compound RD. This effect of red shift is quite opposite to the change trend found in the related art. These comparisons show the uniqueness of the metal complex structure of the present disclosure. The present disclosure provides a metal complex which has a completely new structure and can achieve an unexpected deeper red light emission.

### Device Example

### Device Example 1

First, a glass substrate having an indium tin oxide (ITO) anode with a thickness of 120 nm was cleaned and then treated with oxygen plasma and UV ozone. After the treatment, the substrate was dried in a glovebox to remove moisture. Then, the substrate was mounted on a substrate holder and placed in a vacuum chamber. Organic layers specified below were sequentially deposited through vacuum thermal evaporation on the ITO anode at a rate of 0.2 to 2 Angstroms per second and a vacuum degree of about 10⁻⁸ torr (wherein 1 torr = 133.322 Pa). Compound HI was doped in Compound HT for use as a hole injection layer (HIL, 3:97) with a thickness of 100 Å. Compound HT was used as a hole transporting layer (HTL) with a thickness of 400 Å. Compound EB was used as an electron blocking layer (EBL) with a thickness of 50 Å. Compound 341 of the present disclosure was doped in a host compound RH for use as an emissive layer (EML, 5:95) with a thickness of 400 Å. Compound HB was used as a hole blocking layer (HBL) with a thickness of 50 Å. On the HBL, Compound ET and 8-hydroxyquinolinolato-lithium (Liq) were co-deposited as an electron transporting layer (ETL) with a thickness of 350 Å. Finally, Liq was deposited as an electron injection layer with a thickness of 1 nm, and Al was deposited as a cathode with a thickness of 120 nm. The device was transferred back to the glovebox and encapsulated with a glass lid and a moisture getter to complete the device.

### Device Comparative Example 1

The preparation method in Device Comparative Example 1 was the same as that in Device Example 1, except that in the emissive layer (EML), Compound 341 of the present disclosure was replaced with Compound RD.

### Device Example 3

The preparation method in Device Example 3 was the same as that in Device Example 1, except that in the emissive layer (EML), Compound 341 of the present disclosure was replaced with Compound 438 of the present disclosure and the weight ratio of Compound 438 and Compound RH was 3:97.

### Device Example 4

The preparation method in Device Example 4 was the same as that in Device Example 3, except that in the emissive layer (EML), Compound 438 of the present disclosure was replaced with Compound 446 of the present disclosure.

### Device Example 5

The preparation method in Device Example 5 was the same as that in Device Example 3, except that in the emissive layer (EML), Compound 438 of the present disclosure was replaced with Compound 1021 of the present disclosure.

### Device Example 6

The preparation method in Device Example 6 was the same as that in Device Example 3, except that in the emissive layer (EML), Compound 438 of the present disclosure was replaced with Compound 405 of the present disclosure.

### Device Example 7

The preparation method in Device Example 7 was the same as that in Device Example 3, except that in the emissive layer (EML), Compound 438 of the present disclosure was replaced with Compound 1019 of the present disclosure.

### Device Example 8

The preparation method in Device Example 8 was the same as that in Device Example 3, except that in the emissive layer (EML), Compound 438 of the present disclosure was replaced with Compound 447 of the present disclosure.

### Device Example 9

The preparation method in Device Example 9 was the same as that in Device Example 3, except that in the emissive layer (EML), Compound 438 of the present disclosure was replaced with Compound 1020 of the present disclosure.

### Device Example 10

The preparation method in Device Example 10 was the same as that in Device Example 3, except that in the emissive layer (EML), Compound 438 of the present disclosure was replaced with Compound 1018 of the present disclosure.

### Device Example 11

The preparation method in Device Example 11 was the same as that in Device Example 3, except that in the emissive layer (EML), Compound 438 of the present disclosure was replaced with Compound 1017 of the present disclosure.

### Device Comparative Example 3

The preparation method in Device Comparative Example 3 was the same as that in Device Example 3, except that in the emissive layer (EML), Compound 438 of the present disclosure was replaced with Compound RD1.

Structures and thicknesses of part of layers of the devices are shown in the following table. A layer using more than one material is obtained by doping different compounds at their weight ratio as recorded.

**Table 2 Part of device structures in device examples and device comparative examples**

| Device No. | HIL | HTL | EBL | EML | HBL | ETL |
|---|---|---|---|---|---|---|
| Comparative Example 1 | Compound HT: Compound HI (97:3) (100 Å) | Compound HT (400 Å) | Compound EB (50 Å) | Compound RH:Compound RD (95:5) (400 Å) | Compound HB (50 Å) | Compound ET:Liq (40:60) (350 Å) |
| Example 1 | Compound HT: Compound HI (97:3) (100 Å) | Compound HT (400 Å) | Compound EB (50 Å) | Compound RH:Compound 341 (95:5) (400 Å) | Compound HB (50 Å) | Compound ET:Liq (40:60) (350 Å) |
| Example 3 | Compound HT: Compound HI (97:3) (100 Å) | Compound HT (400 Å) | Compound EB (50 Å) | Compound RH:Compound 438 (97:3) (400 Å) | Compound HB (50 Å) | Compound ET:Liq (40:60) (350 Å) |
| Example 4 | Compound HT: Compound HI (97:3) (100 Å) | Compound HT (400 Å) | Compound EB (50 Å) | Compound RH:Compound 446 (97:3) (400 Å) | Compound HB (50 Å) | Compound ET:Liq (40:60) (350 Å) |
| Example 5 | Compound HT: Compound HI (97:3) (100 Å) | Compound HT (400 Å) | Compound EB (50 Å) | Compound RH:Compound 1021 (97:3) (400 Å) | Compound HB (50 Å) | Compound ET:Liq (40:60) (350 Å) |
| Example 6 | Compound HT: Compound HI (97:3) (100 Å) | Compound HT (400 Å) | Compound EB (50 Å) | Compound RH:Compound 405 (97:3) (400 Å) | Compound HB (50 Å) | Compound ET:Liq (40:60) (350 Å) |
| Example 7 | Compound HT: Compound HI (97:3) (100 Å) | Compound HT (400 Å) | Compound EB (50 Å) | Compound RH:Compound 1019 (97:3) (400 Å) | Compound HB (50 Å) | Compound ET:Liq (40:60) (350 Å) |
| Example 8 | Compound HT: Compound HI (97:3) (100 Å) | Compound HT (400 Å) | Compound EB (50 Å) | Compound RH:Compound 447 (97:3) (400 Å) | Compound HB (50 Å) | Compound ET:Liq (40:60) (350 Å) |
| Example 9 | Compound HT: Compound HI (97:3) (100 Å) | Compound HT (400 Å) | Compound EB (50 Å) | Compound RH:Compound 1020 (97:3) (400 Å) | Compound HB (50 Å) | Compound ET:Liq (40:60) (350 Å) |
| Example 10 | Compound HT: Compound HI (97:3) (100 Å) | Compound HT (400 Å) | Compound EB (50 Å) | Compound RH:Compound 1018 (97:3) (400 Å) | Compound HB (50 Å) | Compound ET:Liq (40:60) (350 Å) |
| Example 11 | Compound HT:Compound HI (97:3) (100 Å) | Compound HT (400 Å) | Compound EB (50 Å) | Compound RH:Compound 1017 (97:3) (400 Å) | Compound HB (50 Å) | Compound ET:Liq (40:60) (350 Å) |
| Comparative Example 3 | Compound HT: Compound HI (97:3) (100 Å) | Compound HT (400 Å) | Compound EB (50 Å) | Compound RH:Compound RD1 (97:3) (400 Å) | Compound HB (50 Å) | Compound ET:Liq (40:60) (350 Å) |

The structures of the materials used in the devices are shown as follows:

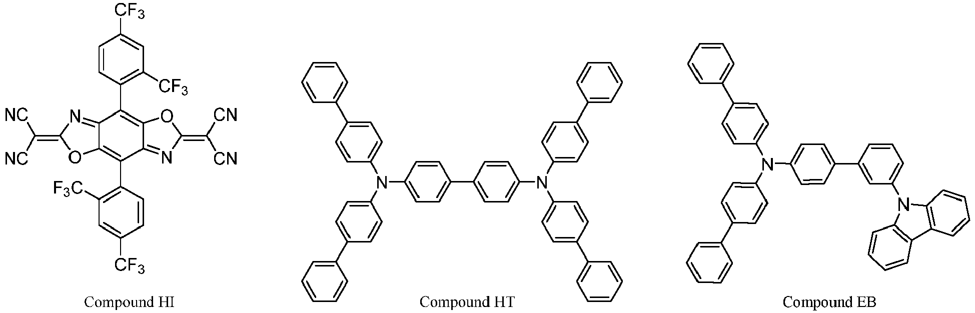

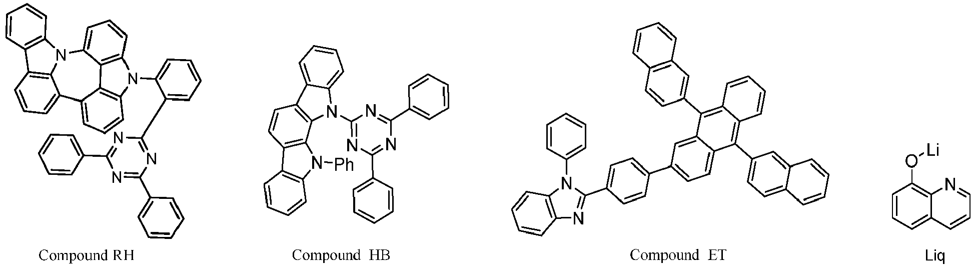

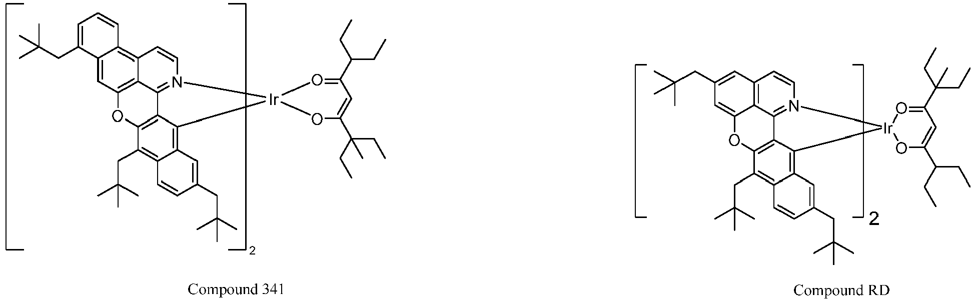

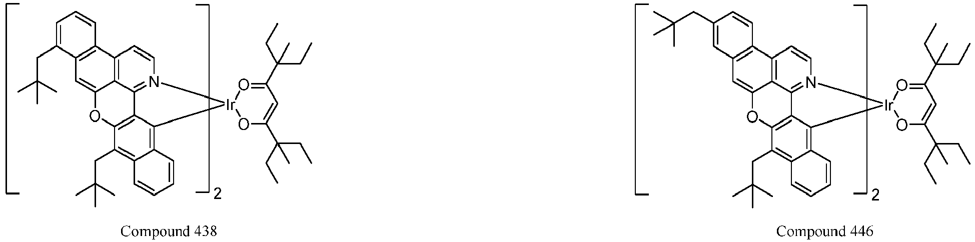

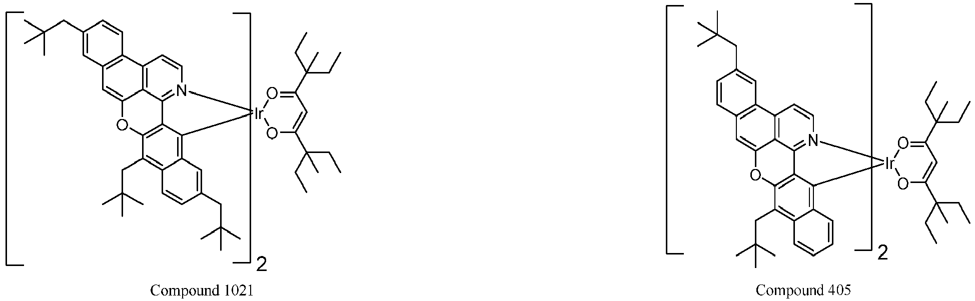

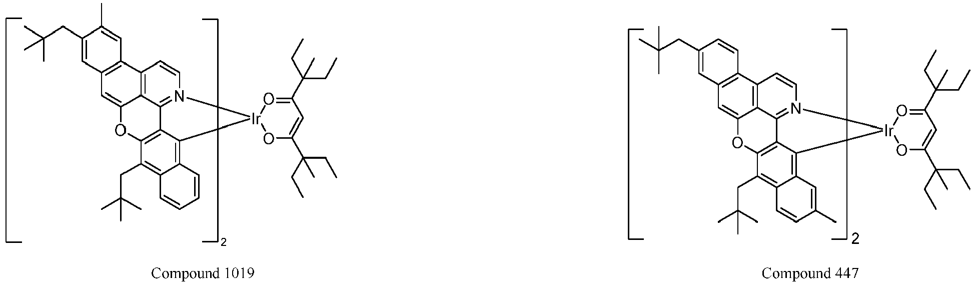

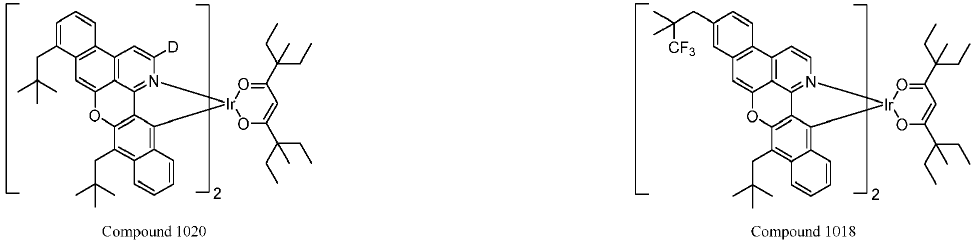

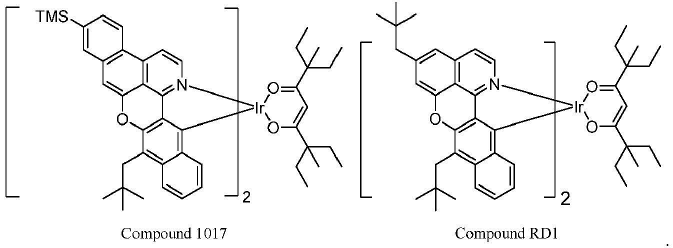

IVL characteristics of the devices were measured. Table 3 shows the CIE data, driving voltage (Voltage), maximum emission wavelength (λₘₐₓ), full width at half maximum (FWHM) and external quantum efficiency (EQE) of the device examples and the device comparative examples measured at a constant current of 15 mA/cm².

**Table 3 Device data**

| Device No. | CIE (x, y) | λₘₐₓ (nm) | FWHM (nm) | Voltage (V) | EQE (%) |
|---|---|---|---|---|---|
| Comparative Example 1 | (0.684, 0.315) | 621 | 31.7 | 3.82 | 24.11 |
| Example 1 | (0.688, 0.311) | 625 | 32.7 | 3.81 | 25.86 |
| Example 3 | (0.678, 0.321) | 618 | 32.4 | 3.32 | 26.44 |
| Example 4 | (0.675, 0.324) | 617 | 32.2 | 3.35 | 27.05 |
| Example 5 | (0.684, 0.315) | 623 | 32.5 | 3.71 | 25.62 |
| Example 6 | (0.679, 0.320) | 620 | 32.7 | 3.37 | 24.59 |
| Example 7 | (0.678, 0.321) | 619 | 32.1 | 3.43 | 24.57 |
| Example 8 | (0.688, 0.311) | 625 | 34.1 | 3.58 | 26.47 |
| Example 9 | (0.677, 0.322) | 619 | 32.4 | 3.39 | 26.67 |
| Example 10 | (0.679, 0.320) | 620 | 32.6 | 3.41 | 25.76 |
| Example 11 | (0.684, 0.315) | 623 | 33.2 | 3.42 | 25.01 |
| Comparative Example 3 | (0.675, 0.325) | 616 | 31.9 | 3.40 | 24.24 |

### Discussion

As can be seen from the data shown in Table 3, Example 1 has a significant red shift in color while a very narrow full width at half maximum is maintained similar to that in Comparative Example 1 and a relatively low voltage is maintained substantially the same as that in Comparative Example 1, with the CIEx being shifted from 0.684 in Comparative Example 1 to 0.688, and the maximum emission wavelength being red-shifted from 621 nm in Comparative Example 1 to 625 nm, achieving a deeper red light emission. Moreover, the external quantum efficiency in Example 1 also has a further significant improvement than the extremely high efficiency level of 24.11% in Comparative Example 1 and is improved by nearly 7.3%. It proves that the present disclosure provides deep red phosphorescent materials with a narrow peak width, a low voltage and high efficiency and fully proves that the compounds of the present disclosure have broad application prospect.

Compared to Comparative Example 3, the maximum emission wavelengths in Examples 3 to 11 each has a red shift while a very narrow full width at half maximum and a low voltage level are maintained substantially the same as those in Comparative Example 3, achieving a deeper red light emission. Moreover, the device efficiency in Examples 3 to 11 has a further significant improvement than the extremely high efficiency level of 24.24% in Comparative Example 3. In particular, Examples 3, 4, 8 and 9 all achieve ultra-high device efficiency of more than 26%. Again, it proves that the present disclosure provides deep red phosphorescent materials with a narrow peak width, a low voltage and high efficiency and fully proves that the compounds of the present disclosure have broad application prospect.

Further, since a top-emitting device structure is a device structure widely applied to commercial devices, the excellent effect of the metal complexes of the present disclosure in the top-emitting device is further verified in the present disclosure.

### Device Example 2

Firstly, a 0.7 mm thick glass substrate was provided. On the glass substrate, indium tin oxide (ITO) 75 Å/Ag 1500 Å/ITO 150 Å were pre-patterned for use as an anode. Then, the substrate was dried in a glovebox to remove moisture, mounted on a holder and transferred into a vacuum chamber. Organic layers specified below were sequentially deposited through vacuum thermal evaporation on the anode at a rate of 0.01 to 10 Å/s and a vacuum degree of about 10⁻⁶ torr (wherein 1 torr = 133.322 Pa). Firstly, Compound HT1 and Compound HI were simultaneously deposited as a hole injection layer (HIL, 97:3, 100 Å). On the HIL, Compound HT1 was deposited for use as a hole transporting layer (HTL, 2200 Å). The HTL was also used as a microcavity adjustment layer. Then, on the hole transporting layer, Compound EB1 was deposited for use as an electron blocking layer (EBL, 50 Å). Then, Compound 341 of the present disclosure and Compound RH were co-deposited as an emissive layer (EML, 3:97, 400 Å). On the EML, Compound ET1 and Liq were co-deposited as an electron transporting layer (ETL, 40:60, 350 Å). A metal Yb (10 Å) was deposited as an electron injection layer (EIL), and the metals Ag and Mg were co-deposited as a cathode (140 Å) at a ratio of 9:1. Finally, Compound CPL54 was deposited as a cathode capping layer (CPL, 650 Å). Compound CPL54 was purchased from JIANGSU SUNERA TECHNOLOGY CO., LTD. The device was transferred back to the glovebox and encapsulated with a glass lid and a moisture getter in a nitrogen atmosphere to complete the device.

### Device Comparative Example 2

The preparation method in Device Comparative Example 2 was the same as that in Device Example 2, except that in the emissive layer (EML), Compound 341 of the present disclosure was replaced with Compound RD.

### Device Example 12

The preparation method in Device Example 12 was the same as that in Device Example 2, except that in the emissive layer (EML), Compound 341 of the present disclosure was replaced with Compound 447 of the present disclosure.

Structures and thicknesses of part of layers of the devices are shown in the following table. A layer using more than one material is obtained by doping different compounds at their weight ratio as recorded.

**Table 4 Part of device structures in Examples 2 and 12 and Comparative Example 2**

| Device No. | HIL | HTL | EBL | EML | ETL |
|---|---|---|---|---|---|
| Example 2 | Compound HI:Compound HT1 (3:97) (100 Å) | Compound HT1 (2200 Å) | Compound EB1 (50 Å) | Compound RH:Compound 341 (97:3) (400 Å) | Compound ET1:Liq (40:60) (350 Å) |
| Comparative Example 2 | Compound HI:Compound HT1 (3:97) (100 Å) | Compound HT1 (2200 Å) | Compound EB1 (50 Å) | Compound RH:Compound RD (97:3) (400 Å) | Compound ET1:Liq (40:60) (350 Å) |
| Example 12 | Compound HI:Compound HT1 (3:97) (100 Å) | Compound HT1 (2200 Å) | Compound EB1 (50 Å) | Compound RH:Compound 447 (97:3) (400 Å) | Compound ET1:Liq (40:60) (350 Å) |

The structures of the new materials used in the devices are shown as follows:

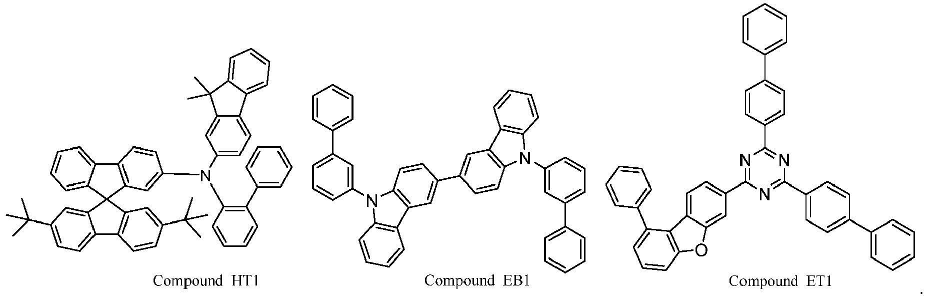

IVL characteristics of the devices were measured. At 10 mA/cm², CIE data, maximum emission wavelength λₘₐₓ, voltage (V), full width at half maximum (FWHM) and external quantum efficiency (EQE) of the devices were measured. The data was recorded and shown in Table 5.

**Table 5 Device data in Examples 2 and 12 and Comparative Example 2**

| Device ID | CIE (x, y) | λₘₐₓ (nm) | FWHM (nm) | Voltage (V) | EQE (%) |
|---|---|---|---|---|---|
| Example 2 | (0.690, 0.310) | 623 | 25.0 | 3.23 | 55.33 |
| Comparative Example 2 | (0.680, 0.319) | 618 | 24.3 | 3.21 | 47.22 |
| Example 12 | (0.691, 0.308) | 624 | 24.4 | 3.23 | 53.21 |

### Discussion

As can be seen from Table 5, the top-emitting device in Example 2 using the compound of the present disclosure at the emissive layer also has very excellent performance. In Example 2, a very narrow full width at half maximum is maintained similar to that in Comparative Example 2, and a relatively low voltage level is maintained substantially the same as that in Comparative Example 2. Further, compared to Comparative Example 2, the emitted color in Example 2 also has a significant red shift, with the CIEx being shifted from 0.680 to 0.690 and the maximum emission wavelength being red-shifted from 618 nm to 623 nm. Moreover, in Example 2, in the case where the voltage is maintained substantially the same as that in Comparative Example 2, the EQE has a significant improvement and is improved by nearly 17%. Example 12 exhibits an extremely narrow full width at half maximum level that is almost the same as that in Comparative Example 2, and a relatively low voltage level is maintained substantially the same as that in Comparative Example 2. More importantly, the maximum emission wavelength in Example 12 has a significant red shift. Moreover, the EQE also has a significant improvement and is improved by nearly 13%. Example 12 has very excellent device performance similar to that in Example 2. Again, it proves that the metal complexes of the present disclosure have excellent characteristics and a great application potential in the top-emitting device.

## Claims

1. A metal complex, comprising a metal M and a ligand Lₐ coordinated to the metal M, wherein the metal M is selected from a metal with a relative atomic mass greater than 40, and the ligand Lₐ has a structure represented by Formula 1: 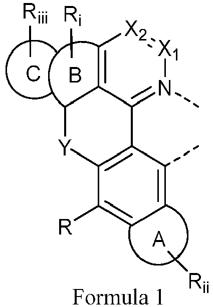
wherein the ring A and the ring B are each independently selected from a five-membered unsaturated carbocyclic ring, an aromatic ring having 6 to 30 carbon atoms or a heteroaromatic ring having 3 to 30 carbon atoms; and the ring C is selected from an aromatic ring having 6 to 30 carbon atoms or a heteroaromatic ring having 6 to 30 ring atoms;
Rᵢ and Rᵢᵢ represent, at each occurrence identically or differently, mono-substitution, multiple substitutions or non-substitution; and Rᵢᵢᵢ represents, at each occurrence identically or differently, mono-substitution or multiple substitutions;
Y is selected from SiR_{y}R_{y}, GeR_{y}R_{y}, O, S or Se;
when two R_{y} are present at the same time, the two R_{y} may be identical or different;
X₁ and X₂ are, at each occurrence identically or differently, selected from CRₓ or N;
R, Rᵢ, Rᵢᵢ, Rₓ and R_{y} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
wherein substituted alkyl, substituted cycloalkyl, substituted heteroalkyl, substituted heterocyclic group, substituted arylalkyl, substituted alkoxy, substituted aryloxy, substituted alkenyl, substituted aryl, substituted heteroaryl, substituted alkylsilyl, substituted arylsilyl, substituted alkylgermanyl, substituted arylgermanyl, and substituted amino are substituted with one or more groups selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl group having 6 to 20 carbon atoms, unsubstituted alkylgermanyl group having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof; and
adjacent substituents Rᵢ, Rₓ, R_{y}, R, Rᵢᵢ and Rᵢᵢᵢ are optionally joined to form a ring.

2. The metal complex according to claim 1, wherein the ring A and/or the ring B are each independently selected from a five-membered unsaturated carbocyclic ring, an aromatic ring having 6 to 18 carbon atoms or a heteroaromatic ring having 3 to 18 carbon atoms; and the ring C is selected from an aromatic ring having 6 to 18 carbon atoms or a heteroaromatic ring having 6 to 18 ring atoms; and
preferably, the ring A and/or the ring B are each independently selected from a five-membered unsaturated carbocyclic ring, an aromatic ring having 6 to 10 carbon atoms or a heteroaromatic ring having 3 to 10 carbon atoms; and the ring C is selected from an aromatic ring having 6 to 10 carbon atoms or a heteroaromatic ring having 6 to 10 ring atoms.

3. The metal complex according to claim 1 or 2, wherein Lₐ is selected from a structure represented by any one of Formula 2 to Formula 17: 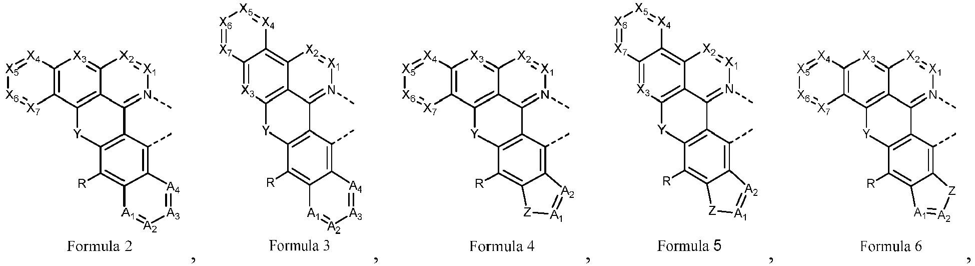 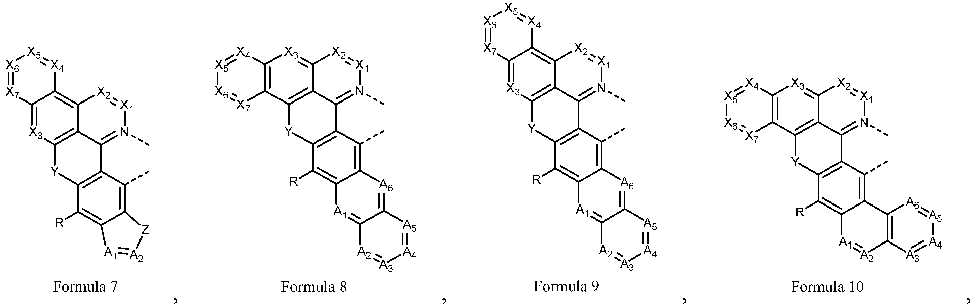 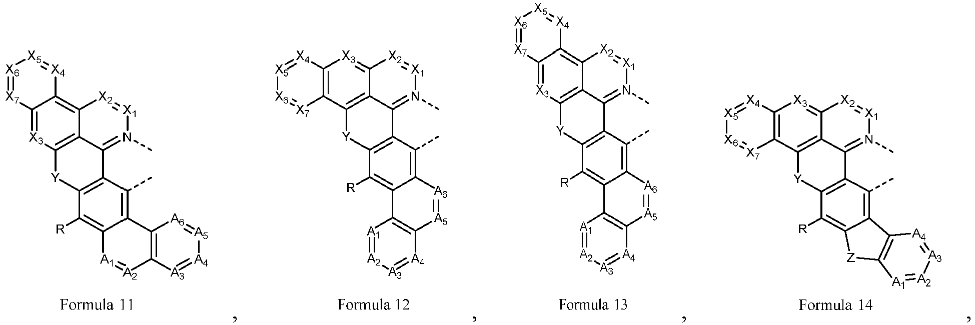 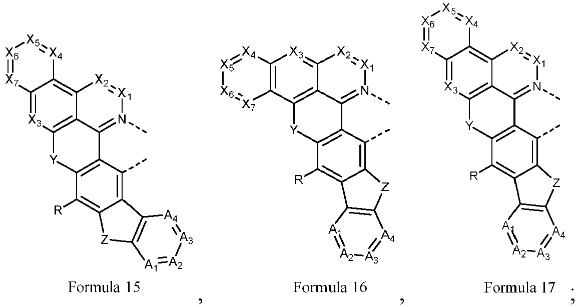 wherein
In Formula 2 to Formula 17, X₁ and X₂ are, at each occurrence identically or differently, selected from CRₓ or N; preferably, X₁ is selected from CRₓ; X₃ is selected from CRᵢ or N; A₁ to A₆ are, at each occurrence identically or differently, selected from CRᵢᵢ or N; X₄ to X₇ are, at each occurrence identically or differently, selected from CH, CRᵢᵢᵢ or N, and at least one of X₄ to X₇ is selected from CRᵢᵢᵢ;
Z is, at each occurrence identically or differently, selected from CRᵢᵥRᵢᵥ, SiRᵢᵥRᵢᵥ, PRᵢᵥ, O, S or NRᵢᵥ; when two Rᵢᵥ are present at the same time, the two Rᵢᵥ are identical or different;
Y is selected from SiR_{y}R_{y}, O, S or Se; when two R_{y} are present at the same time, the two R_{y} are identical or different; preferably, Y is selected from O or S;
R, Rₓ, R_{y}, Rᵢ, Rᵢᵢ and Rᵢᵥ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents Rᵢ, Rₓ, R_{y}, R, Rᵢᵢ, Rᵢᵢᵢ and Rᵢᵥ are optionally joined to form a ring;
preferably, Lₐ is selected from a structure represented by Formula 2 or Formula 3; and
more preferably, Lₐ is selected from a structure represented by Formula 3.

4. The metal complex according to claim 3, wherein in Formula 2 to Formula 17, at least one of X₁ to Xₙ and/or A₁ to Aₘ is selected from N, wherein Xₙ corresponds to one with the largest serial number among X₁ to X₇ in any one of Formula 2 to Formula 17, and Aₘ corresponds to one with the largest serial number among A₁ to A₆ in any one of Formula 2 to Formula 17;
preferably, in Formula 2 to Formula 17, at least one of X₁ to Xₙ is selected from N, wherein Xₙ corresponds to one with the largest serial number among X₁ to X₇ in any one of Formula 2 to Formula 17; and
more preferably, X₂ is N.

5. The metal complex according to claim 3, wherein in Formula 2 to Formula 17, X₁ and X₂ are each independently selected from CRₓ; X₃ is selected from CRi; A₁ to A₆ are each independently selected from CRᵢᵢ; X₄ to X₇ are, at each occurrence identically or differently, selected from CH or CRᵢᵢᵢ, and at least one of X₄ to X₇ is selected from CRᵢᵢᵢ; adjacent substituents Rₓ, Rᵢ, Rᵢᵢ and Rᵢᵢᵢ are optionally joined to form a ring;
preferably, the Rₓ, Rᵢ and Rᵢᵢ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group and combinations thereof;
the Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group and combinations thereof;
more preferably, at least one or two of Rₓ, Rᵢ and Rᵢᵢ is(are), at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group and combinations thereof; and
Rᵢᵢᵢ is, at each occurrence identically or differently, selected from the group consisting of: deuterium, fluorine, methyl, ethyl, isopropyl, isobutyl, t-butyl, neopentyl, cyclopentyl, cyclopentylmethyl, cyclohexyl, norbornyl, adamantyl, trimethylsilyl, isopropyldimethylsilyl, phenyldimethylsilyl, trifluoromethyl, a cyano group, phenyl and combinations thereof.

6. The metal complex according to any one of claims 3 to 5, wherein in Formula 2 to Formula 17, at least one or two of A₁ to A₆ is(are) selected from CRᵢᵢ, and the Rᵢᵢ is, at each occurrence identically or differently, selected from deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group or a combination thereof;
X₃ is selected from CRi, and the Rᵢ is, at each occurrence identically or differently, selected from hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group or a combination thereof;
preferably, the Rᵢ is, at each occurrence identically or differently, selected from the group consisting of: hydrogen, deuterium, fluorine, methyl, ethyl, isopropyl, isobutyl, t-butyl, neopentyl, cyclopentyl, cyclopentylmethyl, cyclohexyl, norbornyl, adamantyl, trimethylsilyl, isopropyldimethylsilyl, phenyldimethylsilyl, trifluoromethyl, a cyano group, phenyl and combinations thereof; and
the Rᵢᵢ is, at each occurrence identically or differently, selected from the group consisting of: deuterium, fluorine, methyl, ethyl, isopropyl, isobutyl, t-butyl, neopentyl, cyclopentyl, cyclopentylmethyl, cyclohexyl, norbornyl, adamantyl, trimethylsilyl, isopropyldimethylsilyl, phenyldimethylsilyl, trifluoromethyl, a cyano group, phenyl and combinations thereof.

7. The metal complex according to any one of claims 3 to 6, wherein in Formula 2 to Formula 17, R is selected from hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof; and
preferably, the R is selected from hydrogen, deuterium, fluorine, methyl, ethyl, isopropyl, isobutyl, t-butyl, cyclopentyl, cyclopentylmethyl, cyclohexyl, neopentyl, deuterated methyl, deuterated ethyl, deuterated isopropyl, deuterated isobutyl, deuterated t-butyl, deuterated cyclopentyl, deuterated cyclopentylmethyl, deuterated cyclohexyl, deuterated neopentyl, trimethylsilyl or a combination thereof.

8. The metal complex according to any one of claims 1 to 7, wherein the ligand Lₐ has a structure represented by Formula 18: 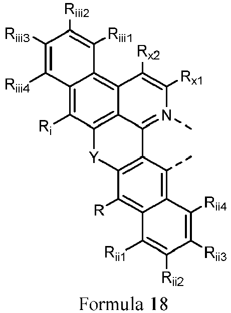
wherein in Formula 18, Y is selected from O or S;
Rₓ₁, Rₓ₂, Rᵢ, Rᵢᵢ₁, Rᵢᵢ₂, Rᵢᵢ₃, Rᵢᵢ₄, R, Rᵢᵢᵢ₁, Rᵢᵢᵢ₂, Rᵢᵢᵢ₃ and Rᵢᵢᵢ₄ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; at least one of Rᵢᵢᵢ₁, Rᵢᵢᵢ₂, Rᵢᵢᵢ₃ and Rᵢᵢᵢ₄ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
preferably, one or two of Rₓ₁ and Rₓ₂ and/or at least one or two of Rᵢᵢ₁, Rᵢᵢ₂, Rᵢᵢ₃ and Rᵢᵢ₄ is(are), at each occurrence identically or differently, selected from deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof; R is selected from halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof; at least one or two of Rᵢᵢᵢ₁, Rᵢᵢᵢ₂, Rᵢᵢᵢ₃ and Rᵢᵢᵢ₄ is(are), at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof;
more preferably, one or two of Rₓ₁ and Rₓ₂ and/or at least one or two of Rᵢᵢ₁, Rᵢᵢ₂, Rᵢᵢ₃ and Rᵢᵢ₄ is(are), at each occurrence identically or differently, selected from substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof; R is selected from substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms or a combination thereof; and
at least one or two of Rᵢᵢᵢ₁, Rᵢᵢᵢ₂, Rᵢᵢᵢ₃ and Rᵢᵢᵢ₄ is(are), at each occurrence identically or differently, selected from the group consisting of: substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms and combinations thereof.

9. The metal complex according to claim 8, wherein in Formula 18, at least one of Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ and R is, at each occurrence identically or differently, selected from the group consisting of: substituted or unsubstituted alkyl having 3 to 20 carbon atoms, substituted or unsubstituted cycloalkyl having 3 to 20 ring carbon atoms, substituted or unsubstituted alkylsilyl having 3 to 20 carbon atoms and combinations thereof; and
preferably, at least one of Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ and R is, at each occurrence identically or differently, selected from the group consisting of: substituted or unsubstituted alkyl having 3 to 10 carbon atoms, substituted or unsubstituted cycloalkyl having 3 to 10 ring carbon atoms and combinations thereof.

10. The metal complex according to any one of claims 1 to 9, wherein Lₐ is, at each occurrence identically or differently, selected from the group consisting of the following structures: 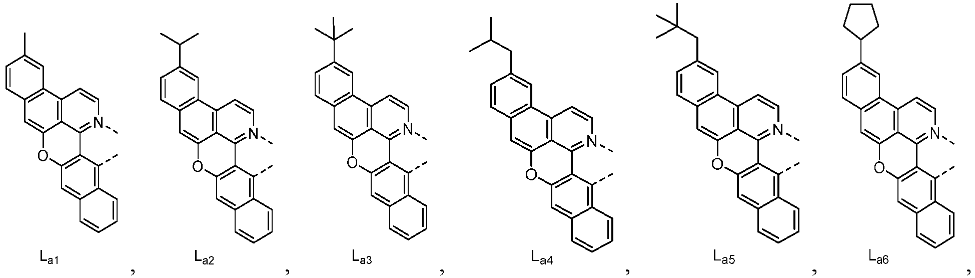 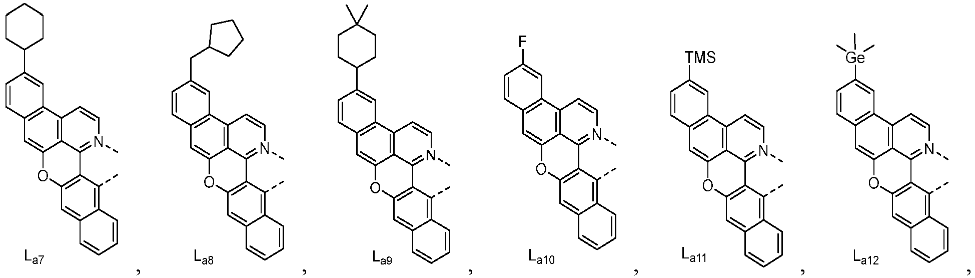 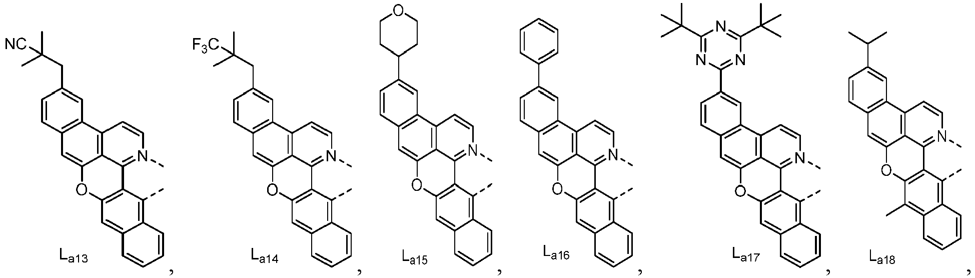 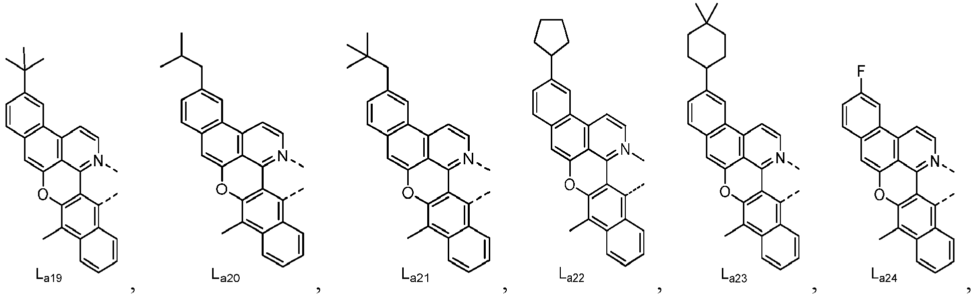 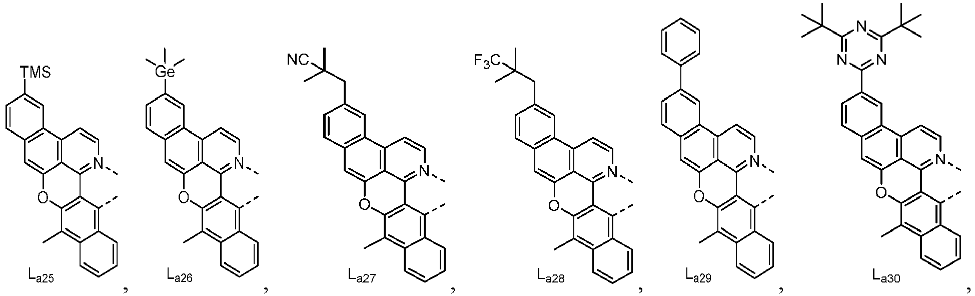 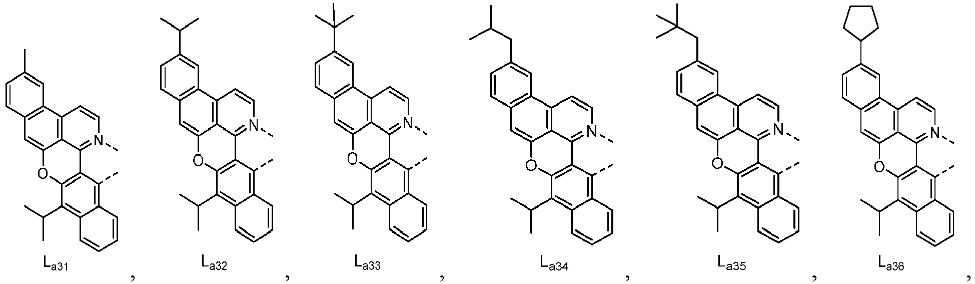 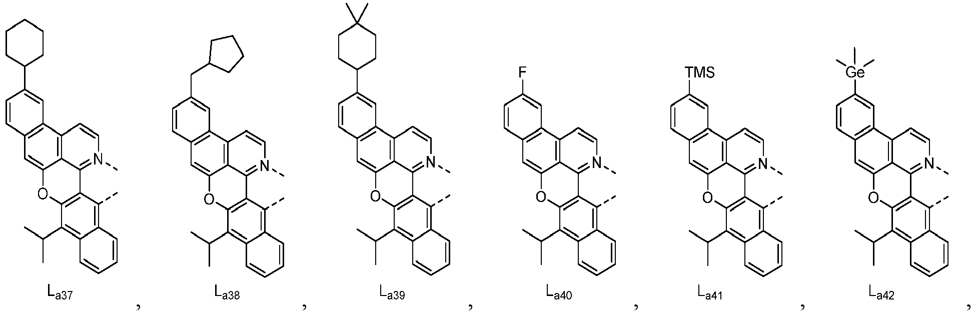 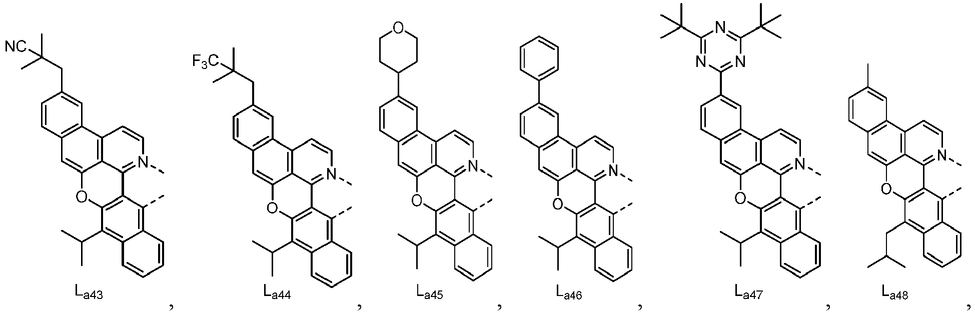 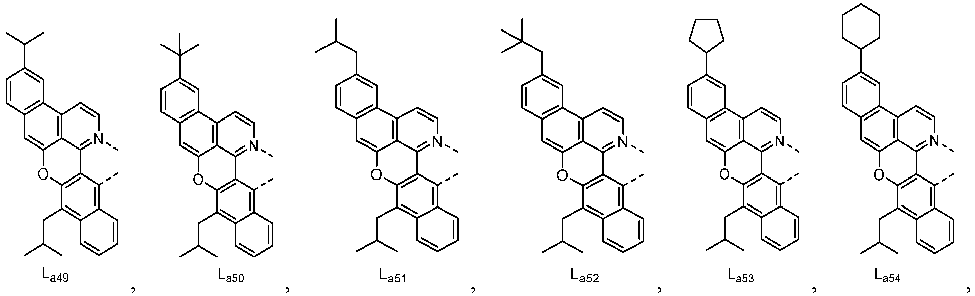 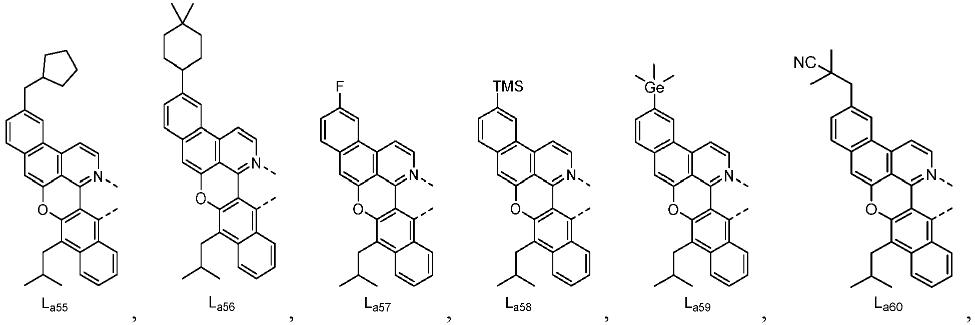 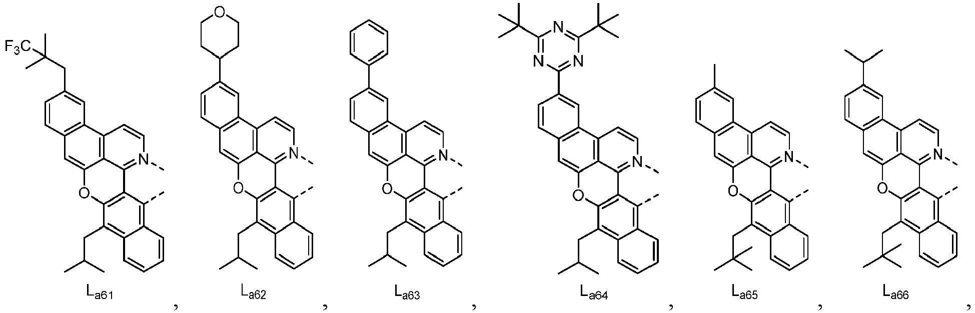 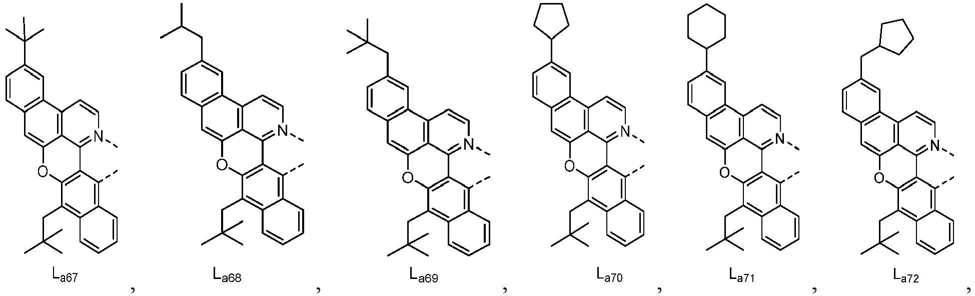 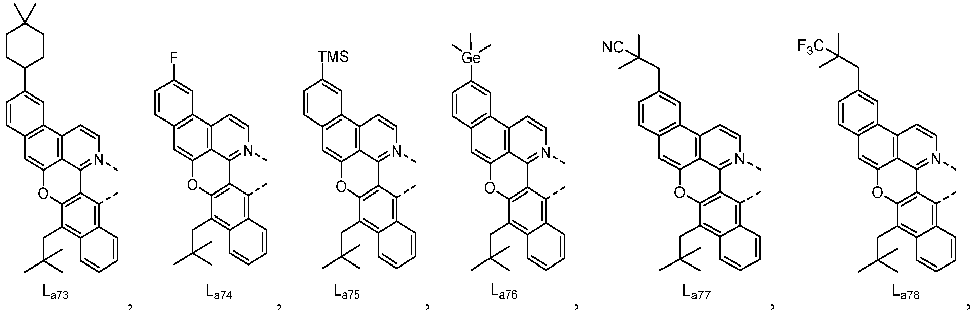 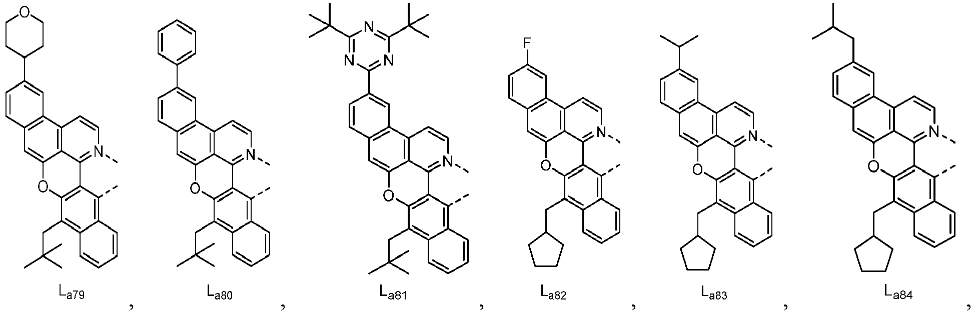 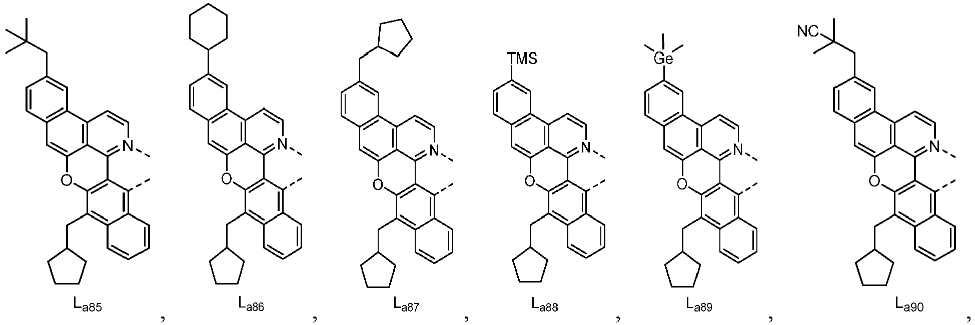 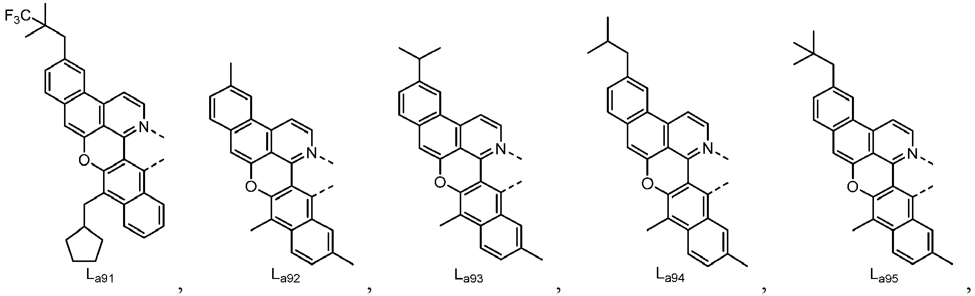 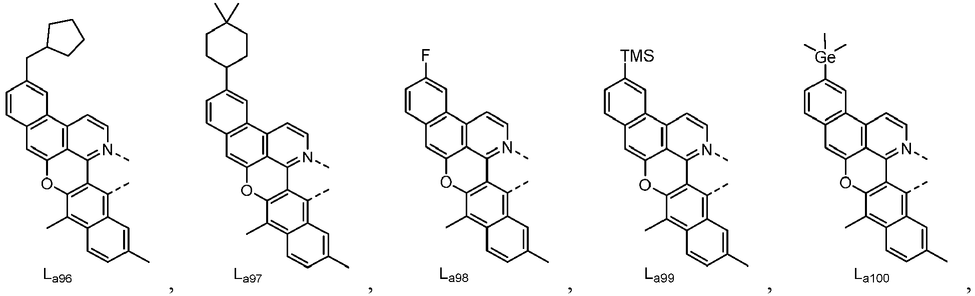 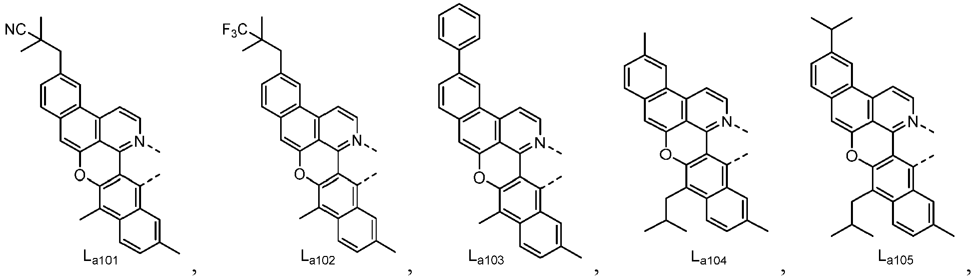 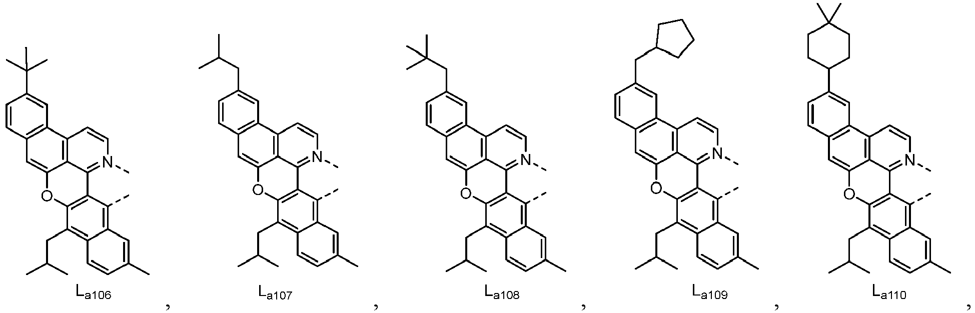 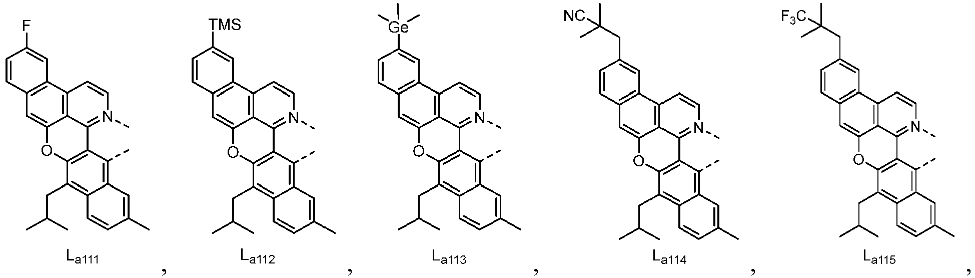 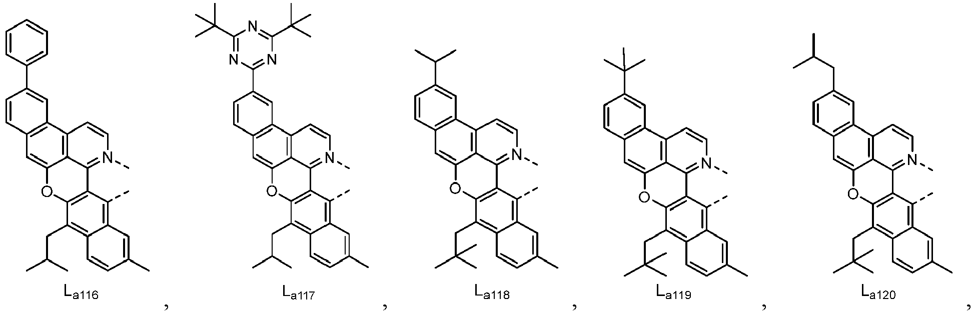 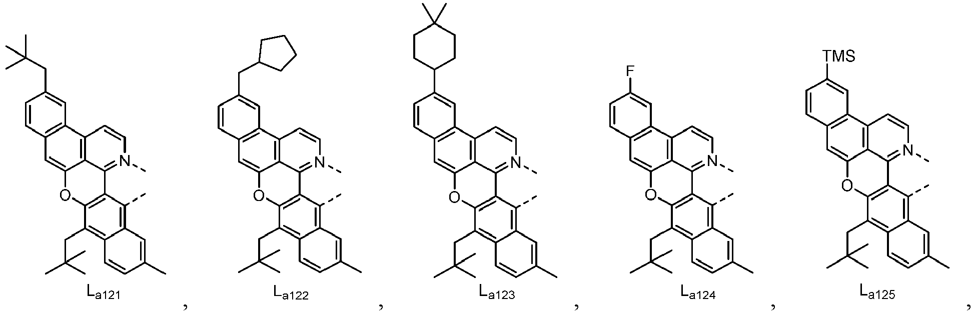 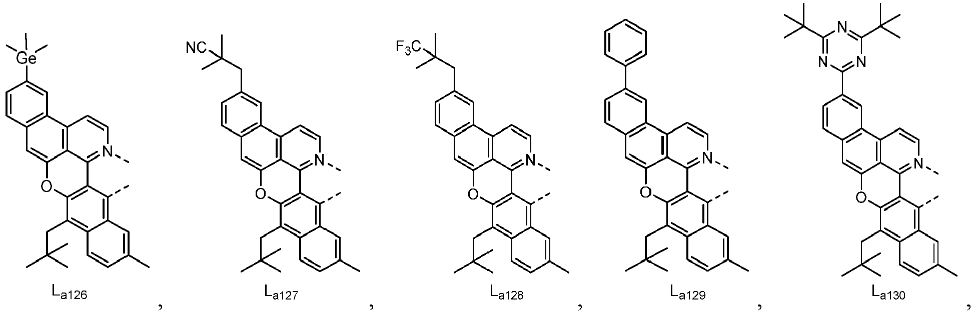 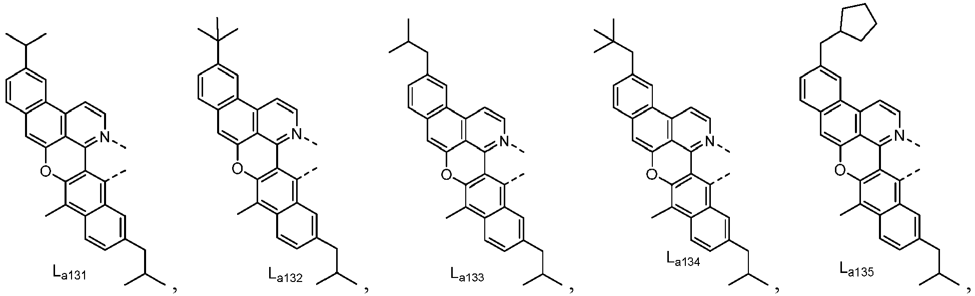 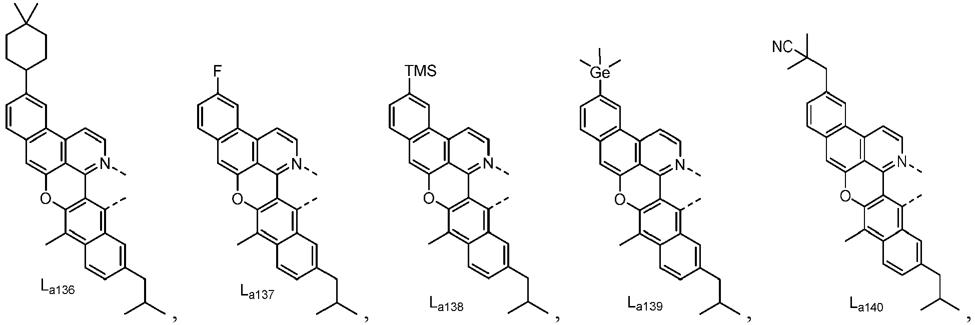 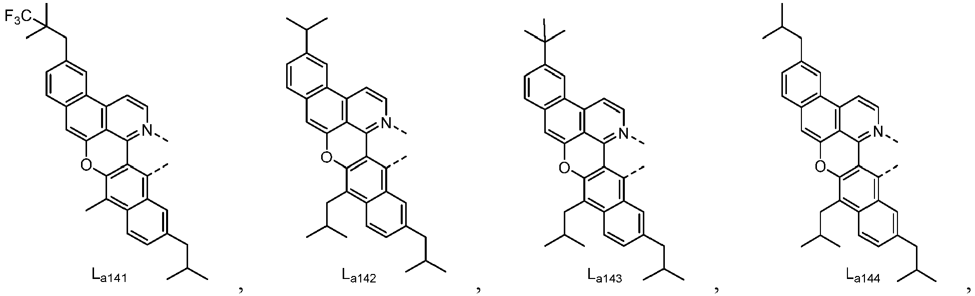 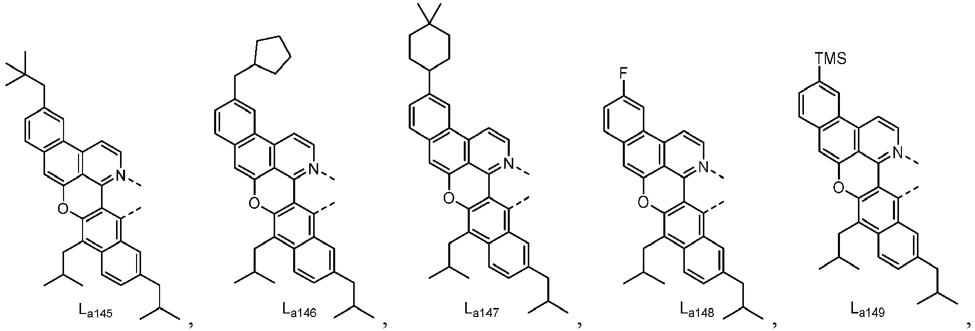 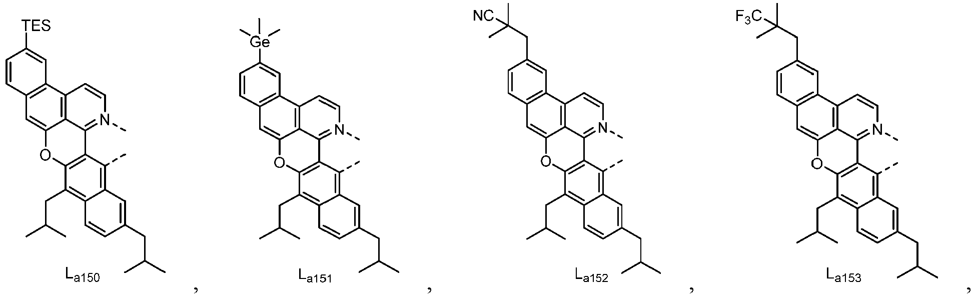 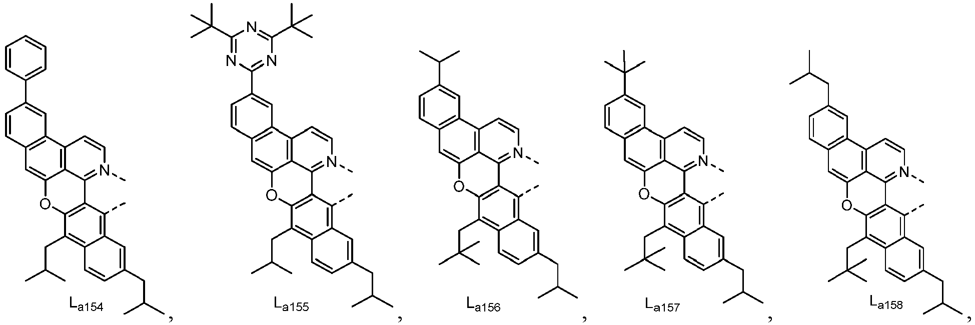 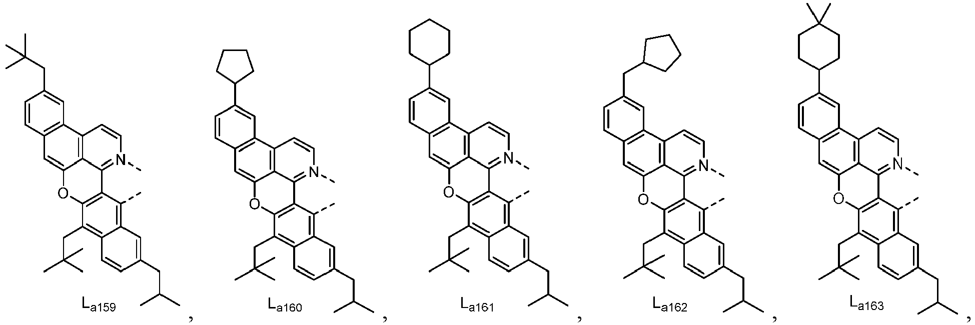 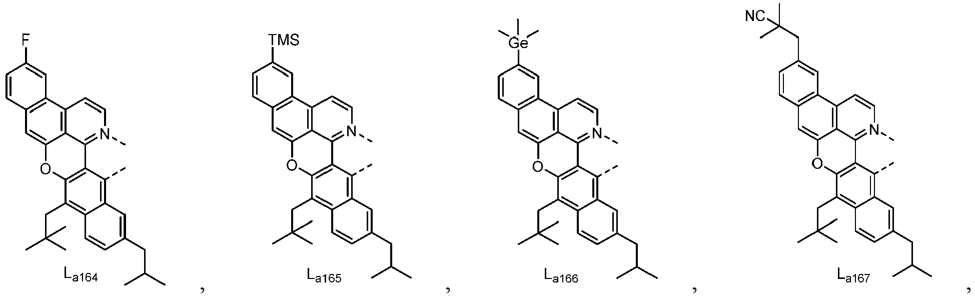 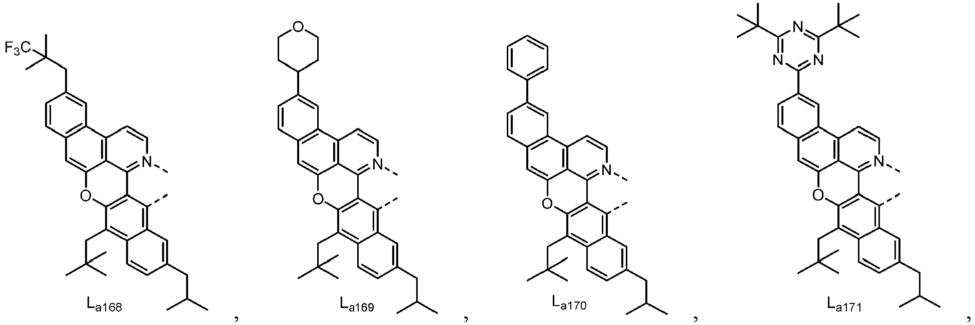 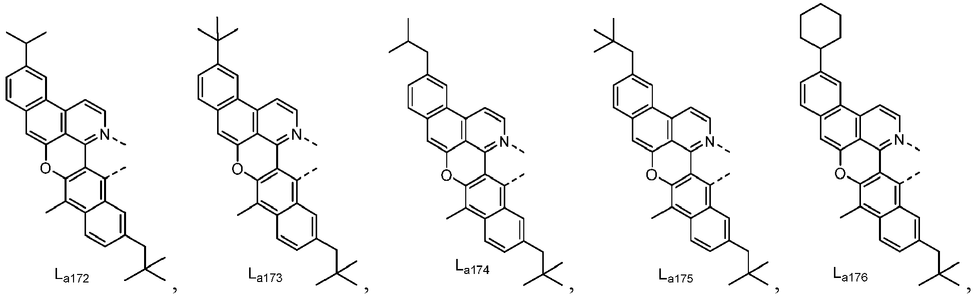 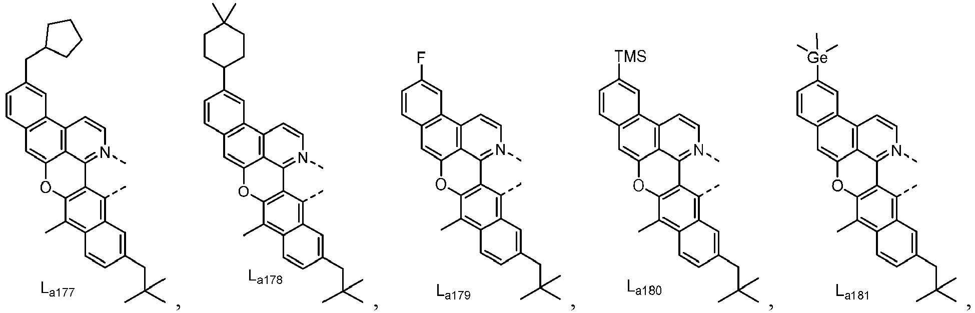 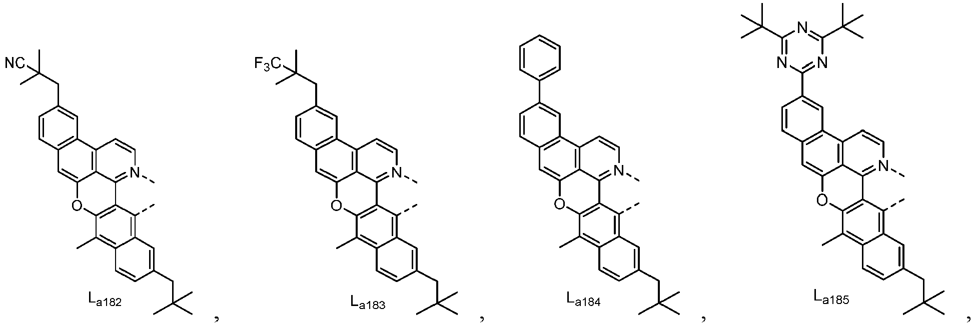 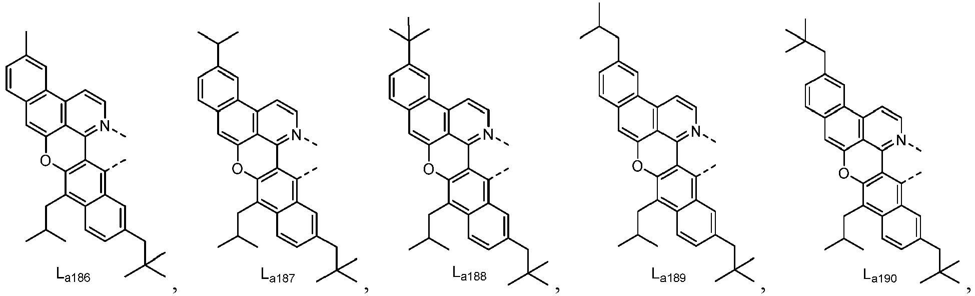 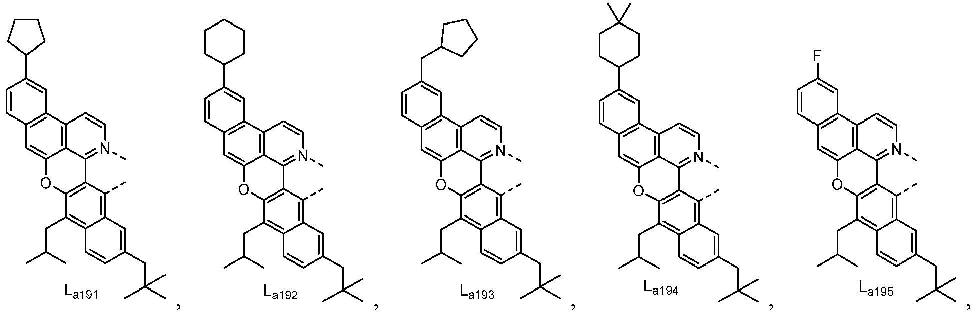 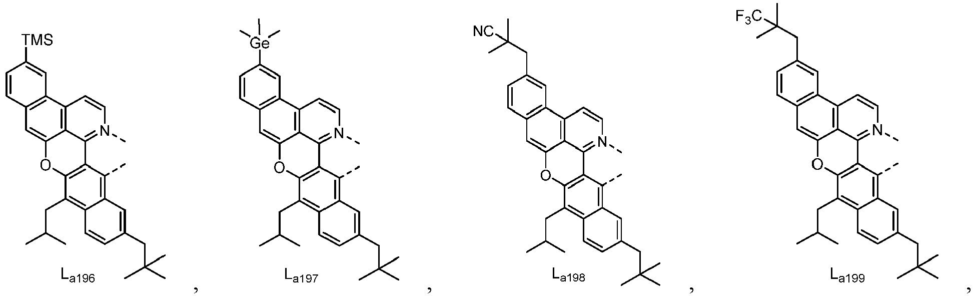 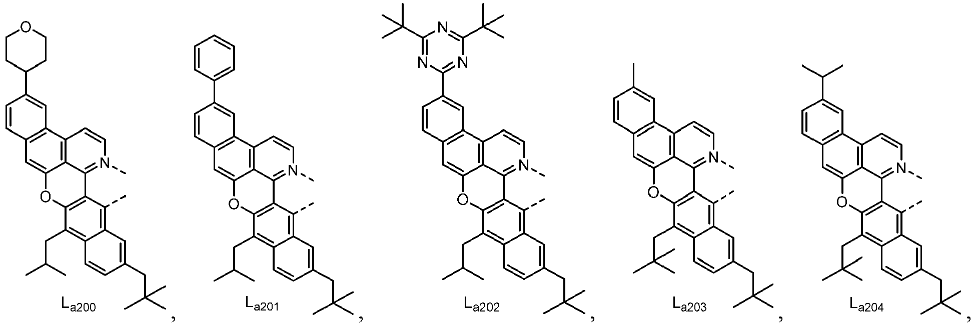 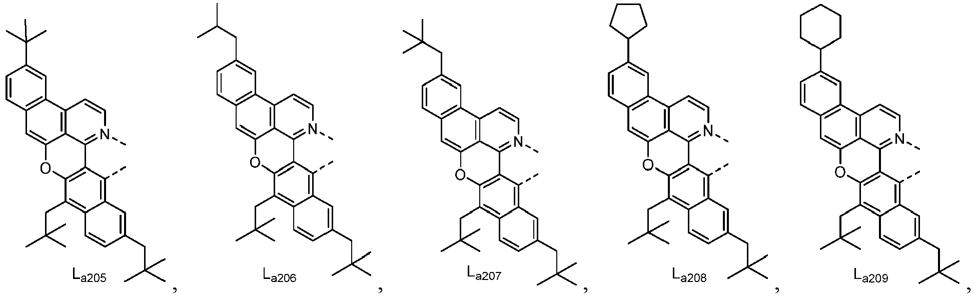 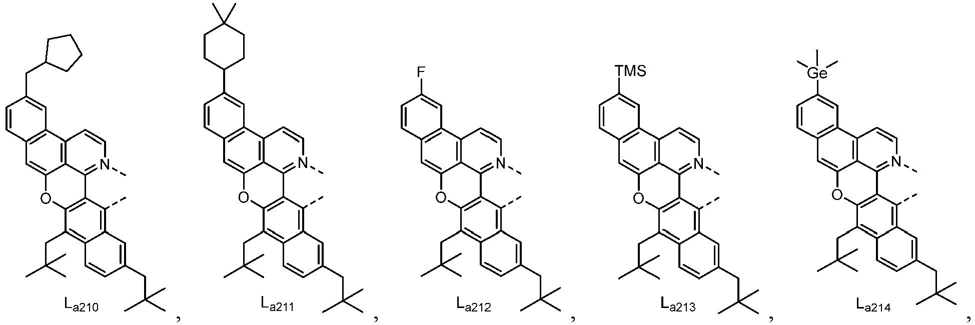 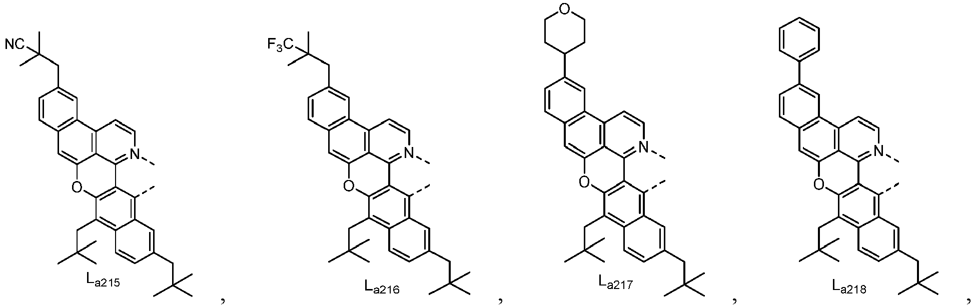 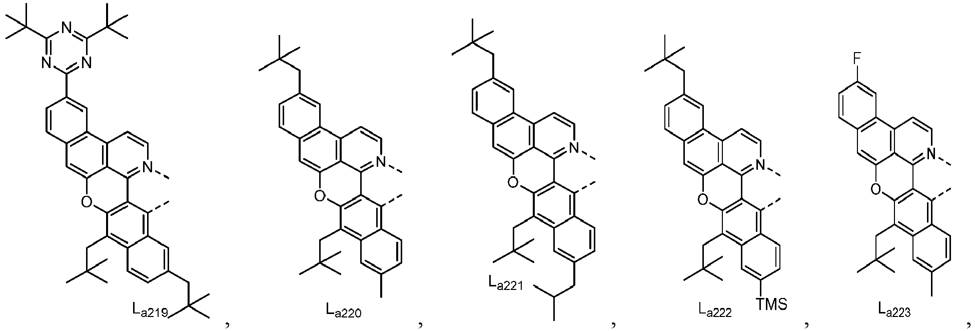 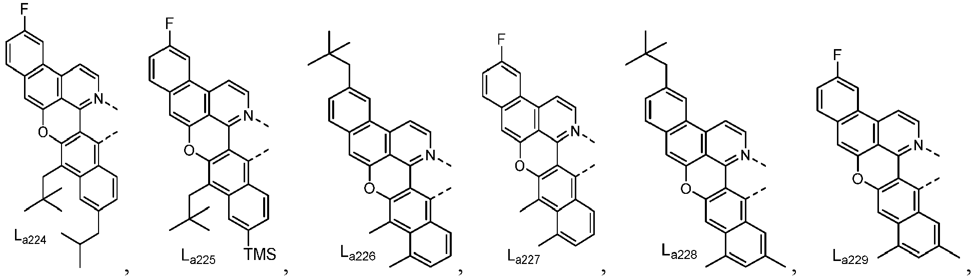 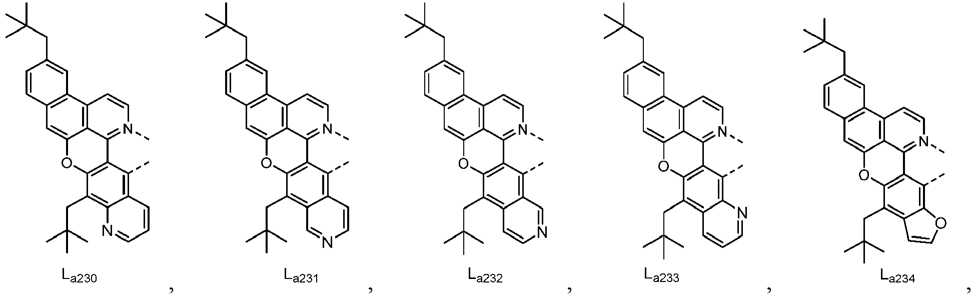 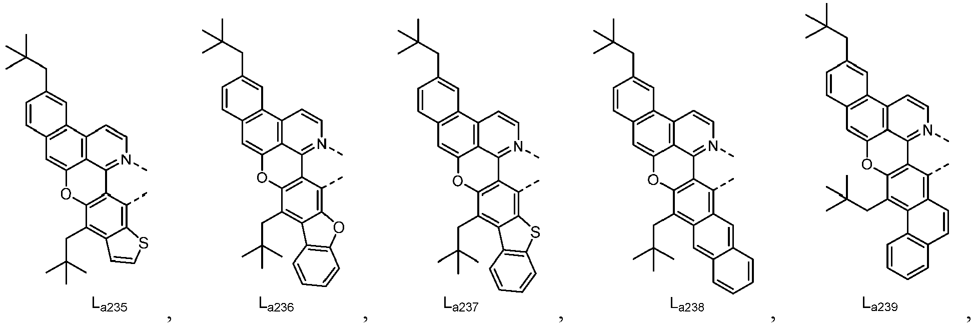 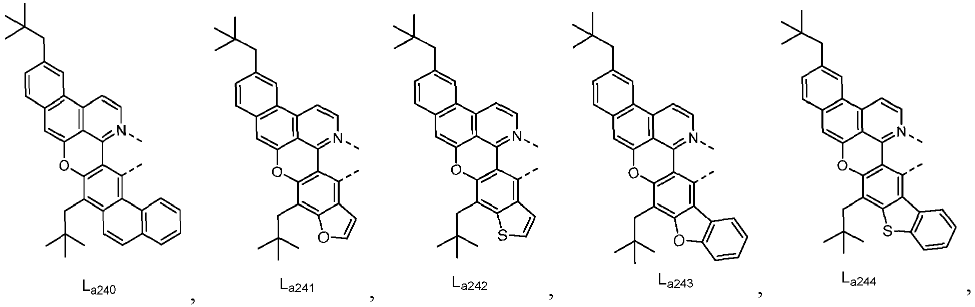 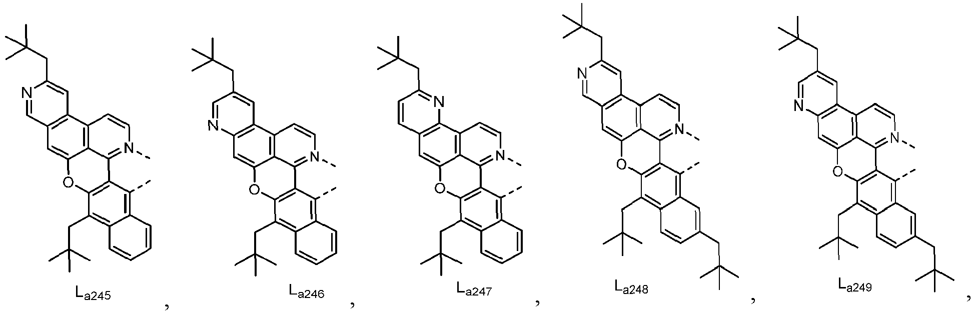 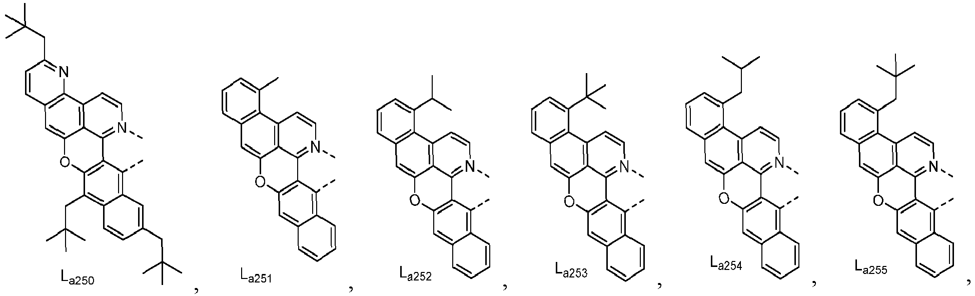 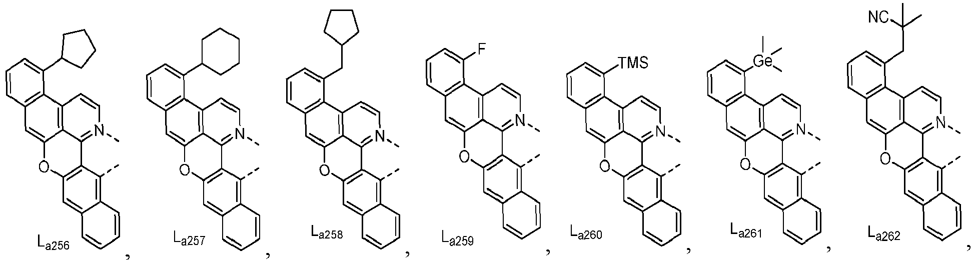 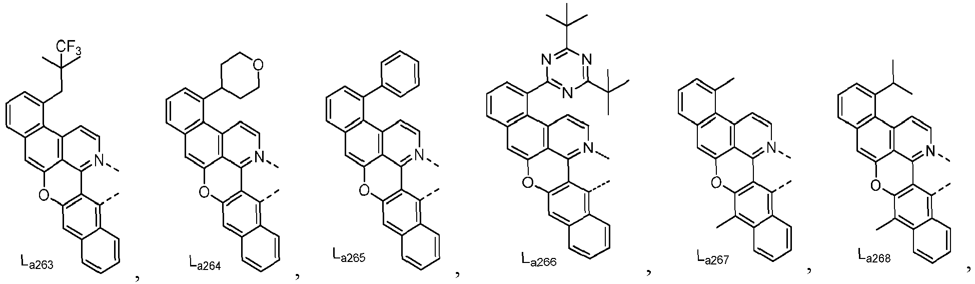 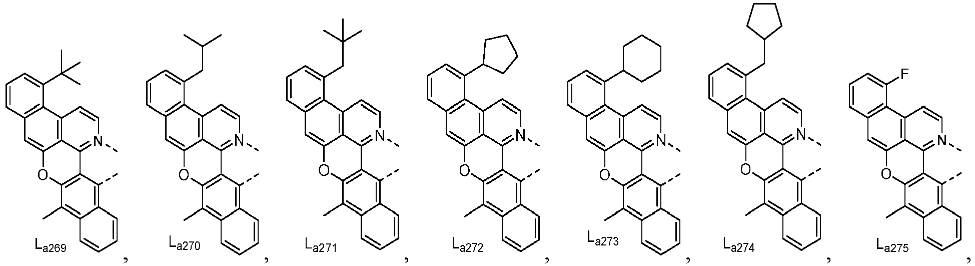 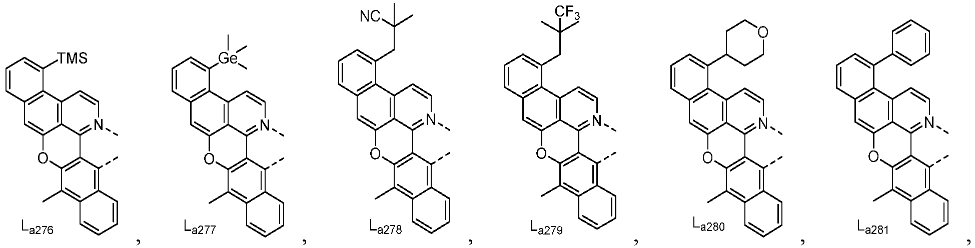 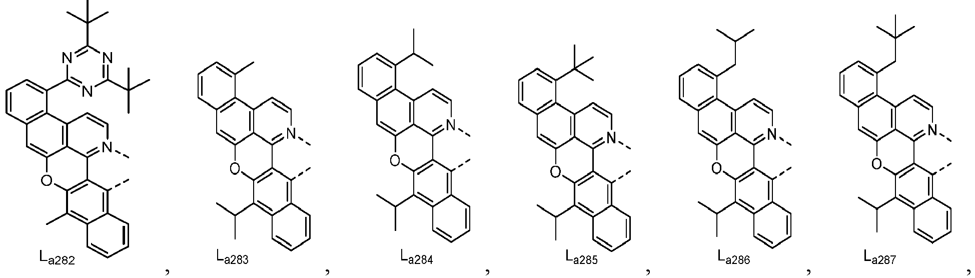 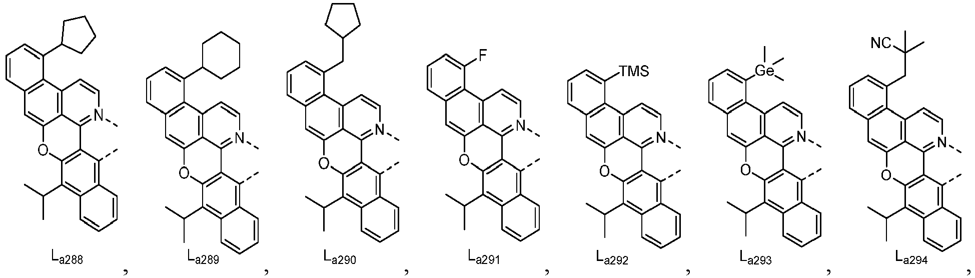 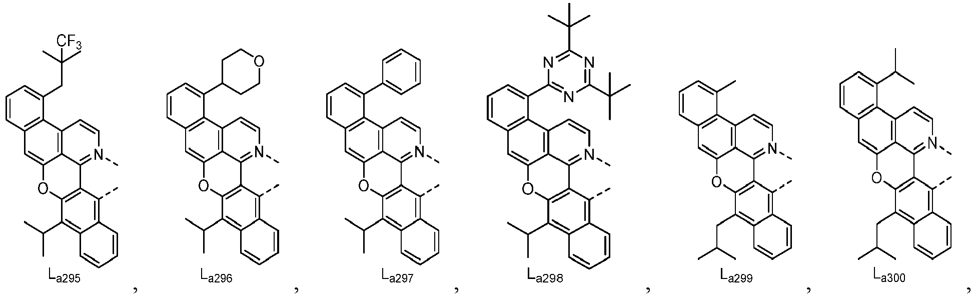 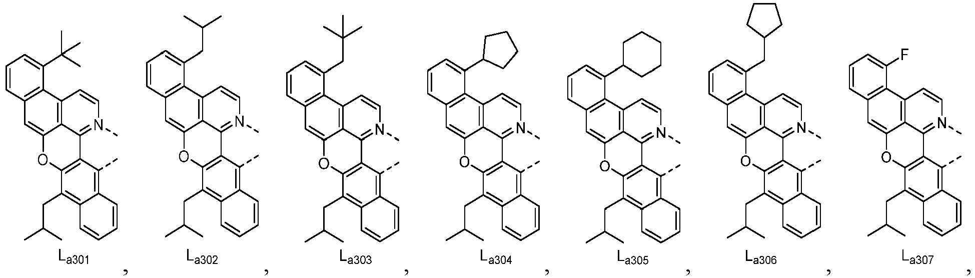 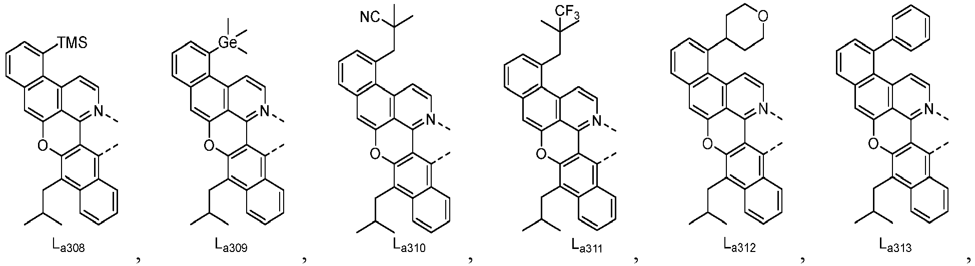 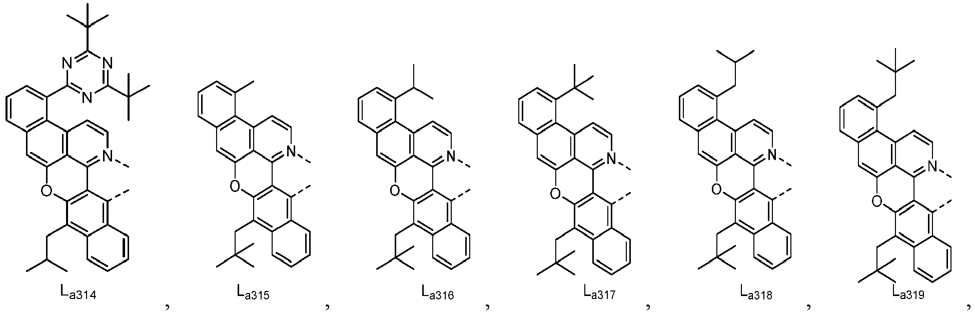 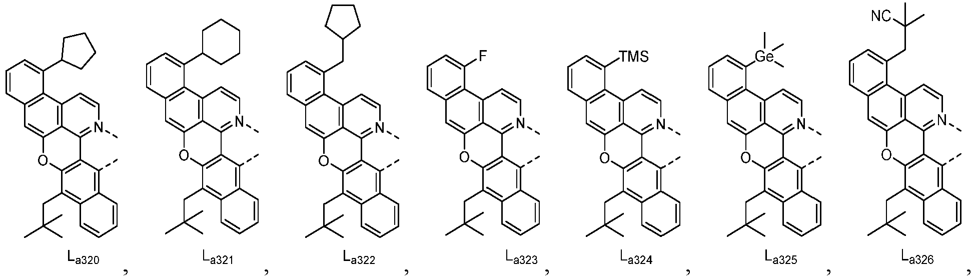 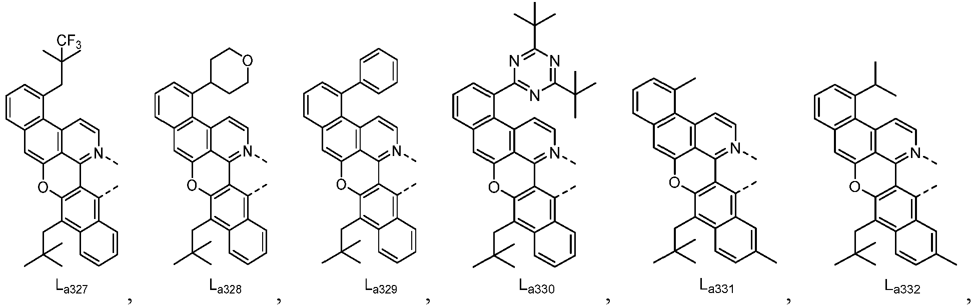 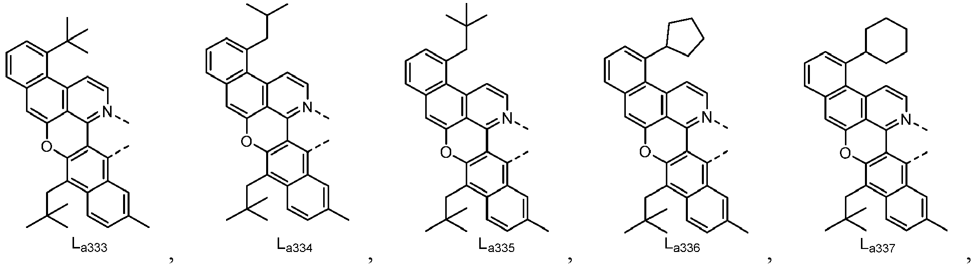 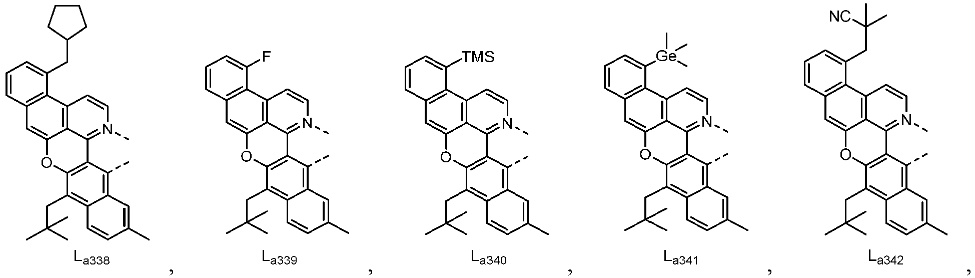 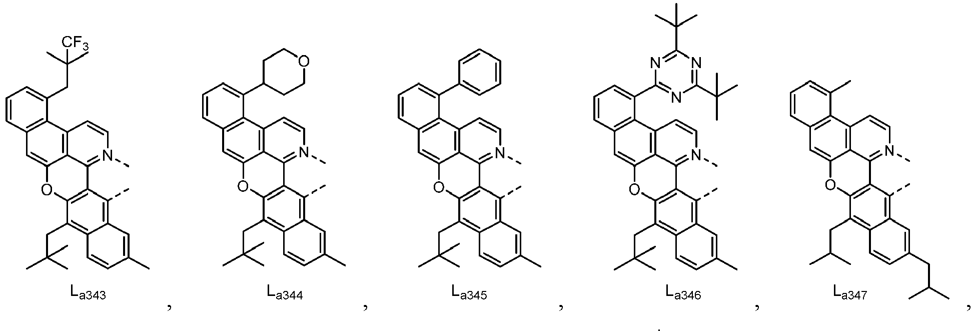 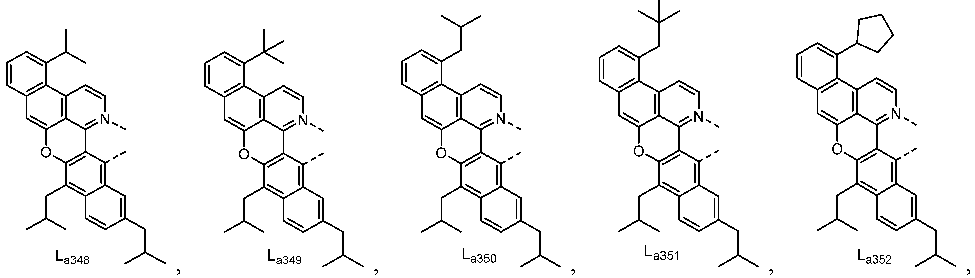 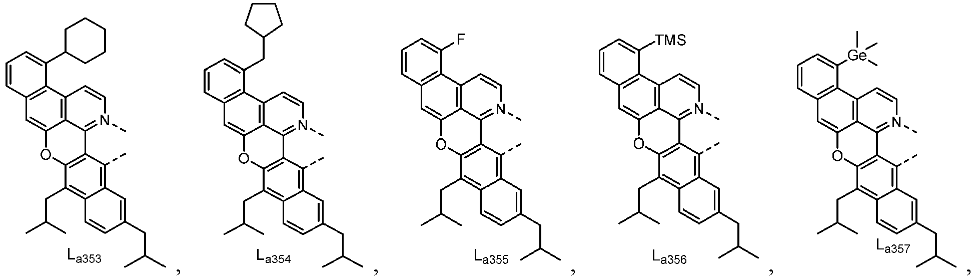 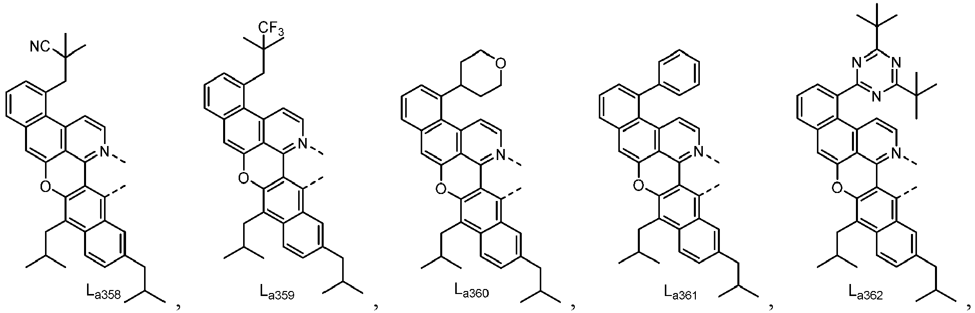 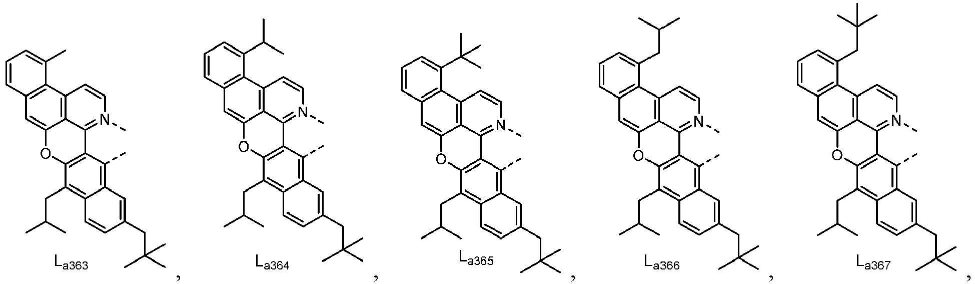 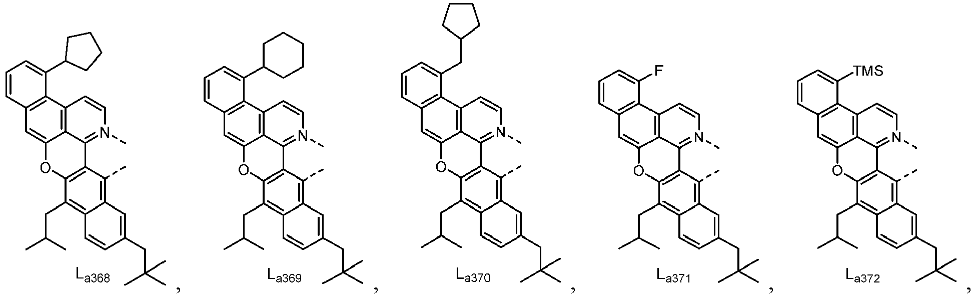 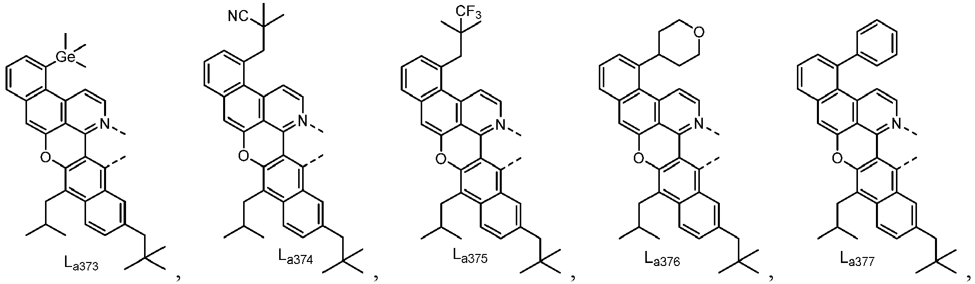 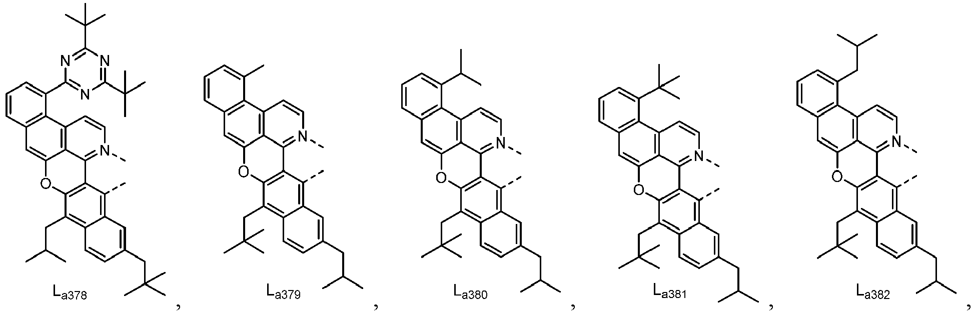 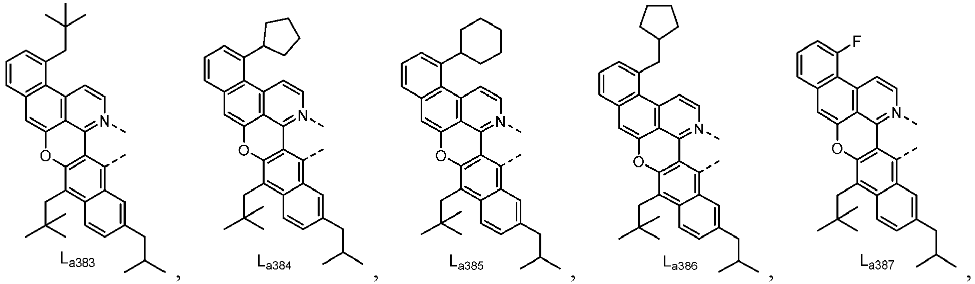 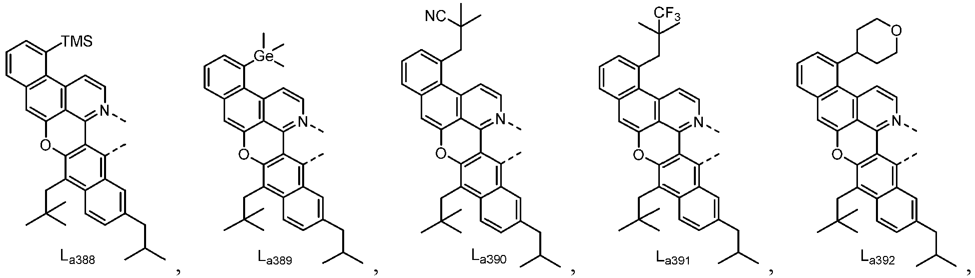 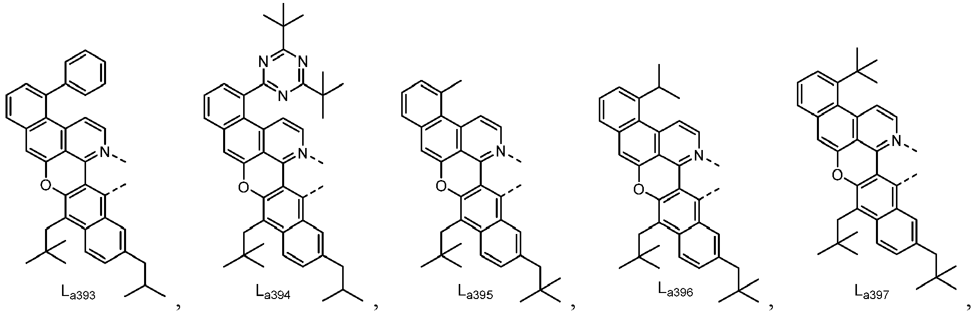 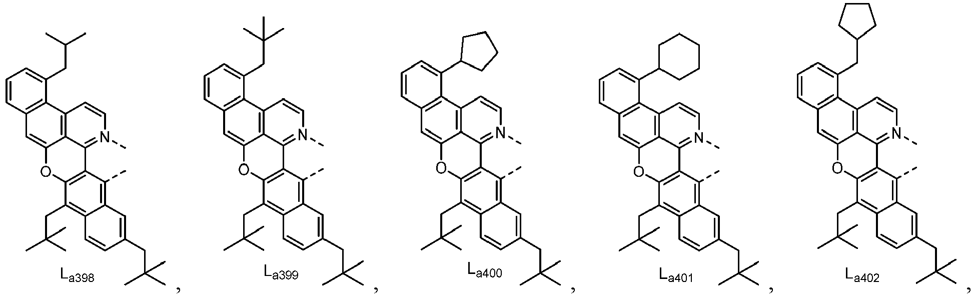 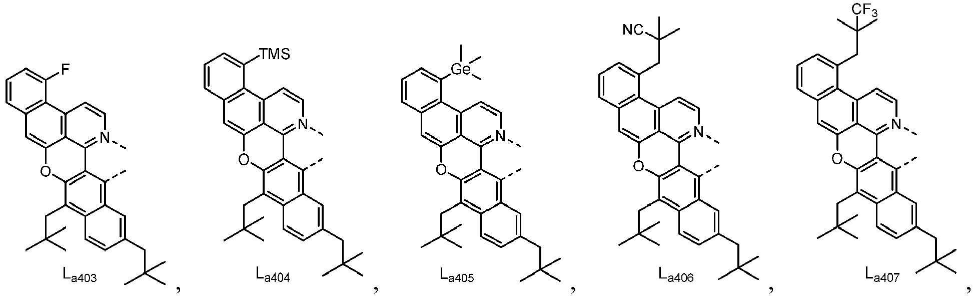 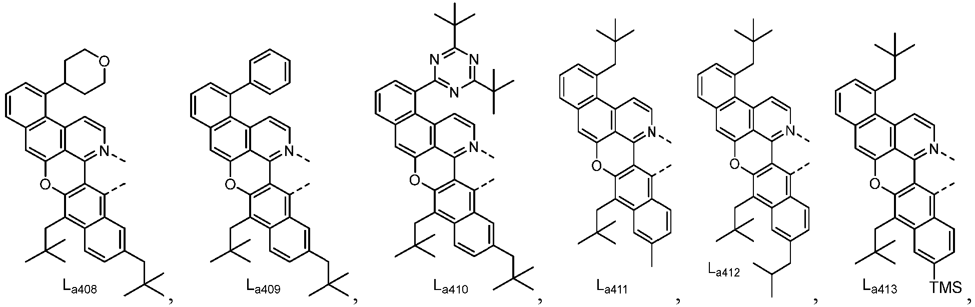 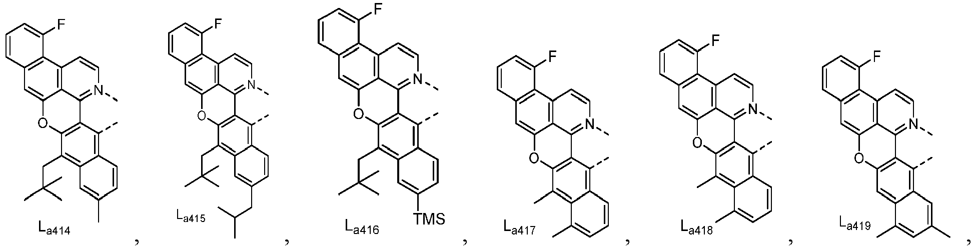 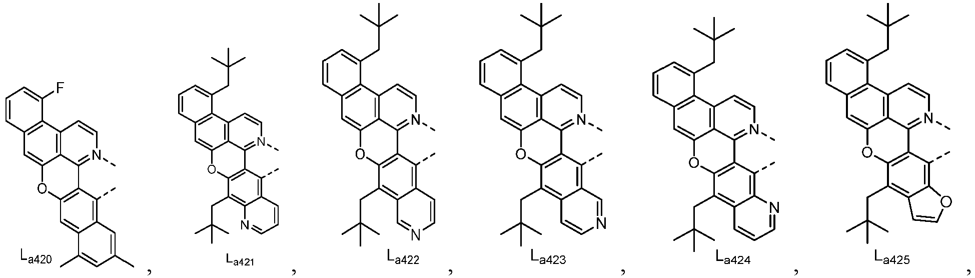 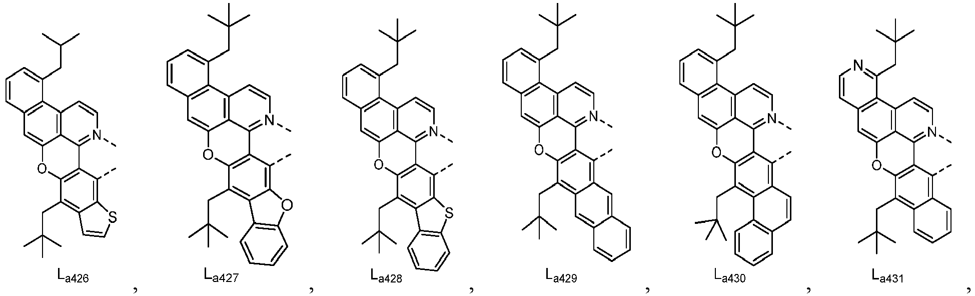 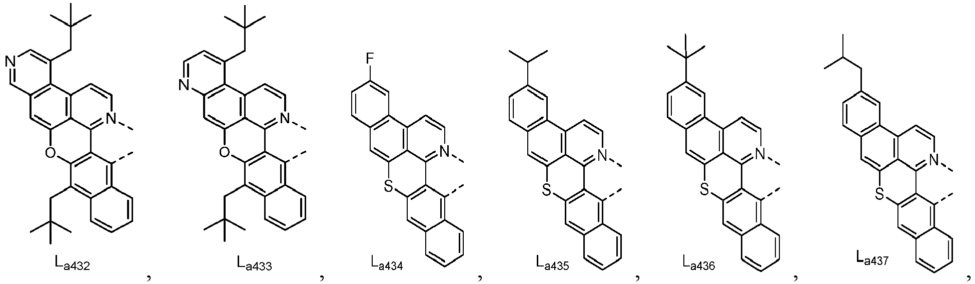 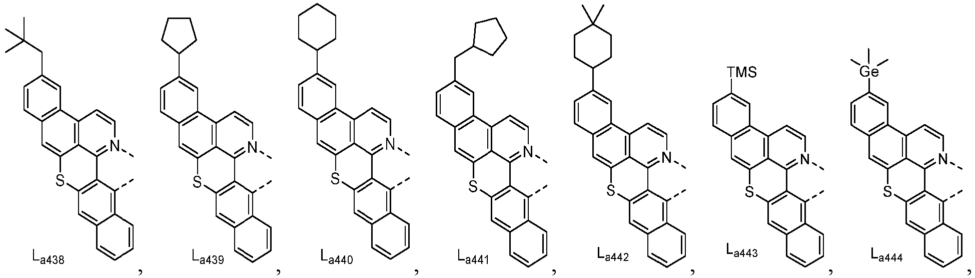 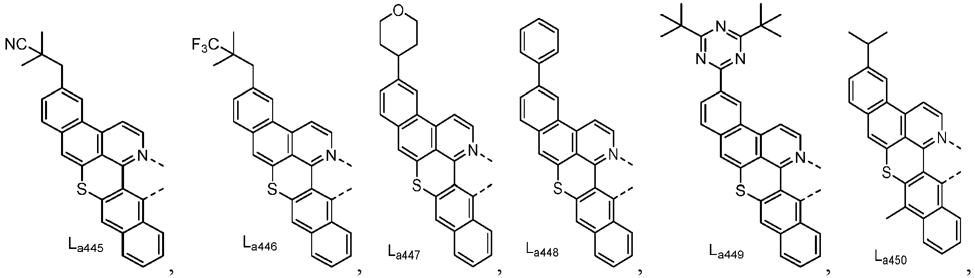 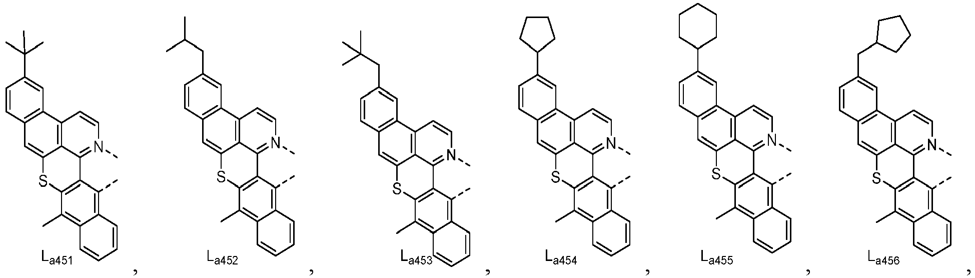 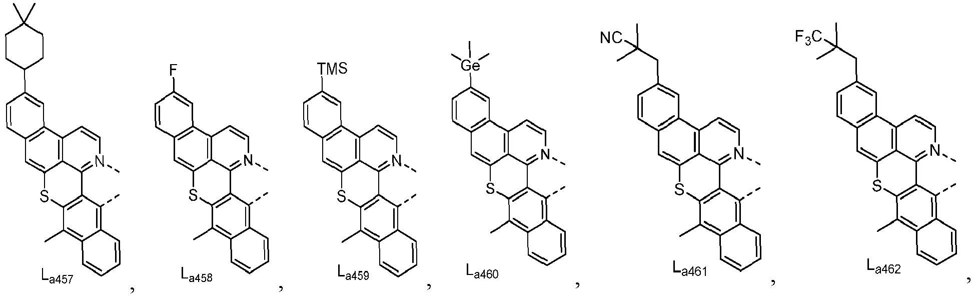 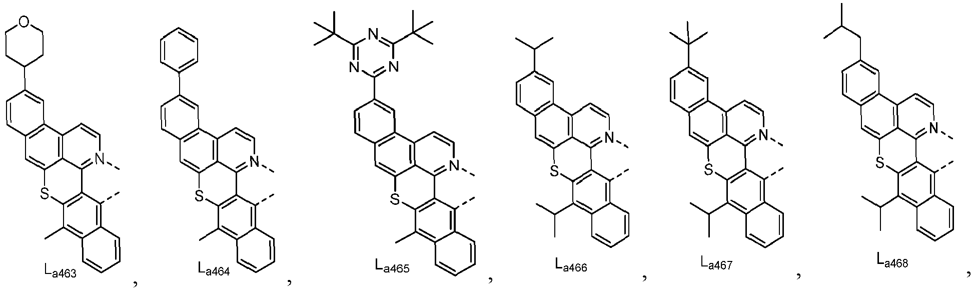 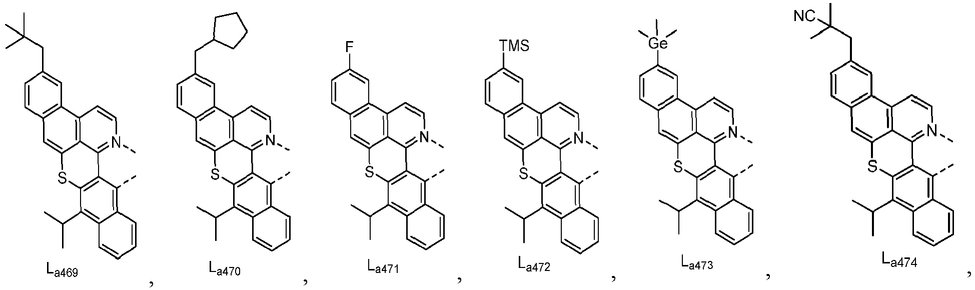 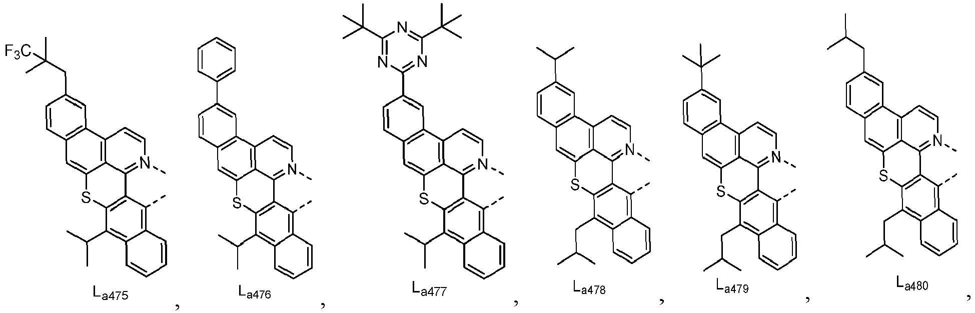 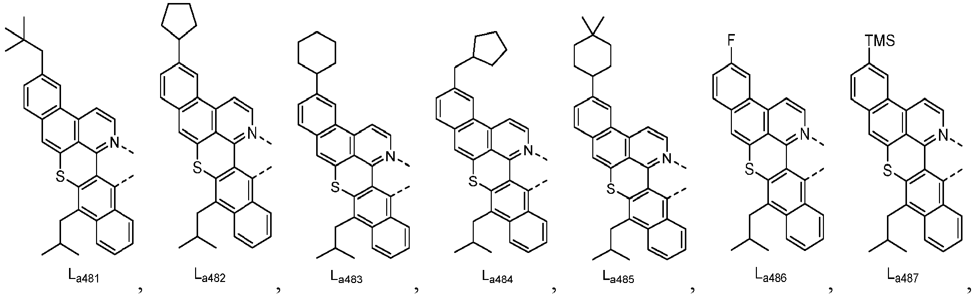 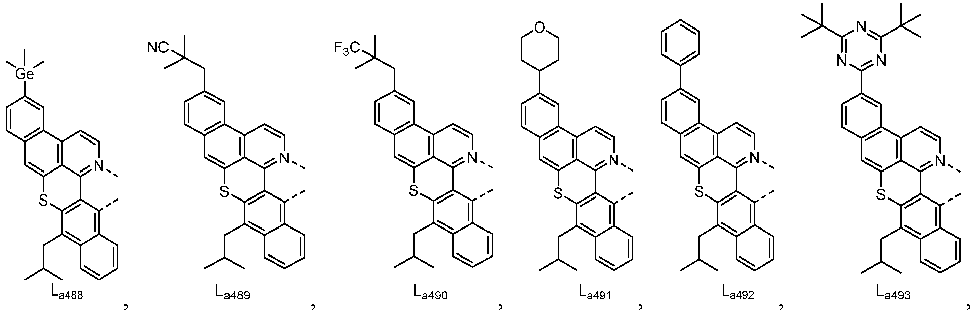 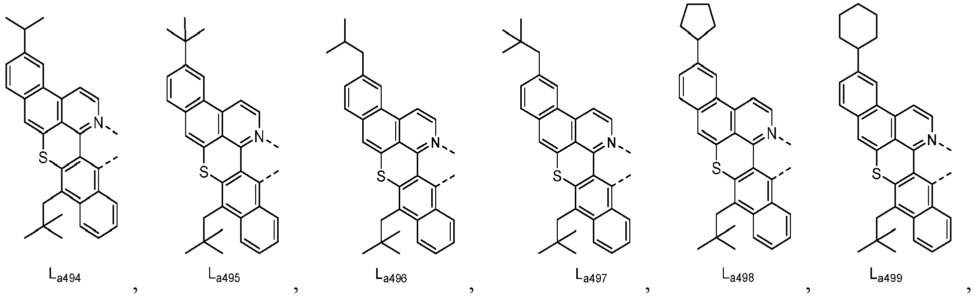 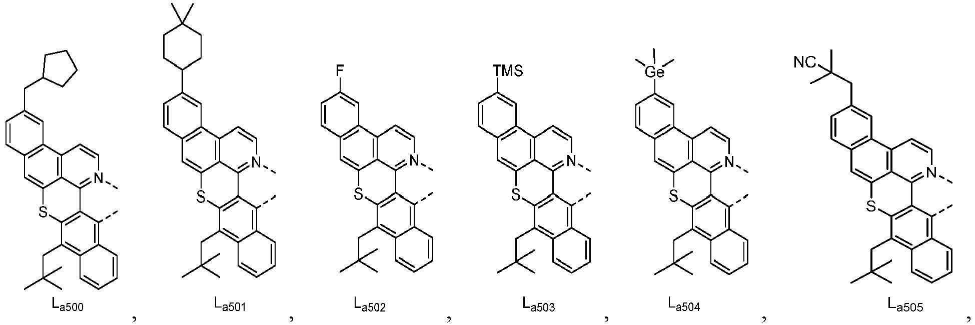 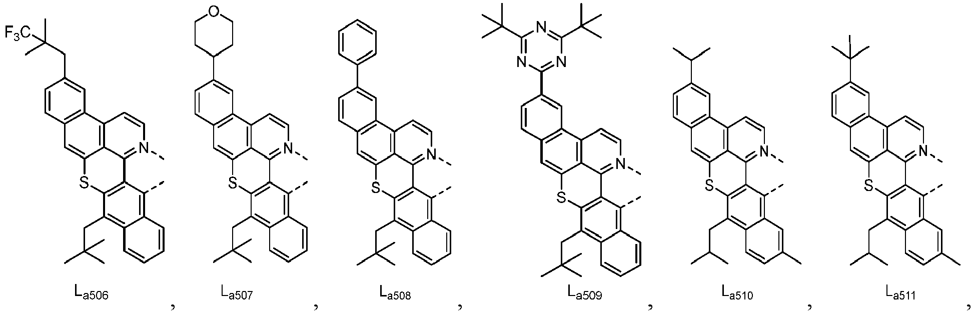 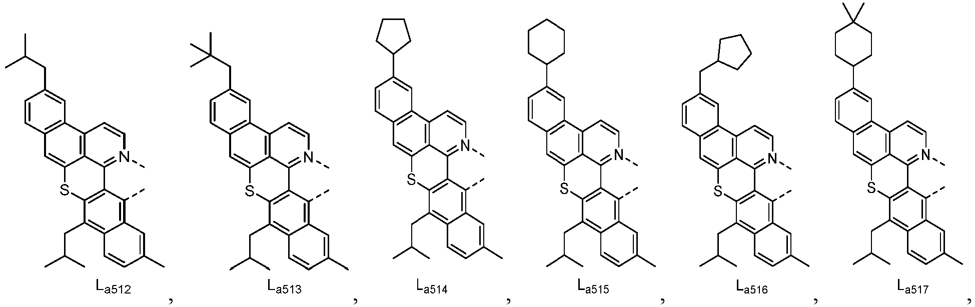 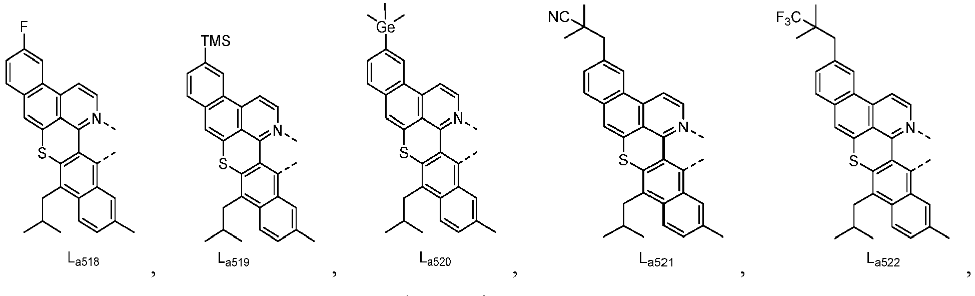 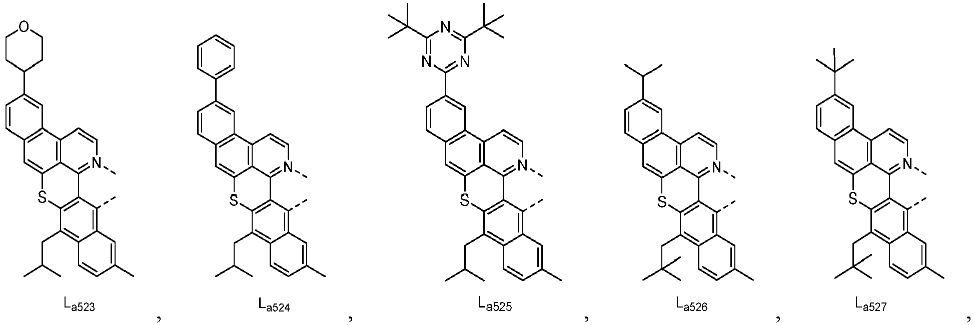 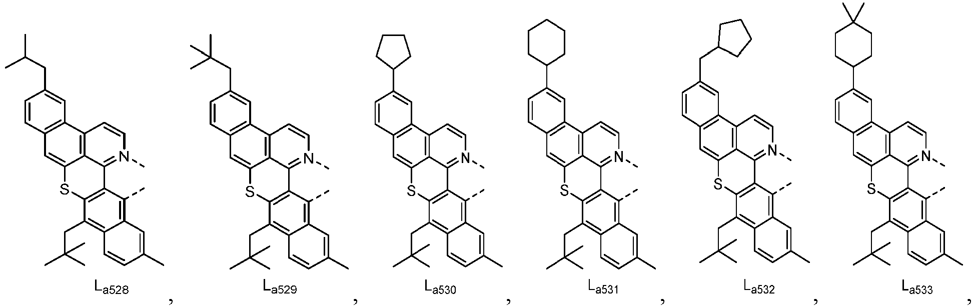 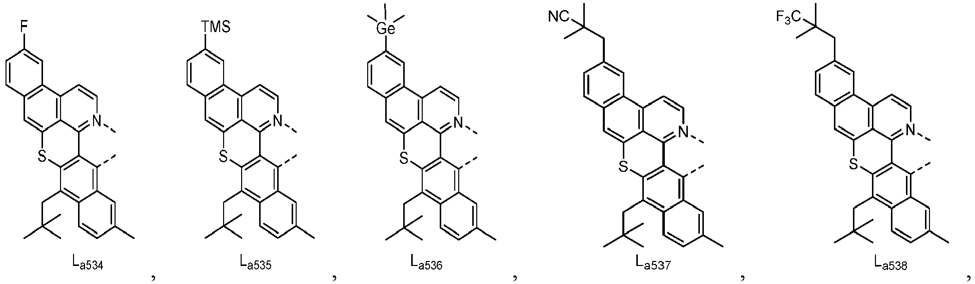 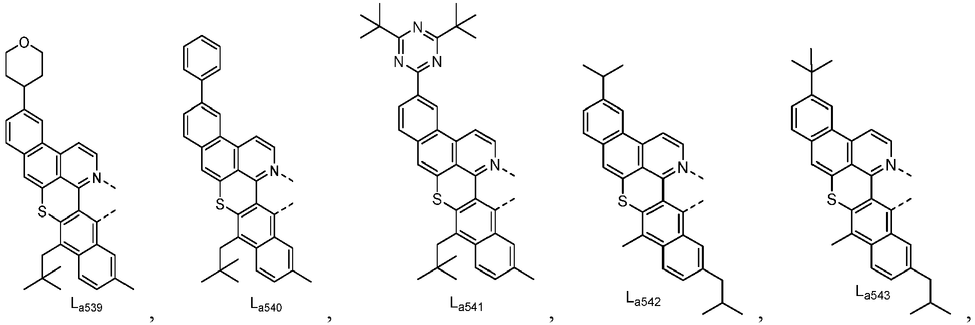 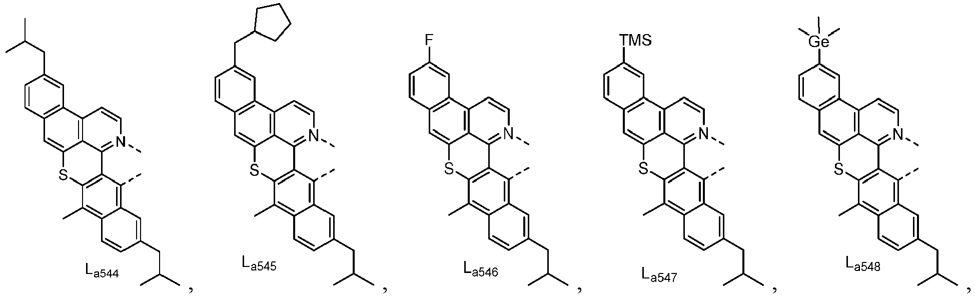 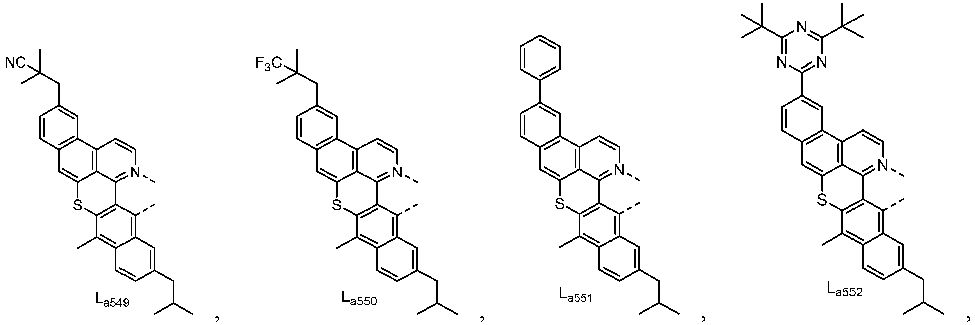 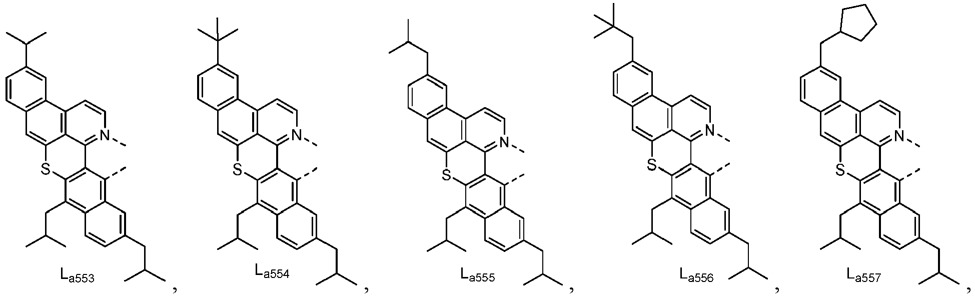 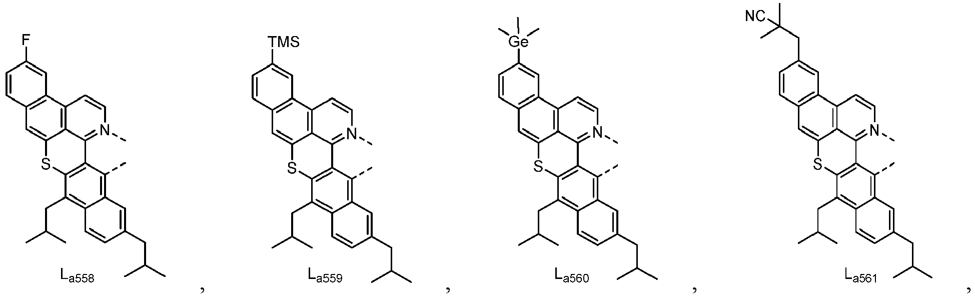 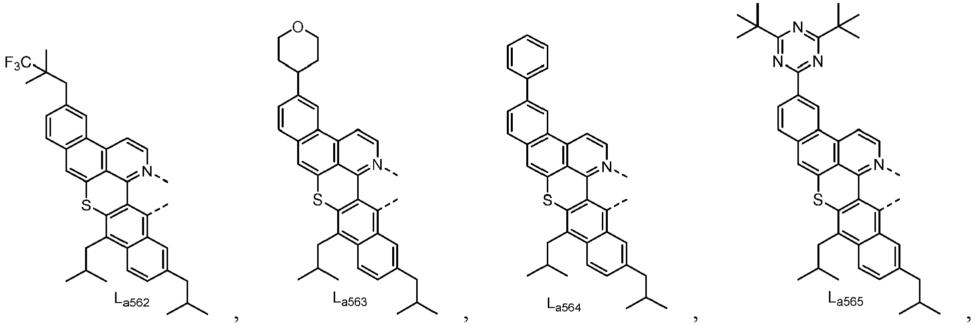 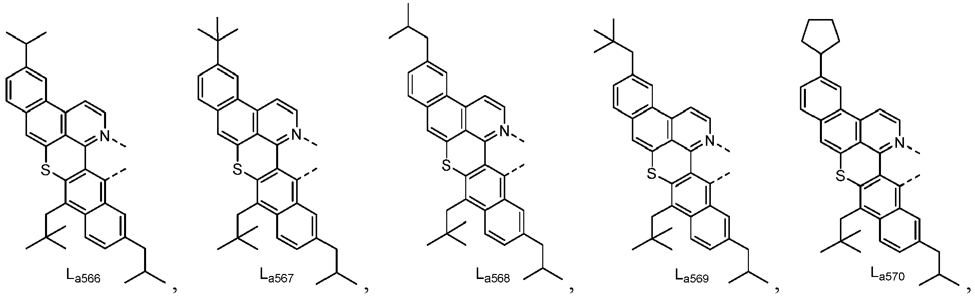 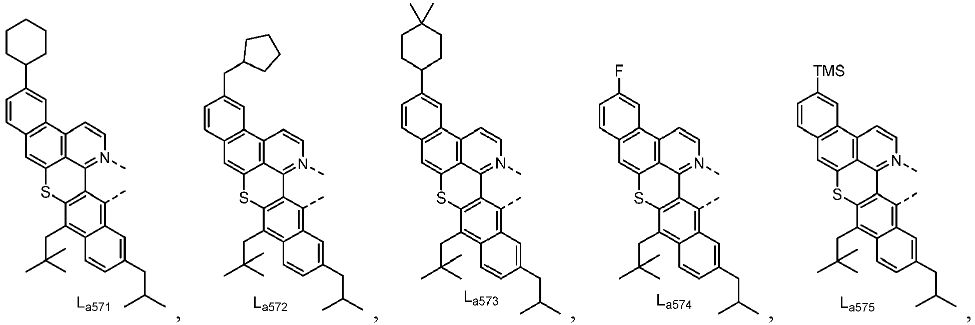 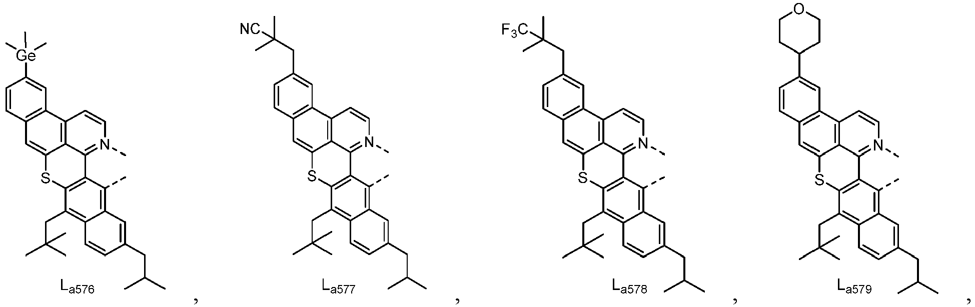 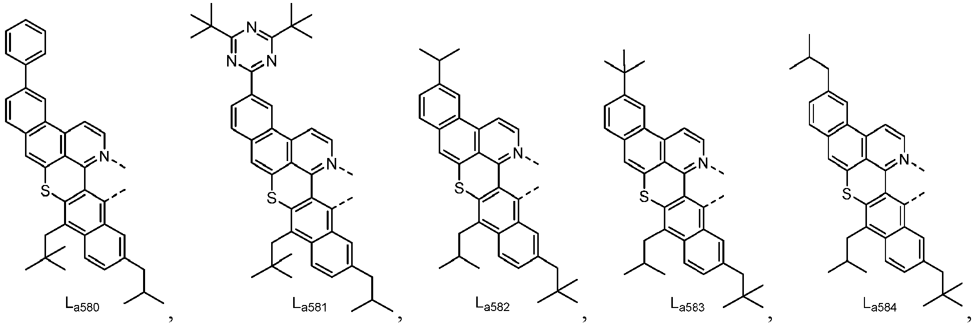 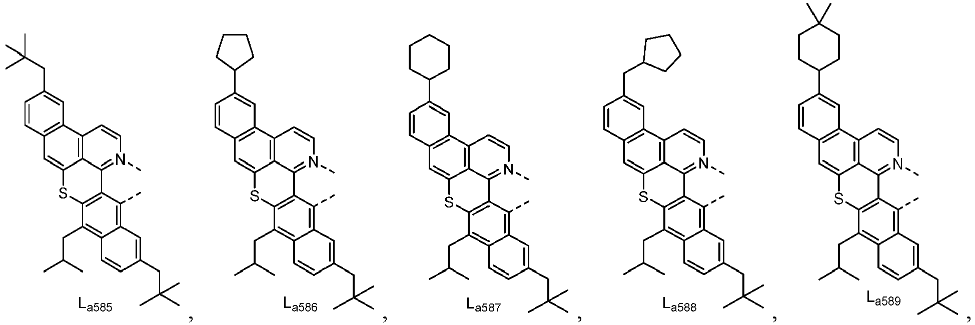 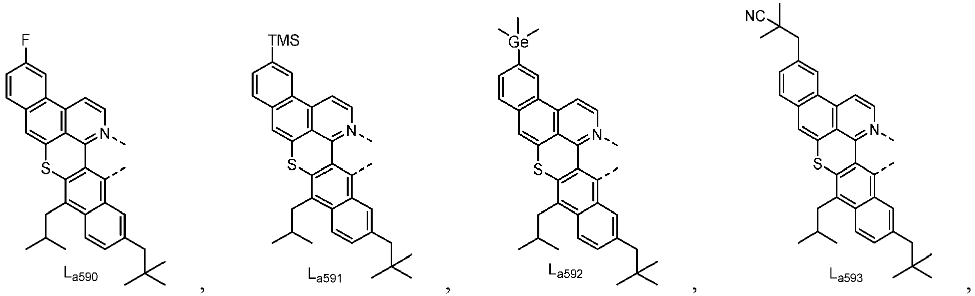 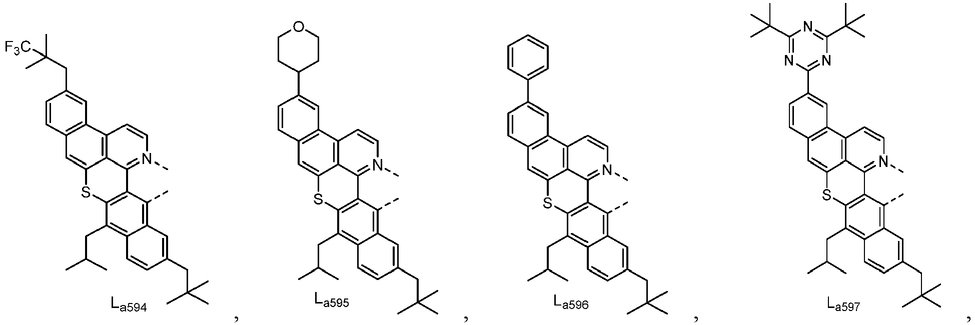 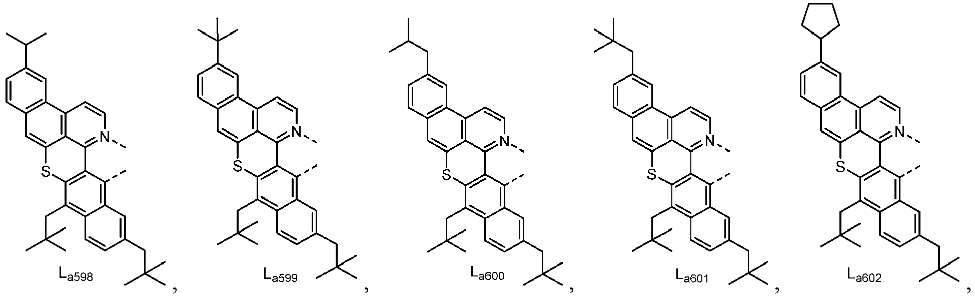 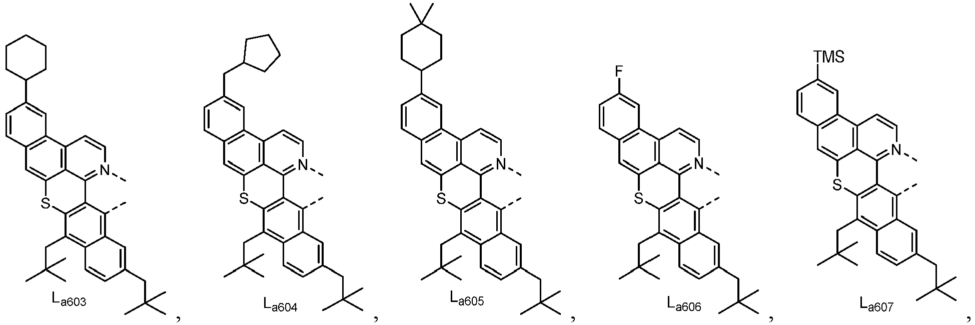 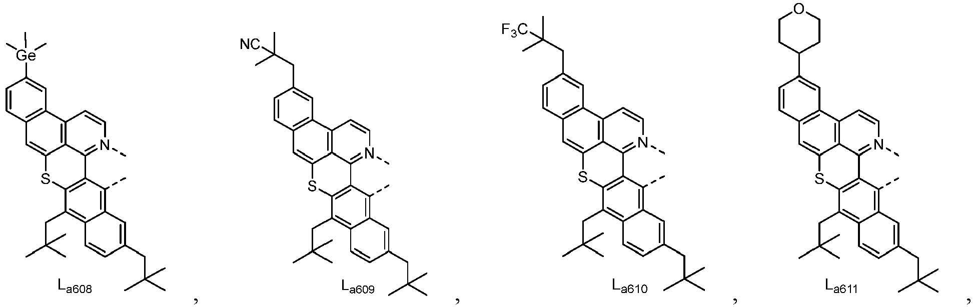 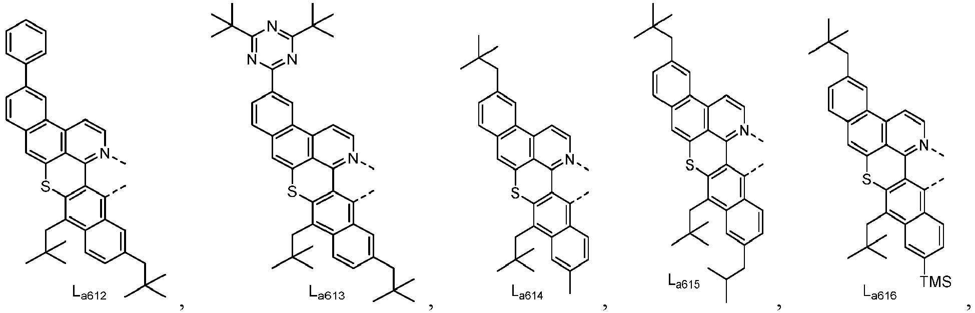 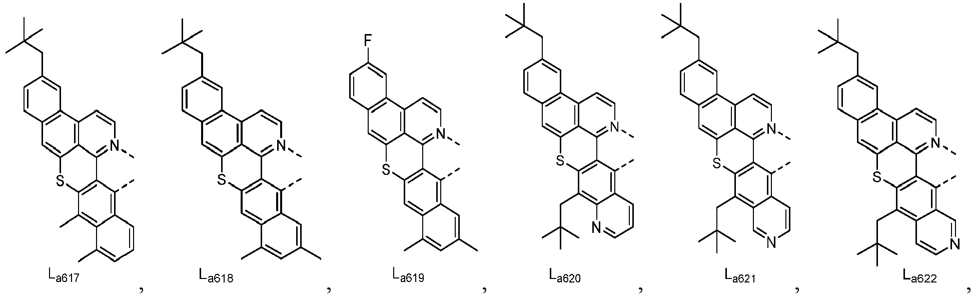 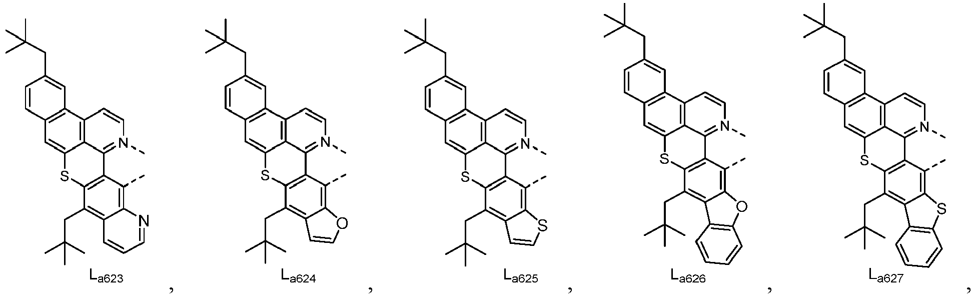 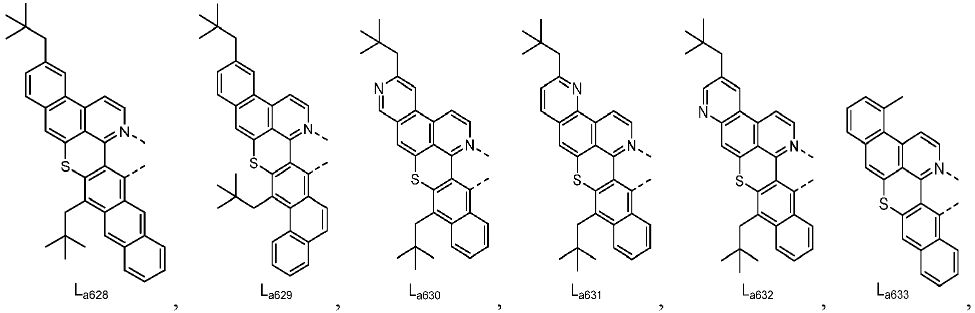 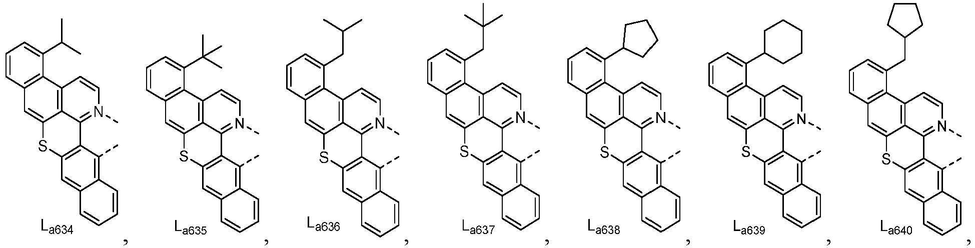 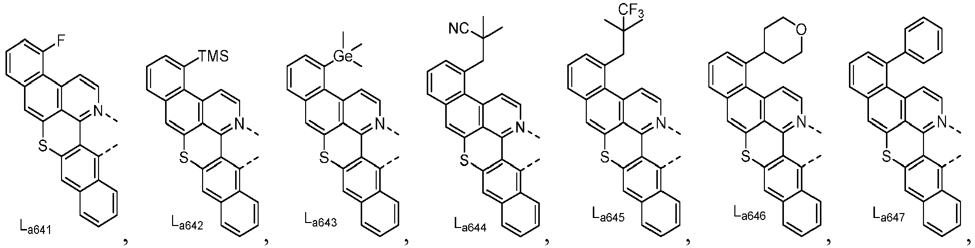 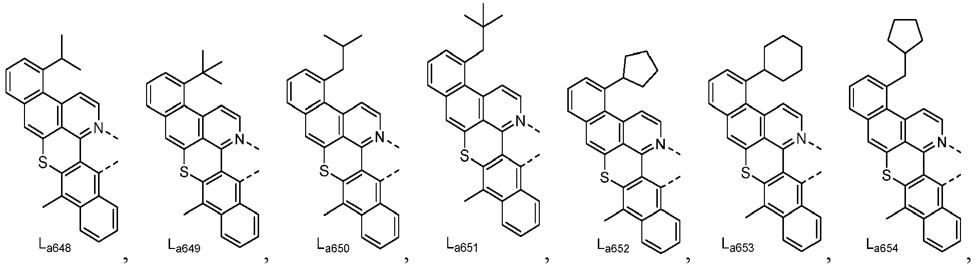 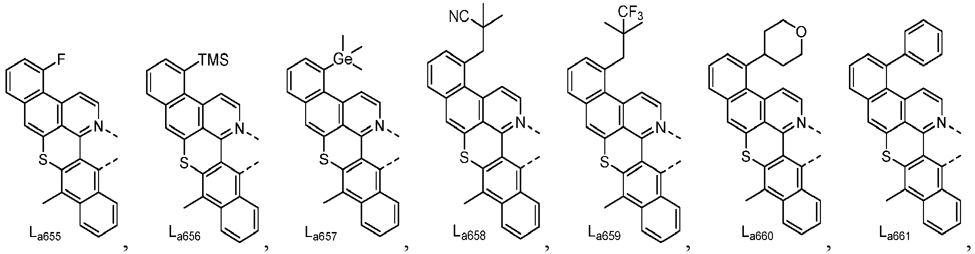 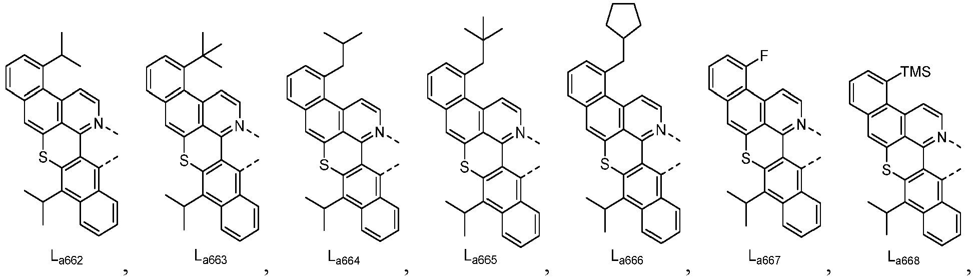 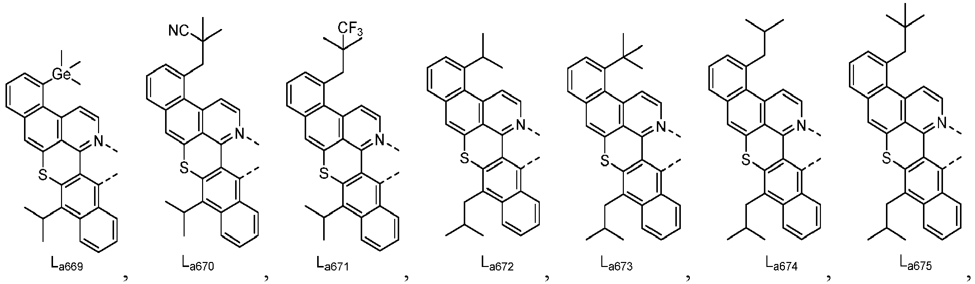 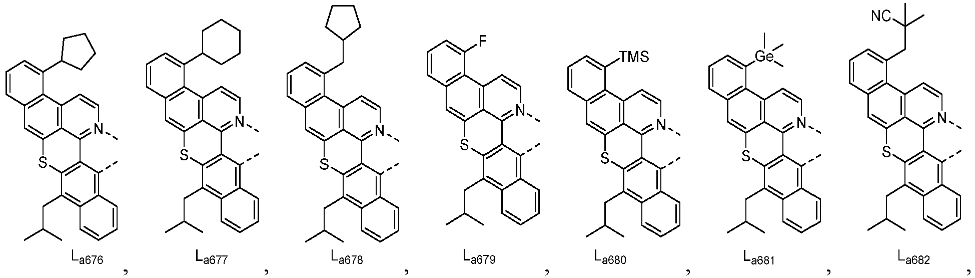 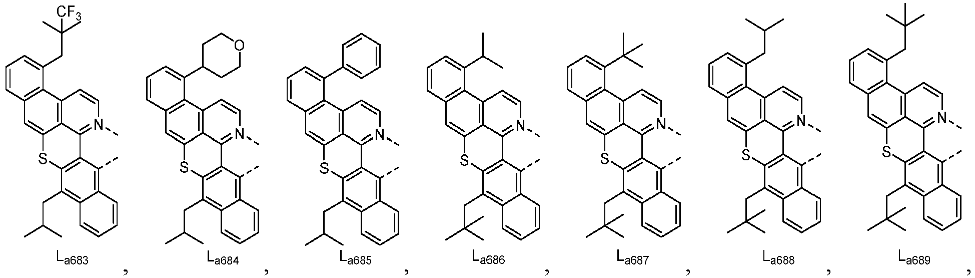 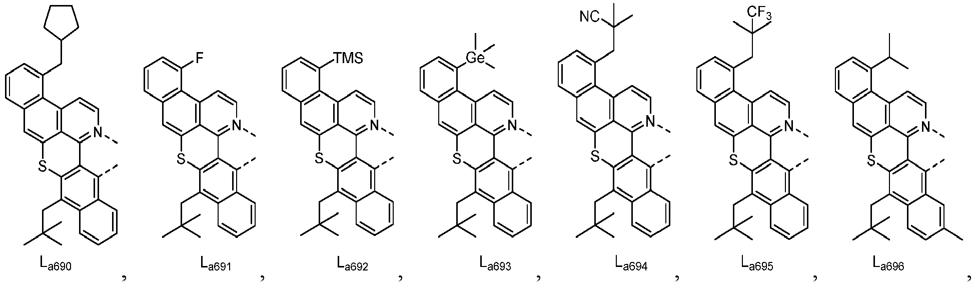 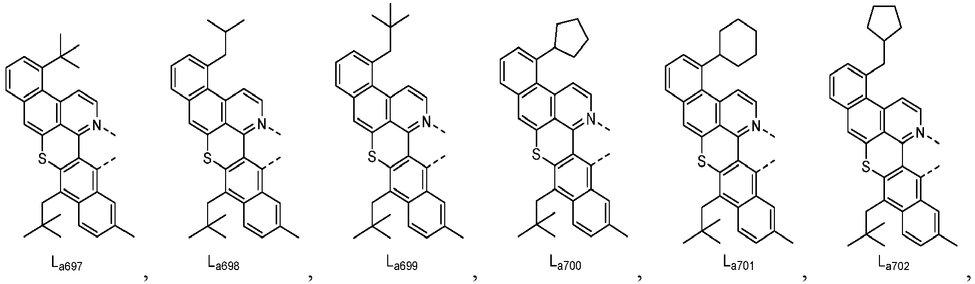 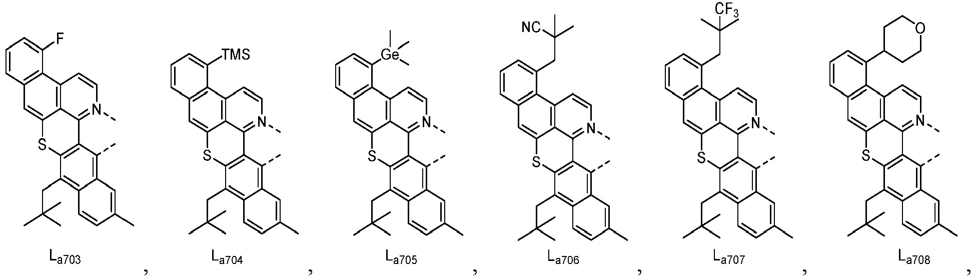 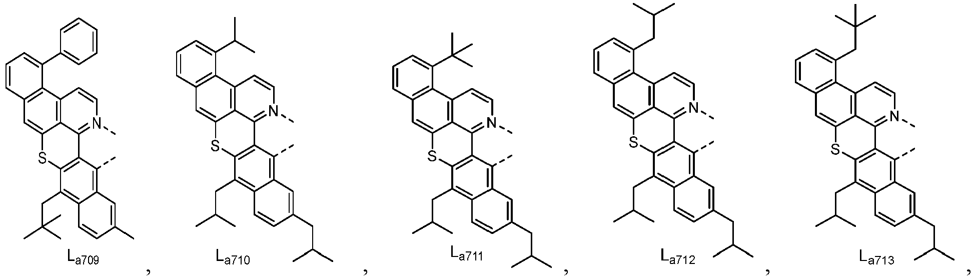 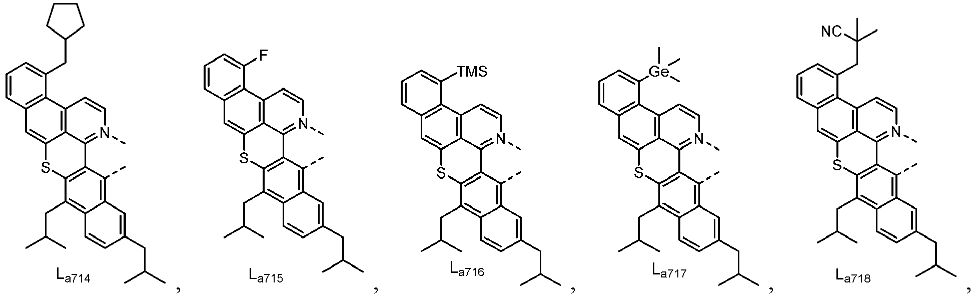 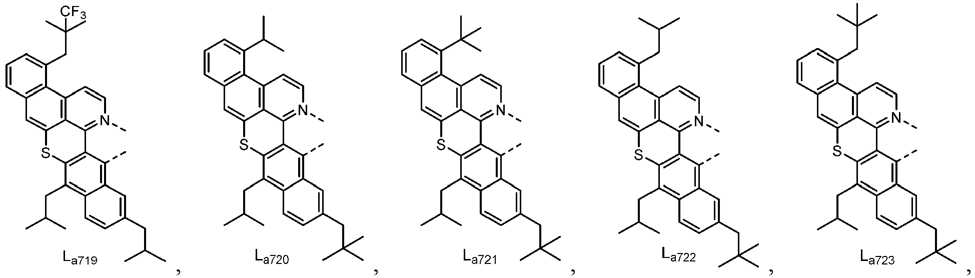 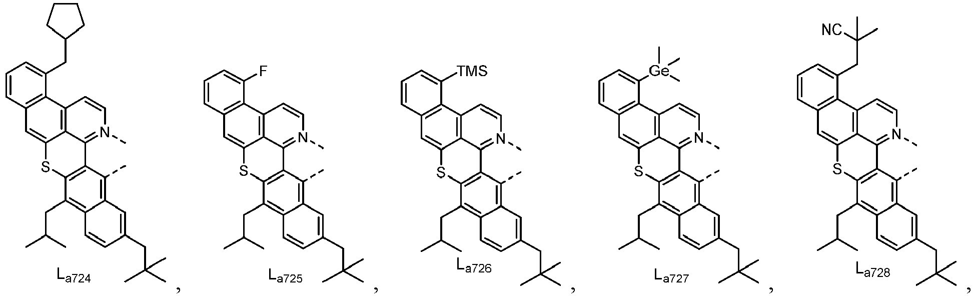 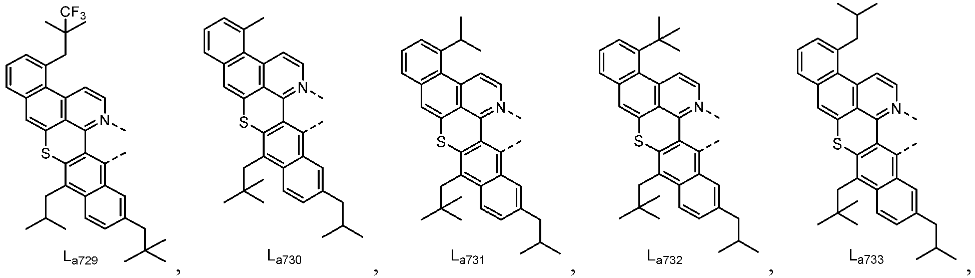 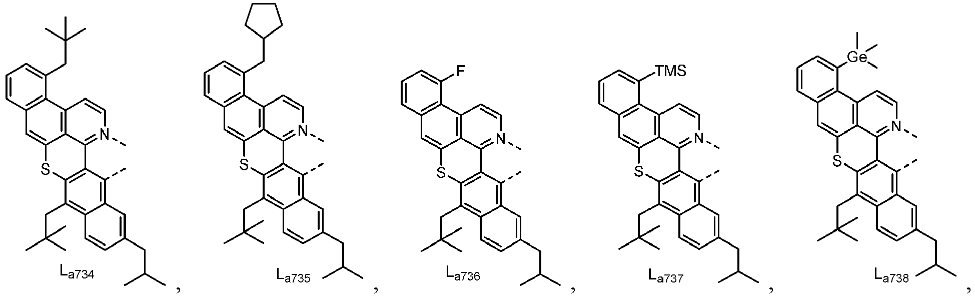 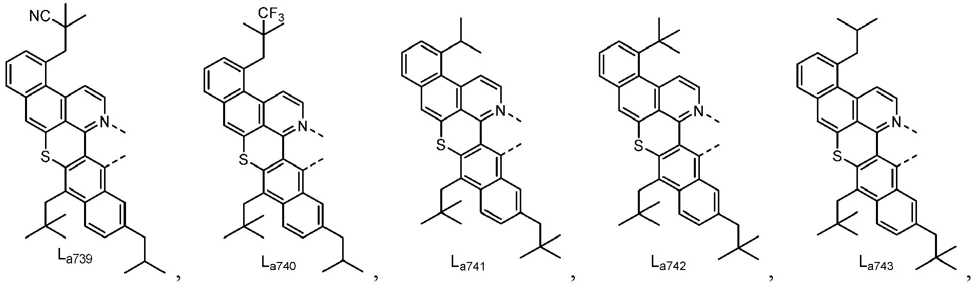 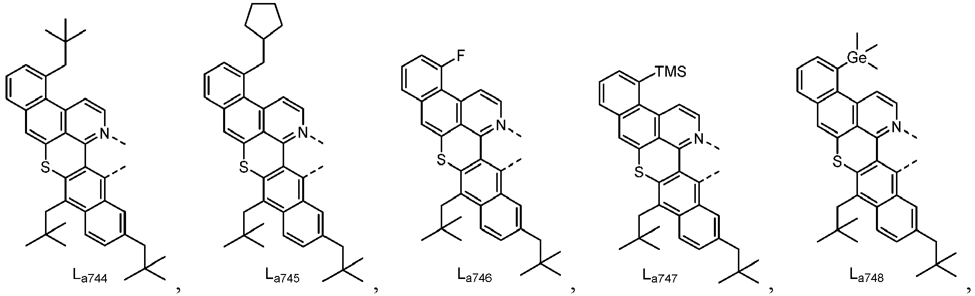 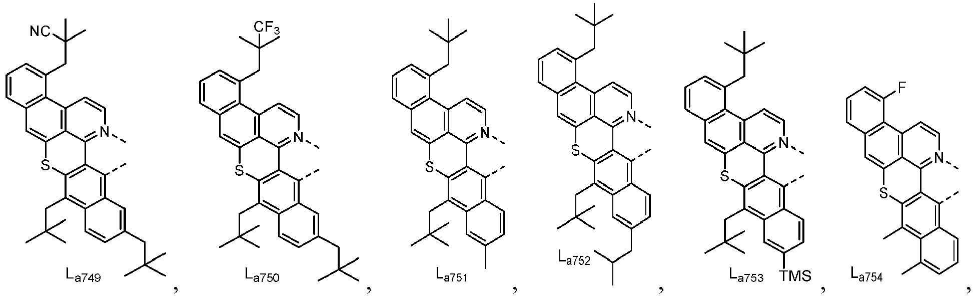 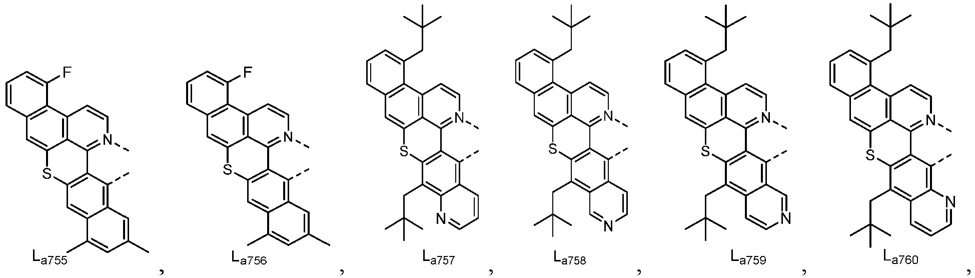 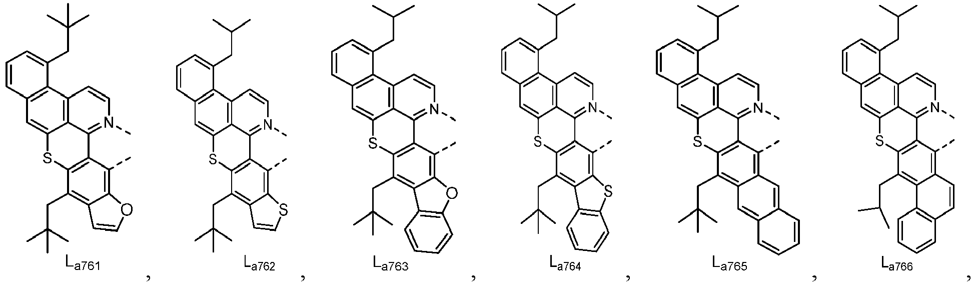 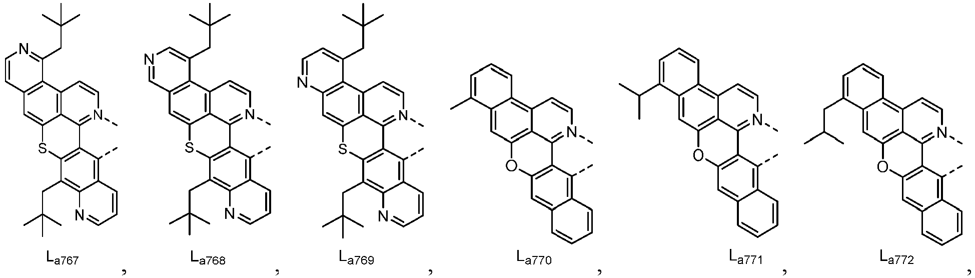 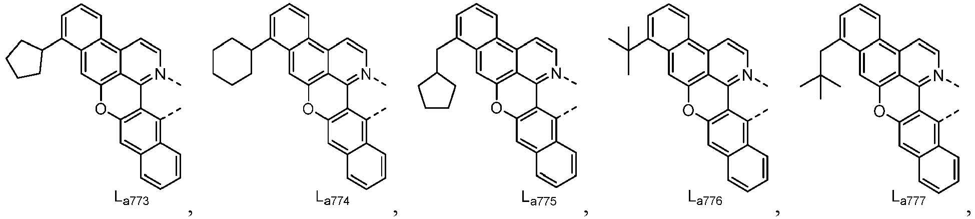 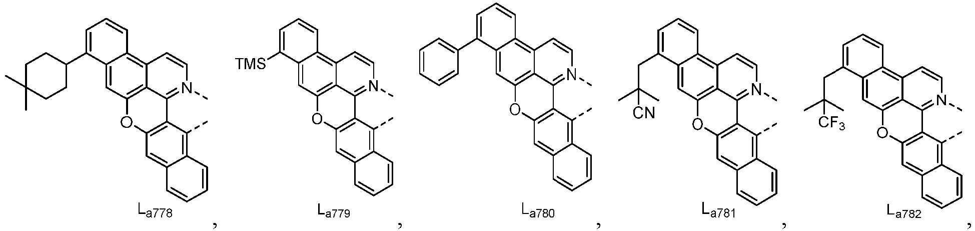 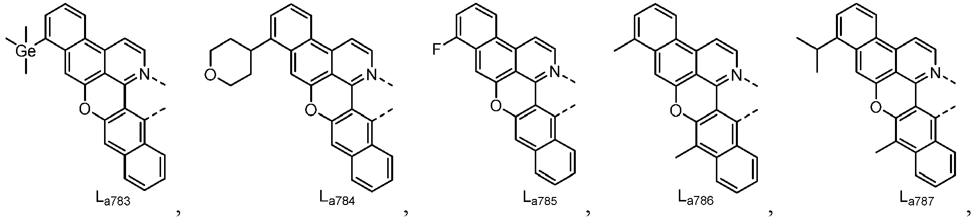 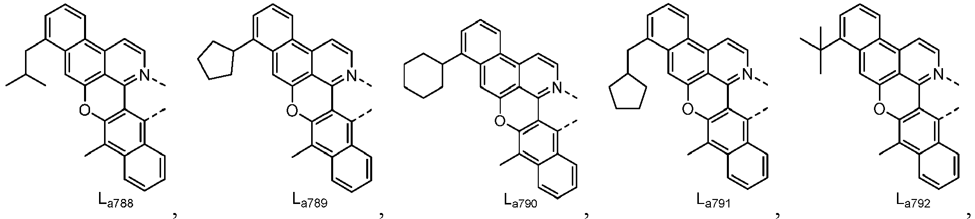 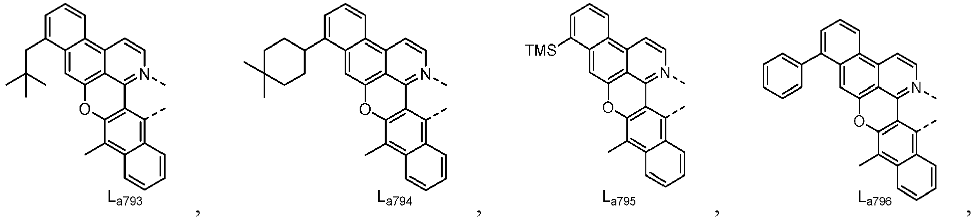 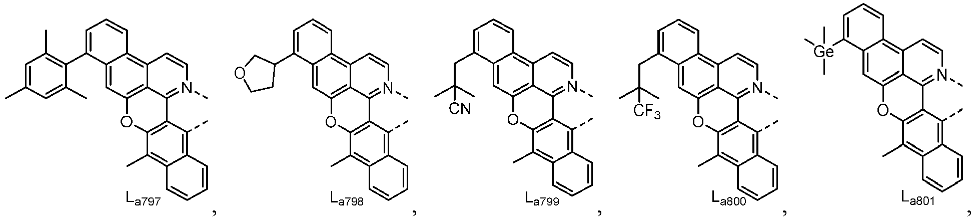 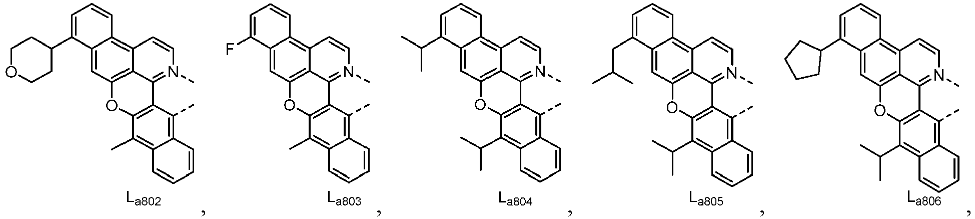 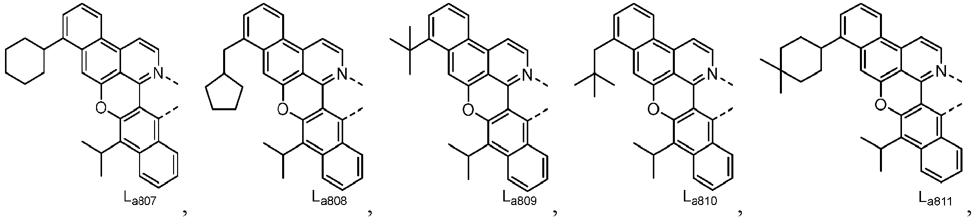 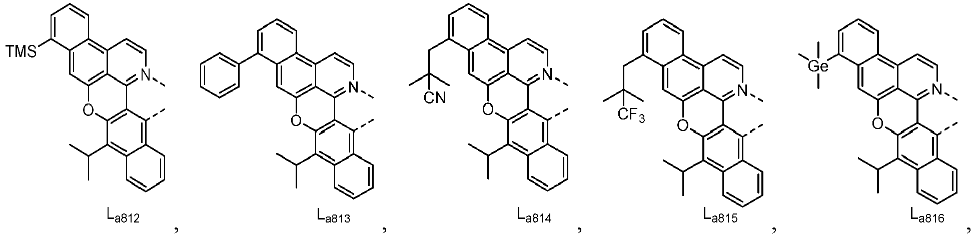 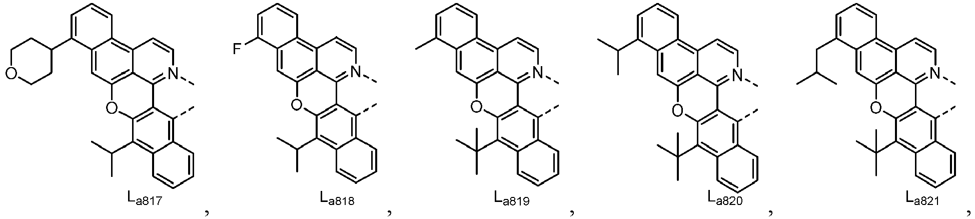 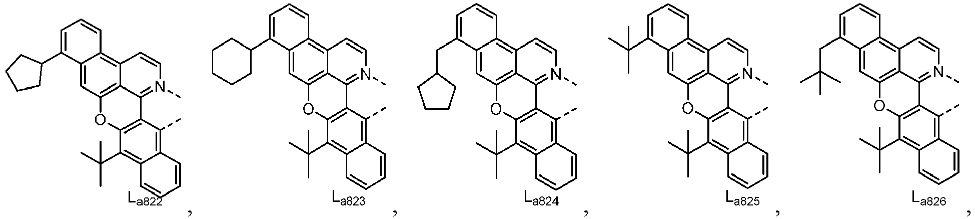 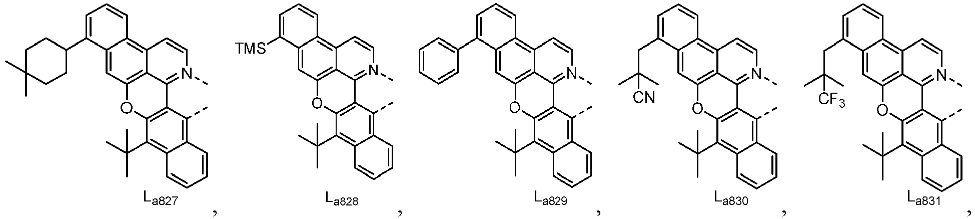 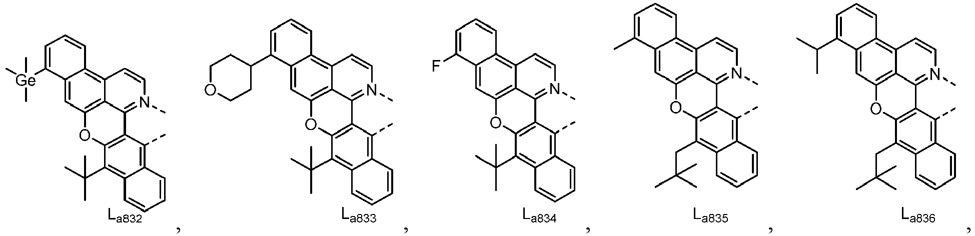 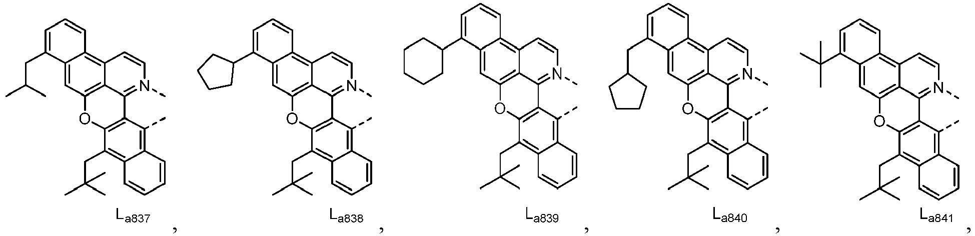 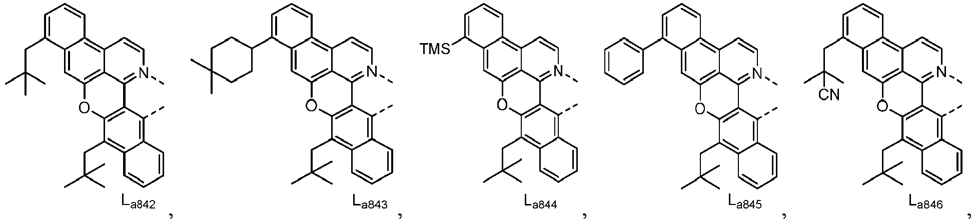 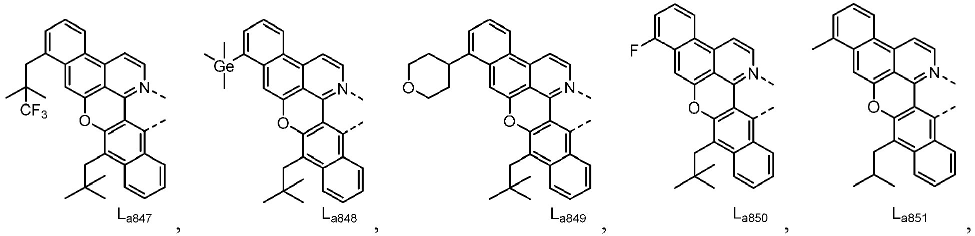 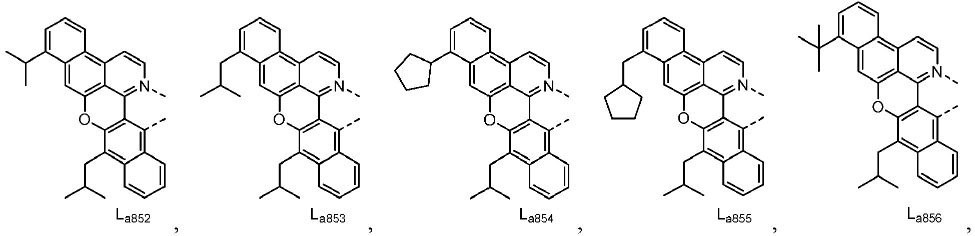 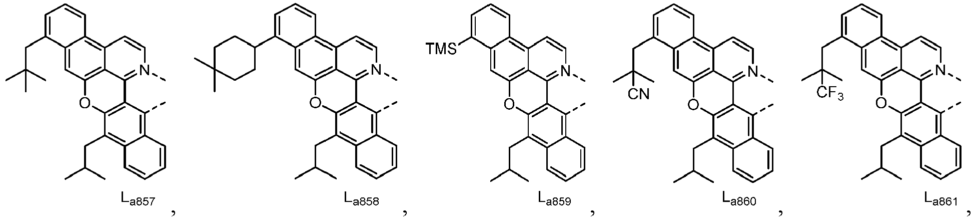 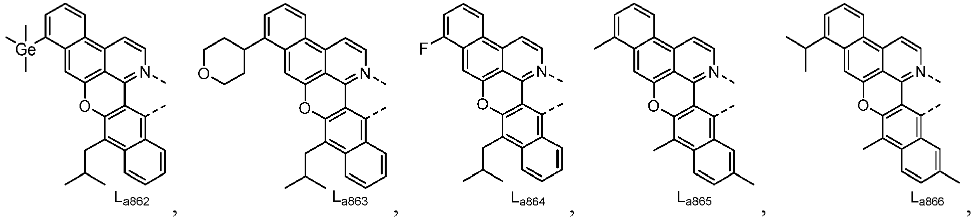 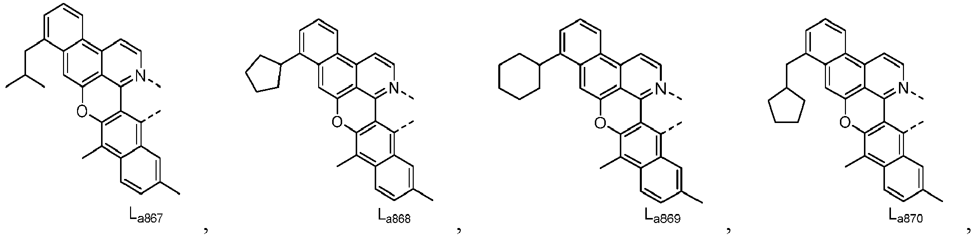 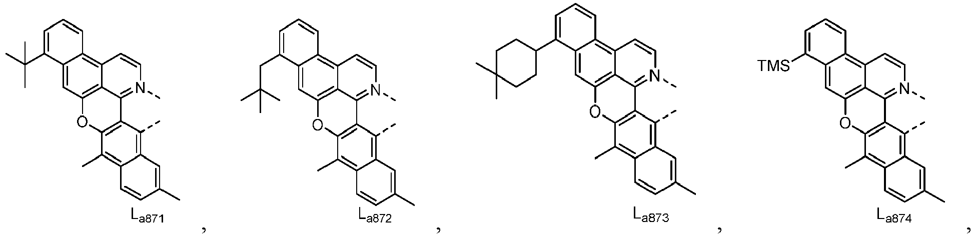 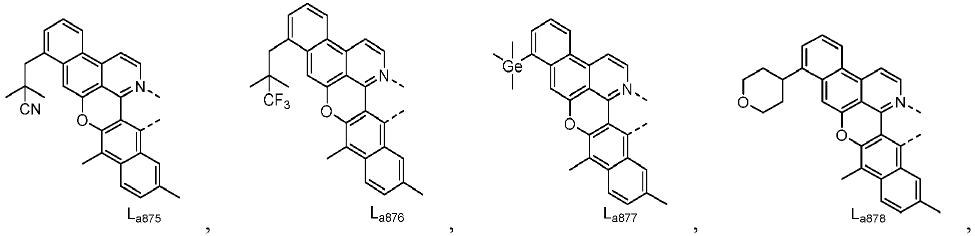 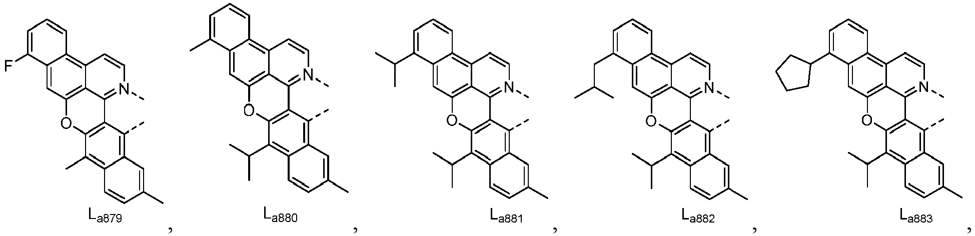 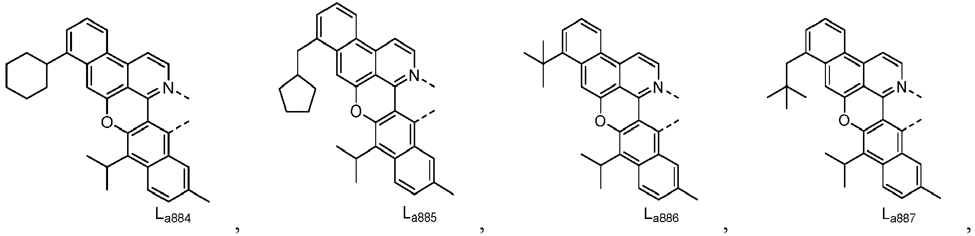 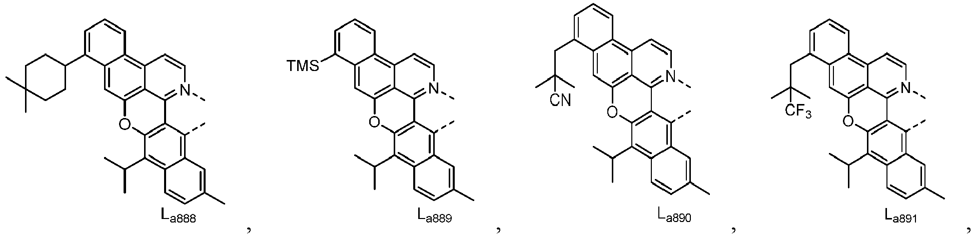 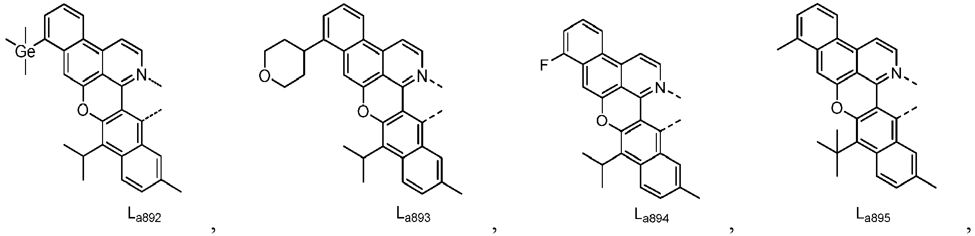 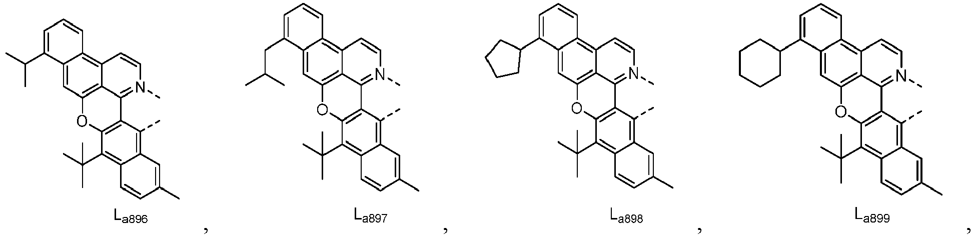 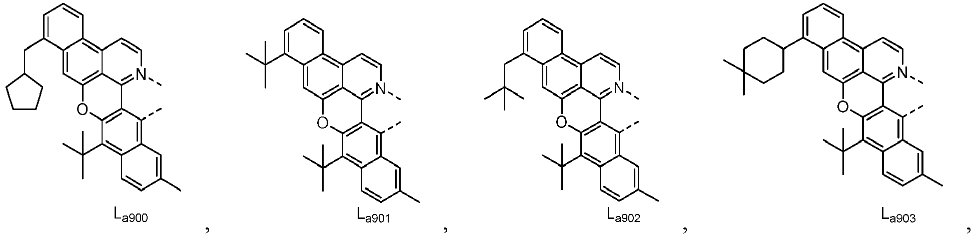 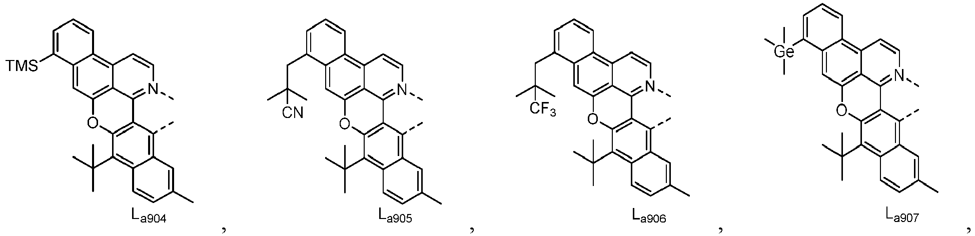 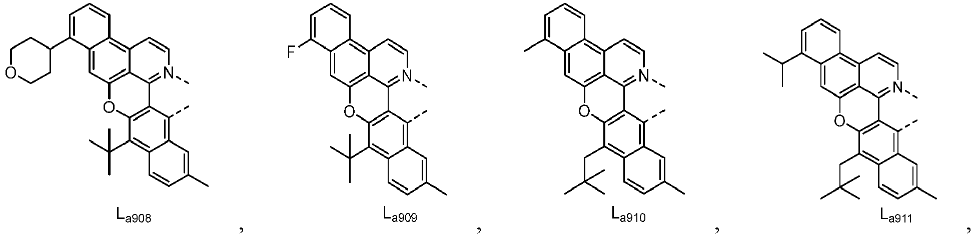 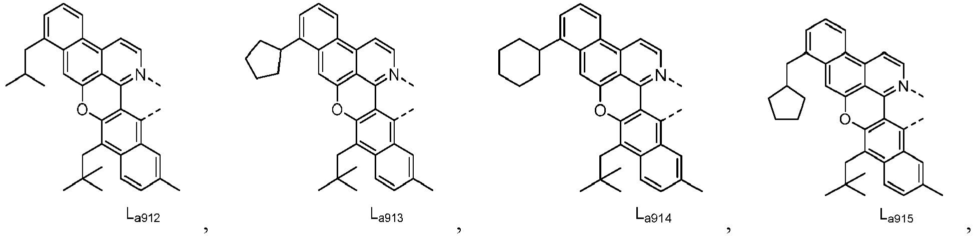 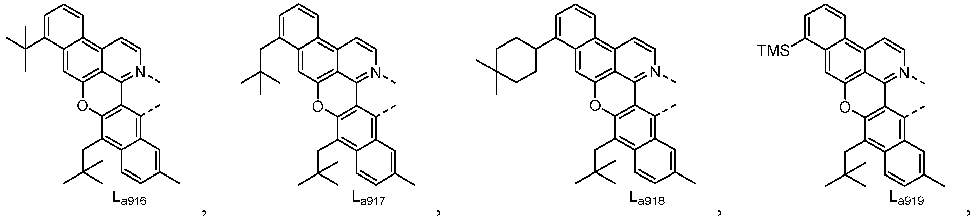 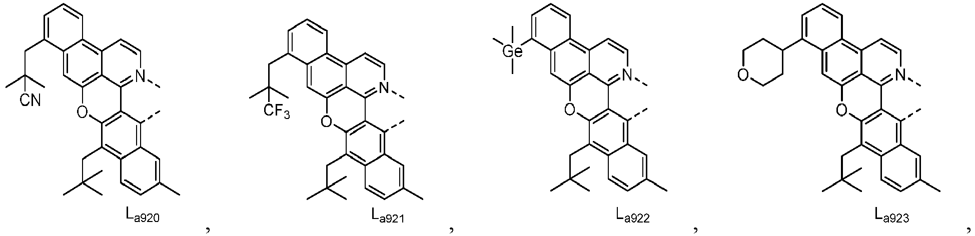 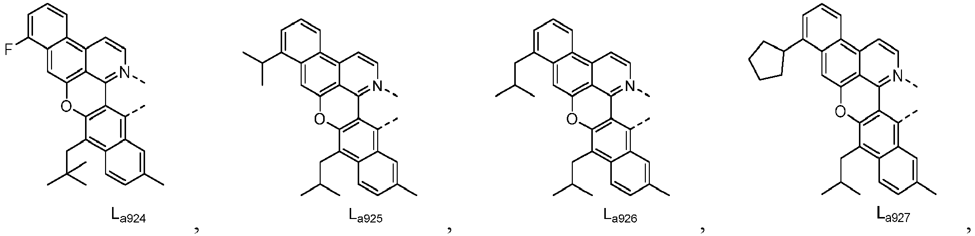 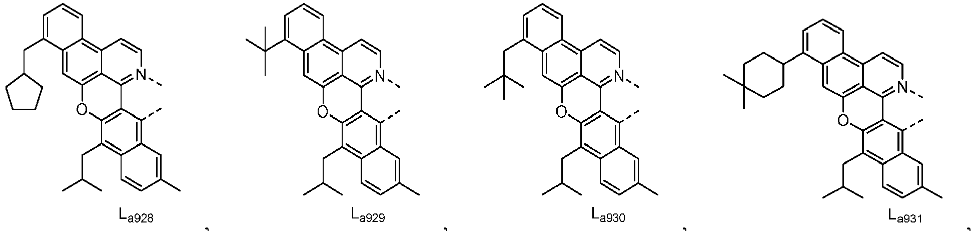 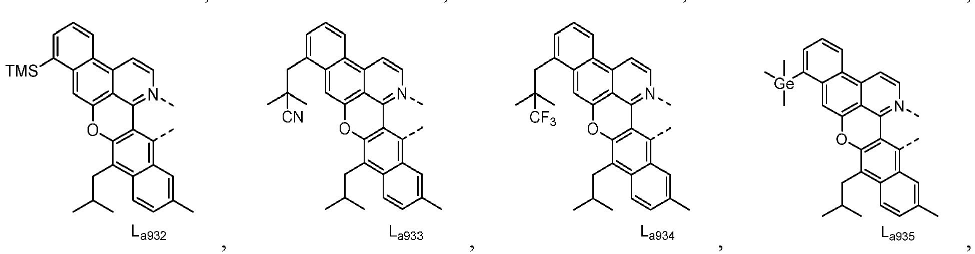 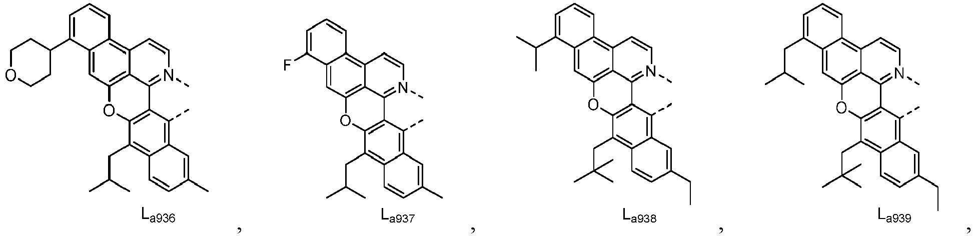 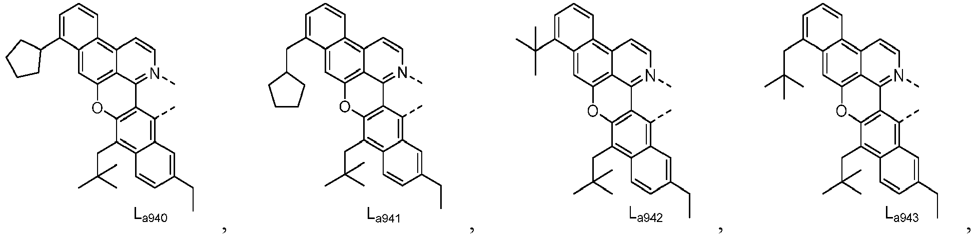 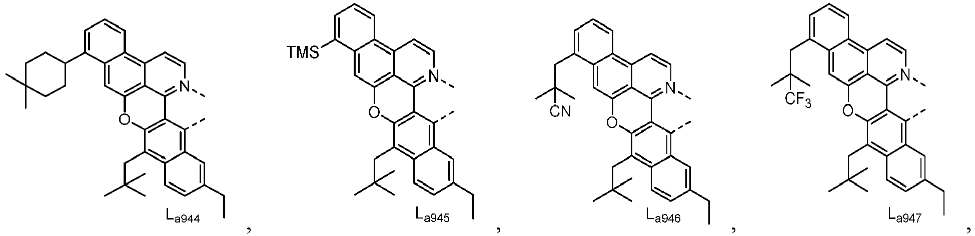 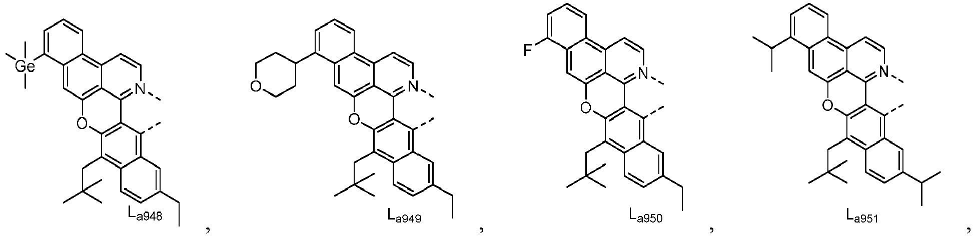 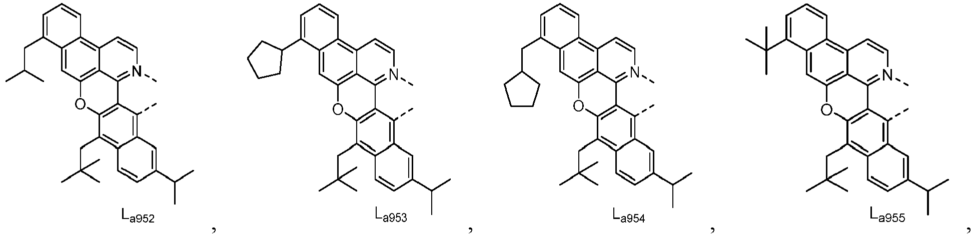 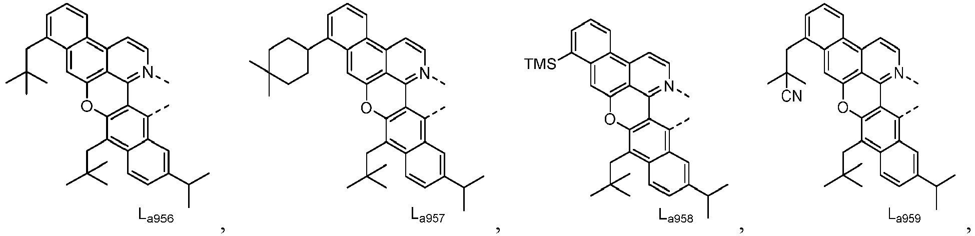 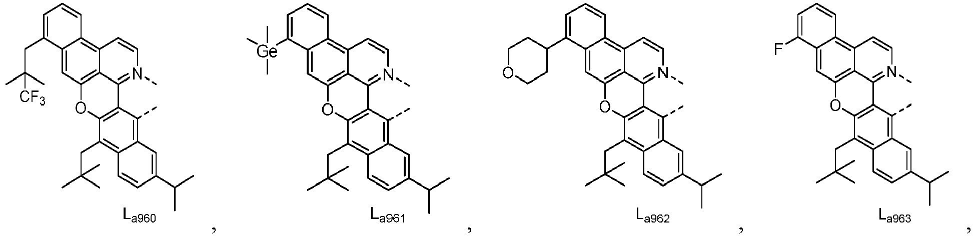 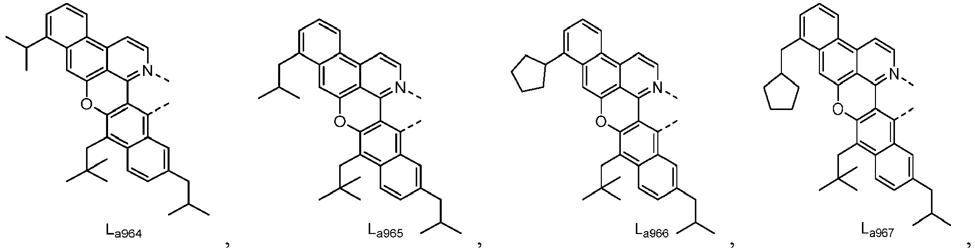 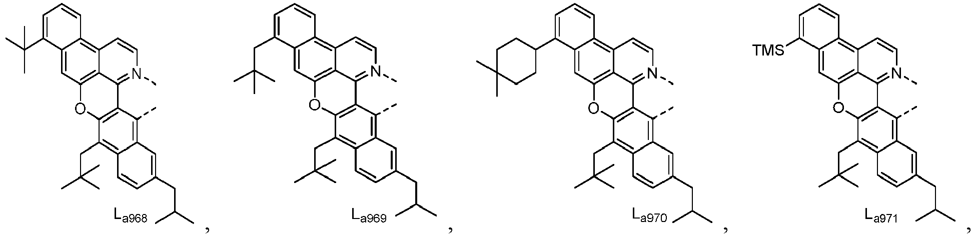 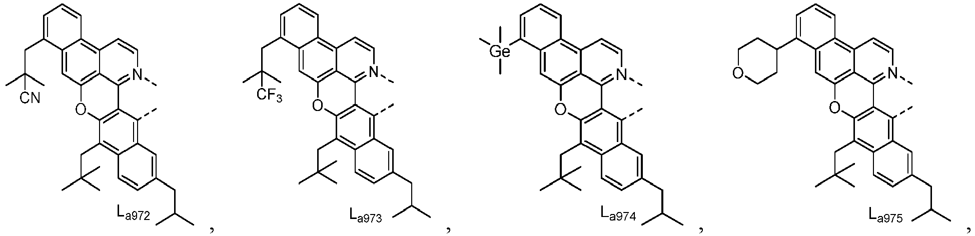 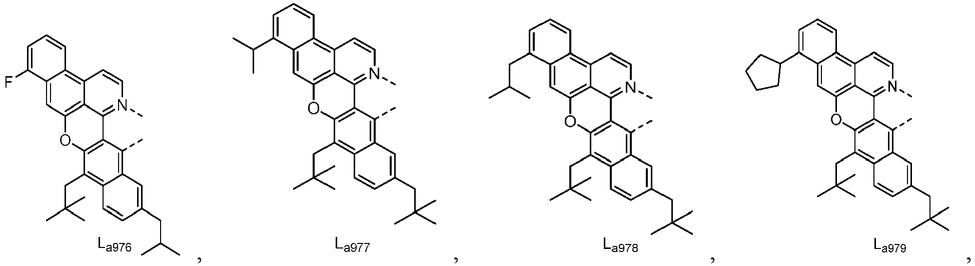 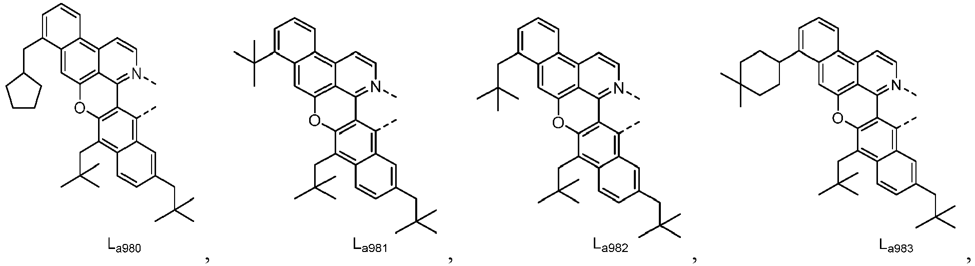 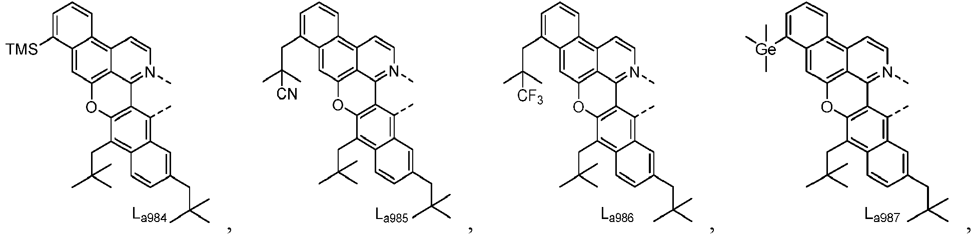 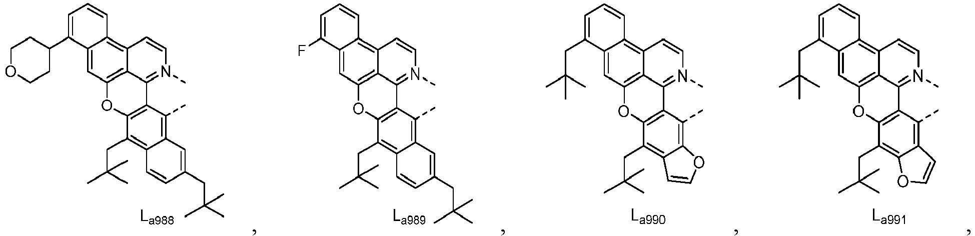 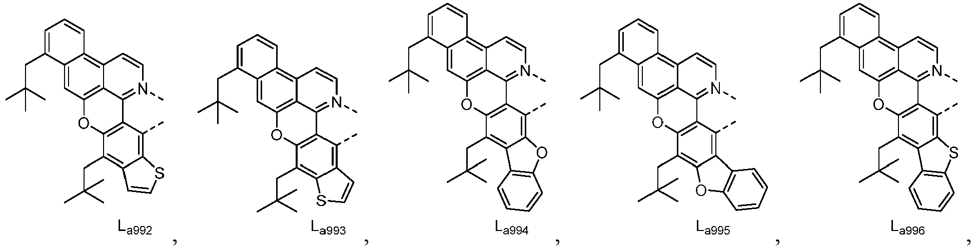 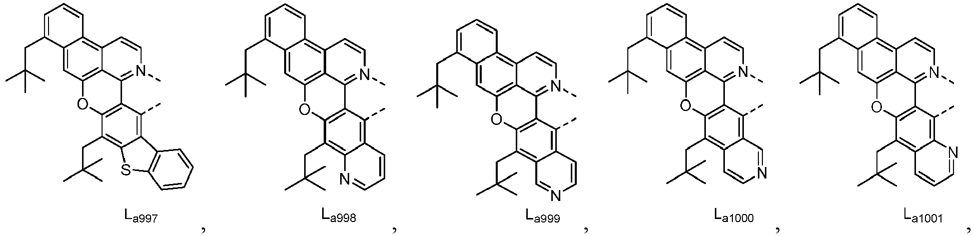 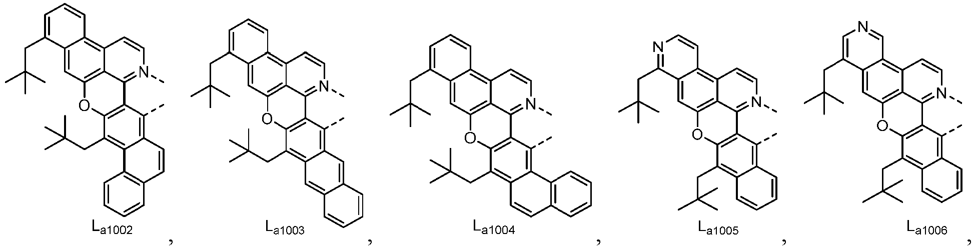 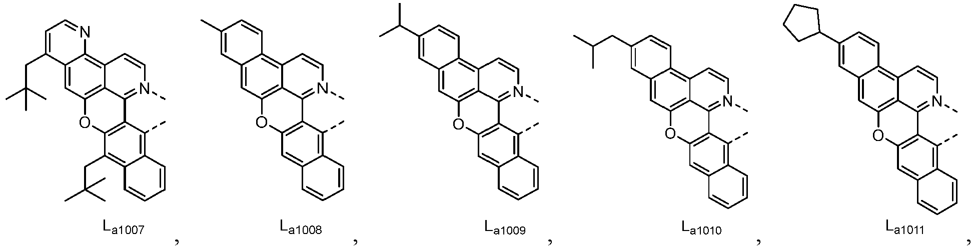 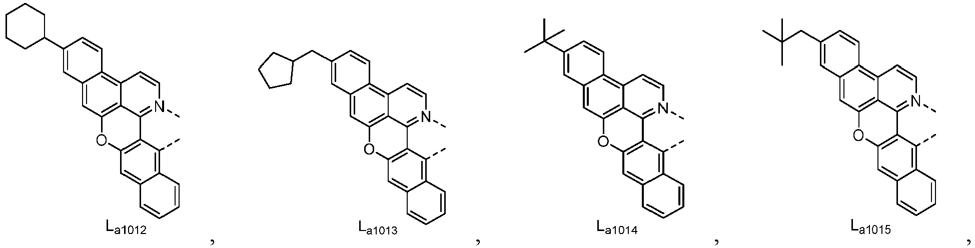 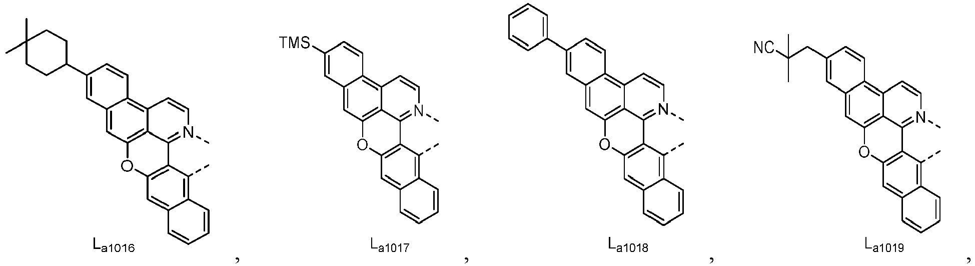 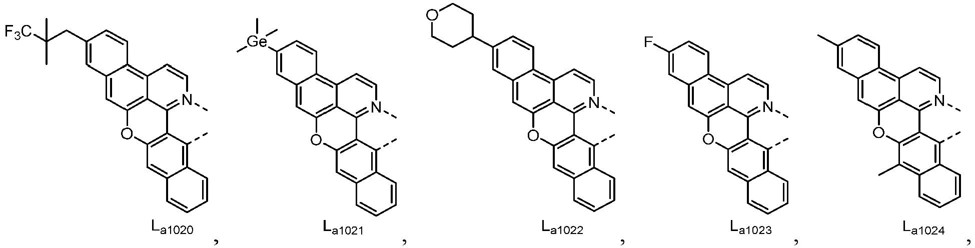 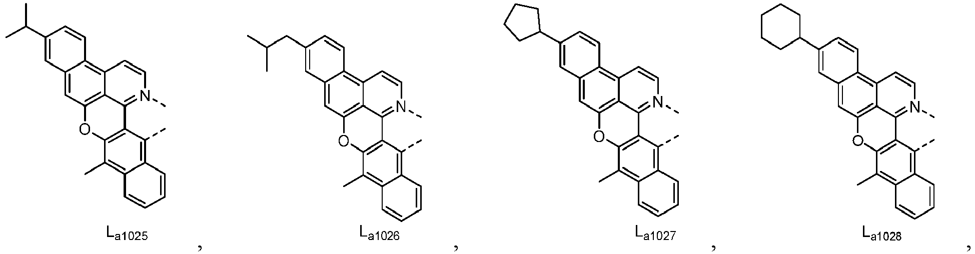 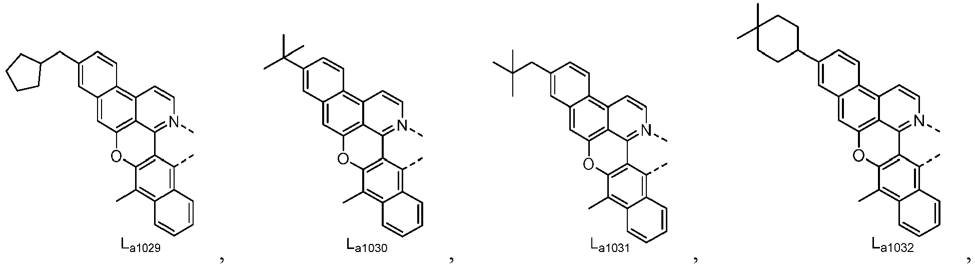 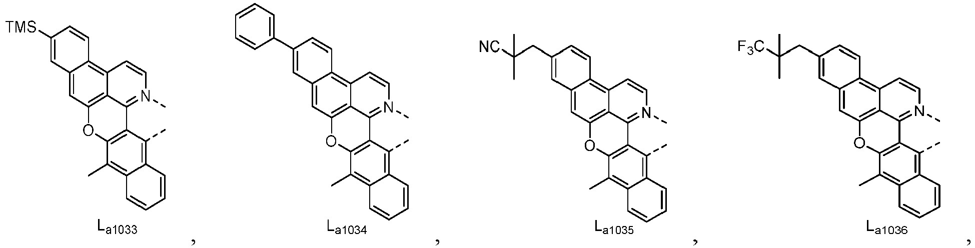 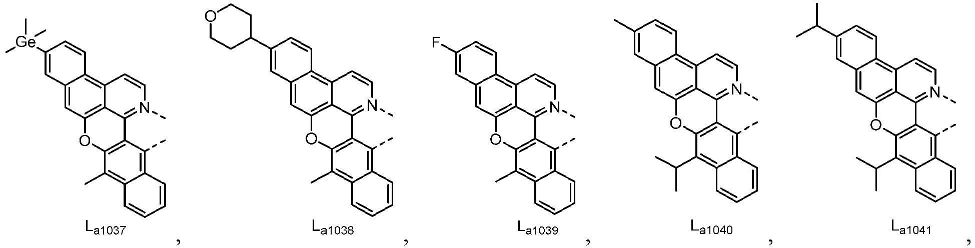 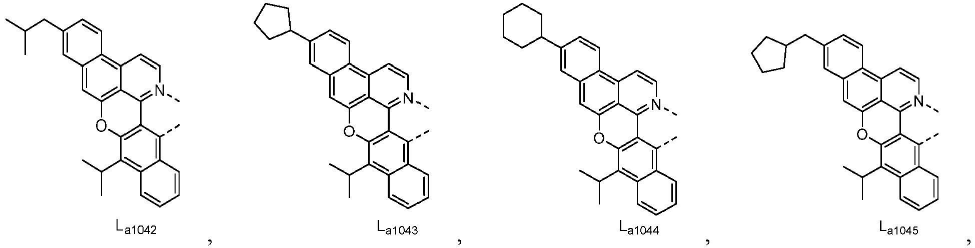 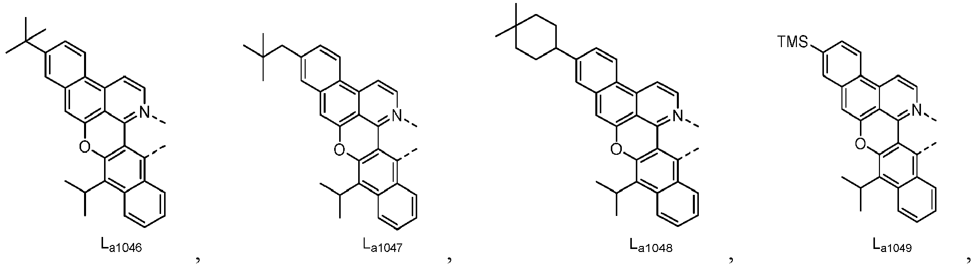 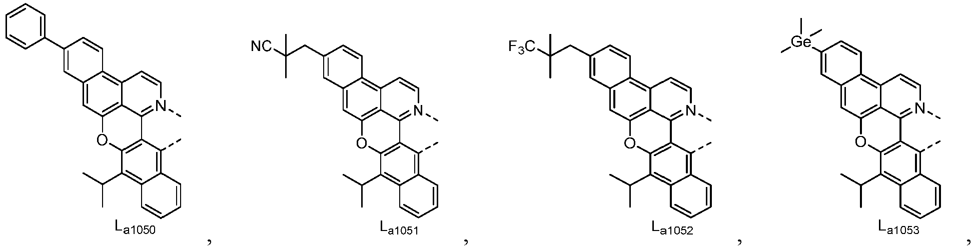 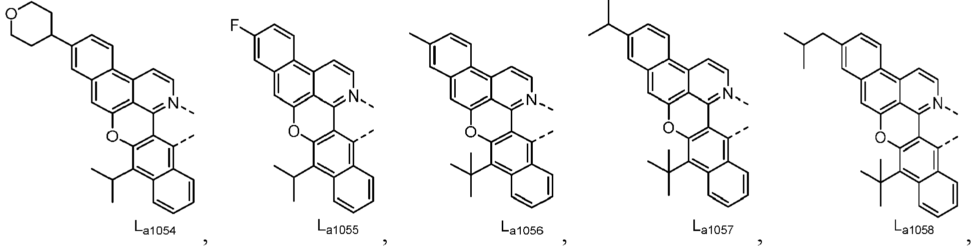 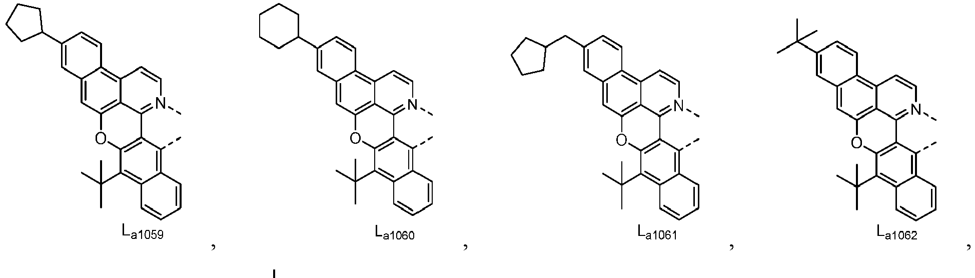 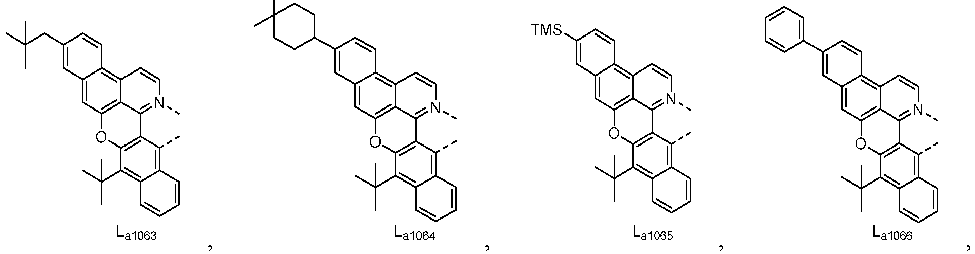 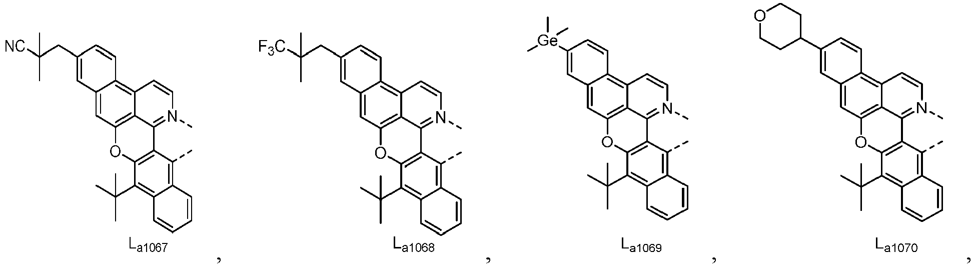 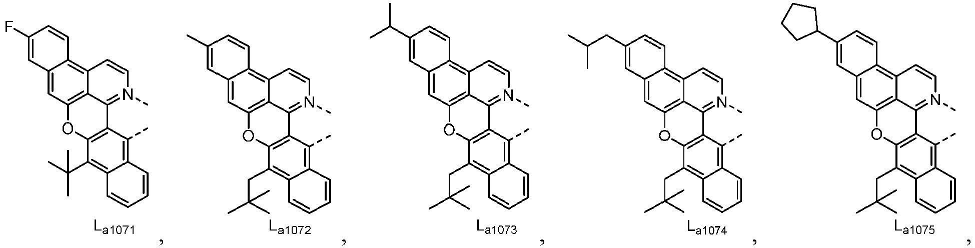 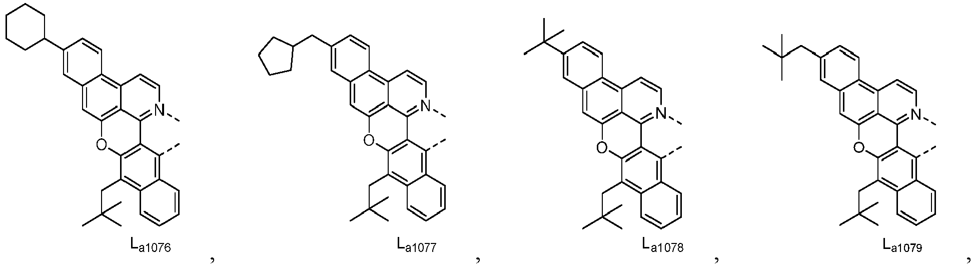 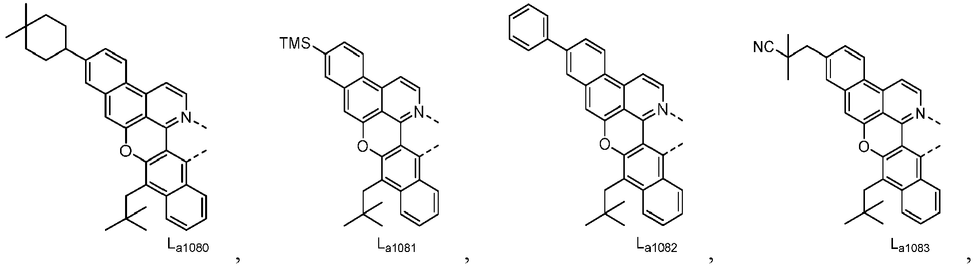 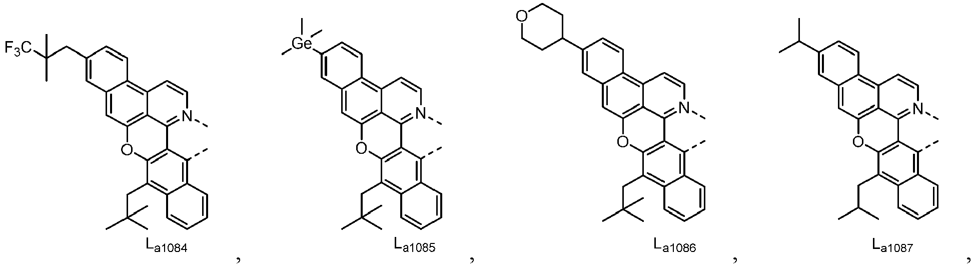 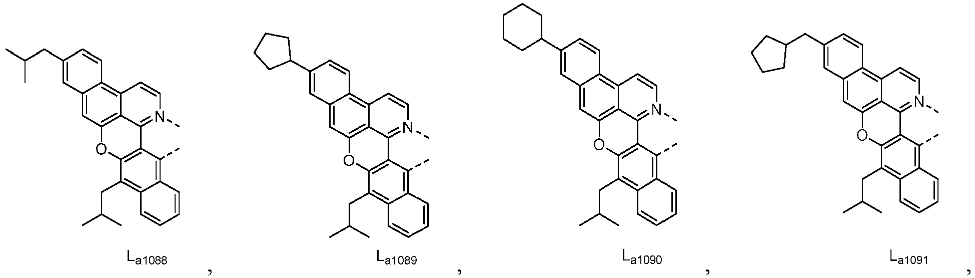 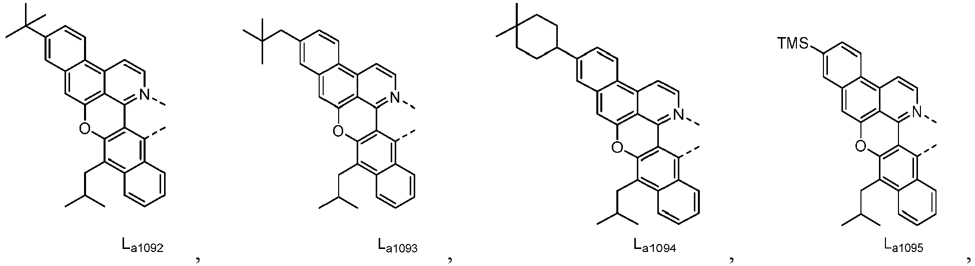 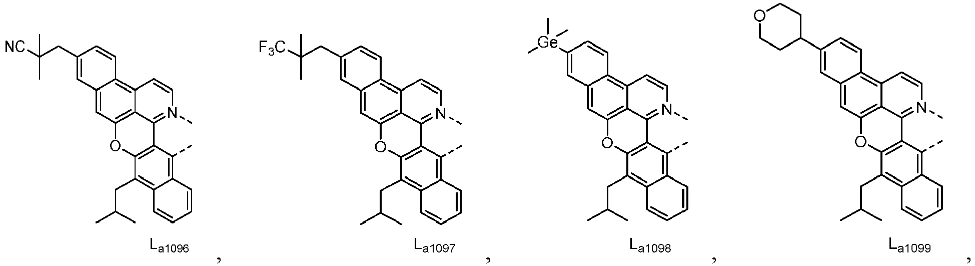 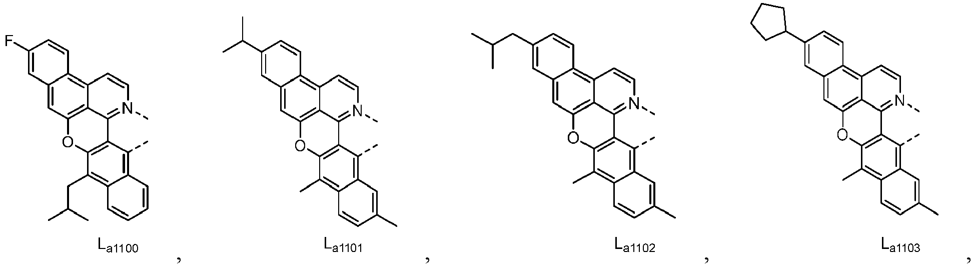 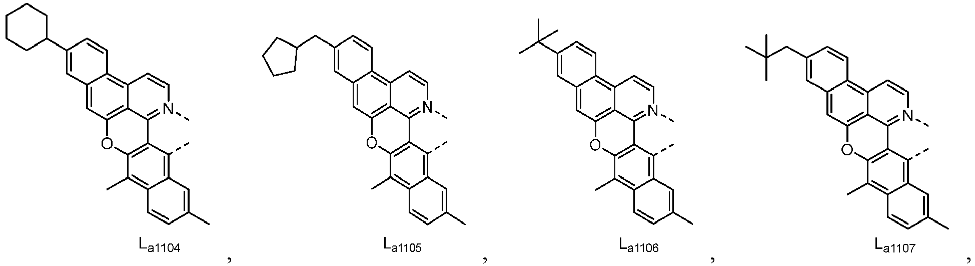 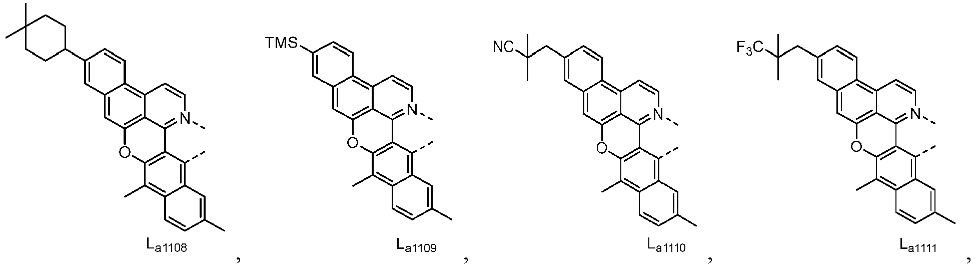 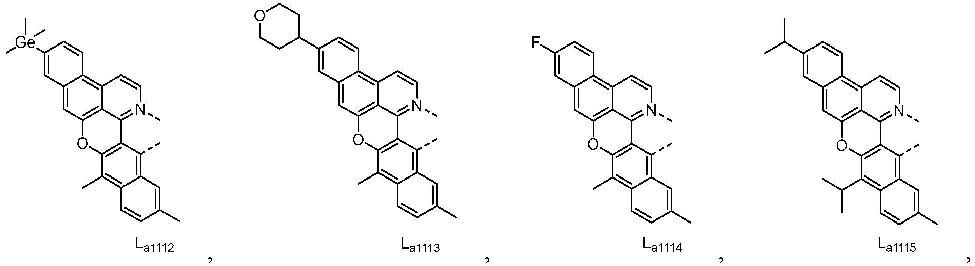 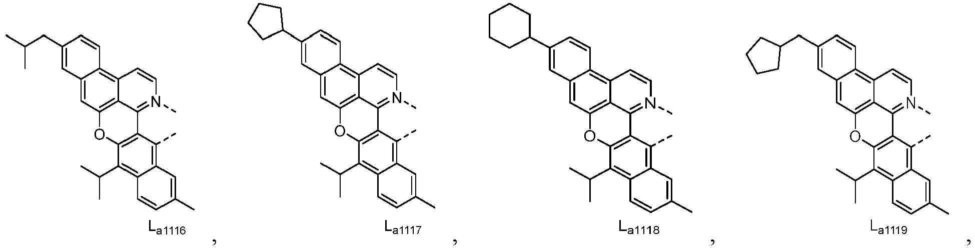 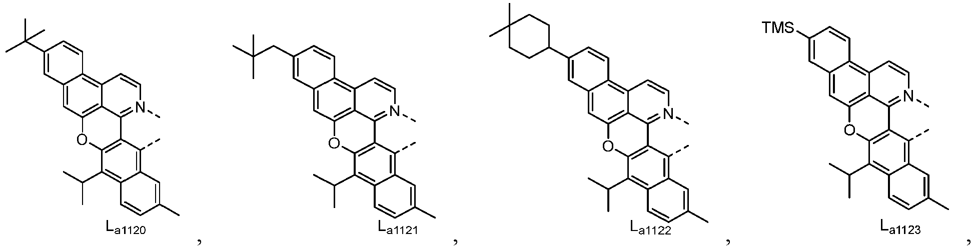 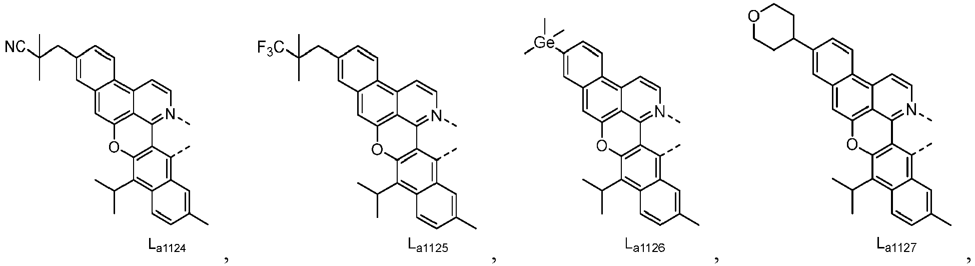 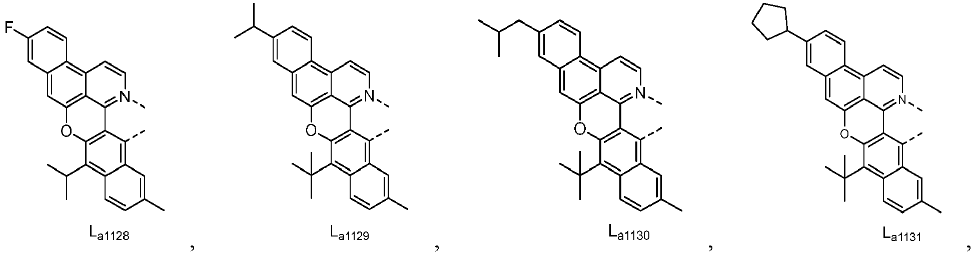 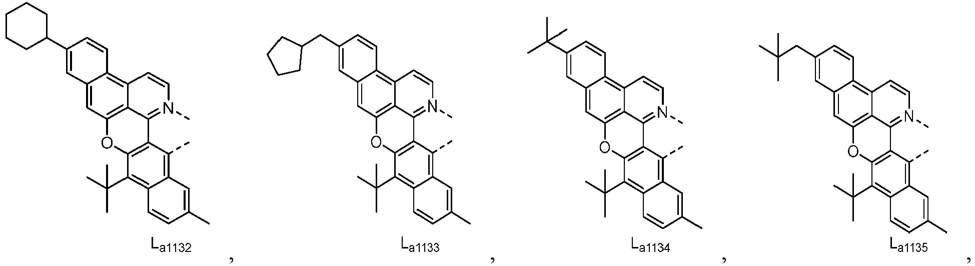 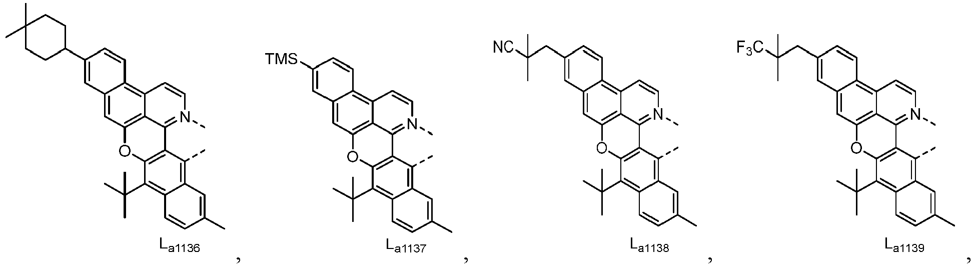 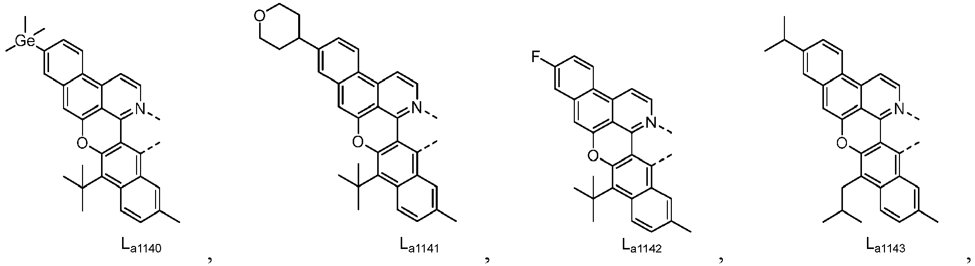 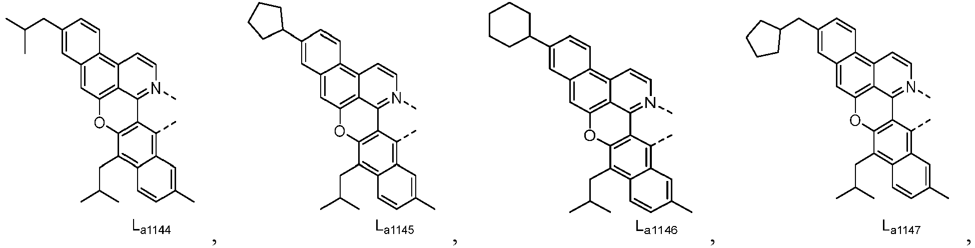 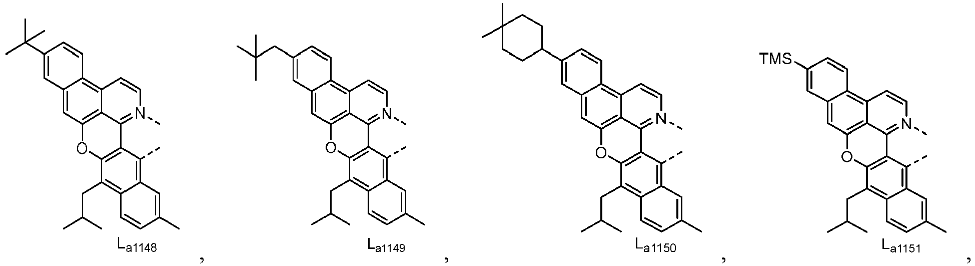 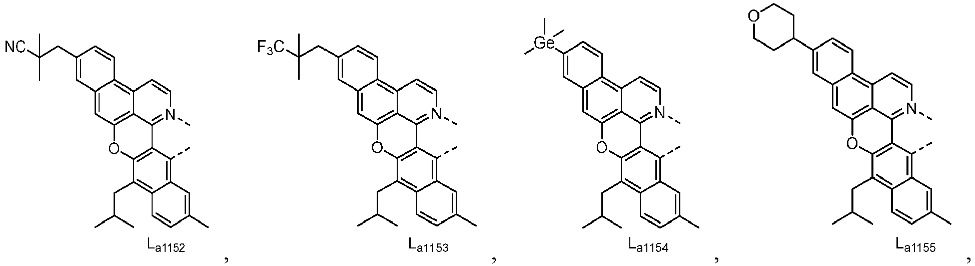 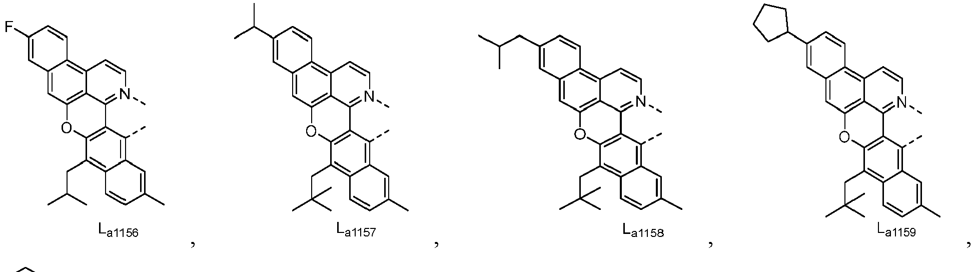 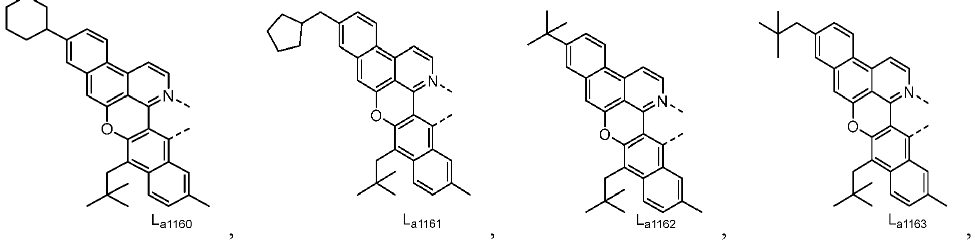 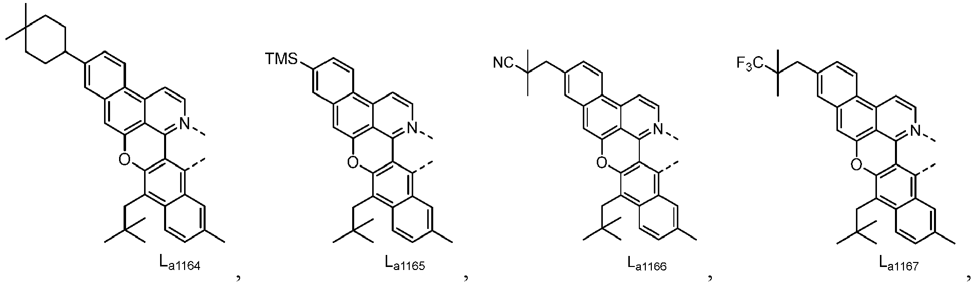 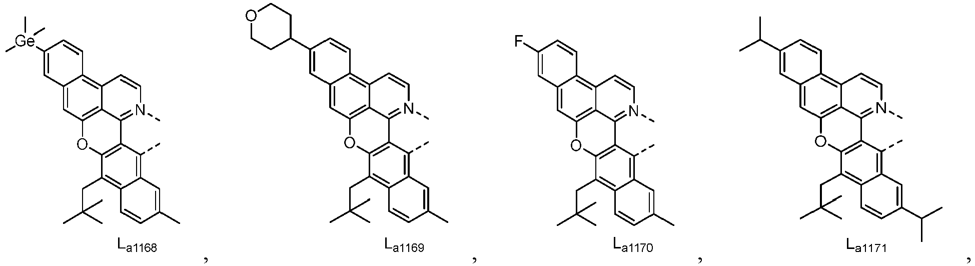 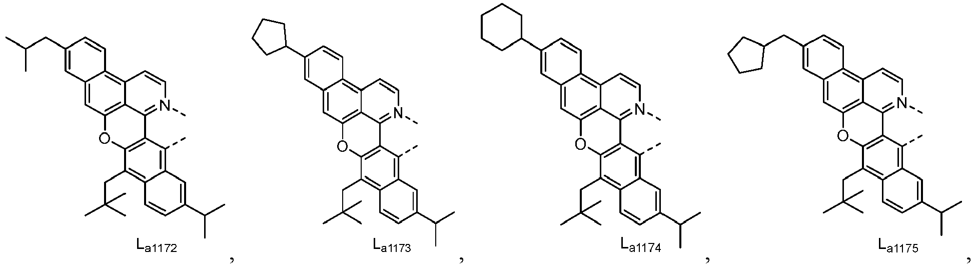 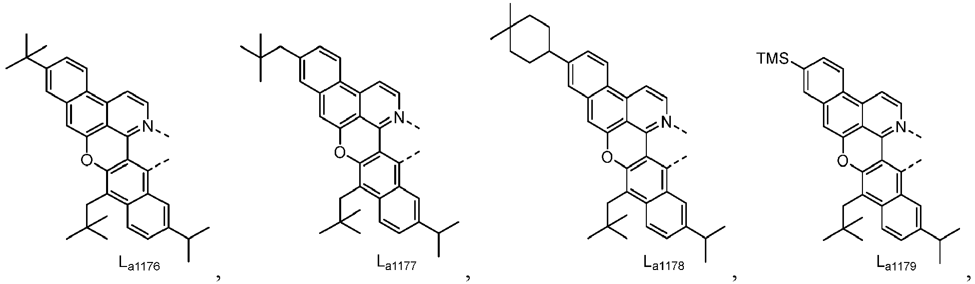 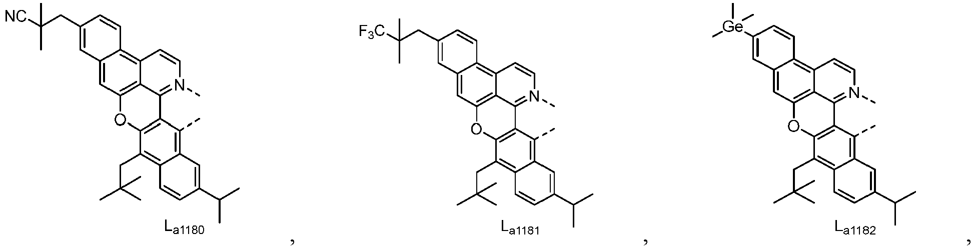 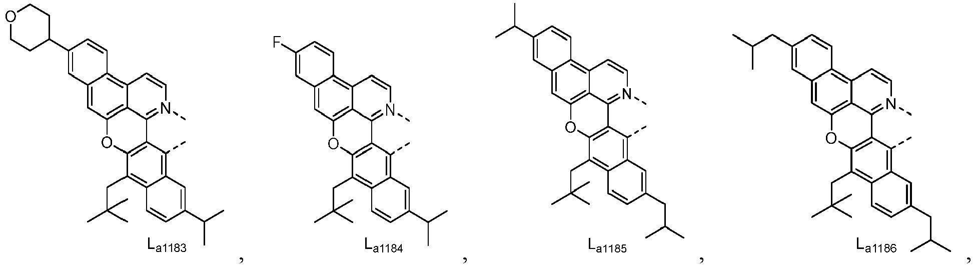 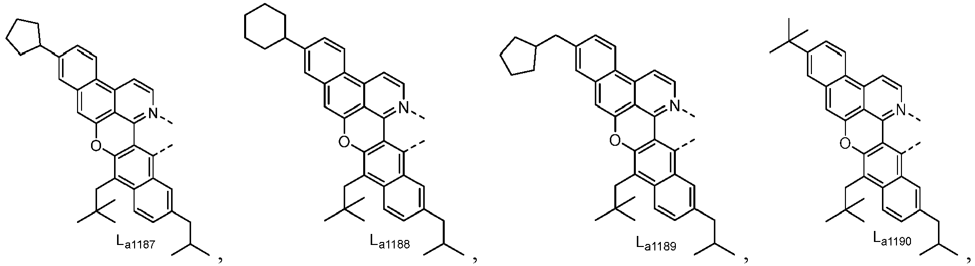 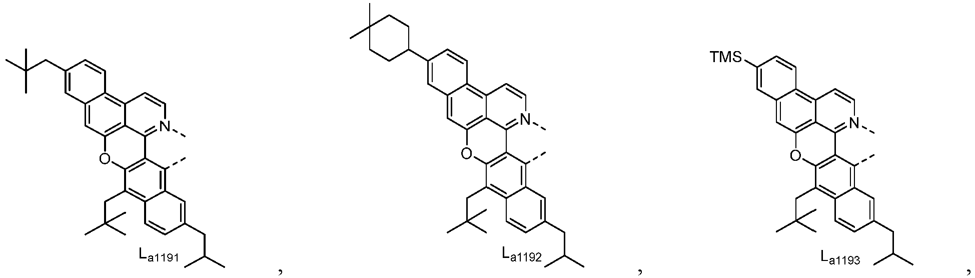 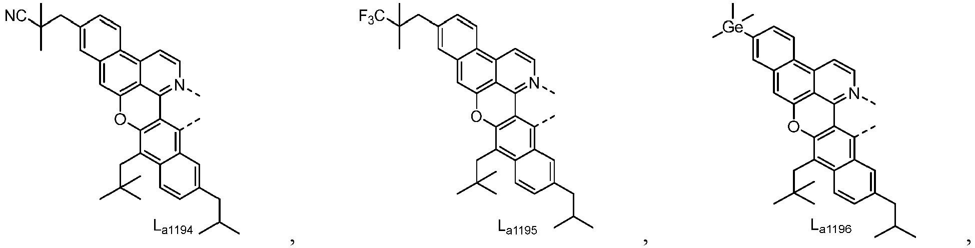 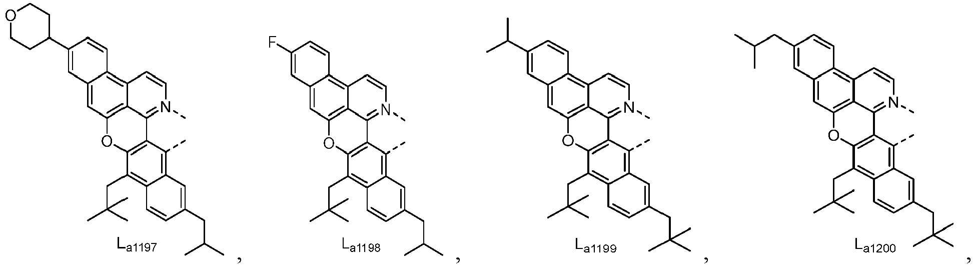 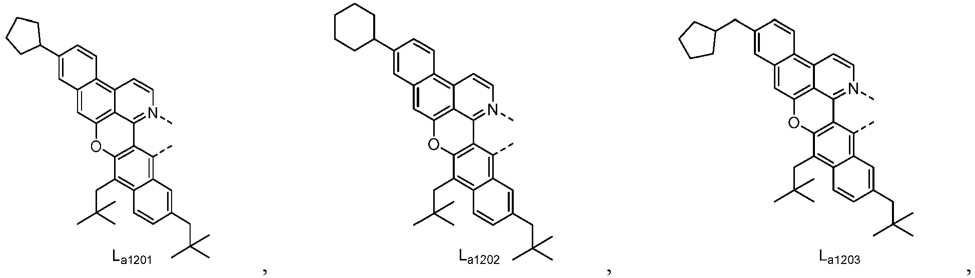 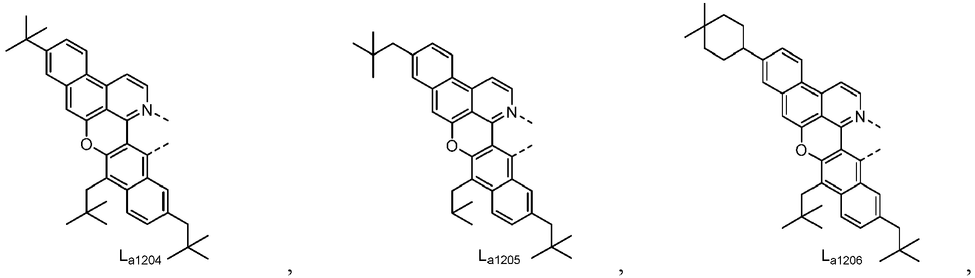 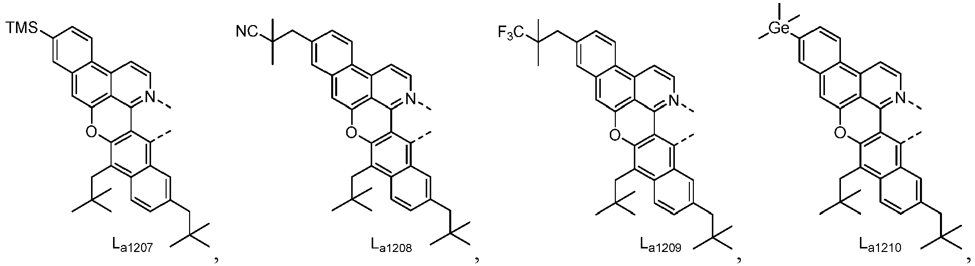 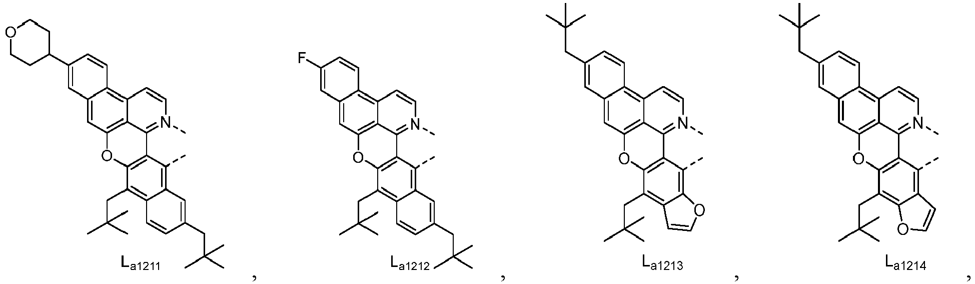 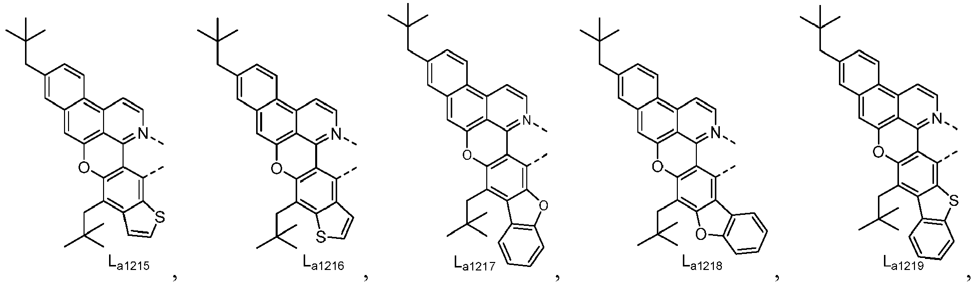 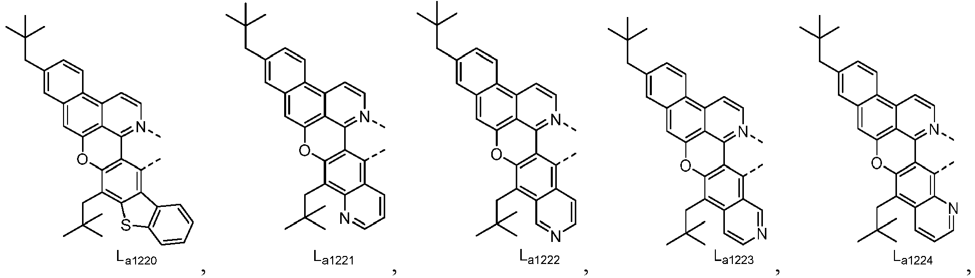 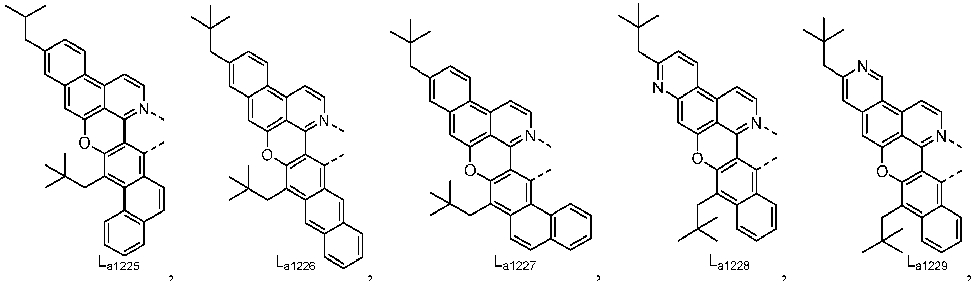 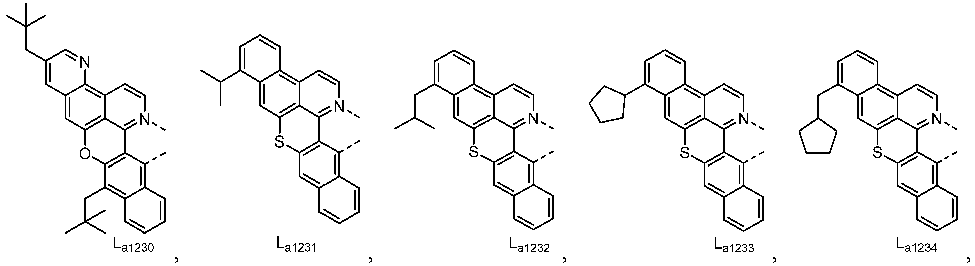 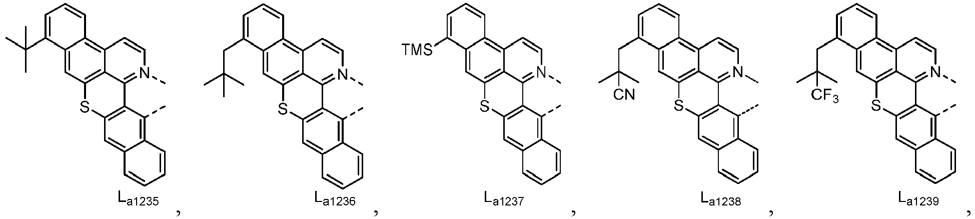 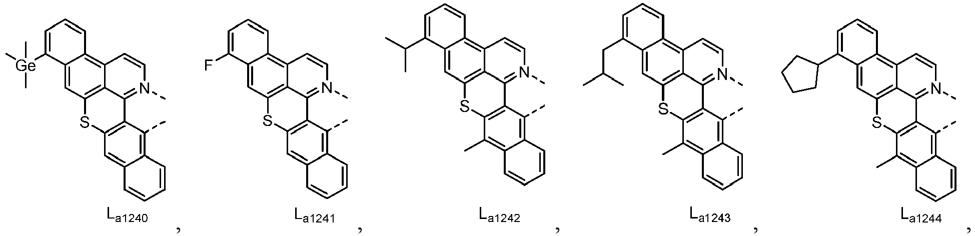 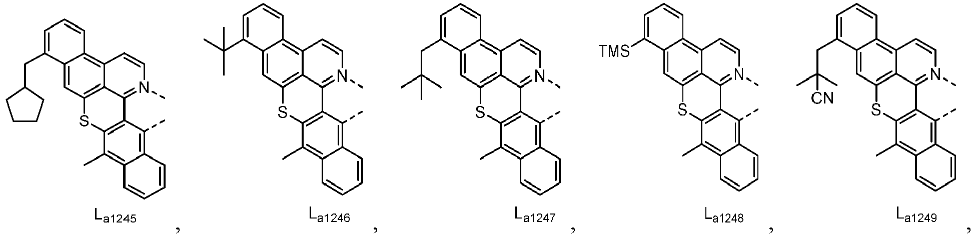 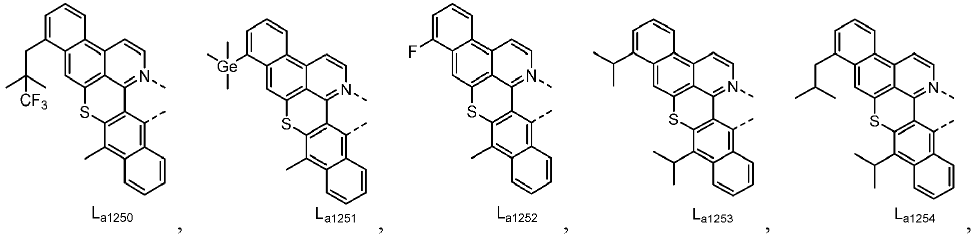 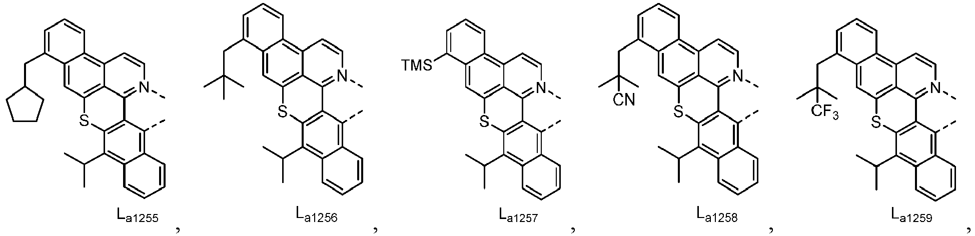 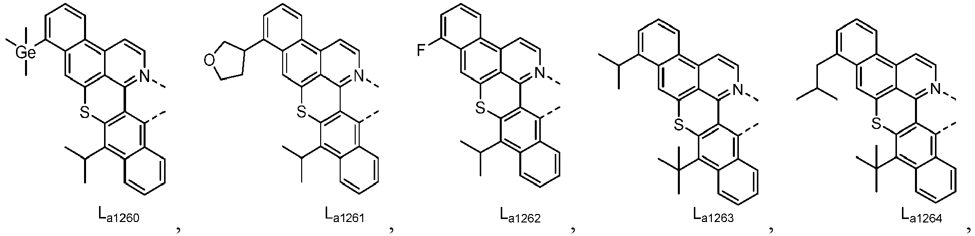 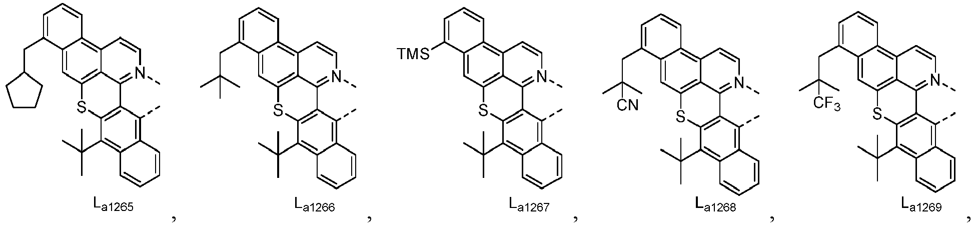 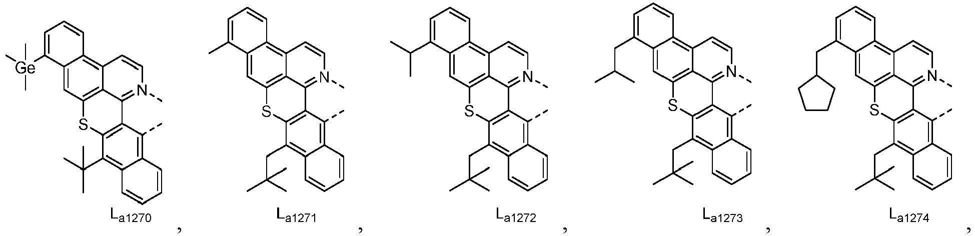 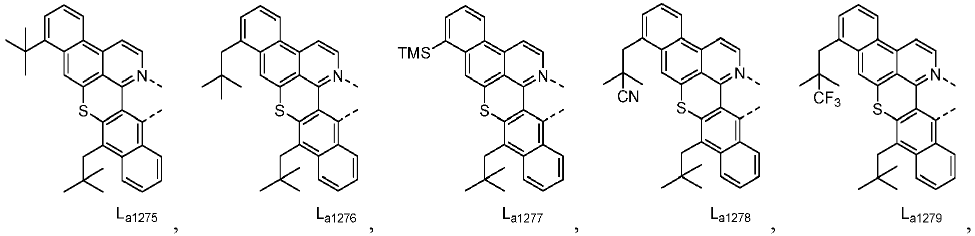 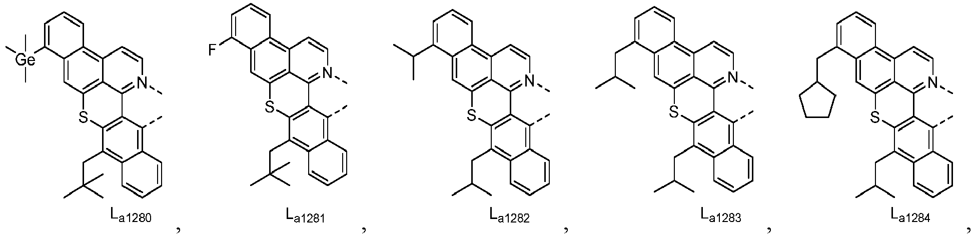 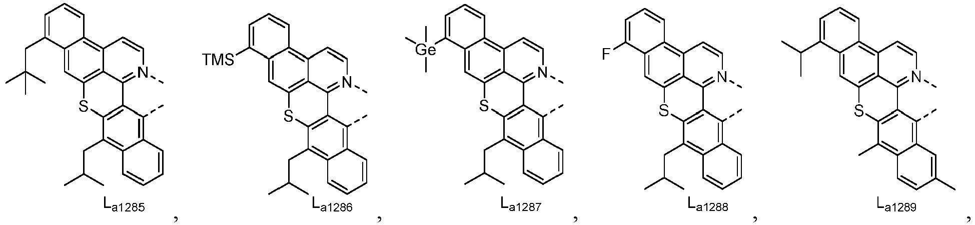 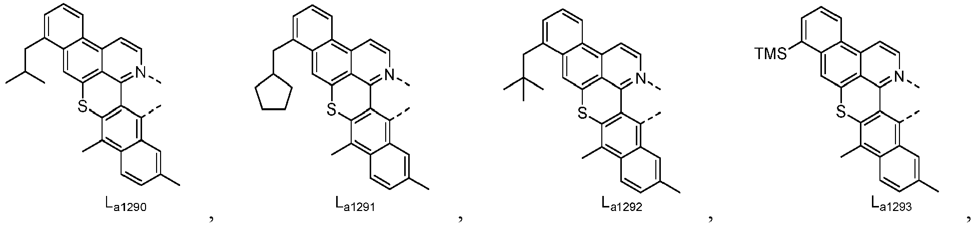 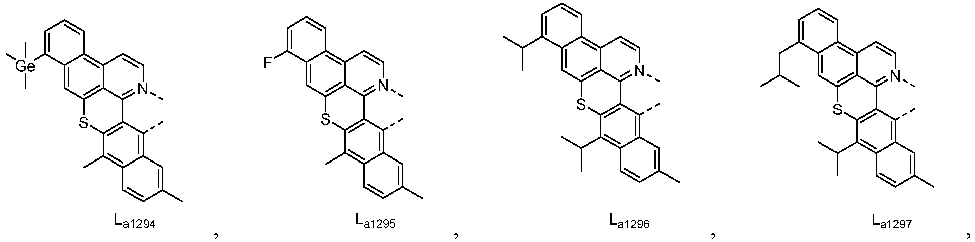 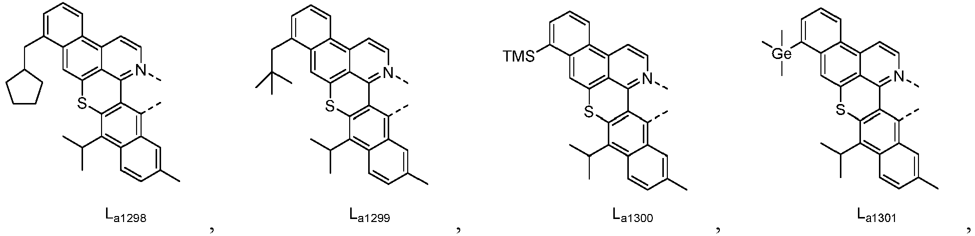 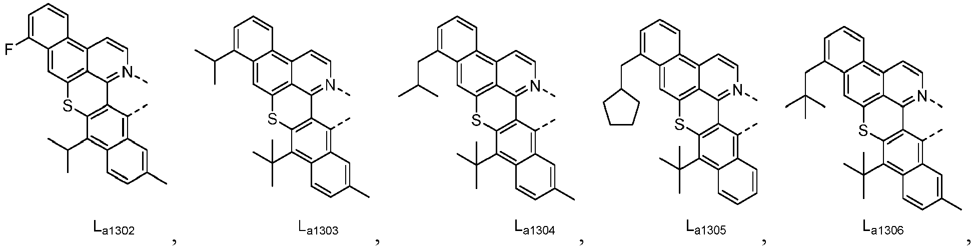 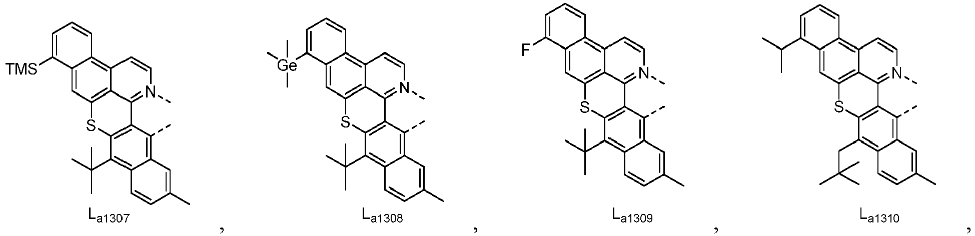 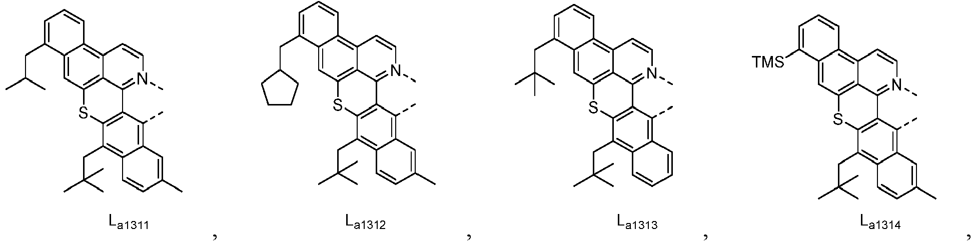 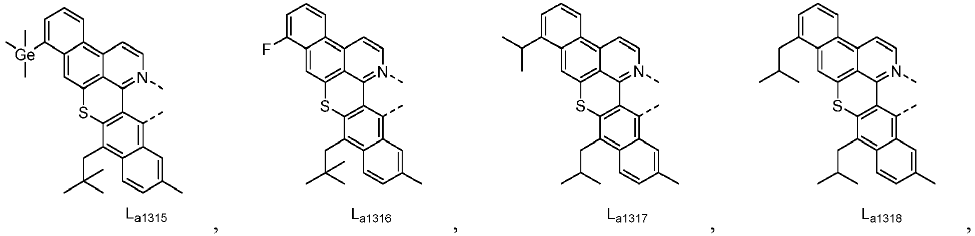 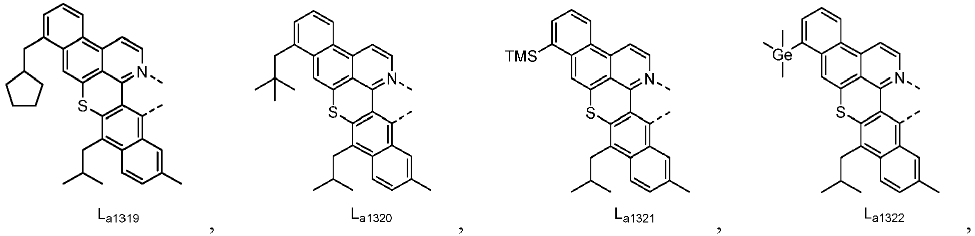 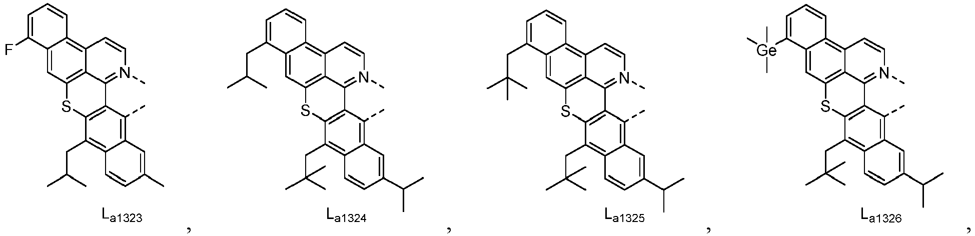 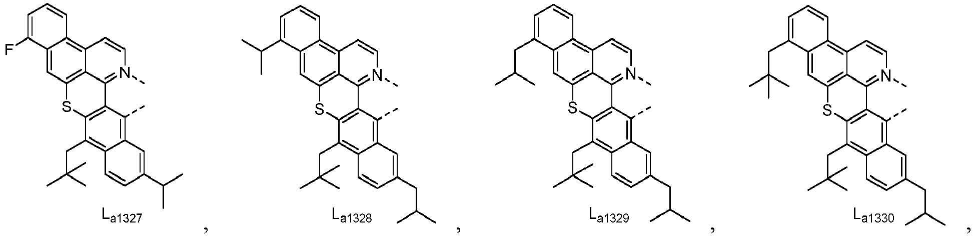 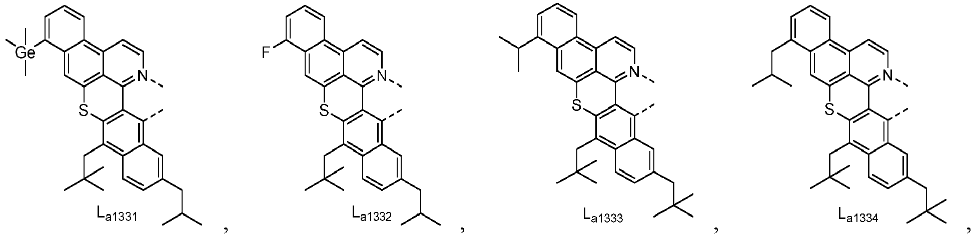 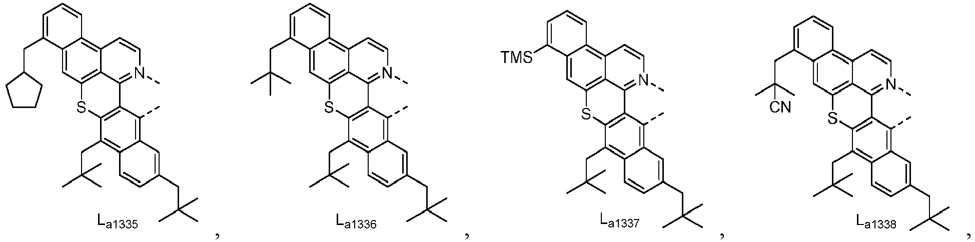 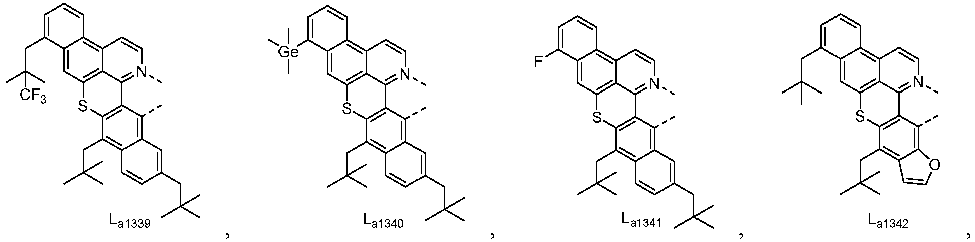 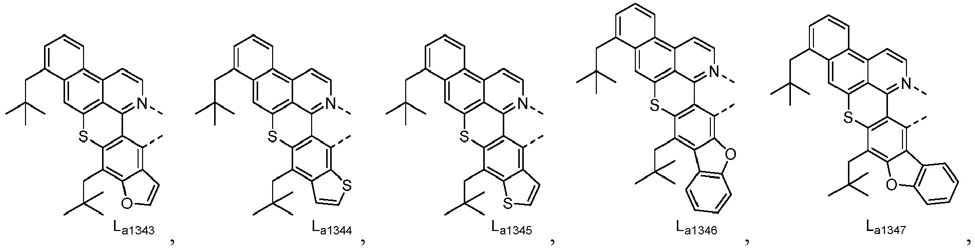 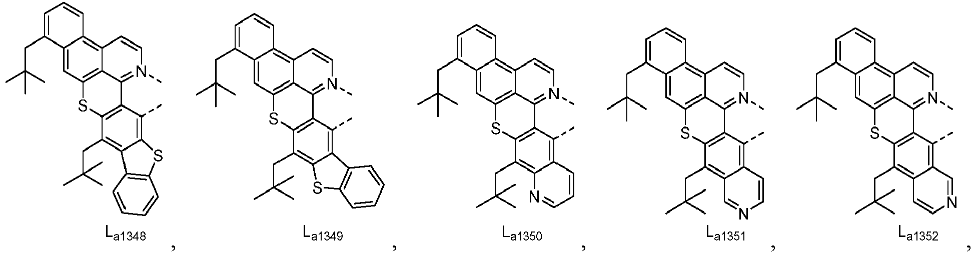 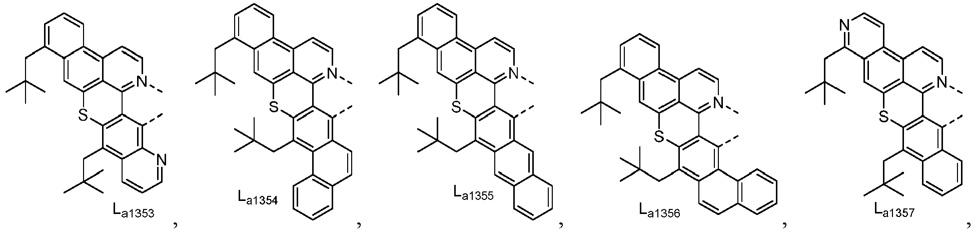 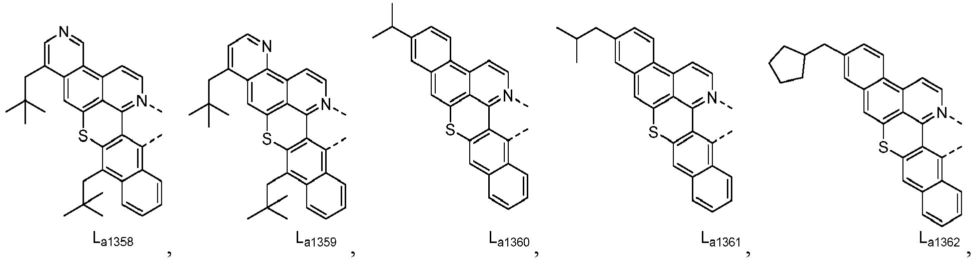 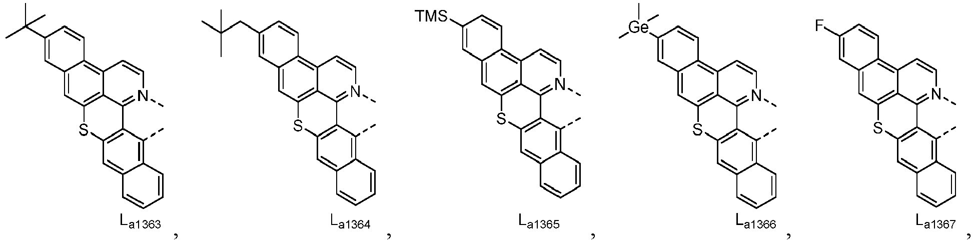 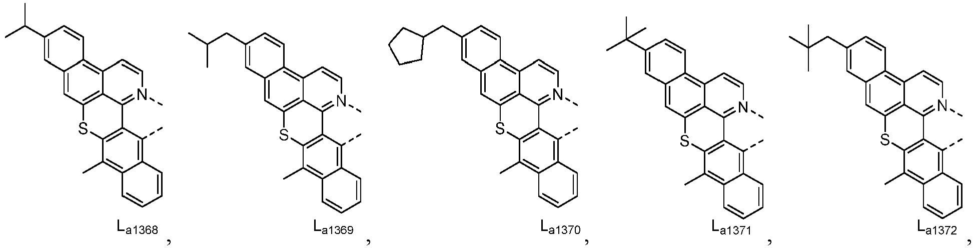 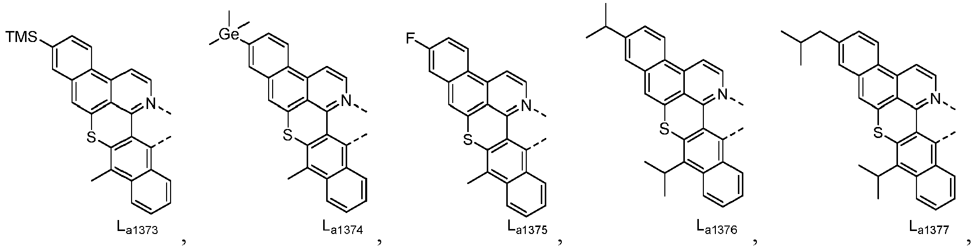 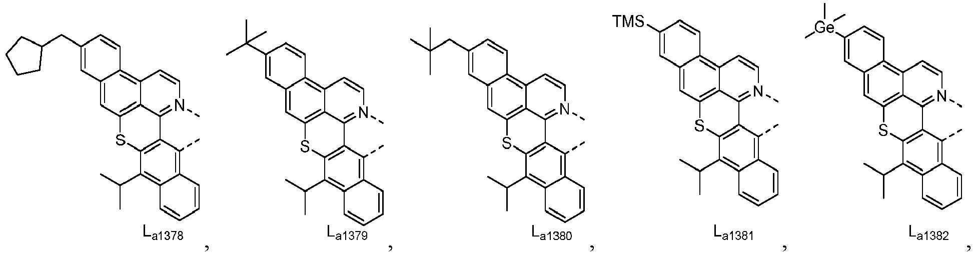 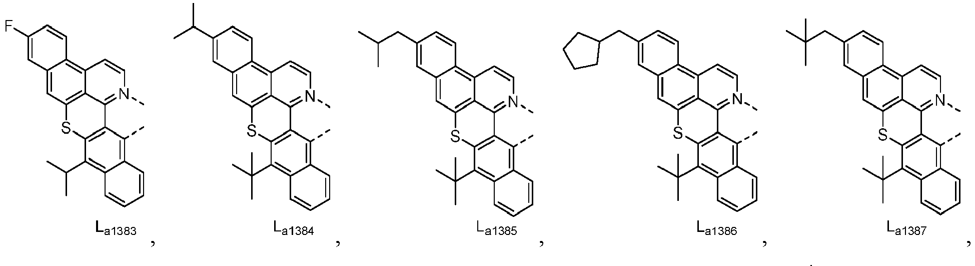 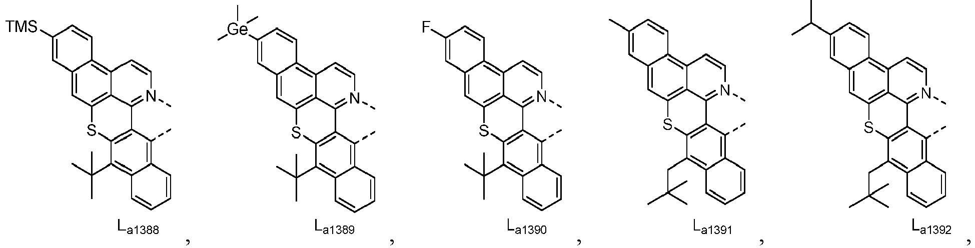 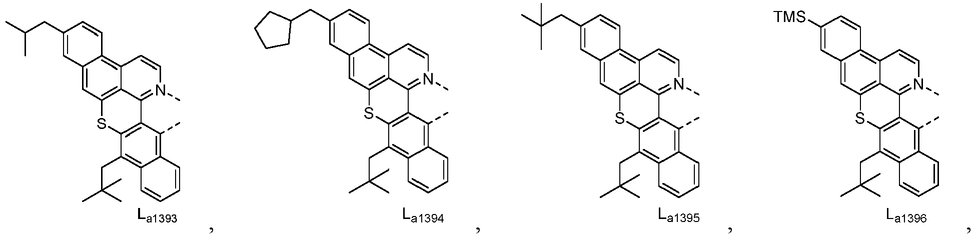 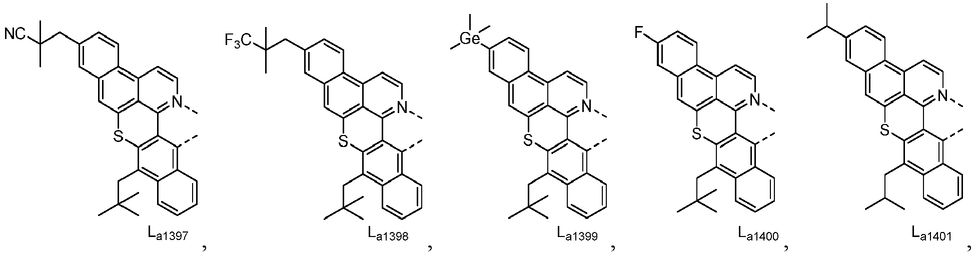 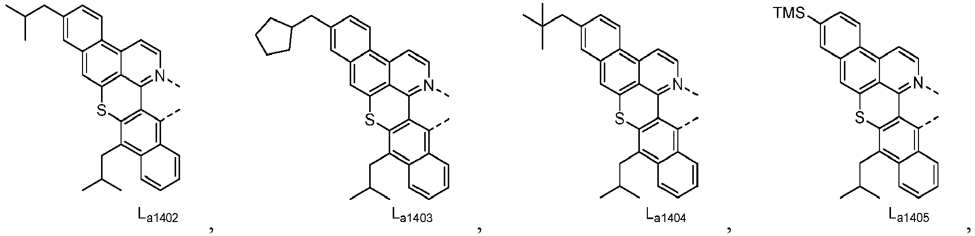 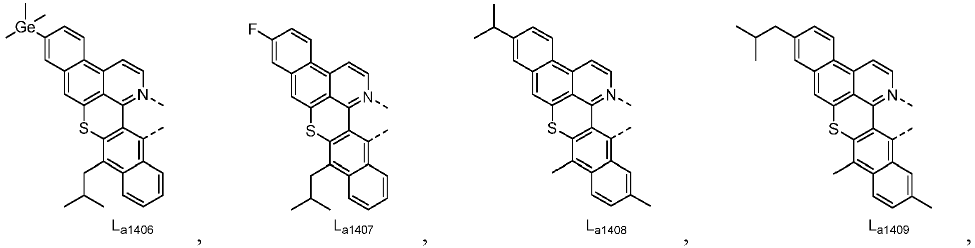 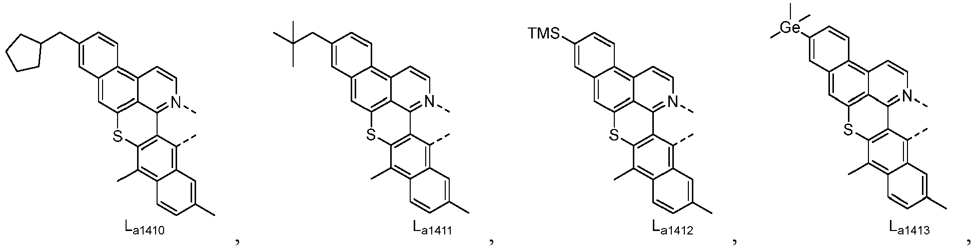 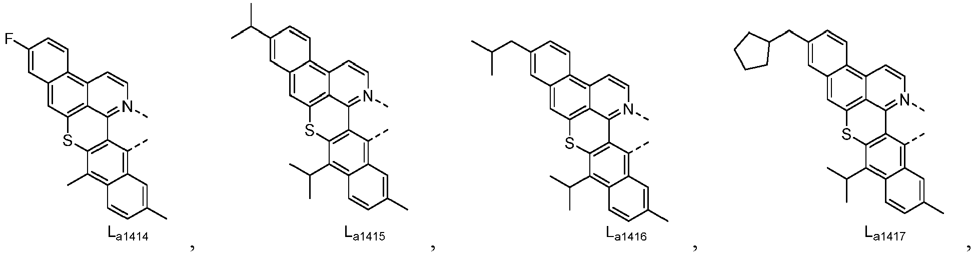 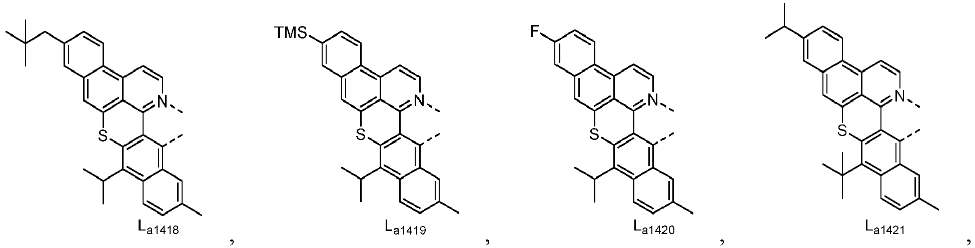 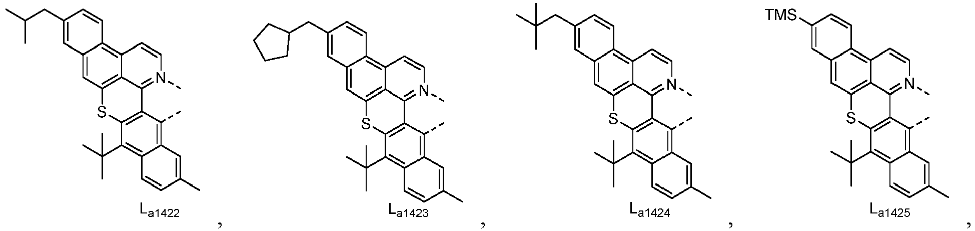 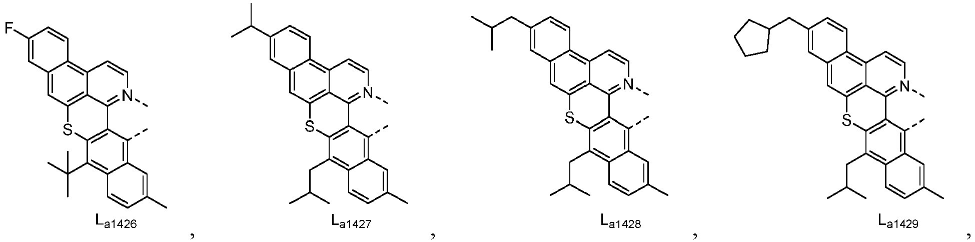 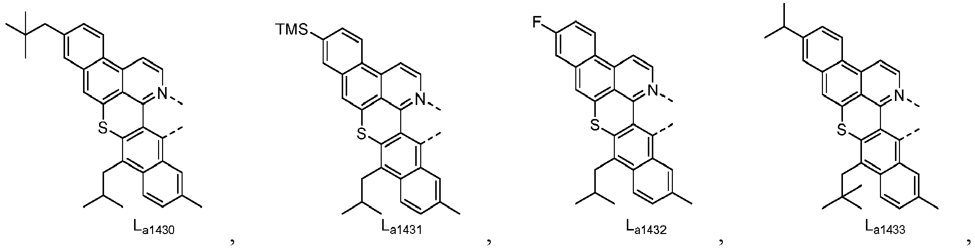 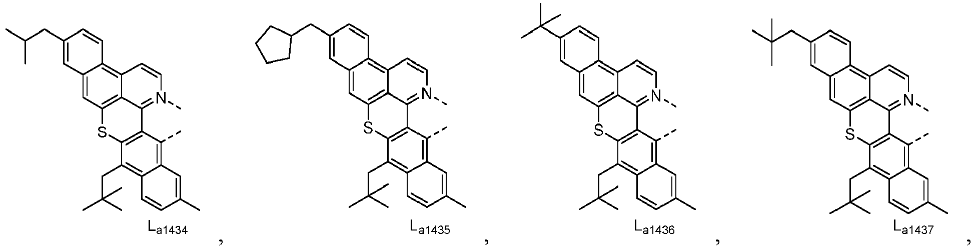 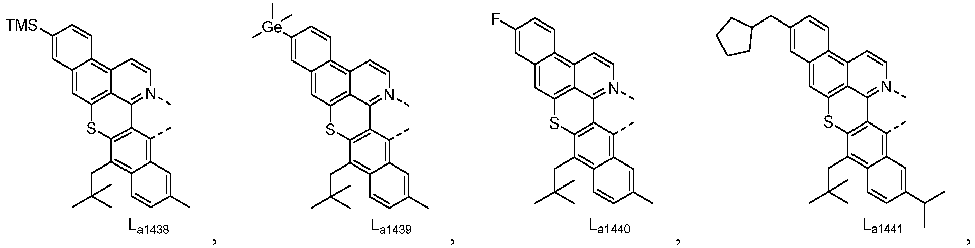 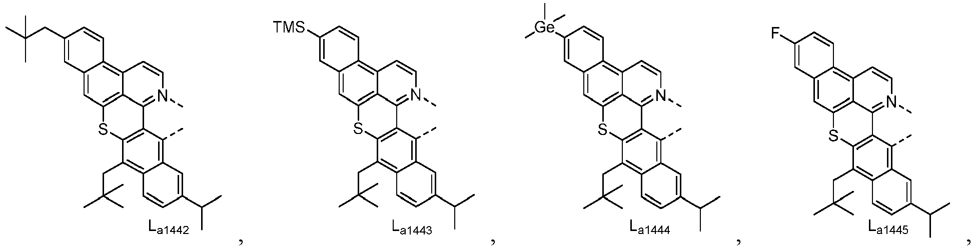 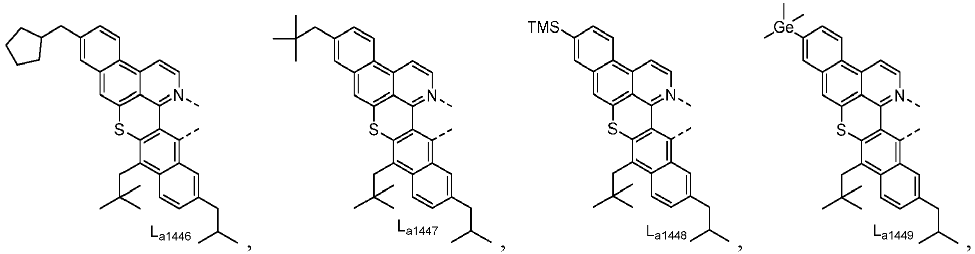 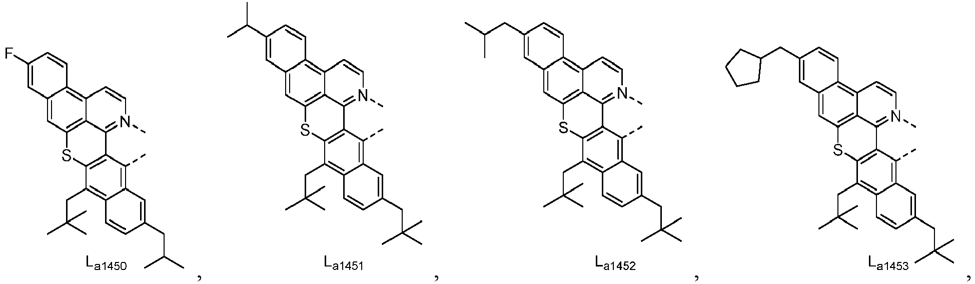 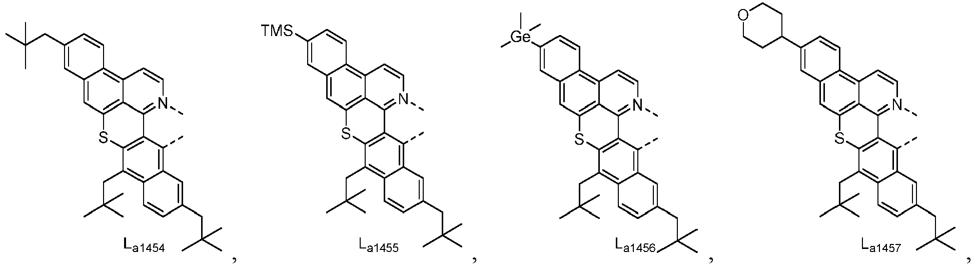 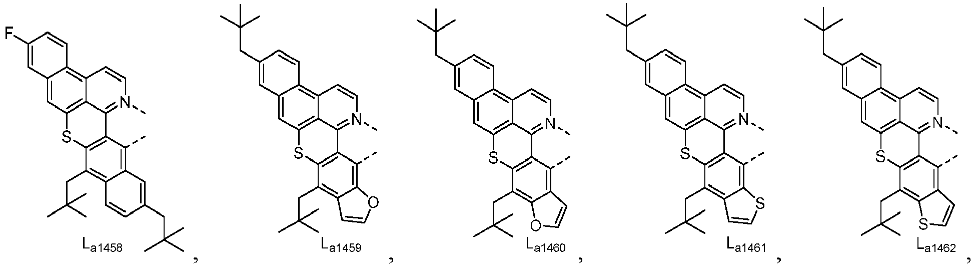 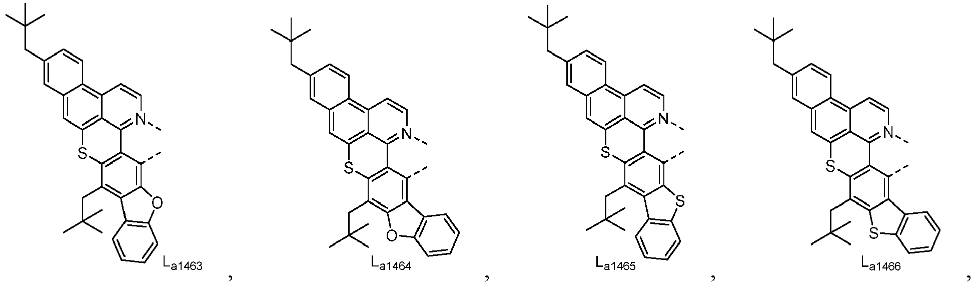 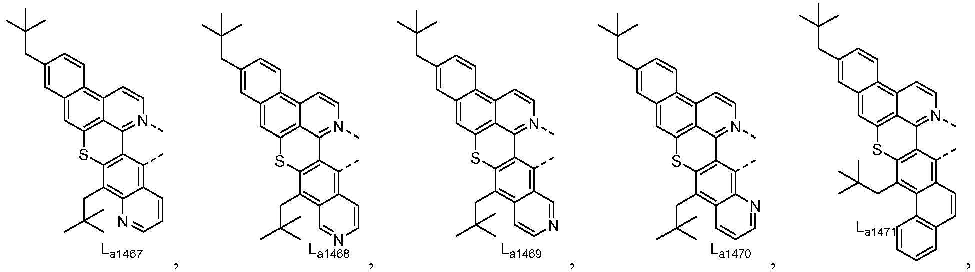 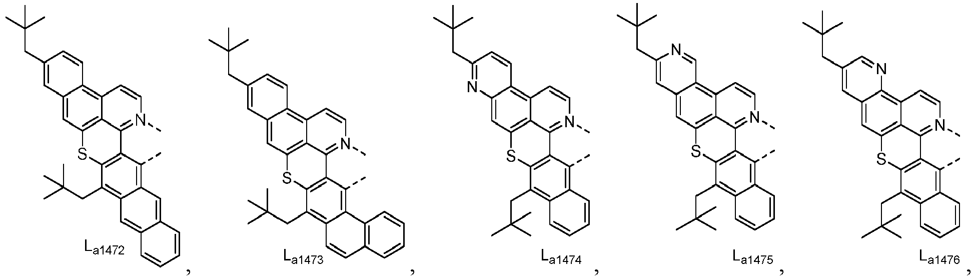 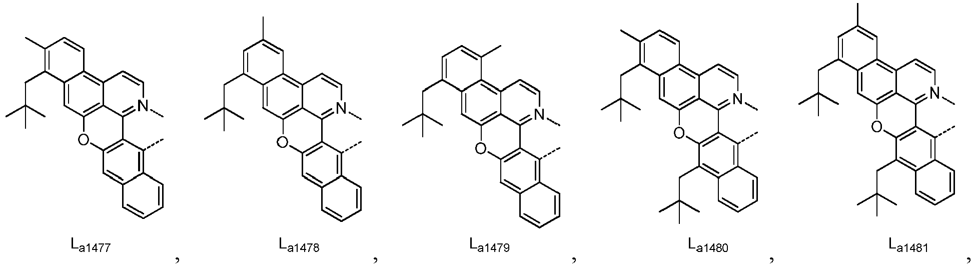 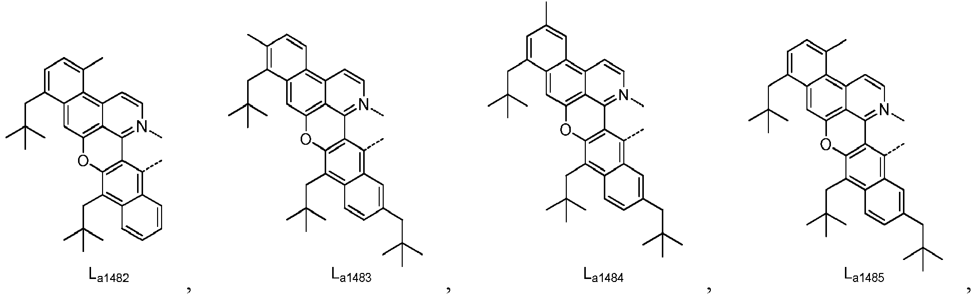 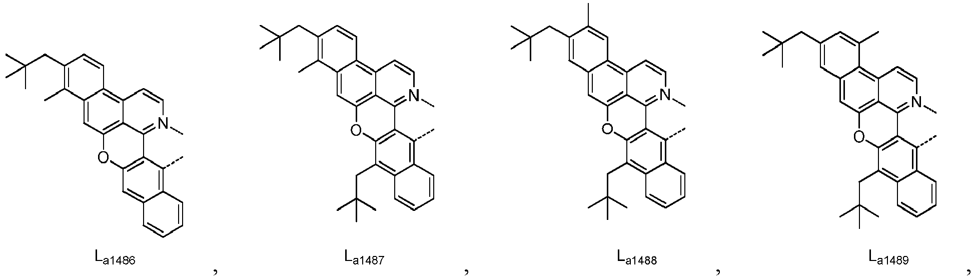 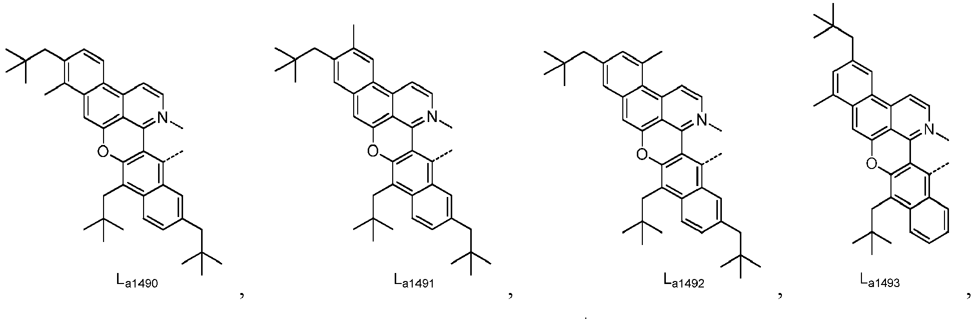 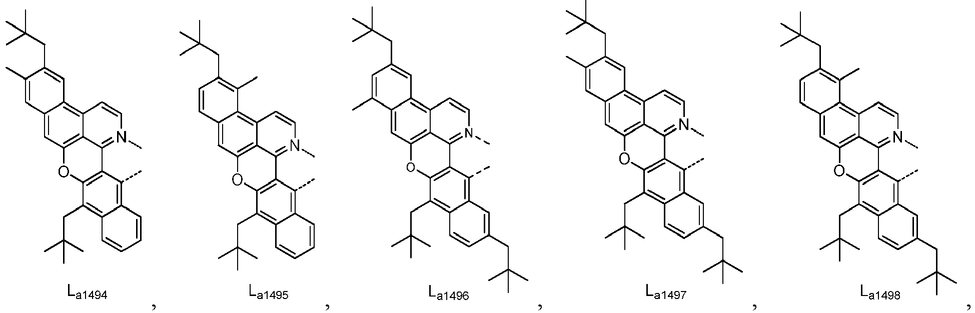 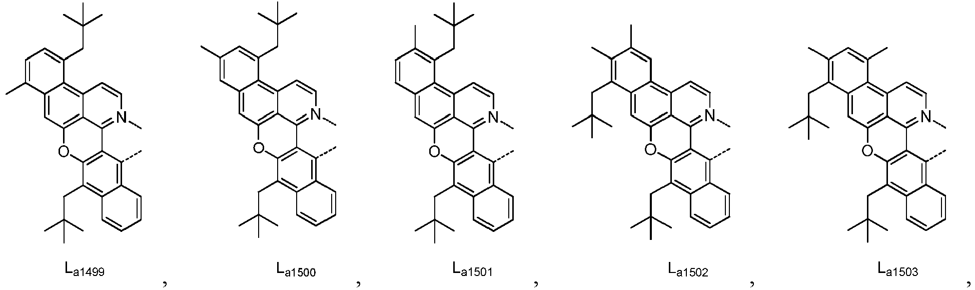 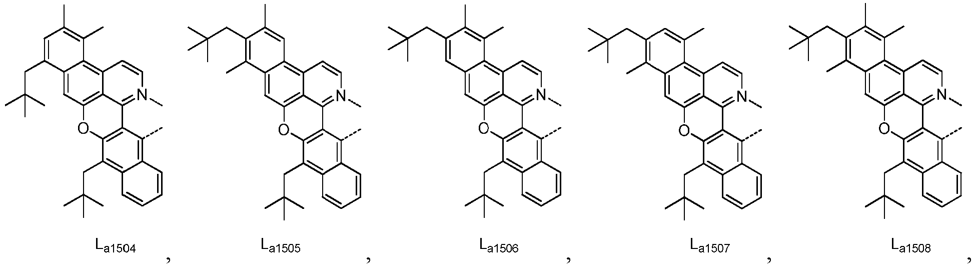 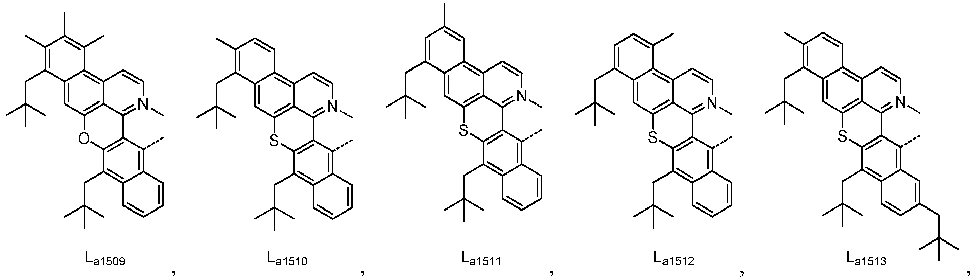 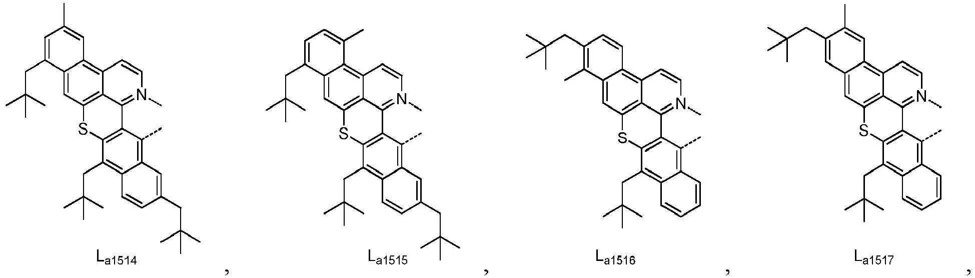 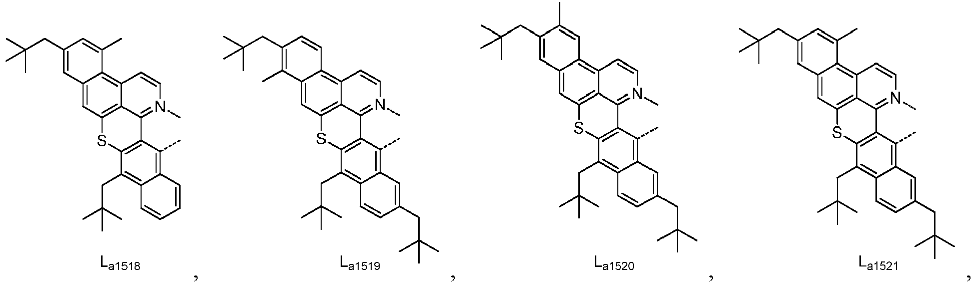 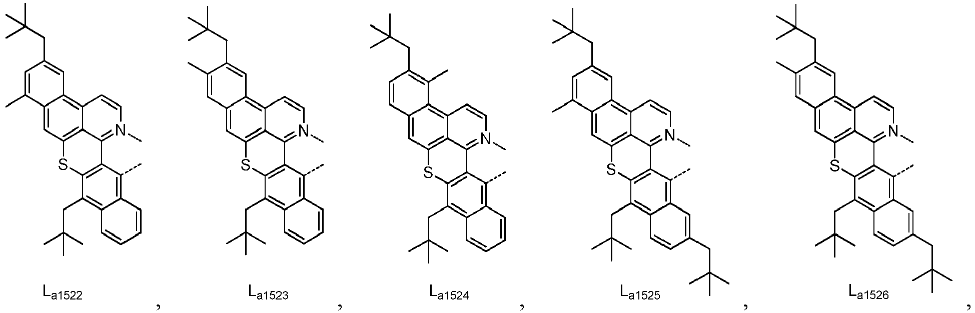 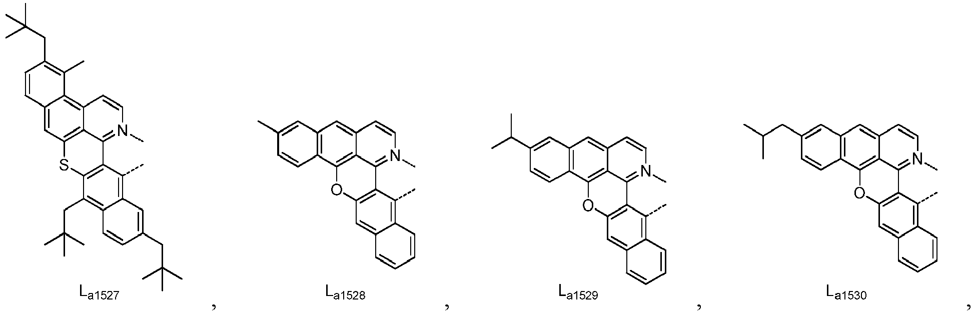 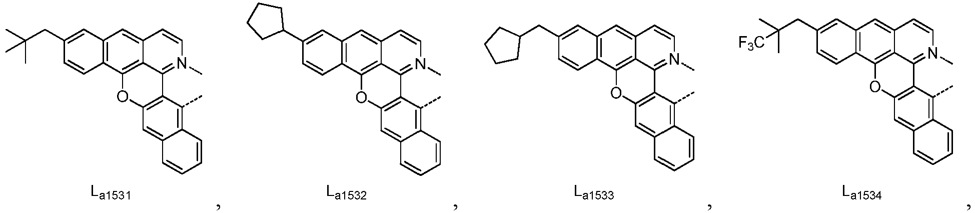 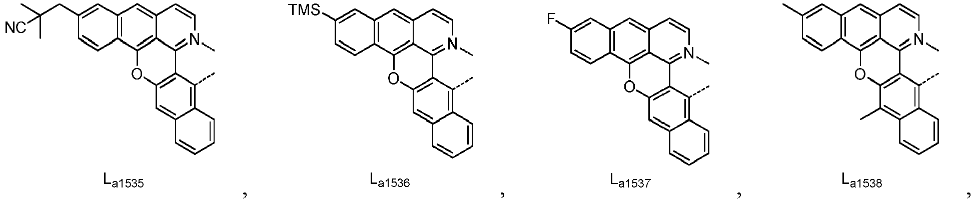 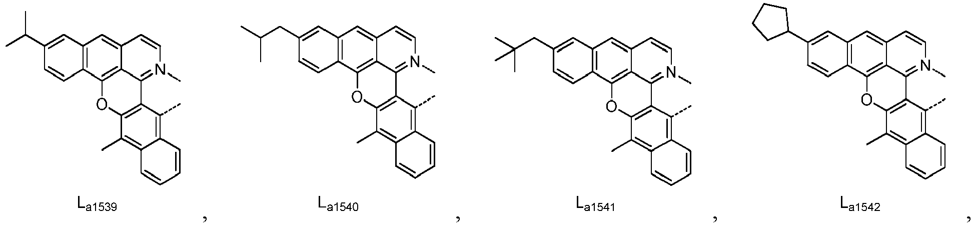 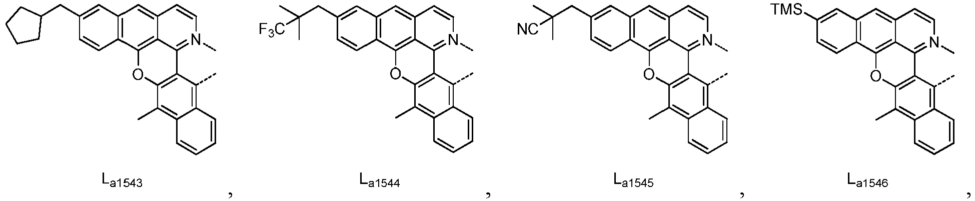 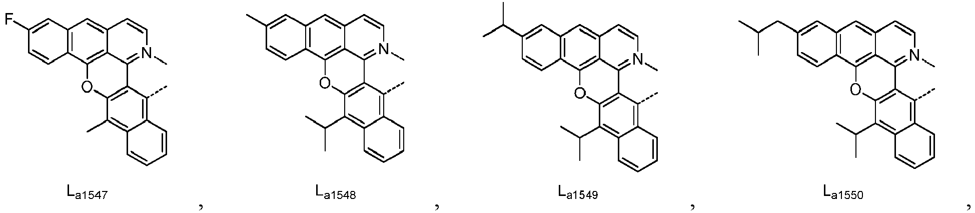 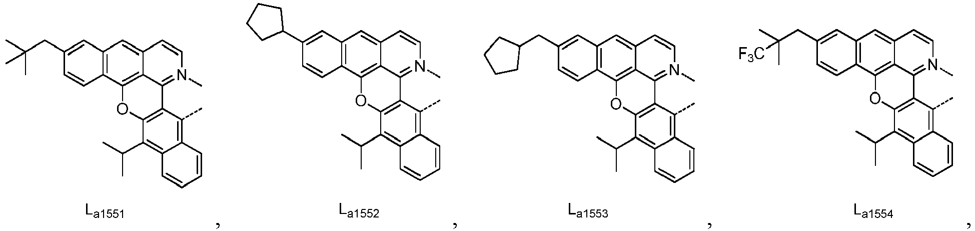 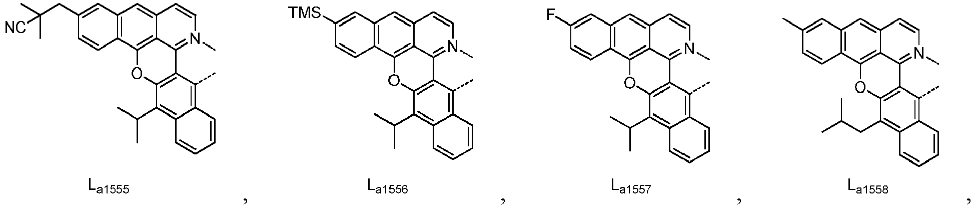 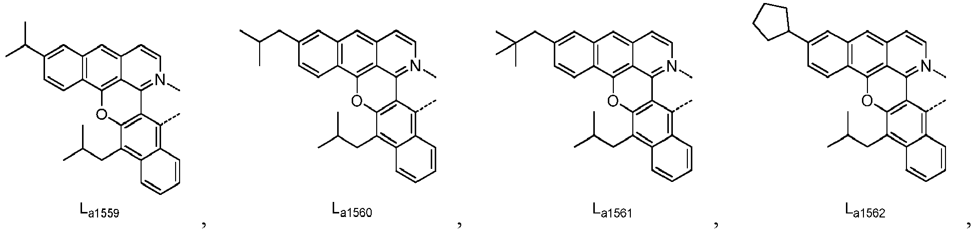 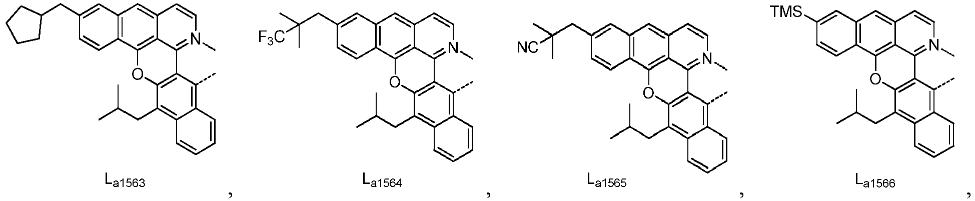 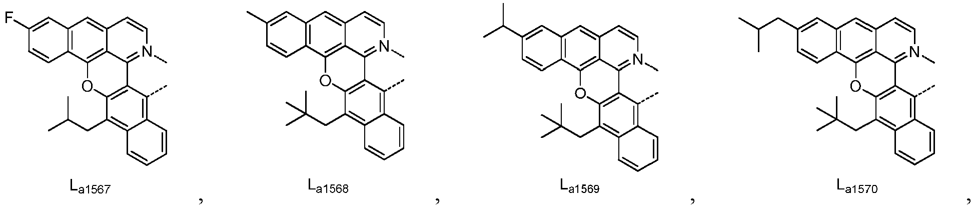 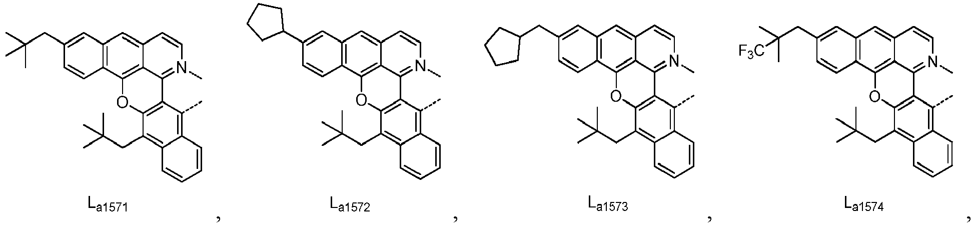 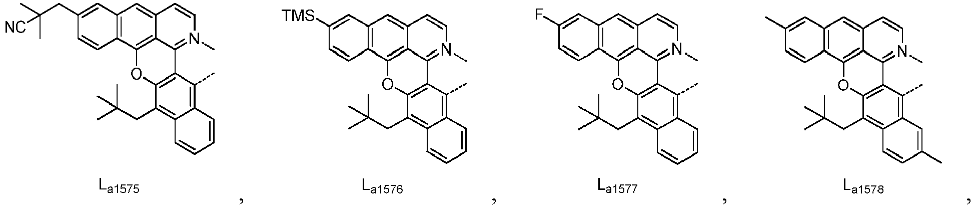 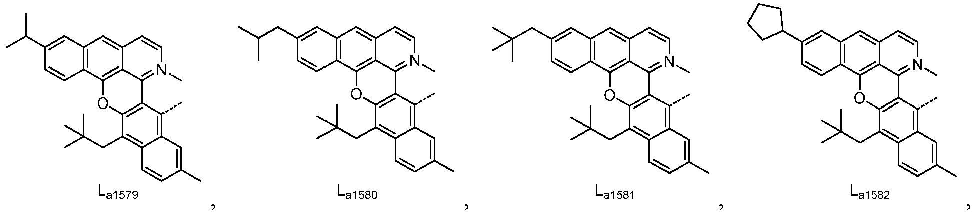 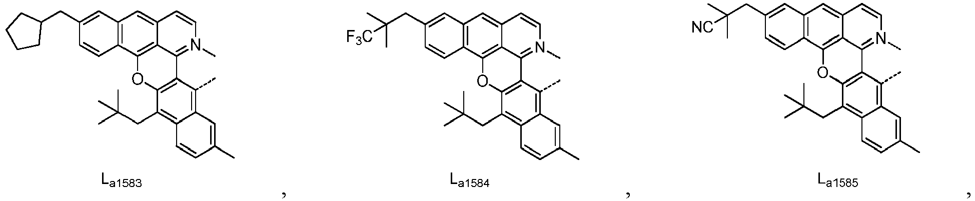 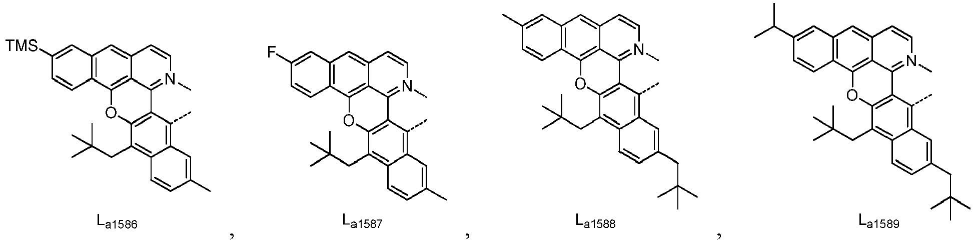 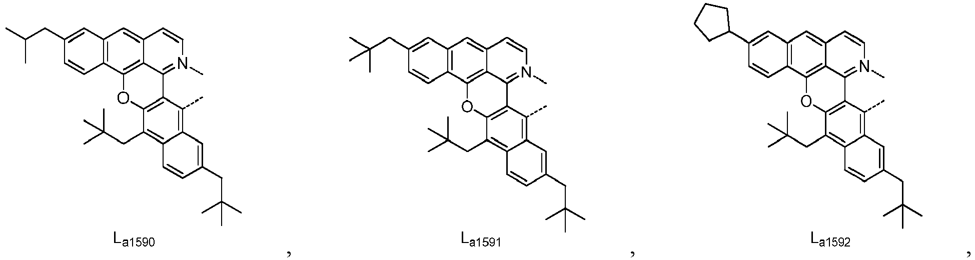 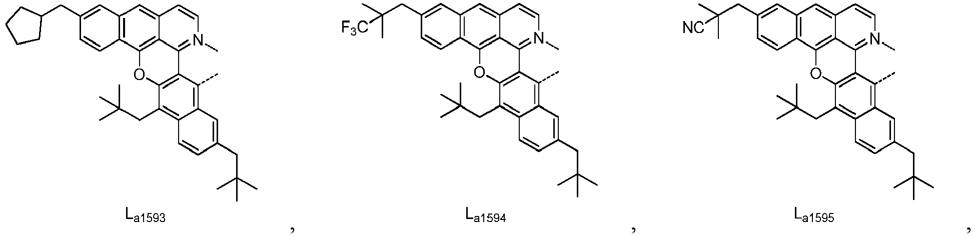 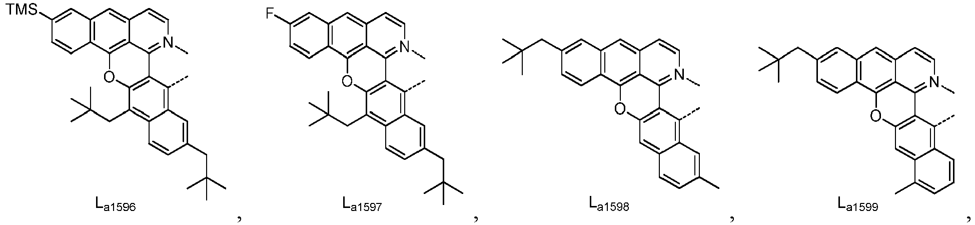 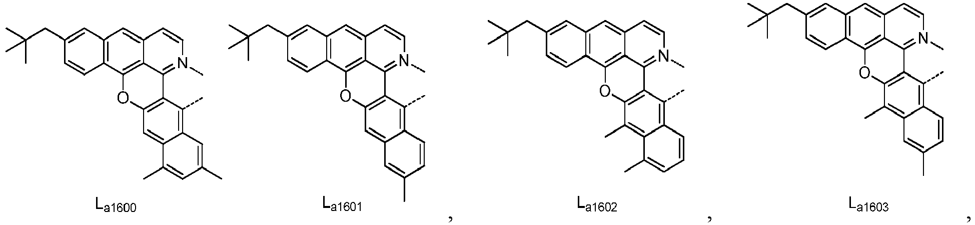 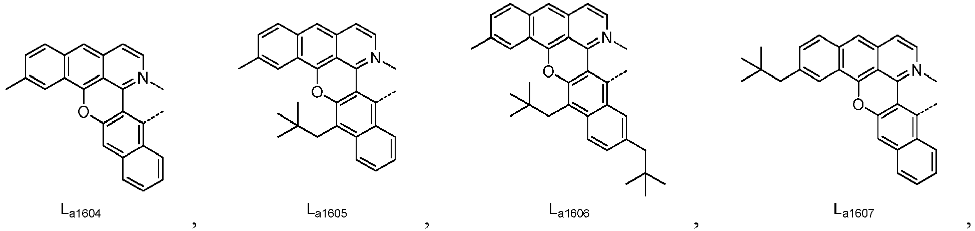 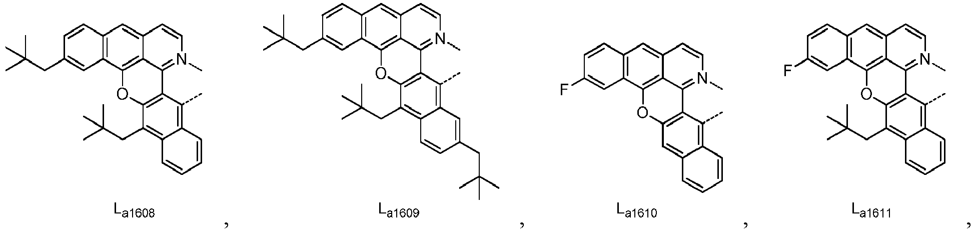 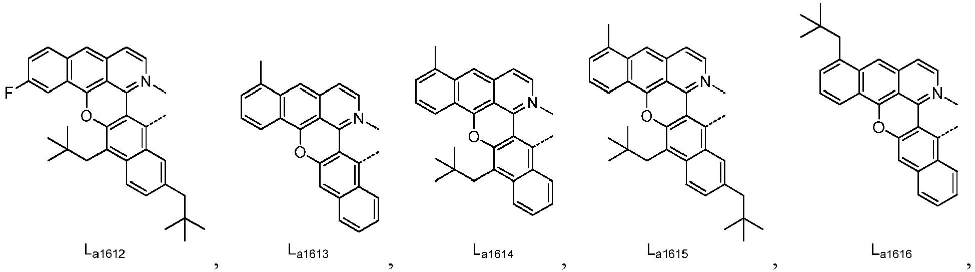 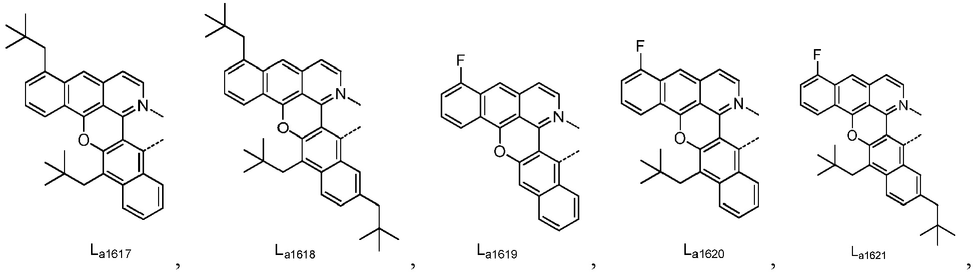 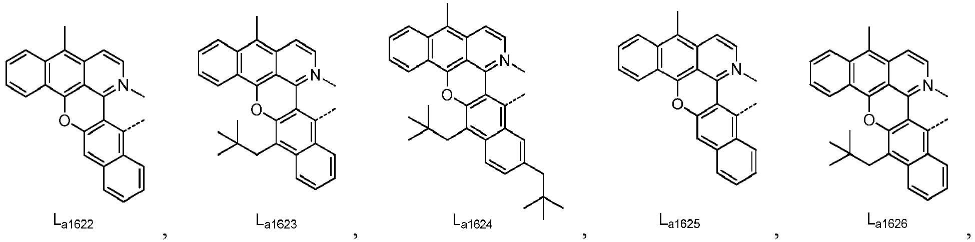 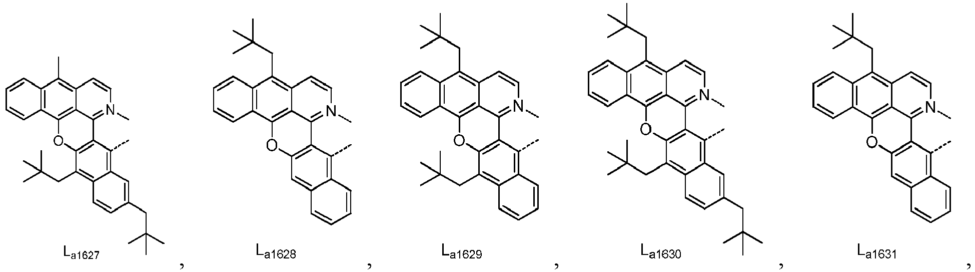 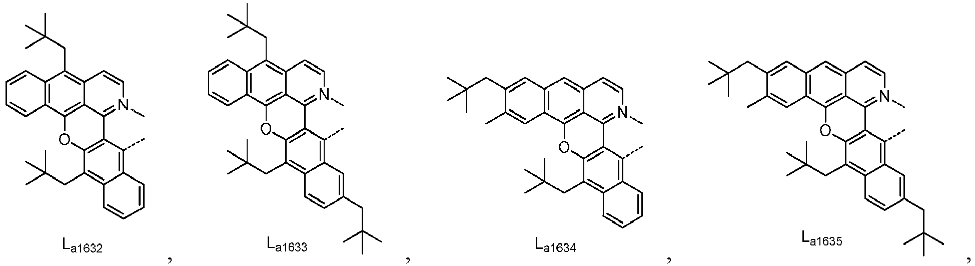 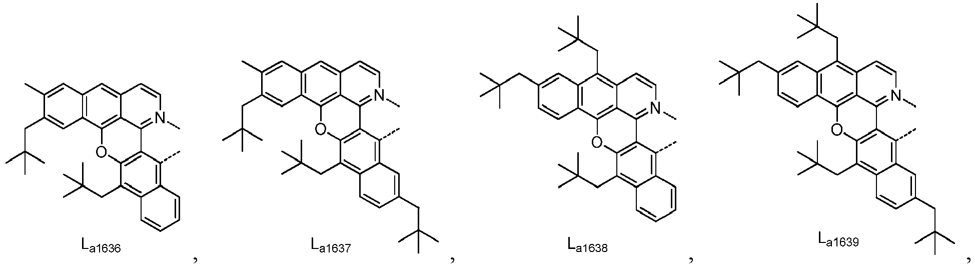 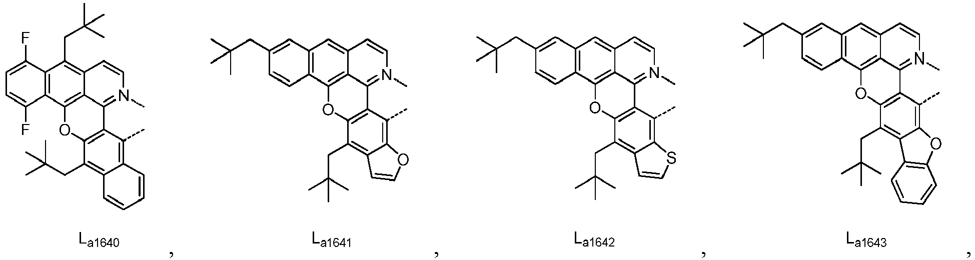 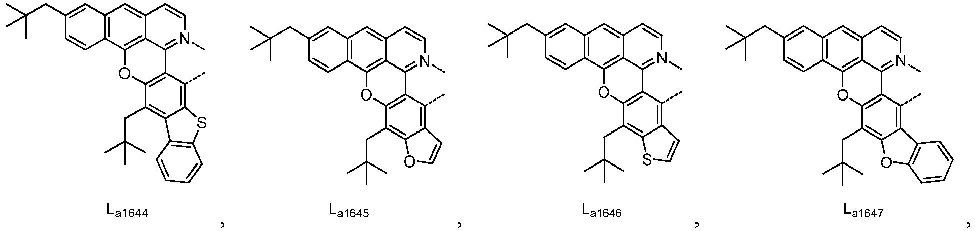 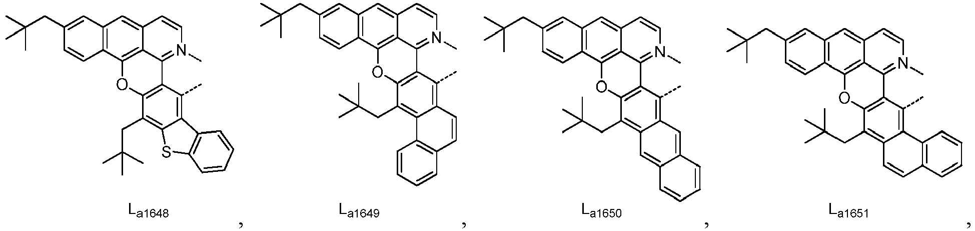 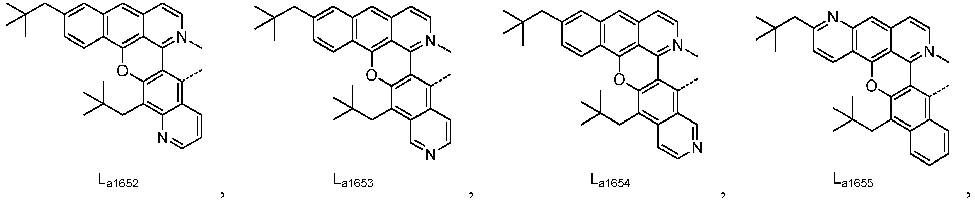 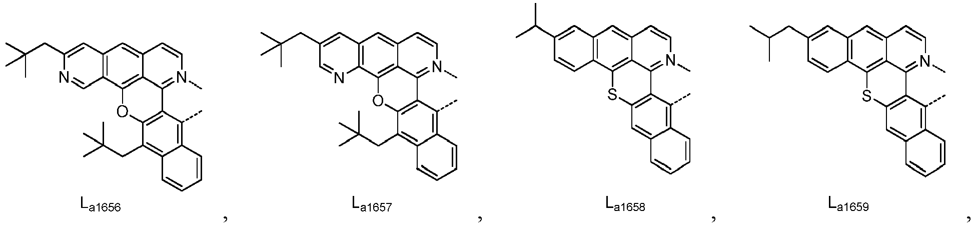 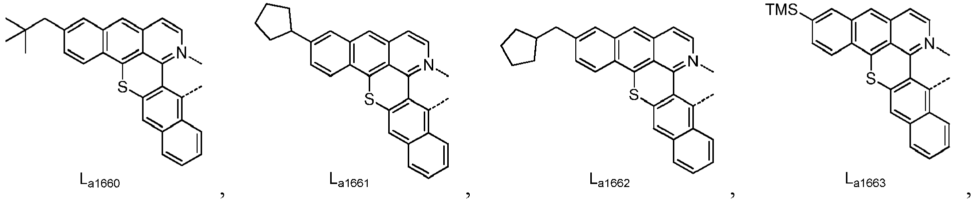 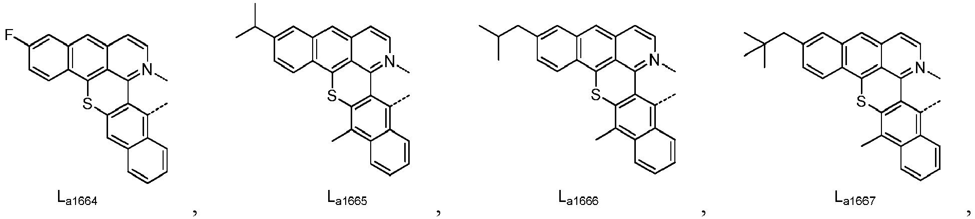 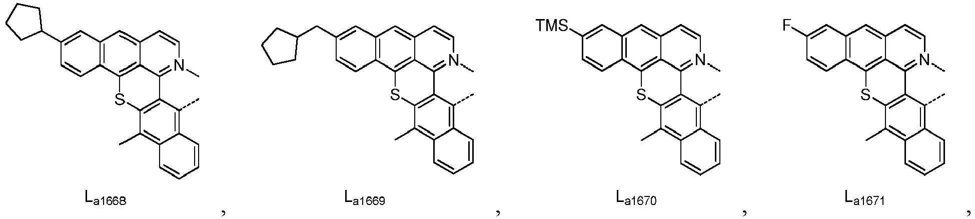 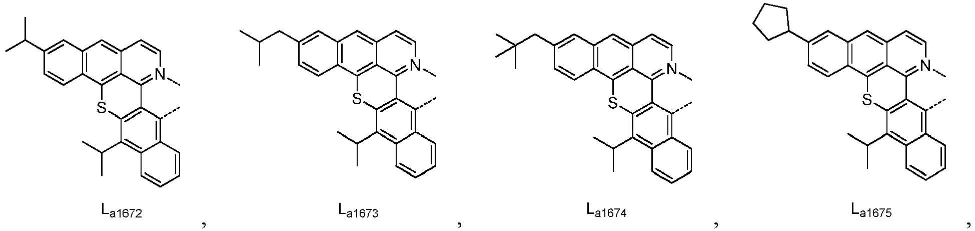 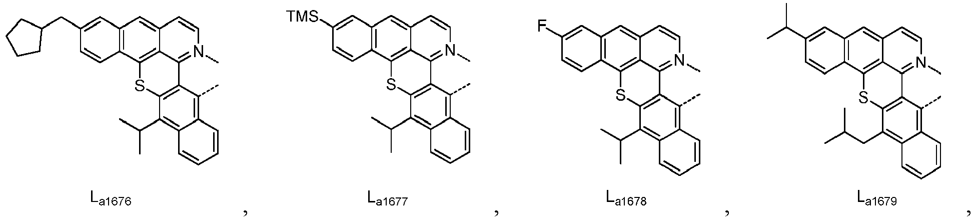 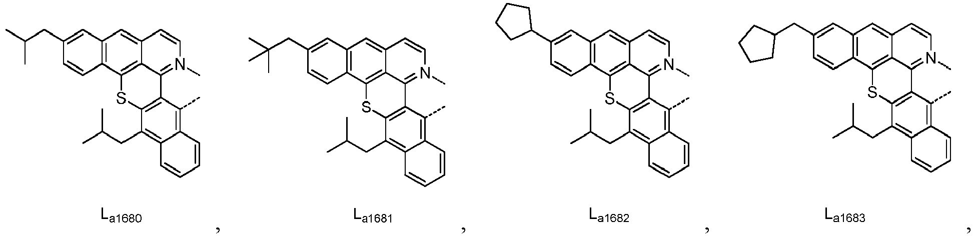 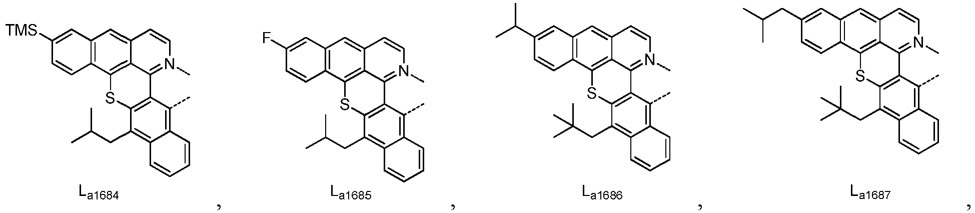 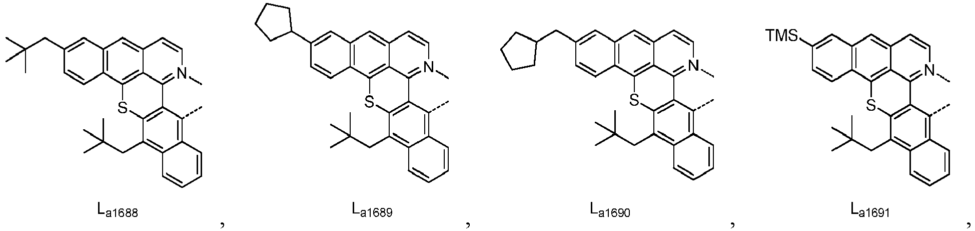 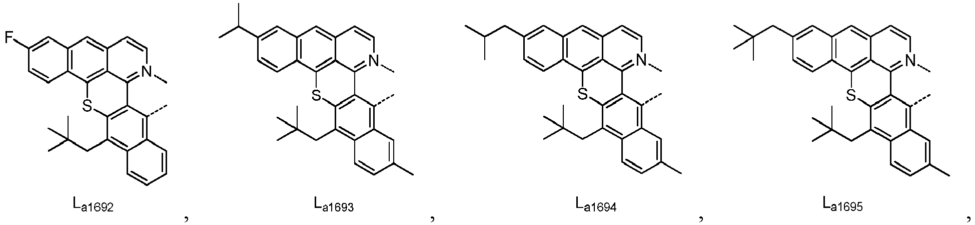 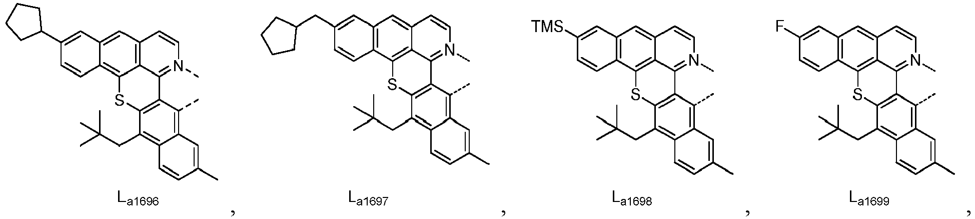 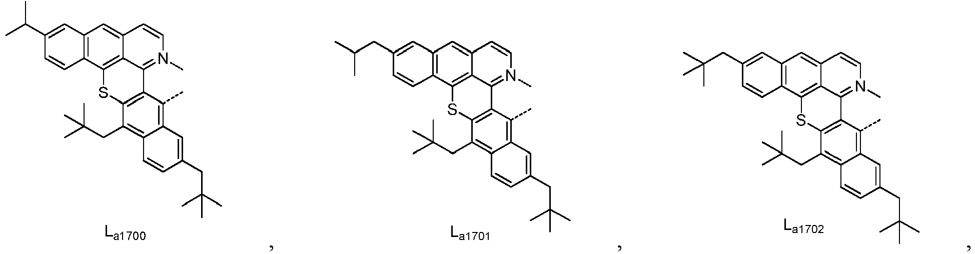 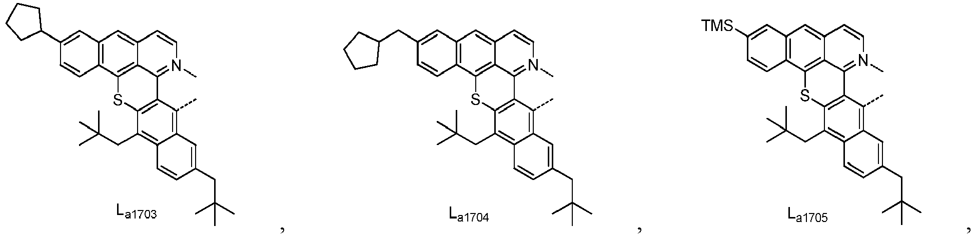 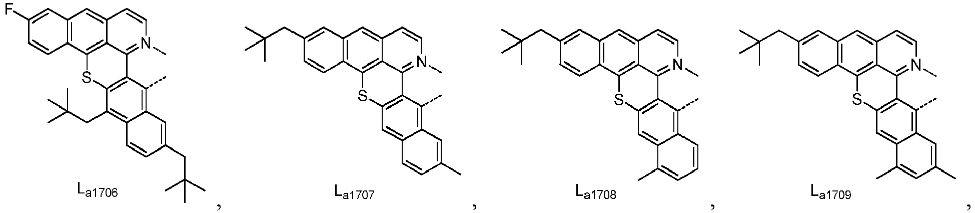 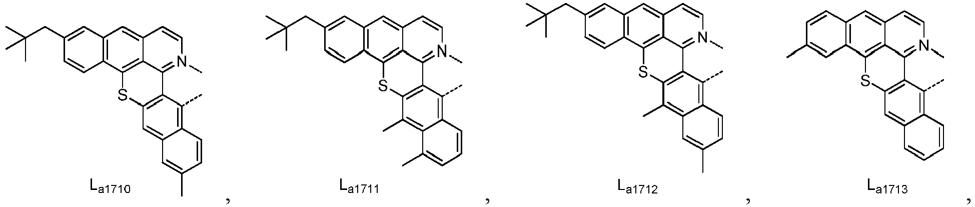 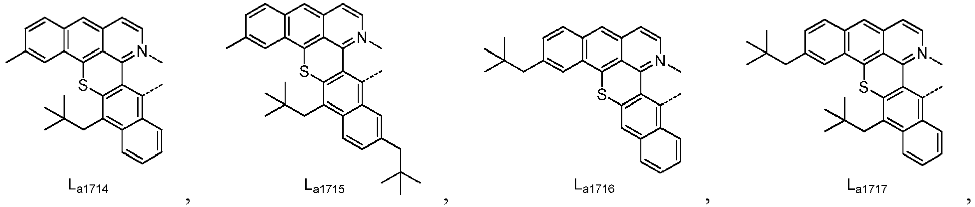 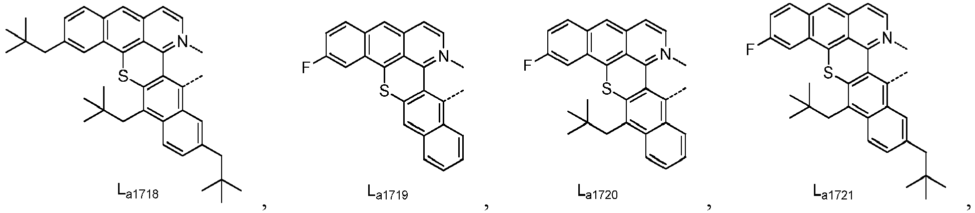 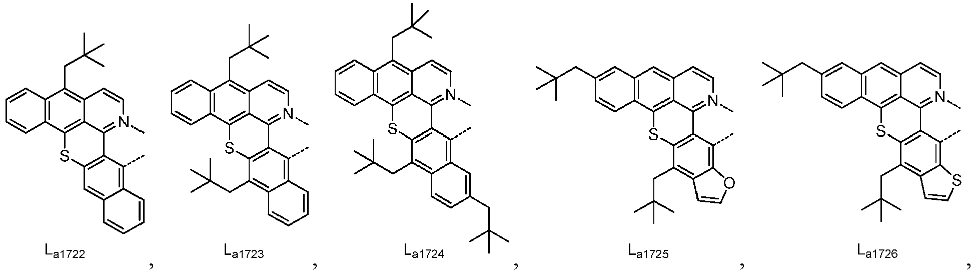 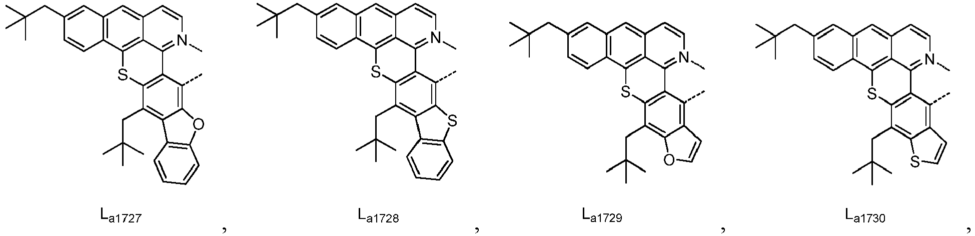 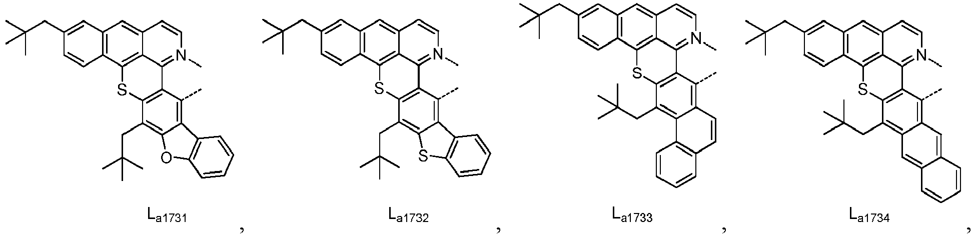 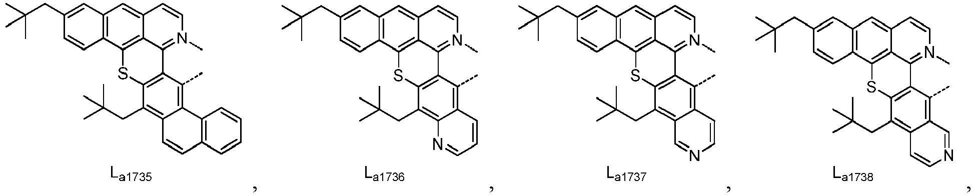 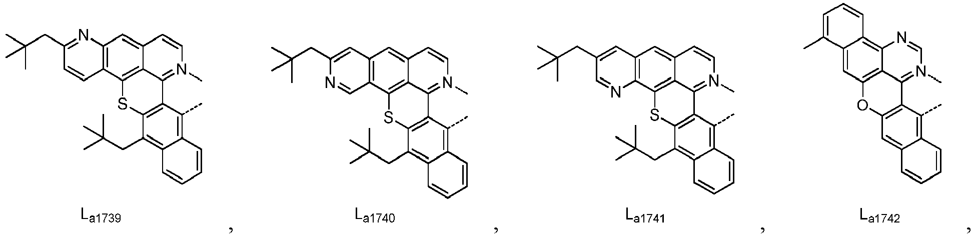 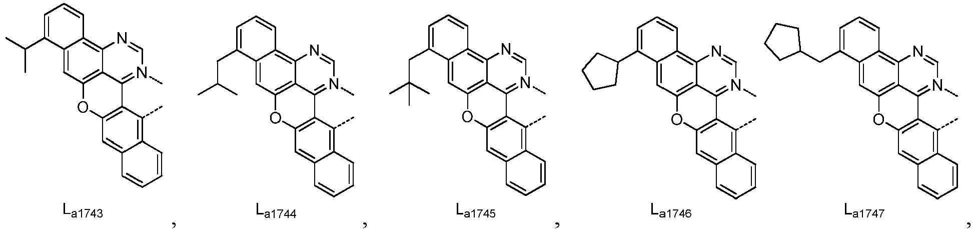 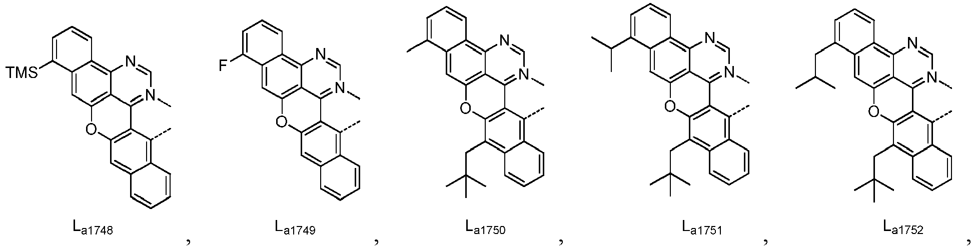 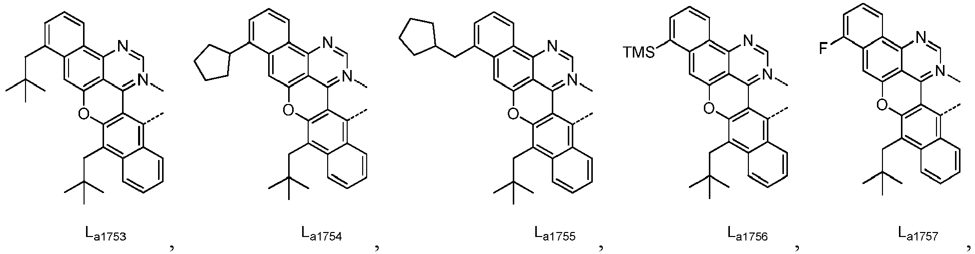 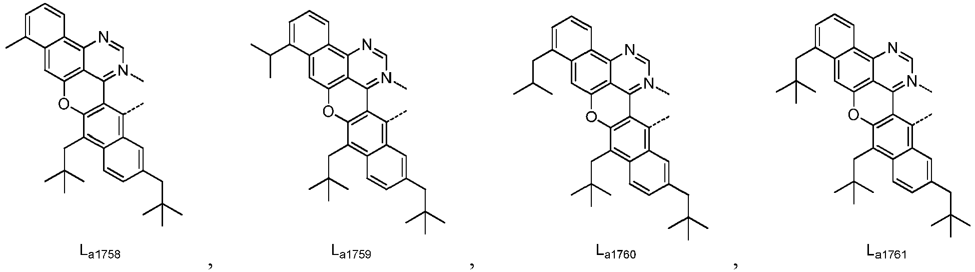 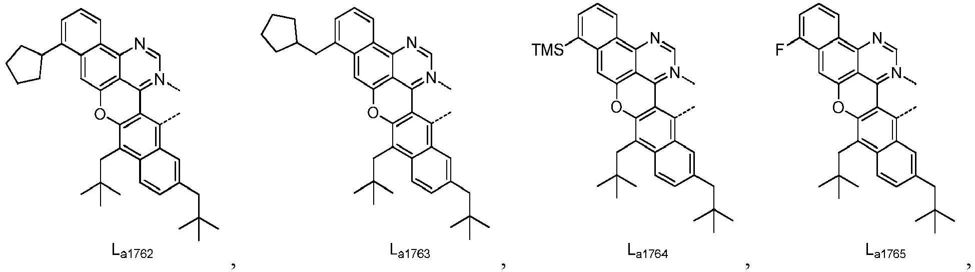 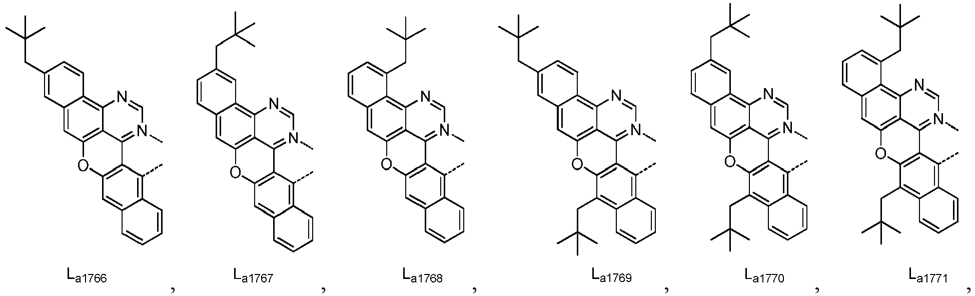 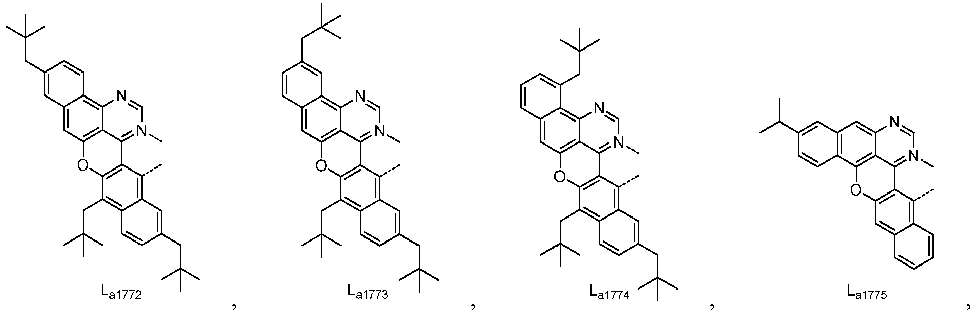 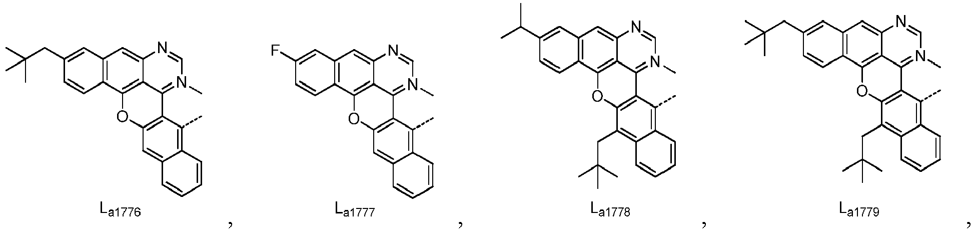 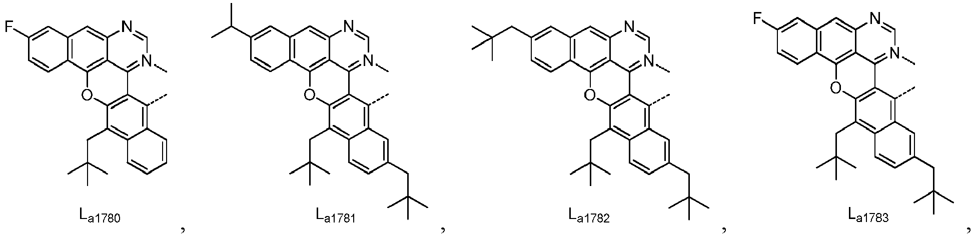 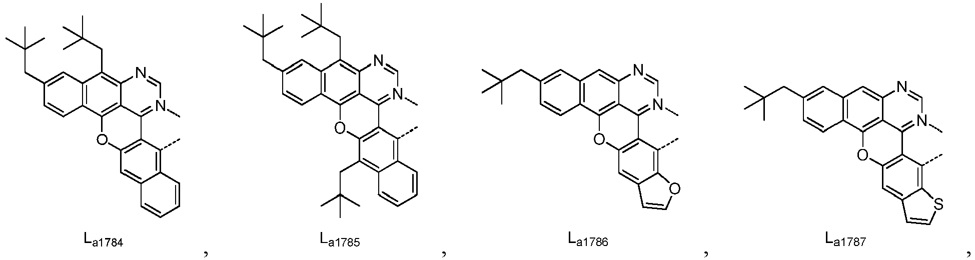 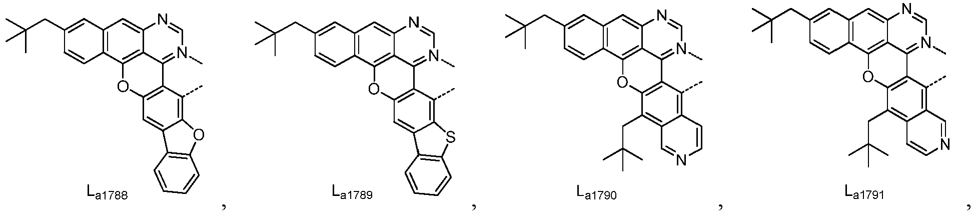 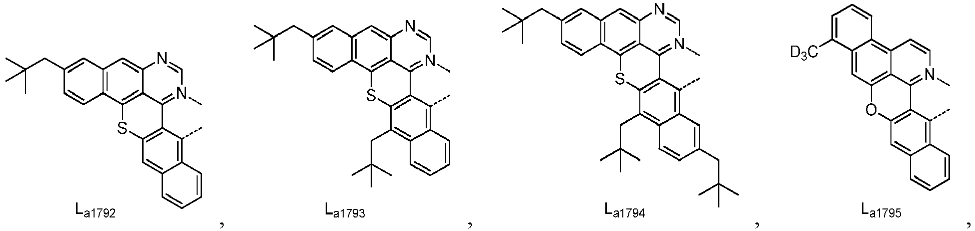 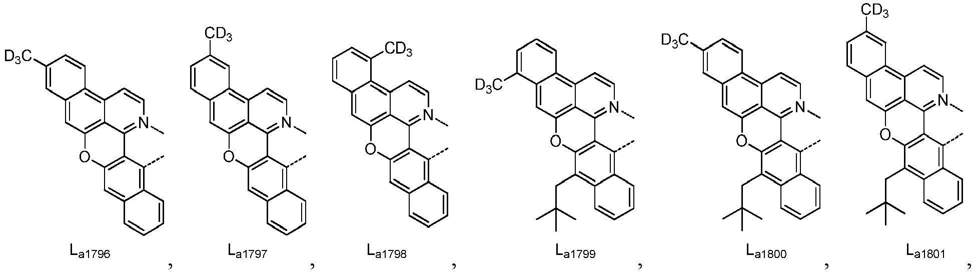 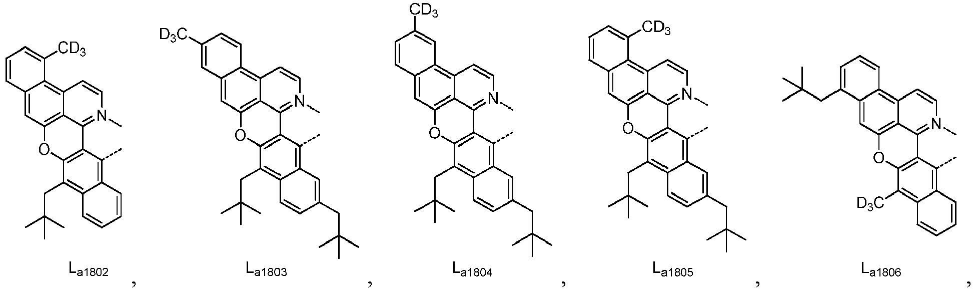 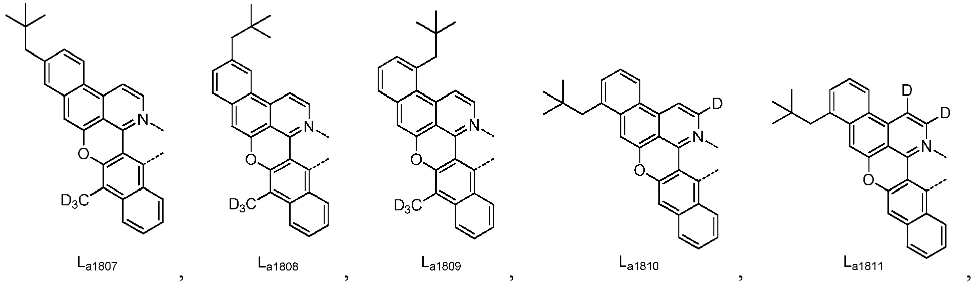 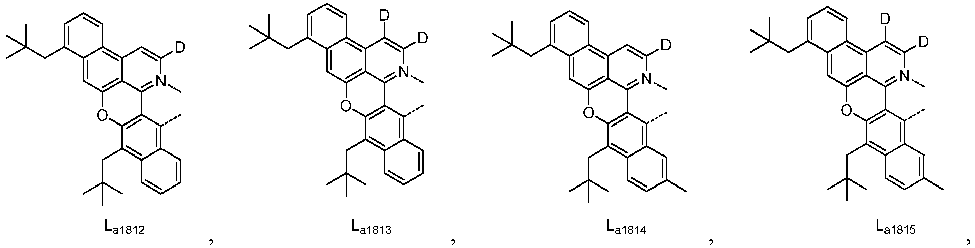 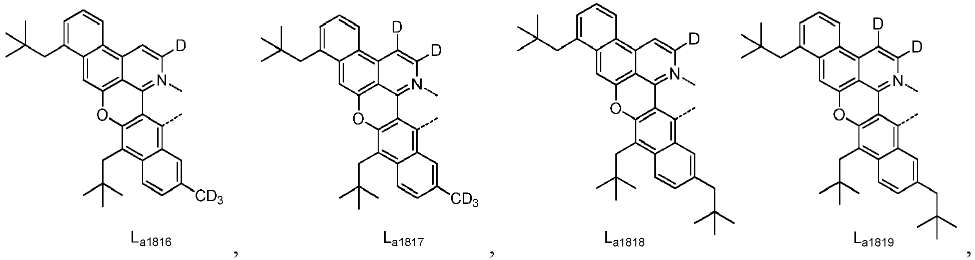 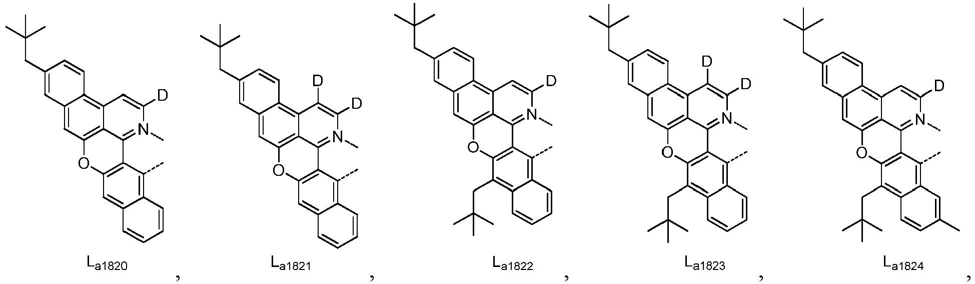 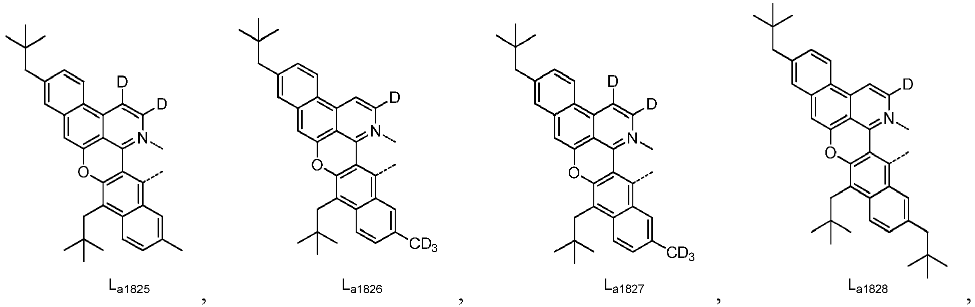 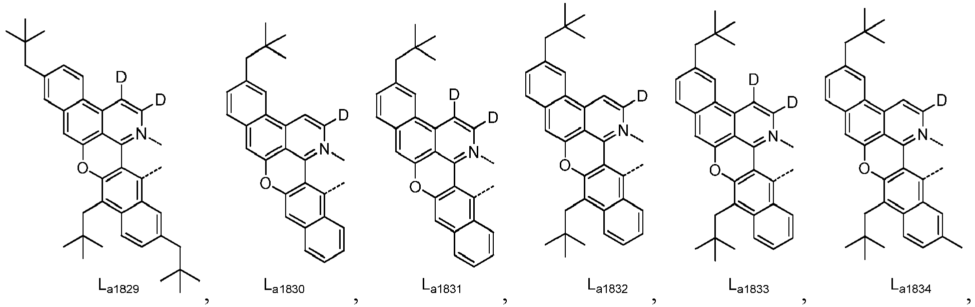 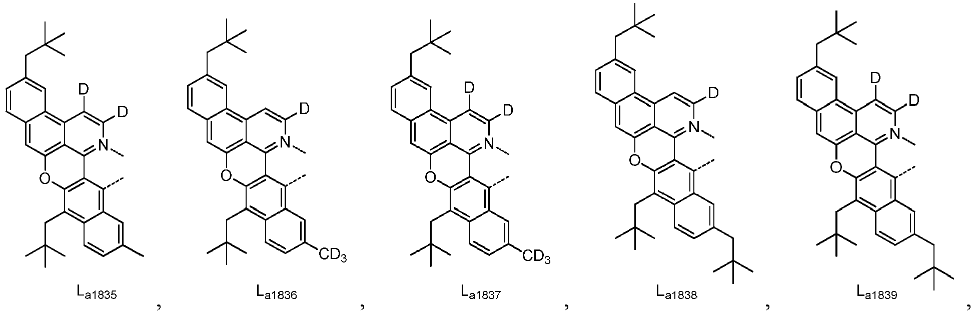 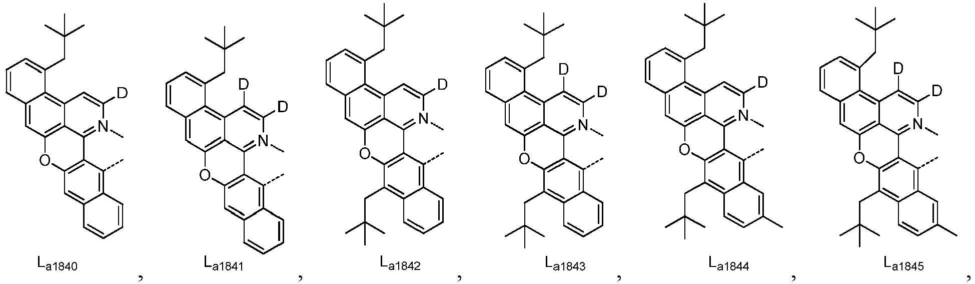 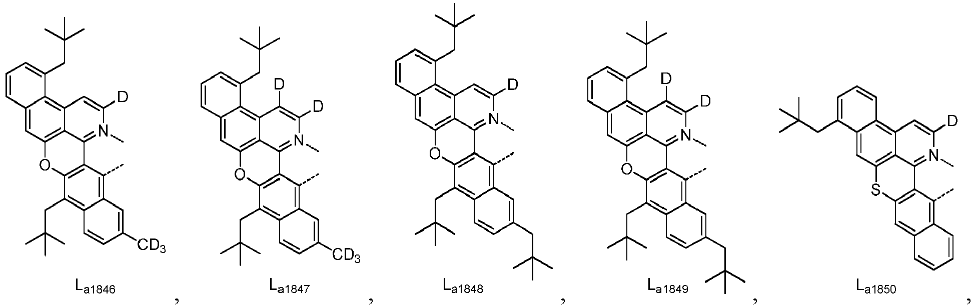 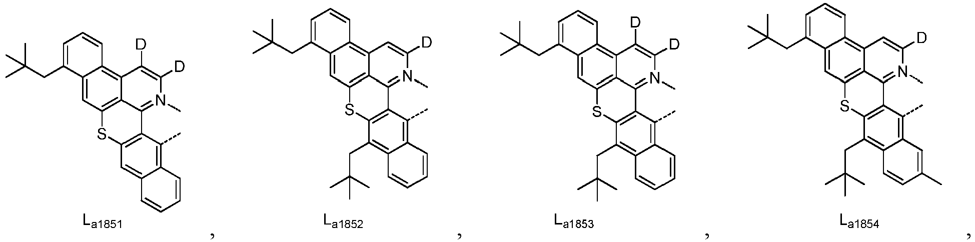 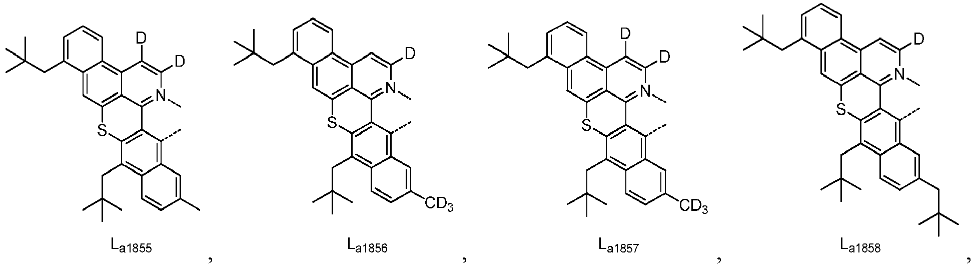 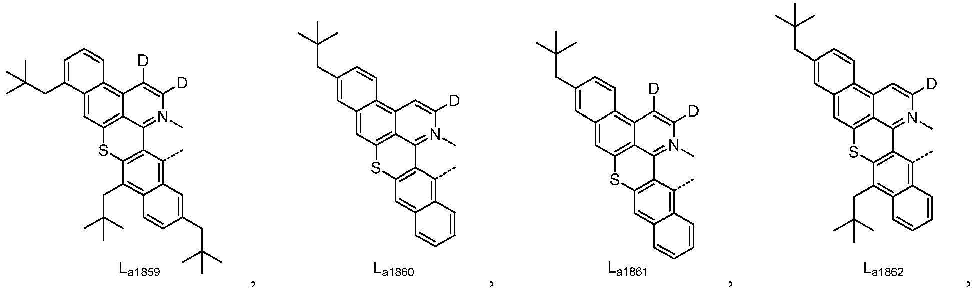 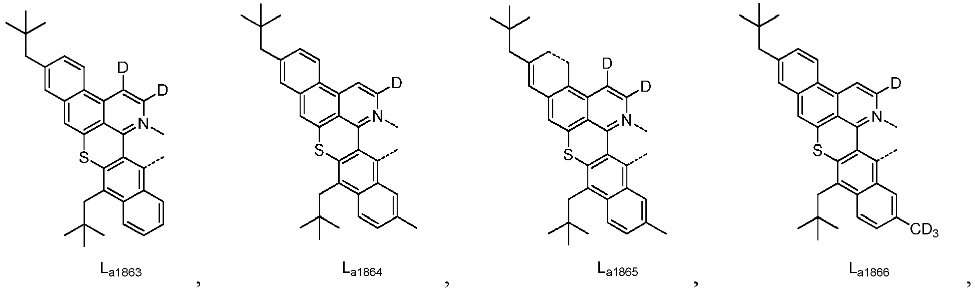 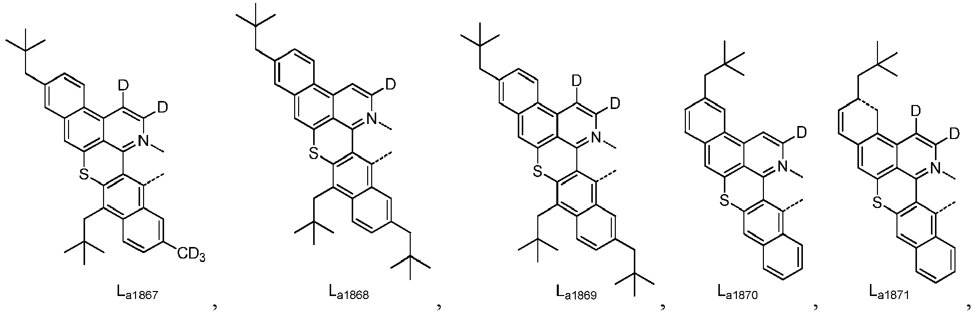 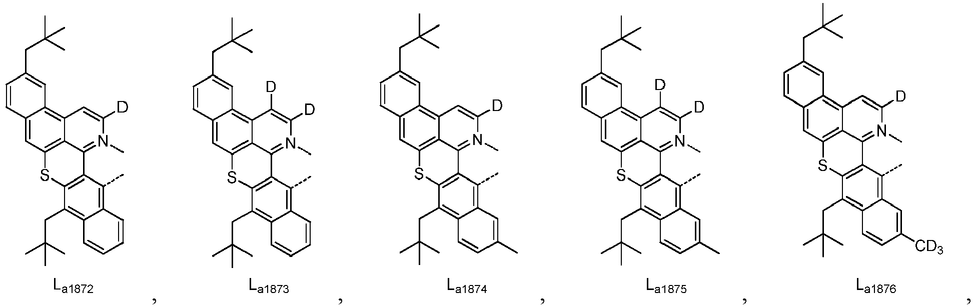 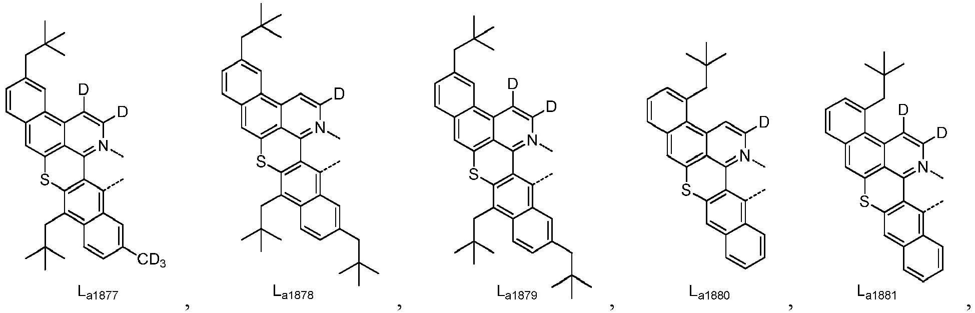 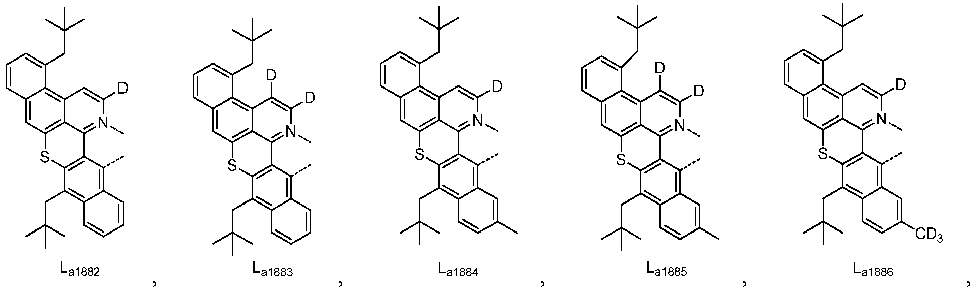 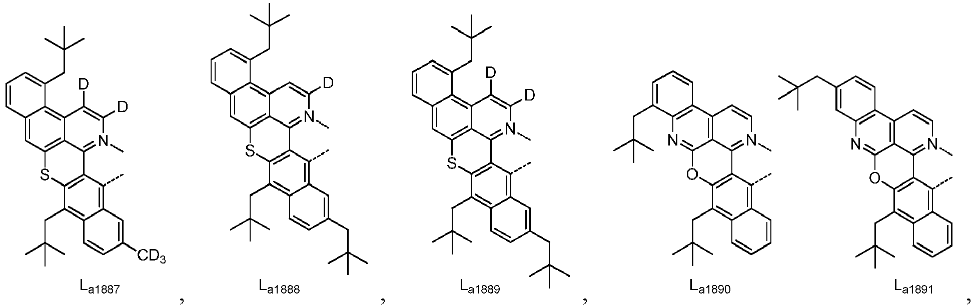 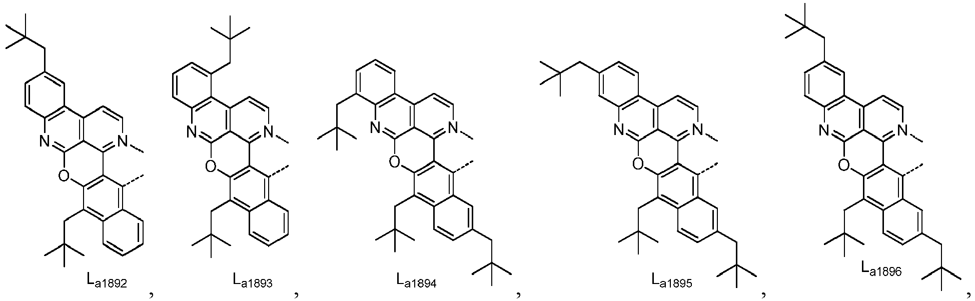 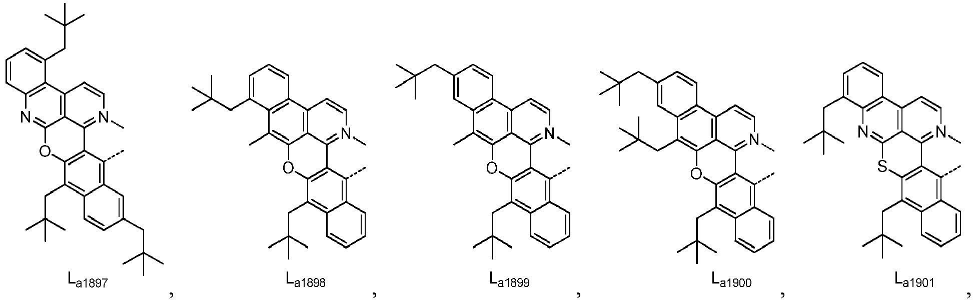 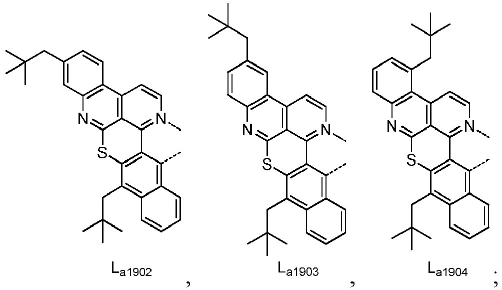
wherein in the above structures, TMS is trimethylsilyl; and
optionally, hydrogens in the structures of Lₐ₁ to Lₐ₁₉₀₄ are partially or fully substituted with deuterium.

11. The metal complex according to any one of claims 1 to 10, wherein the metal complex has a structure of M(Lₐ)ₘ(L_{b})ₙ(L_{c})_{q};
wherein the metal M is selected from a metal with a relative atomic mass greater than 40; preferably, the metal M is selected from Ir, Rh, Re, Os, Pt, Au or Cu; more preferably, the metal M is selected from Ir, Pt or Os;
Lₐ, L_{b} and L_{c} are a first ligand, a second ligand and a third ligand of the complex, respectively; m is 1, 2 or 3, n is 0, 1 or 2, q is 0, 1 or 2, and m+n+q is equal to an oxidation state of the metal M; when m is greater than 1, a plurality of Lₐ are identical or different; when n is 2, two L_{b} are identical or different; when q is 2, two L_{c} are identical or different;
Lₐ, L_{b} and L_{c} are optionally joined to form a multidentate ligand;
L_{b} and L_{c} are, at each occurrence identically or differently, selected from the group consisting of the following structures: 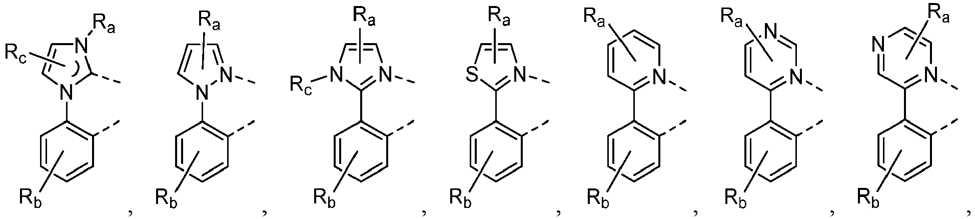 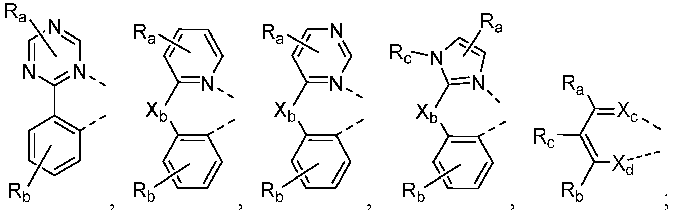
wherein Rₐ, R_{b} and R_{c} represent, at each occurrence identically or differently, monosubstitution, multiple substitutions or non-substitution;
X_{b} is, at each occurrence identically or differently, selected from the group consisting of: O, S, Se, NR_{N1} and CR_{C1}R_{C2};
X_{c} and X_{d} are, at each occurrence identically or differently, selected from the group consisting of: O, S, Se and NR_{N2};
Rₐ, R_{b}, R_{c}, R_{N1}, R_{N2}, R_{C1} and R_{C2} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents Rₐ, R_{b}, R_{c}, R_{N1}, R_{N2}, R_{C1} and R_{C2} are optionally joined to form a ring.

12. The metal complex according to claim 11, wherein the metal complex has a general formula of Ir(Lₐ)ₘ(L_{b})₃₋ₘ and a structure represented by Formula 1-1 or Formula 1-2: 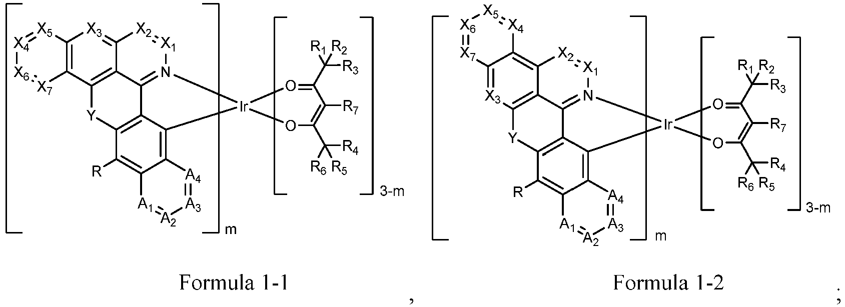 wherein
m is 1 or 2;
X₁ and X₂ are, at each occurrence identically or differently, selected from CRₓ or N; X₃ is, at each occurrence identically or differently, selected from CRi or N; A₁ to A₄ are, at each occurrence identically or differently, selected from CRᵢᵢ or N; X₄ to X₇ are, at each occurrence identically or differently, selected from CH, CRᵢᵢᵢ or N, and at least one of X₄ to X₇ is selected from CRᵢᵢᵢ;
Y is selected from SiR_{y}R_{y}, O, S or Se; when two R_{y} are present at the same time, the two R_{y} are identical or different;
R, Rₓ, R_{y}, Rᵢ, Rᵢᵢ, R₁, R₂, R₃, R₄, R₅, R₆ and R₇ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Rᵢᵢᵢ is, at each occurrence identically or differently, selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents R, Rₓ, R_{y}, Rᵢ, Rᵢᵢ and Rᵢᵢᵢ are optionally joined to form a ring;
adjacent substituents R₁, R₂, R₃, R₄, R₅, R₆ and R₇ are optionally joined to form a ring;
preferably, at least one or two of R₁ to R₃ is(are), at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof; and/or at least one or two of R₄ to R₆ is(are), at each occurrence identically or differently, selected from substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms or a combination thereof; and
more preferably, at least two of R₁ to R₃ are, at each occurrence identically or differently, selected from substituted or unsubstituted alkyl having 2 to 20 carbon atoms, substituted or unsubstituted cycloalkyl having 3 to 20 ring carbon atoms, substituted or unsubstituted heteroalkyl having 2 to 20 carbon atoms or a combination thereof; and/or at least two of R₄ to R₆ are, at each occurrence identically or differently, selected from substituted or unsubstituted alkyl having 2 to 20 carbon atoms, substituted or unsubstituted cycloalkyl having 3 to 20 ring carbon atoms, substituted or unsubstituted heteroalkyl having 2 to 20 carbon atoms or a combination thereof.

13. The metal complex according to any one of claims 10 to 11, wherein L_{b} is, at each occurrence identically or differently, selected from the group consisting of the following structures: 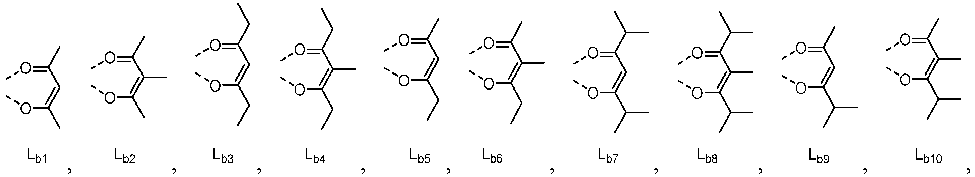 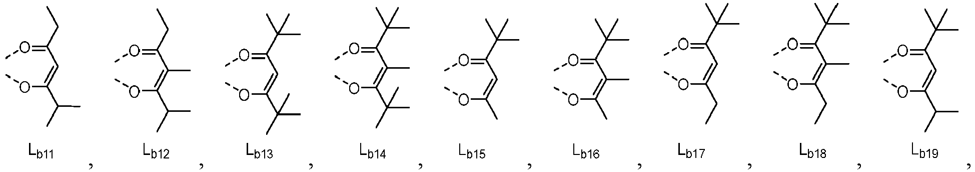 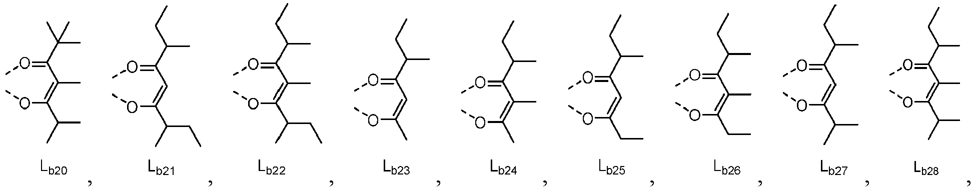 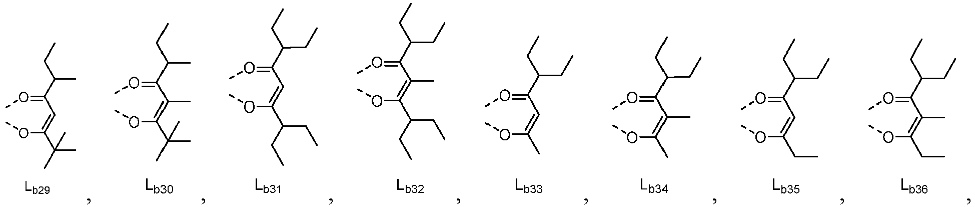 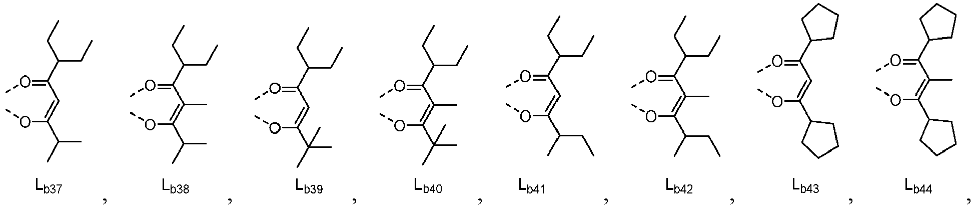 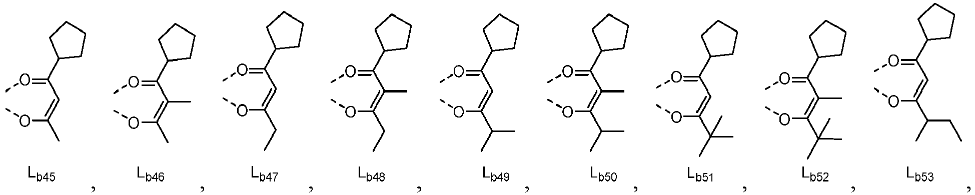 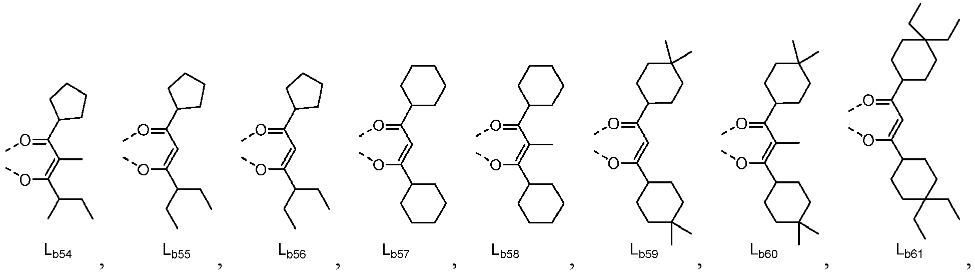 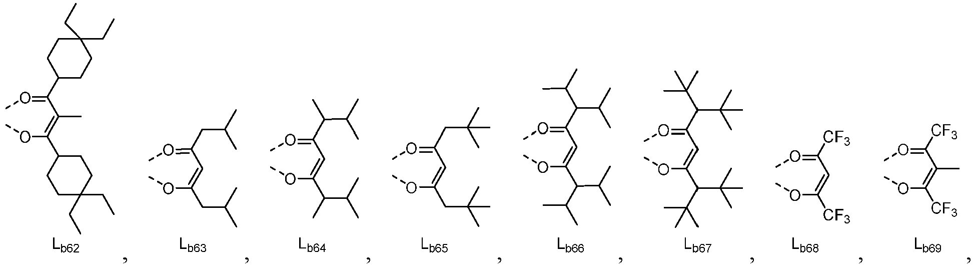 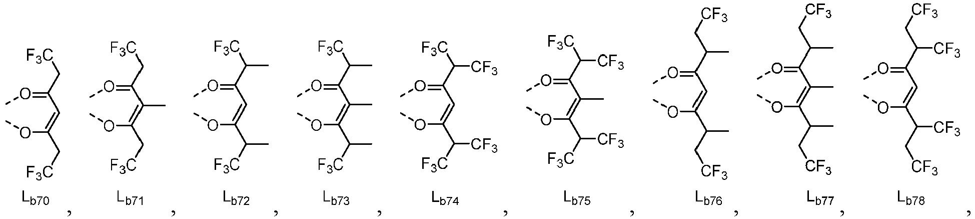 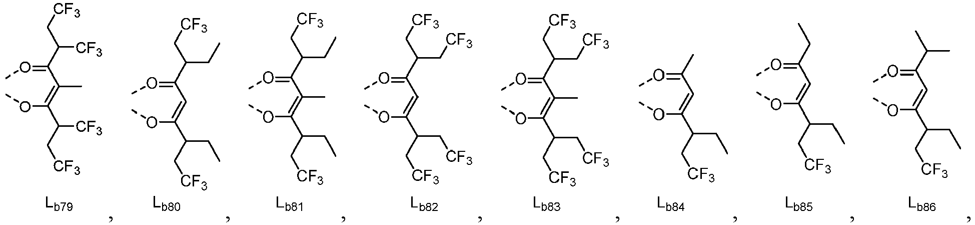 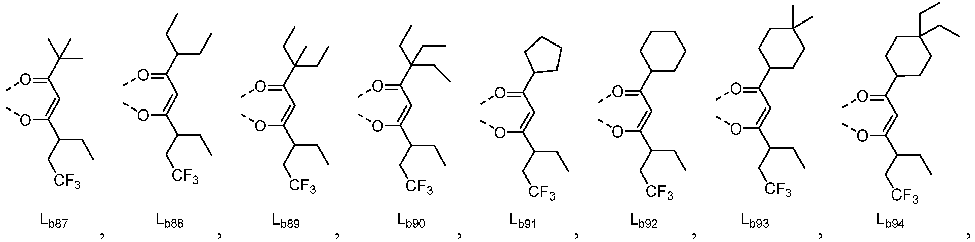 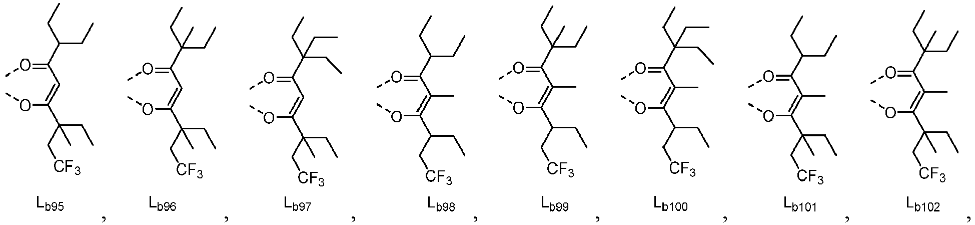 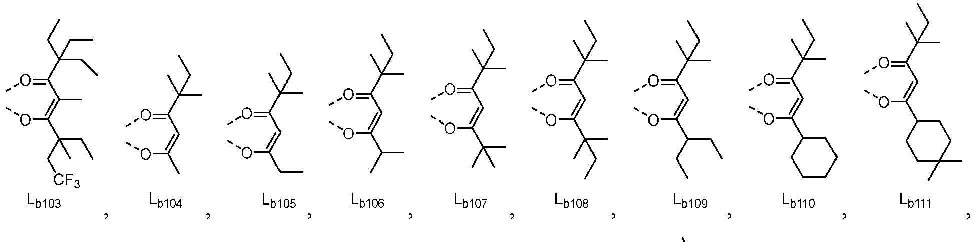 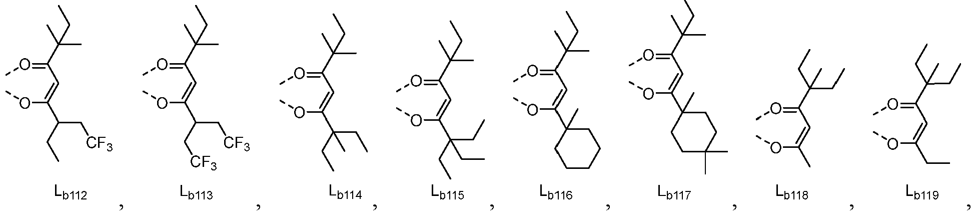 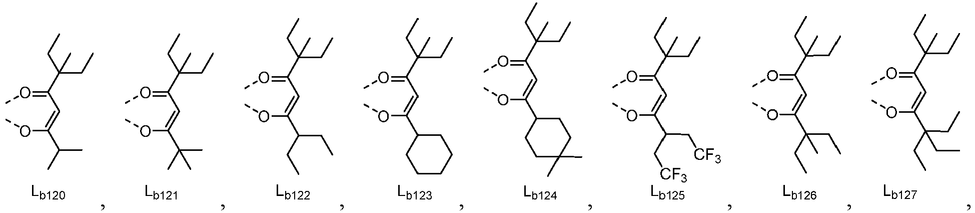 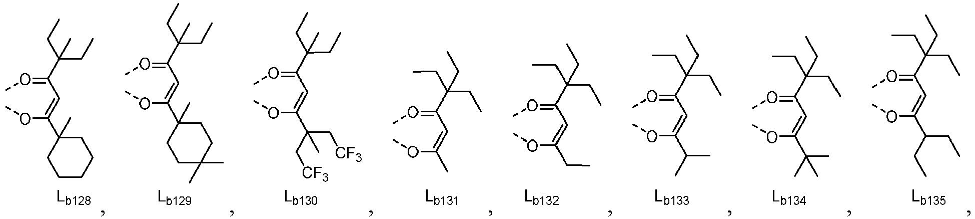 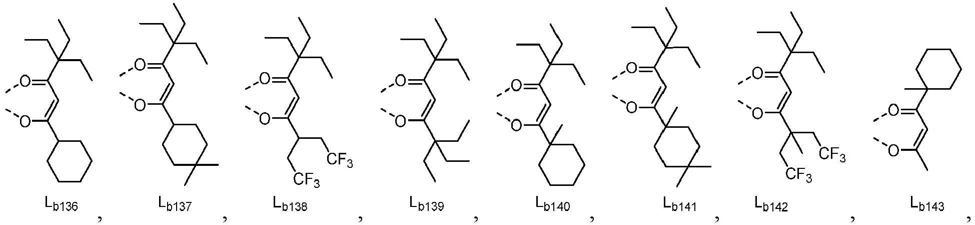 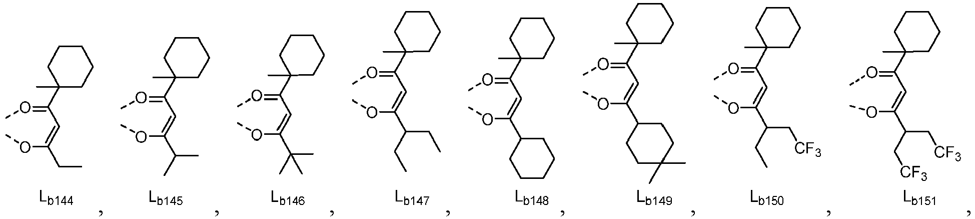 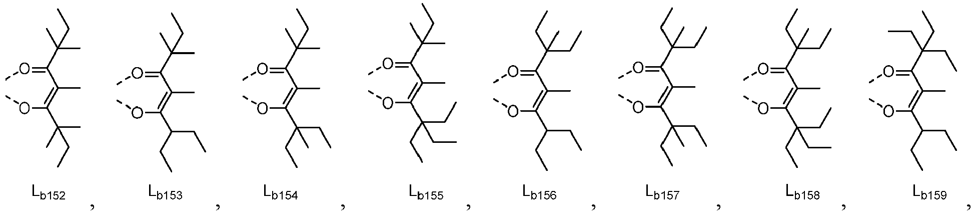 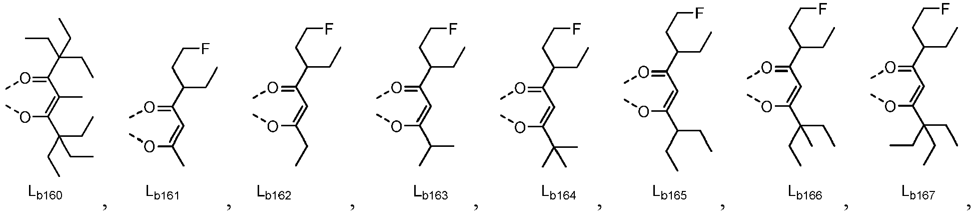 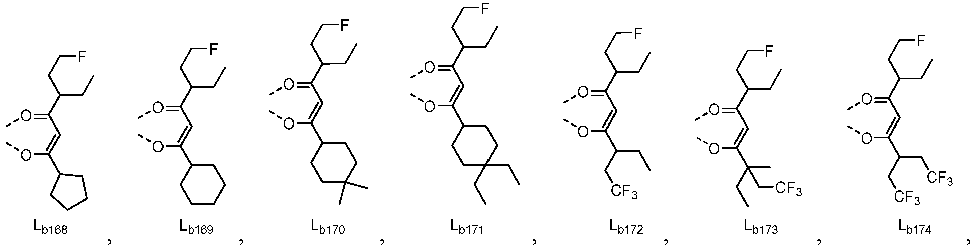 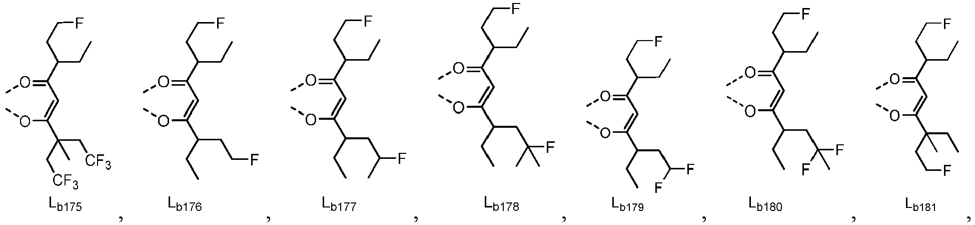 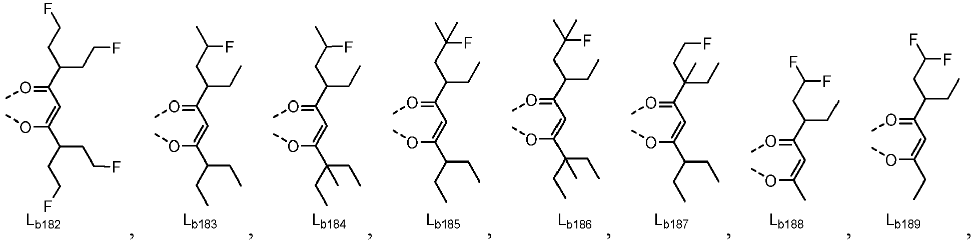 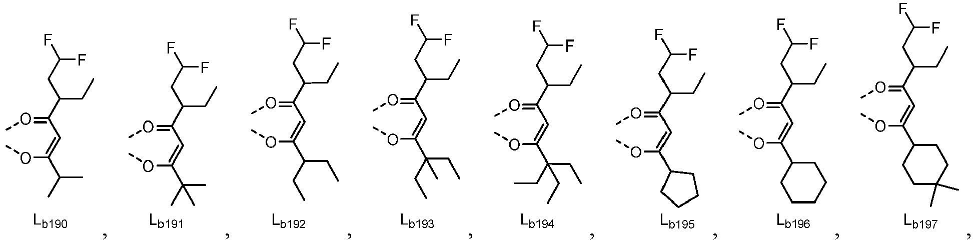 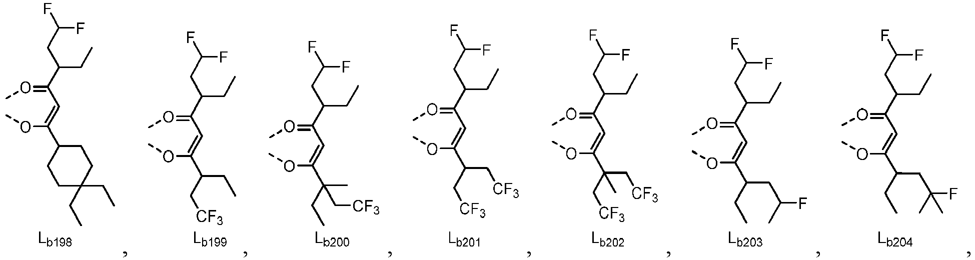 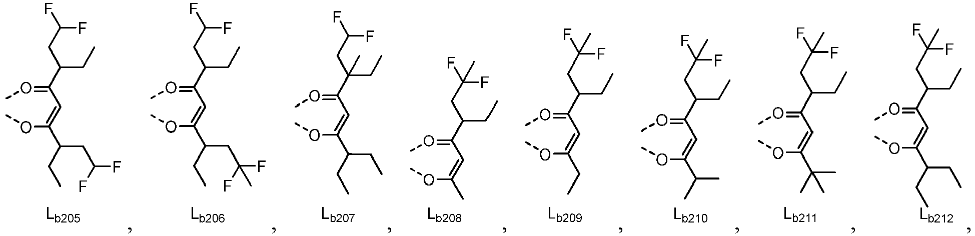 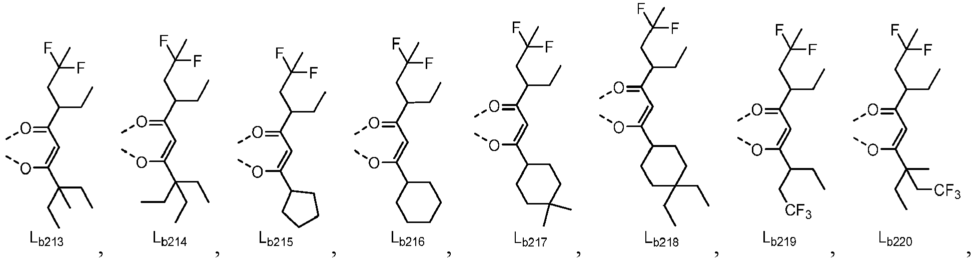 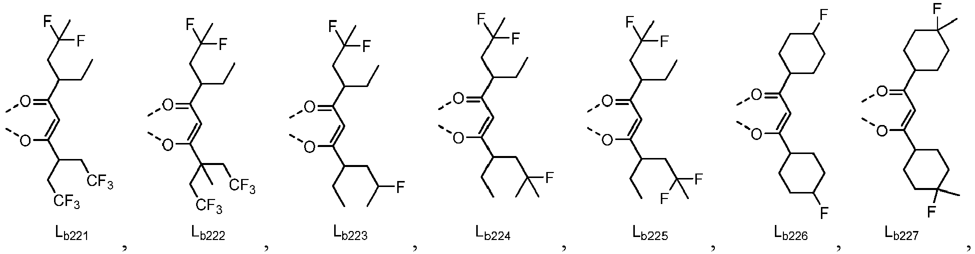 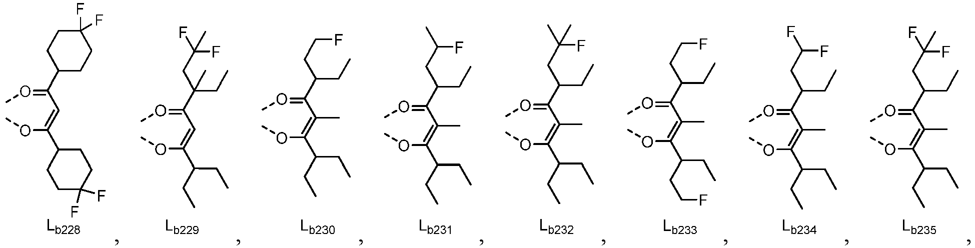 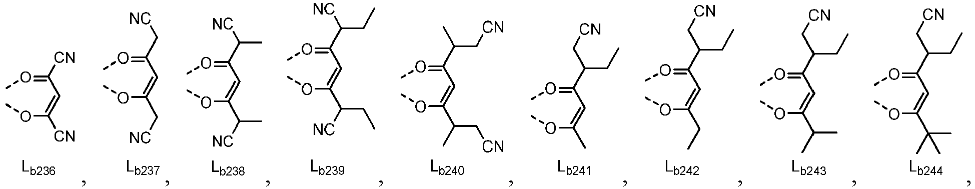 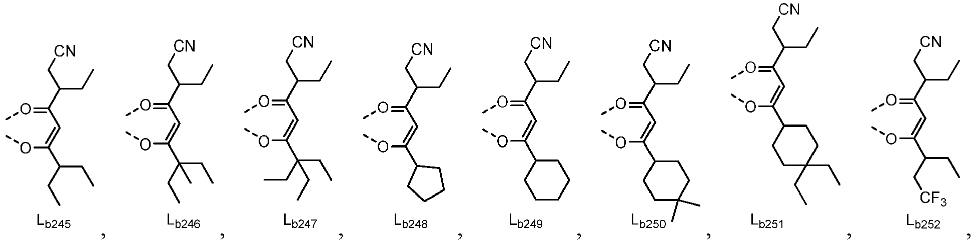 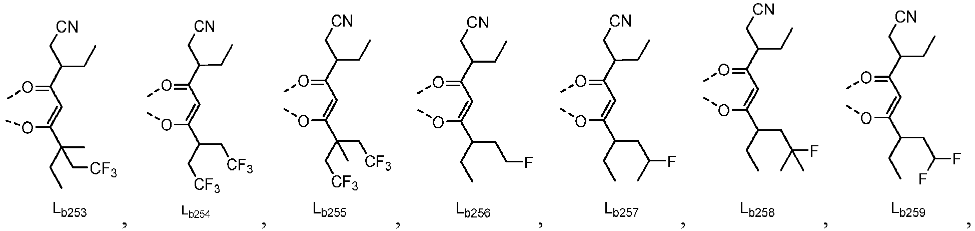 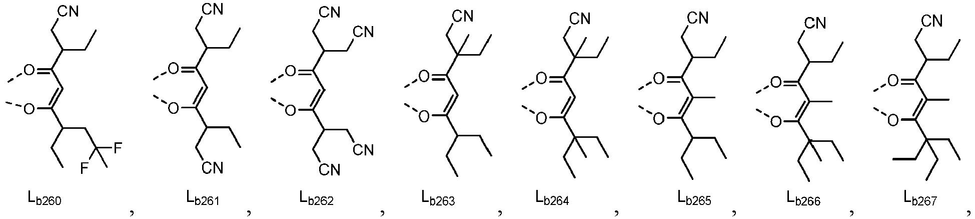 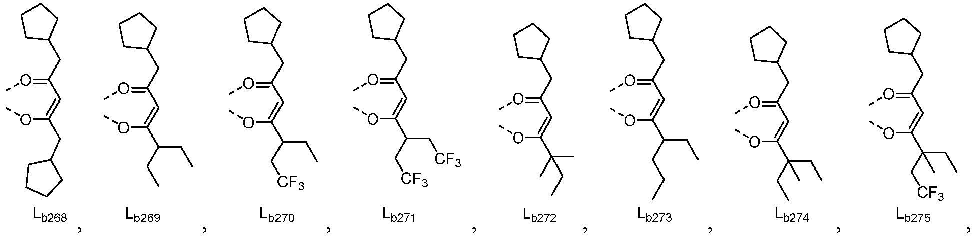 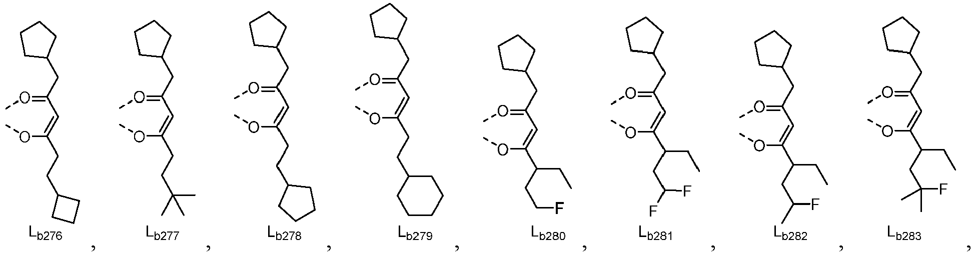 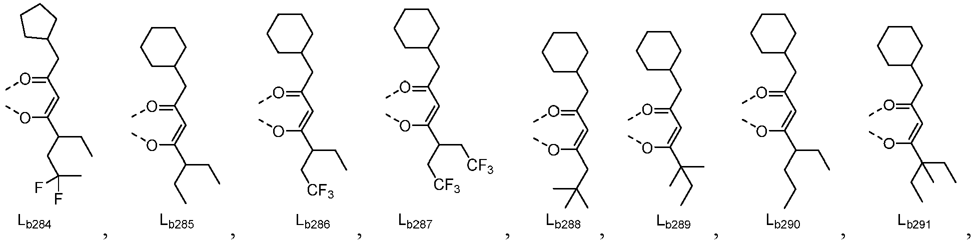 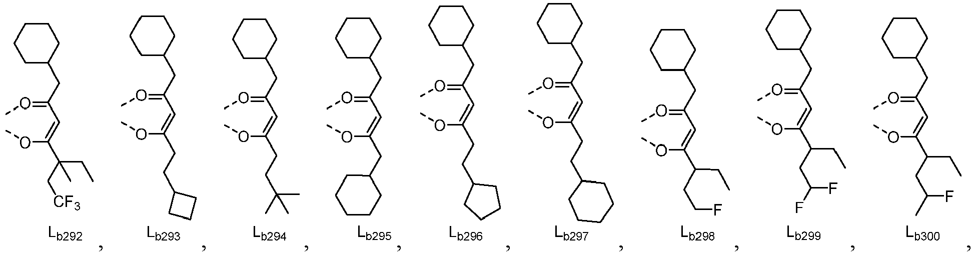 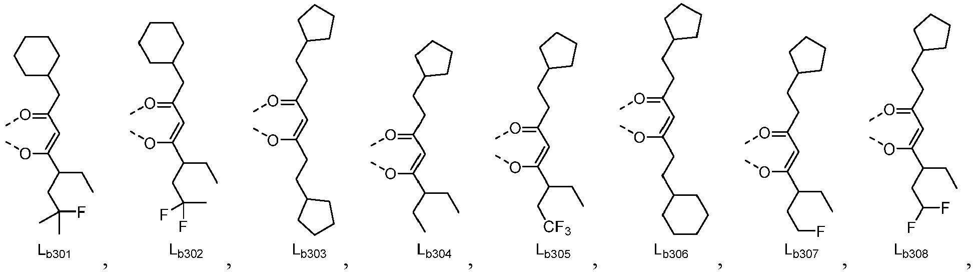 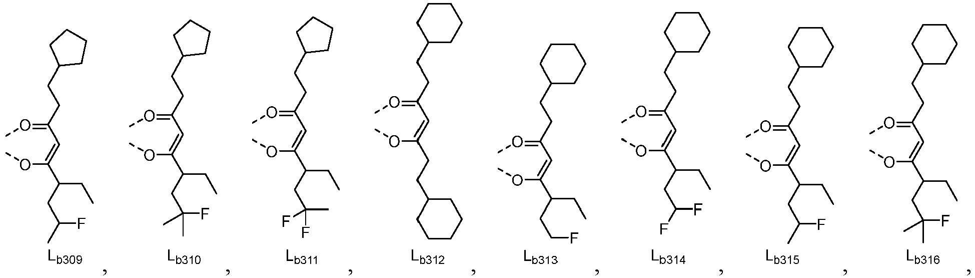 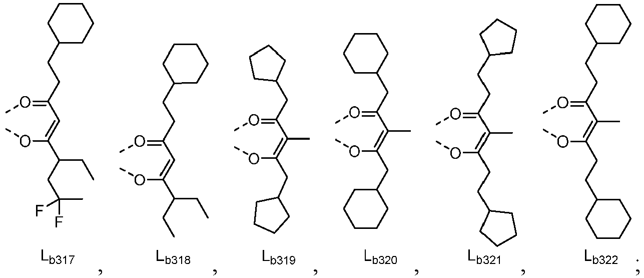 wherein L_{c} is, at each occurrence identically or differently, selected from the group consisting of the following structures:

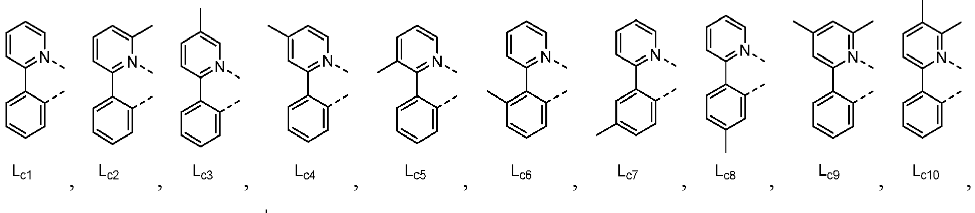

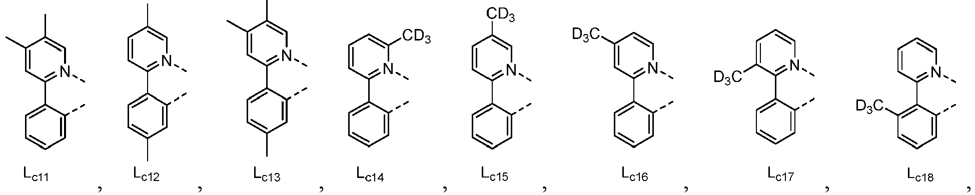

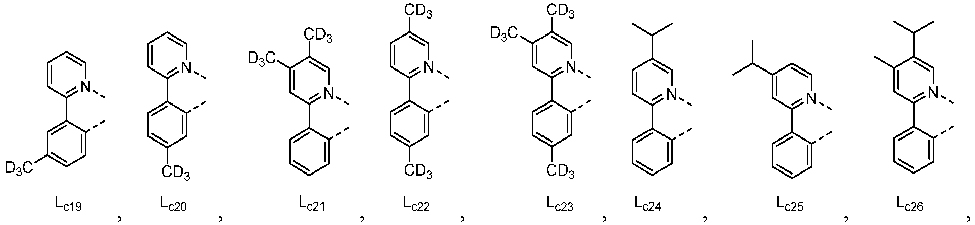

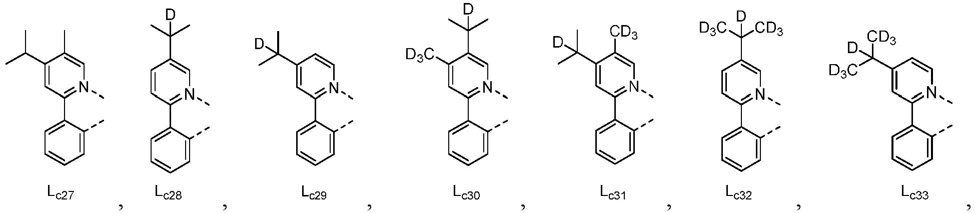

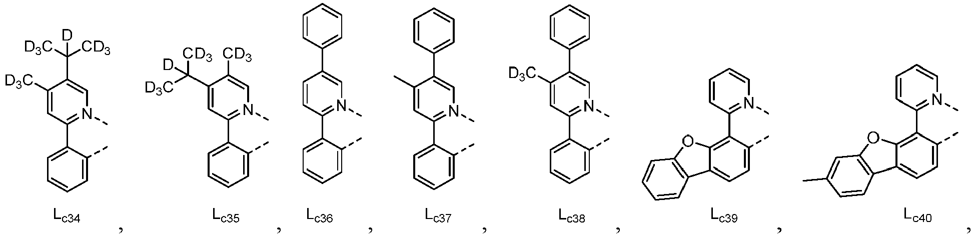

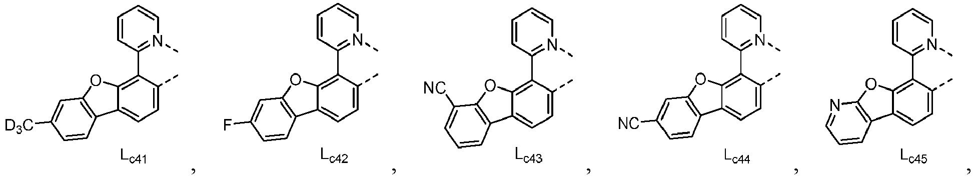

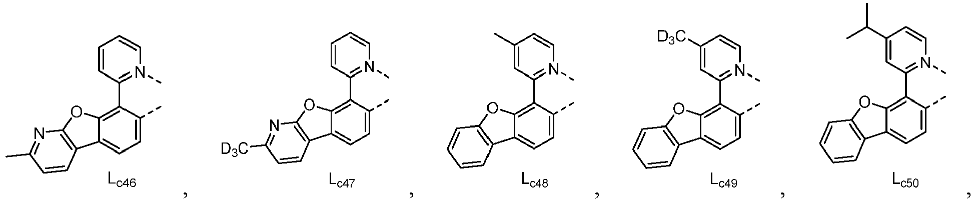

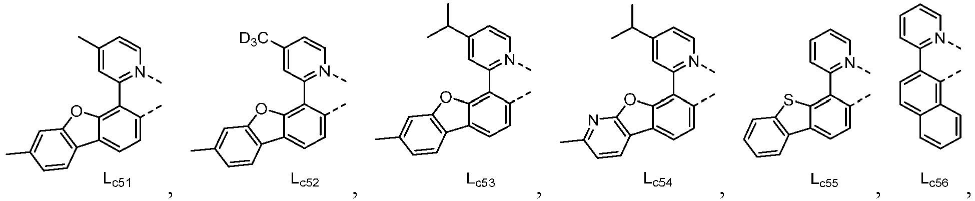

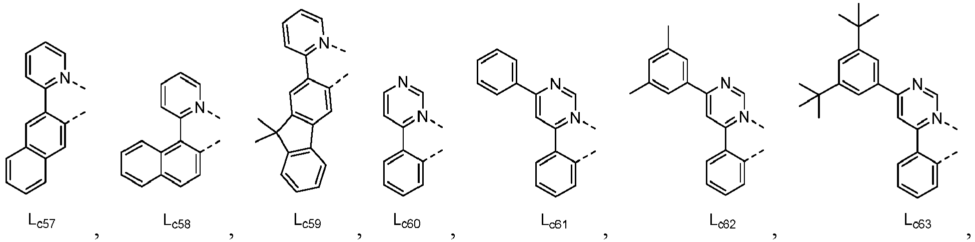

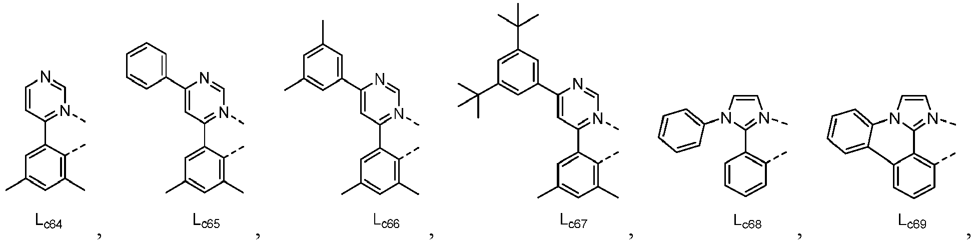

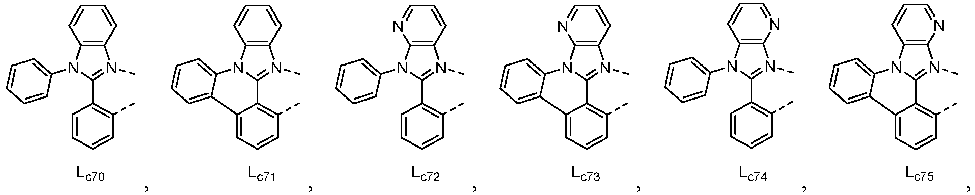

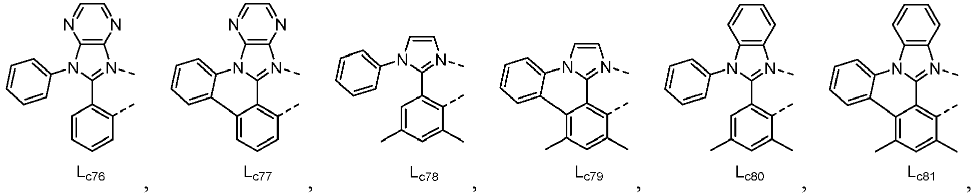

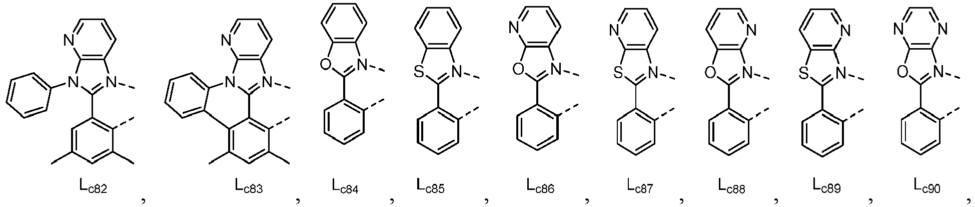

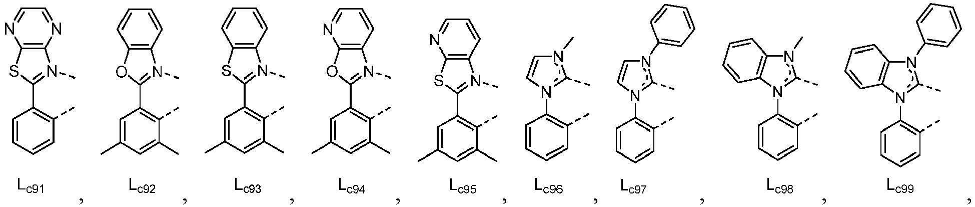

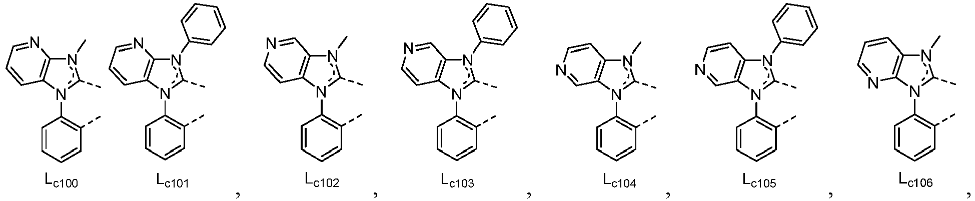

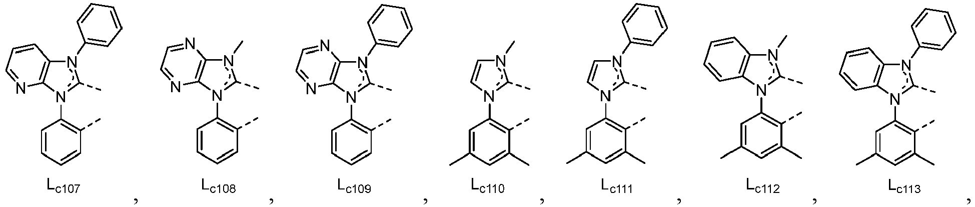

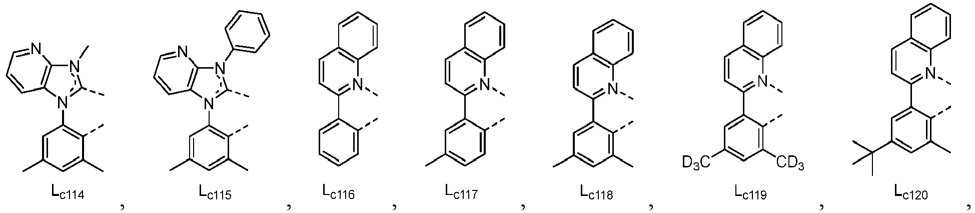

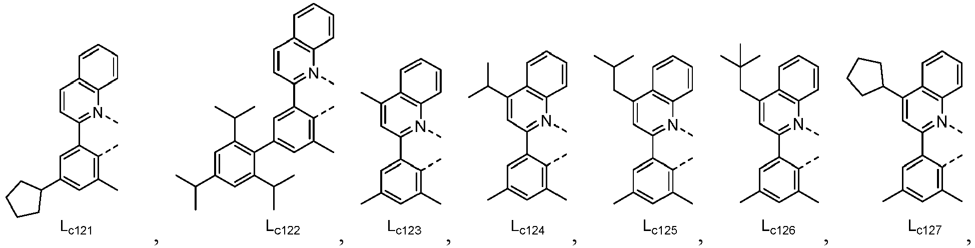

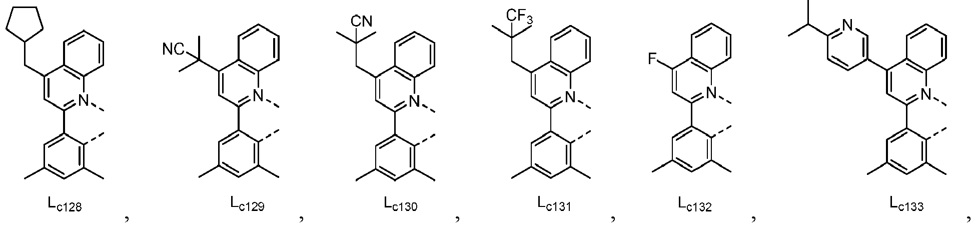

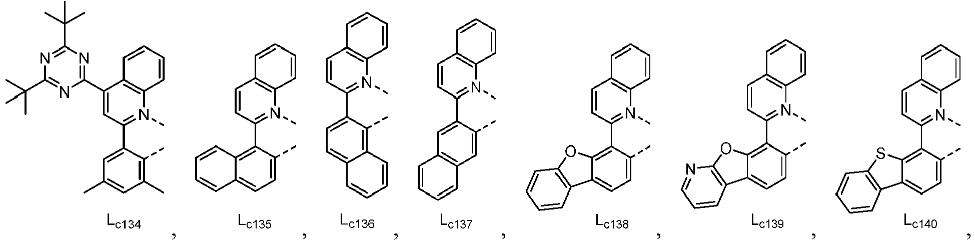

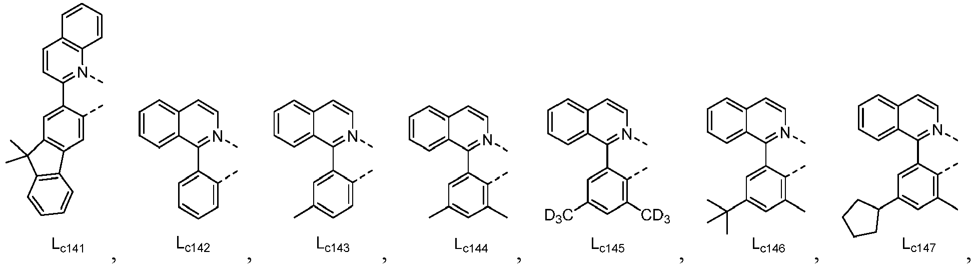

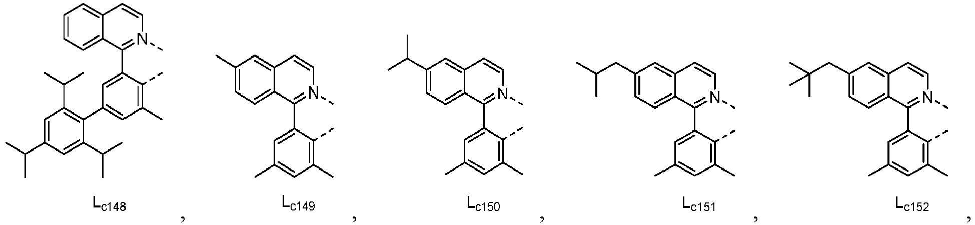

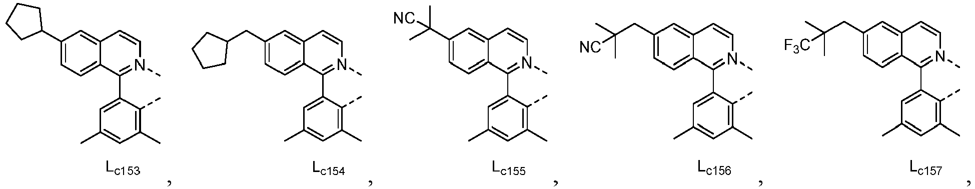

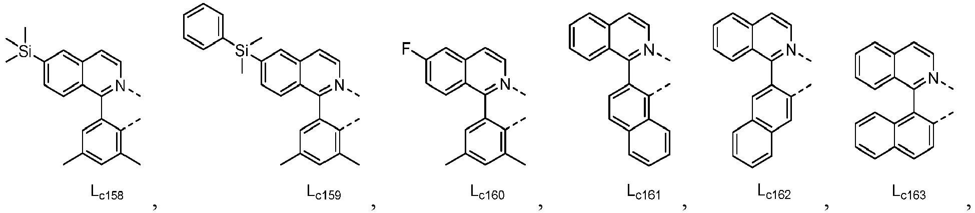

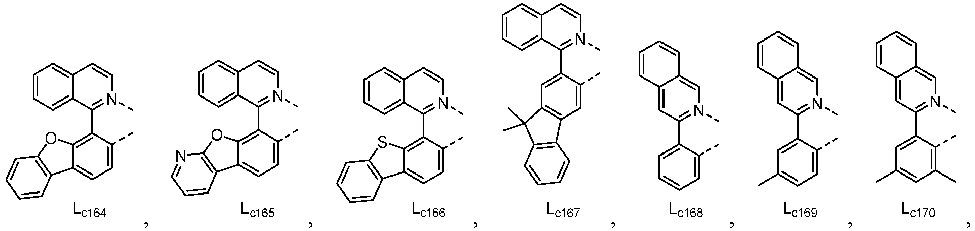

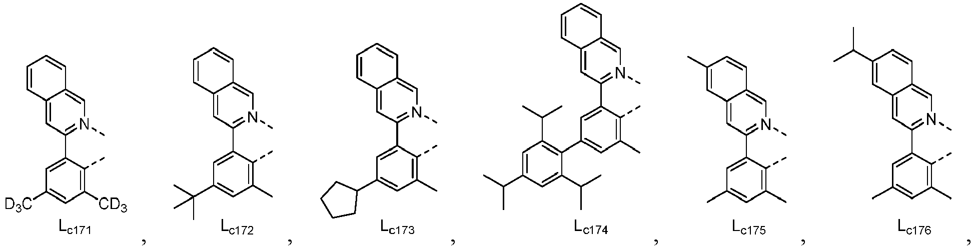

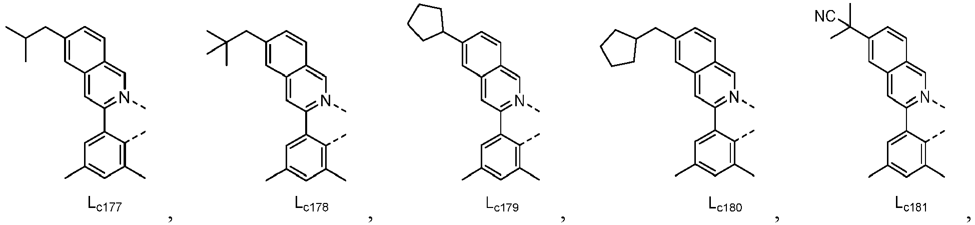

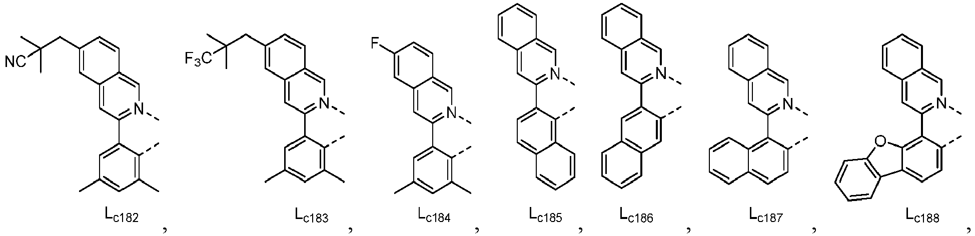

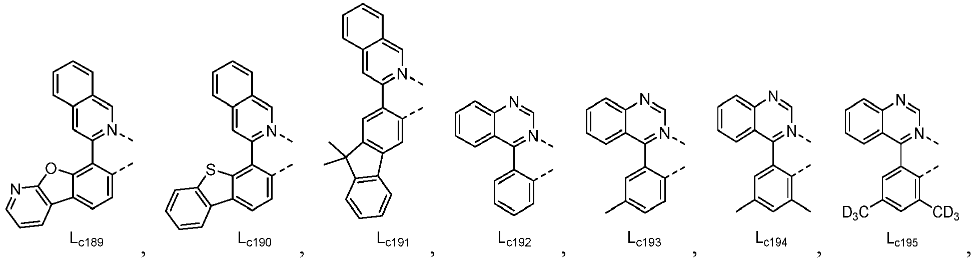

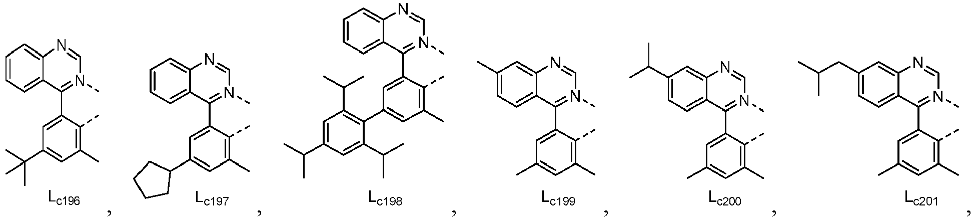

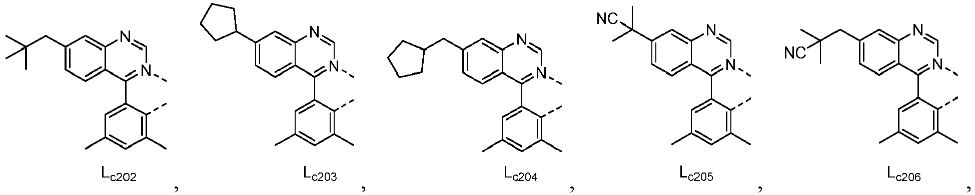

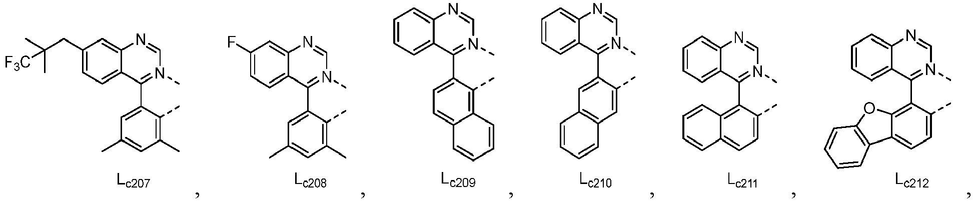

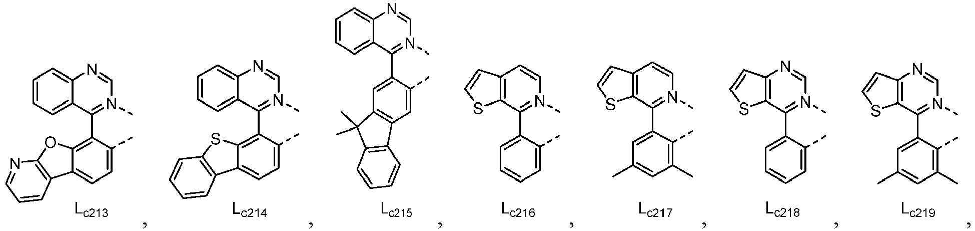

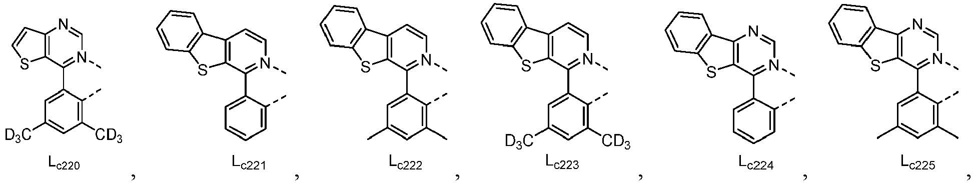

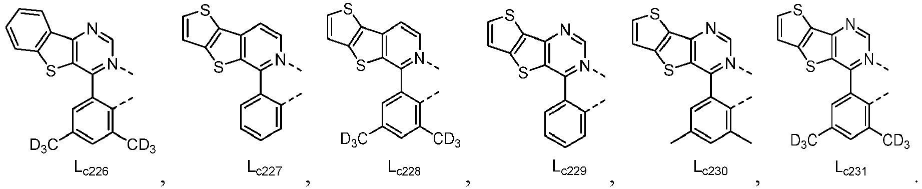

14. The metal complex according to claim 13, wherein the metal complex has a structure of Ir(Lₐ)₂(L_{b}) or Ir(Lₐ)₂(L_{c}) or Ir(Lₐ)(L_{c})₂ or Ir(Lₐ)(L_{b})(L_{c});
wherein when the metal complex has a structure of Ir(Lₐ)₂(L_{b}), Lₐ is, at each occurrence identically or differently, selected from any one or any two of the group consisting of Lₐ₁ to Lₐ₁₉₀₄, and L_{b} is selected from any one of the group consisting of L_{b1} to L_{b322}; when the metal complex has a structure of Ir(Lₐ)₂(L_{c}), Lₐ is, at each occurrence identically or differently, selected from any one or any two of the group consisting of Lₐ₁ to Lₐ₁₉₀₄, and L_{c} is selected from any one of the group consisting of L_{c1} to L_{c231}; when the metal complex has a structure of Ir(Lₐ)(L_{c})₂, Lₐ is selected from any one of the group consisting of Lₐ₁ to Lₐ₁₉₀₄, and L_{c} is, at each occurrence identically or differently, selected from any one or any two of the group consisting of L_{c1} to L_{c231}; when the metal complex has a structure of Ir(Lₐ)(L_{b})(L_{c}), Lₐ is selected from any one of the group consisting of Lₐ₁ to Lₐ₁₉₀₄, L_{b} is selected from any one of the group consisting of L_{b1} to L_{b322}, and L_{c} is selected from any one of the group consisting of L_{c1} to L_{c231}; and
preferably, the metal complex is selected from the group consisting of Compound 1 to Compound 1010;
wherein Compound 1 to Compound 800 each have a structure of Ir(Lₐ)₂(L_{b}), wherein the two Lₐ are identical, and the Lₐ and L_{b} are respectively selected from the structures listed in the following table:
| Compound No. | Lₐ | L_{b} | Compound No. | Lₐ | L_{b} |
|---|---|---|---|---|---|
| 1 | Lₐ₅ | L_{b1} | 2 | Lₐ₂₁ | L_{b1} |
| 3 | Lₐ₃₅ | L_{b1} | 4 | Lₐ₆₆ | L_{b1} |
| 5 | Lₐ₆₉ | L_{b1} | 6 | Lₐ₇₀ | L_{b1} |
| 7 | Lₐ₇₄ | L_{b1} | 8 | Lₐ₁₂₁ | L_{b1} |
| 9 | Lₐ₁₄₈ | L_{b1} | 10 | Lₐ₁₇₅ | L_{b1} |
| 11 | Lₐ₂₀₇ | L_{b1} | 12 | Lₐ₂₁₂ | L_{b1} |
| 13 | Lₐ₂₃₆ | L_{b1} | 14 | Lₐ₂₅₅ | L_{b1} |
| 15 | Lₐ₂₇₁ | L_{b1} | 16 | Lₐ₂₈₇ | L_{b1} |
| 17 | Lₐ₃₁₉ | L_{b1} | 18 | Lₐ₃₂₀ | L_{b1} |
| 19 | Lₐ₃₃₅ | L_{b1} | 20 | Lₐ₃₉₉ | L_{b1} |
| 21 | Lₐ₄₃₈ | L_{b1} | 22 | Lₐ₄₅₃ | L_{b1} |
| 23 | Lₐ₄₆₉ | L_{b1} | 24 | Lₐ₄₉₇ | L_{b1} |
| 25 | Lₐ₅₀₀ | L_{b1} | 26 | Lₐ₅₂₉ | L_{b1} |
| 27 | Lₐ₆₀₁ | L_{b1} | 28 | Lₐ₆₀₆ | L_{b1} |
| 29 | Lₐ₆₃₇ | L_{b1} | 30 | Lₐ₆₆₅ | L_{b1} |
| 31 | Lₐ₆₈₉ | L_{b1} | 32 | Lₐ₆₉₉ | L_{b1} |
| 33 | Lₐ₇₀₀ | L_{b1} | 34 | Lₐ₇₄₄ | L_{b1} |
| 35 | Lₐ₇₇₇ | L_{b1} | 36 | Lₐ₇₉₃ | L_{b1} |
| 37 | Lₐ₈₁₀ | L_{b1} | 38 | Lₐ₈₄₂ | L_{b1} |
| 39 | Lₐ₈₅₀ | L_{b1} | 40 | Lₐ₉₁₇ | L_{b1} |
| 41 | Lₐ₉₈₂ | L_{b1} | 42 | Lₐ₉₈₉ | L_{b1} |
| 43 | Lₐ₁₀₁₆ | L_{b1} | 44 | Lₐ₁₀₃₁ | L_{b1} |
| 45 | Lₐ₁₀₄₇ | L_{b1} | 46 | Lₐ₁₀₇₉ | L_{b1} |
| 47 | Lₐ₁₁₆₃ | L_{b1} | 47 | Lₐ₁₁₉₁ | L_{b1} |
| 49 | Lₐ₁₁₉₈ | L_{b1} | 50 | Lₐ₁₂₃₆ | L_{b1} |
| 51 | Lₐ₁₂₄₇ | L_{b1} | 52 | Lₐ₁₂₇₆ | L_{b1} |
| 53 | Lₐ₁₃₁₃ | L_{b1} | 54 | Lₐ₁₃₃₆ | L_{b1} |
| 55 | Lₐ₁₃₄₁ | L_{b1} | 56 | Lₐ₁₃₆₄ | L_{b1} |
| 57 | Lₐ₁₃₉₅ | L_{b1} | 58 | Lₐ₁₄₃₇ | L_{b1} |
| 59 | Lₐ₁₄₅₄ | L_{b1} | 60 | Lₐ₁₄₅₅ | L_{b1} |
| 61 | Lₐ₁₄₈₀ | L_{b1} | 62 | Lₐ₁₄₈₇ | L_{b1} |
| 63 | Lₐ₁₄₉₂ | L_{b1} | 64 | Lₐ₁₅₁₀ | L_{b1} |
| 65 | Lₐ₁₅₂₃ | L_{b1} | 66 | Lₐ₁₅₃₁ | L_{b1} |
| 67 | Lₐ₁₅₇₁ | L_{b1} | 68 | Lₐ₁₅₉₁ | L_{b1} |
| 69 | Lₐ₁₆₀₈ | L_{b1} | 70 | Lₐ₁₆₀₉ | L_{b1} |
| 71 | Lₐ₁₆₂₉ | L_{b1} | 72 | Lₐ₁₆₃₀ | L_{b1} |
| 73 | Lₐ₁₆₃₈ | L_{b1} | 74 | Lₐ₁₆₈₈ | L_{b1} |
| 75 | Lₐ₁₇₀₂ | L_{b1} | 76 | Lₐ₁₇₁₇ | L_{b1} |
| 77 | Lₐ₁₇₂₃ | L_{b1} | 78 | Lₐ₁₇₅₃ | L_{b1} |
| 79 | Lₐ₁₇₆₁ | L_{b1} | 80 | Lₐ₁₈₁₃ | L_{b1} |
| 81 | Lₐ₁₈₁₅ | L_{b1} | 82 | Lₐ₁₈₁₉ | L_{b1} |
| 83 | Lₐ₁₈₂₃ | L_{b1} | 84 | Lₐ₁₆₂₉ | L_{b1} |
| 85 | Lₐ₁₈₃₃ | L_{b1} | 86 | Lₐ₁₈₃₉ | L_{b1} |
| 87 | Lₐ₁₈₄₃ | L_{b1} | 88 | Lₐ₁₈₄₉ | L_{b1} |
| 89 | Lₐ₁₈₅₃ | L_{b1} | 90 | Lₐ₁₈₅₅ | L_{b1} |
| 91 | Lₐ₁₈₅₉ | L_{b1} | 92 | Lₐ₁₈₆₃ | L_{b1} |
| 93 | Lₐ₁₈₆₅ | L_{b1} | 94 | Lₐ₁₈₆₉ | L_{b1} |
| 95 | Lₐ₁₈₇₃ | L_{b1} | 96 | Lₐ₁₈₇₅ | L_{b1} |
| 97 | Lₐ₁₈₇₉ | L_{b1} | 98 | Lₐ₁₈₈₃ | L_{b1} |
| 99 | Lₐ₁₈₈₅ | L_{b1} | 100 | Lₐ₁₈₈₉ | L_{b1} |
| 101 | Lₐ₅ | L_{b31} | 102 | Lₐ₂₁ | L_{b31} |
| 103 | Lₐ₃₅ | L_{b31} | 104 | Lₐ₆₆ | L_{b31} |
| 105 | Lₐ₆₉ | L_{b31} | 106 | Lₐ₇₀ | L_{b31} |
| 107 | Lₐ₇₄ | L_{b31} | 108 | Lₐ₁₂₁ | L_{b31} |
| 109 | Lₐ₁₄₈ | L_{b31} | 110 | Lₐ₁₇₅ | L_{b31} |
| 111 | Lₐ₂₀₇ | L_{b31} | 112 | Lₐ₂₁₂ | L_{b31} |
| 113 | Lₐ₂₃₆ | L_{b31} | 114 | Lₐ₂₅₅ | L_{b31} |
| 115 | Lₐ₂₇₁ | L_{b31} | 116 | Lₐ₂₈₇ | L_{b31} |
| 117 | Lₐ₃₁₉ | L_{b31} | 118 | Lₐ₃₂₀ | L_{b31} |
| 119 | Lₐ₃₃₅ | L_{b31} | 120 | Lₐ₃₉₉ | L_{b31} |
| 121 | Lₐ₄₃₈ | L_{b31} | 122 | Lₐ₄₅₃ | L_{b31} |
| 123 | Lₐ₄₆₉ | L_{b31} | 124 | Lₐ₄₉₇ | L_{b31} |
| 125 | Lₐ₅₀₀ | L_{b31} | 126 | Lₐ₅₂₉ | L_{b31} |
| 127 | Lₐ₆₀₁ | L_{b31} | 128 | Lₐ₆₀₆ | L_{b31} |
| 129 | Lₐ₆₃₇ | L_{b31} | 130 | Lₐ₆₆₅ | L_{b31} |
| 131 | Lₐ₆₈₉ | L_{b31} | 132 | Lₐ₆₉₉ | L_{b31} |
| 133 | Lₐ₇₀₀ | L_{b31} | 134 | Lₐ₇₄₄ | L_{b31} |
| 135 | Lₐ₇₇₇ | L_{b31} | 136 | Lₐ₇₉₃ | L_{b31} |
| 137 | Lₐ₈₁₀ | L_{b31} | 138 | Lₐ₈₄₂ | L_{b31} |
| 139 | Lₐ₈₅₀ | L_{b31} | 140 | Lₐ₉₁₇ | L_{b31} |
| 141 | Lₐ₉₈₂ | L_{b31} | 142 | Lₐ₉₈₉ | L_{b31} |
| 143 | Lₐ₁₀₁₆ | L_{b31} | 144 | Lₐ₁₀₃₁ | L_{b31} |
| 145 | Lₐ₁₀₄₇ | L_{b31} | 146 | Lₐ₁₀₇₉ | L_{b31} |
| 147 | Lₐ₁₁₆₃ | L_{b31} | 148 | Lₐ₁₁₉₁ | L_{b31} |
| 149 | Lₐ₁₁₉₈ | L_{b31} | 150 | Lₐ₁₂₃₆ | L_{b31} |
| 151 | Lₐ₁₂₄₇ | L_{b31} | 152 | Lₐ₁₂₇₆ | L_{b31} |
| 153 | Lₐ₁₃₁₃ | L_{b31} | 154 | Lₐ₁₃₃₆ | L_{b31} |
| 155 | Lₐ₁₃₄₁ | L_{b31} | 156 | Lₐ₁₃₆₄ | L_{b31} |
| 157 | Lₐ₁₃₉₅ | L_{b31} | 158 | Lₐ₁₄₃₇ | L_{b31} |
| 159 | Lₐ₁₄₅₄ | L_{b31} | 160 | Lₐ₁₄₅₅ | L_{b31} |
| 161 | Lₐ₁₄₈₀ | L_{b31} | 162 | Lₐ₁₄₈₇ | L_{b31} |
| 163 | Lₐ₁₄₉₂ | L_{b31} | 164 | Lₐ₁₅₁₀ | L_{b31} |
| 165 | Lₐ₁₅₂₃ | L_{b31} | 166 | Lₐ₁₅₃₁ | L_{b31} |
| 167 | Lₐ₁₅₇₁ | L_{b31} | 168 | Lₐ₁₅₉₁ | L_{b31} |
| 169 | Lₐ₁₆₀₈ | L_{b31} | 170 | Lₐ₁₆₀₉ | L_{b31} |
| 171 | Lₐ₁₆₂₉ | L_{b31} | 172 | Lₐ₁₆₃₀ | L_{b31} |
| 173 | Lₐ₁₆₃₈ | L_{b31} | 174 | Lₐ₁₆₈₈ | L_{b31} |
| 175 | Lₐ₁₇₀₂ | L_{b31} | 176 | Lₐ₁₇₁₇ | L_{b31} |
| 177 | Lₐ₁₇₂₃ | L_{b31} | 178 | Lₐ₁₇₅₃ | L_{b31} |
| 179 | Lₐ₁₇₆₁ | L_{b31} | 180 | Lₐ₁₈₁₃ | L_{b31} |
| 181 | Lₐ₁₈₁₅ | L_{b31} | 182 | Lₐ₁₈₁₉ | L_{b31} |
| 183 | Lₐ₁₈₂₃ | L_{b31} | 184 | Lₐ₁₈₂₉ | L_{b31} |
| 185 | Lₐ₁₈₃₃ | L_{b31} | 186 | Lₐ₁₈₃₉ | L_{b31} |
| 187 | Lₐ₁₈₄₃ | L_{b31} | 188 | Lₐ₁₈₄₉ | L_{b31} |
| 189 | Lₐ₁₈₅₃ | L_{b31} | 190 | Lₐ₁₈₅₅ | L_{b31} |
| 191 | Lₐ₁₈₅₉ | L_{b31} | 192 | Lₐ₁₈₆₃ | L_{b31} |
| 193 | Lₐ₁₈₆₅ | L_{b31} | 194 | Lₐ₁₈₈₉ | L_{b31} |
| 195 | Lₐ₁₈₇₃ | L_{b31} | 196 | Lₐ₁₈₇₅ | L_{b31} |
| 197 | Lₐ₁₈₇₉ | L_{b31} | 198 | Lₐ₁₈₈₃ | L_{b31} |
| 199 | Lₐ₁₈₈₅ | L_{b31} | 200 | Lₐ₁₈₈₉ | L_{b31} |
| 201 | Lₐ₅ | L_{b88} | 202 | Lₐ₂₁ | L_{b88} |
| 203 | Lₐ₃₅ | L_{b88} | 204 | Lₐ₆₆ | L_{b88} |
| 205 | Lₐ₆₉ | L_{b88} | 206 | Lₐ₇₀ | L_{b88} |
| 207 | Lₐ₇₄ | L_{b88} | 208 | Lₐ₁₂₁ | L_{b88} |
| 209 | Lₐ₁₄₈ | L_{b88} | 210 | Lₐ₁₇₅ | L_{b88} |
| 211 | Lₐ₂₀₇ | L_{b88} | 212 | Lₐ₂₁₂ | L_{b88} |
| 213 | Lₐ₂₃₆ | L_{b88} | 214 | Lₐ₂₅₅ | L_{b88} |
| 215 | Lₐ₂₇₁ | L_{b88} | 216 | Lₐ₂₈₇ | L_{b88} |
| 217 | Lₐ₃₁₉ | L_{b88} | 218 | Lₐ₃₂₀ | L_{b88} |
| 219 | Lₐ₃₃₅ | L_{b88} | 220 | Lₐ₃₉₉ | L_{b88} |
| 221 | Lₐ₄₃₈ | L_{b88} | 222 | Lₐ₄₅₃ | L_{b88} |
| 223 | Lₐ₄₆₉ | L_{b88} | 224 | Lₐ₄₉₇ | L_{b88} |
| 225 | Lₐ₅₀₀ | L_{b88} | 226 | Lₐ₅₂₉ | L_{b88} |
| 227 | Lₐ₆₀₁ | L_{b88} | 228 | Lₐ₆₀₆ | L_{b88} |
| 229 | Lₐ₆₃₇ | L_{b88} | 230 | Lₐ₆₆₅ | L_{b88} |
| 231 | Lₐ₆₈₉ | L_{b88} | 232 | Lₐ₆₉₉ | L_{b88} |
| 233 | Lₐ₇₀₀ | L_{b88} | 234 | Lₐ₇₄₄ | L_{b88} |
| 235 | Lₐ₇₇₇ | L_{b88} | 236 | Lₐ₇₉₃ | L_{b88} |
| 237 | Lₐ₈₁₀ | L_{b88} | 238 | Lₐ₈₄₂ | L_{b88} |
| 239 | Lₐ₈₅₀ | L_{b88} | 240 | Lₐ₉₁₇ | L_{b88} |
| 241 | Lₐ₉₈₂ | L_{b88} | 242 | Lₐ₉₈₉ | L_{b88} |
| 243 | Lₐ₁₀₁₆ | L_{b88} | 244 | Lₐ₁₀₃₁ | L_{b88} |
| 245 | Lₐ₁₀₄₇ | L_{b88} | 246 | Lₐ₁₀₇₉ | L_{b88} |
| 247 | Lₐ₁₁₆₃ | L_{b88} | 248 | Lₐ₁₁₉₁ | L_{b88} |
| 249 | Lₐ₁₁₉₈ | L_{b88} | 250 | Lₐ₁₂₃₆ | L_{b88} |
| 251 | Lₐ₁₂₄₇ | L_{b88} | 252 | Lₐ₁₂₇₆ | L_{b88} |
| 253 | Lₐ₁₃₁₃ | L_{b88} | 254 | Lₐ₁₃₃₆ | L_{b88} |
| 255 | Lₐ₁₃₄₁ | L_{b88} | 256 | Lₐ₁₃₆₄ | L_{b88} |
| 257 | Lₐ₁₃₉₅ | L_{b88} | 258 | Lₐ₁₄₃₇ | L_{b88} |
| 259 | Lₐ₁₄₅₄ | L_{b88} | 260 | Lₐ₁₄₅₅ | L_{b88} |
| 261 | Lₐ₁₄₈₀ | L_{b88} | 262 | Lₐ₁₄₈₇ | L_{b88} |
| 263 | Lₐ₁₄₉₂ | L_{b88} | 264 | Lₐ₁₅₁₀ | L_{b88} |
| 265 | Lₐ₁₅₂₃ | L_{b88} | 266 | Lₐ₁₅₃₁ | L_{b88} |
| 267 | Lₐ₁₅₇₁ | L_{b88} | 268 | Lₐ₁₅₉₁ | L_{b88} |
| 269 | Lₐ₁₆₀₈ | L_{b88} | 270 | Lₐ₁₆₀₉ | L_{b88} |
| 271 | Lₐ₁₆₂₉ | L_{b88} | 272 | Lₐ₁₆₃₀ | L_{b88} |
| 273 | Lₐ₁₆₃₈ | L_{b88} | 274 | Lₐ₁₆₈₈ | L_{b88} |
| 275 | Lₐ₁₇₀₂ | L_{b88} | 276 | Lₐ₁₇₁₇ | L_{b88} |
| 277 | Lₐ₁₇₂₃ | L_{b88} | 278 | Lₐ₁₇₅₃ | L_{b88} |
| 279 | Lₐ₁₇₆₁ | L_{b88} | 280 | Lₐ₁₈₁₃ | L_{b88} |
| 281 | Lₐ₁₈₁₅ | L_{b88} | 282 | Lₐ₁₈₁₉ | L_{b88} |
| 283 | Lₐ₁₈₂₃ | L_{b88} | 284 | Lₐ₁₆₂₉ | L_{b88} |
| 285 | Lₐ₁₈₃₃ | L_{b88} | 286 | Lₐ₁₈₃₉ | L_{b88} |
| 287 | Lₐ₁₈₄₃ | L_{b88} | 288 | Lₐ₁₈₄₉ | L_{b88} |
| 289 | Lₐ₁₈₅₃ | L_{b88} | 290 | Lₐ₁₈₅₅ | L_{b88} |
| 291 | Lₐ₁₈₅₉ | L_{b88} | 292 | Lₐ₁₈₆₃ | L_{b88} |
| 293 | Lₐ₁₈₆₅ | L_{b88} | 294 | Lₐ₁₈₈₉ | L_{b88} |
| 295 | Lₐ₁₈₇₃ | L_{b88} | 296 | Lₐ₁₈₇₅ | L_{b88} |
| 297 | Lₐ₁₈₇₉ | L_{b88} | 298 | Lₐ₁₈₈₃ | L_{b88} |
| 299 | Lₐ₁₈₈₅ | L_{b88} | 300 | Lₐ₁₈₈₉ | L_{b88} |
| 301 | Lₐ₅ | L_{b122} | 302 | Lₐ₂₁ | L_{b122} |
| 303 | Lₐ₃₅ | L_{b122} | 304 | Lₐ₆₆ | L_{b122} |
| 305 | Lₐ₆₉ | L_{b122} | 306 | Lₐ₇₀ | L_{b122} |
| 307 | Lₐ₇₄ | L_{b122} | 308 | Lₐ₁₂₁ | L_{b122} |
| 309 | Lₐ₁₄₈ | L_{b122} | 310 | Lₐ₁₇₅ | L_{b122} |
| 311 | Lₐ₂₀₇ | L_{b122} | 312 | Lₐ₂₁₂ | L_{b122} |
| 313 | Lₐ₂₃₆ | L_{b122} | 314 | Lₐ₂₅₅ | L_{b122} |
| 315 | Lₐ₂₇₁ | L_{b122} | 316 | Lₐ₂₈₇ | L_{b122} |
| 317 | Lₐ₃₁₉ | L_{b122} | 318 | Lₐ₃₂₀ | L_{b122} |
| 319 | Lₐ₃₃₅ | L_{b122} | 320 | Lₐ₃₉₉ | L_{b122} |
| 321 | Lₐ₄₃₈ | L_{b122} | 322 | Lₐ₄₅₃ | L_{b122} |
| 323 | Lₐ₄₆₉ | L_{b122} | 324 | Lₐ₄₉₇ | L_{b122} |
| 325 | Lₐ₅₀₀ | L_{b122} | 326 | Lₐ₅₂₉ | L_{b122} |
| 327 | Lₐ₆₀₁ | L_{b122} | 328 | Lₐ₆₀₆ | L_{b122} |
| 329 | Lₐ₆₃₇ | L_{b122} | 330 | Lₐ₆₆₅ | L_{b122} |
| 331 | Lₐ₆₈₉ | L_{b122} | 332 | Lₐ₆₉₉ | L_{b122} |
| 333 | Lₐ₇₀₀ | L_{b122} | 334 | Lₐ₇₄₄ | L_{b122} |
| 335 | Lₐ₇₇₇ | L_{b122} | 336 | Lₐ₇₉₃ | L_{b122} |
| 337 | Lₐ₈₁₀ | L_{b122} | 338 | Lₐ₈₄₂ | L_{b122} |
| 339 | Lₐ₈₅₀ | L_{b122} | 340 | Lₐ₉₁₇ | L_{b122} |
| 341 | Lₐ₉₈₂ | L_{b122} | 342 | Lₐ₉₈₉ | L_{b122} |
| 343 | Lₐ₁₀₁₆ | L_{b122} | 344 | Lₐ₁₀₃₁ | L_{b122} |
| 345 | Lₐ₁₀₄₇ | L_{b122} | 346 | Lₐ₁₀₇₉ | L_{b122} |
| 347 | Lₐ₁₁₆₃ | L_{b122} | 348 | Lₐ₁₁₉₁ | L_{b122} |
| 349 | Lₐ₁₁₉₈ | L_{b122} | 350 | Lₐ₁₂₃₆ | L_{b122} |
| 351 | Lₐ₁₂₄₇ | L_{b122} | 352 | Lₐ₁₂₇₆ | L_{b122} |
| 353 | Lₐ₁₃₁₃ | L_{b122} | 354 | Lₐ₁₃₃₆ | L_{b122} |
| 355 | Lₐ₁₃₄₁ | L_{b122} | 356 | Lₐ₁₃₆₄ | L_{b122} |
| 357 | Lₐ₁₃₉₅ | L_{b122} | 358 | Lₐ₁₄₃₇ | L_{b122} |
| 359 | Lₐ₁₄₅₄ | L_{b122} | 360 | Lₐ₁₄₅₅ | L_{b122} |
| 361 | Lₐ₁₄₈₀ | L_{b122} | 362 | Lₐ₁₄₈₇ | L_{b122} |
| 363 | Lₐ₁₄₉₂ | L_{b122} | 364 | Lₐ₁₅₁₀ | L_{b122} |
| 365 | Lₐ₁₅₂₃ | L_{b122} | 366 | Lₐ₁₅₃₁ | L_{b122} |
| 367 | Lₐ₁₅₇₁ | L_{b122} | 368 | Lₐ₁₅₉₁ | L_{b122} |
| 369 | Lₐ₁₆₀₈ | L_{b122} | 370 | Lₐ₁₆₀₉ | L_{b122} |
| 371 | Lₐ₁₆₂₉ | L_{b122} | 372 | Lₐ₁₆₃₀ | L_{b122} |
| 373 | Lₐ₁₆₃₈ | L_{b122} | 374 | Lₐ₁₆₈₈ | L_{b122} |
| 375 | Lₐ₁₇₀₂ | L_{b122} | 376 | Lₐ₁₇₁₇ | L_{b122} |
| 377 | Lₐ₁₇₂₃ | L_{b122} | 378 | Lₐ₁₇₅₃ | L_{b122} |
| 379 | Lₐ₁₇₆₁ | L_{b122} | 380 | Lₐ₁₈₁₃ | L_{b122} |
| 381 | Lₐ₁₈₁₅ | L_{b122} | 382 | Lₐ₁₈₁₉ | L_{b122} |
| 383 | Lₐ₁₈₂₃ | L_{b122} | 384 | Lₐ₁₈₂₉ | L_{b122} |
| 385 | Lₐ₁₈₃₃ | L_{b122} | 386 | Lₐ₁₈₃₉ | L_{b122} |
| 387 | Lₐ₁₈₄₃ | L_{b122} | 388 | Lₐ₁₈₄₉ | L_{b122} |
| 389 | Lₐ₁₈₅₃ | L_{b122} | 390 | Lₐ₁₈₅₅ | L_{b122} |
| 391 | Lₐ₁₈₅₉ | L_{b122} | 392 | Lₐ₁₈₆₃ | L_{b122} |
| 393 | Lₐ₁₈₆₅ | L_{b122} | 394 | Lₐ₁₈₈₉ | L_{b122} |
| 395 | Lₐ₁₈₇₃ | L_{b122} | 396 | Lₐ₁₈₇₅ | L_{b122} |
| 397 | Lₐ₁₈₇₉ | L_{b122} | 398 | Lₐ₁₈₈₃ | L_{b122} |
| 399 | Lₐ₁₈₈₅ | L_{b122} | 400 | Lₐ₁₈₈₉ | L_{b122} |
| 401 | Lₐ₅ | L_{b126} | 402 | Lₐ₂₁ | L_{b126} |
| 403 | Lₐ₃₅ | L_{b126} | 404 | Lₐ₆₆ | L_{b126} |
| 405 | Lₐ₆₉ | L_{b126} | 406 | Lₐ₇₀ | L_{b126} |
| 407 | Lₐ₇₄ | L_{b126} | 408 | Lₐ₁₂₁ | L_{b126} |
| 409 | Lₐ₁₄₈ | L_{b126} | 410 | Lₐ₁₇₅ | L_{b126} |
| 411 | Lₐ₂₀₇ | L_{b126} | 412 | Lₐ₂₁₂ | L_{b126} |
| 413 | Lₐ₂₃₆ | L_{b126} | 414 | Lₐ₂₅₅ | L_{b126} |
| 415 | Lₐ₂₇₁ | L_{b126} | 416 | Lₐ₂₈₇ | L_{b126} |
| 417 | Lₐ₃₁₉ | L_{b126} | 418 | Lₐ₃₂₀ | L_{b126} |
| 419 | Lₐ₃₃₅ | L_{b126} | 420 | Lₐ₃₉₉ | L_{b126} |
| 421 | Lₐ₄₃₈ | L_{b126} | 422 | Lₐ₄₅₃ | L_{b126} |
| 423 | Lₐ₄₆₉ | L_{b126} | 424 | Lₐ₄₉₇ | L_{b126} |
| 425 | Lₐ₅₀₀ | L_{b126} | 426 | Lₐ₅₂₉ | L_{b126} |
| 427 | Lₐ₆₀₁ | L_{b126} | 428 | Lₐ₆₀₆ | L_{b126} |
| 429 | Lₐ₆₃₇ | L_{b126} | 430 | Lₐ₆₆₅ | L_{b126} |
| 431 | Lₐ₆₈₉ | L_{b126} | 432 | Lₐ₆₉₉ | L_{b126} |
| 433 | Lₐ₇₀₀ | L_{b126} | 434 | Lₐ₇₄₄ | L_{b126} |
| 435 | Lₐ₇₇₇ | L_{b126} | 436 | Lₐ₇₉₃ | L_{b126} |
| 437 | Lₐ₈₁₀ | L_{b126} | 438 | Lₐ₈₄₂ | L_{b126} |
| 439 | Lₐ₈₅₀ | L_{b126} | 440 | Lₐ₉₁₇ | L_{b126} |
| 441 | Lₐ₉₈₂ | L_{b126} | 442 | Lₐ₉₈₉ | L_{b126} |
| 443 | Lₐ₁₀₁₆ | L_{b126} | 444 | Lₐ₁₀₃₁ | L_{b126} |
| 445 | Lₐ₁₀₄₇ | L_{b126} | 446 | Lₐ₁₀₇₉ | L_{b126} |
| 447 | Lₐ₁₁₆₃ | L_{b126} | 448 | Lₐ₁₁₉₁ | L_{b126} |
| 449 | Lₐ₁₁₉₈ | L_{b126} | 450 | Lₐ₁₂₃₆ | L_{b126} |
| 451 | Lₐ₁₂₄₇ | L_{b126} | 452 | Lₐ₁₂₇₆ | L_{b126} |
| 453 | Lₐ₁₃₁₃ | L_{b126} | 454 | Lₐ₁₃₃₆ | L_{b126} |
| 455 | Lₐ₁₃₄₁ | L_{b126} | 456 | Lₐ₁₃₆₄ | L_{b126} |
| 457 | Lₐ₁₃₉₅ | L_{b126} | 458 | Lₐ₁₄₃₇ | L_{b126} |
| 459 | Lₐ₁₄₅₄ | L_{b126} | 460 | Lₐ₁₄₅₅ | L_{b126} |
| 461 | Lₐ₁₄₈₀ | L_{b126} | 462 | Lₐ₁₄₈₇ | L_{b126} |
| 463 | Lₐ₁₄₉₂ | L_{b126} | 464 | Lₐ₁₅₁₀ | L_{b126} |
| 465 | Lₐ₁₅₂₃ | L_{b126} | 466 | Lₐ₁₅₃₁ | L_{b126} |
| 467 | Lₐ₁₅₇₁ | L_{b126} | 468 | Lₐ₁₅₉₁ | L_{b126} |
| 469 | Lₐ₁₆₀₈ | L_{b126} | 470 | Lₐ₁₆₀₉ | L_{b126} |
| 471 | Lₐ₁₆₂₉ | L_{b126} | 472 | Lₐ₁₆₃₀ | L_{b126} |
| 473 | Lₐ₁₆₃₈ | L_{b126} | 474 | Lₐ₁₆₈₈ | L_{b126} |
| 475 | Lₐ₁₇₀₂ | L_{b126} | 476 | Lₐ₁₇₁₇ | L_{b126} |
| 477 | Lₐ₁₇₂₃ | L_{b126} | 478 | Lₐ₁₇₅₃ | L_{b126} |
| 479 | Lₐ₁₇₆₁ | L_{b126} | 480 | Lₐ₁₈₁₃ | L_{b126} |
| 481 | Lₐ₁₈₁₅ | L_{b126} | 482 | Lₐ₁₈₁₉ | L_{b126} |
| 483 | Lₐ₁₈₂₃ | L_{b126} | 484 | Lₐ₁₈₂₉ | L_{b126} |
| 485 | Lₐ₁₈₃₃ | L_{b126} | 486 | Lₐ₁₈₃₉ | L_{b126} |
| 487 | Lₐ₁₈₄₃ | L_{b126} | 488 | Lₐ₁₈₄₉ | L_{b126} |
| 489 | Lₐ₁₈₅₃ | L_{b126} | 490 | Lₐ₁₈₅₅ | L_{b126} |
| 491 | Lₐ₁₈₅₉ | L_{b126} | 492 | Lₐ₁₈₆₃ | L_{b126} |
| 493 | Lₐ₁₈₆₅ | L_{b126} | 494 | Lₐ₁₈₆₉ | L_{b126} |
| 495 | Lₐ₁₈₇₃ | L_{b126} | 496 | Lₐ₁₈₇₅ | L_{b126} |
| 497 | Lₐ₁₈₇₉ | L_{b126} | 498 | Lₐ₁₈₈₃ | L_{b126} |
| 499 | Lₐ₁₈₈₅ | L_{b126} | 500 | Lₐ₁₈₈₉ | L_{b126} |
| 501 | Lₐ₅ | L_{b135} | 502 | Lₐ₂₁ | L_{b135} |
| 503 | Lₐ₃₅ | L_{b135} | 504 | Lₐ₆₆ | L_{b135} |
| 505 | Lₐ₆₉ | L_{b135} | 506 | Lₐ₇₀ | L_{b135} |
| 507 | Lₐ₇₄ | L_{b135} | 508 | Lₐ₁₂₁ | L_{b135} |
| 509 | Lₐ₁₄₈ | L_{b135} | 510 | Lₐ₁₇₅ | L_{b135} |
| 511 | Lₐ₂₀₇ | L_{b135} | 512 | Lₐ₂₁₂ | L_{b135} |
| 513 | Lₐ₂₃₆ | L_{b135} | 514 | Lₐ₂₅₅ | L_{b135} |
| 515 | Lₐ₂₇₁ | L_{b135} | 516 | Lₐ₂₈₇ | L_{b135} |
| 517 | Lₐ₃₁₉ | L_{b135} | 518 | Lₐ₃₂₀ | L_{b135} |
| 519 | Lₐ₃₃₅ | L_{b135} | 520 | Lₐ₃₉₉ | L_{b135} |
| 521 | Lₐ₄₃₈ | L_{b135} | 522 | Lₐ₄₅₃ | L_{b135} |
| 523 | Lₐ₄₆₉ | L_{b135} | 524 | Lₐ₄₉₇ | L_{b135} |
| 525 | Lₐ₅₀₀ | L_{b135} | 526 | Lₐ₅₂₉ | L_{b135} |
| 527 | Lₐ₆₀₁ | L_{b135} | 528 | Lₐ₆₀₆ | L_{b135} |
| 529 | Lₐ₆₃₇ | L_{b135} | 530 | Lₐ₆₆₅ | L_{b135} |
| 531 | Lₐ₆₈₉ | L_{b135} | 532 | Lₐ₆₉₉ | L_{b135} |
| 533 | Lₐ₇₀₀ | L_{b135} | 534 | Lₐ₇₄₄ | L_{b135} |
| 535 | Lₐ₇₇₇ | L_{b135} | 536 | Lₐ₇₉₃ | L_{b135} |
| 537 | Lₐ₈₁₀ | L_{b135} | 538 | Lₐ₈₄₂ | L_{b135} |
| 539 | Lₐ₈₅₀ | L_{b135} | 540 | Lₐ₉₁₇ | L_{b135} |
| 541 | Lₐ₉₈₂ | L_{b135} | 542 | Lₐ₉₈₉ | L_{b135} |
| 543 | Lₐ₁₀₁₆ | L_{b135} | 544 | Lₐ₁₀₃₁ | L_{b135} |
| 545 | Lₐ₁₀₄₇ | L_{b135} | 546 | Lₐ₁₀₇₉ | L_{b135} |
| 547 | Lₐ₁₁₆₃ | L_{b135} | 548 | Lₐ₁₁₉₁ | L_{b135} |
| 549 | Lₐ₁₁₉₈ | L_{b135} | 550 | Lₐ₁₂₃₆ | L_{b135} |
| 551 | Lₐ₁₂₄₇ | L_{b135} | 552 | Lₐ₁₂₇₆ | L_{b135} |
| 553 | Lₐ₁₃₁₃ | L_{b135} | 554 | Lₐ₁₃₃₆ | L_{b135} |
| 555 | Lₐ₁₃₄₁ | L_{b135} | 556 | Lₐ₁₃₆₄ | L_{b135} |
| 557 | Lₐ₁₃₉₅ | L_{b135} | 558 | Lₐ₁₄₃₇ | L_{b135} |
| 559 | Lₐ₁₄₅₄ | L_{b135} | 560 | Lₐ₁₄₅₅ | L_{b135} |
| 561 | Lₐ₁₄₈₀ | L_{b135} | 562 | Lₐ₁₄₈₇ | L_{b135} |
| 563 | Lₐ₁₄₉₂ | L_{b135} | 564 | Lₐ₁₅₁₀ | L_{b135} |
| 565 | Lₐ₁₅₂₃ | L_{b135} | 566 | Lₐ₁₅₃₁ | L_{b135} |
| 567 | Lₐ₁₅₇₁ | L_{b135} | 568 | Lₐ₁₅₉₁ | L_{b135} |
| 569 | Lₐ₁₆₀₈ | L_{b135} | 570 | Lₐ₁₆₀₉ | L_{b135} |
| 571 | Lₐ₁₆₂₉ | L_{b135} | 572 | Lₐ₁₆₃₀ | L_{b135} |
| 573 | Lₐ₁₆₃₈ | L_{b135} | 574 | Lₐ₁₆₈₈ | L_{b135} |
| 575 | Lₐ₁₇₀₂ | L_{b135} | 576 | Lₐ₁₇₁₇ | L_{b135} |
| 577 | Lₐ₁₇₂₃ | L_{b135} | 578 | Lₐ₁₇₅₃ | L_{b135} |
| 579 | Lₐ₁₇₆₁ | L_{b135} | 580 | Lₐ₁₈₁₃ | L_{b135} |
| 581 | Lₐ₁₈₁₅ | L_{b135} | 582 | Lₐ₁₈₁₉ | L_{b135} |
| 583 | Lₐ₁₈₂₃ | L_{b135} | 584 | Lₐ₁₈₂₉ | L_{b135} |
| 585 | Lₐ₁₈₃₃ | L_{b135} | 586 | Lₐ₁₈₃₉ | L_{b135} |
| 587 | Lₐ₁₈₄₃ | L_{b135} | 588 | Lₐ₁₈₄₉ | L_{b135} |
| 589 | Lₐ₁₈₅₃ | L_{b135} | 590 | Lₐ₁₈₅₅ | L_{b135} |
| 591 | Lₐ₁₈₅₉ | L_{b135} | 592 | Lₐ₁₈₆₃ | L_{b135} |
| 593 | Lₐ₁₈₆₅ | L_{b135} | 594 | Lₐ₁₈₆₉ | L_{b135} |
| 595 | Lₐ₁₈₇₃ | L_{b135} | 596 | Lₐ₁₈₇₅ | L_{b135} |
| 597 | Lₐ₁₈₇₉ | L_{b135} | 598 | Lₐ₁₈₈₃ | L_{b135} |
| 599 | Lₐ₁₈₈₅ | L_{b135} | 600 | Lₐ₁₈₈₉ | L_{b135} |
| 601 | Lₐ₅ | L_{b165} | 602 | Lₐ₂₁ | L_{b165} |
| 603 | Lₐ₃₅ | L_{b165} | 604 | Lₐ₆₆ | L_{b165} |
| 605 | Lₐ₆₉ | L_{b165} | 606 | Lₐ₇₀ | L_{b165} |
| 607 | Lₐ₇₄ | L_{b165} | 608 | Lₐ₁₂₁ | L_{b165} |
| 609 | Lₐ₁₄₈ | L_{b165} | 610 | Lₐ₁₇₅ | L_{b165} |
| 611 | Lₐ₂₀₇ | L_{b165} | 612 | Lₐ₂₁₂ | L_{b165} |
| 613 | Lₐ₂₃₆ | L_{b165} | 614 | Lₐ₂₅₅ | L_{b165} |
| 615 | Lₐ₂₇₁ | L_{b165} | 616 | Lₐ₂₈₇ | L_{b165} |
| 617 | Lₐ₃₁₉ | L_{b165} | 618 | Lₐ₃₂₀ | L_{b165} |
| 619 | Lₐ₃₃₅ | L_{b165} | 620 | Lₐ₃₉₉ | L_{b165} |
| 621 | Lₐ₄₃₈ | L_{b165} | 622 | Lₐ₄₅₃ | L_{b165} |
| 623 | Lₐ₄₆₉ | L_{b165} | 624 | Lₐ₄₉₇ | L_{b165} |
| 625 | Lₐ₅₀₀ | L_{b165} | 626 | Lₐ₅₂₉ | L_{b165} |
| 627 | Lₐ₆₀₁ | L_{b165} | 628 | Lₐ₆₀₆ | L_{b165} |
| 629 | Lₐ₆₃₇ | L_{b165} | 630 | Lₐ₆₆₅ | L_{b165} |
| 631 | Lₐ₆₈₉ | L_{b165} | 632 | Lₐ₆₉₉ | L_{b165} |
| 633 | Lₐ₇₀₀ | L_{b165} | 634 | Lₐ₇₄₄ | L_{b165} |
| 635 | Lₐ₇₇₇ | L_{b165} | 636 | Lₐ₇₉₃ | L_{b165} |
| 637 | Lₐ₈₁₀ | L_{b165} | 638 | Lₐ₈₄₂ | L_{b165} |
| 639 | Lₐ₈₅₀ | L_{b165} | 640 | Lₐ₉₁₇ | L_{b165} |
| 641 | Lₐ₉₈₂ | L_{b165} | 642 | Lₐ₉₈₉ | L_{b165} |
| 643 | Lₐ₁₀₁₆ | L_{b165} | 644 | Lₐ₁₀₃₁ | L_{b165} |
| 645 | Lₐ₁₀₄₇ | L_{b165} | 646 | Lₐ₁₀₇₉ | L_{b165} |
| 647 | Lₐ₁₁₆₃ | L_{b165} | 648 | Lₐ₁₁₉₁ | L_{b165} |
| 649 | Lₐ₁₁₉₈ | L_{b165} | 650 | Lₐ₁₂₃₆ | L_{b165} |
| 651 | Lₐ₁₂₄₇ | L_{b165} | 652 | Lₐ₁₂₇₆ | L_{b165} |
| 653 | Lₐ₁₃₁₃ | L_{b165} | 654 | Lₐ₁₃₃₆ | L_{b165} |
| 655 | Lₐ₁₃₄₁ | L_{b165} | 656 | Lₐ₁₃₆₄ | L_{b165} |
| 657 | Lₐ₁₃₉₅ | L_{b165} | 658 | Lₐ₁₄₃₇ | L_{b165} |
| 659 | Lₐ₁₄₅₄ | L_{b165} | 660 | Lₐ₁₄₅₅ | L_{b165} |
| 661 | Lₐ₁₄₈₀ | L_{b165} | 662 | Lₐ₁₄₈₇ | L_{b165} |
| 663 | Lₐ₁₄₉₂ | L_{b165} | 664 | Lₐ₁₅₁₀ | L_{b165} |
| 665 | Lₐ₁₅₂₃ | L_{b165} | 666 | Lₐ₁₅₃₁ | L_{b165} |
| 667 | Lₐ₁₅₇₁ | L_{b165} | 668 | Lₐ₁₅₉₁ | L_{b165} |
| 669 | Lₐ₁₆₀₈ | L_{b165} | 670 | Lₐ₁₆₀₉ | L_{b165} |
| 671 | Lₐ₁₆₂₉ | L_{b165} | 672 | Lₐ₁₆₃₀ | L_{b165} |
| 673 | Lₐ₁₆₃₈ | L_{b165} | 674 | Lₐ₁₆₈₈ | L_{b165} |
| 675 | Lₐ₁₇₀₂ | L_{b165} | 676 | Lₐ₁₇₁₇ | L_{b165} |
| 677 | Lₐ₁₇₂₃ | L_{b165} | 678 | Lₐ₁₇₅₃ | L_{b165} |
| 679 | Lₐ₁₇₆₁ | L_{b165} | 680 | Lₐ₁₈₁₃ | L_{b165} |
| 681 | Lₐ₁₈₁₅ | L_{b165} | 682 | Lₐ₁₈₁₉ | L_{b165} |
| 683 | Lₐ₁₈₂₃ | L_{b165} | 684 | Lₐ₁₈₂₉ | L_{b165} |
| 685 | Lₐ₁₈₃₃ | L_{b165} | 686 | Lₐ₁₈₃₉ | L_{b165} |
| 687 | Lₐ₁₈₄₃ | L_{b165} | 688 | Lₐ₁₈₄₉ | L_{b165} |
| 689 | Lₐ₁₈₅₃ | L_{b165} | 690 | Lₐ₁₈₅₅ | L_{b165} |
| 691 | Lₐ₁₈₅₉ | L_{b165} | 692 | Lₐ₁₈₆₃ | L_{b165} |
| 693 | Lₐ₁₈₆₅ | L_{b165} | 694 | Lₐ₁₈₆₉ | L_{b165} |
| 695 | Lₐ₁₈₇₃ | L_{b165} | 696 | Lₐ₁₈₇₅ | L_{b165} |
| 697 | Lₐ₁₈₇₉ | L_{b165} | 698 | Lₐ₁₈₈₃ | L_{b165} |
| 699 | Lₐ₁₈₈₅ | L_{b165} | 700 | Lₐ₁₈₈₉ | L_{b165} |
| 701 | Lₐ₅ | L_{b212} | 702 | Lₐ₂₁ | L_{b212} |
| 703 | Lₐ₃₅ | L_{b212} | 704 | Lₐ₆₆ | L_{b212} |
| 705 | Lₐ₆₉ | L_{b212} | 706 | Lₐ₇₀ | L_{b212} |
| 707 | Lₐ₇₄ | L_{b212} | 708 | Lₐ₁₂₁ | L_{b212} |
| 709 | Lₐ₁₄₈ | L_{b212} | 710 | Lₐ₁₇₅ | L_{b212} |
| 711 | Lₐ₂₀₇ | L_{b212} | 712 | Lₐ₂₁₂ | L_{b212} |
| 713 | Lₐ₂₃₆ | L_{b212} | 714 | Lₐ₂₅₅ | L_{b212} |
| 715 | Lₐ₂₇₁ | L_{b212} | 716 | Lₐ₂₈₇ | L_{b212} |
| 717 | Lₐ₃₁₉ | L_{b212} | 718 | Lₐ₃₂₀ | L_{b212} |
| 719 | Lₐ₃₃₅ | L_{b212} | 720 | Lₐ₃₉₉ | L_{b212} |
| 721 | Lₐ₄₃₈ | L_{b212} | 722 | Lₐ₄₅₃ | L_{b212} |
| 723 | Lₐ₄₆₉ | L_{b212} | 724 | Lₐ₄₉₇ | L_{b212} |
| 725 | Lₐ₅₀₀ | L_{b212} | 726 | Lₐ₅₂₉ | L_{b212} |
| 727 | Lₐ₆₀₁ | L_{b212} | 728 | Lₐ₆₀₆ | L_{b212} |
| 729 | Lₐ₆₃₇ | L_{b212} | 730 | Lₐ₆₆₅ | L_{b212} |
| 731 | Lₐ₆₈₉ | L_{b212} | 732 | Lₐ₆₉₉ | L_{b212} |
| 733 | Lₐ₇₀₀ | L_{b212} | 734 | Lₐ₇₄₄ | L_{b212} |
| 735 | Lₐ₇₇₇ | L_{b212} | 736 | Lₐ₇₉₃ | L_{b212} |
| 737 | Lₐ₈₁₀ | L_{b212} | 738 | Lₐ₈₄₂ | L_{b212} |
| 739 | Lₐ₈₅₀ | L_{b212} | 740 | Lₐ₉₁₇ | L_{b212} |
| 741 | Lₐ₉₈₂ | L_{b212} | 742 | Lₐ₉₈₉ | L_{b212} |
| 743 | Lₐ₁₀₁₆ | L_{b212} | 744 | Lₐ₁₀₃₁ | L_{b212} |
| 745 | Lₐ₁₀₄₇ | L_{b212} | 746 | Lₐ₁₀₇₉ | L_{b212} |
| 747 | Lₐ₁₁₆₃ | L_{b212} | 748 | Lₐ₁₁₉₁ | L_{b212} |
| 749 | Lₐ₁₁₉₈ | L_{b212} | 750 | Lₐ₁₂₃₆ | L_{b212} |
| 751 | Lₐ₁₂₄₇ | L_{b212} | 752 | Lₐ₁₂₇₆ | L_{b212} |
| 753 | Lₐ₁₃₁₃ | L_{b212} | 754 | Lₐ₁₃₃₆ | L_{b212} |
| 755 | Lₐ₁₃₄₁ | L_{b212} | 756 | Lₐ₁₃₆₄ | L_{b212} |
| 757 | Lₐ₁₃₉₅ | L_{b212} | 758 | Lₐ₁₄₃₇ | L_{b212} |
| 759 | Lₐ₁₄₅₄ | L_{b212} | 760 | Lₐ₁₄₅₅ | L_{b212} |
| 761 | Lₐ₁₄₈₀ | L_{b212} | 762 | Lₐ₁₄₈₇ | L_{b212} |
| 763 | Lₐ₁₄₉₂ | L_{b212} | 764 | Lₐ₁₅₁₀ | L_{b212} |
| 765 | Lₐ₁₅₂₃ | L_{b212} | 766 | Lₐ₁₅₃₁ | L_{b212} |
| 767 | Lₐ₁₅₇₁ | L_{b212} | 768 | Lₐ₁₅₉₁ | L_{b212} |
| 769 | Lₐ₁₆₀₈ | L_{b212} | 770 | Lₐ₁₆₀₉ | L_{b212} |
| 771 | Lₐ₁₆₂₉ | L_{b212} | 772 | Lₐ₁₆₃₀ | L_{b212} |
| 773 | Lₐ₁₆₃₈ | L_{b212} | 774 | Lₐ₁₆₈₈ | L_{b212} |
| 775 | Lₐ₁₇₀₂ | L_{b212} | 776 | Lₐ₁₇₁₇ | L_{b212} |
| 777 | Lₐ₁₇₂₃ | L_{b212} | 778 | Lₐ₁₇₅₃ | L_{b212} |
| 779 | Lₐ₁₇₆₁ | L_{b212} | 780 | Lₐ₁₈₁₃ | L_{b212} |
| 781 | Lₐ₁₈₁₅ | L_{b212} | 782 | Lₐ₁₈₁₉ | L_{b212} |
| 783 | Lₐ₁₈₂₃ | L_{b212} | 784 | Lₐ₁₈₂₉ | L_{b212} |
| 785 | Lₐ₁₈₃₃ | L_{b212} | 786 | Lₐ₁₈₃₉ | L_{b212} |
| 787 | Lₐ₁₈₄₃ | L_{b212} | 788 | Lₐ₁₈₄₉ | L_{b212} |
| 789 | Lₐ₁₈₅₃ | L_{b212} | 790 | Lₐ₁₈₅₅ | L_{b212} |
| 791 | Lₐ₁₈₅₉ | L_{b212} | 792 | Lₐ₁₈₆₃ | L_{b212} |
| 793 | Lₐ₁₈₆₅ | L_{b212} | 794 | Lₐ₁₈₆₉ | L_{b212} |
| 795 | Lₐ₁₈₇₃ | L_{b212} | 796 | Lₐ₁₈₇₅ | L_{b212} |
| 797 | Lₐ₁₈₇₉ | L_{b212} | 798 | Lₐ₁₈₈₃ | L_{b212} |
| 799 | Lₐ₁₈₈₅ | L_{b212} | 800 | Lₐ₁₈₈₉ | L_{b212} |
; wherein Compound 801 to Compound 1010 each have a structure of Ir(Lₐ)₂(L_{b}), wherein the two Lₐ are different, and the two Lₐ and L_{b} are respectively selected from the structures listed in the following table:
| Compound No. | Lₐ | Lₐ | L_{b} | Compound No. | Lₐ | Lₐ | L_{b} |
|---|---|---|---|---|---|---|---|
| 801 | Lₐ₉₈₂ | Lₐ₆₉ | L_{b31} | 802 | Lₐ₉₈₂ | Lₐ₂₀₇ | L_{b31} |
| 803 | Lₐ₉₈₂ | Lₐ₃₁₉ | L_{b31} | 804 | Lₐ₉₈₂ | Lₐ₃₉₉ | L_{b31} |
| 805 | Lₐ₉₈₂ | Lₐ₈₄₂ | L_{b31} | 806 | Lₐ₉₈₂ | Lₐ₁₄₃₇ | L_{b31} |
| 807 | Lₐ₉₈₂ | Lₐ₁₅₇₁ | L_{b31} | 808 | Lₐ₉₈₂ | Lₐ₁₆₈₈ | L_{b31} |
| 809 | Lₐ₉₈₂ | Lₐ₉₈₉ | L_{b31} | 810 | Lₐ₉₈₂ | Lₐ₁₈₁₃ | L_{b31} |
| 811 | Lₐ₉₈₂ | Lₐ₈₄₂ | L_{b31} | 812 | Lₐ₁₈₈₉ | Lₐ₁₈₁₉ | L_{b31} |
| 813 | Lₐ₉₈₂ | Lₐ₁₈₄₉ | L_{b31} | 814 | Lₐ₉₈₂ | Lₐ₁₈₆₅ | L_{b31} |
| 815 | Lₐ₉₈₂ | Lₐ₁₈₇₅ | L_{b31} | 816 | Lₐ₃₁₉ | Lₐ₁₈₆₉ | L_{b31} |
| 817 | Lₐ₂₁₂ | Lₐ₁₅₇₁ | L_{b31} | 818 | Lₐ₁₆₈₈ | Lₐ₁₈₆₅ | L_{b31} |
| 819 | Lₐ₁₄₃₇ | Lₐ₁₈₂₉ | L_{b31} | 820 | Lₐ₁₈₆₅ | Lₐ₁₈₈₅ | L_{b31} |
| 821 | Lₐ₁₅₇₁ | Lₐ₁₈₅₅ | L_{b31} | 822 | Lₐ₉₈₉ | Lₐ₁₈₇₃ | L_{b31} |
| 823 | Lₐ₈₄₂ | Lₐ₁₃₈₄ | L_{b31} | 824 | Lₐ₁₈₃₃ | Lₐ₁₈₈₉ | L_{b31} |
| 825 | Lₐ₁₈₆₉ | Lₐ₂₄ | L_{b31} | 826 | Lₐ₁₈₈₉ | Lₐ₁₃₄ | L_{b31} |
| 827 | Lₐ₁₄₃₇ | Lₐ₂₁₂ | L_{b31} | 828 | Lₐ₁₄₃₇ | Lₐ₂₀₇ | L_{b31} |
| 829 | Lₐ₁₈₁₉ | Lₐ₁₈₂₃ | L_{b31} | 830 | Lₐ₁₈₆₃ | Lₐ₁₈₆₅ | L_{b31} |
| 831 | Lₐ₉₈₂ | Lₐ₆₉ | L_{b88} | 832 | Lₐ₉₈₂ | Lₐ₂₀₇ | L_{b88} |
| 833 | Lₐ₉₈₂ | Lₐ₃₁₉ | L_{b88} | 834 | Lₐ₉₈₂ | Lₐ₃₉₉ | L_{b88} |
| 835 | Lₐ₉₈₂ | Lₐ₈₄₂ | L_{b88} | 836 | Lₐ₉₈₂ | Lₐ₁₄₃₇ | L_{b88} |
| 837 | Lₐ₉₈₂ | Lₐ₁₅₇₁ | L_{b88} | 838 | Lₐ₉₈₂ | Lₐ₁₆₈₈ | L_{b88} |
| 839 | Lₐ₉₈₂ | Lₐ₉₈₉ | L_{b88} | 840 | Lₐ₉₈₂ | Lₐ₁₈₁₃ | L_{b88} |
| 841 | Lₐ₉₈₂ | Lₐ₈₄₂ | L_{b88} | 842 | Lₐ₁₈₈₉ | Lₐ₁₈₁₉ | L_{b88} |
| 843 | Lₐ₉₈₂ | Lₐ₁₈₄₉ | L_{b88} | 844 | Lₐ₉₈₂ | Lₐ₁₈₆₅ | L_{b88} |
| 845 | Lₐ₉₈₂ | Lₐ₁₈₇₅ | L_{b88} | 846 | Lₐ₃₁₉ | Lₐ₁₈₆₉ | L_{b88} |
| 847 | Lₐ₂₁₂ | Lₐ₁₅₇₁ | L_{b88} | 848 | Lₐ₁₆₈₈ | Lₐ₁₈₆₅ | L_{b88} |
| 849 | Lₐ₁₄₃₇ | Lₐ₁₈₂₉ | L_{b88} | 850 | Lₐ₁₈₆₅ | Lₐ₁₈₈₅ | L_{b88} |
| 851 | Lₐ₁₅₇₁ | Lₐ₁₈₅₅ | L_{b88} | 852 | Lₐ₉₈₉ | Lₐ₁₈₇₃ | L_{b88} |
| 853 | Lₐ₈₄₂ | Lₐ₁₃₈₄ | L_{b88} | 854 | Lₐ₁₈₃₃ | Lₐ₁₈₈₉ | L_{b88} |
| 855 | Lₐ₁₈₆₉ | Lₐ₂₄ | L_{b88} | 856 | Lₐ₁₈₈₉ | Lₐ₁₃₄ | L_{b88} |
| 857 | Lₐ₁₄₃₇ | Lₐ₂₁₂ | L_{b88} | 858 | Lₐ₁₄₃₇ | Lₐ₂₀₇ | L_{b88} |
| 859 | Lₐ₁₈₁₉ | Lₐ₁₈₂₃ | L_{b88} | 860 | Lₐ₁₈₆₃ | Lₐ₁₈₆₅ | L_{b88} |
| 861 | Lₐ₉₈₂ | Lₐ₆₉ | L_{b122} | 862 | Lₐ₉₈₂ | Lₐ₂₀₇ | L_{b122} |
| 863 | Lₐ₉₈₂ | Lₐ₃₁₉ | L_{b122} | 864 | Lₐ₉₈₂ | Lₐ₃₉₉ | L_{b122} |
| 865 | Lₐ₉₈₂ | Lₐ₈₄₂ | L_{b122} | 866 | Lₐ₉₈₂ | Lₐ₁₄₃₇ | L_{b122} |
| 867 | Lₐ₉₈₂ | Lₐ₁₅₇₁ | L_{b122} | 868 | Lₐ₉₈₂ | Lₐ₁₆₈₈ | L_{b122} |
| 869 | Lₐ₉₈₂ | Lₐ₉₈₉ | L_{b122} | 870 | Lₐ₉₈₂ | Lₐ₁₈₁₃ | L_{b122} |
| 871 | Lₐ₉₈₂ | Lₐ₈₄₂ | L_{b122} | 872 | Lₐ₁₈₈₉ | Lₐ₁₈₁₉ | L_{b122} |
| 873 | Lₐ₉₈₂ | Lₐ₁₈₄₉ | L_{b122} | 874 | Lₐ₉₈₂ | Lₐ₁₈₆₅ | L_{b122} |
| 875 | Lₐ₉₈₂ | Lₐ₁₈₇₅ | L_{b122} | 876 | Lₐ₃₁₉ | Lₐ₁₈₆₉ | L_{b122} |
| 877 | Lₐ₂₁₂ | Lₐ₁₅₇₁ | L_{b122} | 878 | Lₐ₁₆₈₈ | Lₐ₁₈₆₅ | L_{b122} |
| 879 | Lₐ₁₄₃₇ | Lₐ₁₈₂₉ | L_{b122} | 880 | Lₐ₁₈₆₅ | Lₐ₁₈₈₅ | L_{b122} |
| 881 | Lₐ₁₅₇₁ | Lₐ₁₈₅₅ | L_{b122} | 882 | Lₐ₉₈₉ | Lₐ₁₈₇₃ | L_{b122} |
| 883 | Lₐ₈₄₂ | Lₐ₁₃₈₄ | L_{b122} | 884 | Lₐ₁₈₃₃ | Lₐ₁₈₈₉ | L_{b122} |
| 885 | Lₐ₁₈₆₉ | Lₐ₂₄ | L_{b122} | 886 | Lₐ₁₈₈₉ | Lₐ₁₃₄ | L_{b122} |
| 887 | Lₐ₁₄₃₇ | Lₐ₂₁₂ | L_{b122} | 888 | Lₐ₁₄₃₇ | Lₐ₂₀₇ | L_{b122} |
| 889 | Lₐ₁₈₁₉ | Lₐ₁₈₂₃ | L_{b122} | 890 | Lₐ₁₈₆₃ | Lₐ₁₈₆₅ | L_{b122} |
| 891 | Lₐ₉₈₂ | Lₐ₆₉ | L_{b126} | 892 | Lₐ₉₈₂ | Lₐ₂₀₇ | L_{b126} |
| 893 | Lₐ₉₈₂ | Lₐ₃₁₉ | L_{b126} | 894 | Lₐ₉₈₂ | Lₐ₃₉₉ | L_{b126} |
| 895 | Lₐ₉₈₂ | Lₐ₈₄₂ | L_{b126} | 896 | Lₐ₉₈₂ | Lₐ₁₄₃₇ | L_{b126} |
| 897 | Lₐ₉₈₂ | Lₐ₁₅₇₁ | L_{b126} | 898 | Lₐ₉₈₂ | Lₐ₁₆₈₈ | L_{b126} |
| 899 | Lₐ₉₈₂ | Lₐ₉₈₉ | L_{b126} | 900 | Lₐ₉₈₂ | Lₐ₁₈₁₃ | L_{b126} |
| 901 | Lₐ₉₈₂ | Lₐ₈₄₂ | L_{b126} | 902 | Lₐ₁₈₈₉ | Lₐ₁₈₁₉ | L_{b126} |
| 903 | Lₐ₉₈₂ | Lₐ₁₈₄₉ | L_{b126} | 904 | Lₐ₉₈₂ | Lₐ₁₈₆₅ | L_{b126} |
| 905 | Lₐ₉₈₂ | Lₐ₁₈₇₅ | L_{b126} | 906 | Lₐ₃₁₉ | Lₐ₁₈₆₉ | L_{b126} |
| 907 | Lₐ₂₁₂ | Lₐ₁₅₇₁ | L_{b126} | 908 | Lₐ₁₆₈₈ | Lₐ₁₈₆₅ | L_{b126} |
| 909 | Lₐ₁₄₃₇ | Lₐ₁₈₂₉ | L_{b126} | 910 | Lₐ₁₈₆₅ | Lₐ₁₈₈₅ | L_{b126} |
| 911 | Lₐ₁₅₇₁ | Lₐ₁₈₅₅ | L_{b126} | 912 | Lₐ₉₈₉ | Lₐ₁₈₇₃ | L_{b126} |
| 913 | Lₐ₈₄₂ | Lₐ₁₃₈₄ | L_{b126} | 914 | Lₐ₁₈₃₃ | Lₐ₁₈₈₉ | L_{b126} |
| 915 | Lₐ₁₈₆₉ | Lₐ₂₄ | L_{b126} | 916 | Lₐ₁₈₈₉ | Lₐ₁₃₄ | L_{b126} |
| 917 | Lₐ₁₄₃₇ | Lₐ₂₁₂ | L_{b126} | 918 | Lₐ₁₄₃₇ | Lₐ₂₀₇ | L_{b126} |
| 919 | Lₐ₁₈₁₉ | Lₐ₁₈₂₃ | L_{b126} | 920 | Lₐ₁₈₆₃ | Lₐ₁₈₆₅ | L_{b126} |
| 921 | Lₐ₉₈₂ | Lₐ₆₉ | L_{b135} | 922 | Lₐ₉₈₂ | Lₐ₂₀₇ | L_{b135} |
| 923 | Lₐ₉₈₂ | Lₐ₃₁₉ | L_{b135} | 924 | Lₐ₉₈₂ | Lₐ₃₉₉ | L_{b135} |
| 925 | Lₐ₉₈₂ | Lₐ₈₄₂ | L_{b135} | 926 | Lₐ₉₈₂ | Lₐ₁₄₃₇ | L_{b135} |
| 927 | Lₐ₉₈₂ | Lₐ₁₅₇₁ | L_{b135} | 928 | Lₐ₉₈₂ | Lₐ₁₆₈₈ | L_{b135} |
| 929 | Lₐ₉₈₂ | Lₐ₉₈₉ | L_{b135} | 930 | Lₐ₉₈₂ | Lₐ₁₈₁₃ | L_{b135} |
| 931 | Lₐ₉₈₂ | Lₐ₈₄₂ | L_{b135} | 932 | Lₐ₁₈₈₉ | Lₐ₁₈₁₉ | L_{b135} |
| 933 | Lₐ₉₈₂ | Lₐ₁₈₄₉ | L_{b135} | 934 | Lₐ₉₈₂ | Lₐ₁₈₆₅ | L_{b135} |
| 935 | Lₐ₉₈₂ | Lₐ₁₈₇₅ | L_{b135} | 936 | Lₐ₃₁₉ | Lₐ₁₈₆₉ | L_{b135} |
| 937 | Lₐ₂₁₂ | Lₐ₁₅₇₁ | L_{b135} | 938 | Lₐ₁₆₈₈ | Lₐ₁₈₆₅ | L_{b135} |
| 939 | Lₐ₁₄₃₇ | Lₐ₁₈₂₉ | L_{b135} | 940 | Lₐ₁₈₆₅ | Lₐ₁₈₈₅ | L_{b135} |
| 941 | Lₐ₁₅₇₁ | Lₐ₁₈₅₅ | L_{b135} | 942 | Lₐ₉₈₉ | Lₐ₁₈₇₃ | L_{b135} |
| 943 | Lₐ₈₄₂ | Lₐ₁₃₈₄ | L_{b135} | 944 | Lₐ₁₈₃₃ | Lₐ₁₈₈₉ | L_{b135} |
| 945 | Lₐ₁₈₆₉ | Lₐ₂₄ | L_{b135} | 946 | Lₐ₁₈₈₉ | Lₐ₁₃₄ | L_{b135} |
| 947 | Lₐ₁₄₃₇ | Lₐ₂₁₂ | L_{b135} | 948 | Lₐ₁₄₃₇ | Lₐ₂₀₇ | L_{b135} |
| 949 | Lₐ₁₈₁₉ | Lₐ₁₈₂₃ | L_{b135} | 950 | Lₐ₁₈₆₃ | Lₐ₁₈₆₅ | L_{b135} |
| 951 | Lₐ₉₈₂ | Lₐ₆₉ | L_{b165} | 952 | Lₐ₉₈₂ | Lₐ₂₀₇ | L_{b165} |
| 953 | Lₐ₉₈₂ | Lₐ₃₁₉ | L_{b165} | 954 | Lₐ₉₈₂ | Lₐ₃₉₉ | L_{b165} |
| 955 | Lₐ₉₈₂ | Lₐ₈₄₂ | L_{b165} | 956 | Lₐ₉₈₂ | Lₐ₁₄₃₇ | L_{b165} |
| 957 | Lₐ₉₈₂ | Lₐ₁₅₇₁ | L_{b165} | 958 | Lₐ₉₈₂ | Lₐ₁₆₈₈ | L_{b165} |
| 959 | Lₐ₉₈₂ | Lₐ₉₈₉ | L_{b165} | 960 | Lₐ₉₈₂ | Lₐ₁₈₁₃ | L_{b165} |
| 961 | Lₐ₉₈₂ | Lₐ₈₄₂ | L_{b165} | 962 | Lₐ₁₈₈₉ | Lₐ₁₈₁₉ | L_{b165} |
| 963 | Lₐ₉₈₂ | Lₐ₁₈₄₉ | L_{b165} | 964 | Lₐ₉₈₂ | Lₐ₁₈₆₅ | L_{b165} |
| 965 | Lₐ₉₈₂ | Lₐ₁₈₇₅ | L_{b165} | 966 | Lₐ₃₁₉ | Lₐ₁₈₆₉ | L_{b165} |
| 967 | Lₐ₂₁₂ | Lₐ₁₅₇₁ | L_{b165} | 968 | Lₐ₁₆₈₈ | Lₐ₁₈₆₅ | L_{b165} |
| 969 | Lₐ₁₄₃₇ | Lₐ₁₈₂₉ | L_{b165} | 970 | Lₐ₁₈₆₅ | Lₐ₁₈₈₅ | L_{b165} |
| 971 | Lₐ₁₅₇₁ | Lₐ₁₈₅₅ | L_{b165} | 972 | Lₐ₉₈₉ | Lₐ₁₈₇₃ | L_{b165} |
| 973 | Lₐ₈₄₂ | Lₐ₁₃₈₄ | L_{b165} | 974 | Lₐ₁₈₃₃ | Lₐ₁₈₈₉ | L_{b165} |
| 975 | Lₐ₁₈₆₉ | Lₐ₂₄ | L_{b165} | 976 | Lₐ₁₈₈₉ | Lₐ₁₃₄ | L_{b165} |
| 977 | Lₐ₁₄₃₇ | Lₐ₂₁₂ | L_{b165} | 978 | Lₐ₁₄₃₇ | Lₐ₂₀₇ | L_{b165} |
| 979 | Lₐ₁₈₁₉ | Lₐ₁₈₂₃ | L_{b165} | 980 | Lₐ₁₈₆₃ | Lₐ₁₈₆₅ | L_{b165} |
| 981 | Lₐ₉₈₂ | Lₐ₆₉ | L_{b212} | 982 | Lₐ₉₈₂ | Lₐ₂₀₇ | L_{b212} |
| 983 | Lₐ₉₈₂ | Lₐ₃₁₉ | L_{b212} | 984 | Lₐ₉₈₂ | Lₐ₃₉₉ | L_{b212} |
| 985 | Lₐ₉₈₂ | Lₐ₈₄₂ | L_{b212} | 986 | Lₐ₉₈₂ | Lₐ₁₄₃₇ | L_{b212} |
| 987 | Lₐ₉₈₂ | Lₐ₁₅₇₁ | L_{b212} | 988 | Lₐ₉₈₂ | Lₐ₁₆₈₈ | L_{b212} |
| 989 | Lₐ₉₈₂ | Lₐ₉₈₉ | L_{b212} | 990 | Lₐ₉₈₂ | Lₐ₁₈₁₃ | L_{b212} |
| 991 | Lₐ₉₈₂ | Lₐ₈₄₂ | L_{b212} | 992 | Lₐ₁₈₈₉ | Lₐ₁₈₁₉ | L_{b212} |
| 993 | Lₐ₉₈₂ | Lₐ₁₈₄₉ | L_{b212} | 994 | Lₐ₉₈₂ | Lₐ₁₈₆₅ | L_{b212} |
| 995 | Lₐ₉₈₂ | Lₐ₁₈₇₅ | L_{b212} | 996 | Lₐ₃₁₉ | Lₐ₁₈₆₉ | L_{b212} |
| 997 | Lₐ₂₁₂ | Lₐ₁₅₇₁ | L_{b212} | 998 | Lₐ₁₆₈₈ | Lₐ₁₈₆₅ | L_{b212} |
| 999 | Lₐ₁₄₃₇ | Lₐ₁₈₂₉ | L_{b212} | 1000 | Lₐ₁₈₆₅ | Lₐ₁₈₈₅ | L_{b212} |
| 1001 | Lₐ₁₅₇₁ | Lₐ₁₈₅₅ | L_{b212} | 1002 | Lₐ₉₈₉ | Lₐ₁₈₇₃ | L_{b212} |
| 1003 | Lₐ₈₄₂ | Lₐ₁₃₈₄ | L_{b212} | 1004 | Lₐ₁₈₃₃ | Lₐ₁₈₈₉ | L_{b212} |
| 1005 | Lₐ₁₈₆₉ | Lₐ₂₄ | L_{b212} | 1006 | Lₐ₁₈₈₉ | Lₐ₁₃₄ | L_{b212} |
| 1007 | Lₐ₁₄₃₇ | Lₐ₂₁₂ | L_{b212} | 1008 | Lₐ₁₄₃₇ | Lₐ₂₀₇ | L_{b212} |
| 1009 | Lₐ₁₈₁₉ | Lₐ₁₈₂₃ | L_{b212} | 1010 | Lₐ₁₈₆₃ | Lₐ₁₈₆₅ | L_{b212} |

15. An electroluminescent device, comprising:
an anode,
a cathode and
an organic layer disposed between the anode and the cathode, wherein the organic layer comprises the metal complex according to any one of claims 1 to 14;
preferably, the organic layer is a light-emitting layer, and the metal complex is a light-emitting material;
preferably, the electroluminescent device emits red light or white light;
more preferably, the at least one host material comprises at least one chemical group selected from the group consisting of: benzene, pyridine, pyrimidine, triazine, carbazole, azacarbazole, indolocarbazole, dibenzothiophene, aza-dibenzothiophene, dibenzofuran, azadibenzofuran, dibenzoselenophene, triphenylene, azatriphenylene, fluorene, silafluorene, naphthalene, quinoline, isoquinoline, quinazoline, quinoxaline, phenanthrene, azaphenanthrene and combinations thereof.

16. A compound combination, comprising the metal complex according to any one of claims 1 to 14.

## Patentansprüche

1. Metallkomplex umfassend ein Metall M und einen Liganden Lₐ, der an das Metall M koordiniert ist, wobei das Metall M aus einem Metall mit einer relativen Atommasse von mehr als 40 ausgewählt ist und der Ligand Lₐ eine durch Formel 1 dargestellte Struktur hat: 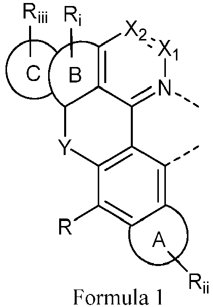
wobei der Ring A und der Ring B jeweils unabhängig voneinander aus einem fünfgliedrigen ungesättigten carbocyclischen Ring, einem aromatischen Ring mit 6 bis 30 Kohlenstoffatomen oder einem heteroaromatischen Ring mit 3 bis 30 Kohlenstoffatomen ausgewählt sind; und der Ring C aus einem aromatischen Ring mit 6 bis 30 Kohlenstoffatomen oder einem heteroaromatischen Ring mit 6 bis 30 Ringatomen ausgewählt ist;
Rᵢ und R;; stehen bei jedem Auftreten identisch oder unterschiedlich für Monosubstitution, Mehrfachsubstitution oder Nichtsubstitution; und Rᵢᵢᵢ steht bei jedem Auftreten identisch oder unterschiedlich für Monosubstitution oder Mehrfachsubstitution;
Y ist ausgewählt aus SiR_{y}R_{y}, GeR_{y}R_{y}, O, S oder Se;
wenn zwei R_{y} gleichzeitig vorhanden sind, können die beiden R_{y} identisch oder unterschiedlich sein;
X₁ und X₂ sind bei jedem Auftreten identisch oder unterschiedlich ausgewählt aus CRₓ oder N;
R, Rᵢ, Rᵢᵢ , Rₓ und R_{y} sind bei jedem Auftreten identisch oder unterschiedlich ausgewählt aus der Gruppe bestehend aus: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon;
Rᵢᵢᵢ ist bei jedem Auftreten identisch oder unterschiedlich ausgewählt aus der Gruppe bestehend aus: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon;
wobei substituiertes Alkyl, substituiertes Cycloalkyl, substituiertes Heteroalkyl, substituierte heterocyclische Gruppe, substituiertes Arylalkyl, substituiertes Alkoxy, substituiertes Aryloxy, substituiertes Alkenyl, substituiertes Aryl, substituiertes Heteroaryl, substituiertes Alkylsilyl, substituiertes Arylsilyl, substituiertes Alkylgermanyl, substituiertes Arylgermanyl und substituiertes Amino mit einer oder mehreren Gruppen substituiert sind, die ausgewählt sind aus der Gruppe bestehend aus Deuterium, Halogen, unsubstituiertem Alkyl mit 1 bis 20 Kohlenstoffatomen, unsubstituiertem Cycloalkyl mit 3 bis 20 Ringkohlenstoffatomen, unsubstituiertem Heteroalkyl mit 1 bis 20 Kohlenstoffatomen, einer unsubstituierten heterocyclischen Gruppe mit 3 bis 20 Ringatomen, unsubstituiertem Arylalkyl mit 7 bis 30 Kohlenstoffatomen, unsubstituiertem Alkoxy mit 1 bis 20 Kohlenstoffatomen, unsubstituiertes Aryloxy mit 6 bis 30 Kohlenstoffatomen, unsubstituiertes Alkenyl mit 2 bis 20 Kohlenstoffatomen, unsubstituiertes Alkinyl mit 2 bis 20 Kohlenstoffatomen, unsubstituiertes Aryl mit 6 bis 30 Kohlenstoffatomen, unsubstituiertes Heteroaryl mit 3 bis 30 Kohlenstoffatomen, unsubstituiertes Alkylsilyl mit 3 bis 20 Kohlenstoffatomen, unsubstituierte Arylsilylgruppe mit 6 bis 20 Kohlenstoffatomen, unsubstituierte Alkylgermanylgruppe mit 3 bis 20 Kohlenstoffatomen, unsubstituierte Arylgermanylgruppe mit 6 bis 20 Kohlenstoffatomen, unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon; und
benachbarte Substituenten Rᵢ, Rₓ, R_{y}, R, Rᵢᵢ und Rᵢᵢᵢ optional zu einem Ring verbunden sind.

2. Metallkomplex nach Anspruch 1, wobei der Ring A und/oder der Ring B jeweils unabhängig voneinander ausgewählt sind aus einem fünfgliedrigen ungesättigten carbocyclischen Ring, einem aromatischen Ring mit 6 bis 18 Kohlenstoffatomen oder einem heteroaromatischen Ring mit 3 bis 18 Kohlenstoffatomen; und der Ring C ausgewählt ist aus einem aromatischen Ring mit 6 bis 18 Kohlenstoffatomen oder einem heteroaromatischen Ring mit 6 bis 18 Ringatomen; und
bevorzugt der Ring A und/oder der Ring B jeweils unabhängig voneinander ausgewählt sind aus einem fünfgliedrigen ungesättigten carbocyclischen Ring, einem aromatischen Ring mit 6 bis 10 Kohlenstoffatomen oder einem heteroaromatischen Ring mit 3 bis 10 Kohlenstoffatomen; und der Ring C ausgewählt ist aus einem aromatischen Ring mit 6 bis 10 Kohlenstoffatomen oder einem heteroaromatischen Ring mit 6 bis 10 Ringatomen.

3. Metallkomplex nach Anspruch 1 oder 2, wobei Lₐ aus einer Struktur ausgewählt ist, die durch eine der Formeln 2 bis 17 dargestellt ist: 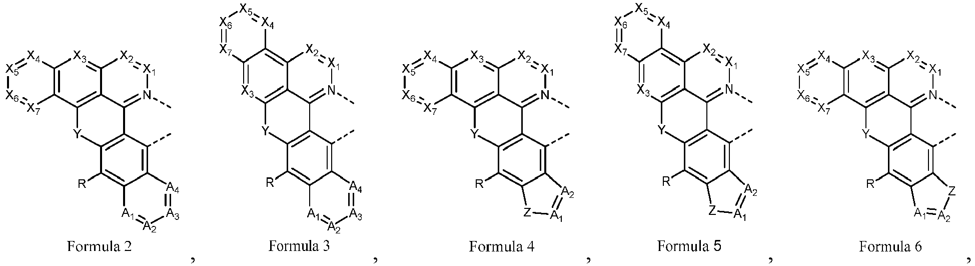 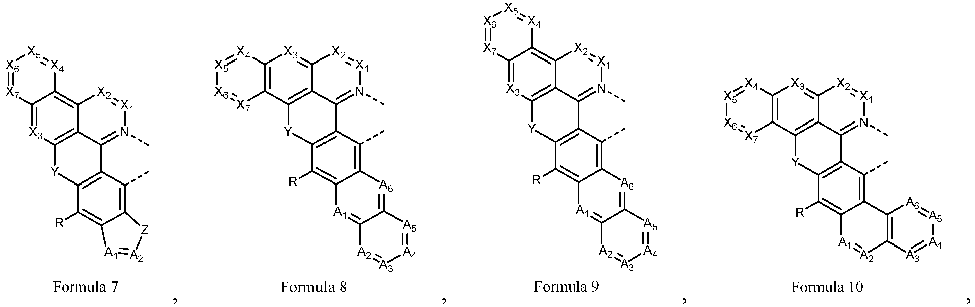 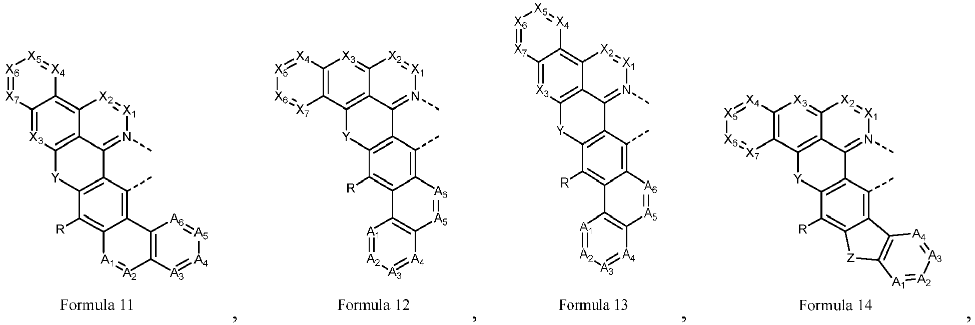 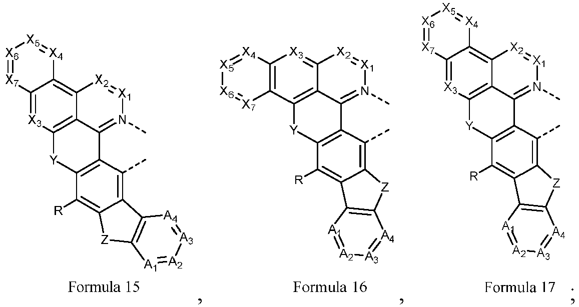 wobei
in Formel 2 bis Formel 17, X₁ und X₂ bei jedem Auftreten identisch oder unterschiedlich ausgewählt sind aus CRₓ oder N; bevorzugt ist X₁ ausgewählt aus CRₓ; X₃ ist ausgewählt aus CRᵢ oder N; A₁ bis A₆ sind bei jedem Auftreten identisch oder unterschiedlich ausgewählt aus CRᵢᵢ oder N; X₄ bis X₇ sind bei jedem Auftreten identisch oder unterschiedlich ausgewählt aus CH, CRᵢᵢᵢ oder N, und mindestens eines von X₄ bis X₇ ist ausgewählt aus CRᵢᵢᵢ;
Z ist bei jedem Auftreten identisch oder unterschiedlich ausgewählt aus CRᵢᵥRᵢᵥ, SiRᵢᵥRᵢᵥ, PRᵢᵥ, O, S or NRᵢᵥ; wenn zwei Rᵢᵥ gleichzeitig vorhanden sind, sind die beiden Rᵢᵥ identisch oder unterschiedlich;
Y ist ausgewählt aus SiR_{y}R_{y}, O, S oder Se; wenn zwei R_{y} gleichzeitig vorhanden sind, sind die beiden R_{y} identisch oder unterschiedlich; bevorzugt ist Y ausgewählt aus O oder S;
R, Rₓ, R_{y}, Rᵢ, Rᵢᵢ und Rᵢᵥ sind bei jedem Auftreten identisch oder unterschiedlich ausgewählt aus der Gruppe bestehend aus: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon;
Rᵢᵢᵢ ist bei jedem Auftreten identisch oder unterschiedlich ausgewählt aus der Gruppe bestehend aus: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon;
benachbarte Substituenten Rᵢ, Rₓ, R_{y}, R, Rᵢᵢ, Rᵢᵢᵢ und Rᵢᵥ optional zu einem Ring verbunden sind;
bevorzugt ist Lₐ ausgewählt aus einer Struktur, die durch Formel 2 oder Formel 3 dargestellt ist; und
noch bevorzugter ist Lₐ ausgewählt aus einer Struktur, die durch Formel 3 dargestellt ist.

4. Metallkomplex nach Anspruch 3, wobei in Formel 2 bis Formel 17 mindestens eines von X₁ bis Xₙ und/oder A₁ bis Aₘ aus N ausgewählt ist, wobei Xₙ einem mit der größten fortlaufenden Nummer unter X₁ bis X₇ in einer der Formeln 2 bis Formel 17 entspricht und Aₘ einem mit der größten fortlaufenden Nummer unter A₁ bis A₆ in einer der Formeln 2 bis Formel 17 entspricht;
bevorzugt ist in den Formeln 2 bis 17 mindestens eines von X₁ bis Xₙ aus N ausgewählt, wobei Xₙ demj enigen mit der größten fortlaufenden Nummer unter X₁ bis X₇ in einer der Formeln 2 bis 17 entspricht; und
besonders bevorzugt ist X₂ N.

5. Metallkomplex nach Anspruch 3, wobei in Formel 2 bis Formel 17 X₁ und X₂ jeweils unabhängig voneinander ausgewählt sind aus CRₓ; X₃ ausgewählt ist aus CRi; A₁ bis A₆ jeweils unabhängig voneinander ausgewählt sind aus CRᵢᵢ, X₄ bis X₇ sind bei jedem Auftreten identisch oder unterschiedlich ausgewählt aus CH oder CRᵢᵢᵢ, und mindestens eines von X₄ bis X₇ ist ausgewählt aus CRᵢᵢᵢ; benachbarte Substituenten Rₓ, Rᵢ, Rᵢᵢ und Rᵢᵢᵢ optional zu einem Ring verbunden sind;
bevorzugt sind Rₓ, Rᵢ und Rᵢᵢ bei jedem Auftreten identisch oder unterschiedlich ausgewählt aus der Gruppe bestehend aus: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, einer Cyanogruppe und Kombinationen davon;
Rᵢᵢᵢ ist bei jedem Auftreten identisch oder unterschiedlich ausgewählt aus der Gruppe bestehend aus: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, einer Cyanogruppe und Kombinationen davon;
besonders bevorzugt ist/sind mindestens eines oder zwei von Rₓ, Rᵢ und Rᵢᵢ bei jedem Auftreten identisch oder unterschiedlich ausgewählt aus der Gruppe bestehend aus: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, einer Cyanogruppe und Kombinationen davon; und
Rᵢᵢᵢ ist bei jedem Auftreten identisch oder unterschiedlich ausgewählt aus der Gruppe bestehend aus: Deuterium, Fluor, Methyl, Ethyl, Isopropyl, Isobutyl, *t-Butyl,* Neopentyl, Cyclopentyl, Cyclopentylmethyl, Cyclohexyl, Norbornyl, Adamantyl, Trimethylsilyl, Isopropyldimethylsilyl, Phenyldimethylsilyl, Trifluormethyl, einer Cyanogruppe, Phenyl und Kombinationen davon.

6. Metallkomplex nach einem der Ansprüche 3 bis 5, wobei in den Formeln 2 bis 17 mindestens eines oder zwei von A₁ bis A₆ ausgewählt ist/sind aus CRᵢᵢ, und das Rᵢᵢ bei jedem Auftreten identisch oder unterschiedlich ausgewählt ist aus Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, einer Cyanogruppe oder einer Kombination davon;
X₃ ist ausgewählt aus CRᵢ, und Rᵢ ist bei jedem Auftreten identisch oder unterschiedlich ausgewählt aus Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, einer Cyanogruppe oder einer Kombination davon;
bevorzugt ist Rᵢ bei jedem Auftreten identisch oder unterschiedlich ausgewählt aus der Gruppe bestehend aus: Wasserstoff, Deuterium, Fluor, Methyl, Ethyl, Isopropyl, Isobutyl, *t-Butyl,* Neopentyl, Cyclopentyl, Cyclopentylmethyl, Cyclohexyl, Norbornyl, Adamantyl, Trimethylsilyl, Isopropyldimethylsilyl, Phenyldimethylsilyl, Trifluormethyl, einer Cyanogruppe, Phenyl und Kombinationen davon; und
Rᵢᵢ ist bei jedem Auftreten identisch oder unterschiedlich ausgewählt aus der Gruppe bestehend aus: Deuterium, Fluor, Methyl, Ethyl, Isopropyl, Isobutyl, *t-Butyl,* Neopentyl, Cyclopentyl, Cyclopentylmethyl, Cyclohexyl, Norbornyl, Adamantyl, Trimethylsilyl, Isopropyldimethylsilyl, Phenyldimethylsilyl, Trifluormethyl, einer Cyanogruppe, Phenyl und Kombinationen davon.

7. Metallkomplex nach einem der Ansprüche 3 bis 6, wobei in Formel 2 bis Formel 17 R ausgewählt ist aus Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen oder einer Kombination davon; und
bevorzugt ist R ausgewählt aus Wasserstoff, Deuterium, Fluor, Methyl, Ethyl, Isopropyl, Isobutyl, *t-Butyl,* Cyclopentyl, Cyclopentylmethyl, Cyclohexyl, Neopentyl, deuteriertem Methyl, deuteriertem Ethyl, deuteriertes Isopropyl, deuteriertes Isobutyl, deuteriertes *t-Butyl,* deuteriertes Cyclopentyl, deuteriertes Cyclopentylmethyl, deuteriertes Cyclohexyl, deuteriertes Neopentyl, Trimethylsilyl oder eine Kombination davon.

8. Metallkomplex nach einem der Ansprüche 1 bis 7, wobei der Ligand Lₐ eine durch Formel 18 dargestellte Struktur hat: 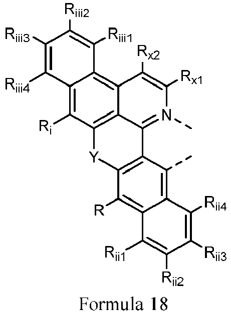
wobei in Formel 18 Y ausgewählt ist aus O oder S;
Rₓ₁, Rₓ₂, Rᵢ, Rᵢᵢ₁, Rᵢᵢ₂, Rᵢᵢ₃, Rᵢᵢ₄, R, Rᵢᵢᵢ₁, Rᵢᵢᵢ₂, Rᵢᵢᵢ₃ und Rᵢᵢᵢ₄ sind bei jedem Auftreten identisch oder unterschiedlich ausgewählt aus der Gruppe bestehend aus: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon; mindestens eines von Rᵢᵢᵢ₁, Rᵢᵢᵢ₂, Rᵢᵢᵢ₃ und Rᵢᵢᵢ₄ bei jedem Auftreten identisch oder unterschiedlich ausgewählt ist aus der Gruppe bestehend aus: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon;
bevorzugt ist/sind eines oder zwei von Rₓ₁ und Rₓ₂ und/oder mindestens eines oder zwei von Rᵢᵢ₁, Rᵢᵢ₂, Rᵢᵢ₃ und Rᵢᵢ₄ bei jedem Auftreten identisch oder unterschiedlich ausgewählt aus Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen oder einer Kombination davon; R ist ausgewählt aus Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen oder einer Kombination davon; mindestens eines oder zwei von Rᵢᵢᵢ₁, Rᵢᵢᵢ₂, Rᵢᵢᵢ₃ und Rᵢᵢᵢ₄ ist/sind bei jedem Auftreten identisch oder unterschiedlich ausgewählt aus der Gruppe bestehend aus: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen und Kombinationen davon;
besonders bevorzugt ist/sind eines oder zwei von Rₓ₁ und Rₓ₂ und/oder mindestens eines oder zwei von Rᵢᵢ₁, Rᵢᵢ₂, Rᵢᵢ₃ und Rᵢᵢ₄ bei jedem Auftreten identisch oder unterschiedlich ausgewählt aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen oder einer Kombination davon; R ausgewählt ist aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen oder einer Kombination davon; und
mindestens eines oder zwei von Rᵢᵢᵢ₁, Rᵢᵢᵢ₂, Rᵢᵢᵢ₃ und Rᵢᵢᵢ₄ ist/sind bei jedem Auftreten identisch oder unterschiedlich ausgewählt aus der Gruppe bestehend aus: substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen und Kombinationen davon.

9. Metallkomplex nach Anspruch 8, wobei in Formel 18 mindestens eines von Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ und R bei jedem Auftreten identisch oder unterschiedlich ausgewählt ist aus der Gruppe bestehend aus: substituiertem oder unsubstituiertem Alkyl mit 3 bis 20 Kohlenstoffatomen, substituiertem oder unsubstituiertem Cycloalkyl mit 3 bis 20 Ringkohlenstoffatomen, substituiertem oder unsubstituiertem Alkylsilyl mit 3 bis 20 Kohlenstoffatomen und Kombinationen davon; und
bevorzugt ist mindestens eines von Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ und R bei jedem Auftreten identisch oder unterschiedlich ausgewählt aus der Gruppe bestehend aus: substituiertem oder unsubstituiertem Alkyl mit 3 bis 10 Kohlenstoffatomen, substituiertem oder unsubstituiertem Cycloalkyl mit 3 bis 10 Ringkohlenstoffatomen und Kombinationen davon.

10. Metallkomplex nach einem der Ansprüche 1 bis 9, wobei Lₐ bei jedem Auftreten identisch oder unterschiedlich aus der Gruppe bestehend aus den folgenden Strukturen ausgewählt ist: 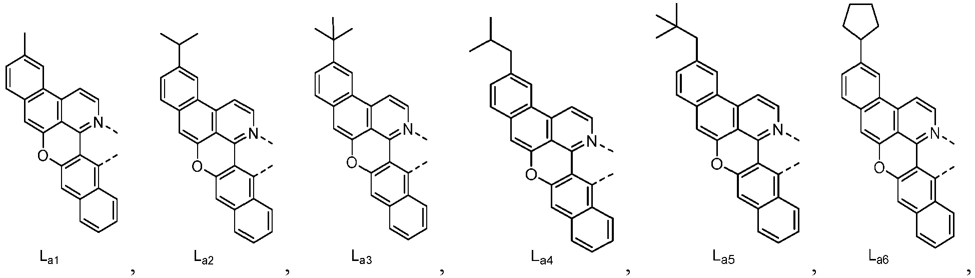 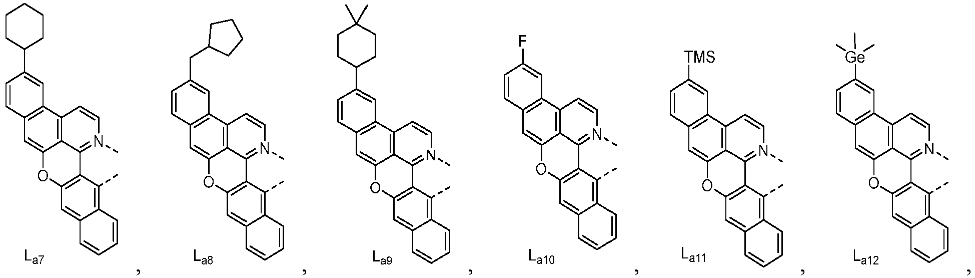 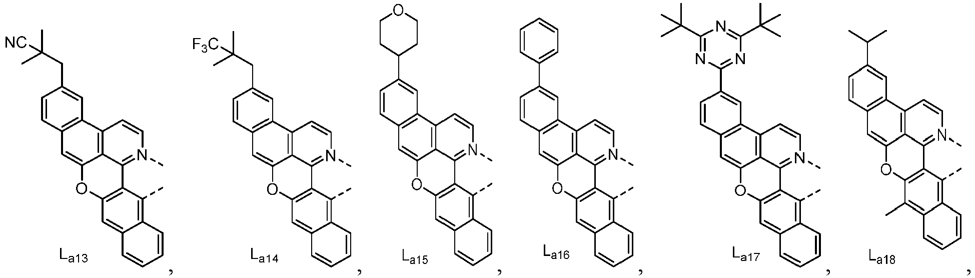 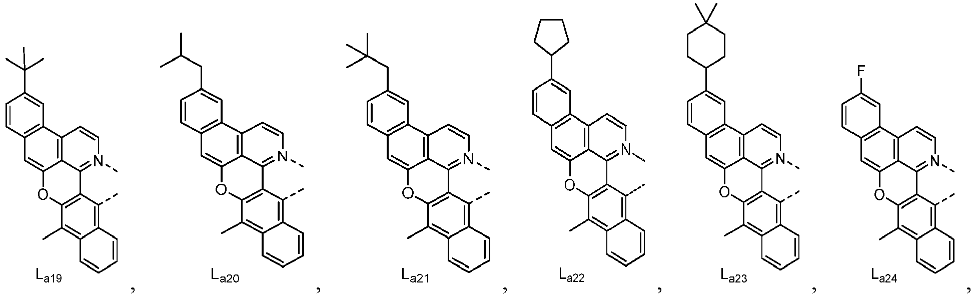 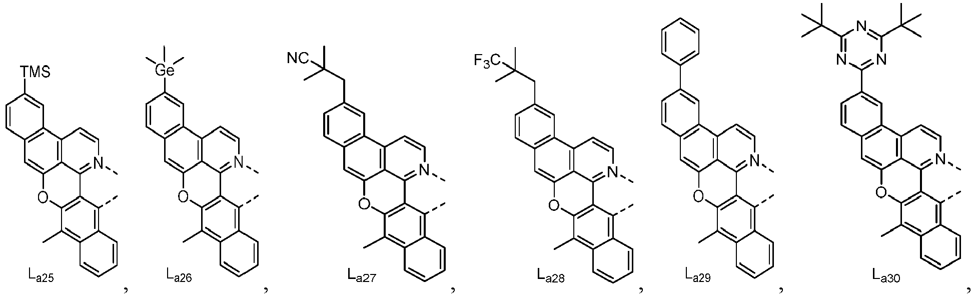 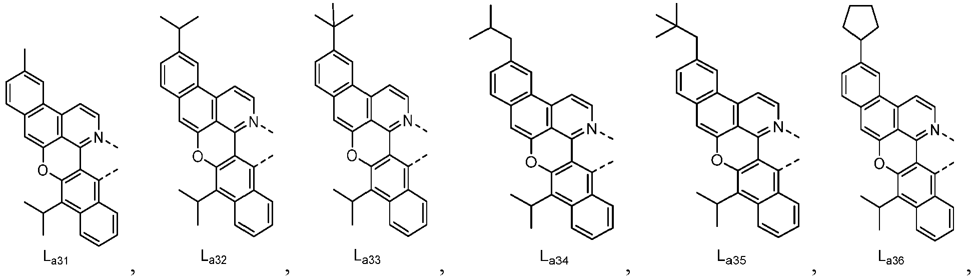 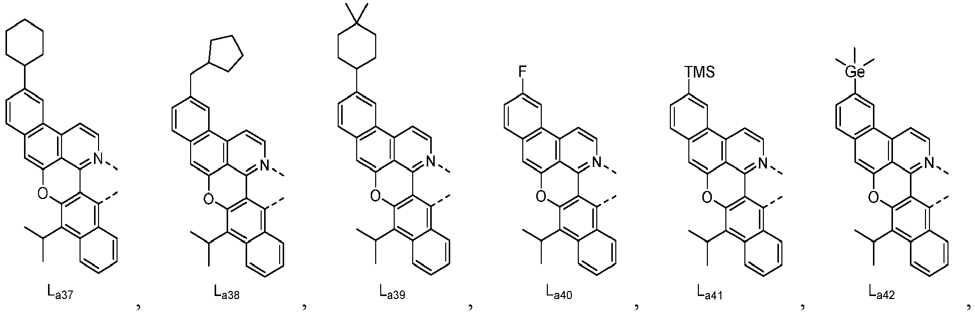 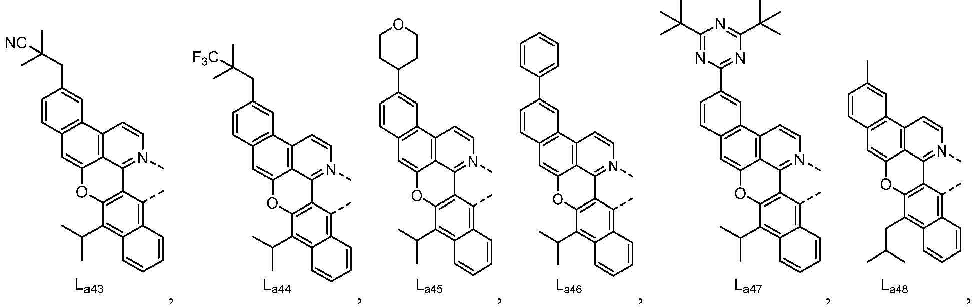 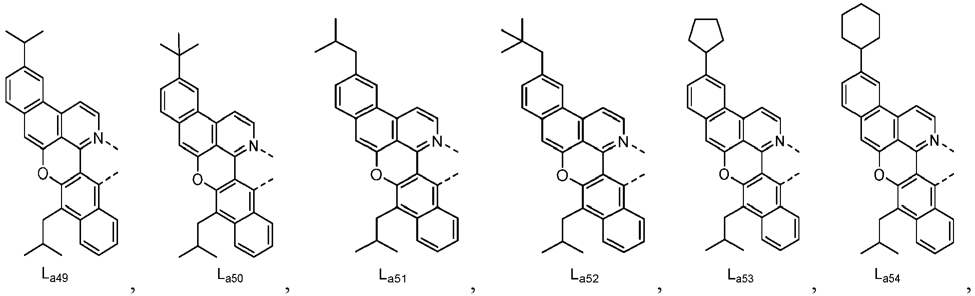 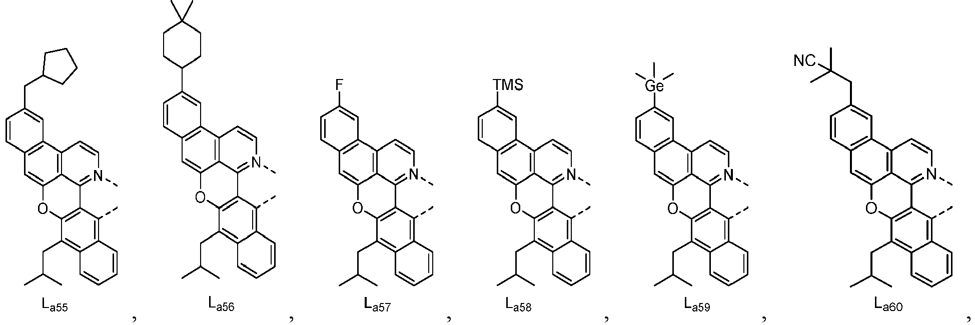 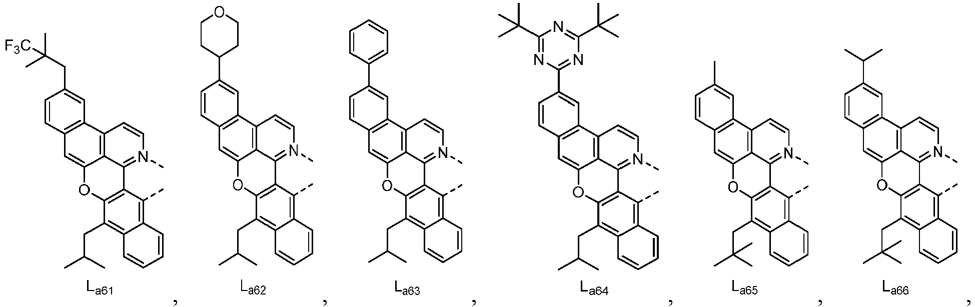 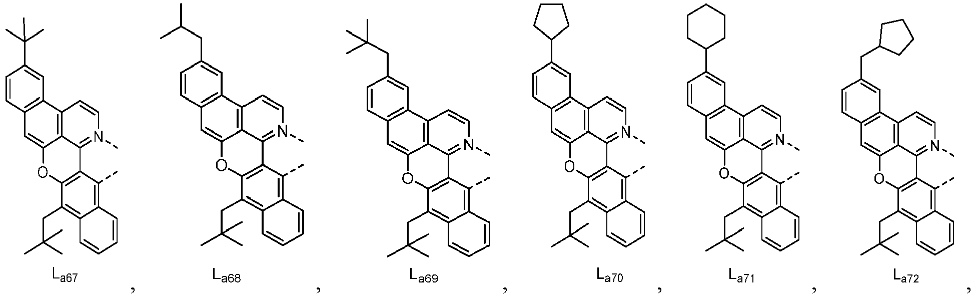 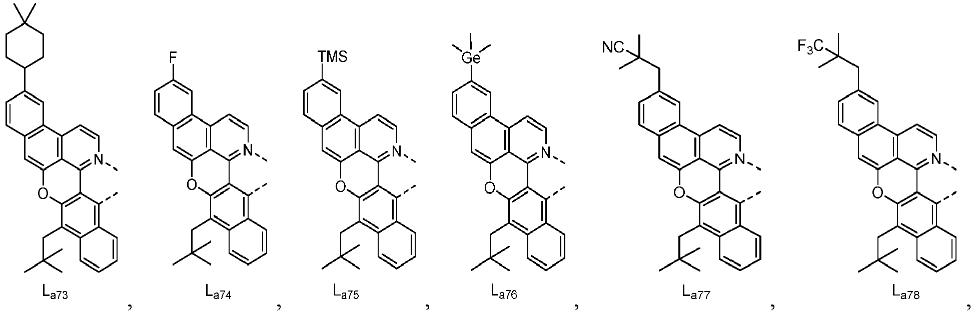 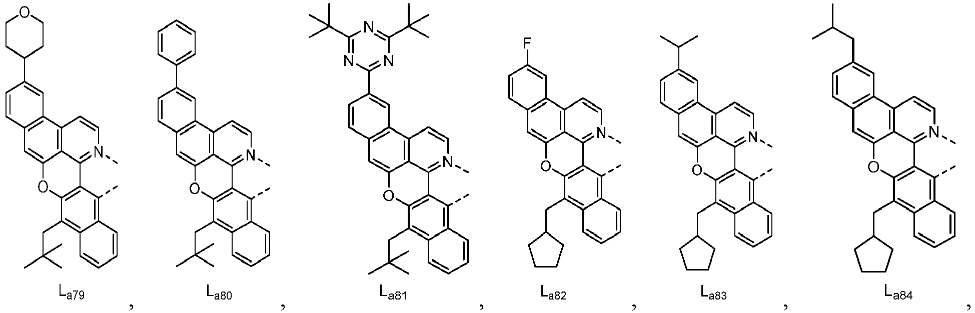 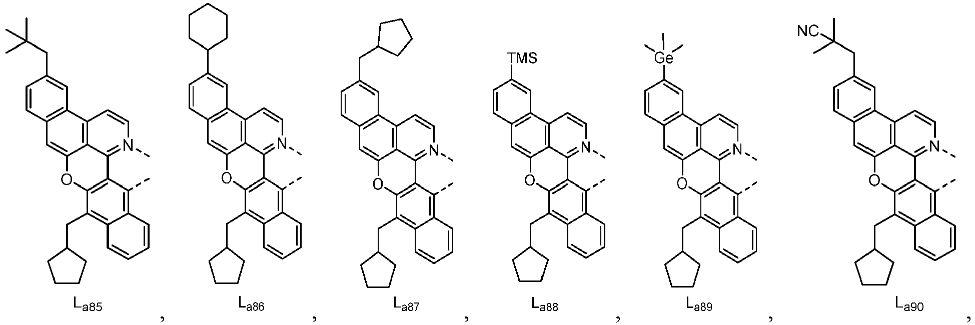 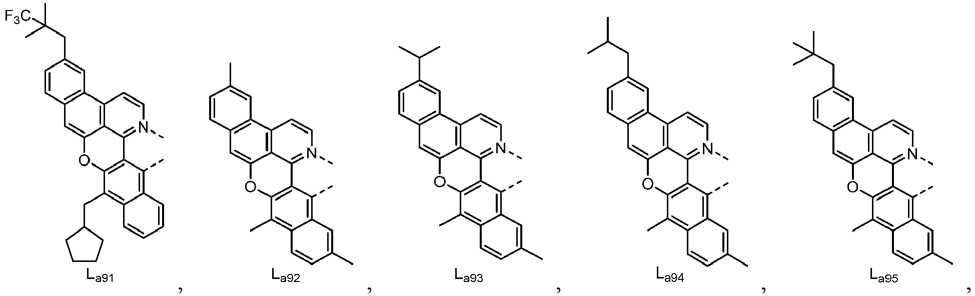 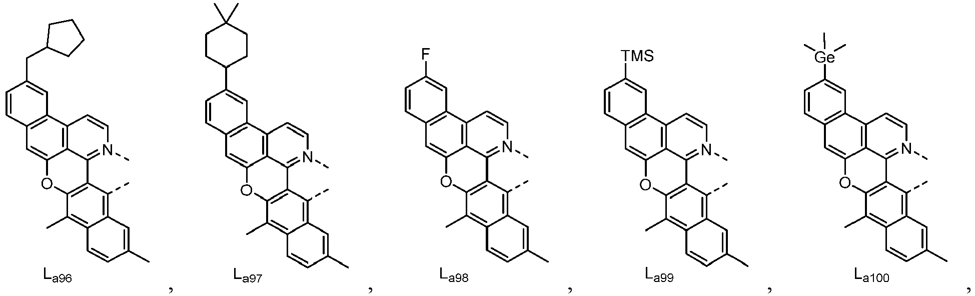 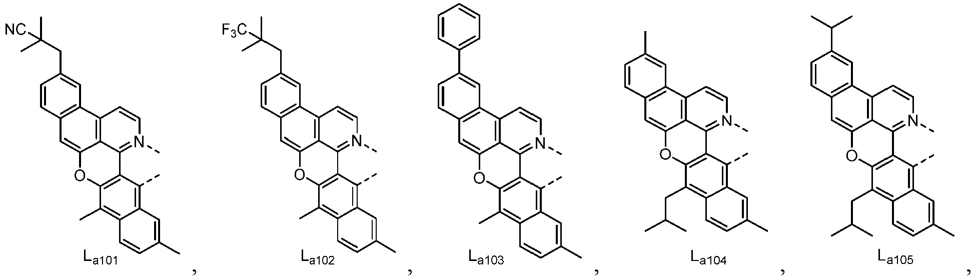 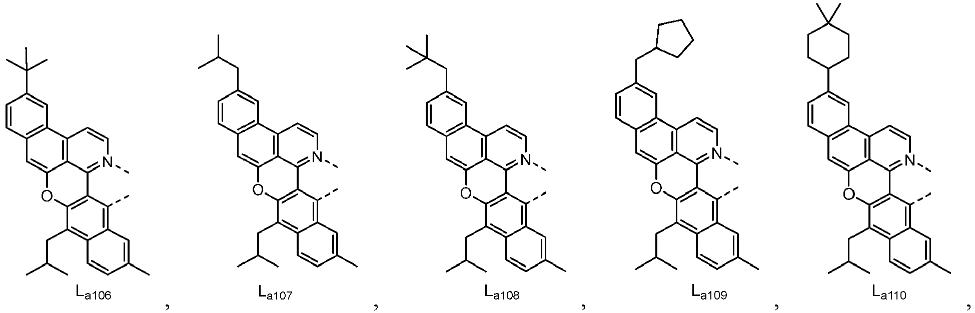 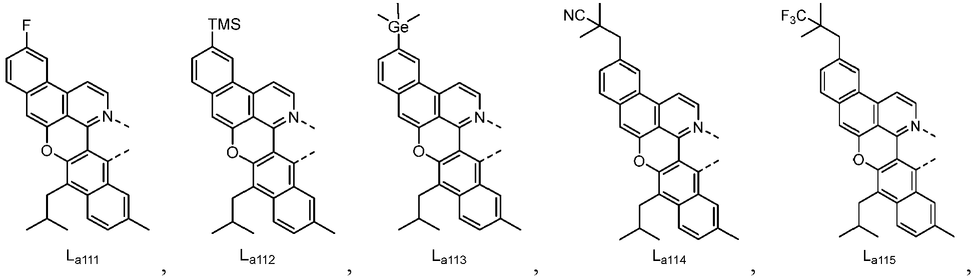 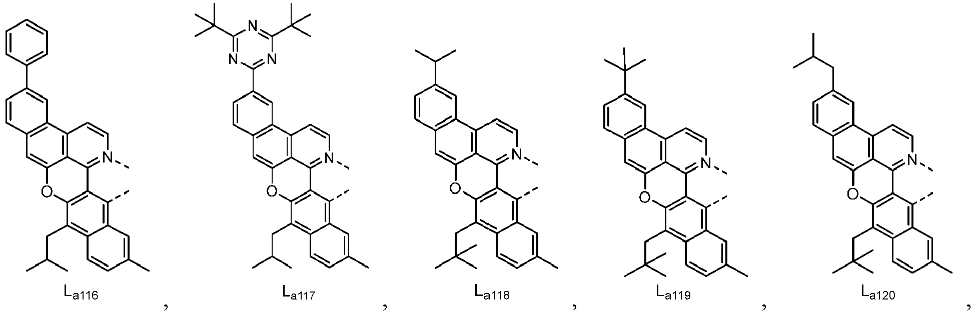 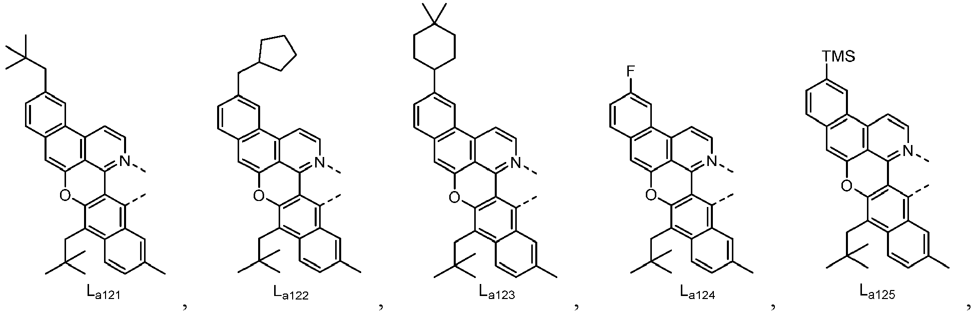 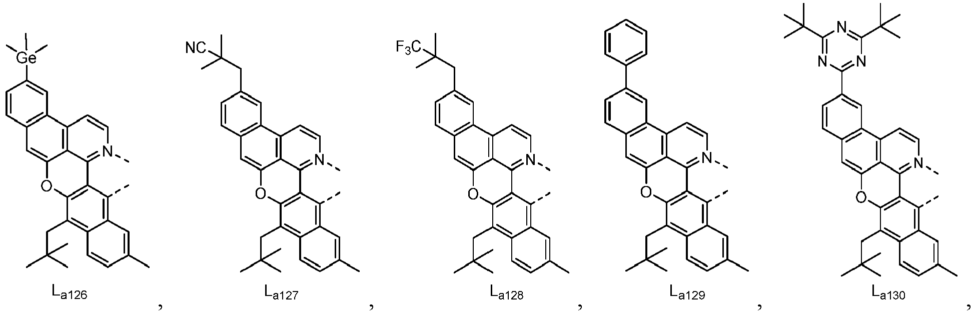 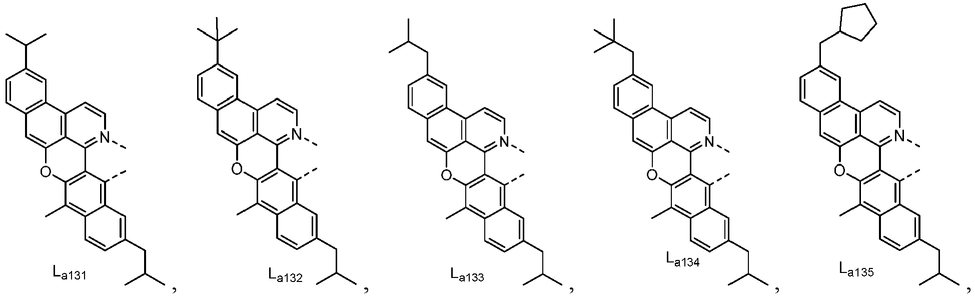 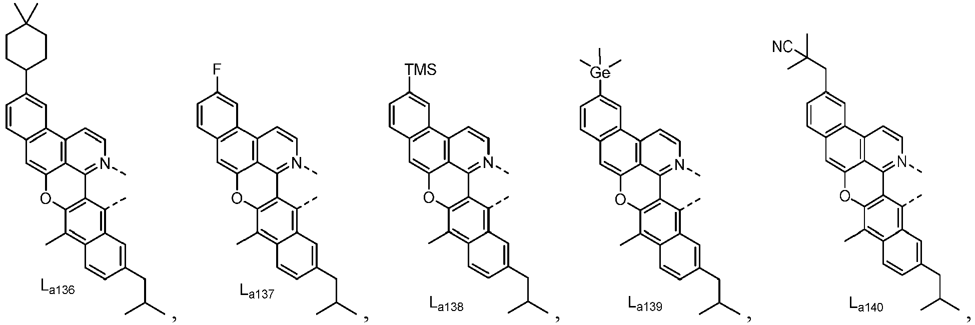 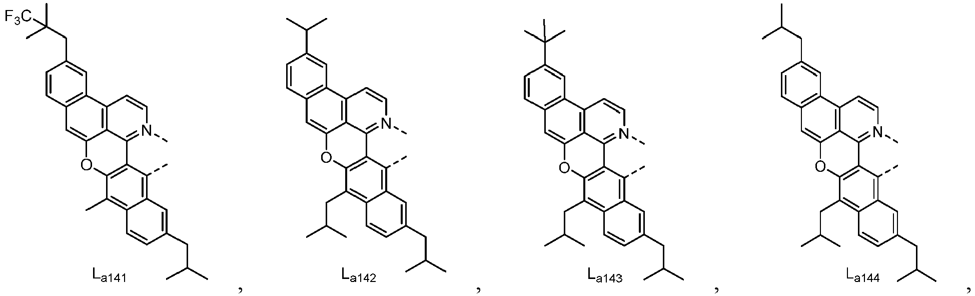 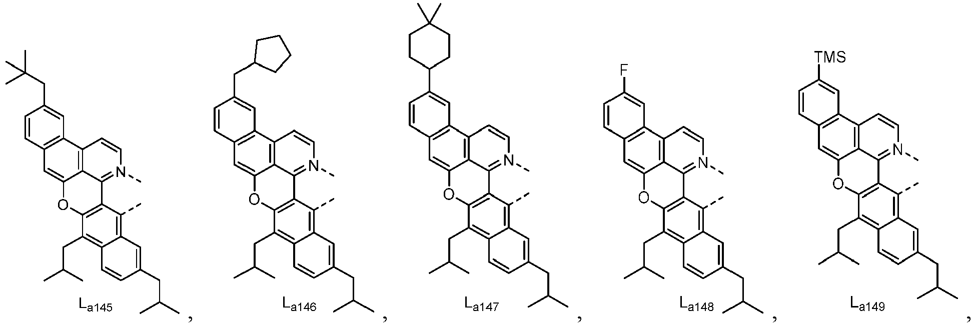 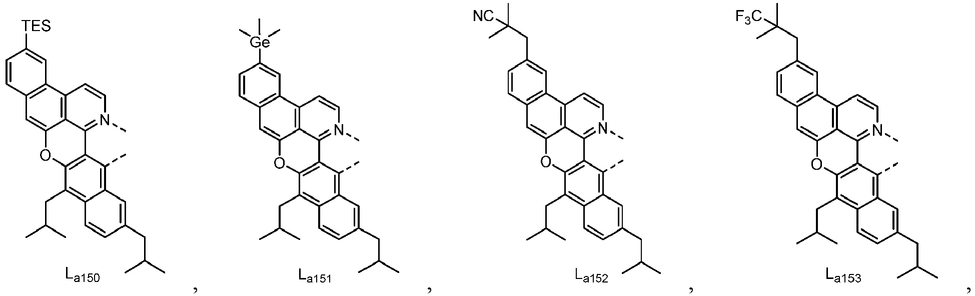 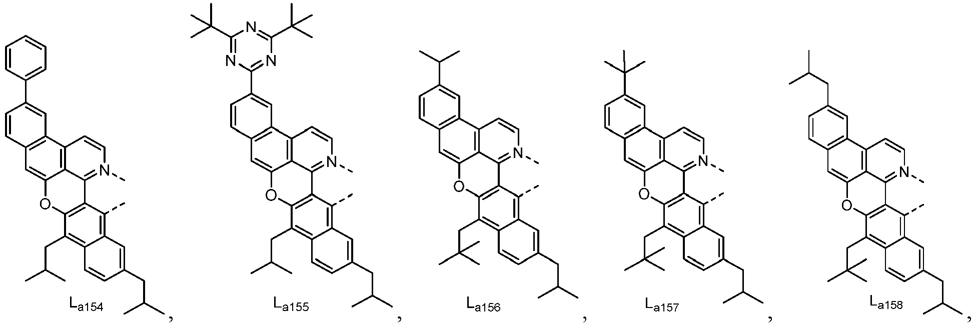 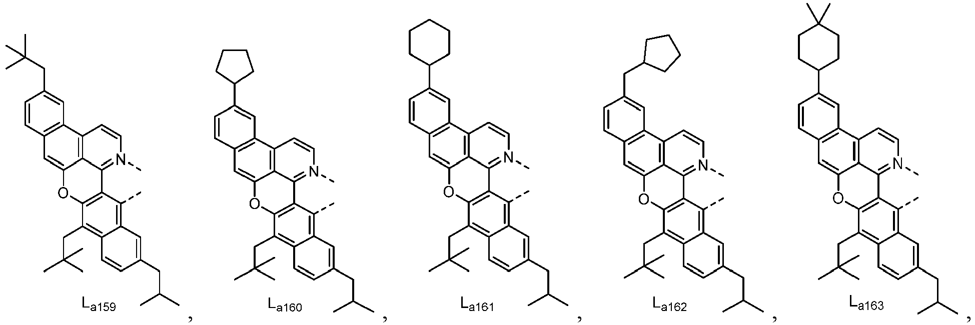 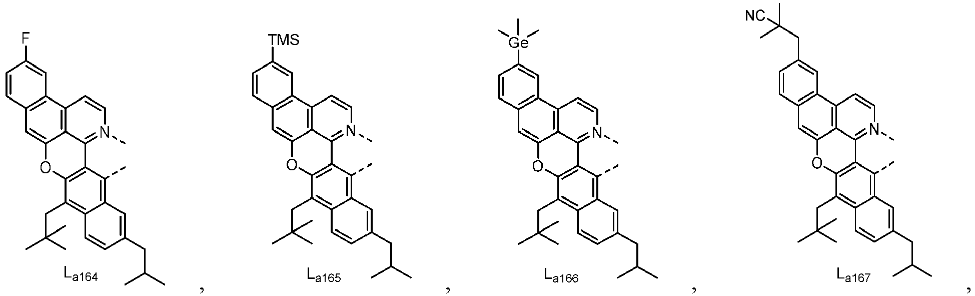 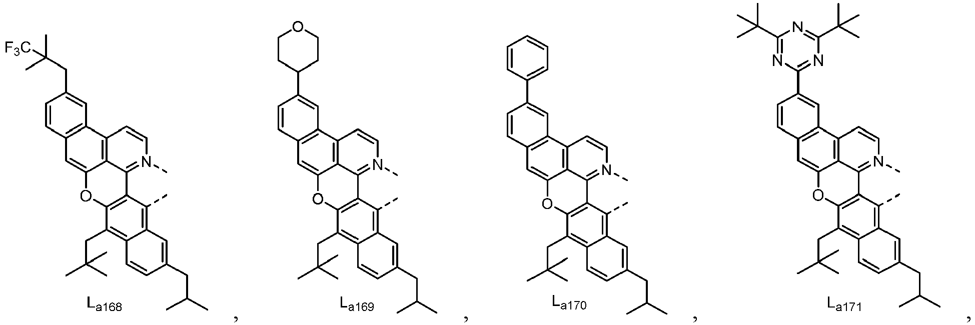 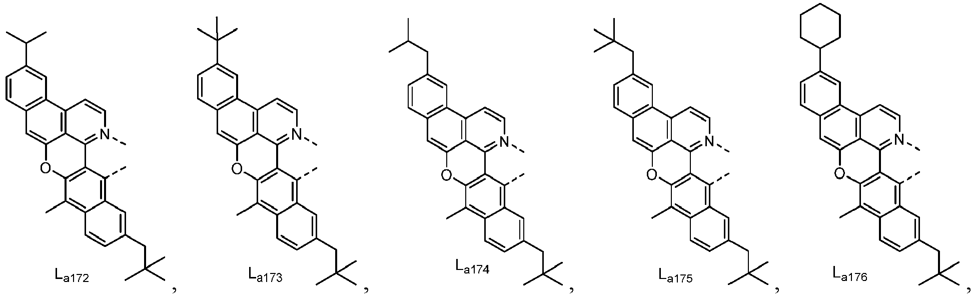 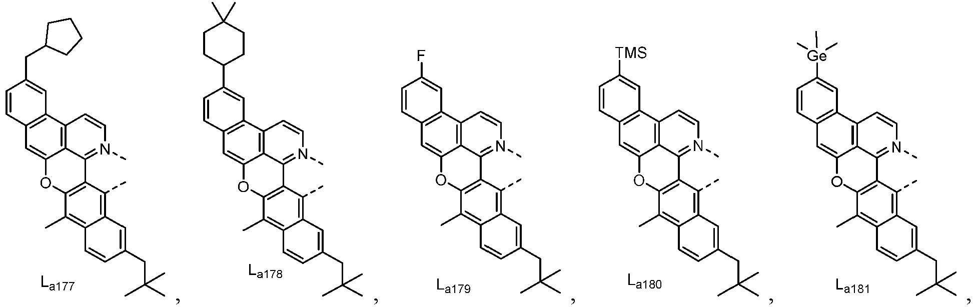 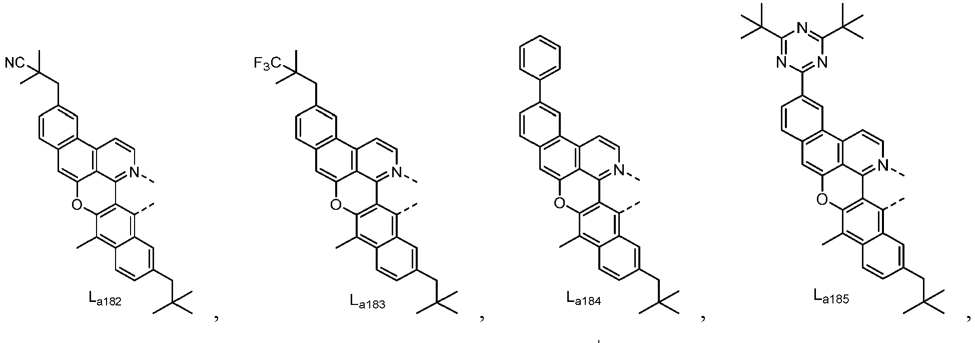 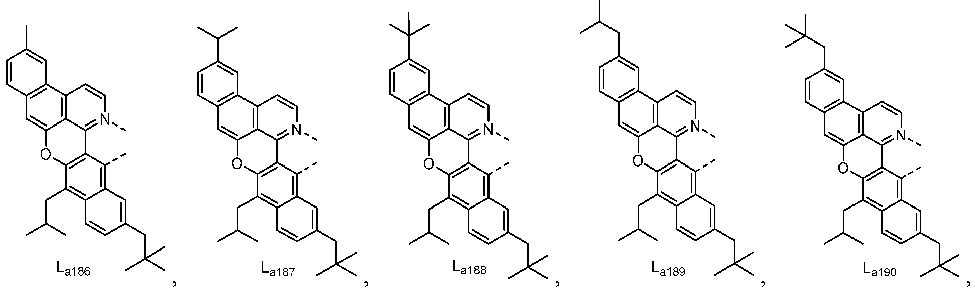 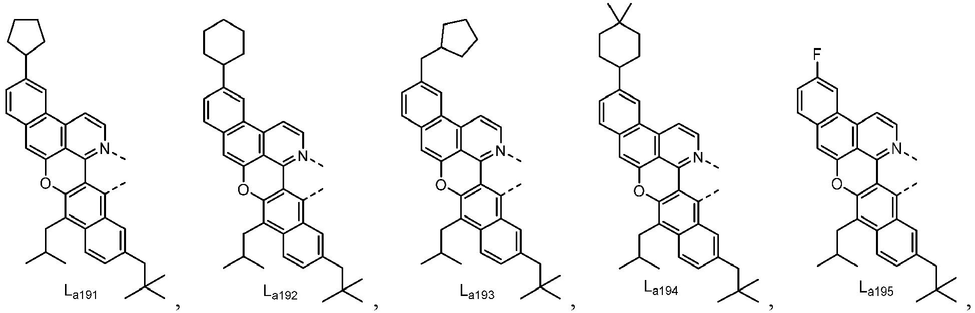 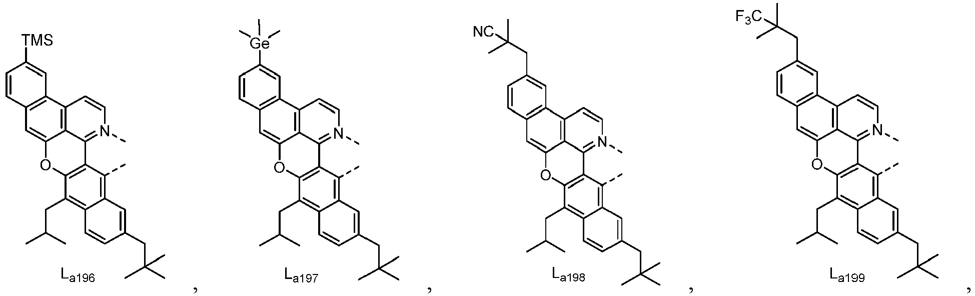 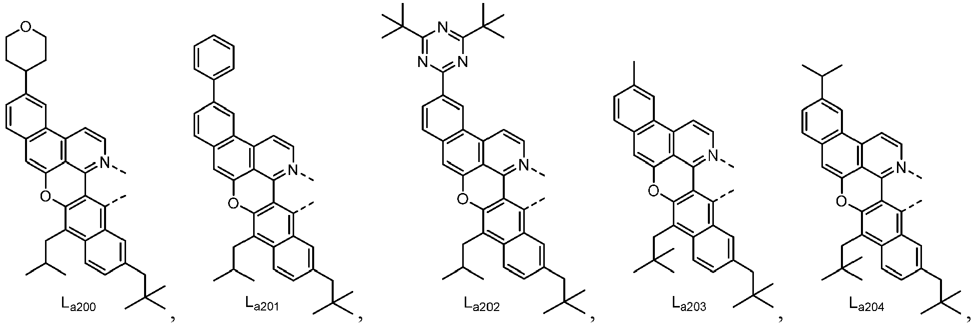 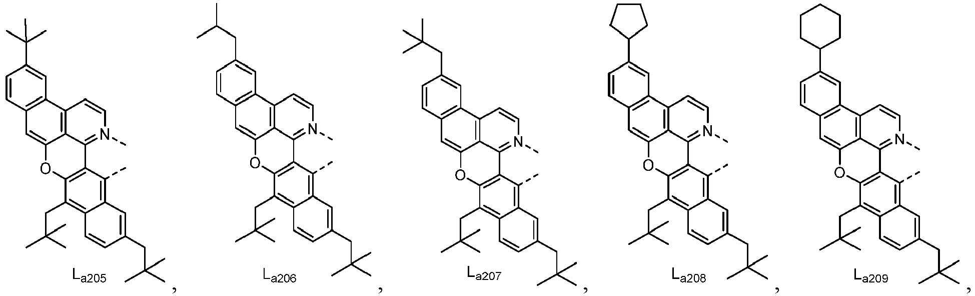 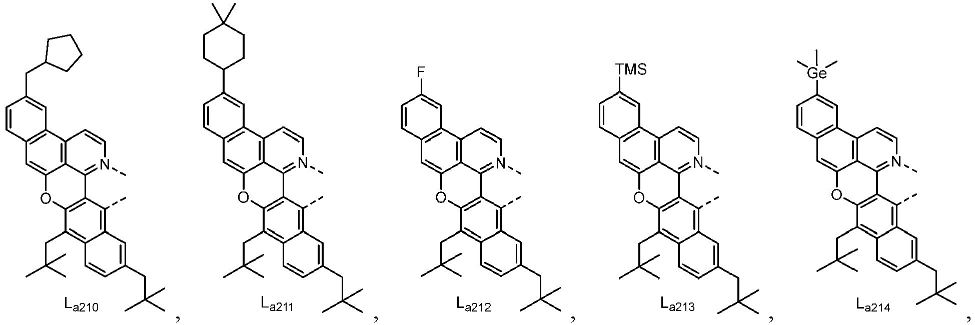 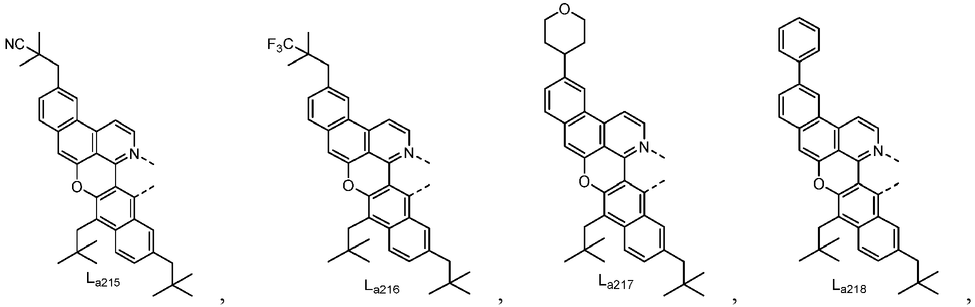 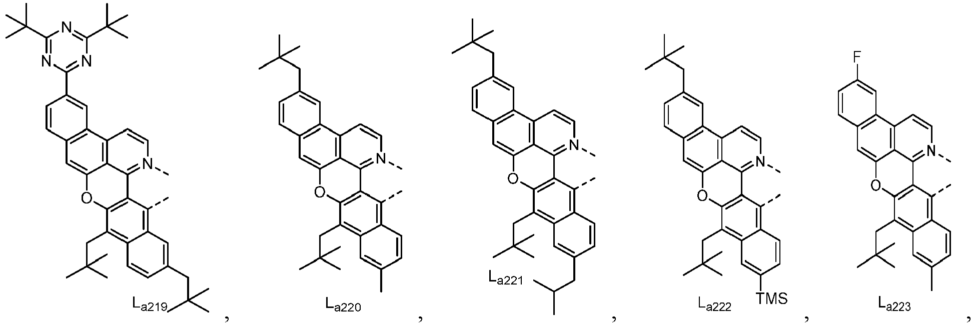 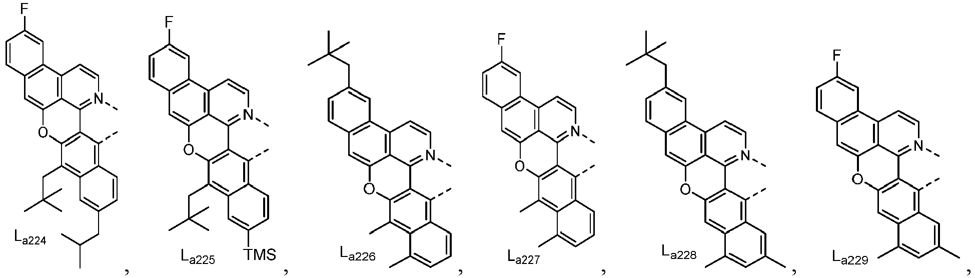 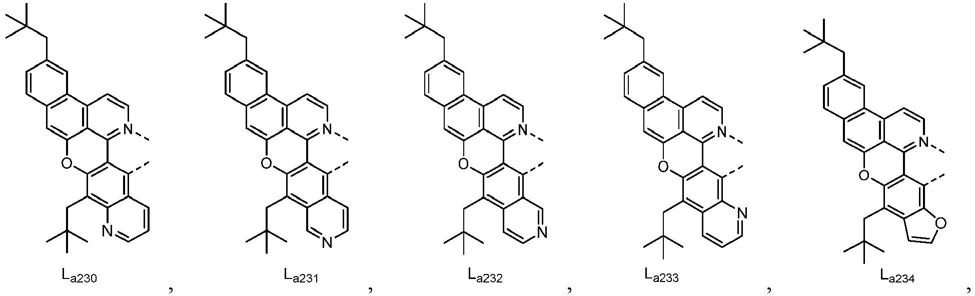 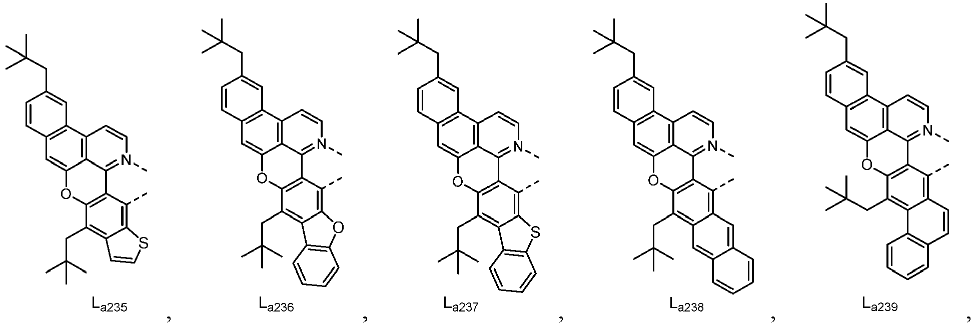 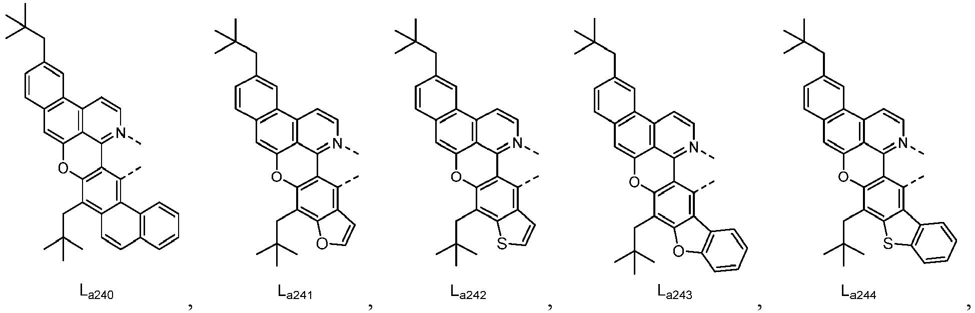 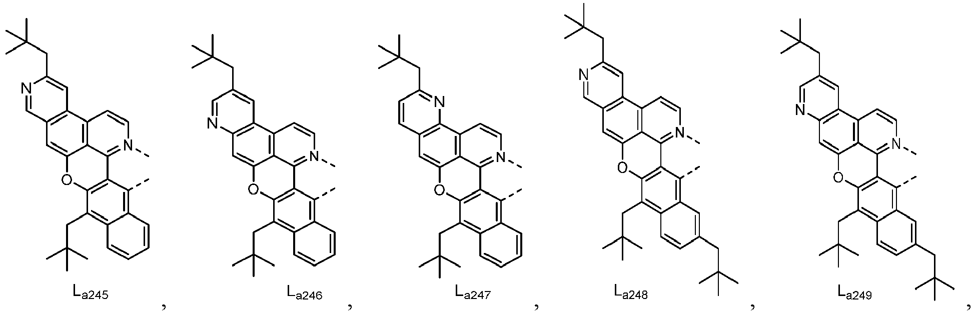 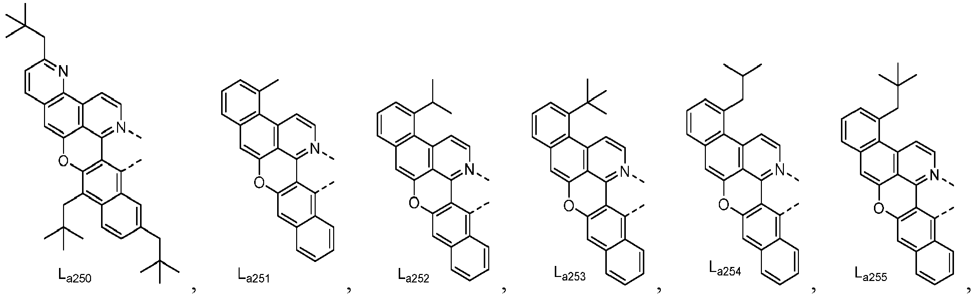 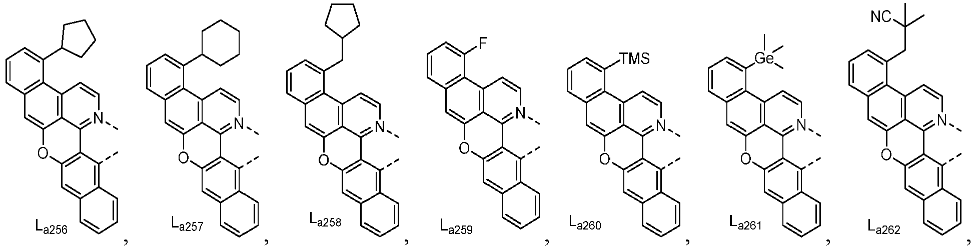 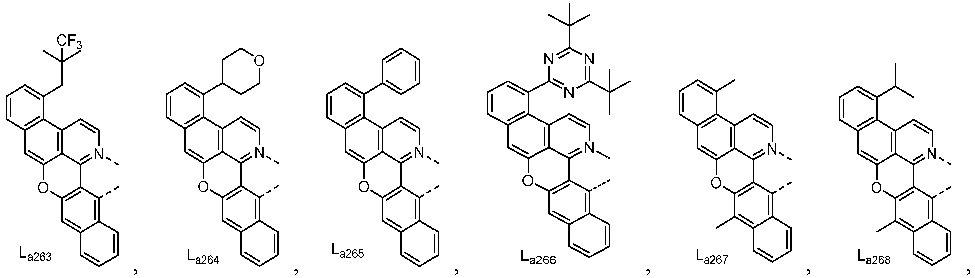 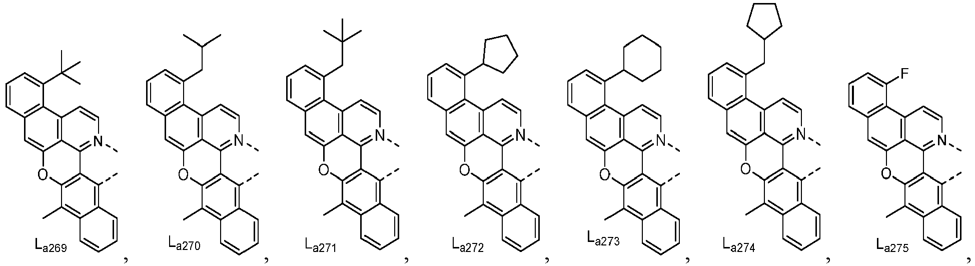 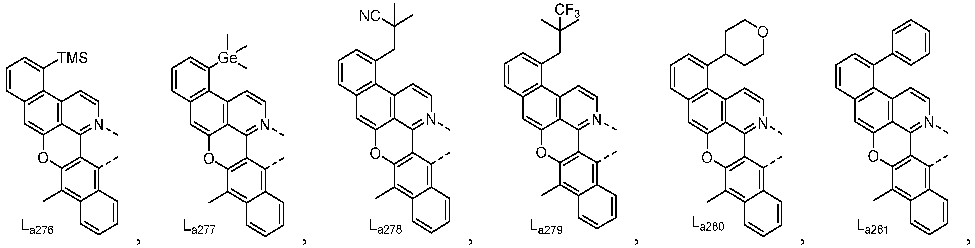 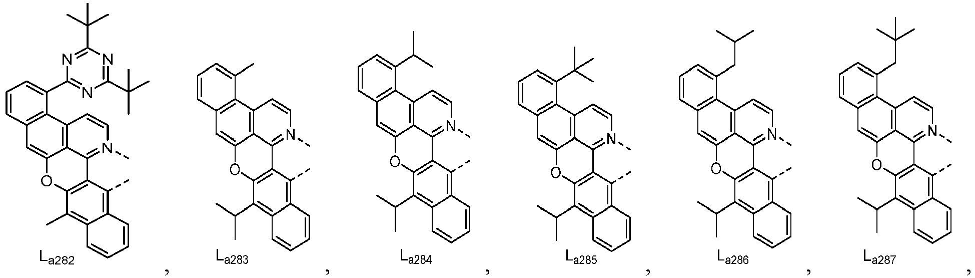 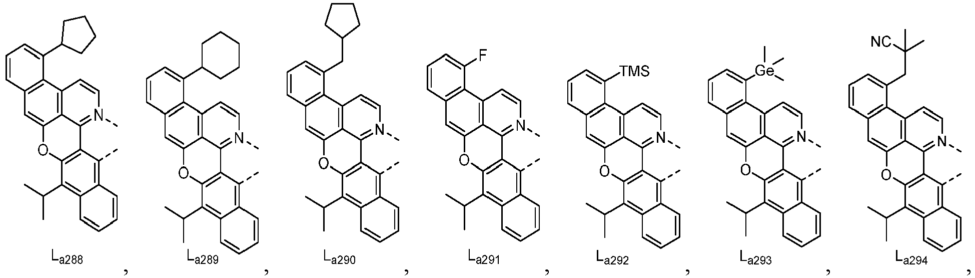 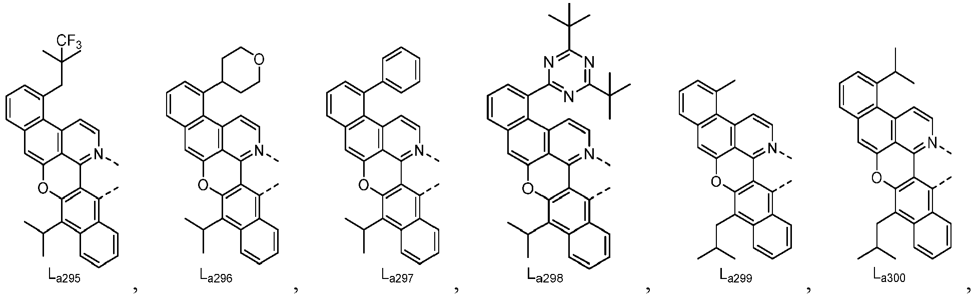 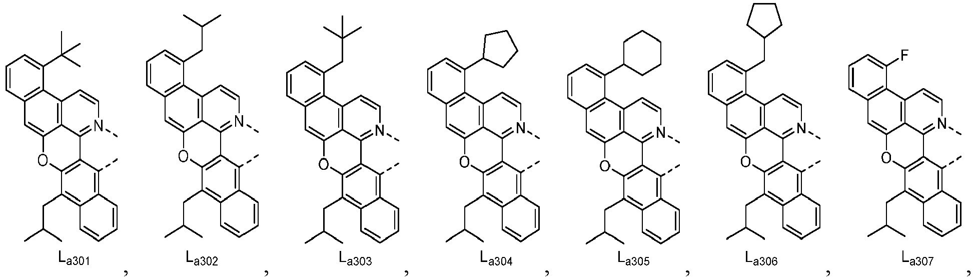 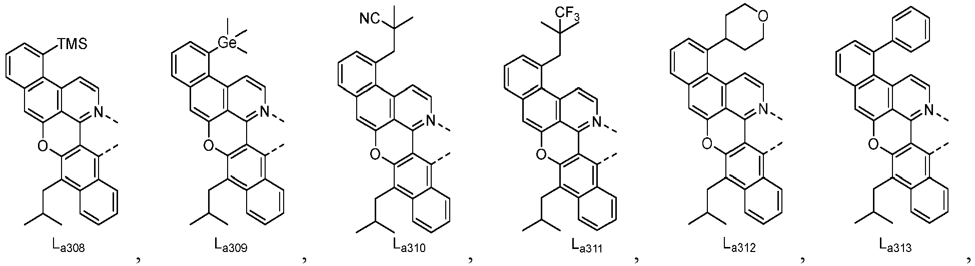 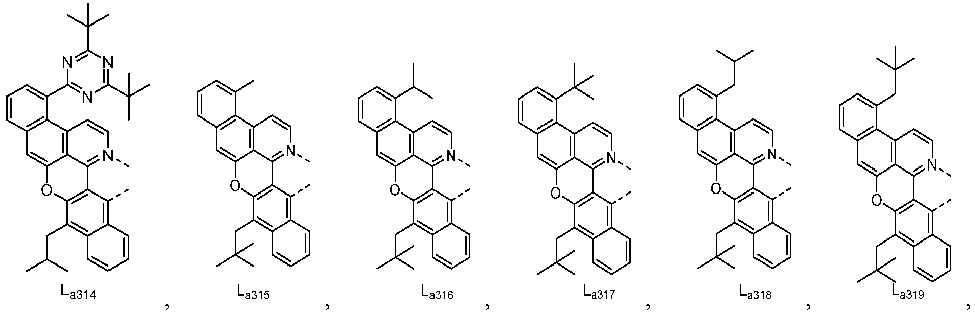 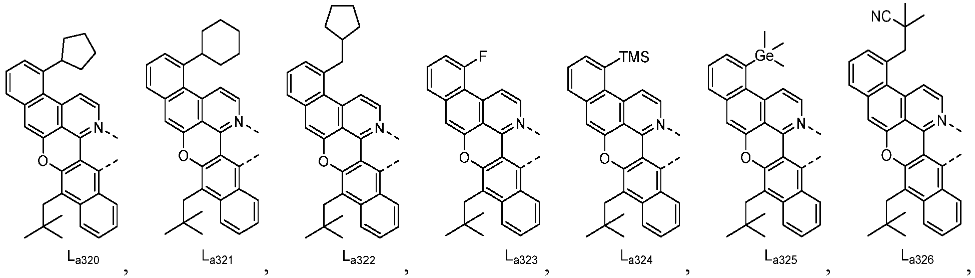 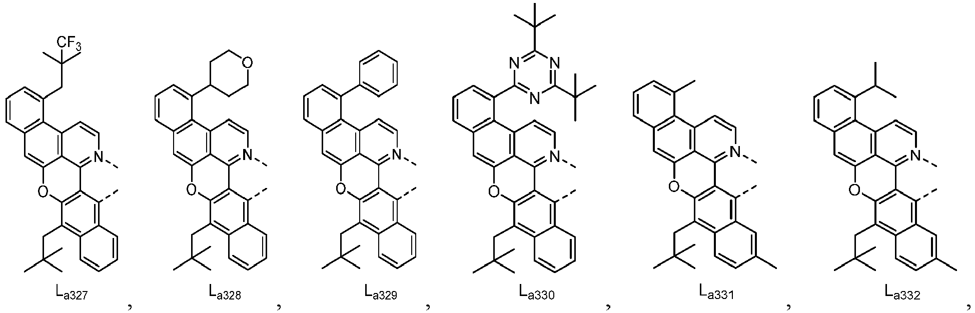 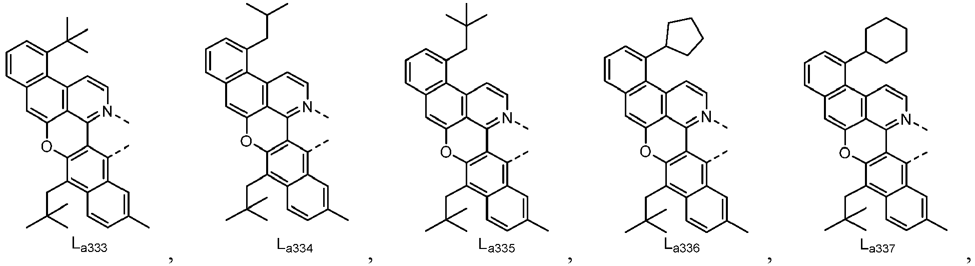 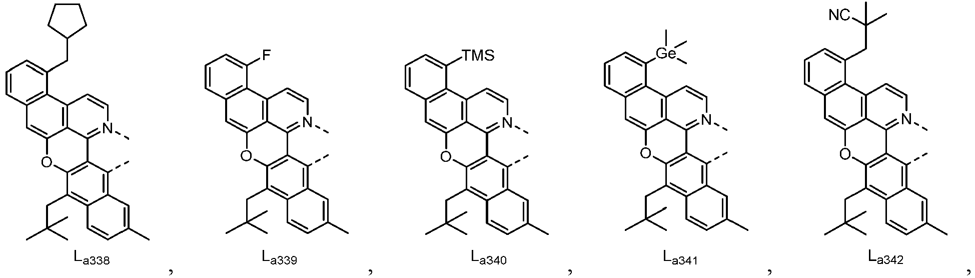 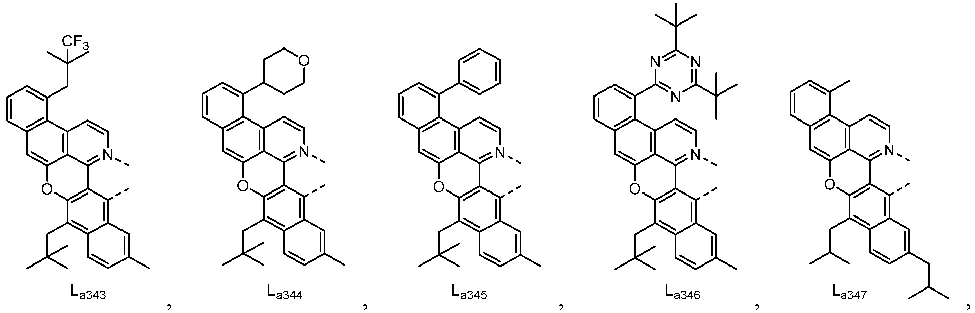 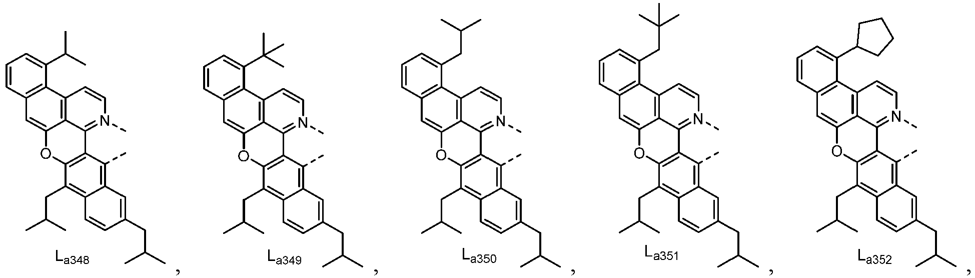 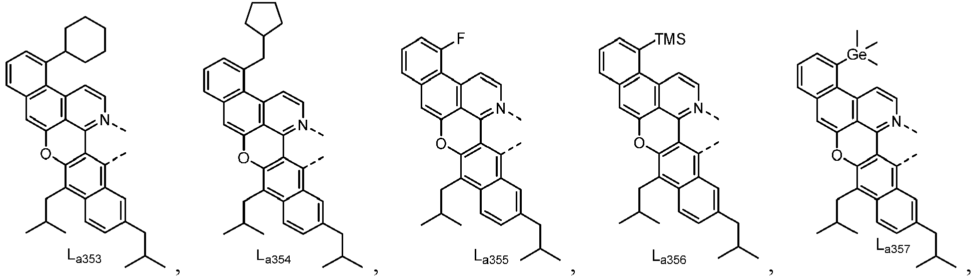 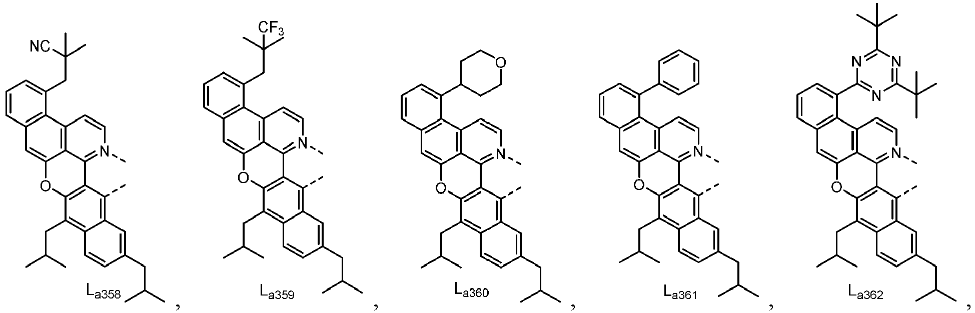 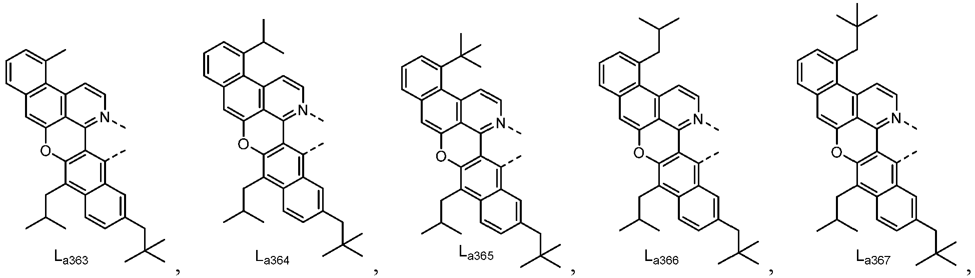 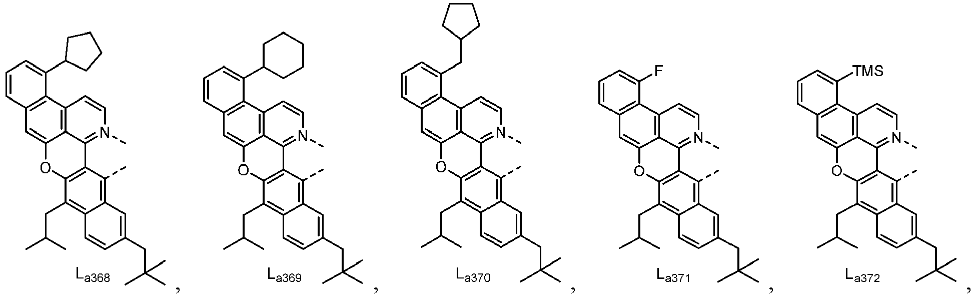 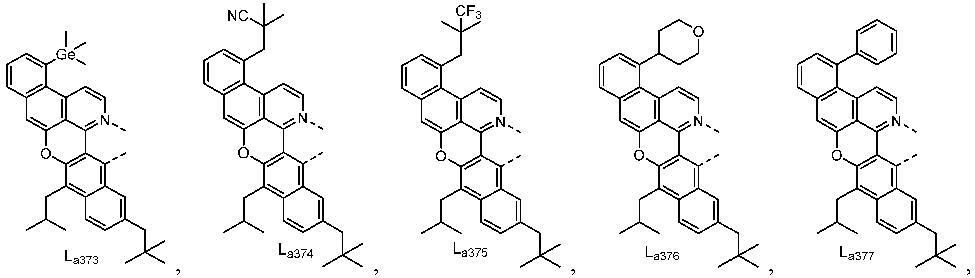 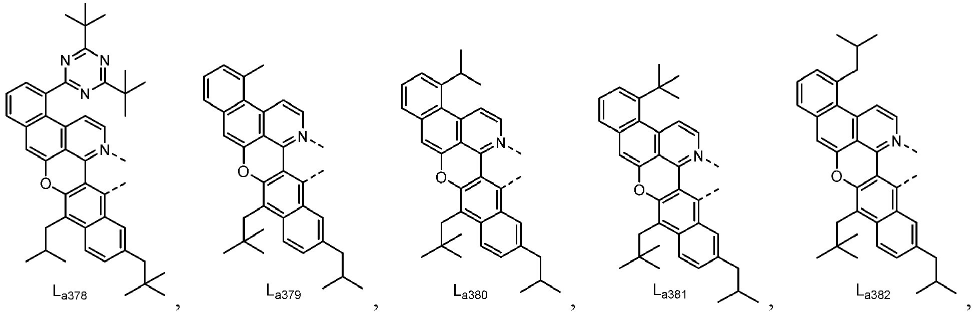 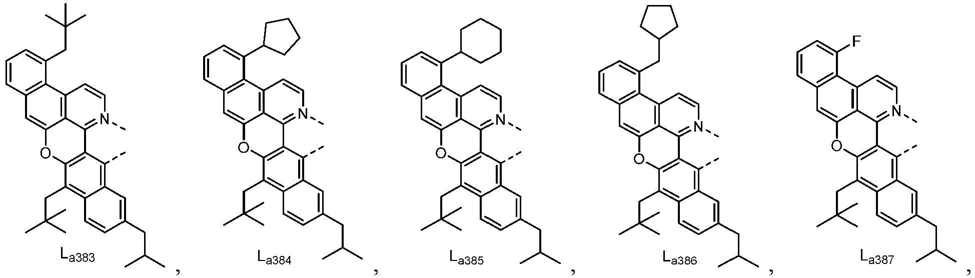 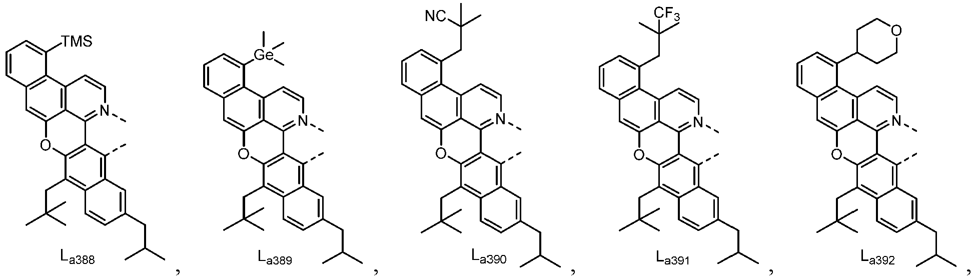 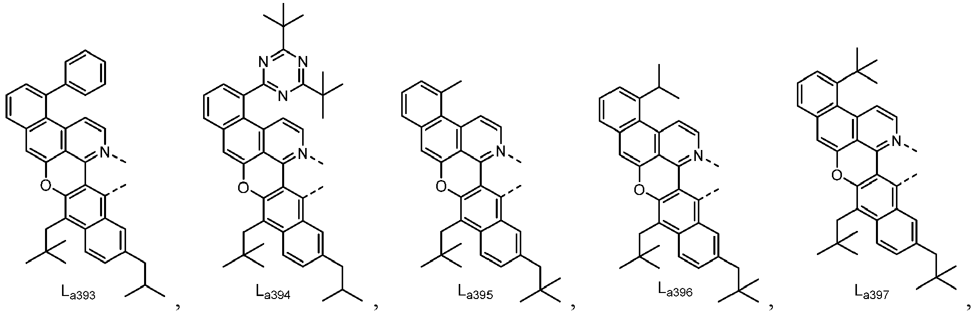 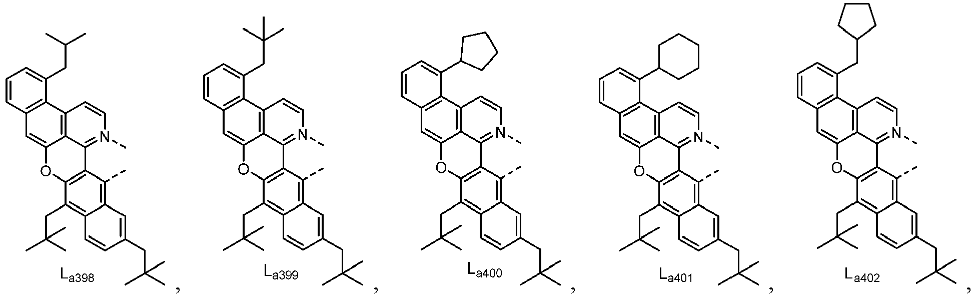 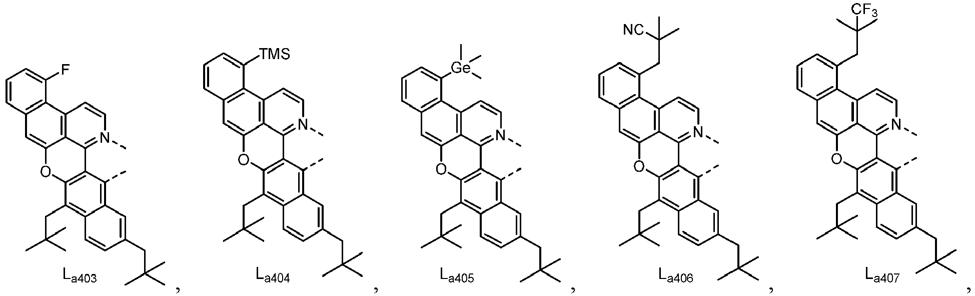 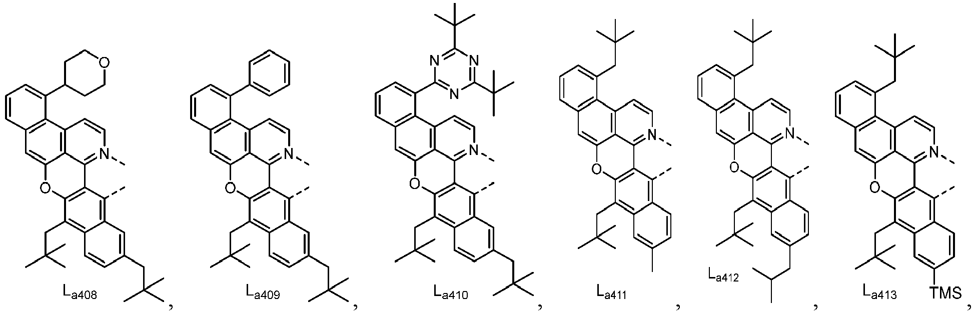 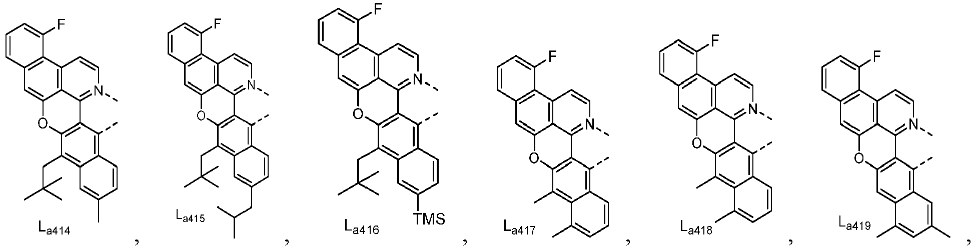 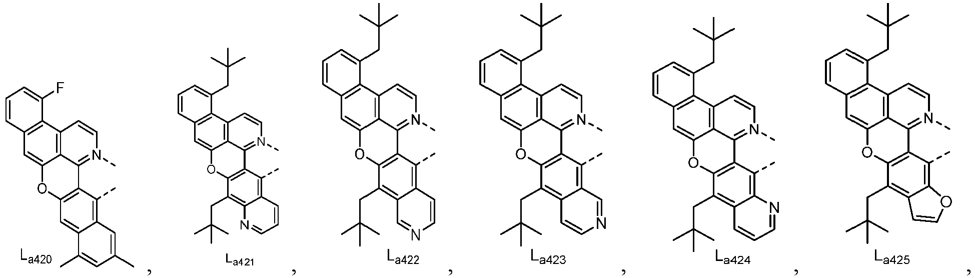 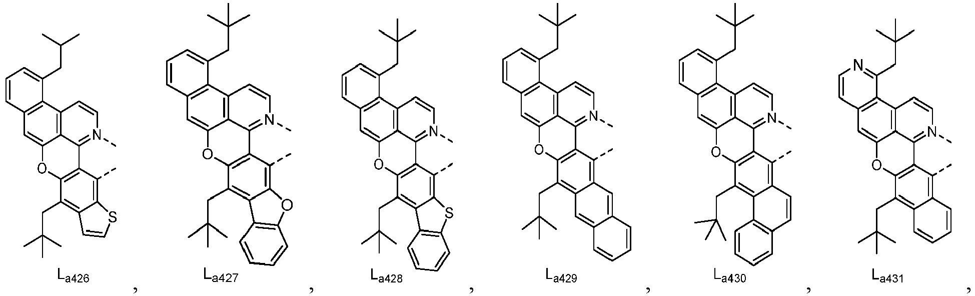 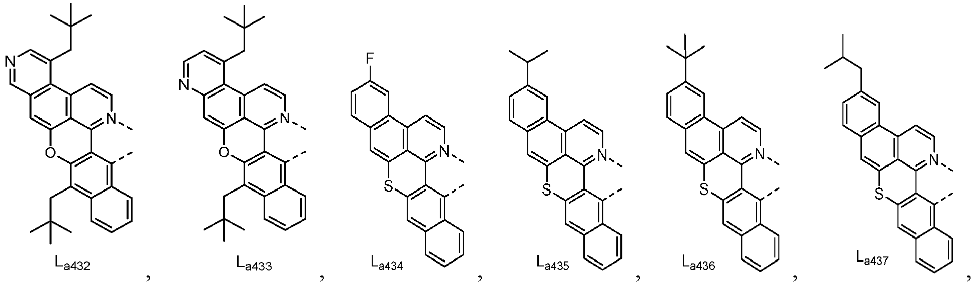 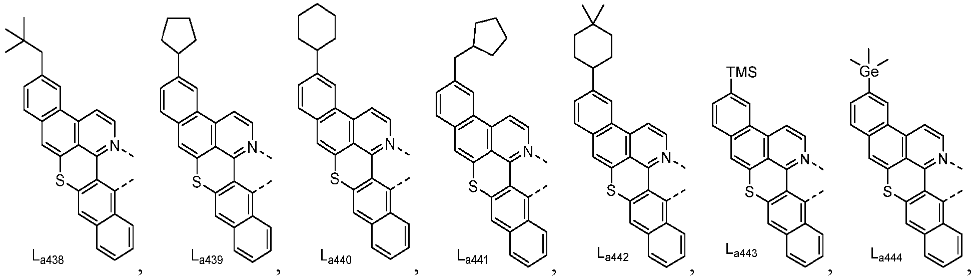 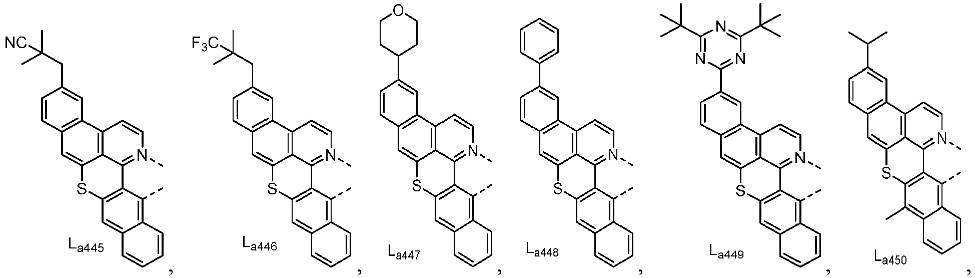 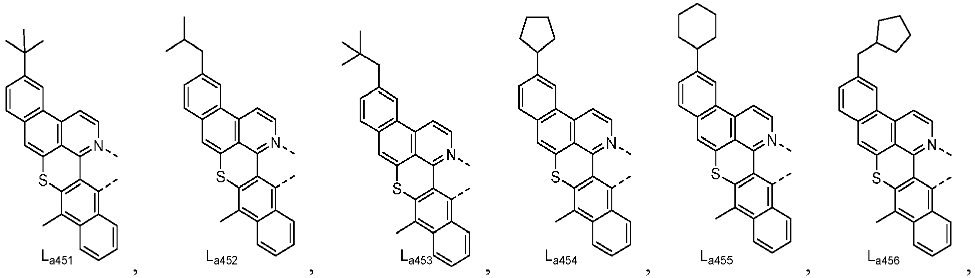 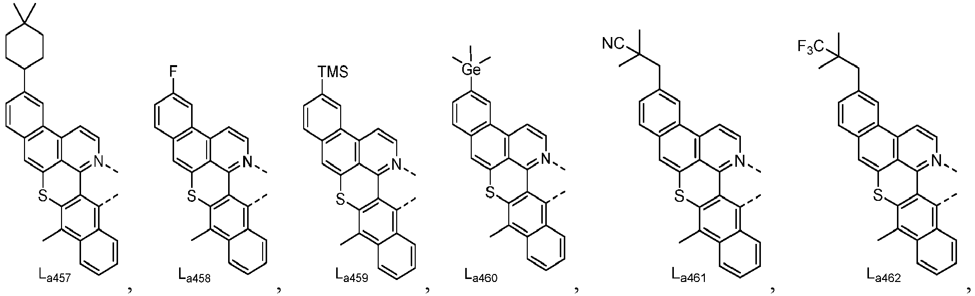 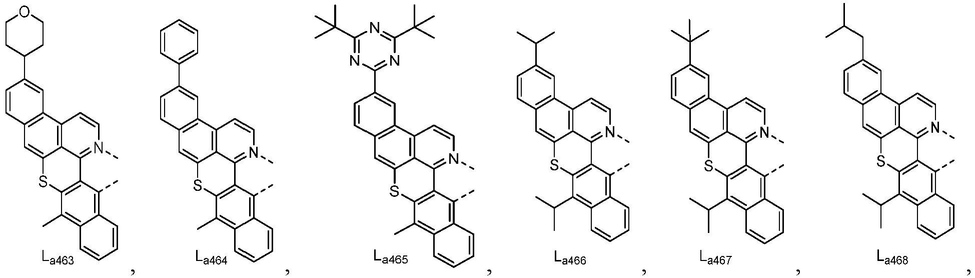 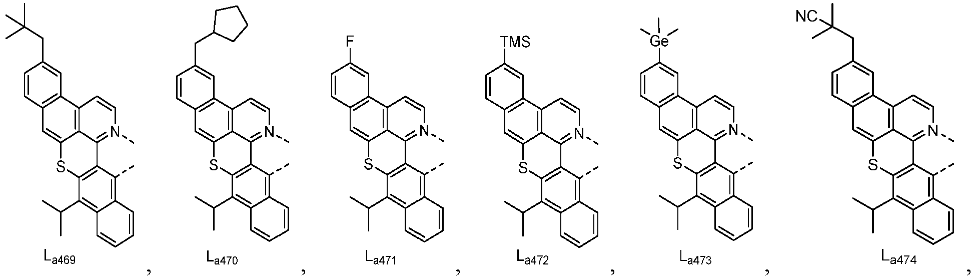 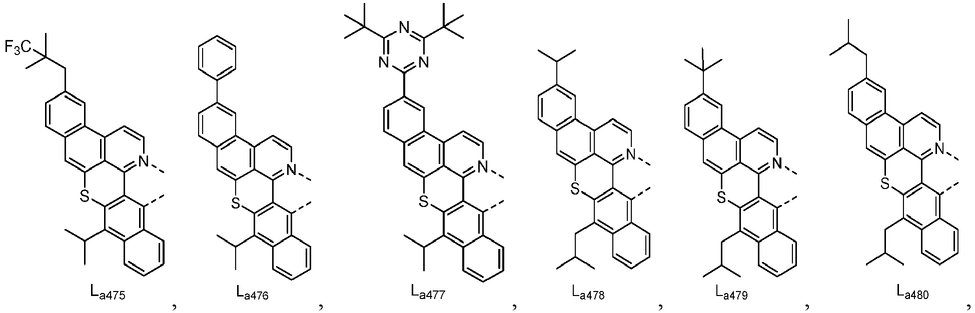 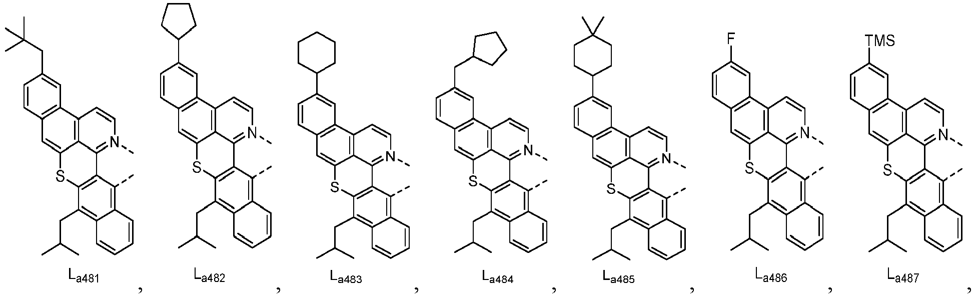 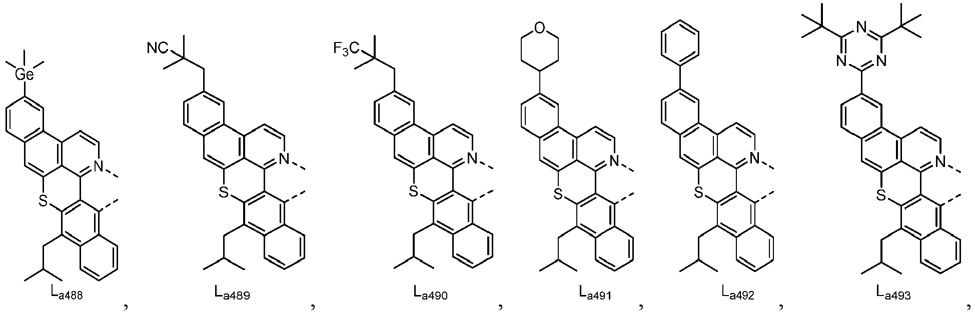 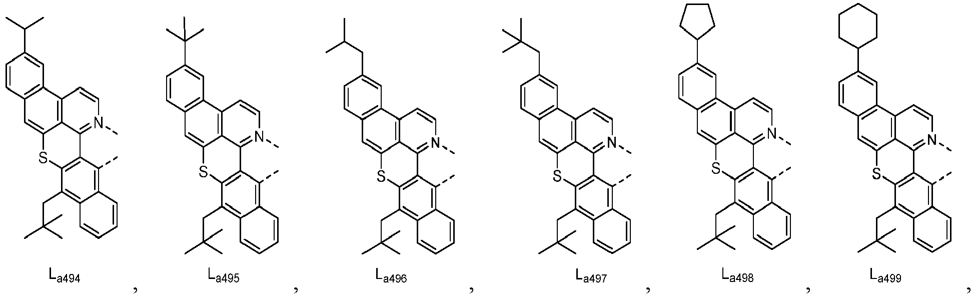 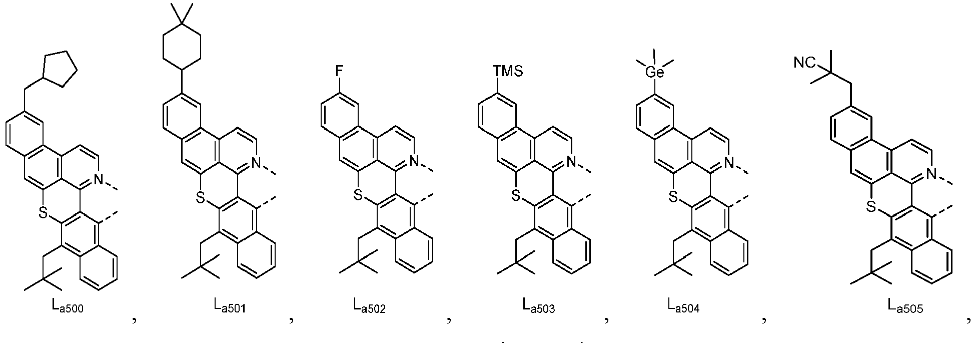 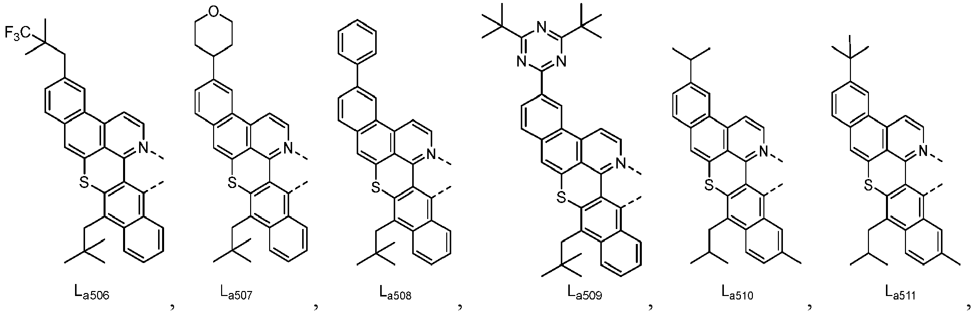 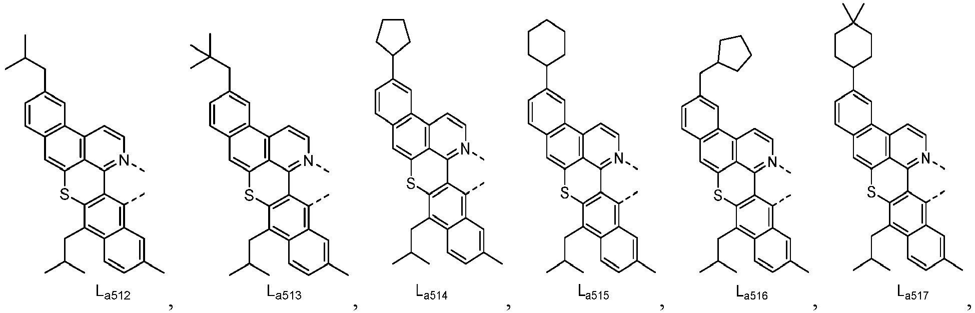 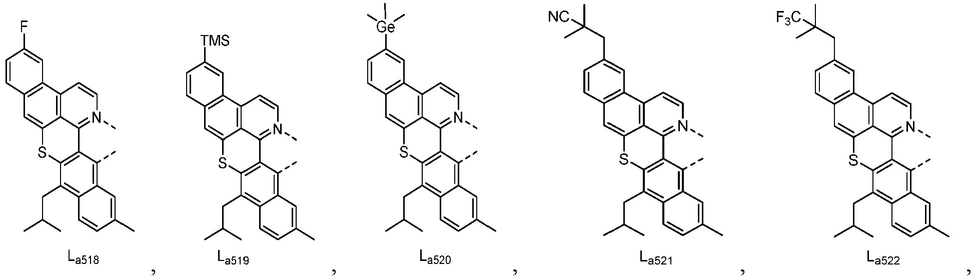 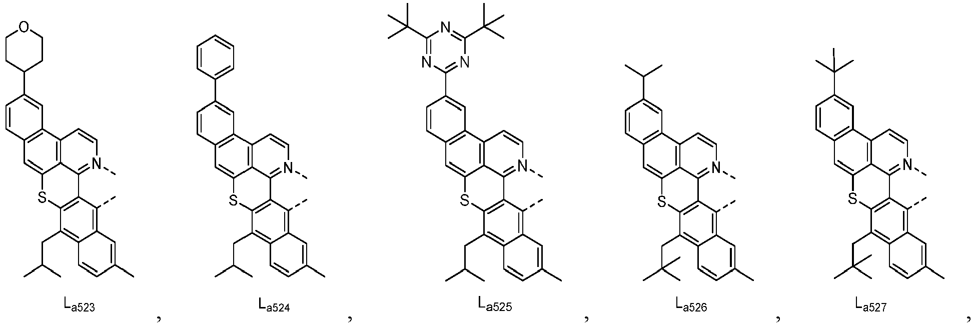 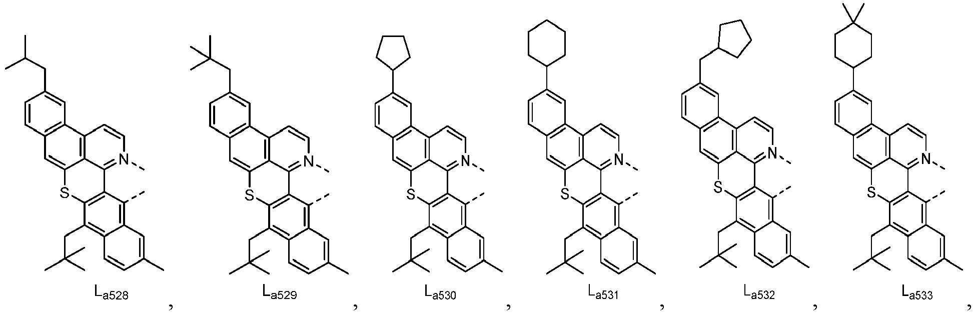 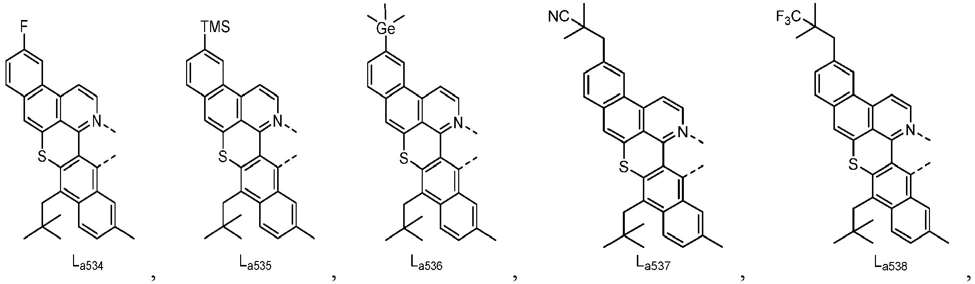 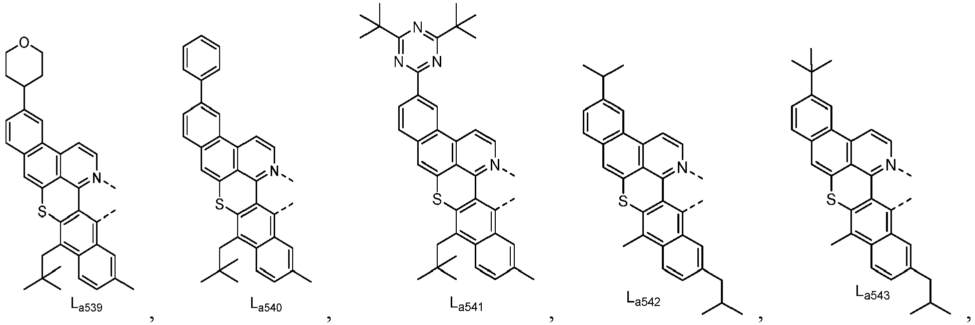 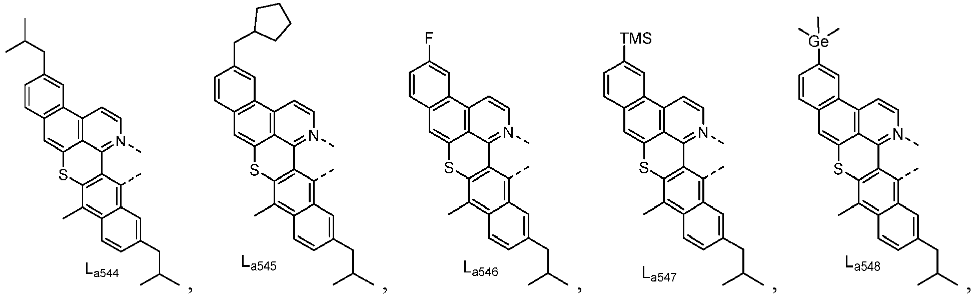 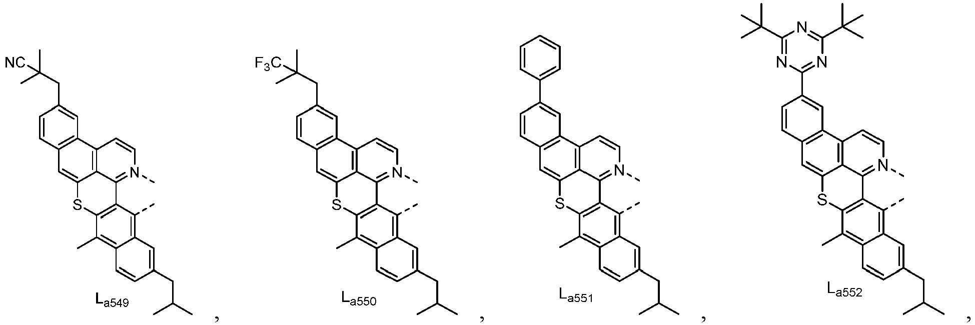 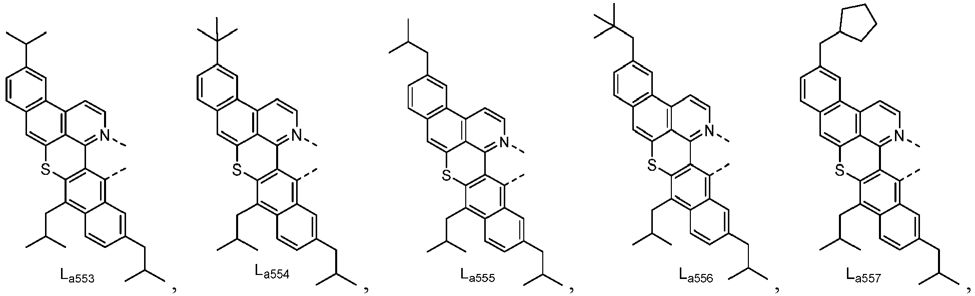 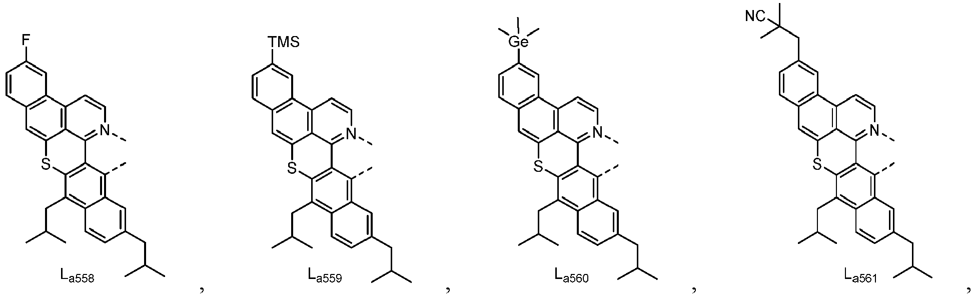 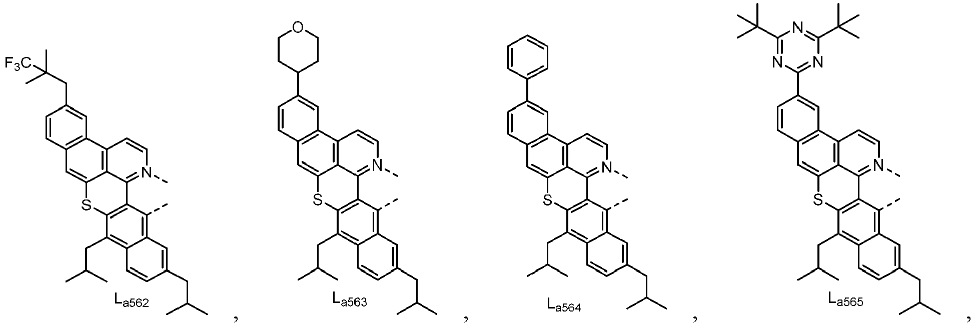 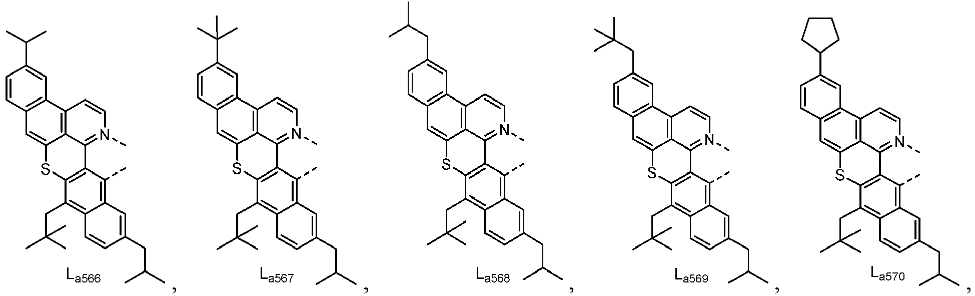 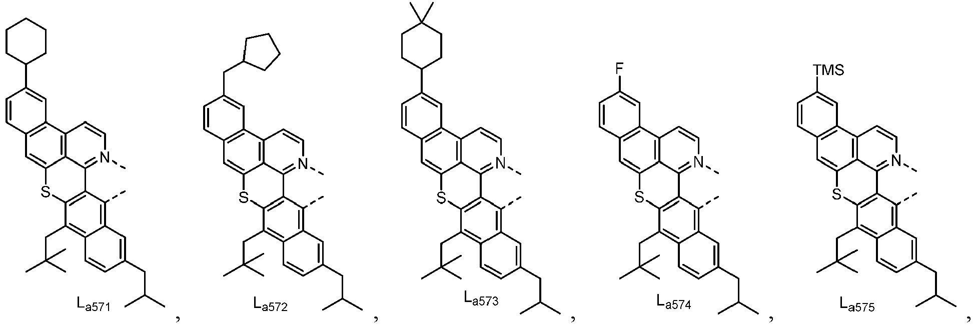 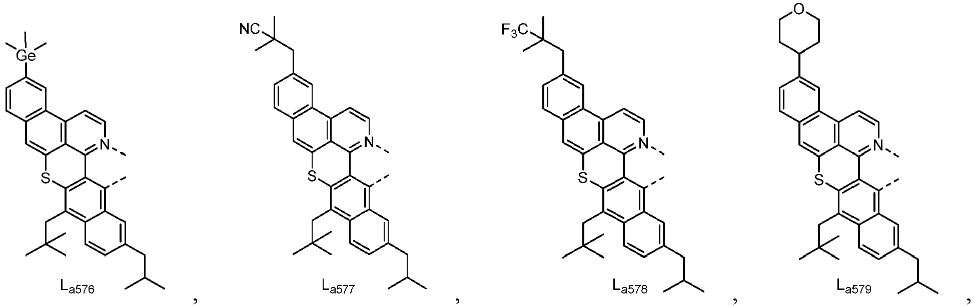 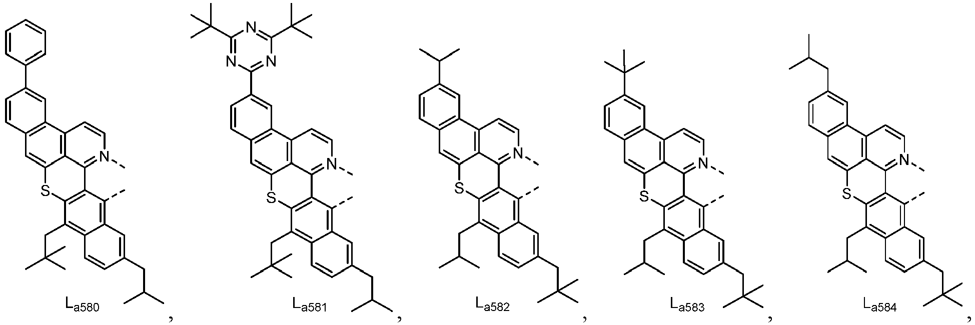 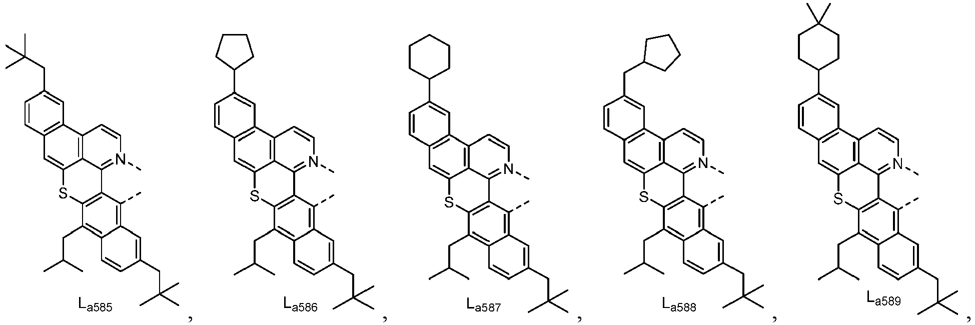 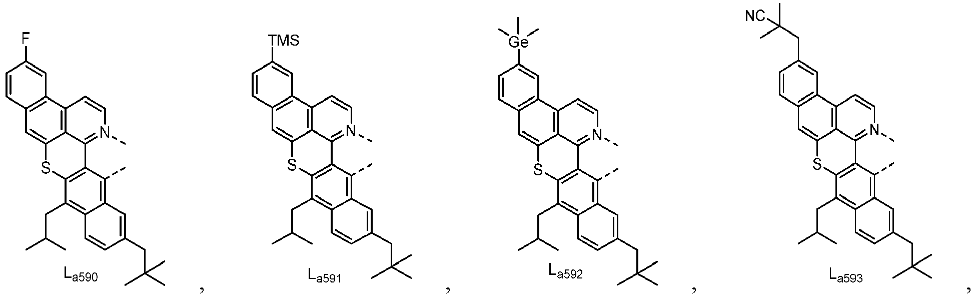 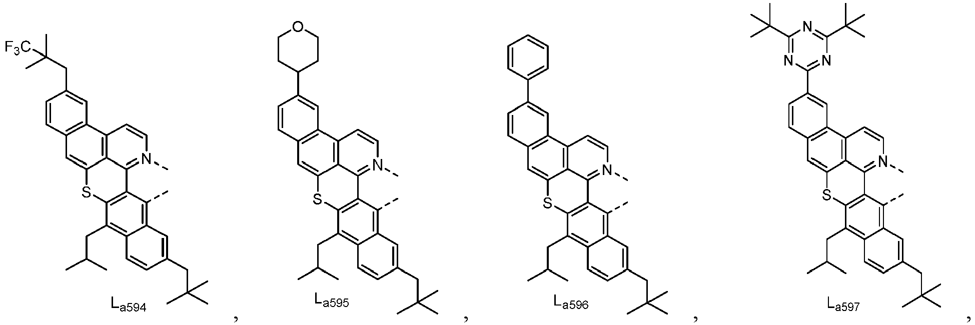 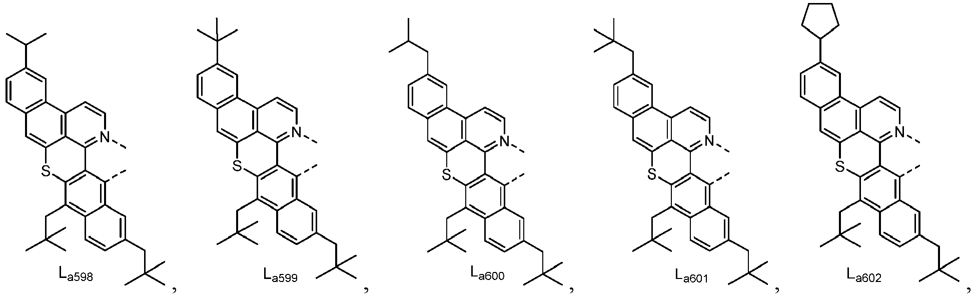 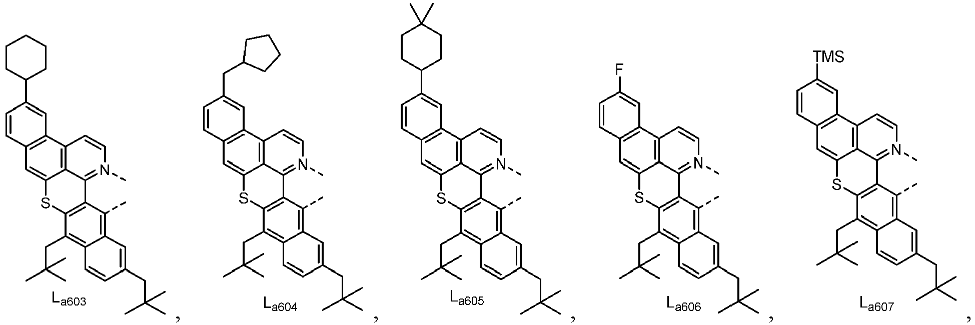 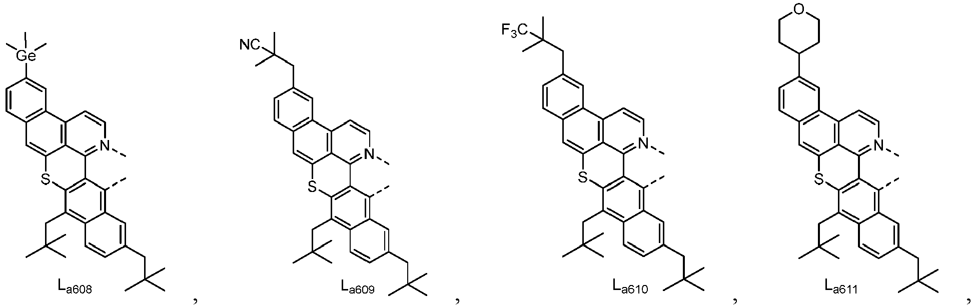 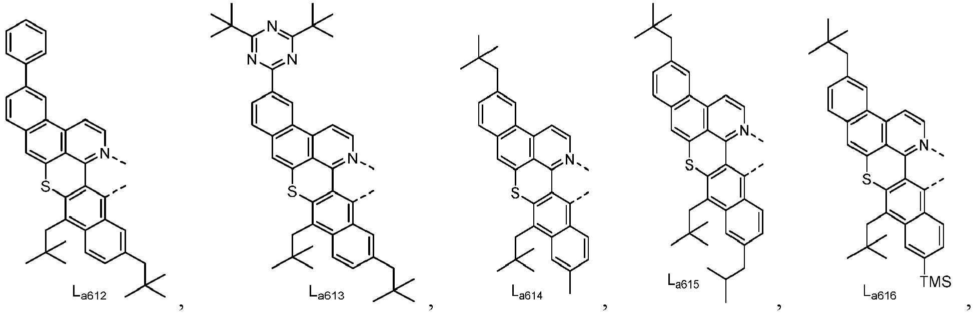 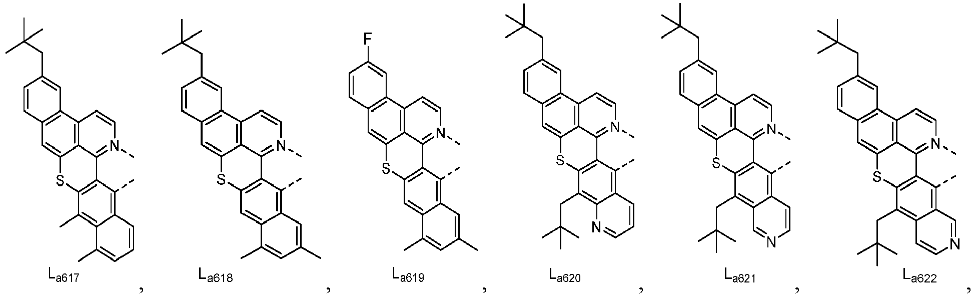 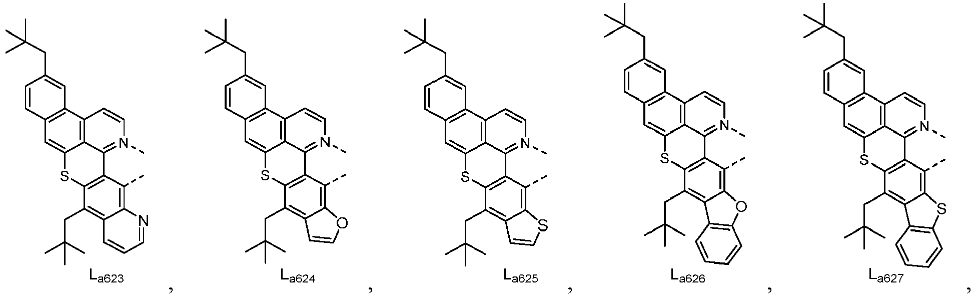 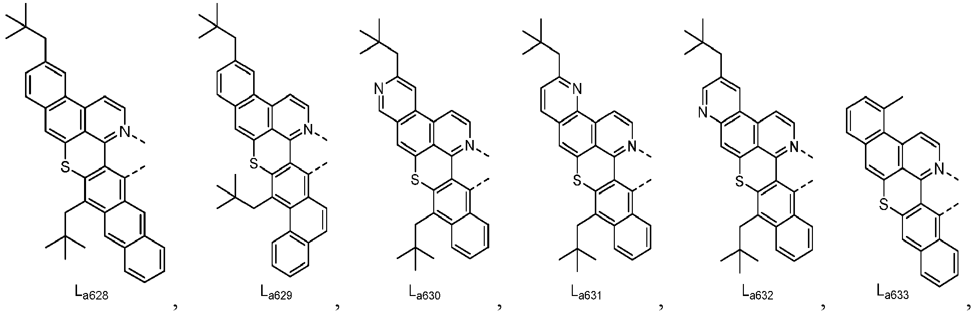 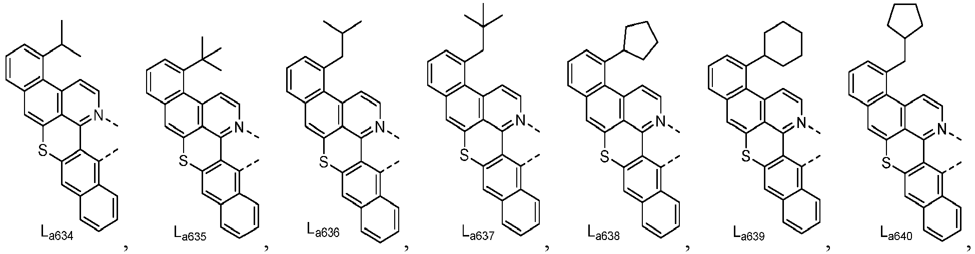 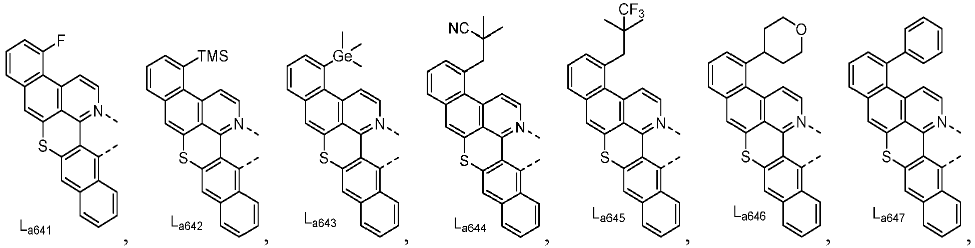 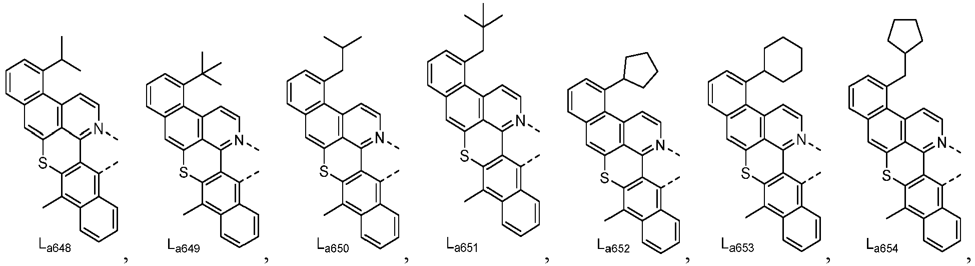 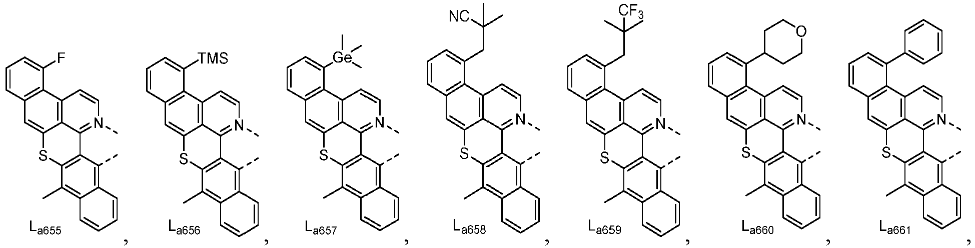 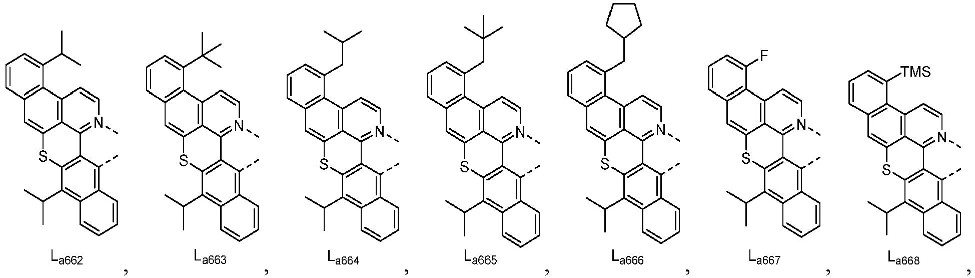 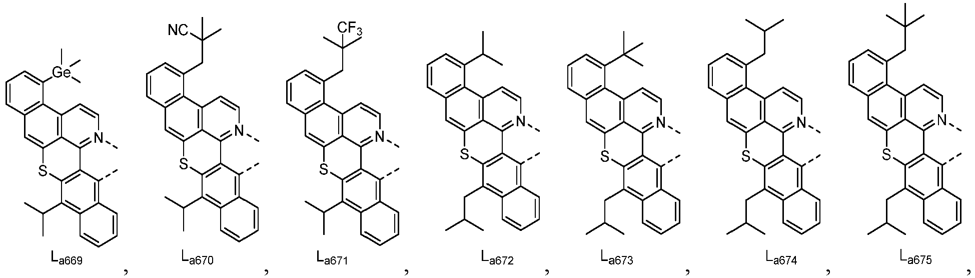 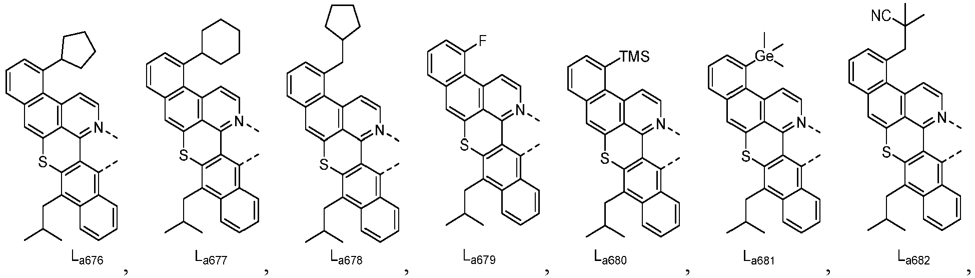 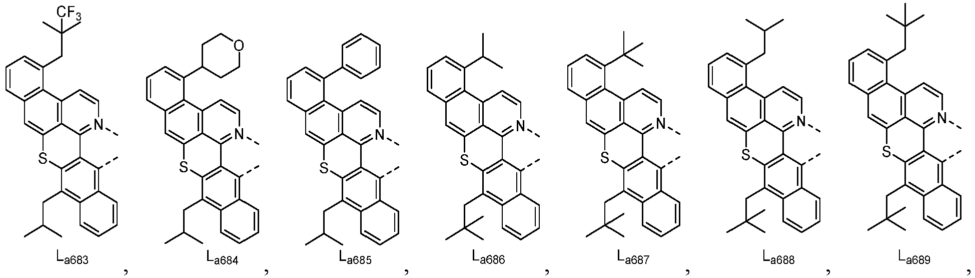 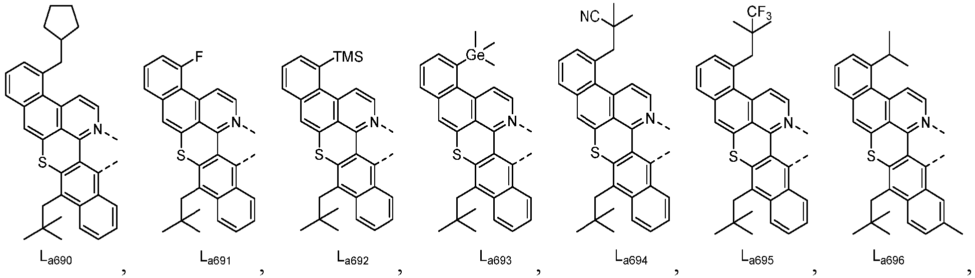 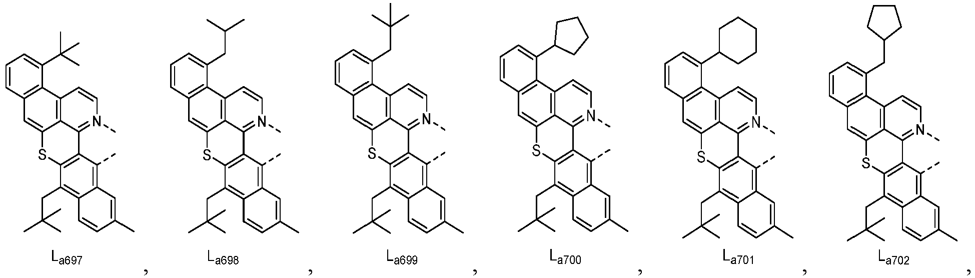 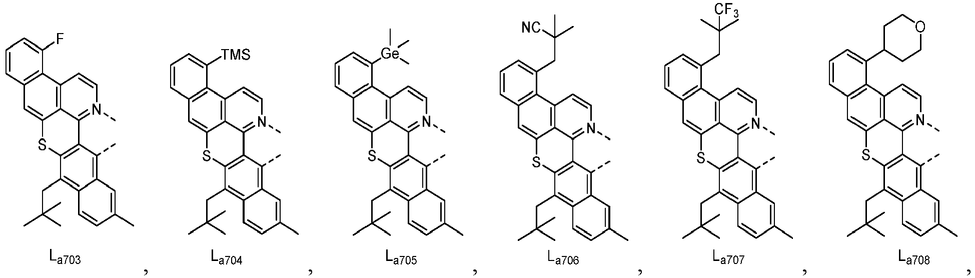 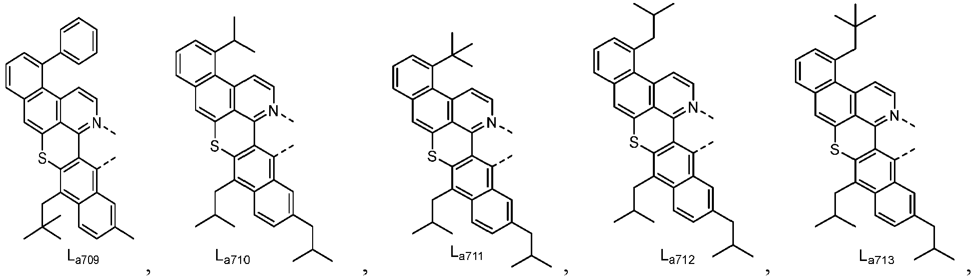 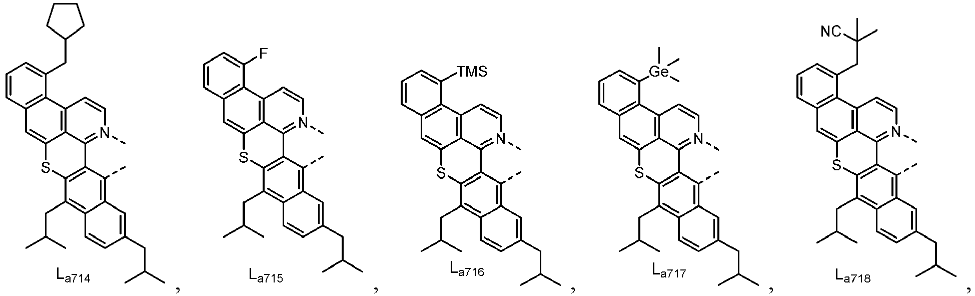 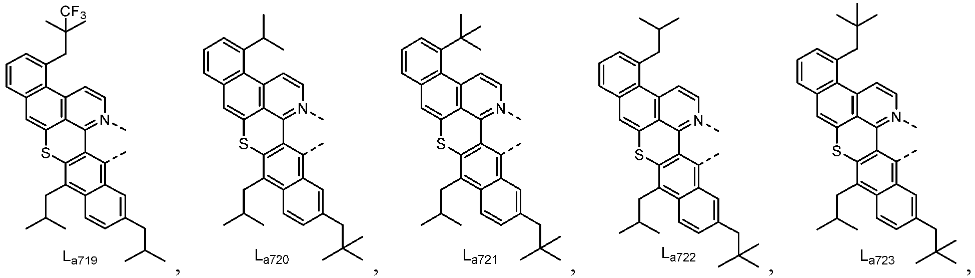 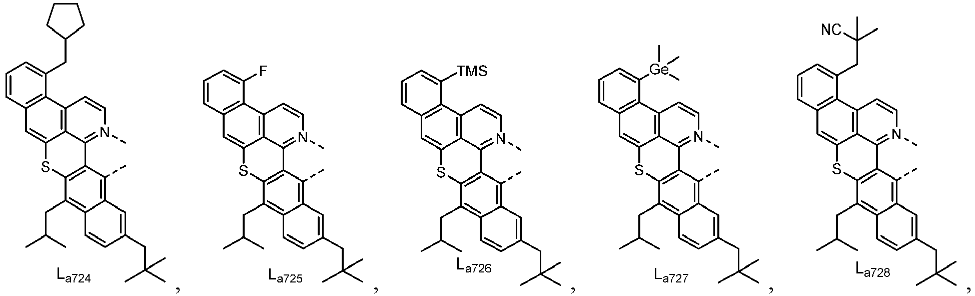 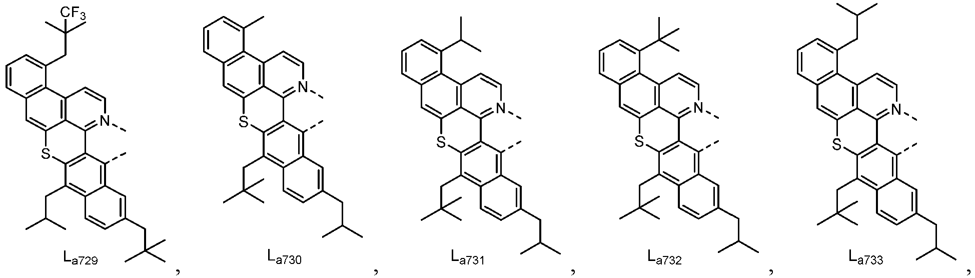 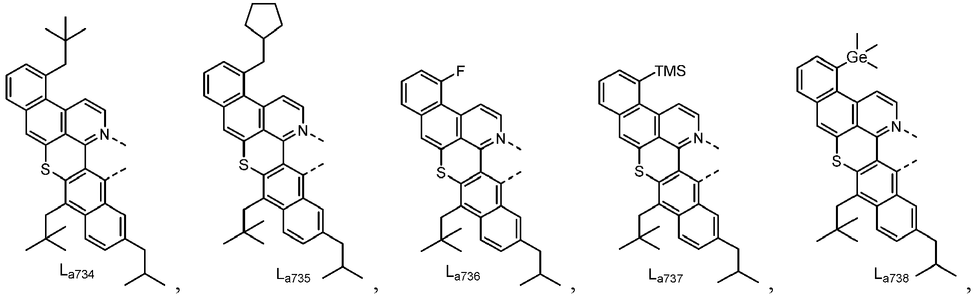 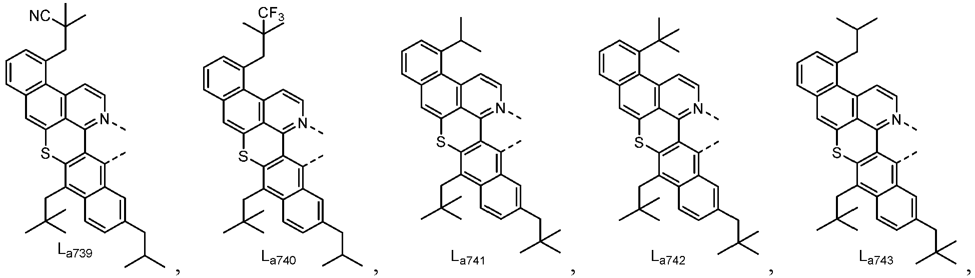 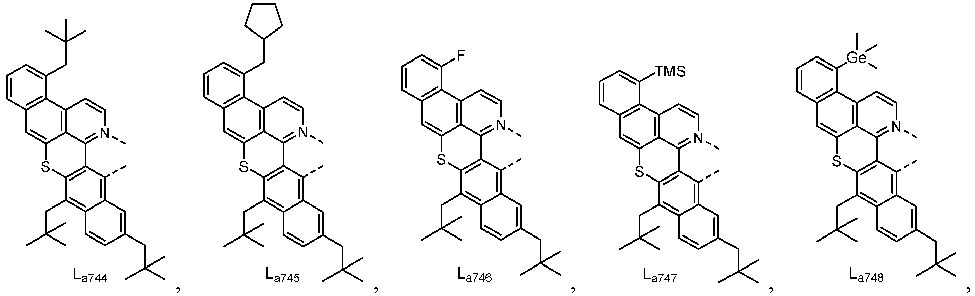 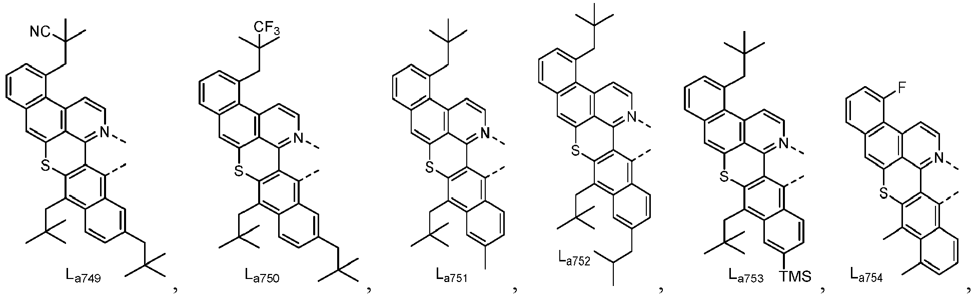 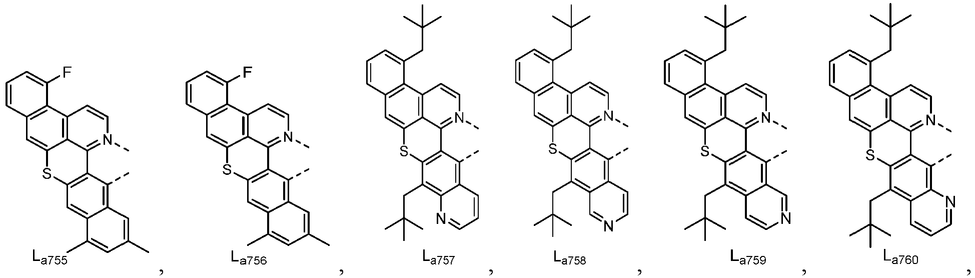 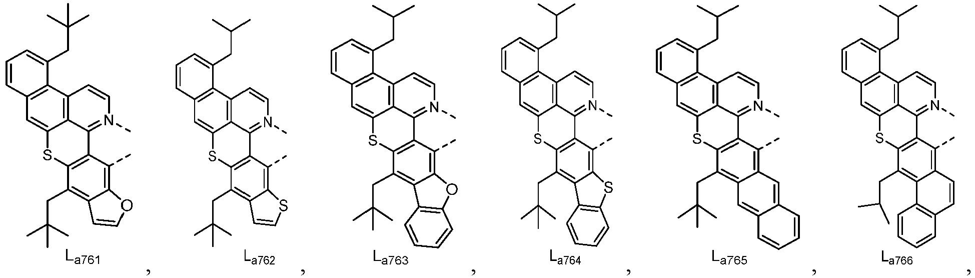 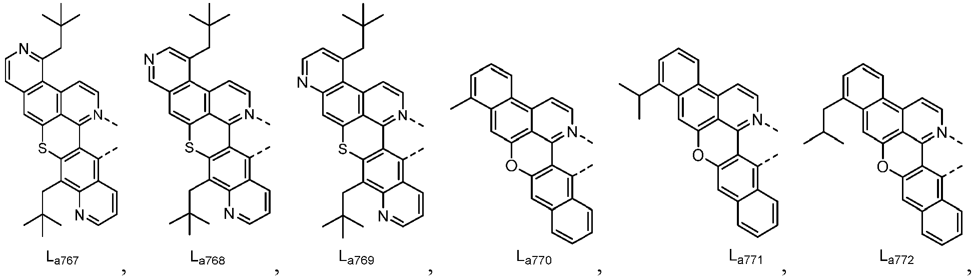 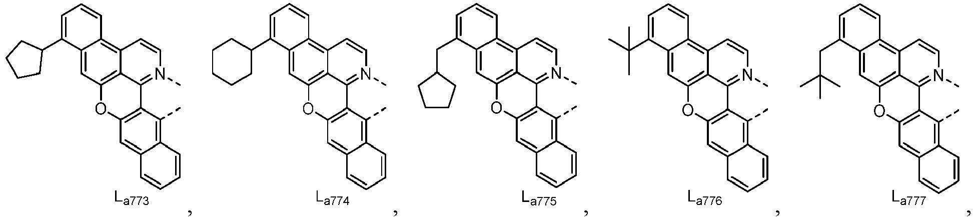 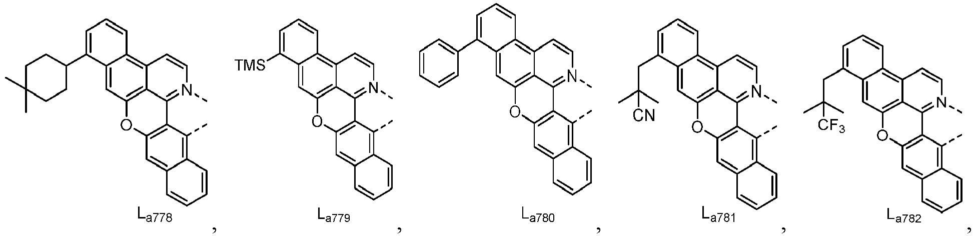 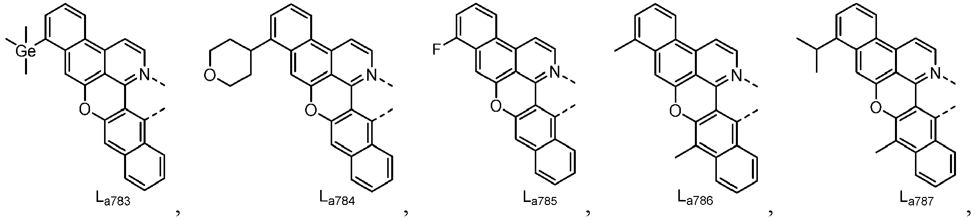 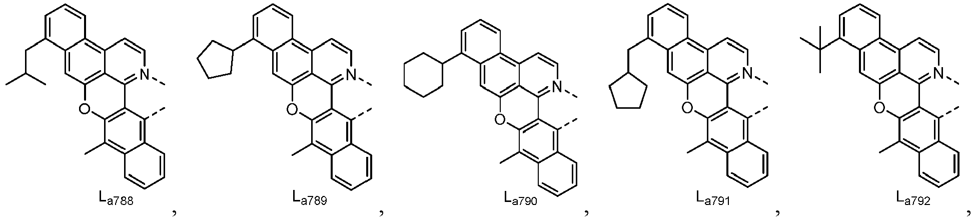 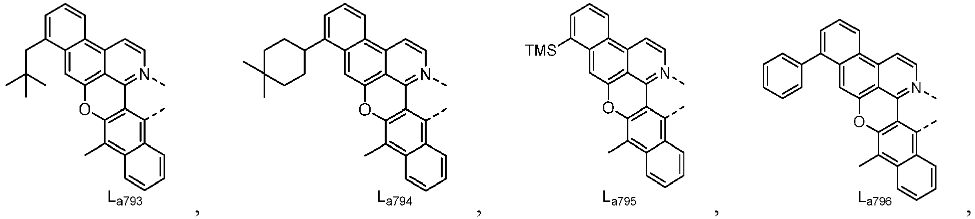 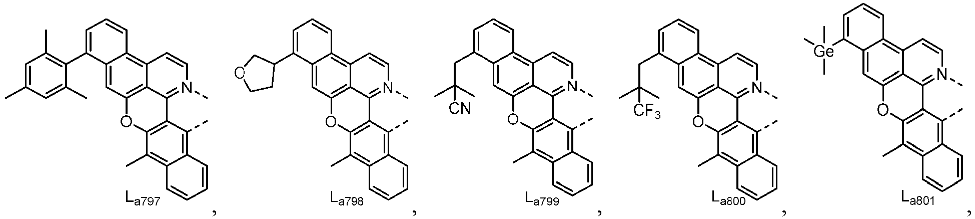 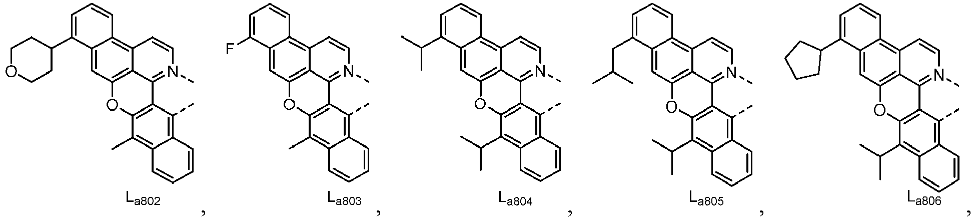 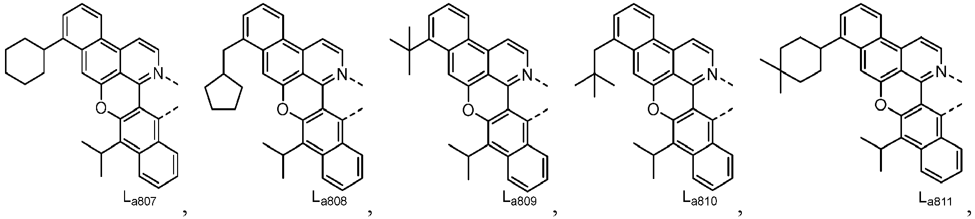 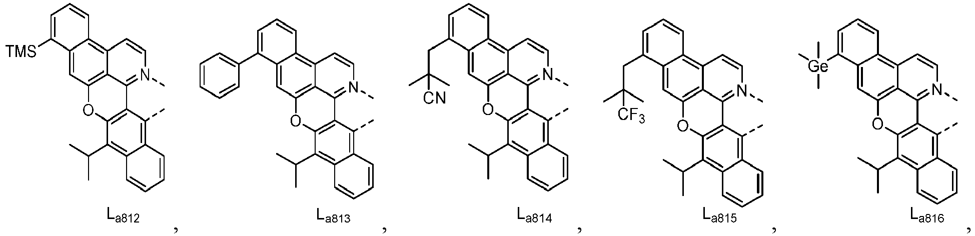 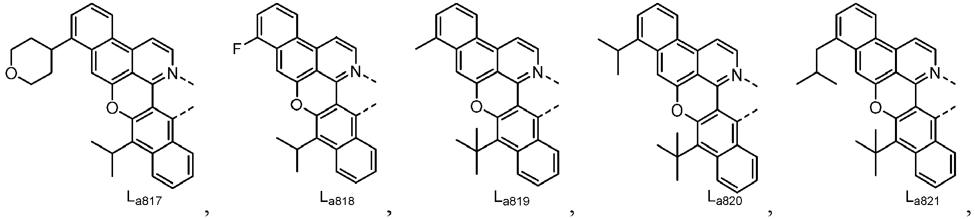 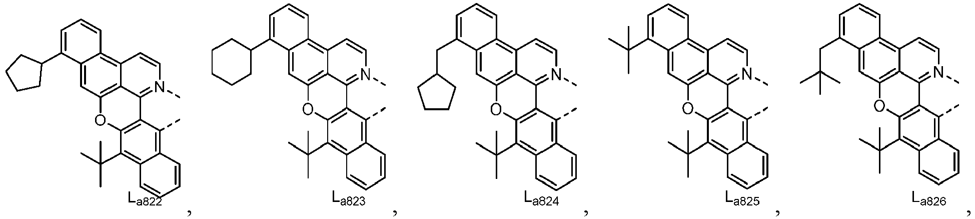 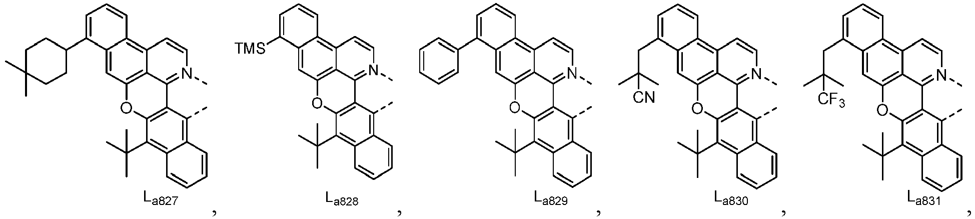 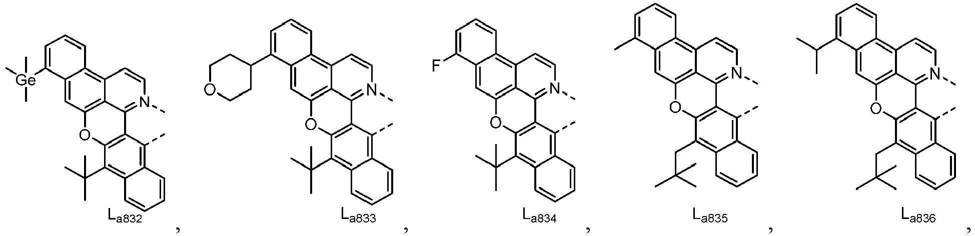 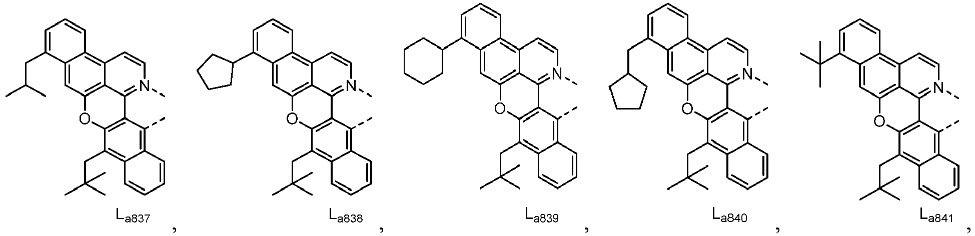 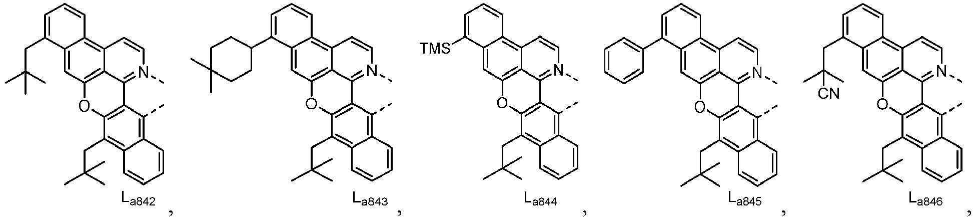 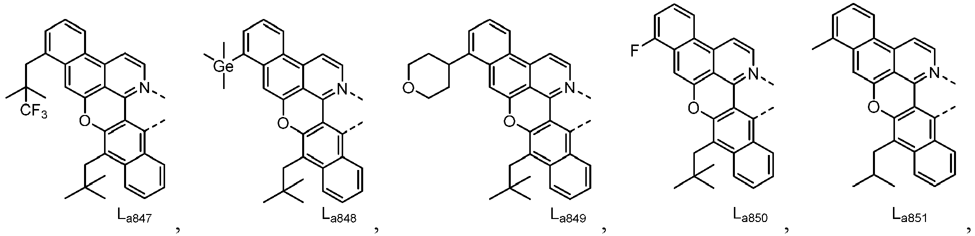 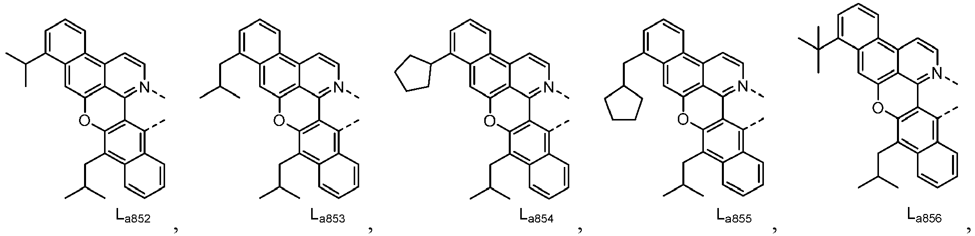 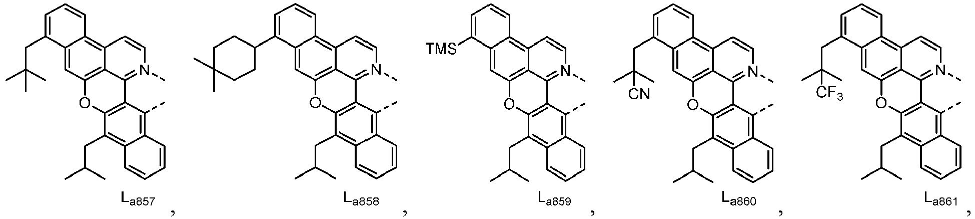 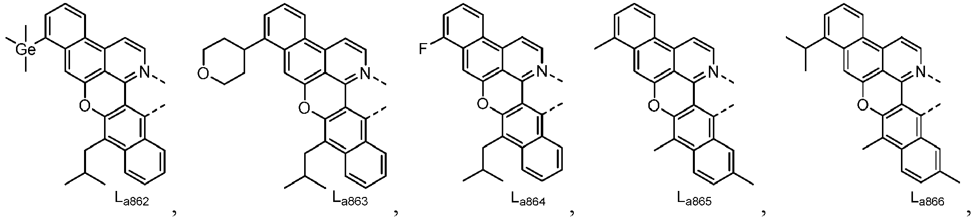 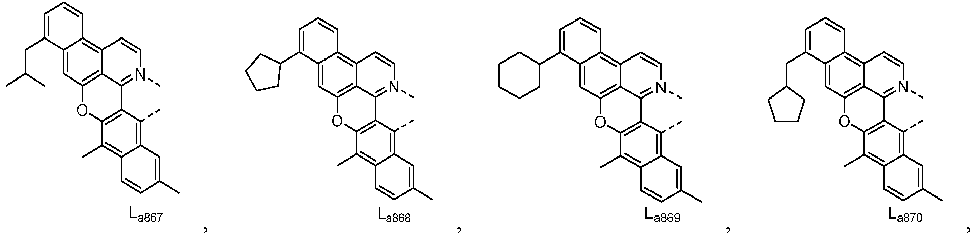 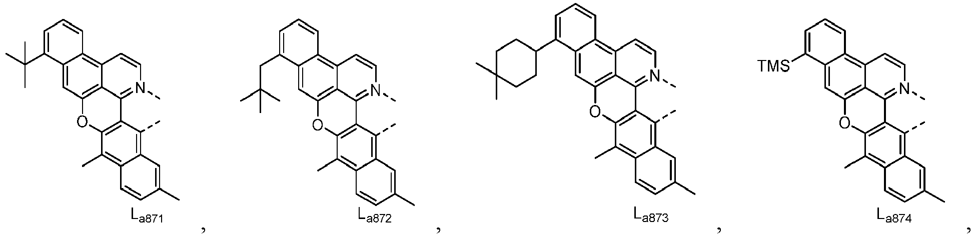 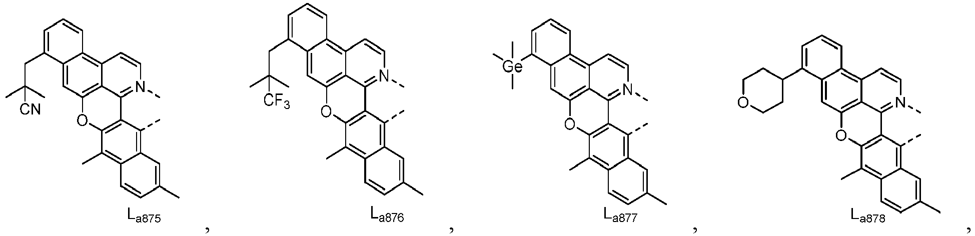 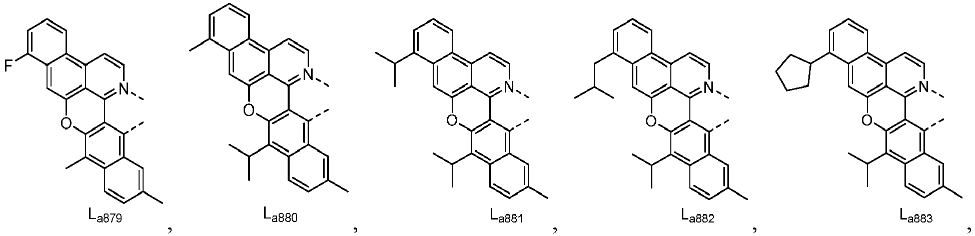 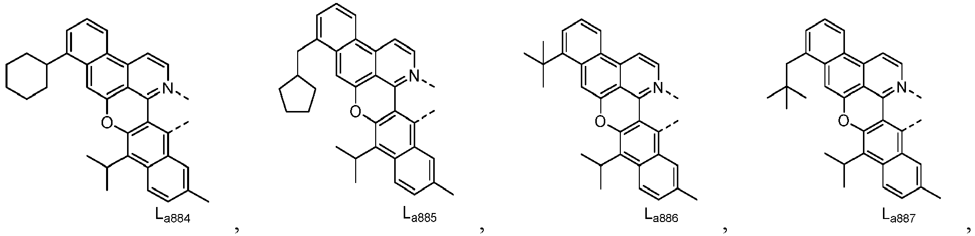 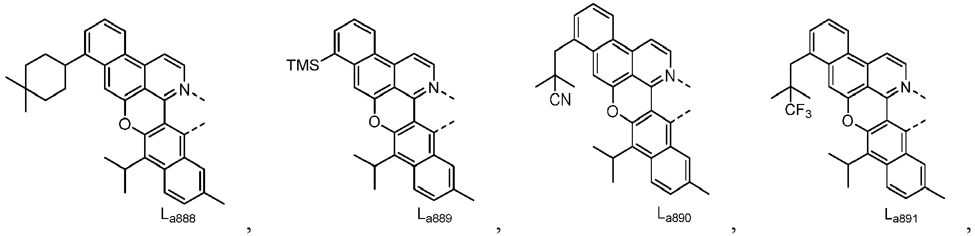 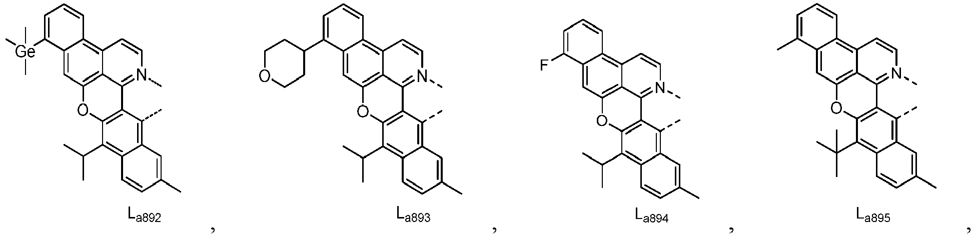 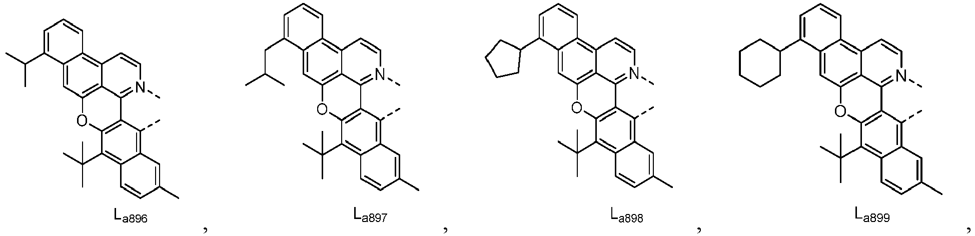 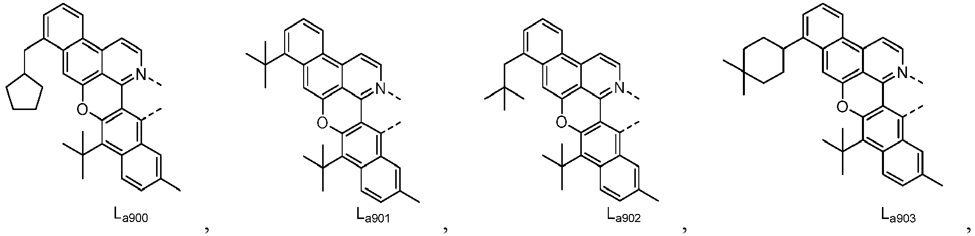 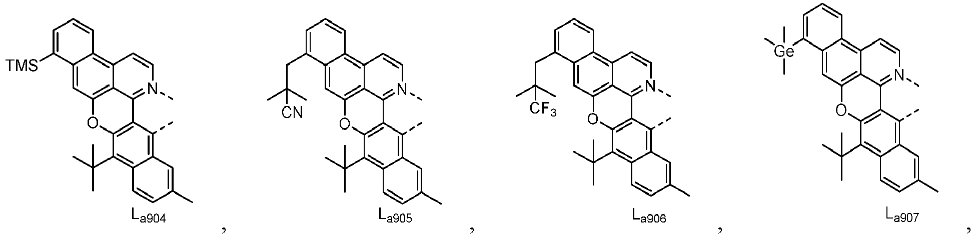 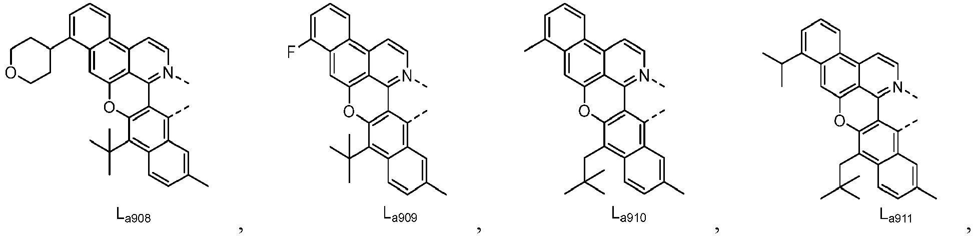 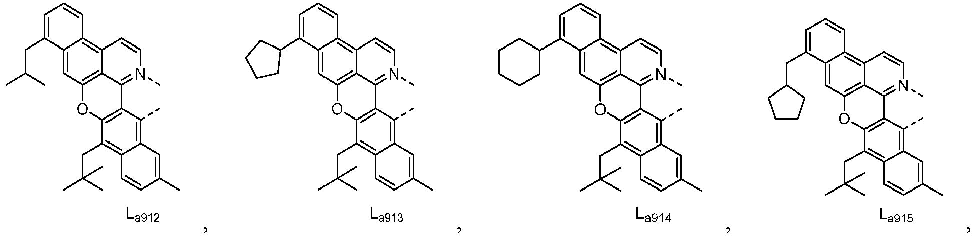 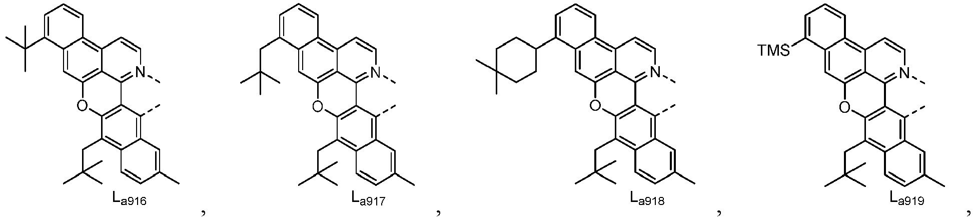 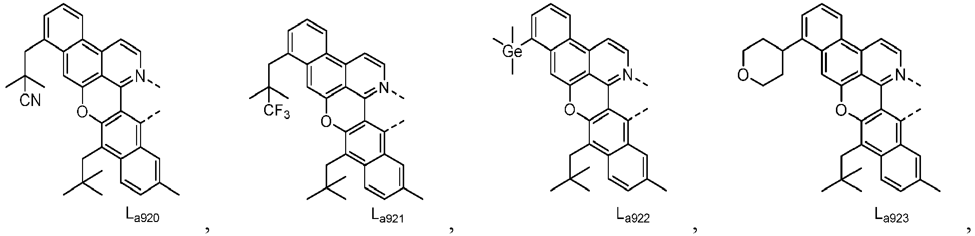 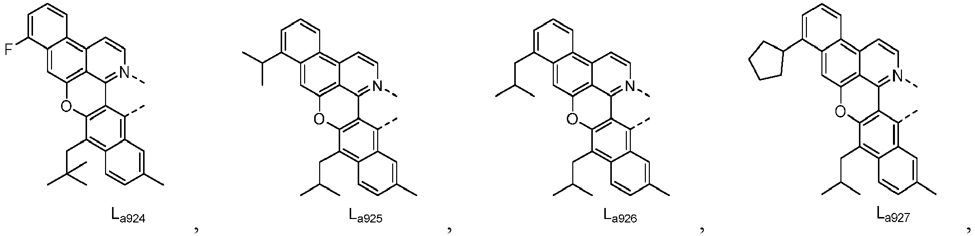 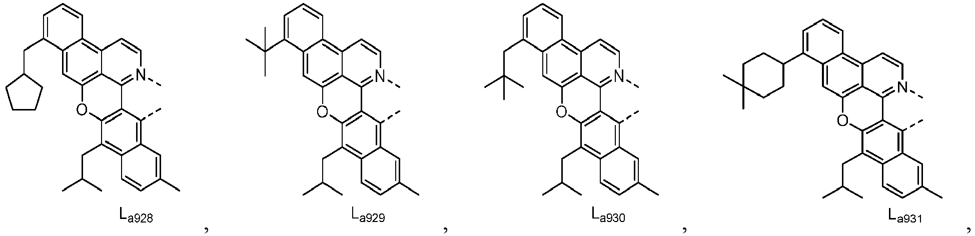 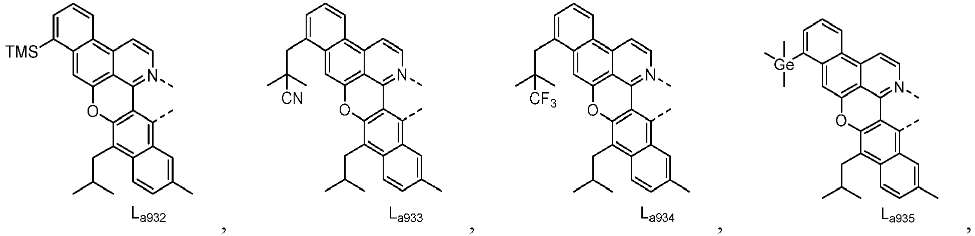 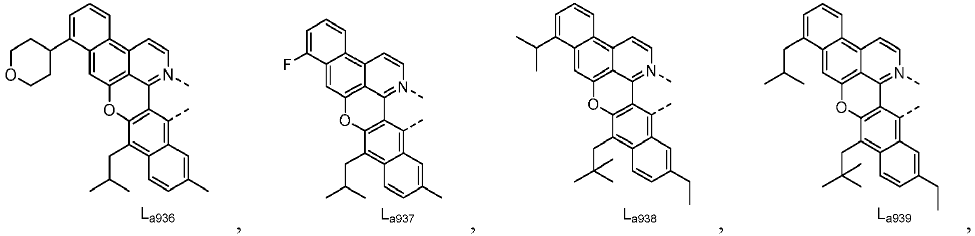 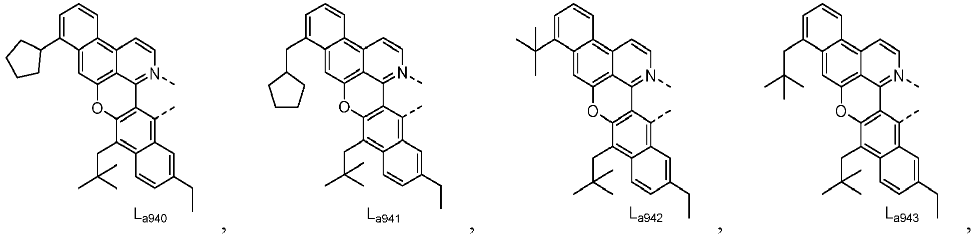 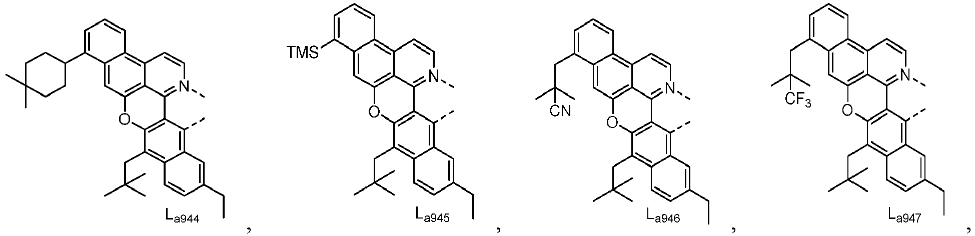 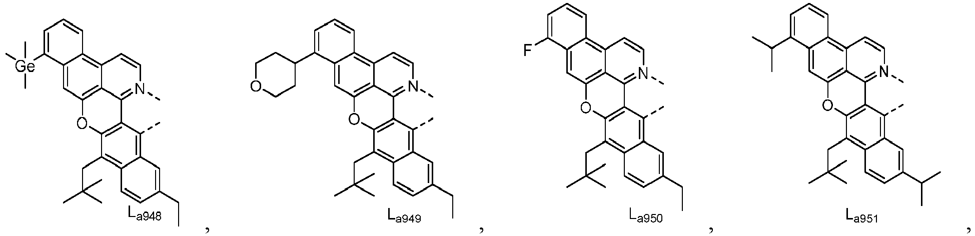 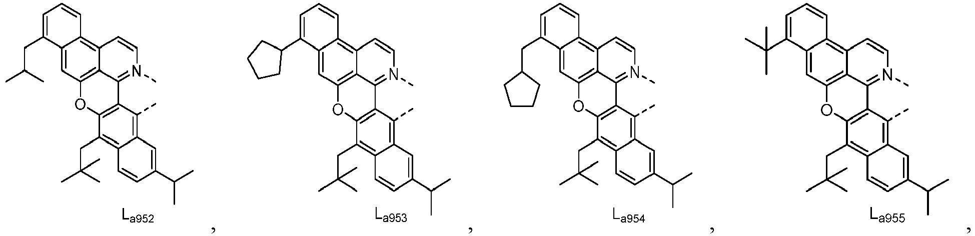 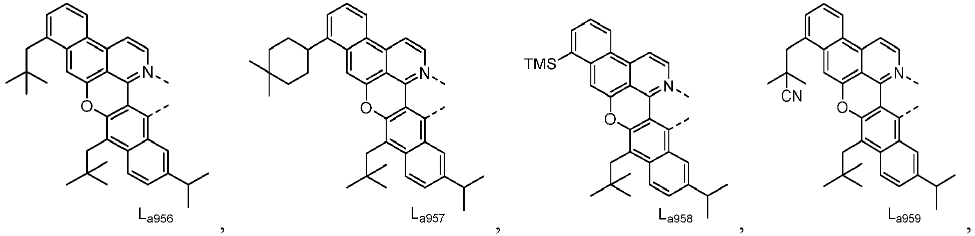 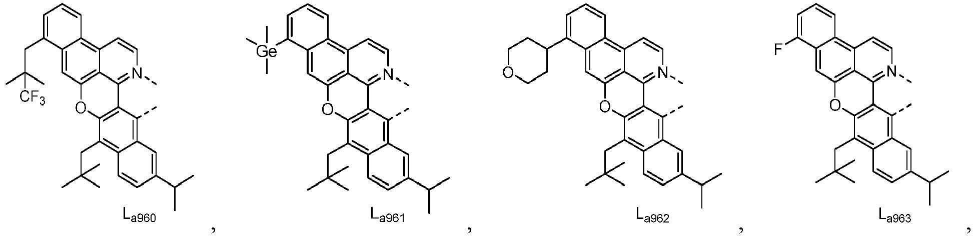 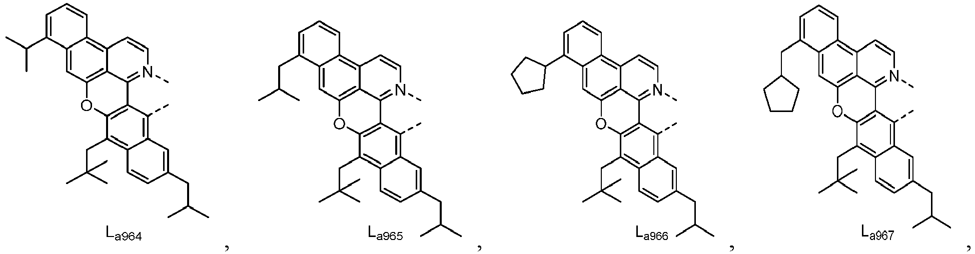 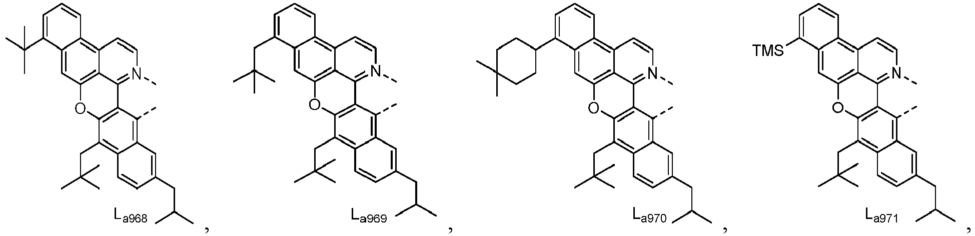 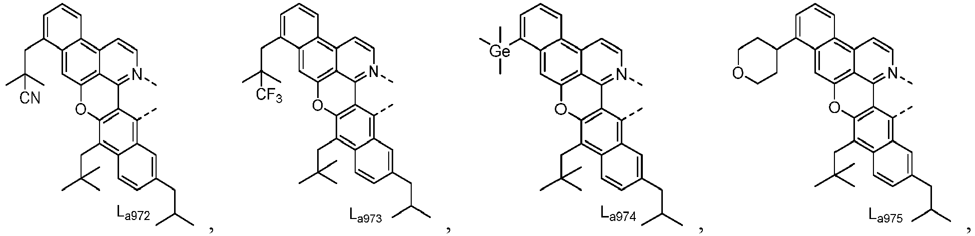 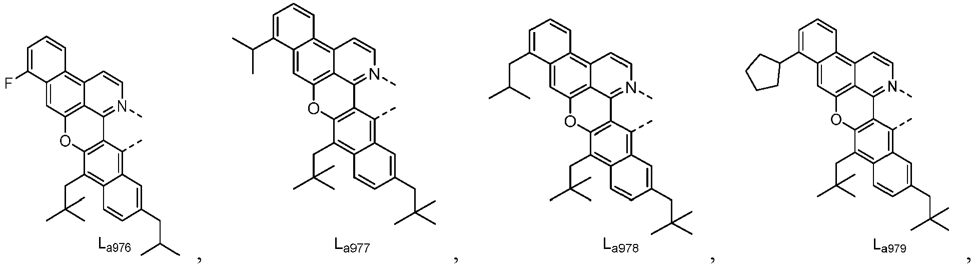 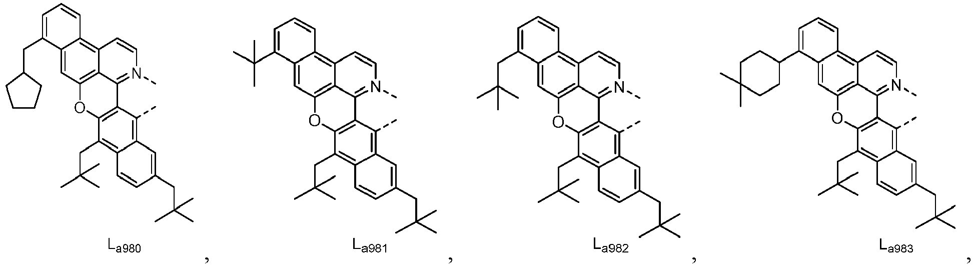 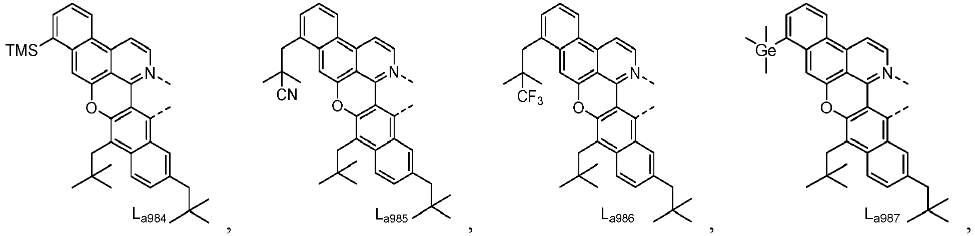 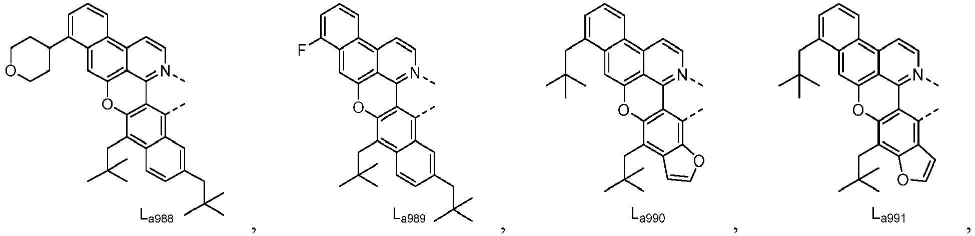 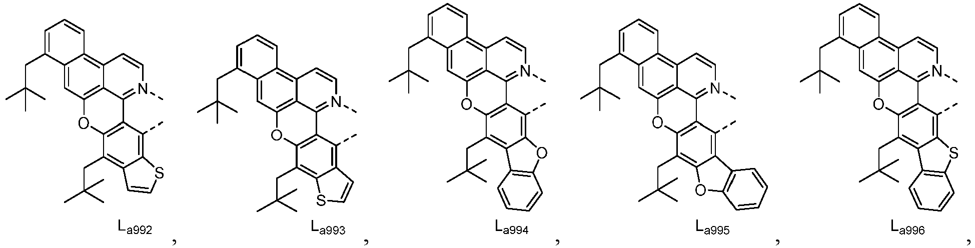 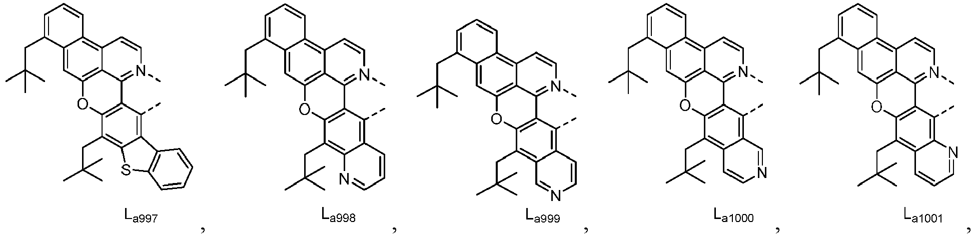 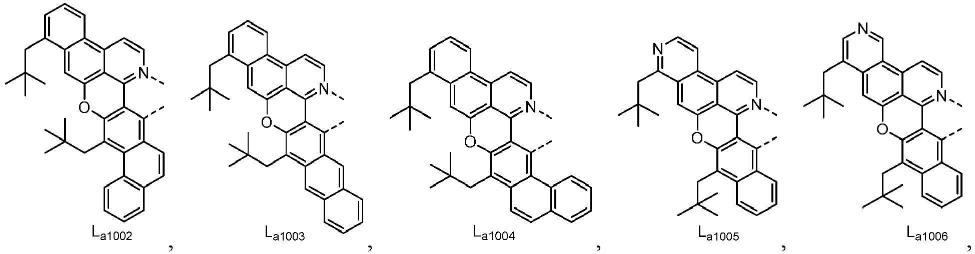 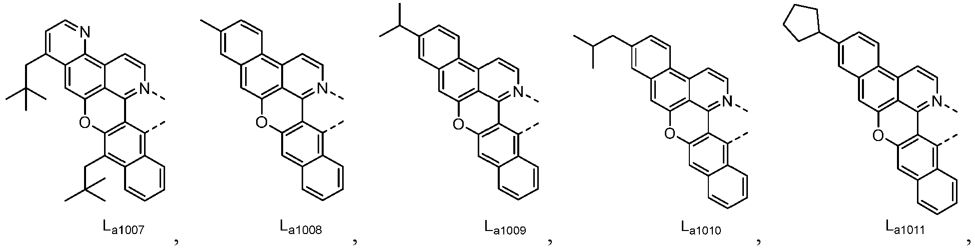 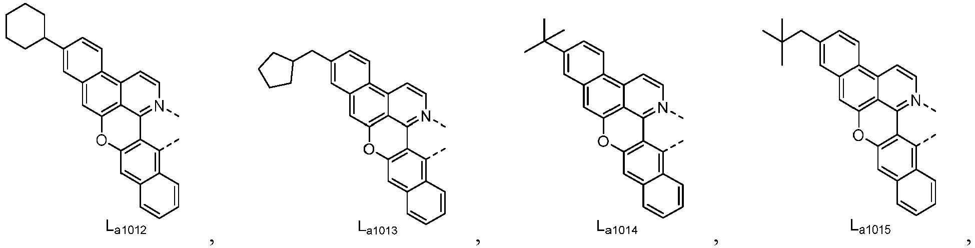 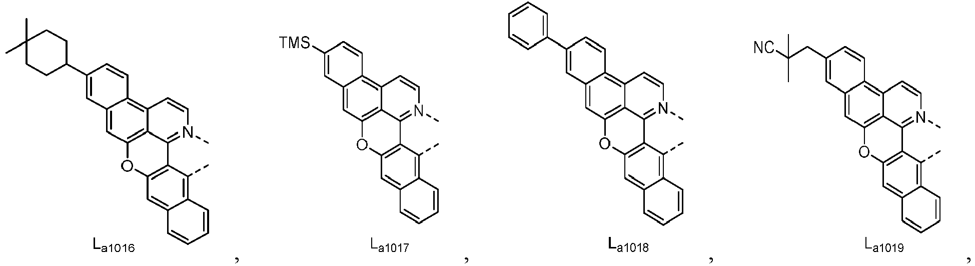 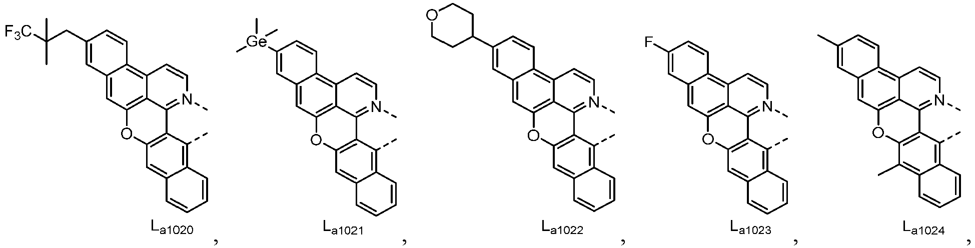 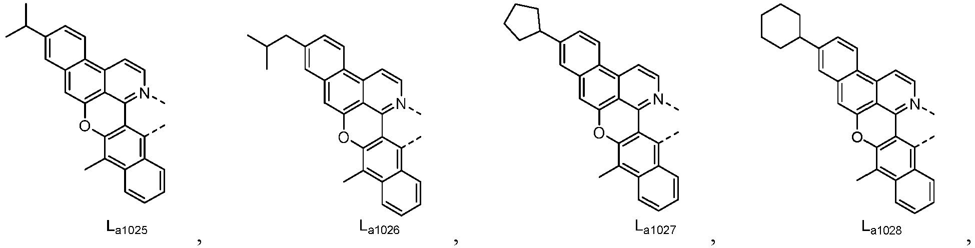 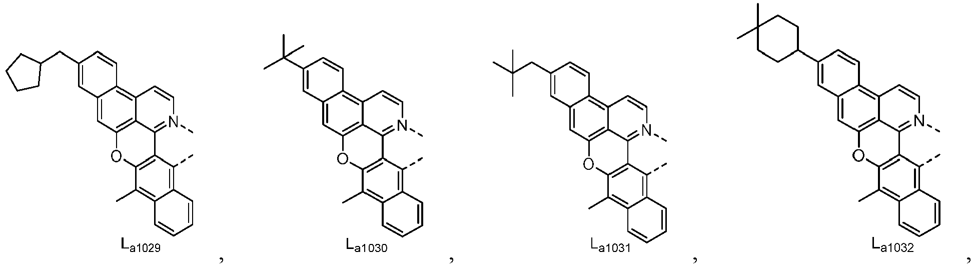 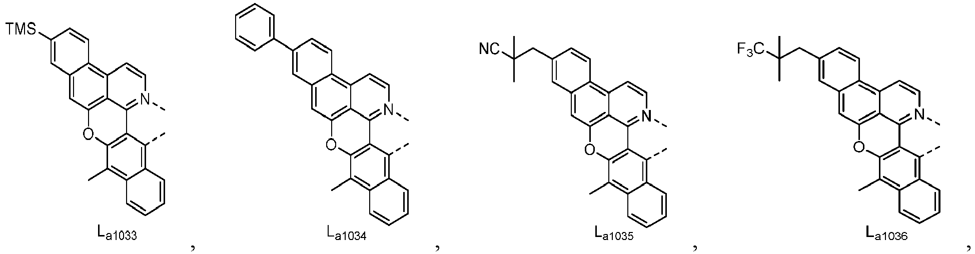 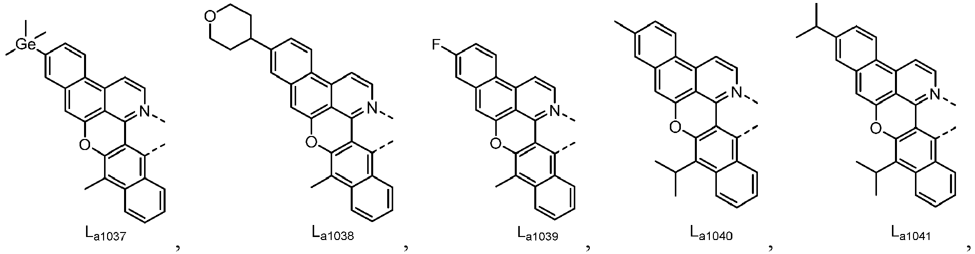 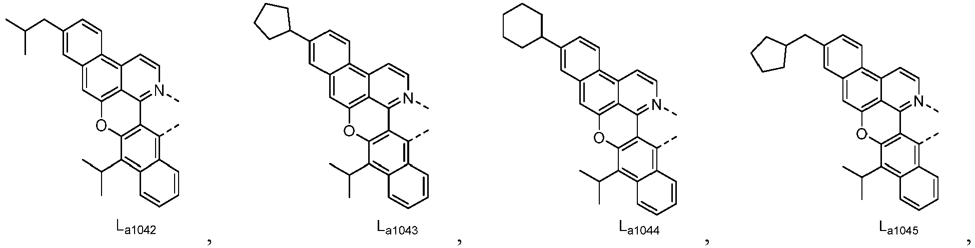 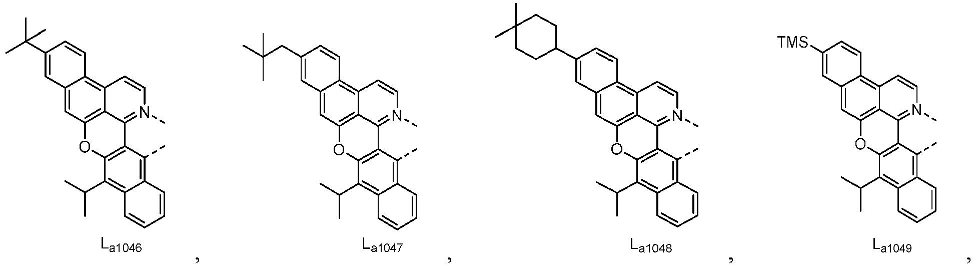 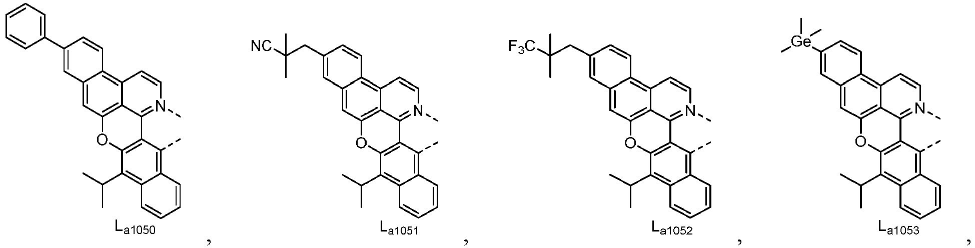 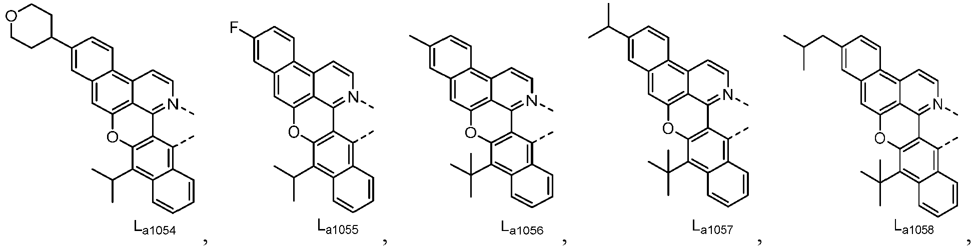 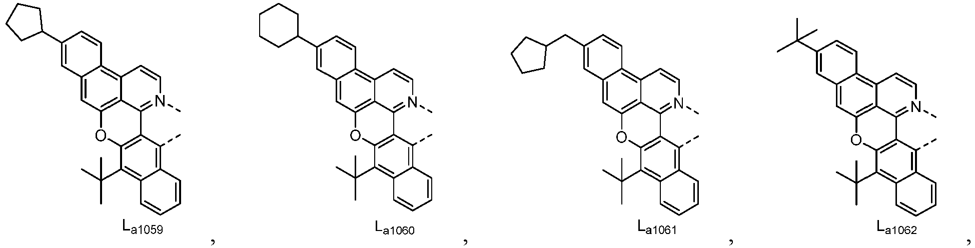 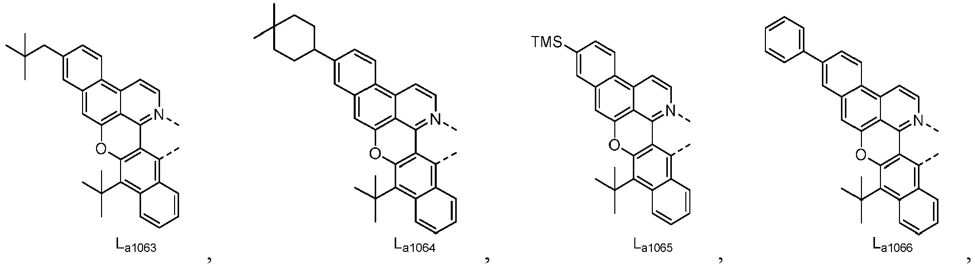 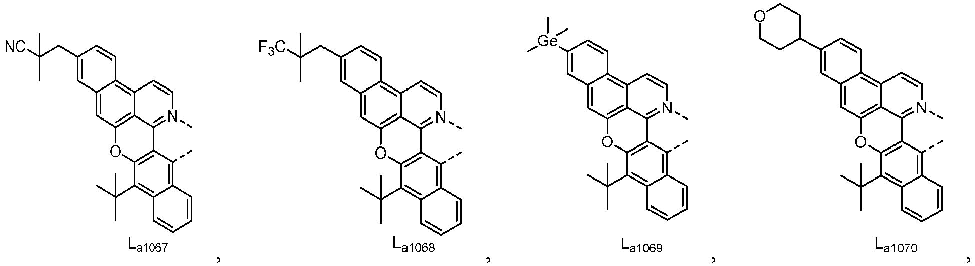 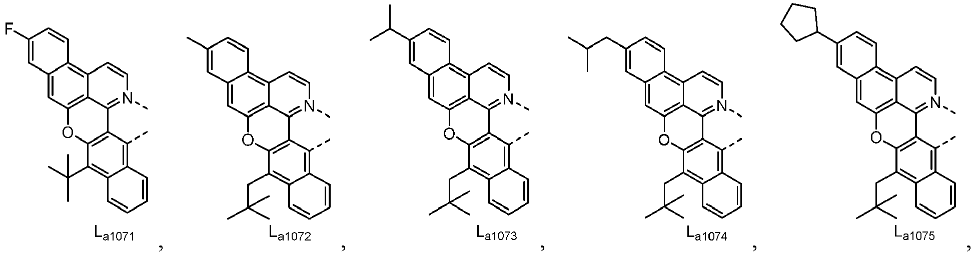 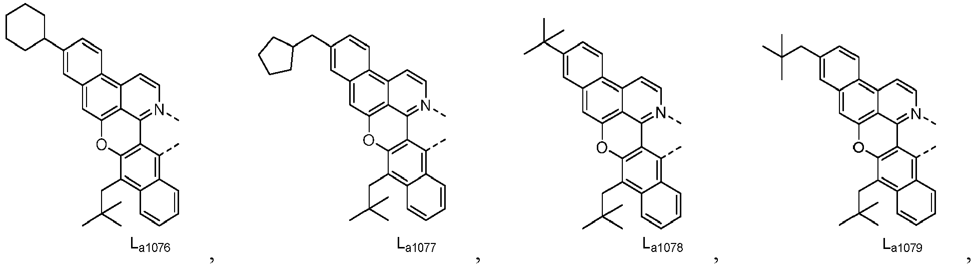 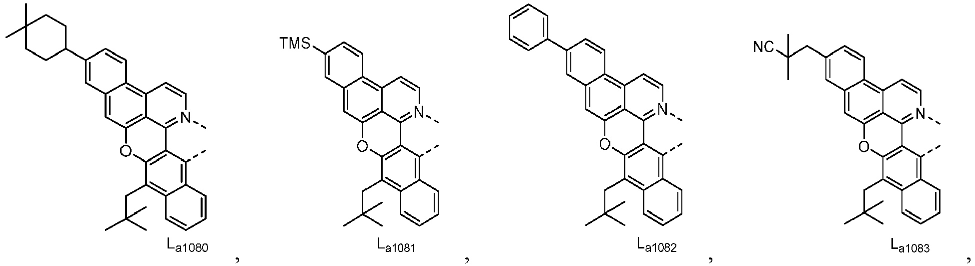 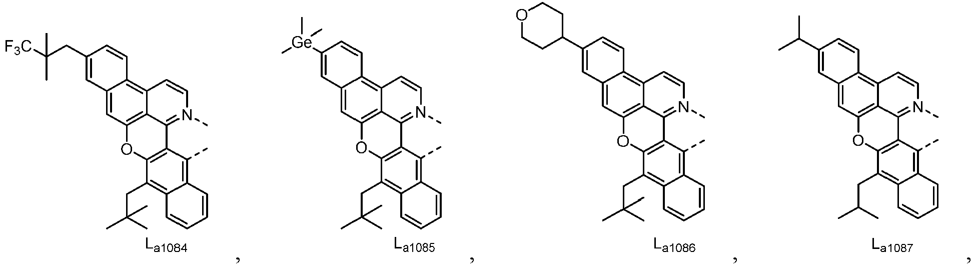 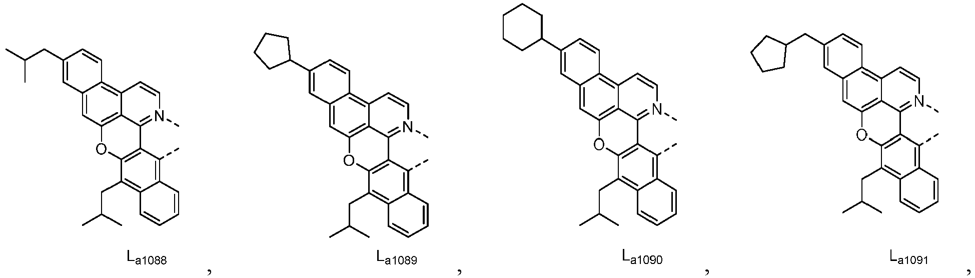 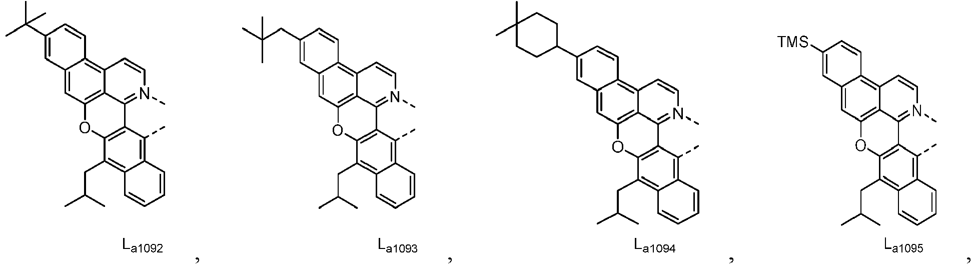 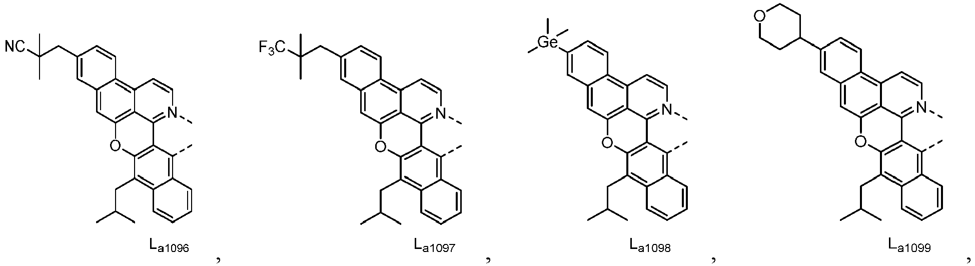 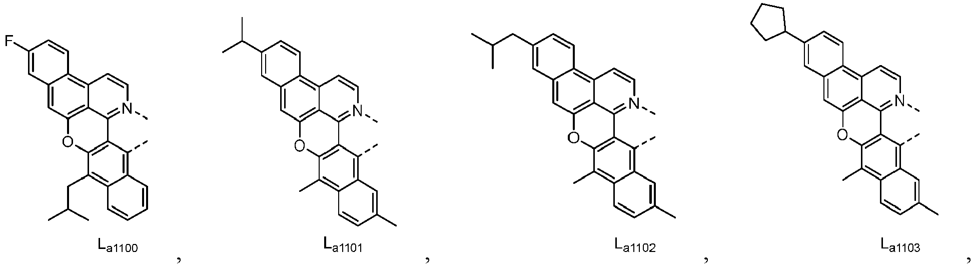 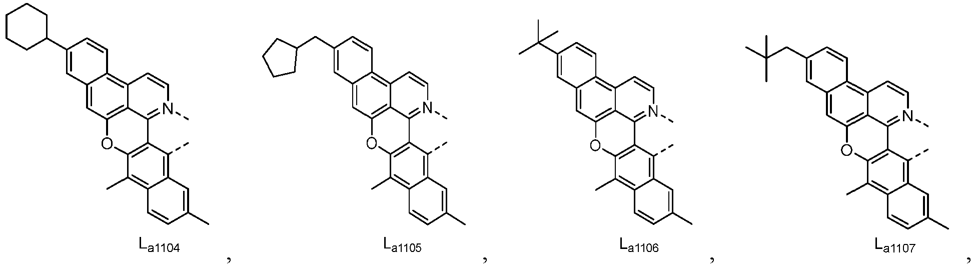 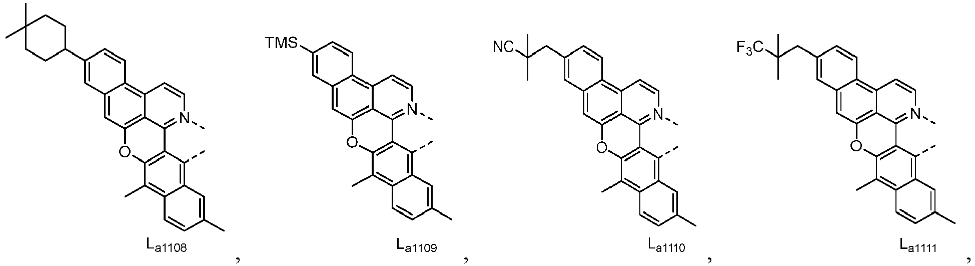 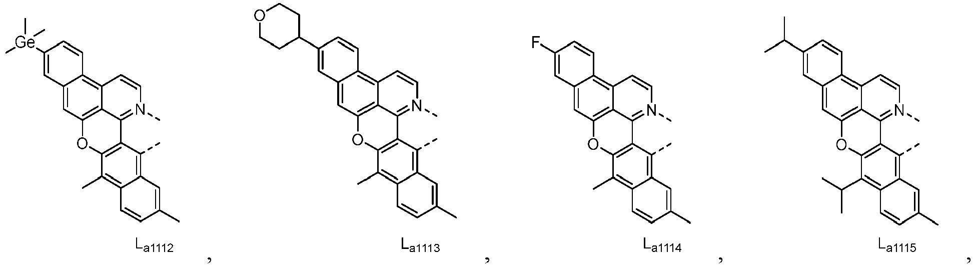 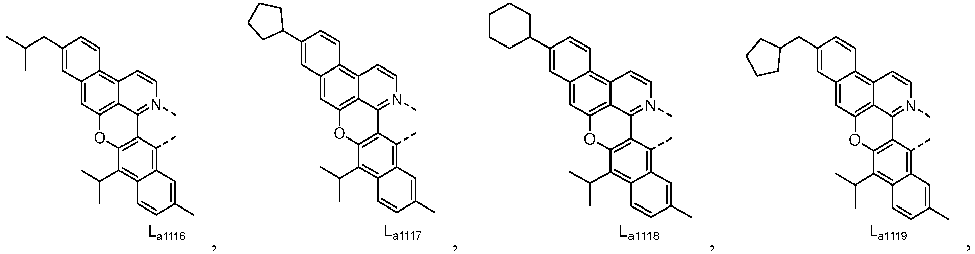 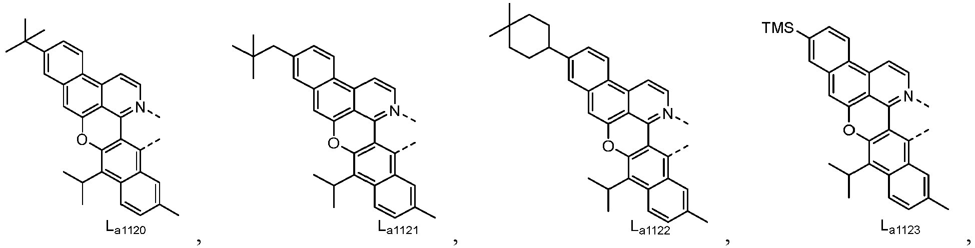 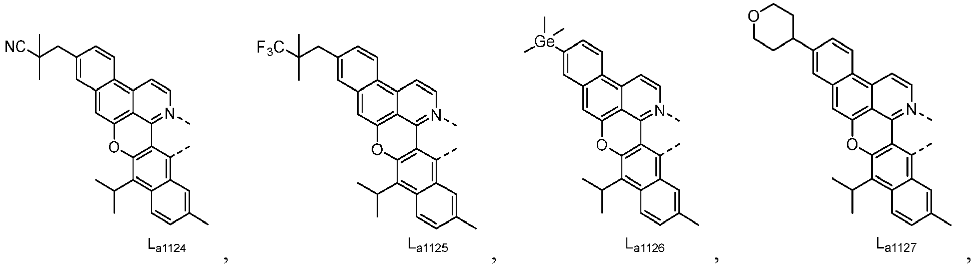 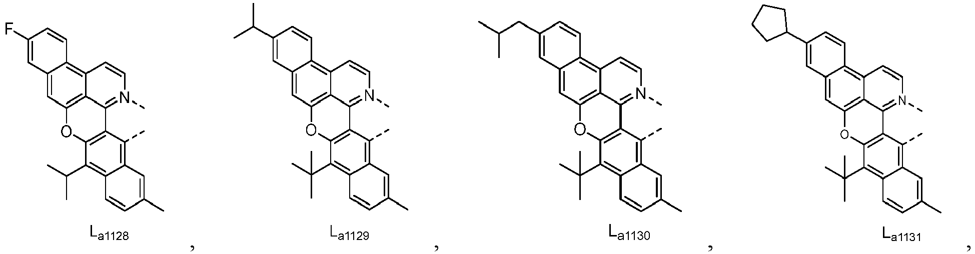 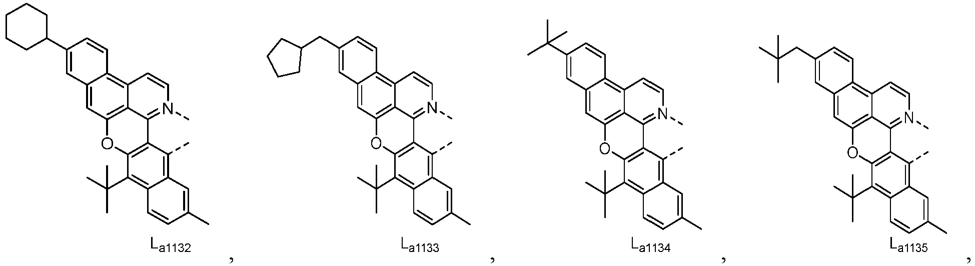 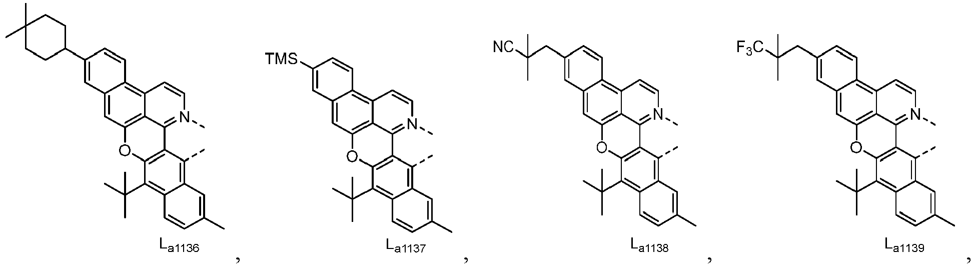 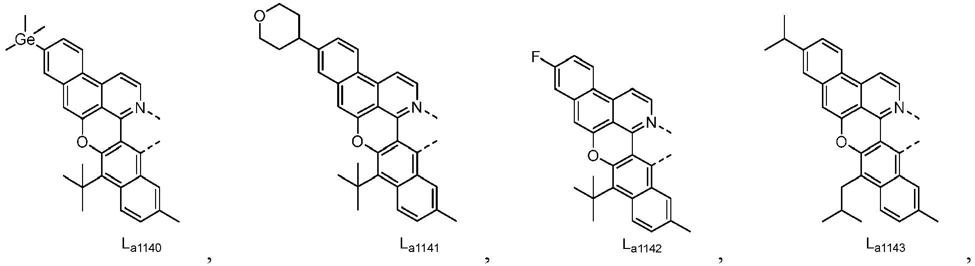 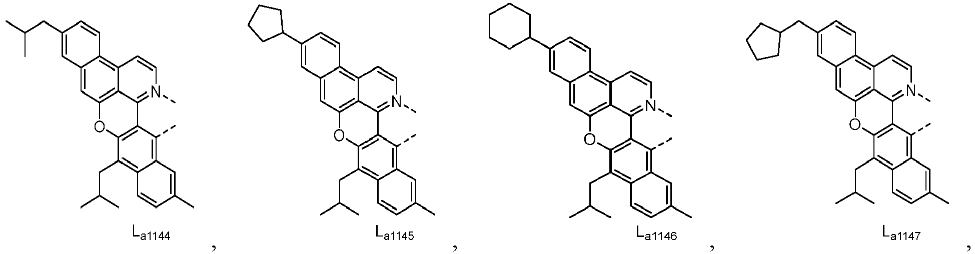 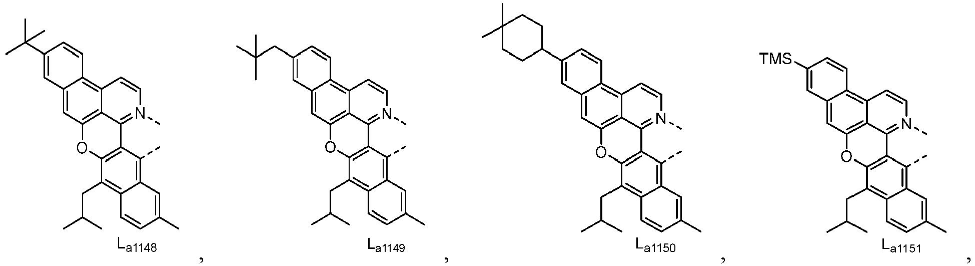 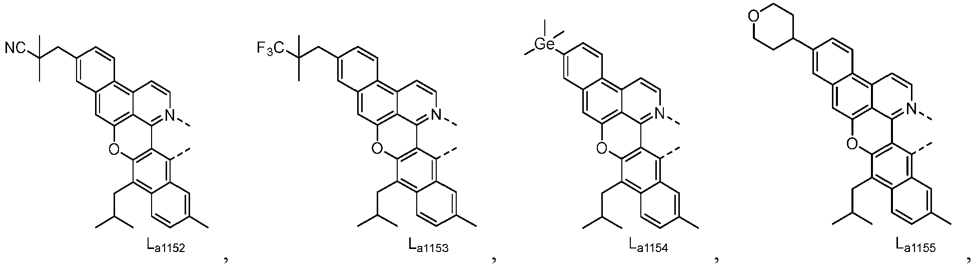 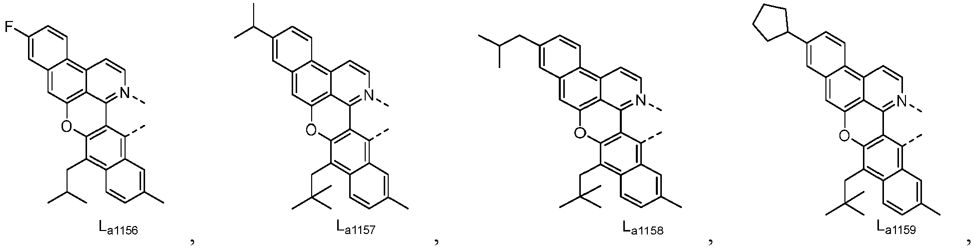 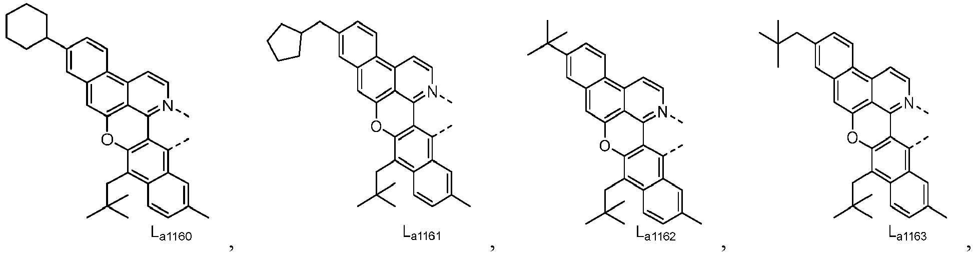 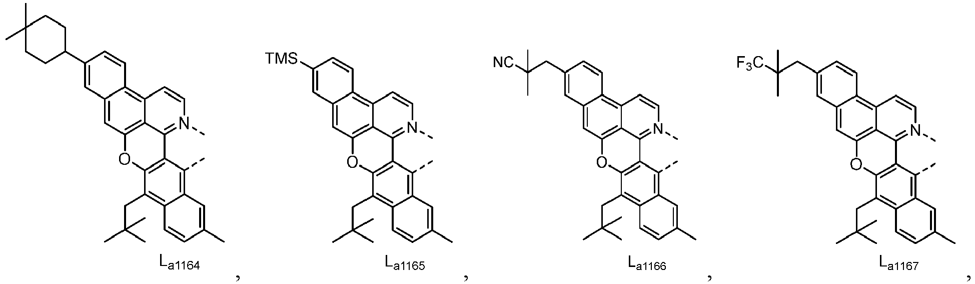 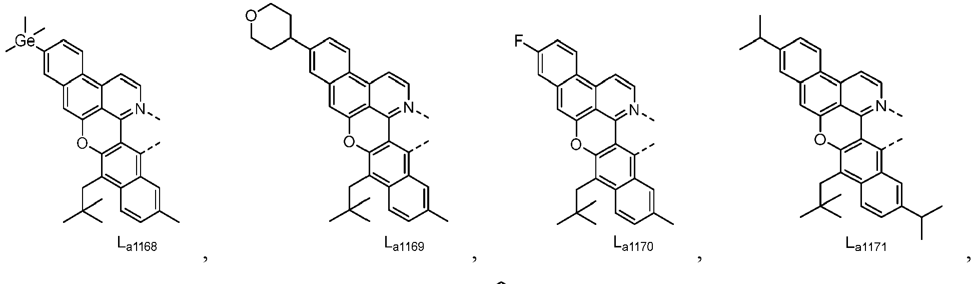 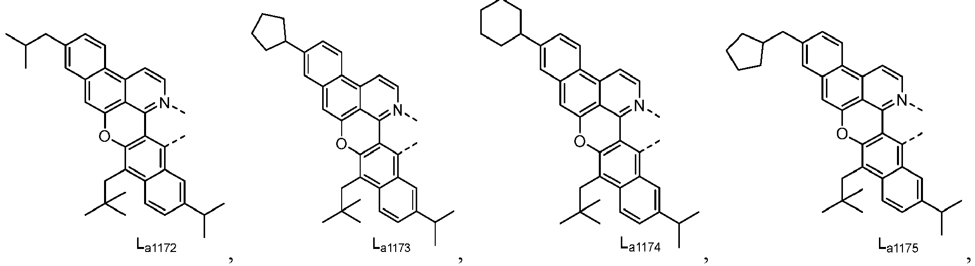 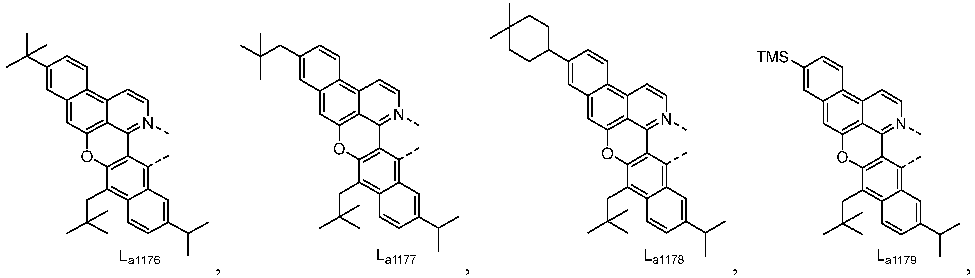 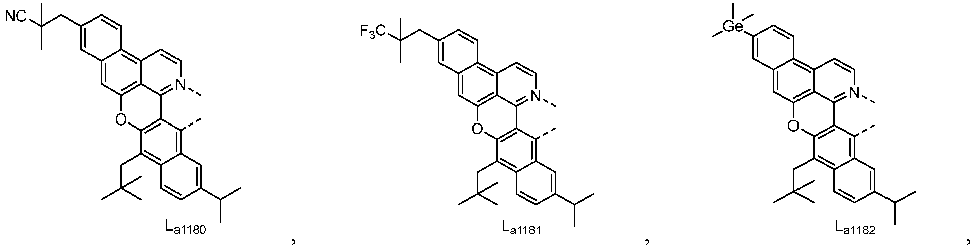 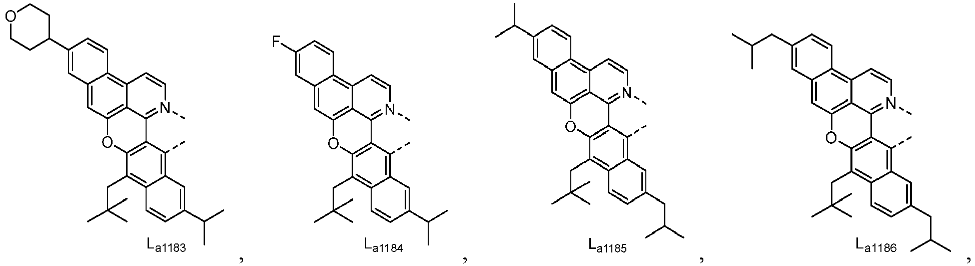 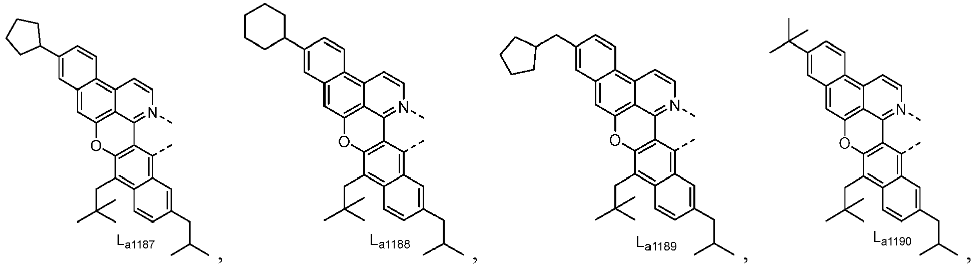 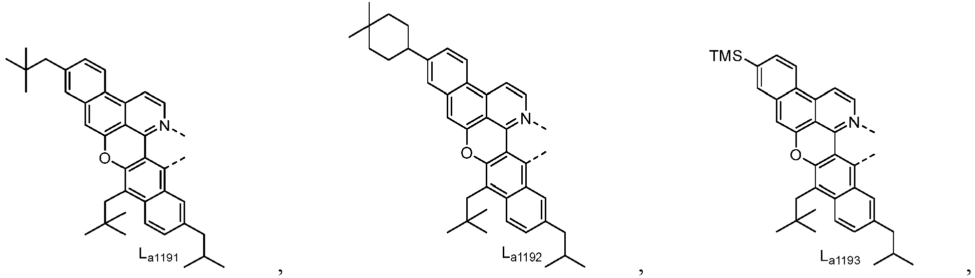 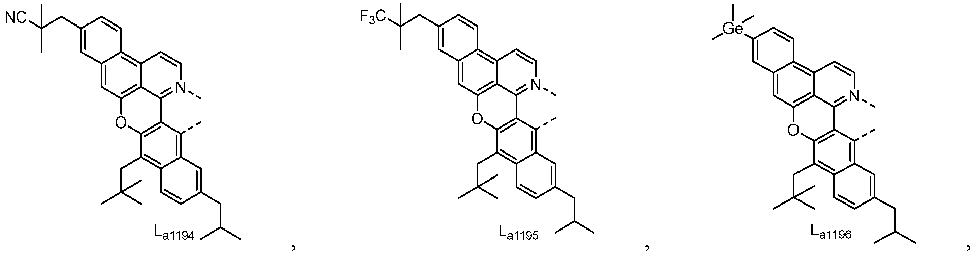 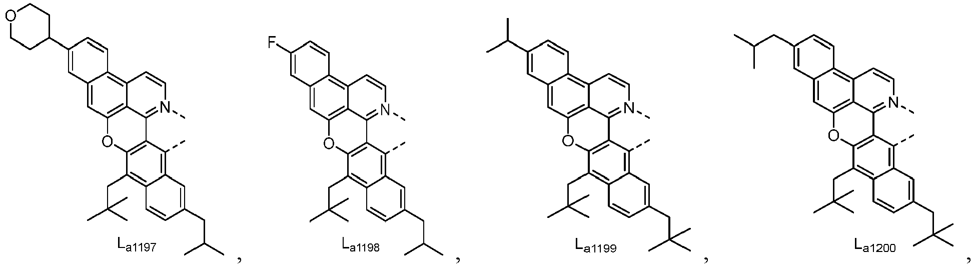 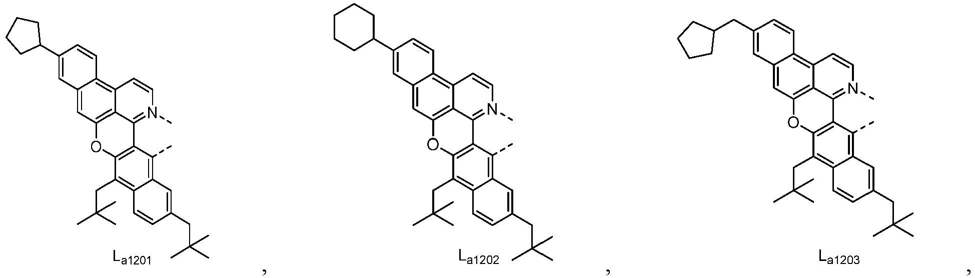 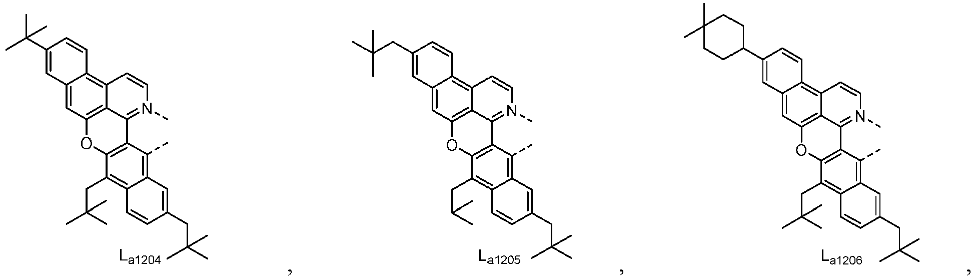 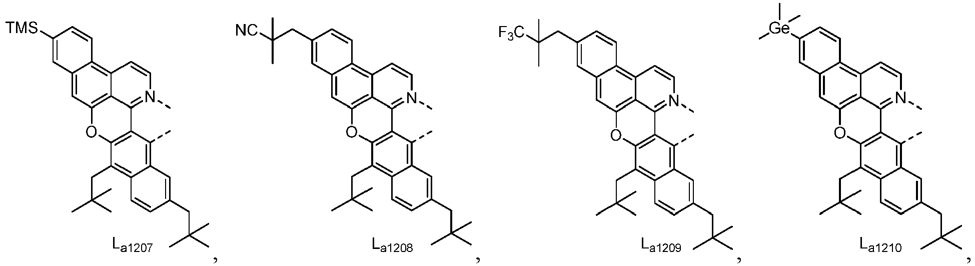 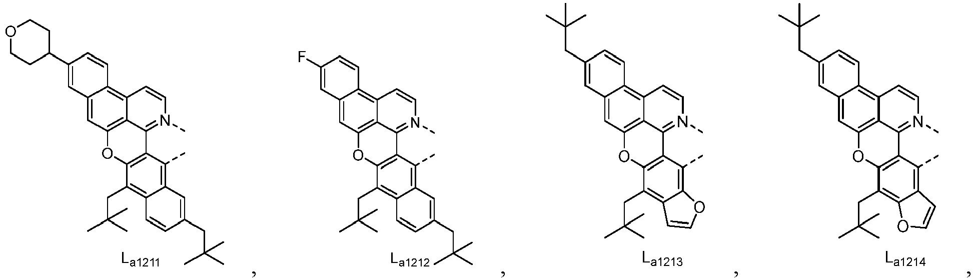 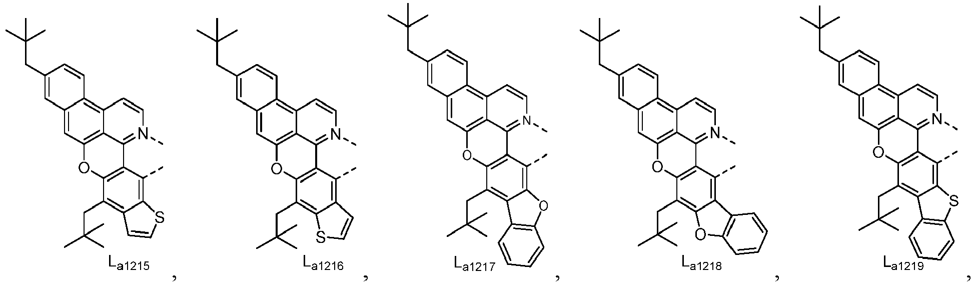 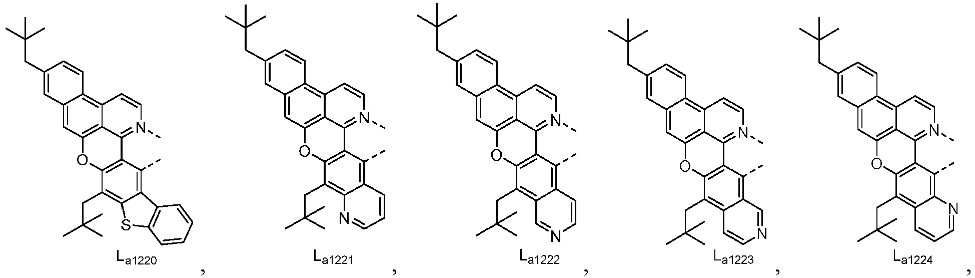 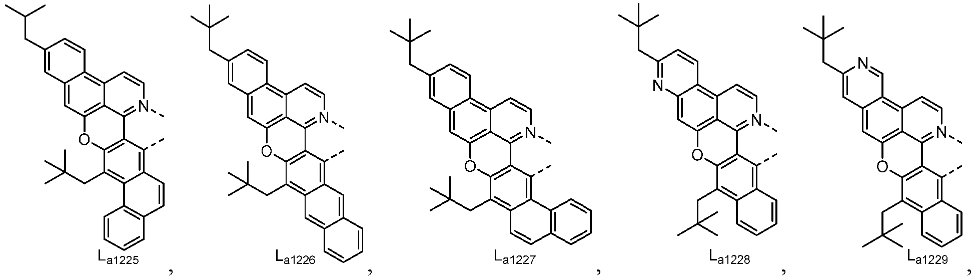 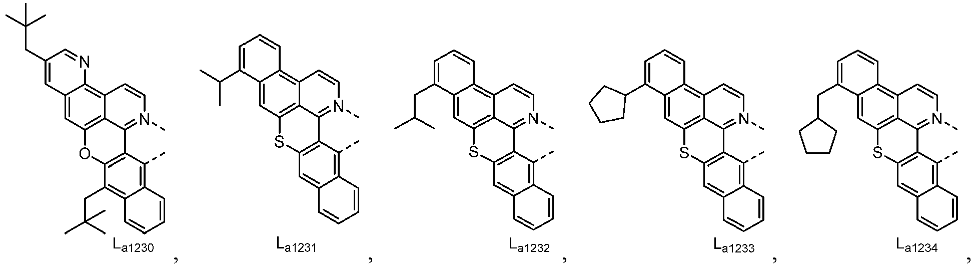 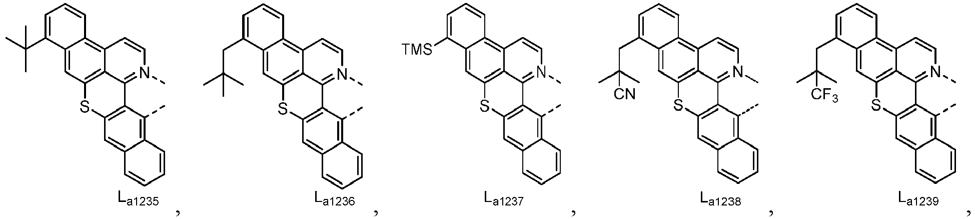 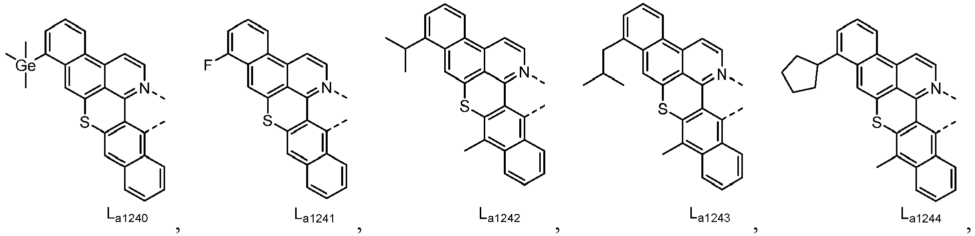 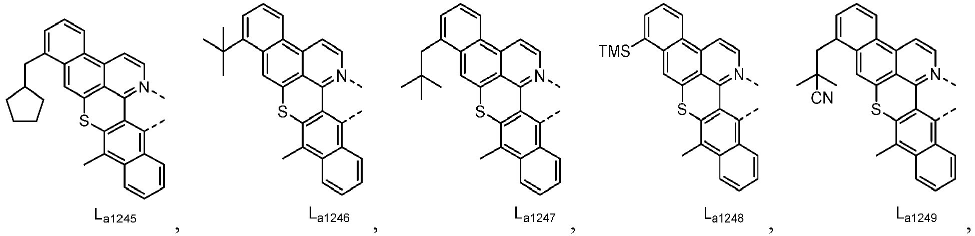 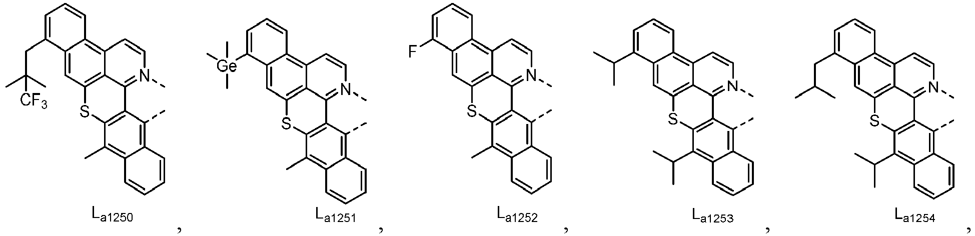 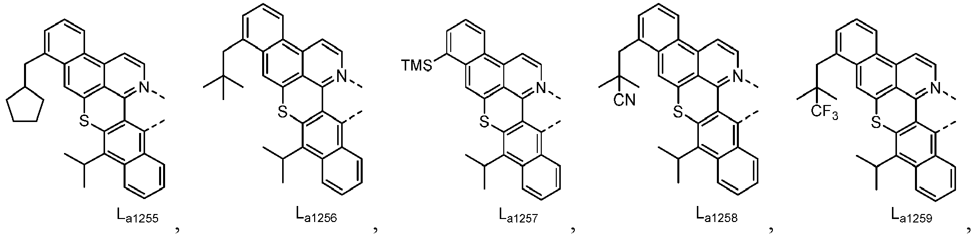 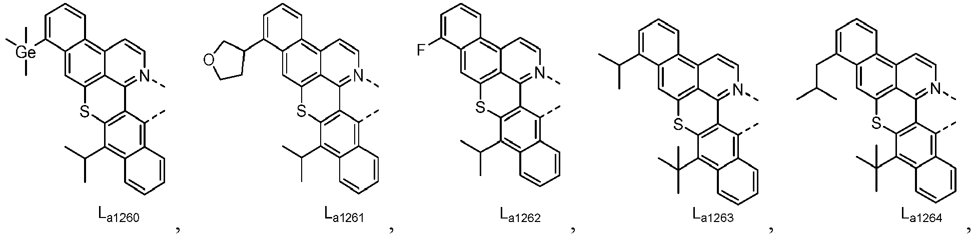 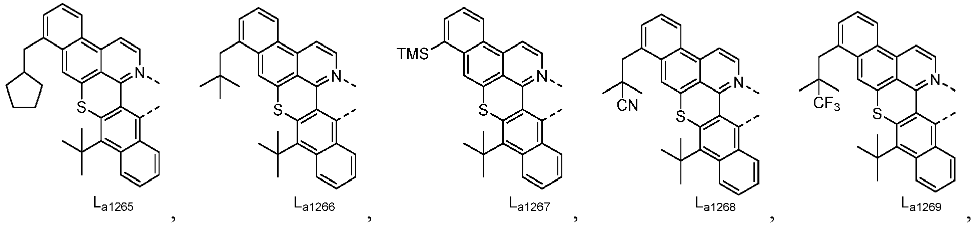 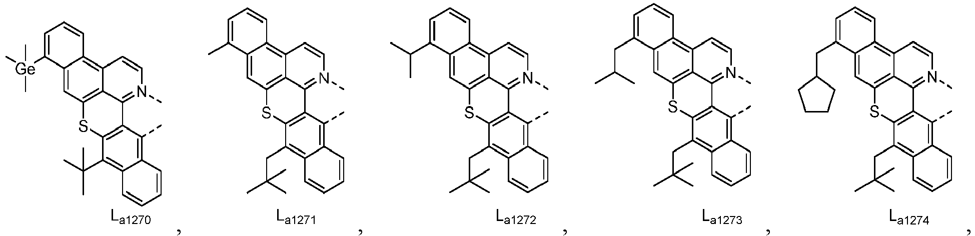 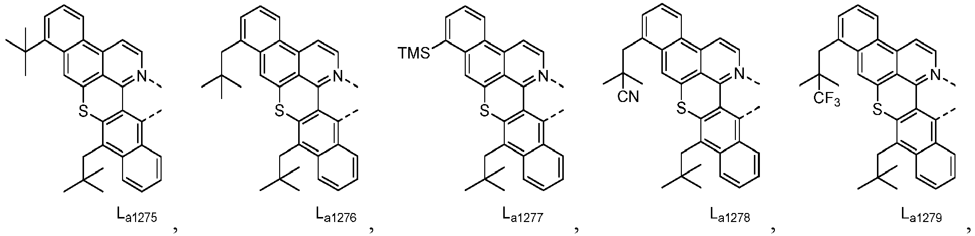 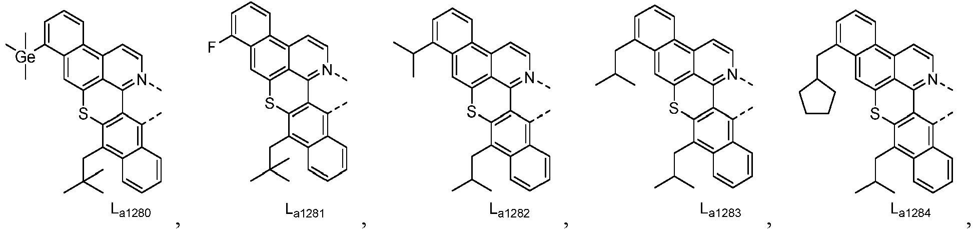 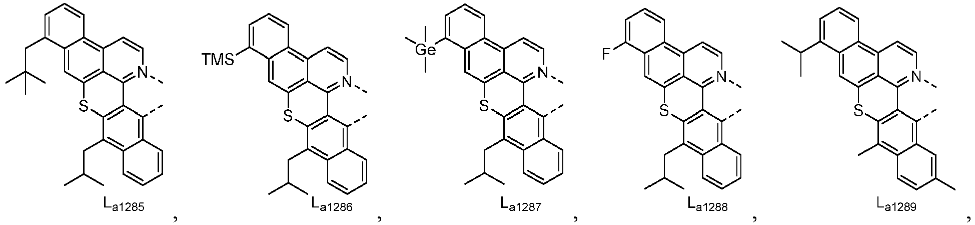 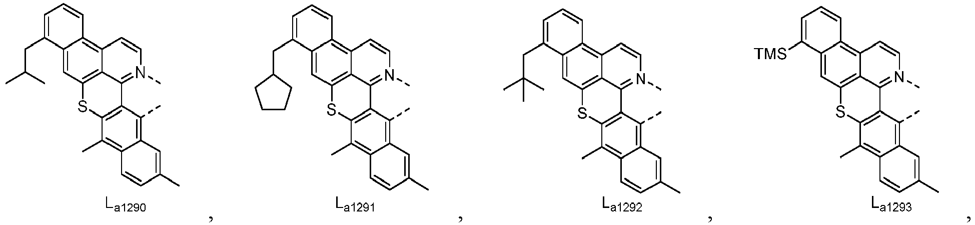 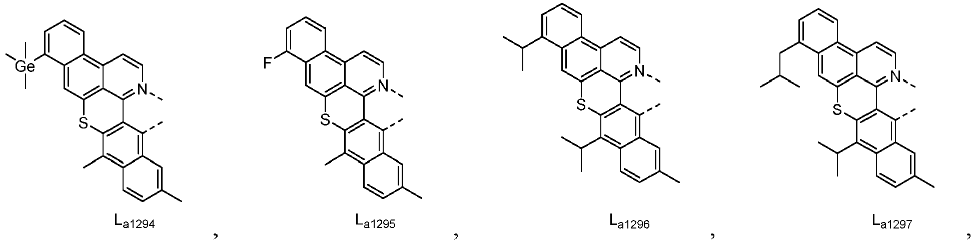 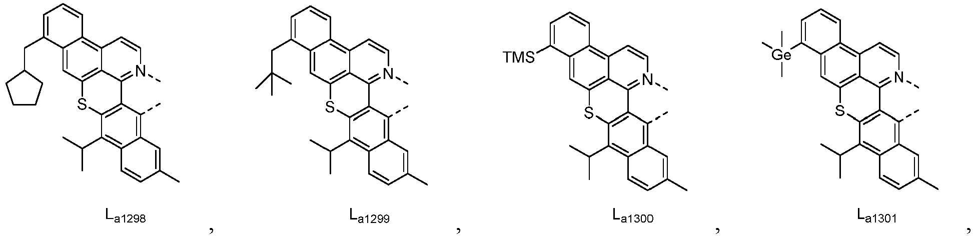 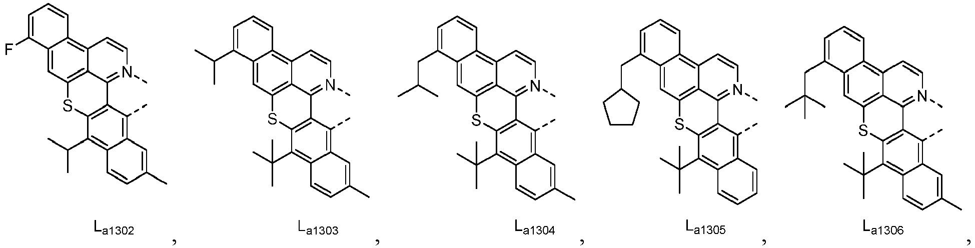 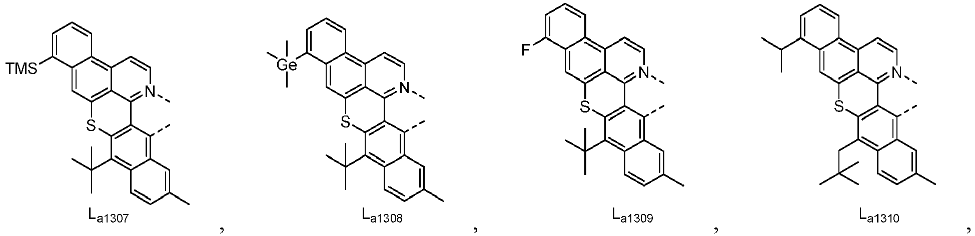 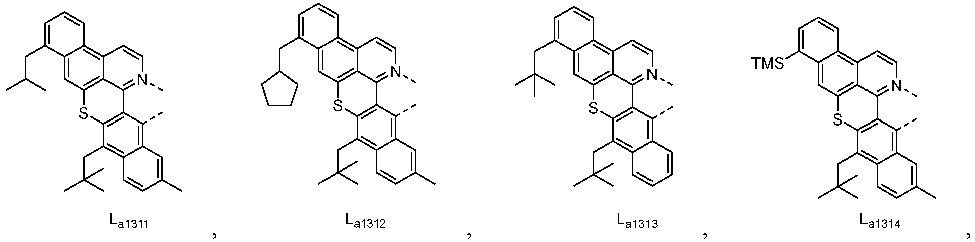 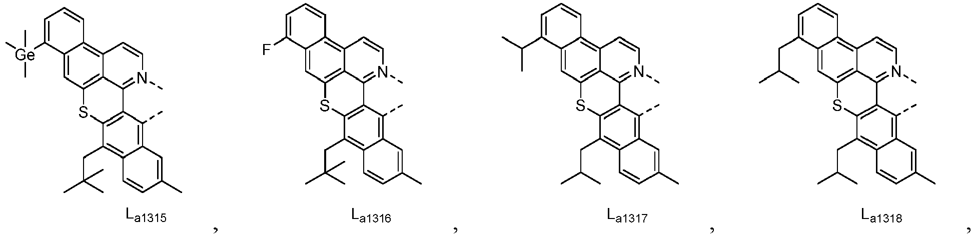 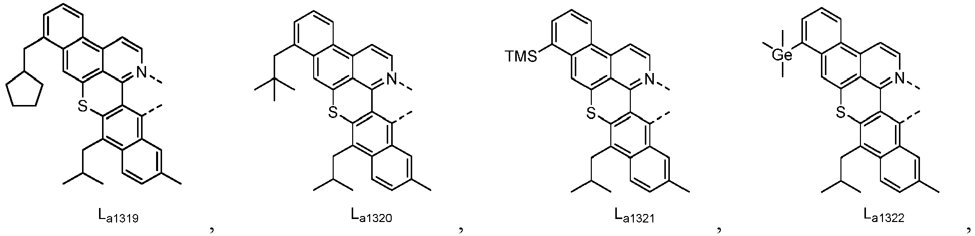 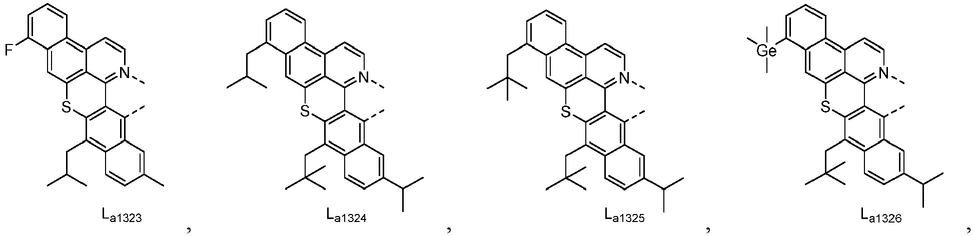 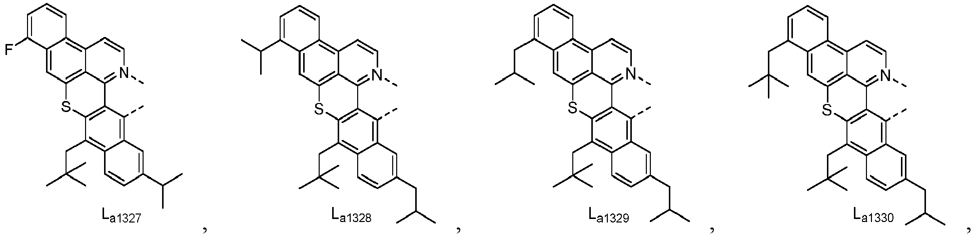 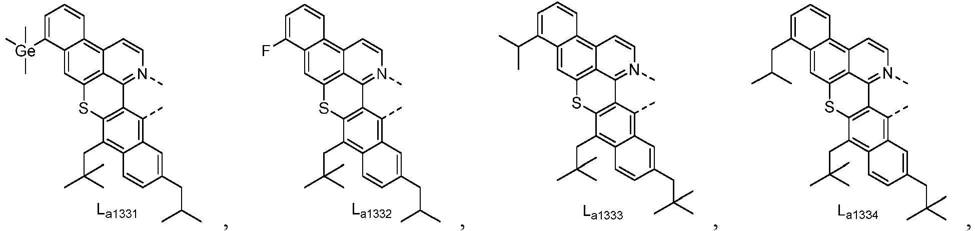 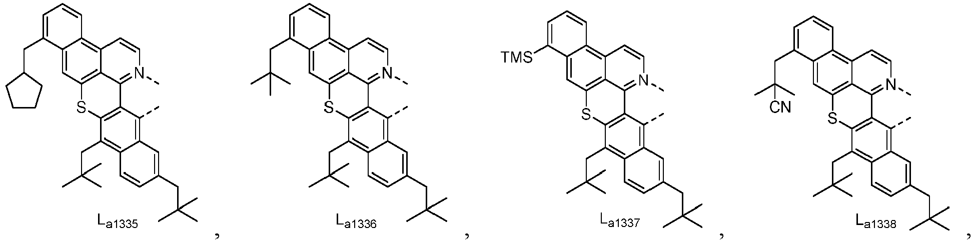 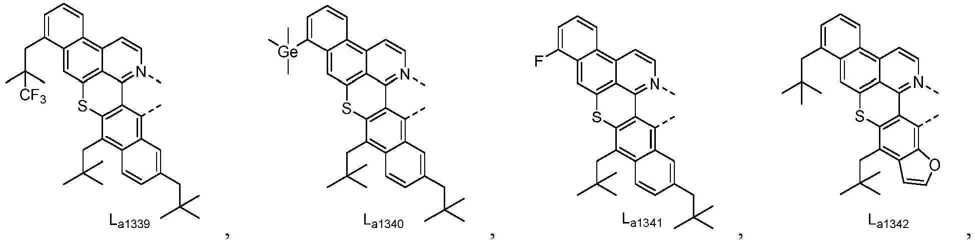 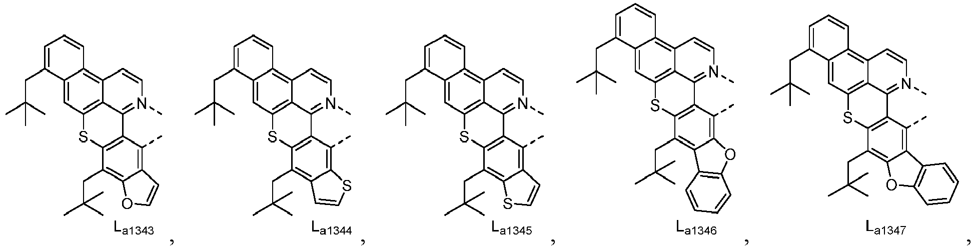 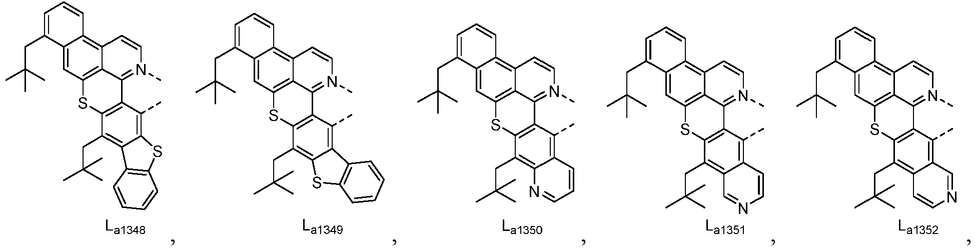 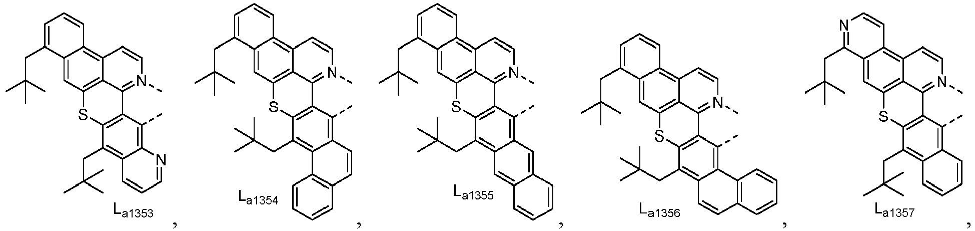 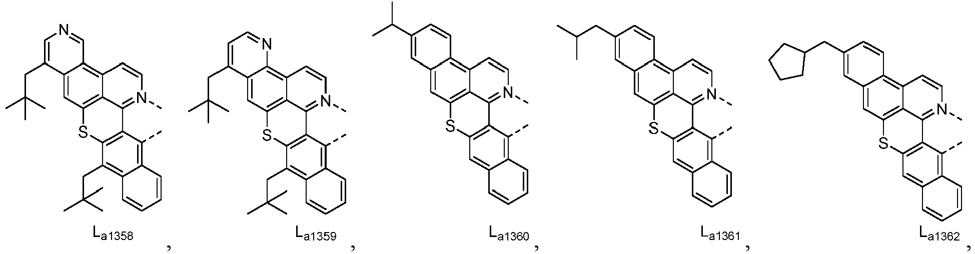 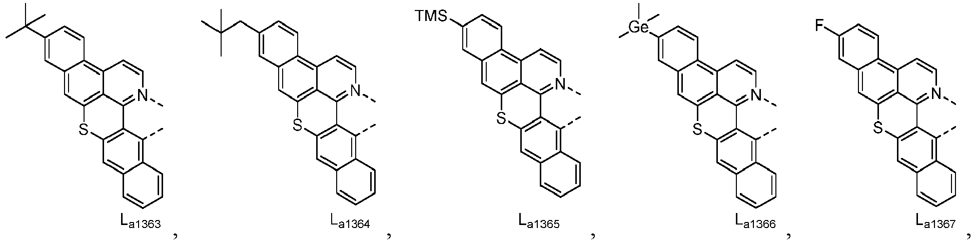 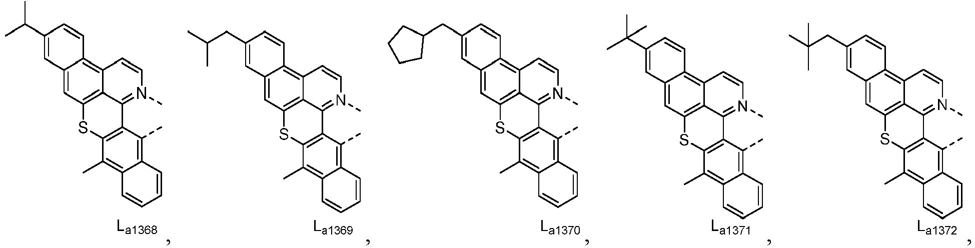 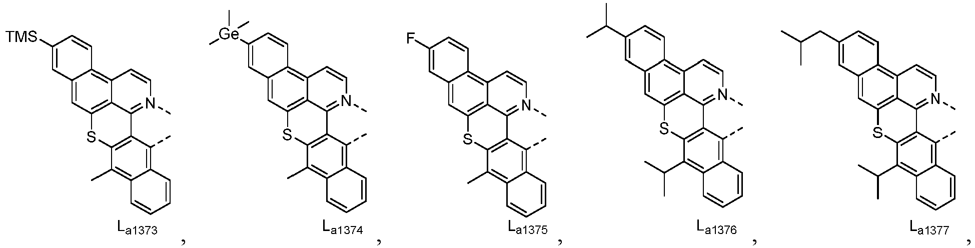 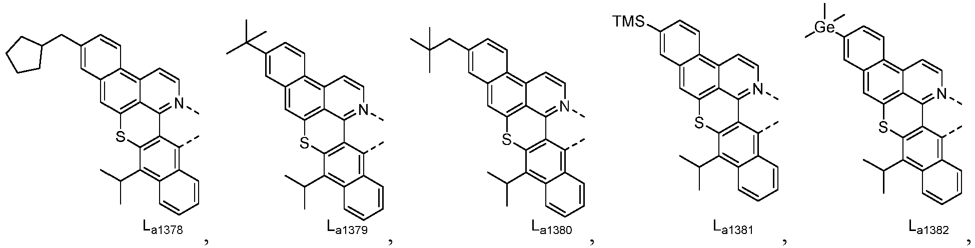 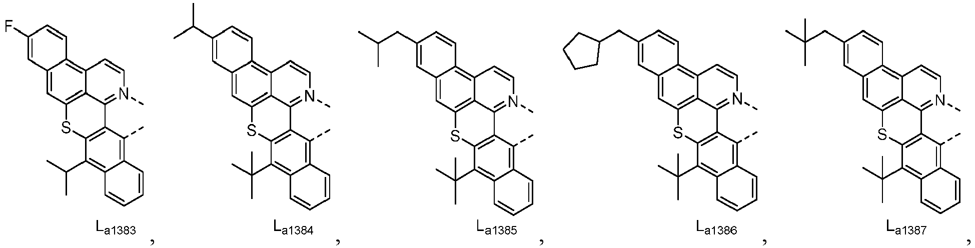 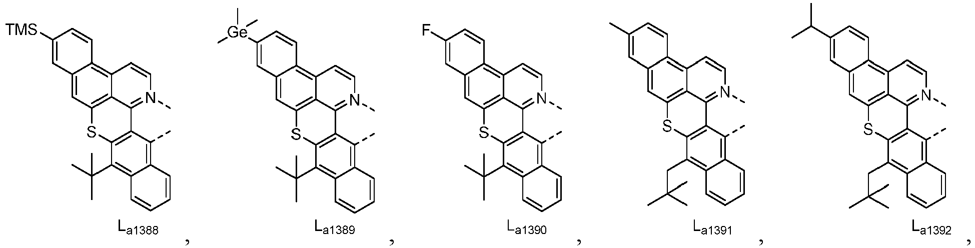 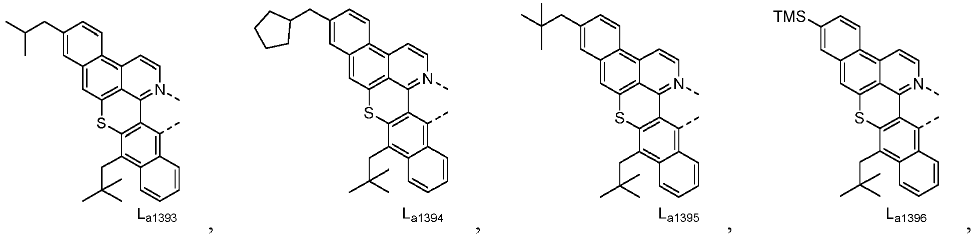 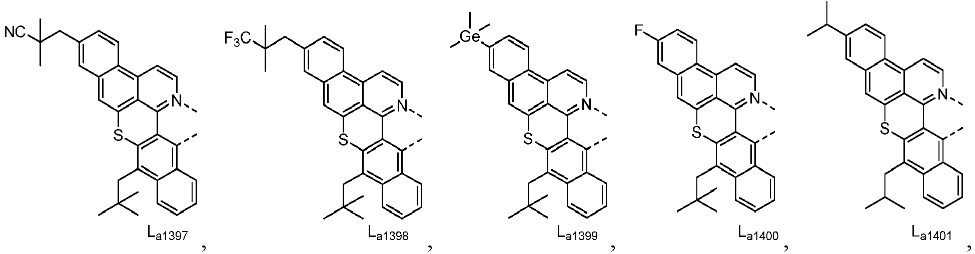 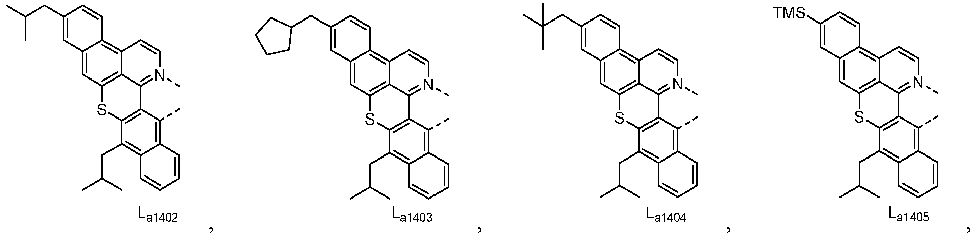 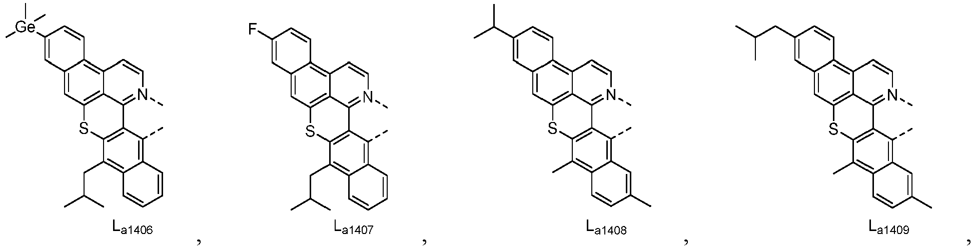 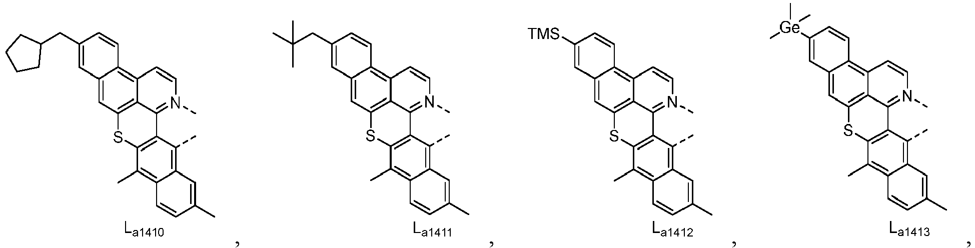 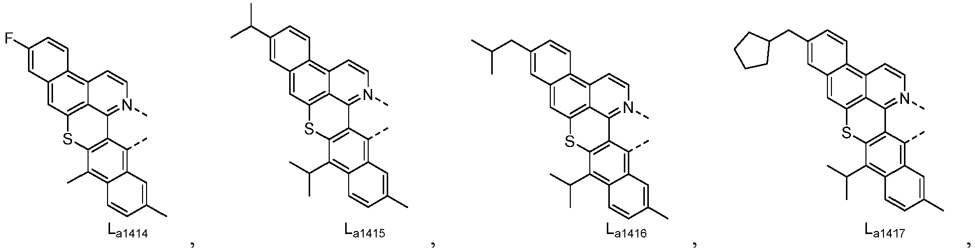 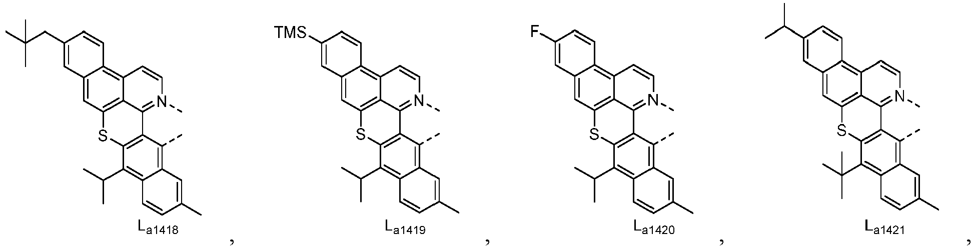 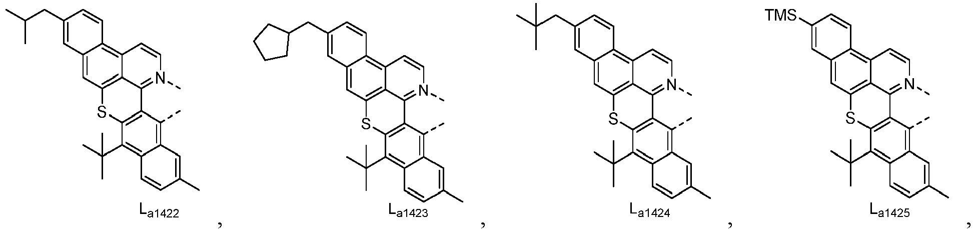 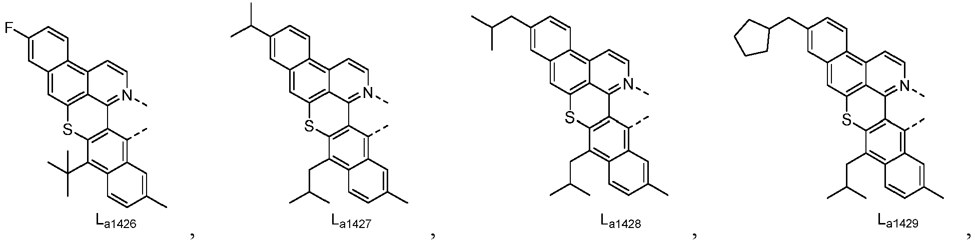 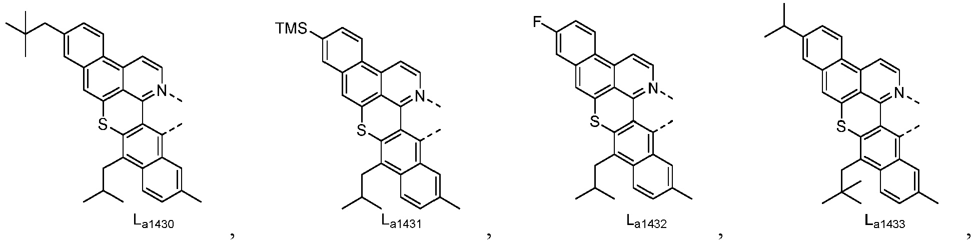 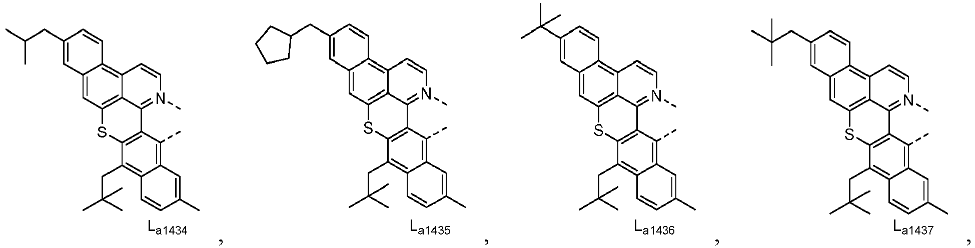 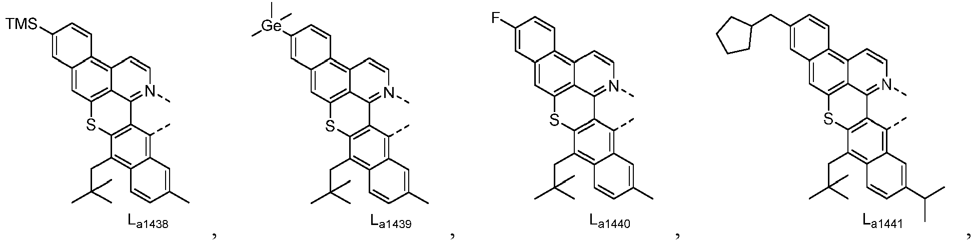 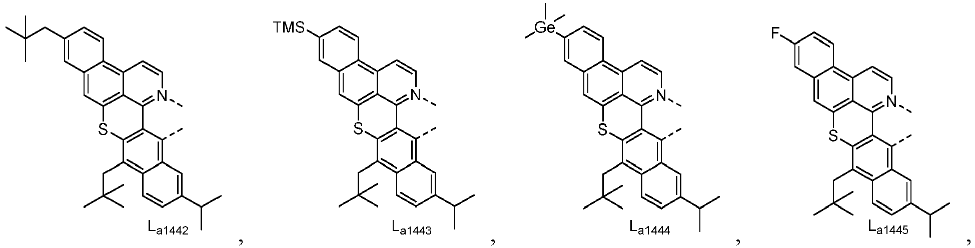 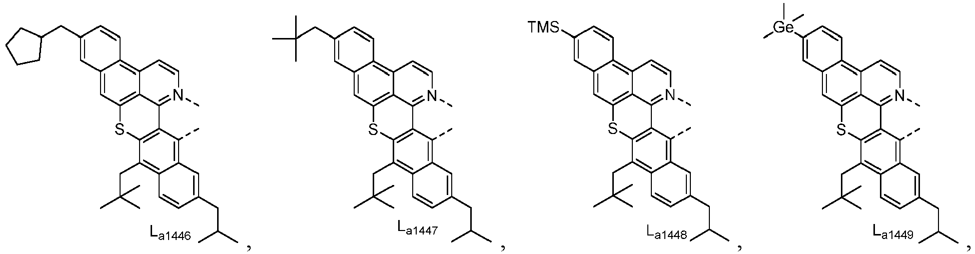 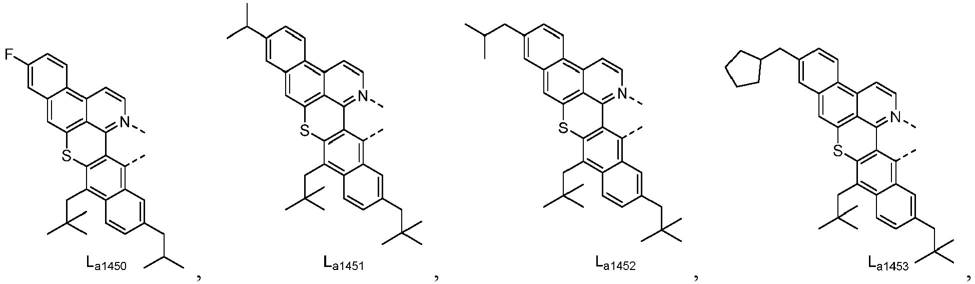 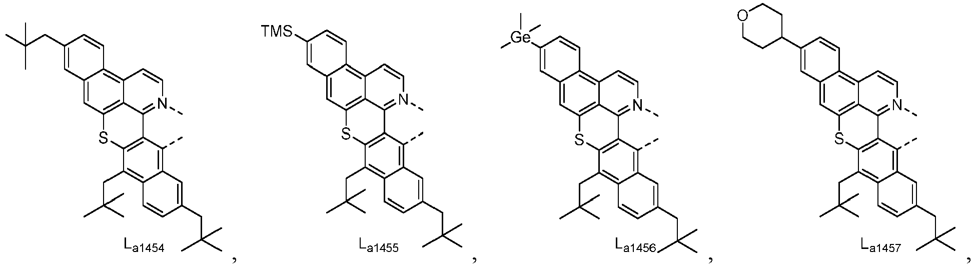 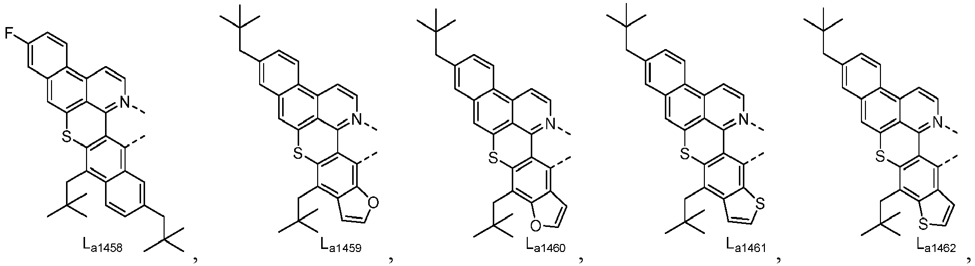 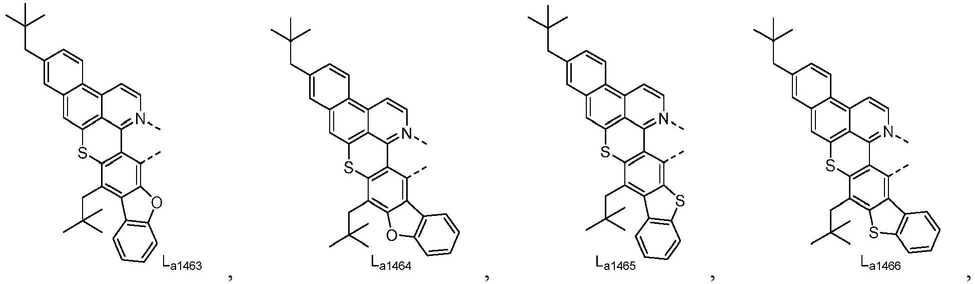 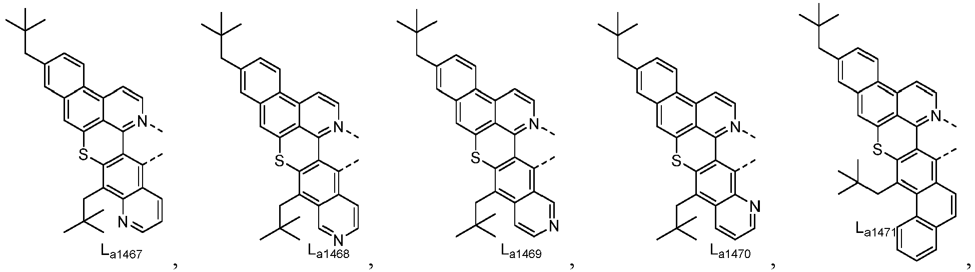 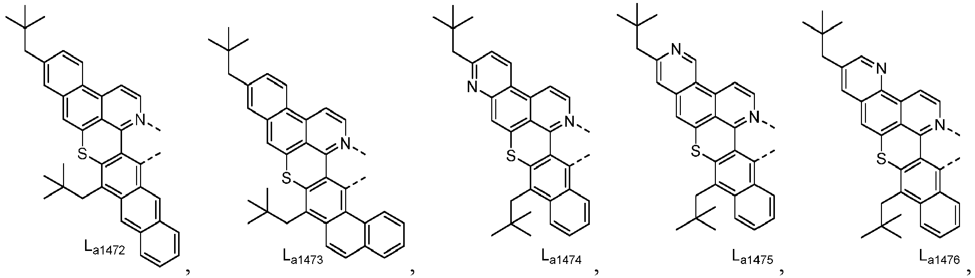 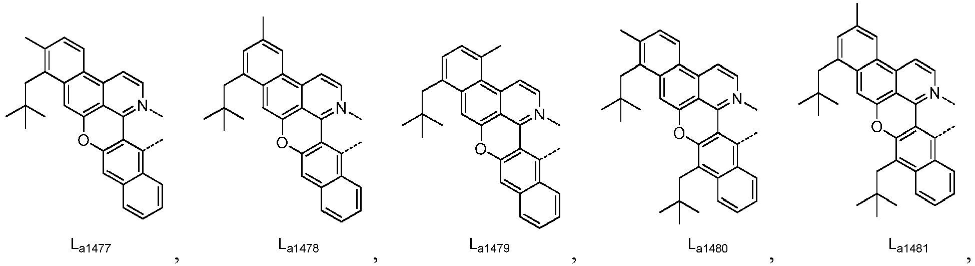 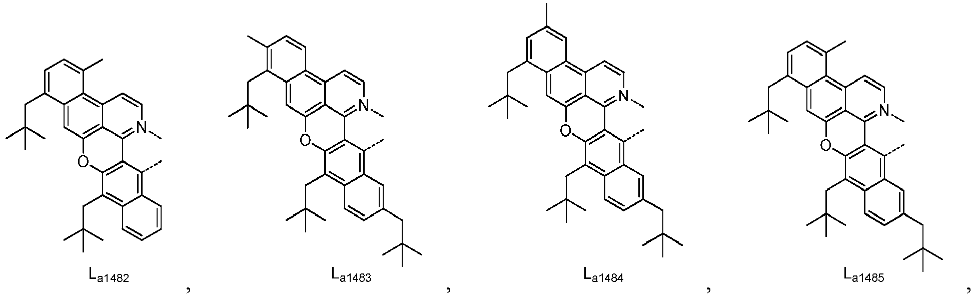 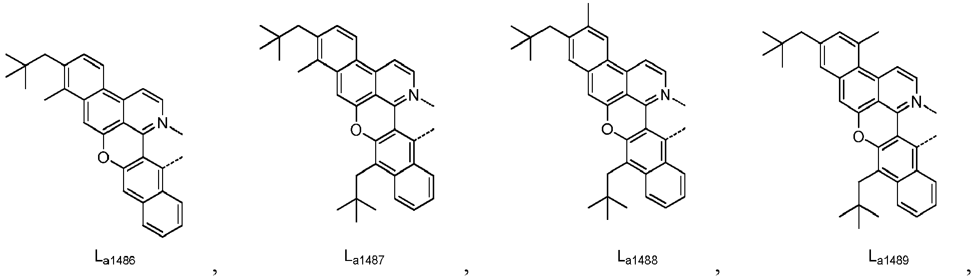 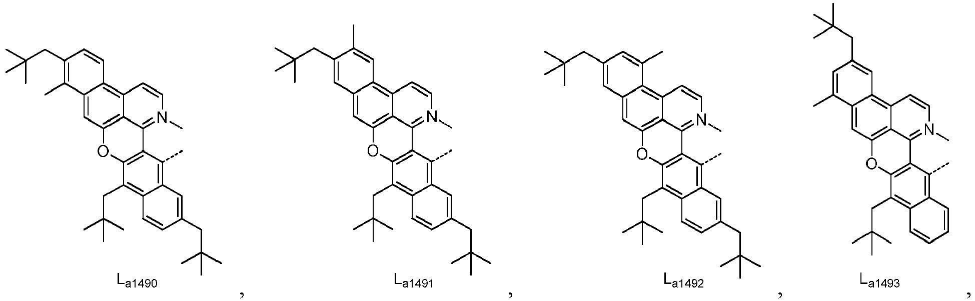 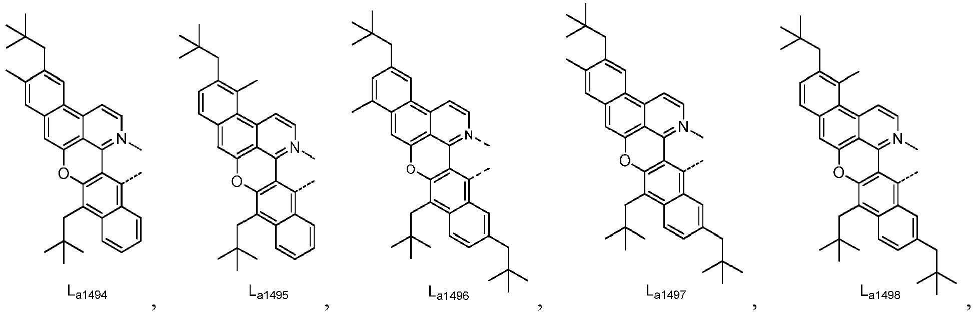 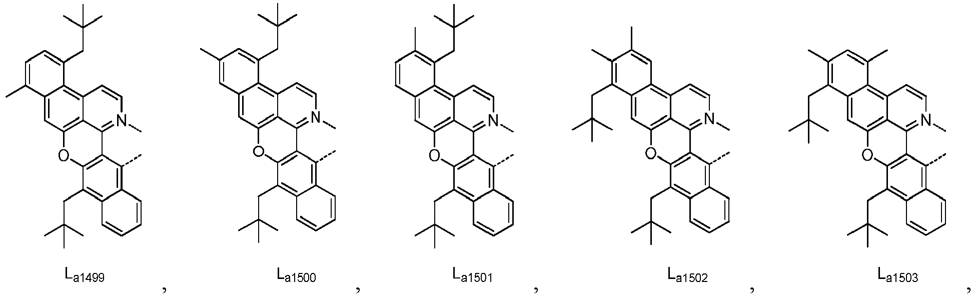 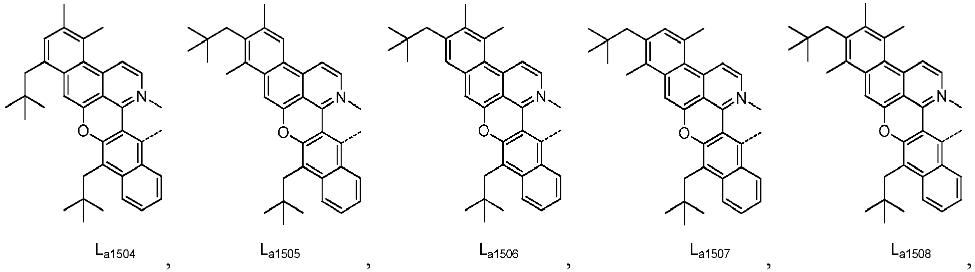 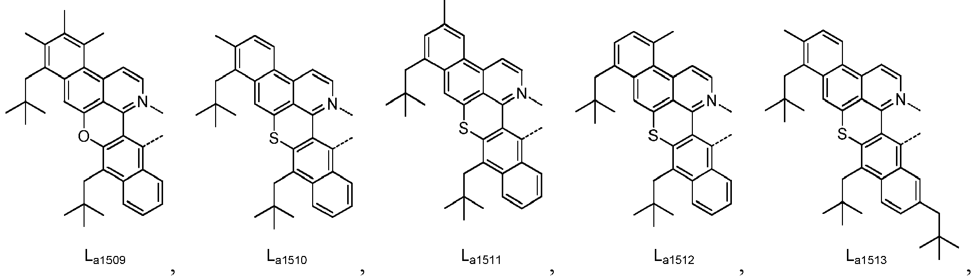 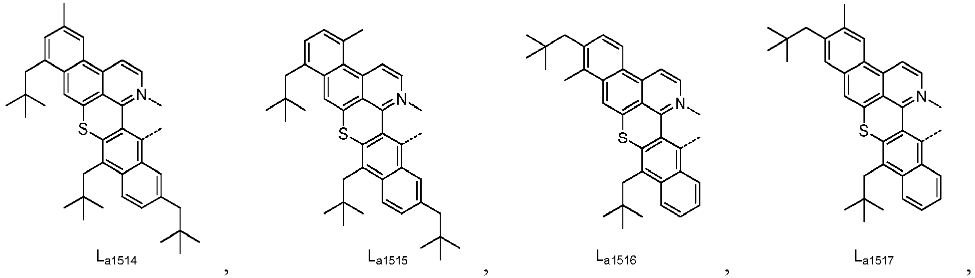 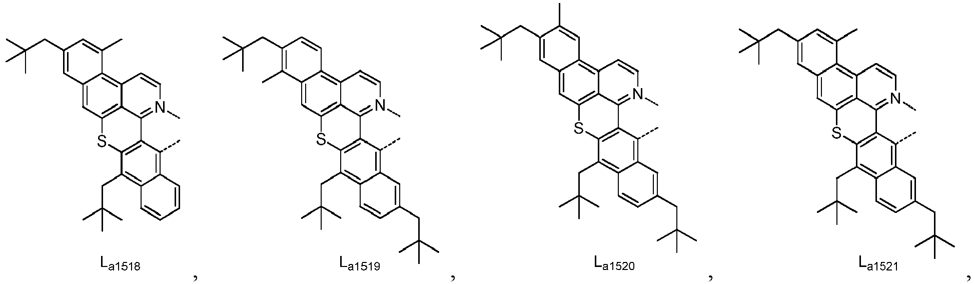 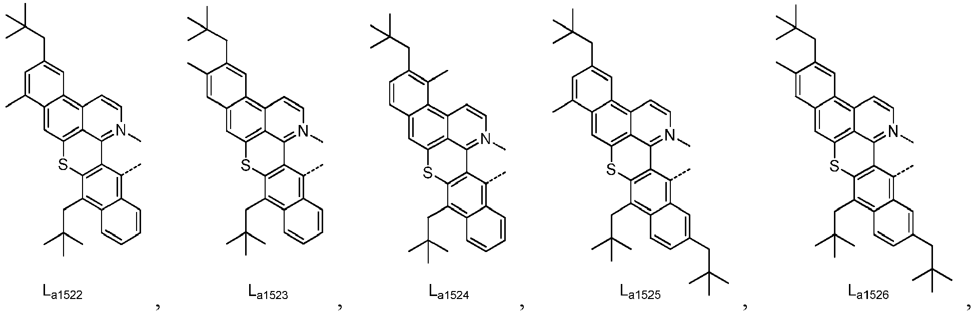 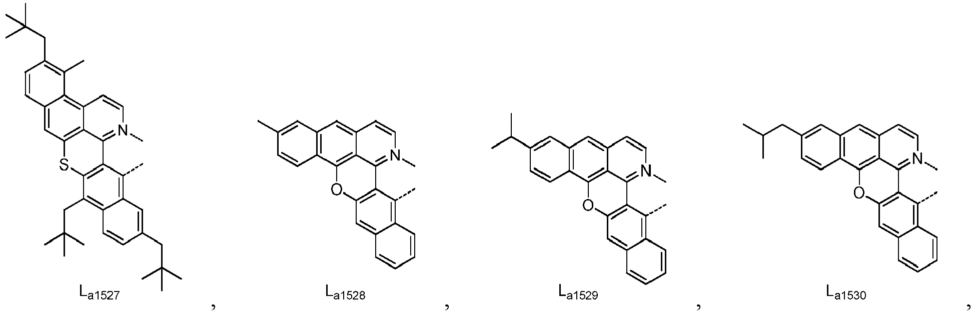 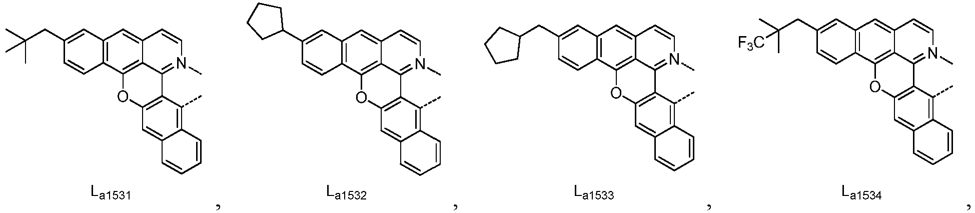 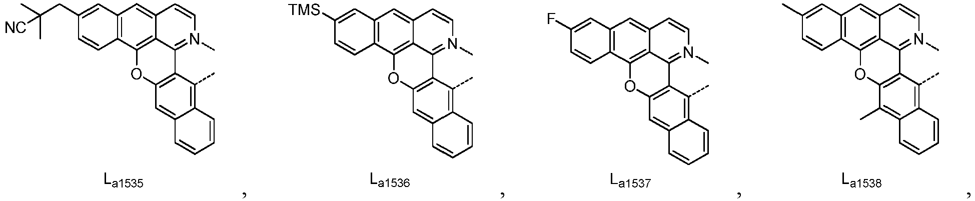 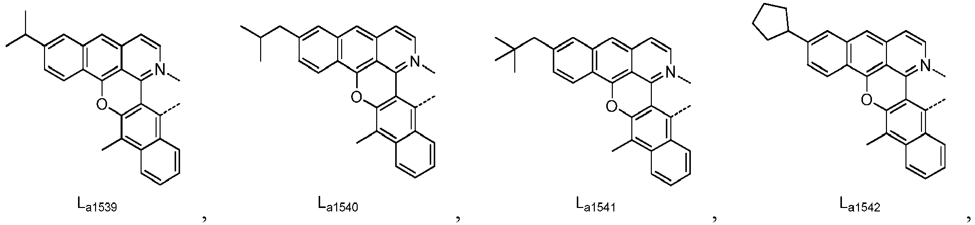 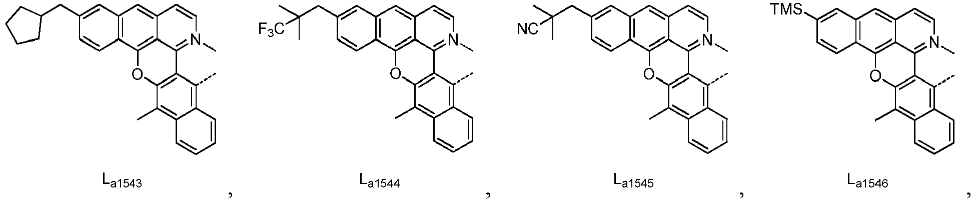 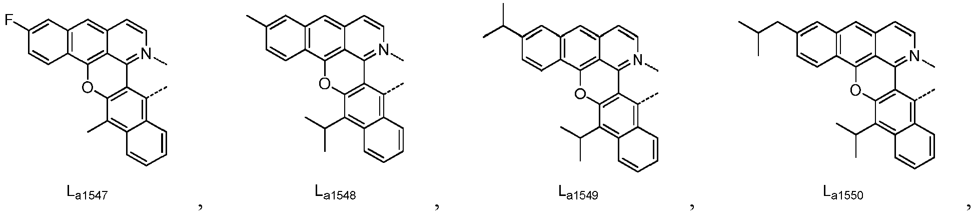 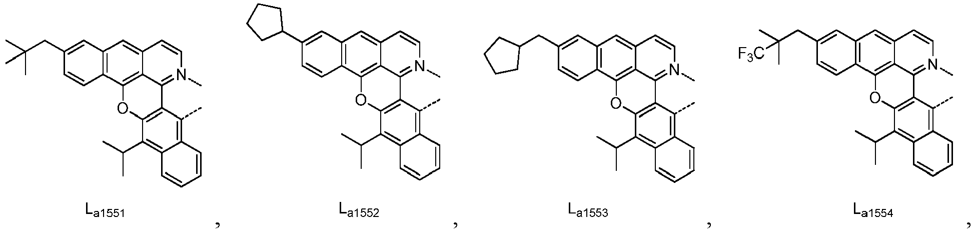 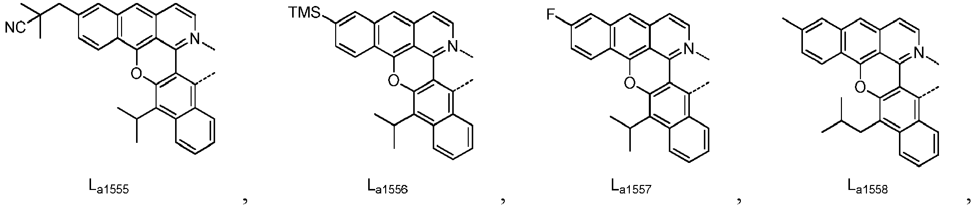 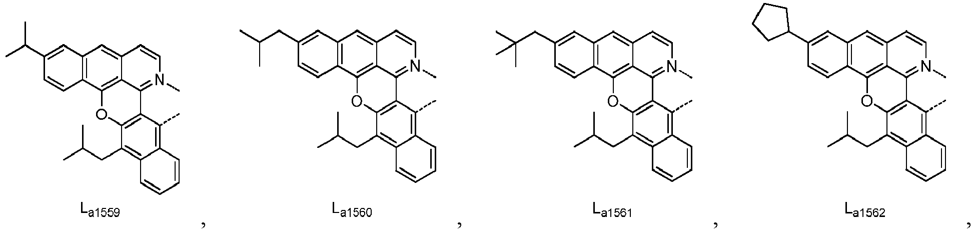 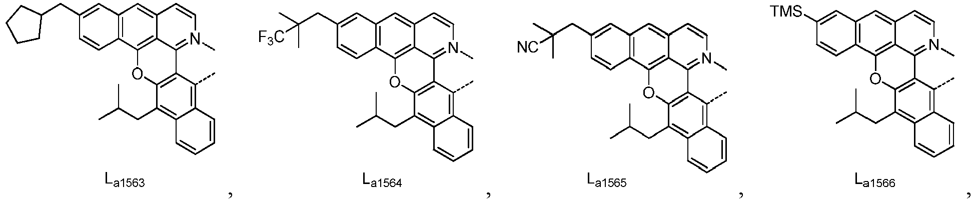 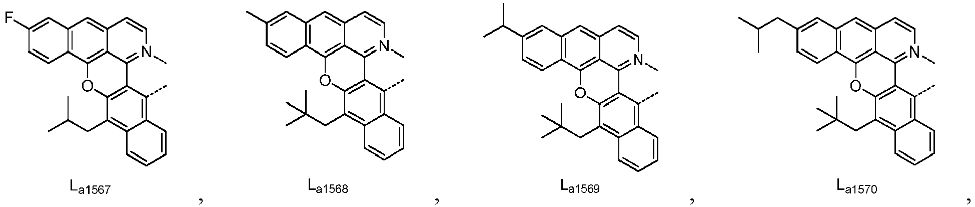 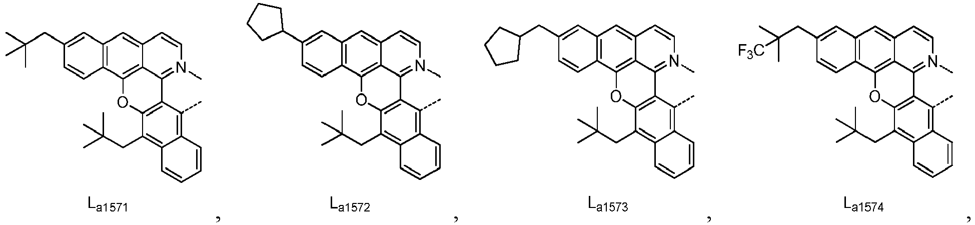 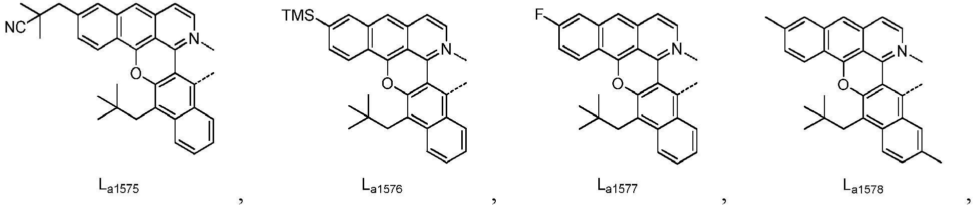 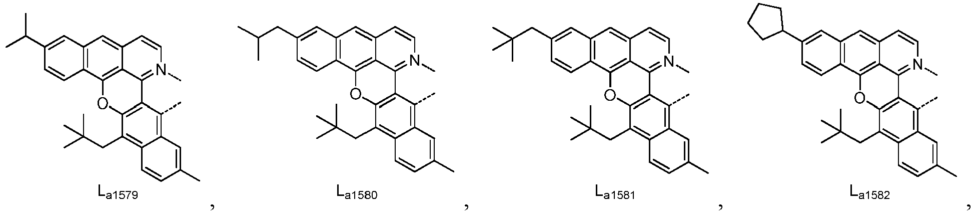 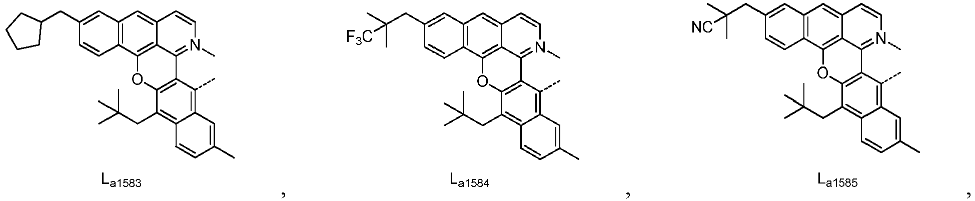 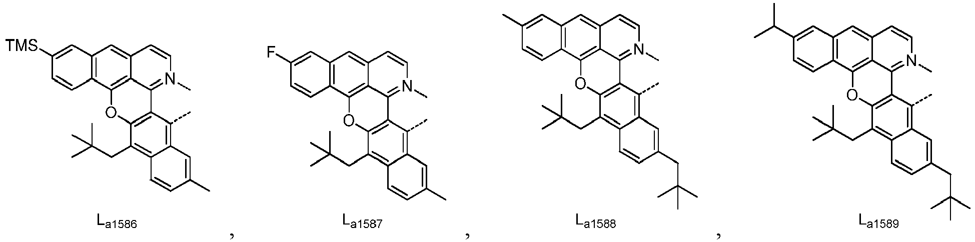 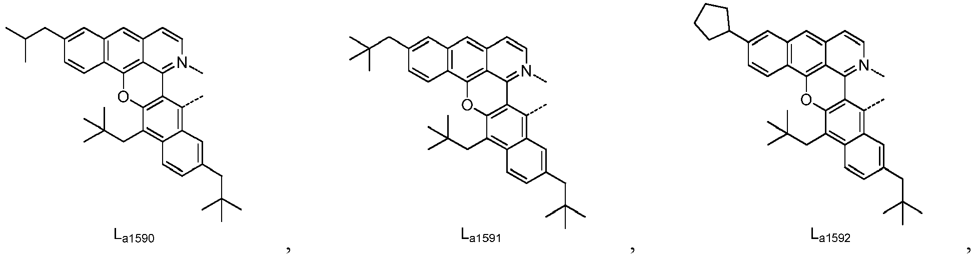 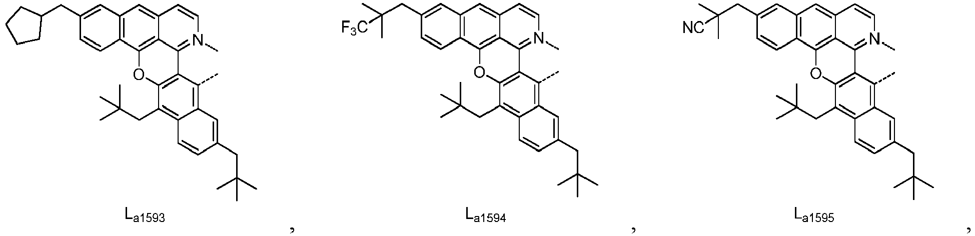 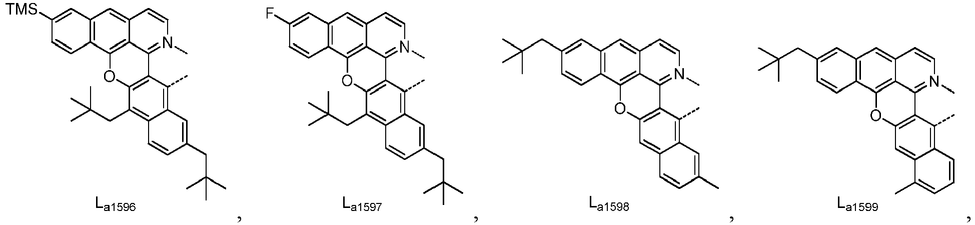 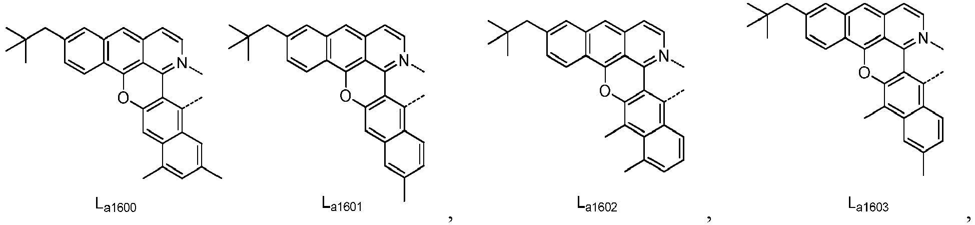 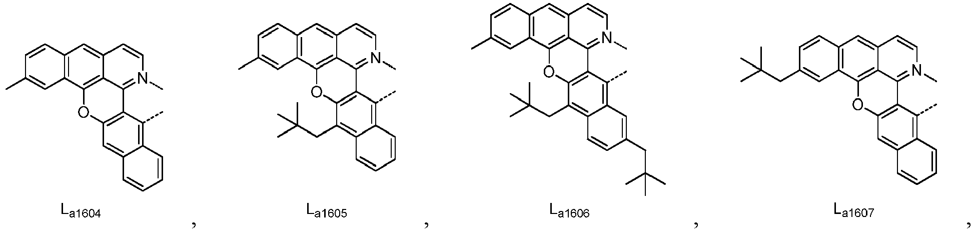 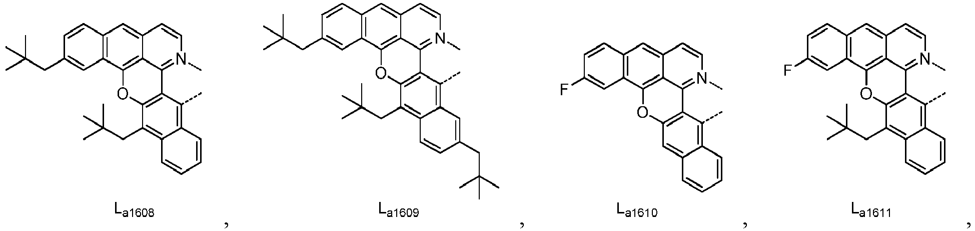 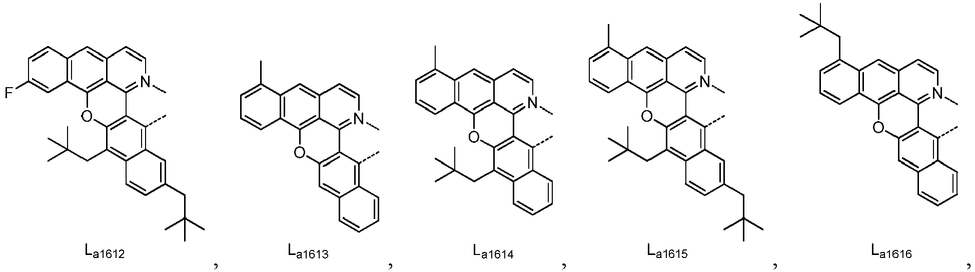 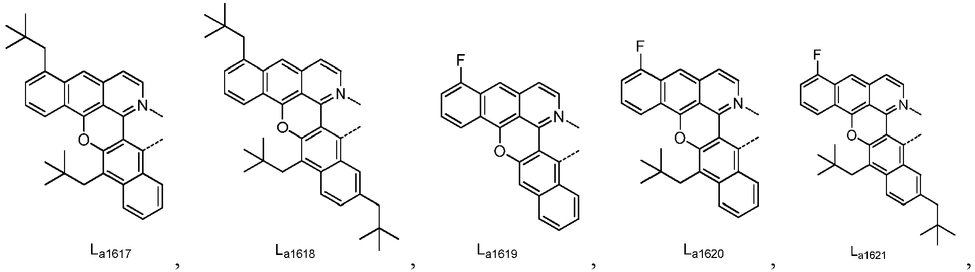 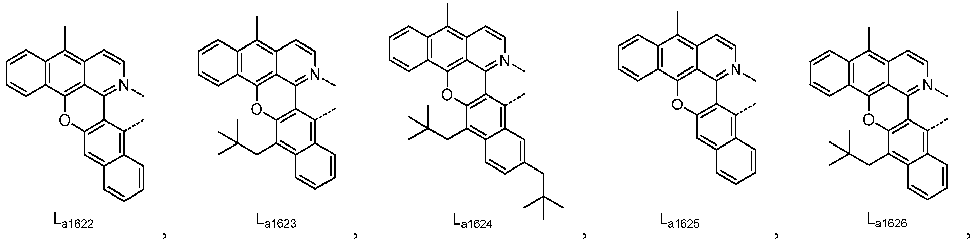 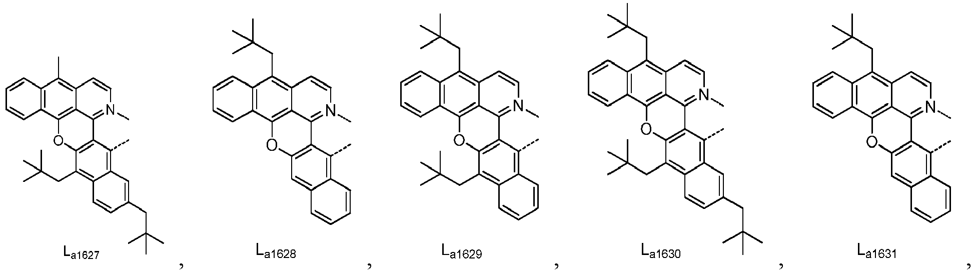 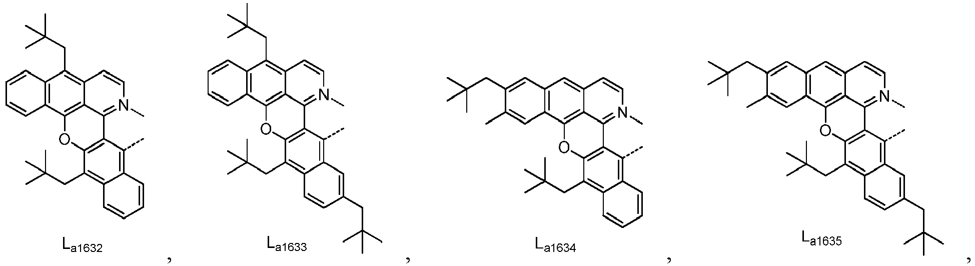 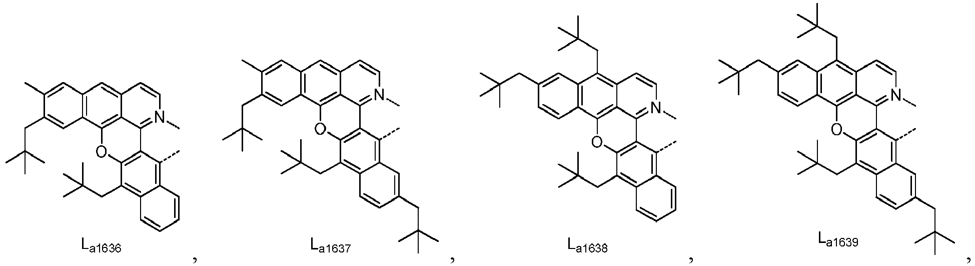 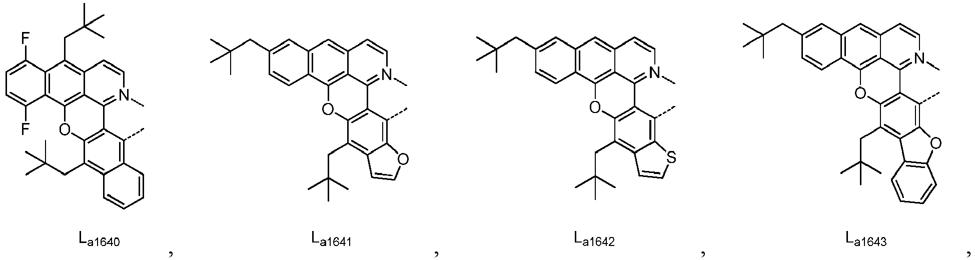 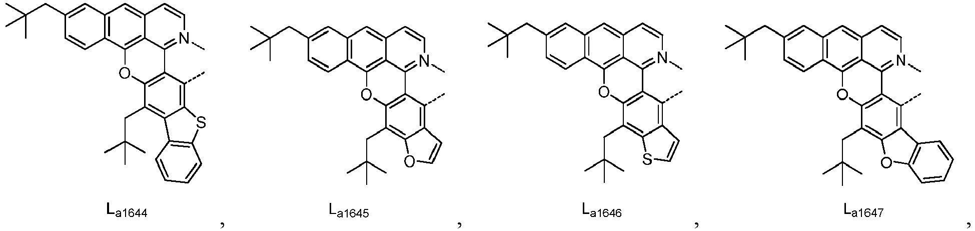 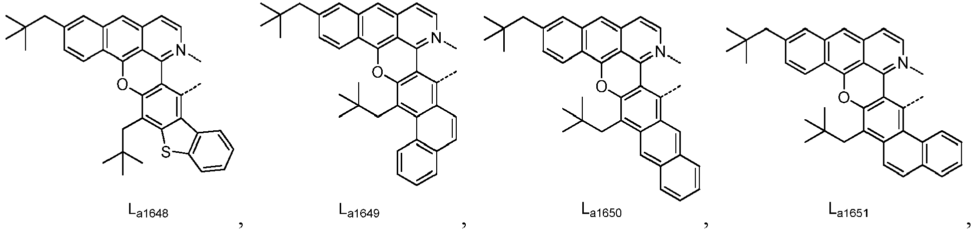 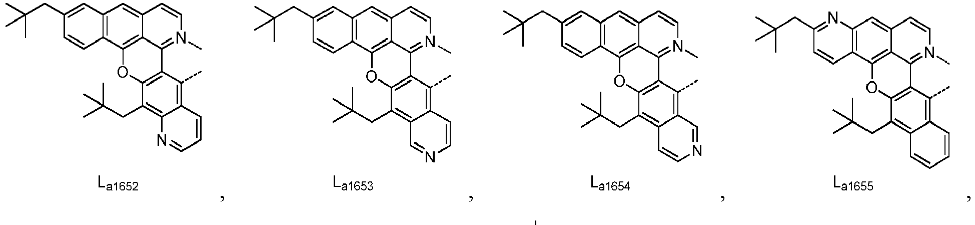 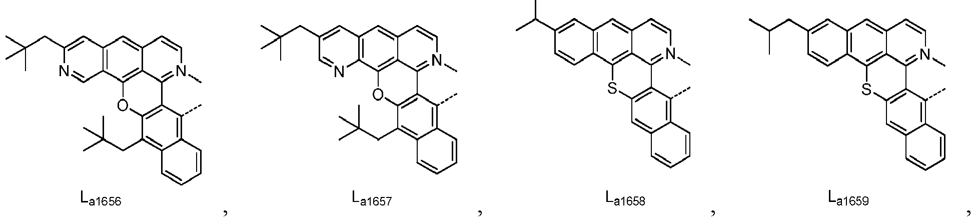 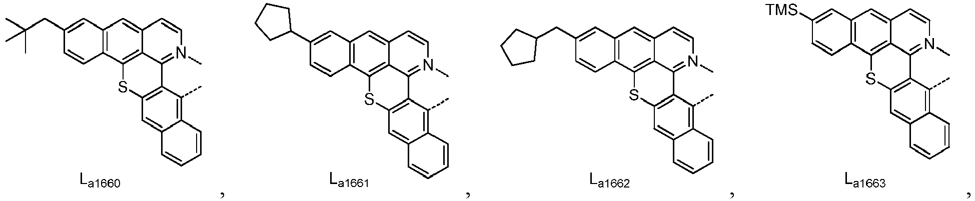 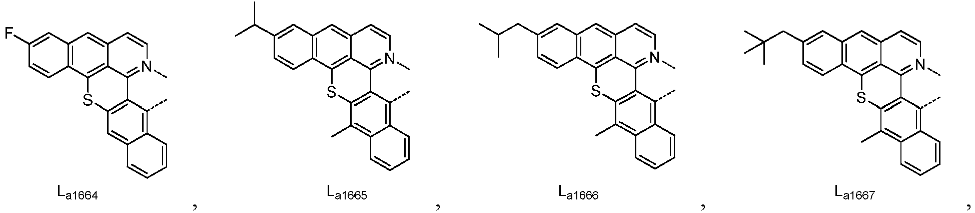 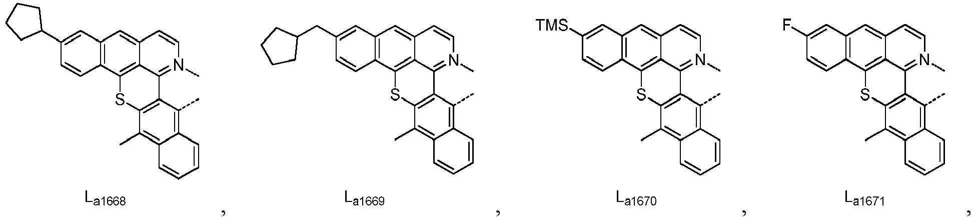 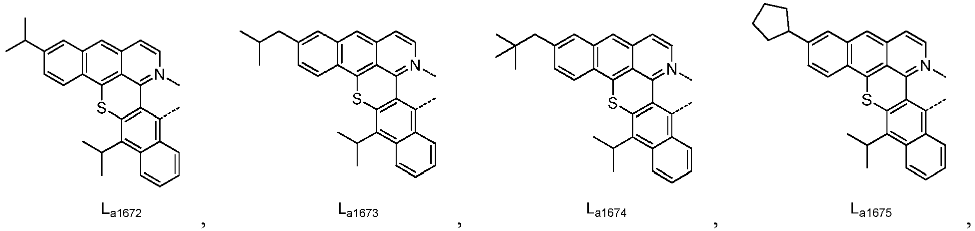 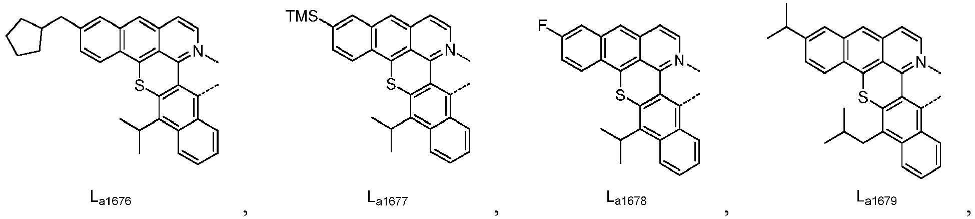 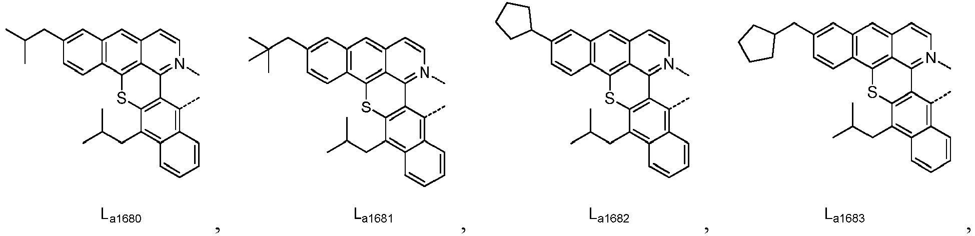 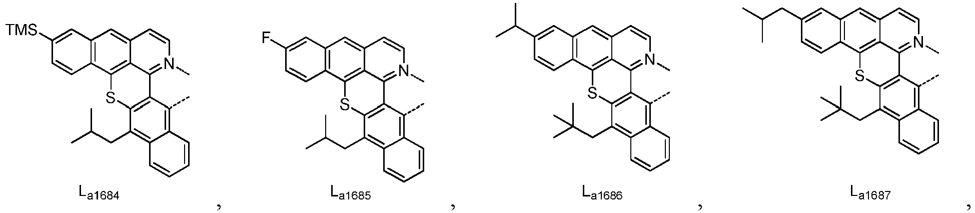 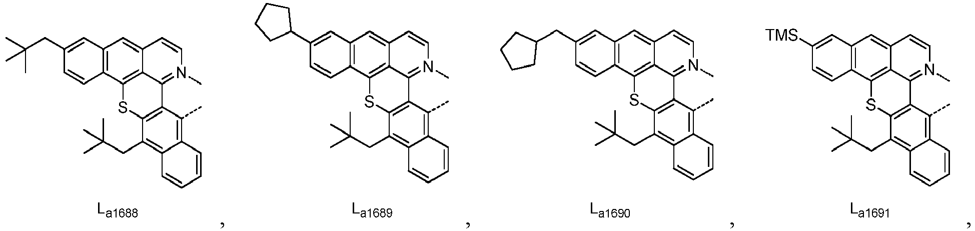 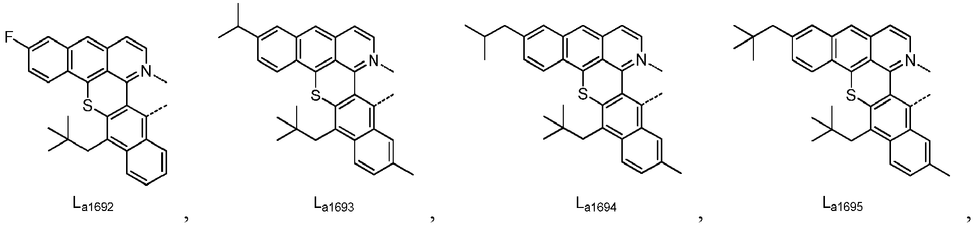 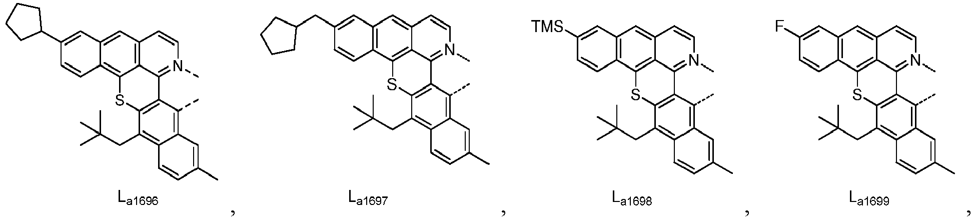 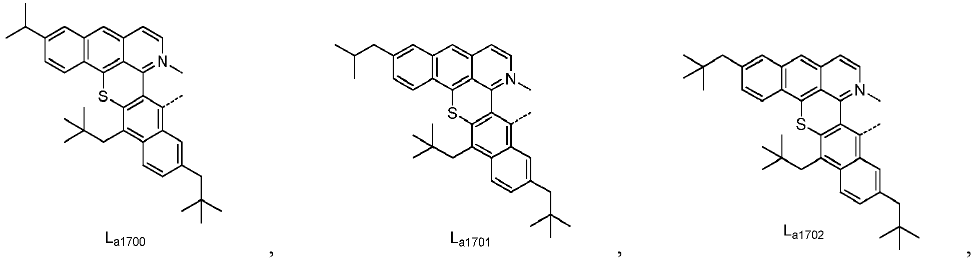 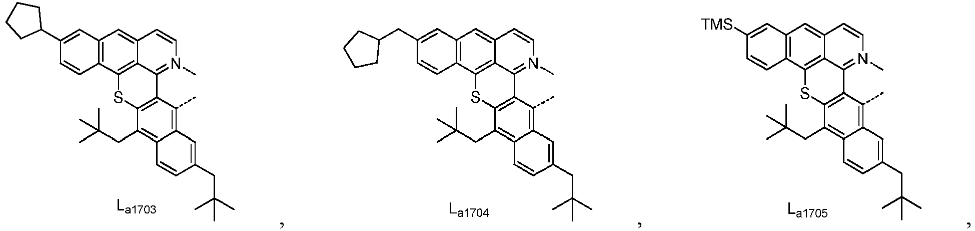 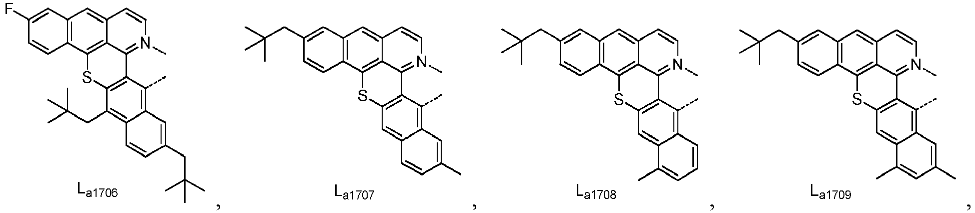 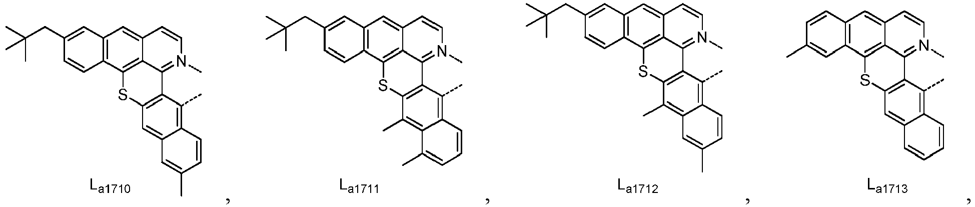 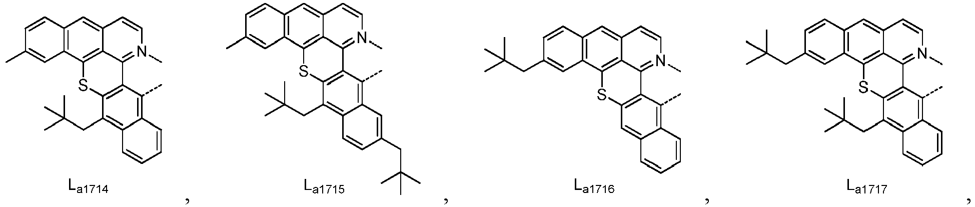 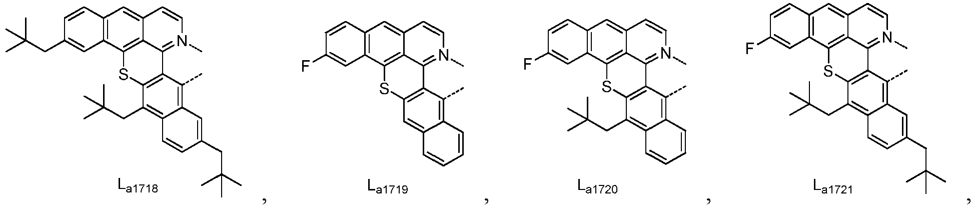 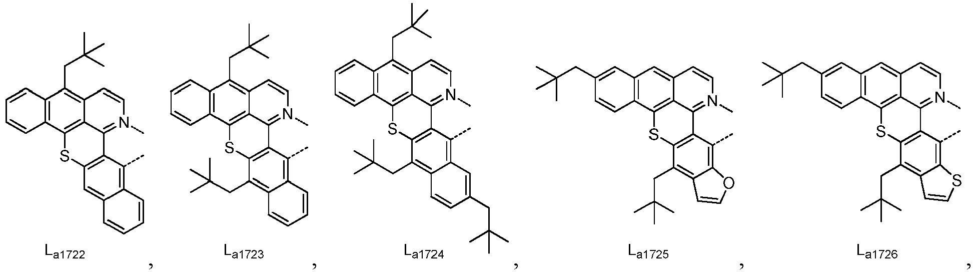 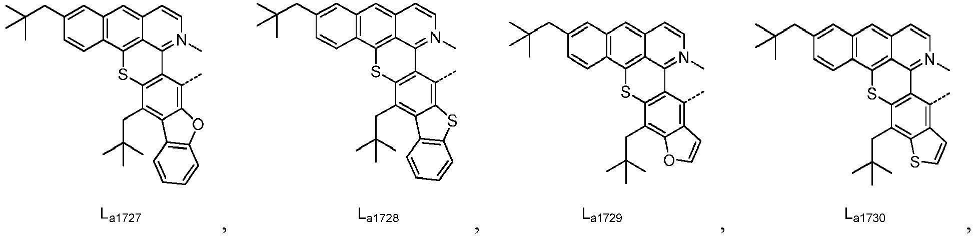 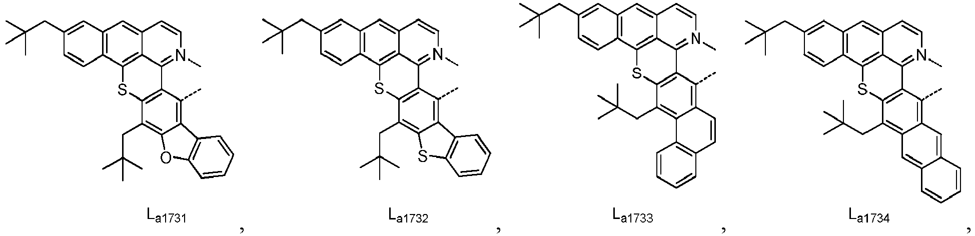 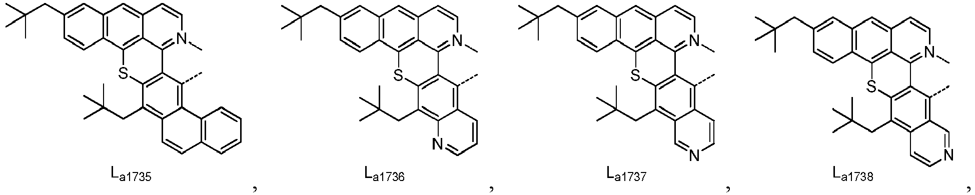 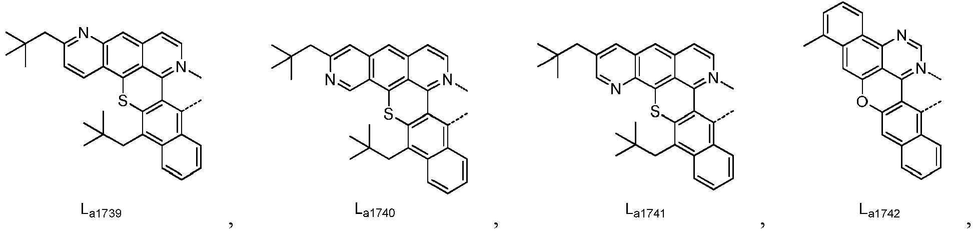 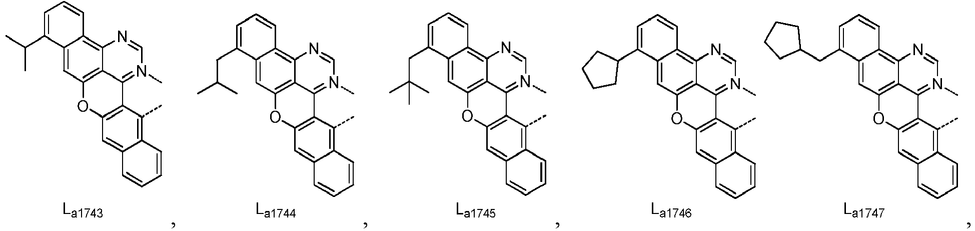 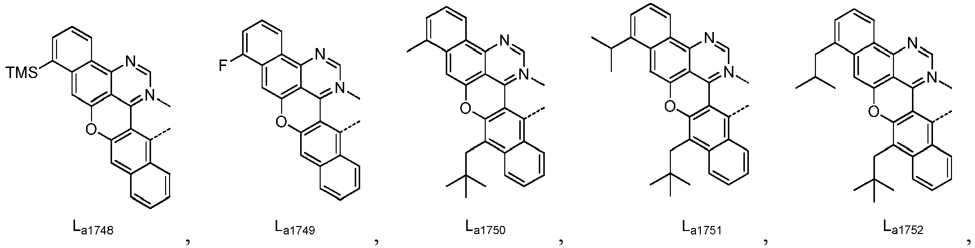 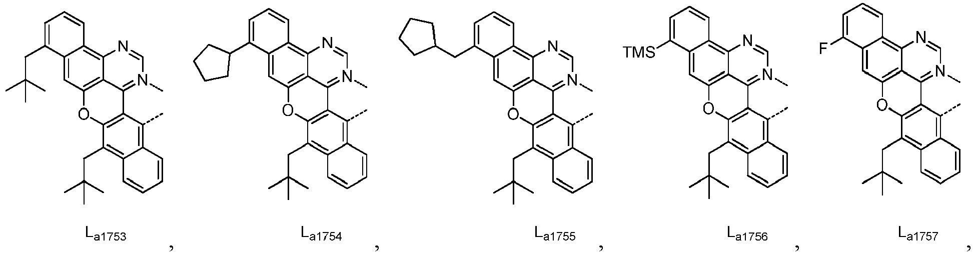 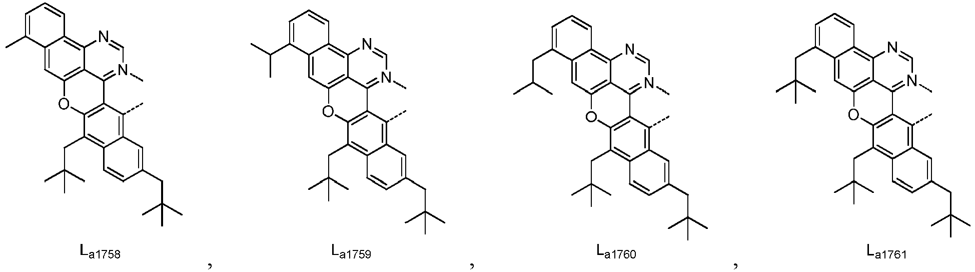 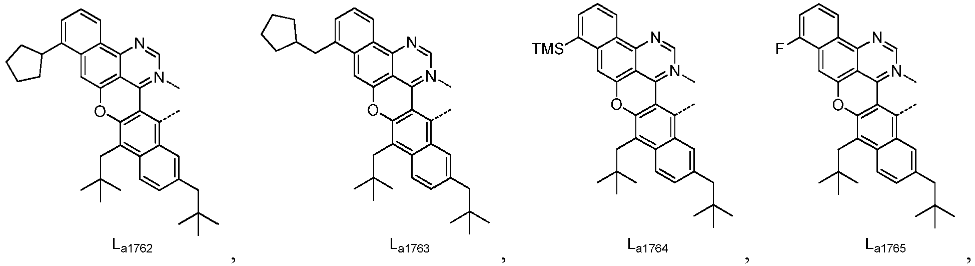 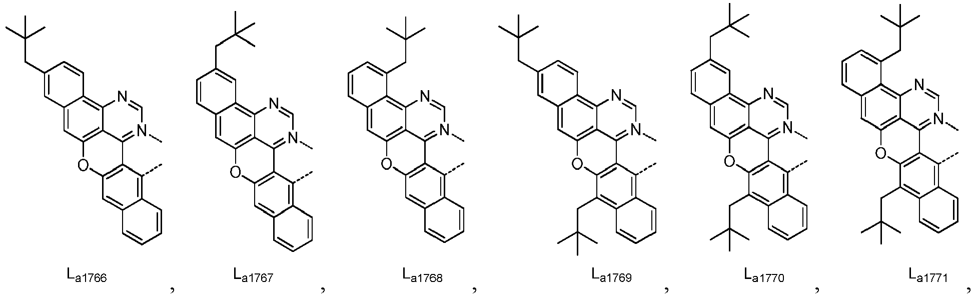 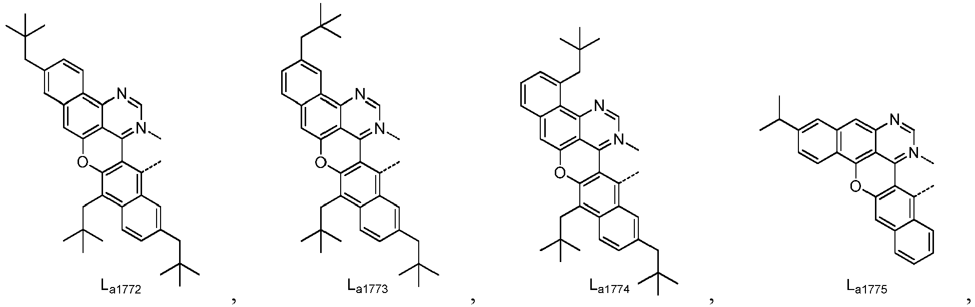 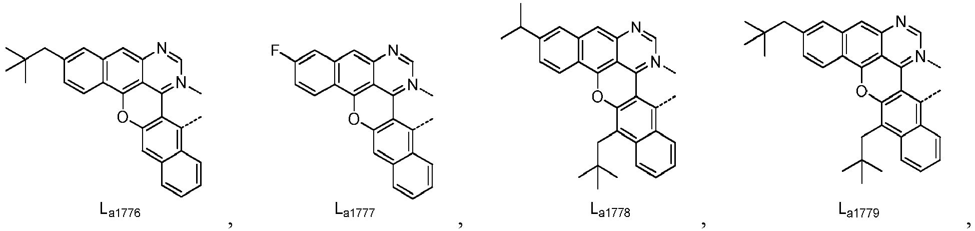 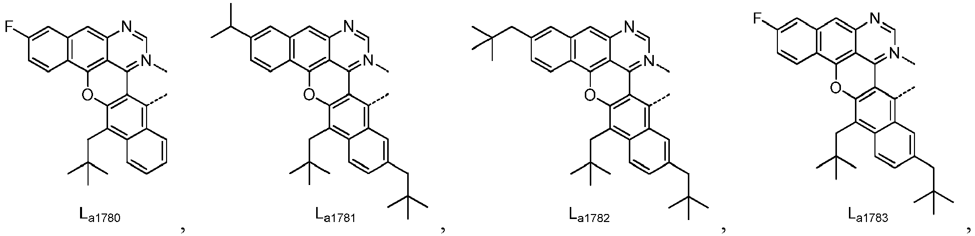 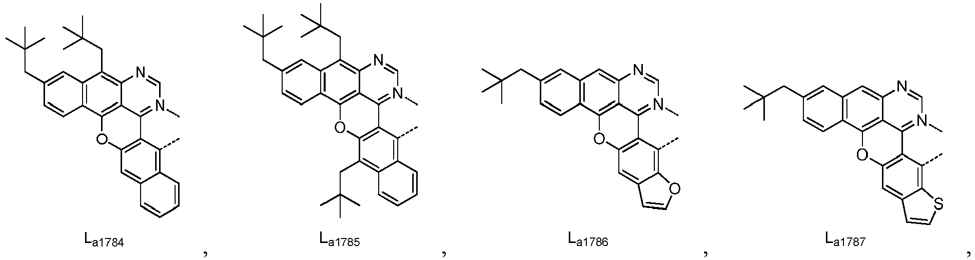 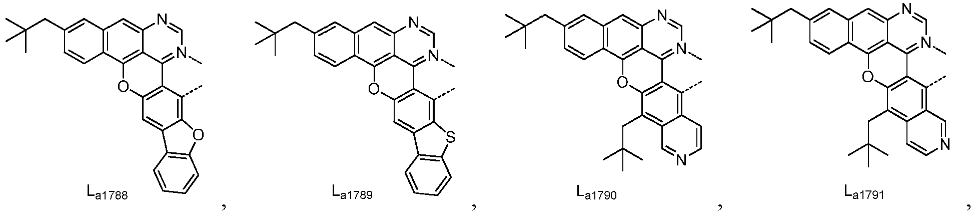 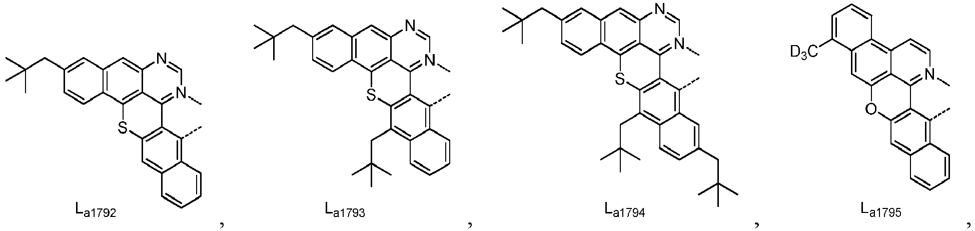 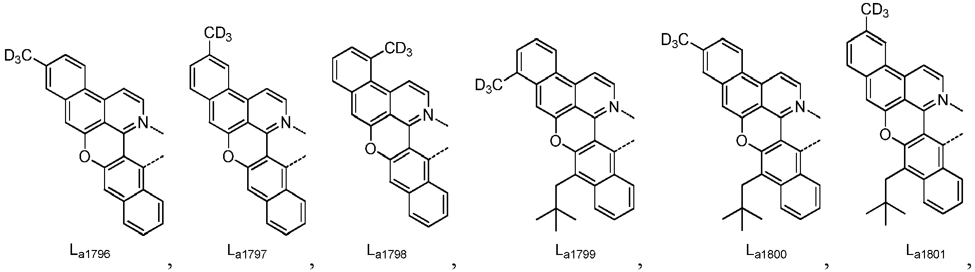 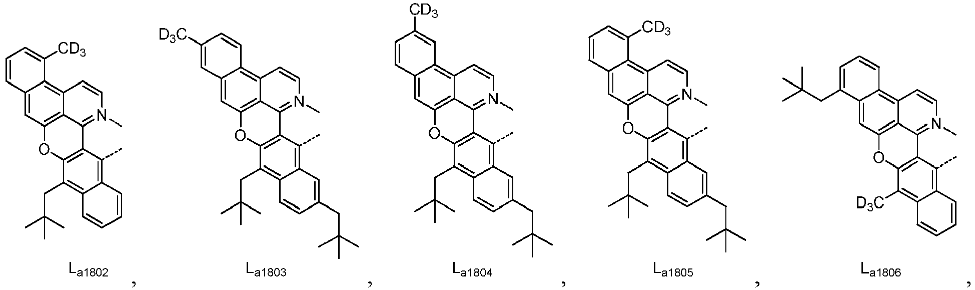 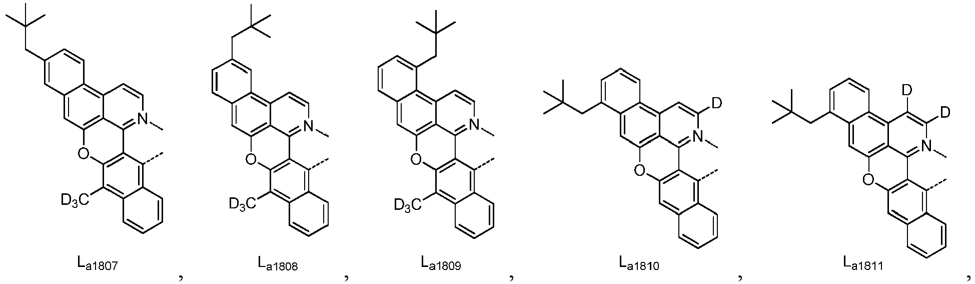 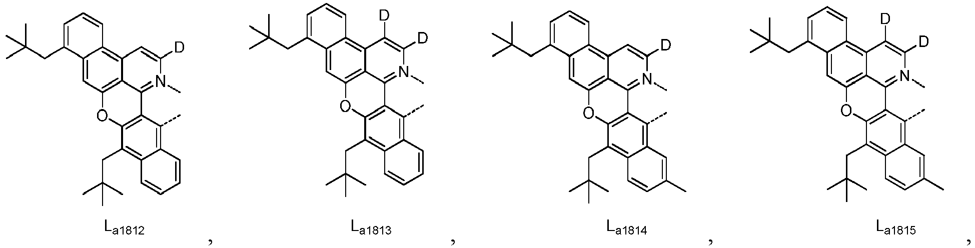 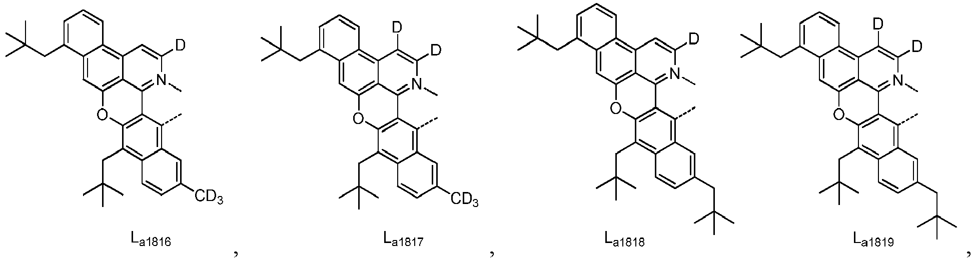 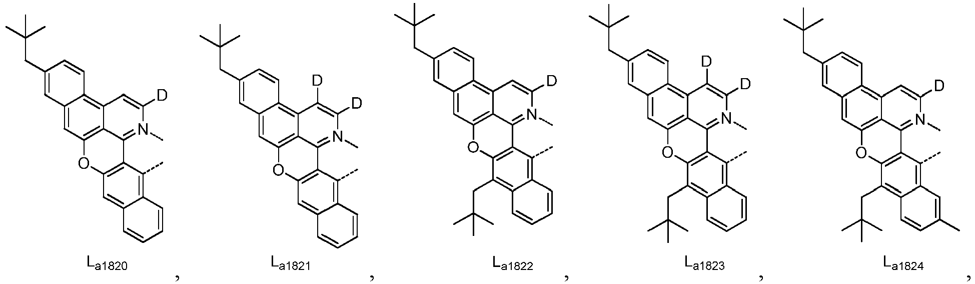 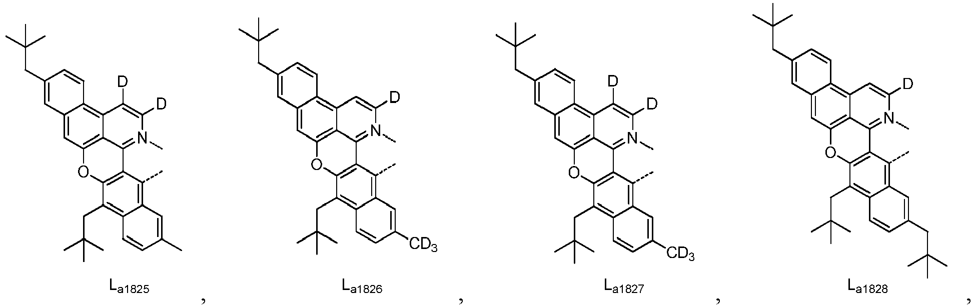 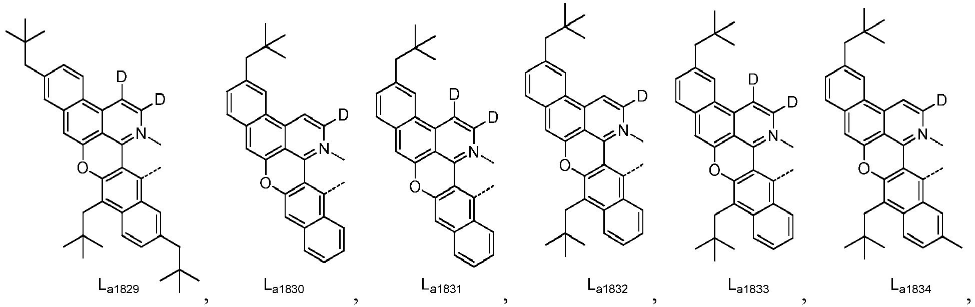 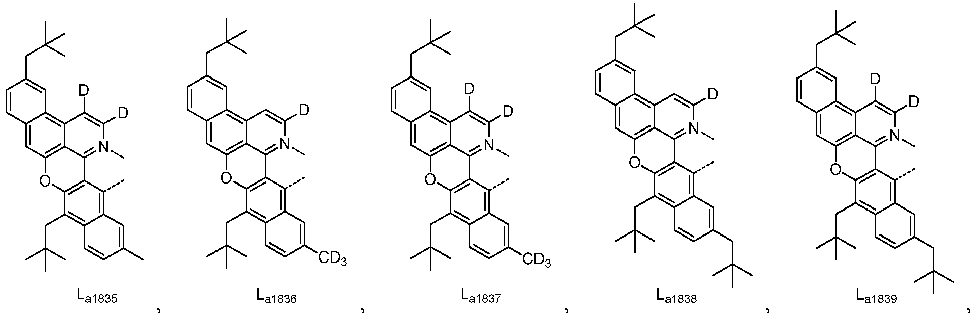 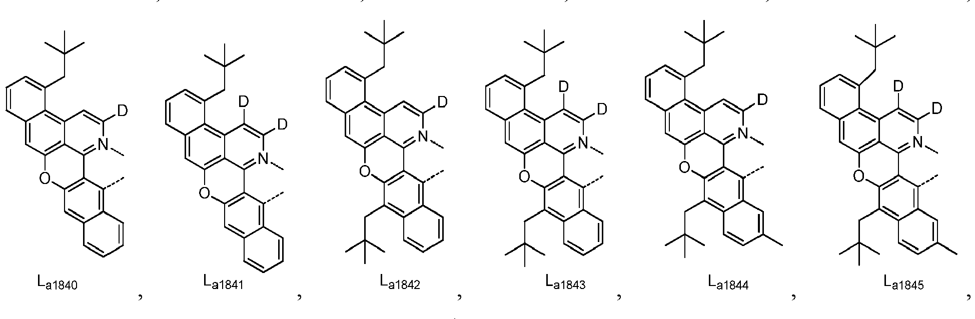 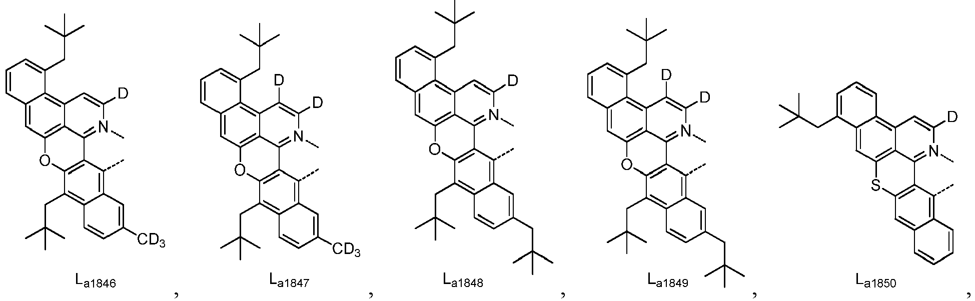 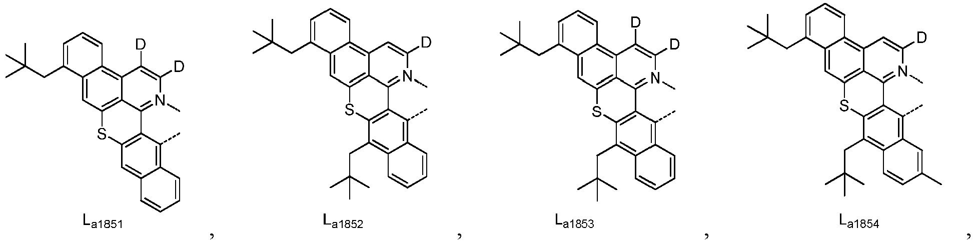 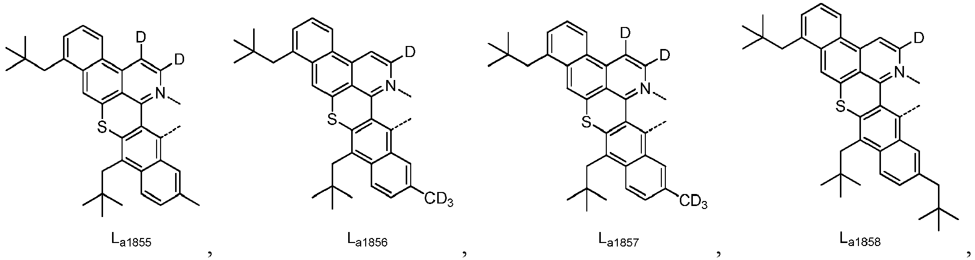 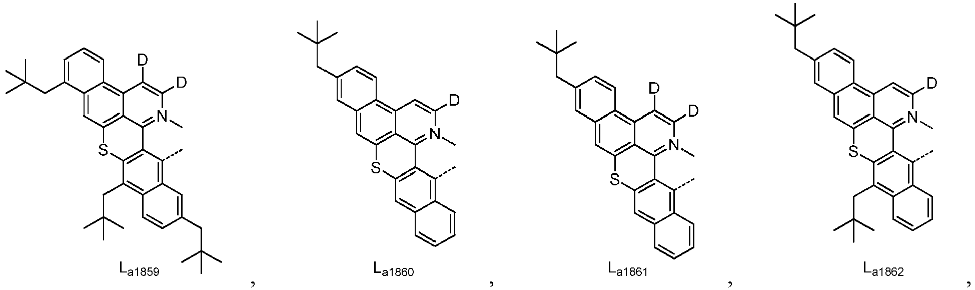 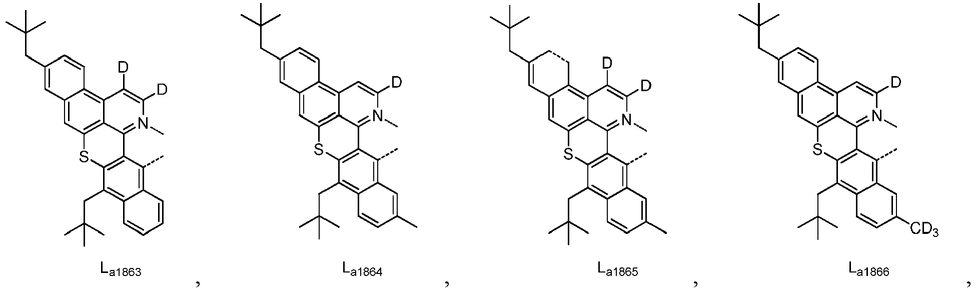 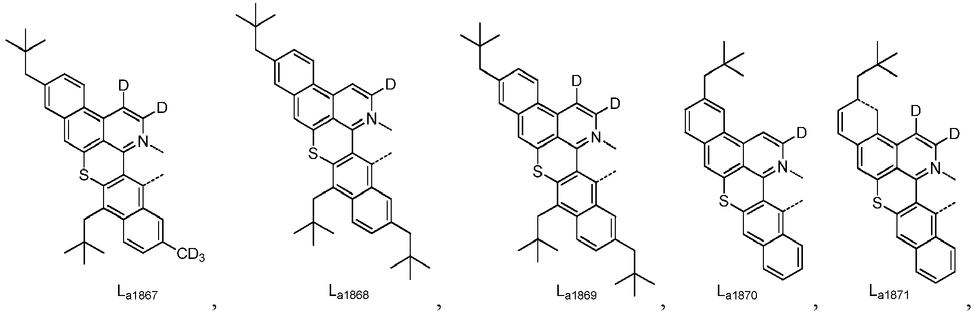 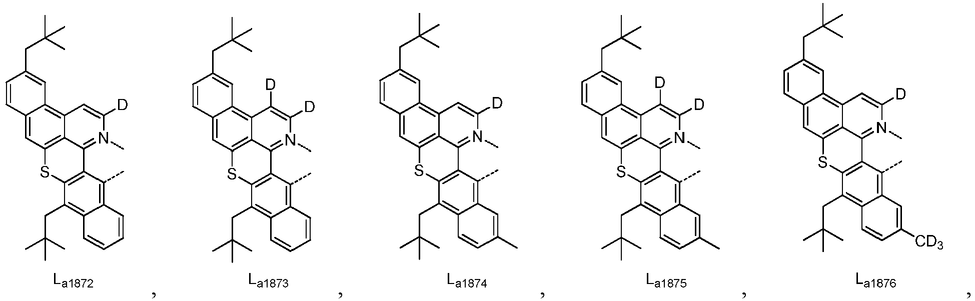 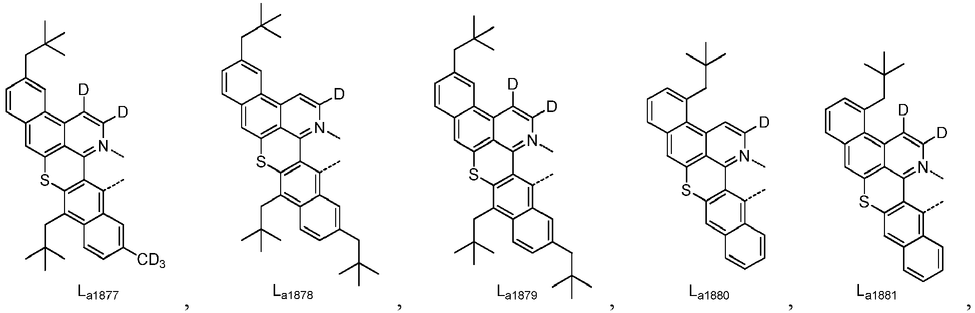 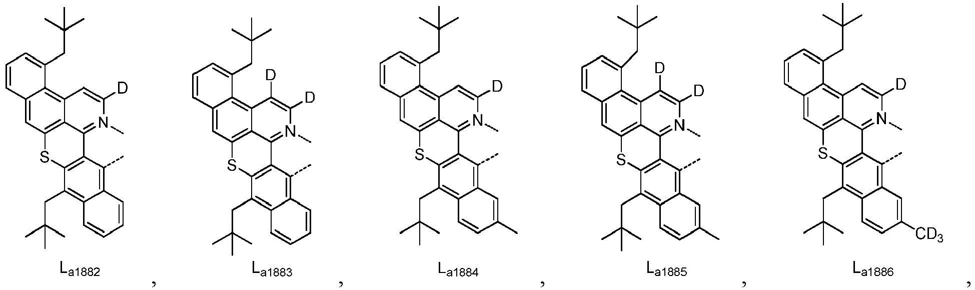 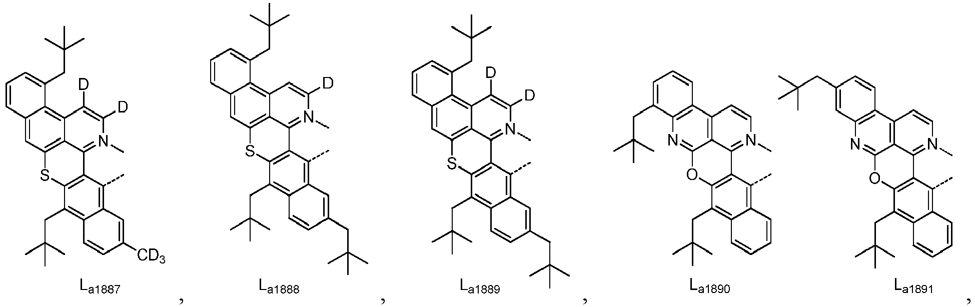 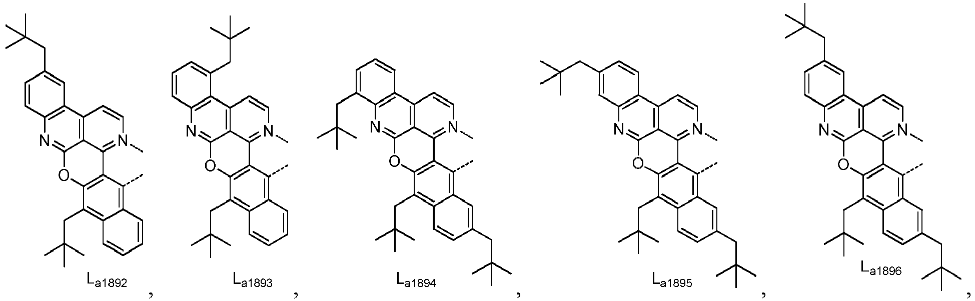 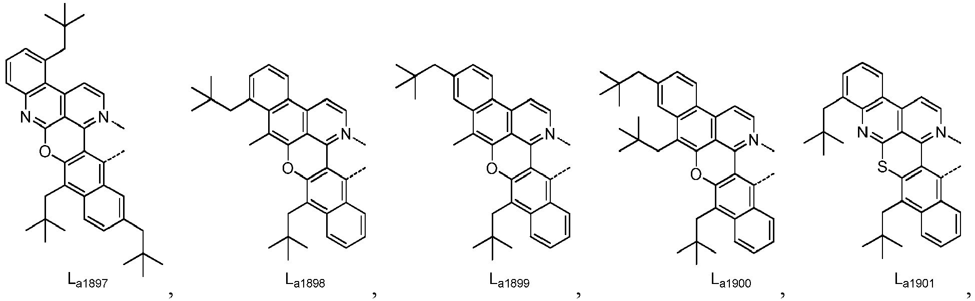 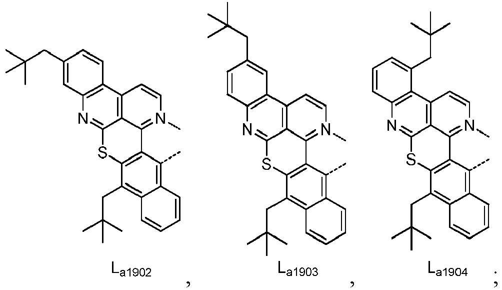
wobei in den obigen Strukturen TMS Trimethylsilyl ist; und
optional die Wasserstoffe in den Strukturen von Lₐ₁ bis Lₐ₁₉₀₄ teilweise oder vollständig durch Deuterium ersetzt sind.

11. Metallkomplex nach einem der Ansprüche 1 bis 10, wobei der Metallkomplex eine Struktur von M(Lₐ)ₘ(L_{b})ₙ(L_{c})_{q} hat;
wobei das Metall M aus einem Metall mit einer relativen Atommasse von mehr als 40 ausgewählt ist; bevorzugt ist das Metall M aus Ir, Rh, Re, Os, Pt, Au oder Cu ausgewählt; noch bevorzugter ist das Metall M aus Ir, Pt oder Os ausgewählt;
Lₐ, L_{b} und L_{c} sind ein erster Ligand, ein zweiter Ligand und ein dritter Ligand des Komplexes; m ist 1, 2 oder 3, n ist 0, 1 oder 2, q ist 0, 1 oder 2, und m+n+q ist gleich einer Oxidationsstufe des Metalls M; wenn m größer als 1 ist, sind eine Vielzahl von Lₐ identisch oder unterschiedlich; wenn n 2 ist, sind zwei L_{b} identisch oder unterschiedlich; wenn q 2 ist, sind zwei L_{c} identisch oder unterschiedlich;
Lₐ, L_{b} und L_{c} sind optional miteinander verbunden, um einen mehrzähnigen Liganden zu bilden;
L_{b} und L_{c} sind bei jedem Auftreten identisch oder unterschiedlich aus der Gruppe bestehend aus den folgenden Strukturen ausgewählt: 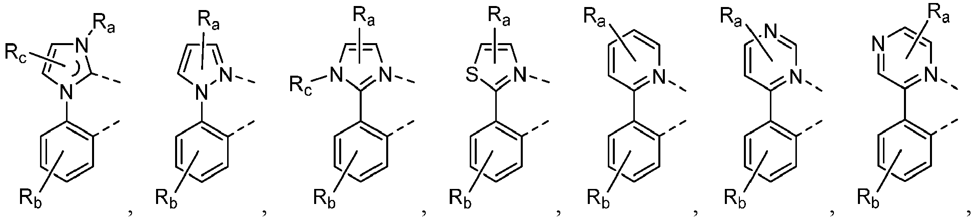 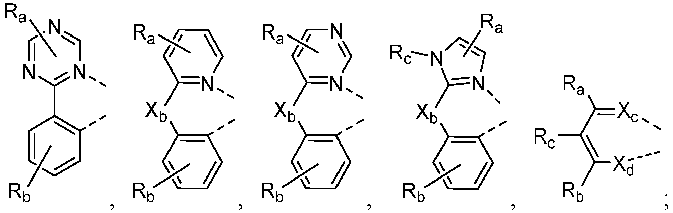
wobei Rₐ, R_{b} und R_{c} bei jedem Auftreten identisch oder unterschiedlich eine Monosubstitution, eine Mehrfachsubstitution oder eine Nichtsubstitution darstellen;
X_{b} bei jedem Auftreten identisch oder unterschiedlich ausgewählt aus der Gruppe bestehend aus: O, S, Se, NR_{N1} und CR_{C1}R_{C2};
X_{c} und X_{d} sind bei jedem Auftreten identisch oder unterschiedlich ausgewählt aus der Gruppe bestehend aus: O, S, Se und NR_{N2};
Rₐ, R_{b}, R_{c}, R_{N1}, R_{N2}, R_{C1} und R_{C2} sind bei jedem Auftreten identisch oder unterschiedlich ausgewählt aus der Gruppe bestehend aus: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon; und
benachbarte Substituenten Rₐ, R_{b}, R_{c}, R_{N1}, R_{N2}, R_{C1} und R_{C2} optional zu einem Ring verbunden sind.

12. Metallkomplex nach Anspruch 11, wobei der Metallkomplex die allgemeine Formel Ir(Lₐ)ₘ(L_{b})₃₋ₘ und eine durch Formel 1-1 oder Formel 1-2 dargestellte Struktur hat: 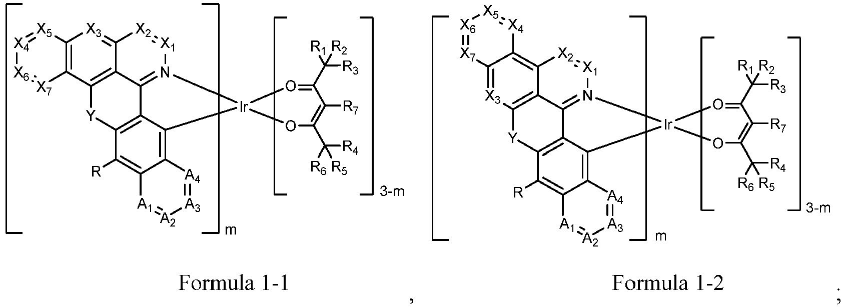 wobei
m 1 oder 2 ist;
X₁ und X₂ sind bei jedem Auftreten identisch oder unterschiedlich ausgewählt aus CRₓ oder N; X₃ ist bei jedem Auftreten identisch oder unterschiedlich ausgewählt aus CRᵢ oder N; A₁ bis A₄ sind bei jedem Auftreten identisch oder unterschiedlich ausgewählt aus CRᵢᵢ oder N; X₄ bis X₇ sind bei jedem Auftreten identisch oder unterschiedlich ausgewählt aus CH, CRᵢᵢᵢ oder N, und mindestens eines von X₄ bis X₇ ist ausgewählt aus CRᵢᵢᵢ;
Y ist ausgewählt aus SiR_{y}R_{y}, O, S oder Se; wenn zwei R_{y} gleichzeitig vorhanden sind, sind die beiden R_{y} identisch oder unterschiedlich;
R, Rₓ, R_{y}, Rᵢ, Rᵢᵢ, R₁, R₂, R₃, R₄, R₅, R₆ und R₇ sind bei jedem Auftreten identisch oder unterschiedlich ausgewählt aus der Gruppe bestehend aus: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon;
Rᵢᵢᵢ ist bei jedem Auftreten identisch oder unterschiedlich ausgewählt aus der Gruppe bestehend aus: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertes oder unsubstituiertes Arylalkyl mit 7 bis 30 Kohlenstoffatomen, substituiertes oder unsubstituiertes Alkoxy mit 1 bis 20 Kohlenstoffatomen, substituiertes oder unsubstituiertes Aryloxy mit 6 bis 30 Kohlenstoffatomen, substituiertes oder unsubstituiertes Alkenyl mit 2 bis 20 Kohlenstoffatomen, substituiertes oder unsubstituiertes Aryl mit 6 bis 30 Kohlenstoffatomen, substituiertes oder unsubstituiertes Heteroaryl mit 3 bis 30 Kohlenstoffatomen, substituiertes oder unsubstituiertes Alkylsilyl mit 3 bis 20 Kohlenstoffatomen, substituiertes oder unsubstituiertes Arylsilyl mit 6 bis 20 Kohlenstoffatomen, substituiertes oder unsubstituiertes Alkylgermanyl mit 3 bis 20 Kohlenstoffatomen, substituiertes oder unsubstituiertes Arylgermanyl mit 6 bis 20 Kohlenstoffatomen, substituiertes oder unsubstituiertes Amino mit 0 bis 20 Kohlenstoffatomen, eine Acylgruppe, eine Carbonylgruppe, eine Carbonsäuregruppe, eine Estergruppe, eine Cyanogruppe, eine Isocyanogruppe, eine Hydroxylgruppe, eine Sulfanylgruppe, eine Sulfinylgruppe, eine Sulfonylgruppe, eine Phosphinogruppe und Kombinationen davon; und
benachbarte Substituenten R, Rₓ, R_{y}, Rᵢ, Rᵢᵢ und Rᵢᵢᵢ optional zu einem Ring verbunden sind;
benachbarte Substituenten R₁, R₂, R₃, R₄, R₅, R₆ und R₇ optional zu einem Ring verbunden sind;
bevorzugt ist/sind mindestens eines oder zwei von R₁ bis R₃ bei jedem Auftreten identisch oder unterschiedlich ausgewählt aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen oder einer Kombination davon; und/oder mindestens eines oder zwei von R₄ bis R₆ ist/sind bei jedem Auftreten identisch oder unterschiedlich ausgewählt aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen oder einer Kombination davon; und
besonders bevorzugt sind mindestens zwei von R₁ bis R₃ bei jedem Auftreten identisch oder unterschiedlich ausgewählt aus substituiertem oder unsubstituiertem Alkyl mit 2 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 2 bis 20 Kohlenstoffatomen oder einer Kombination davon; und/oder mindestens zwei von R₄ bis R₆ bei jedem Auftreten identisch oder unterschiedlich ausgewählt sind aus substituiertem oder unsubstituiertem Alkyl mit 2 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 2 bis 20 Kohlenstoffatomen oder einer Kombination davon.

13. Metallkomplex nach einem der Ansprüche 10 bis 11, wobei L_{b} bei jedem Auftreten identisch oder unterschiedlich aus der Gruppe bestehend aus den folgenden Strukturen ausgewählt ist: 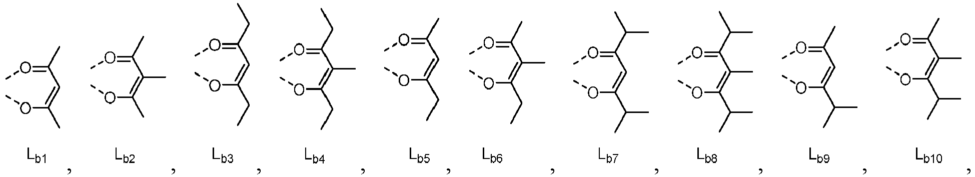 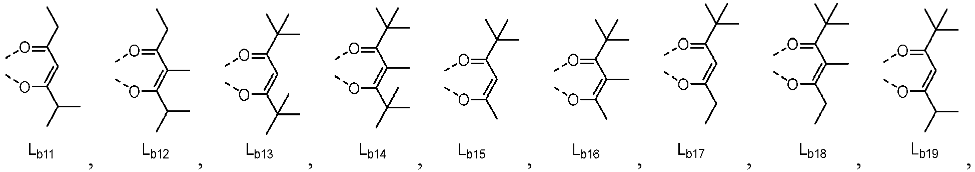 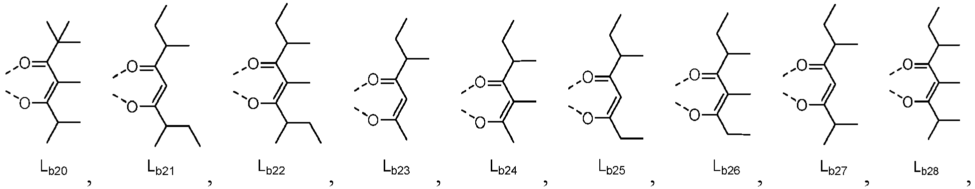 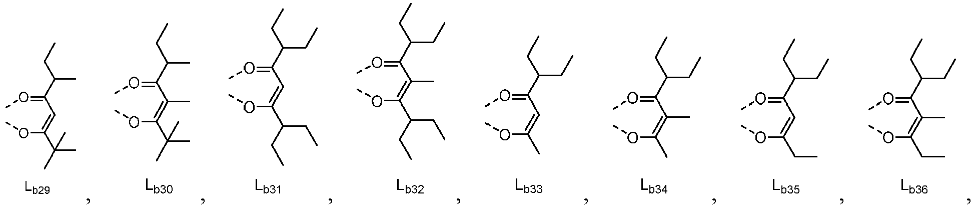 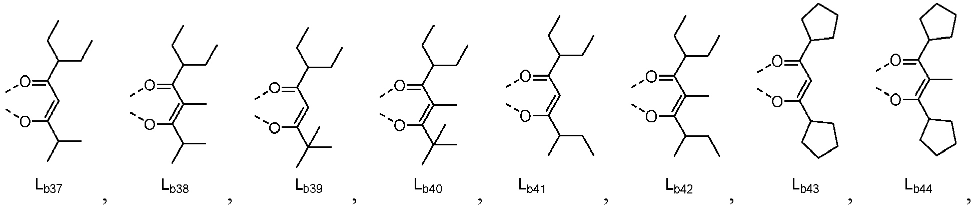 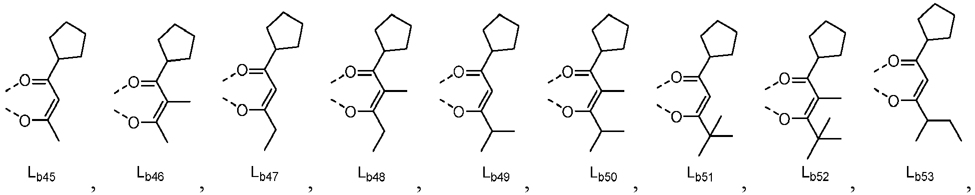 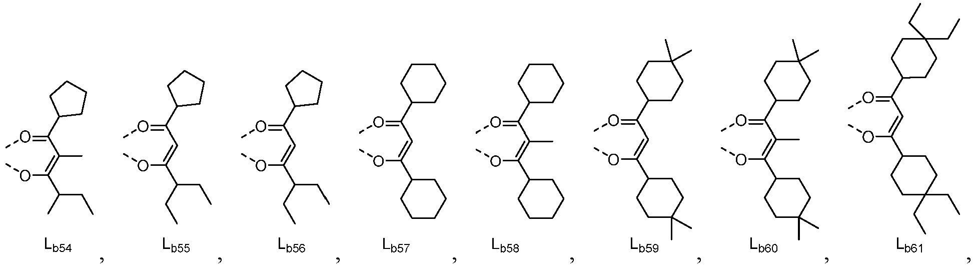 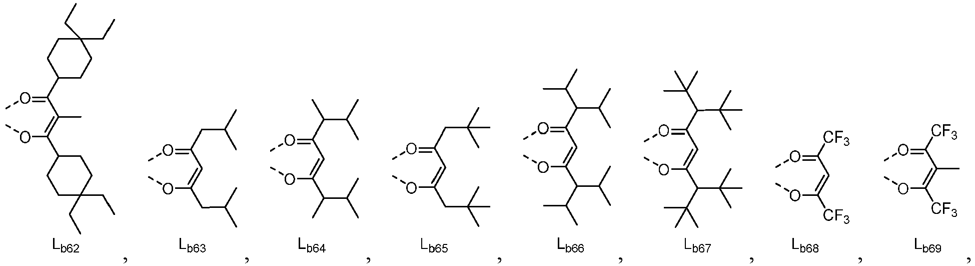 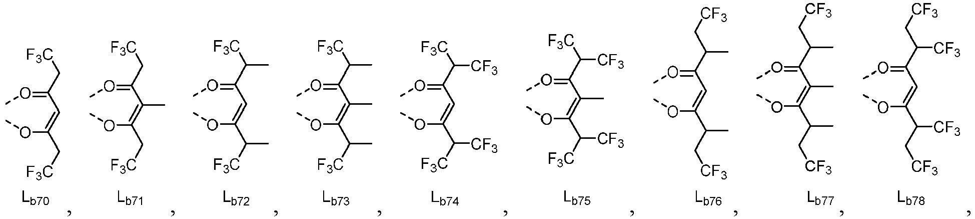 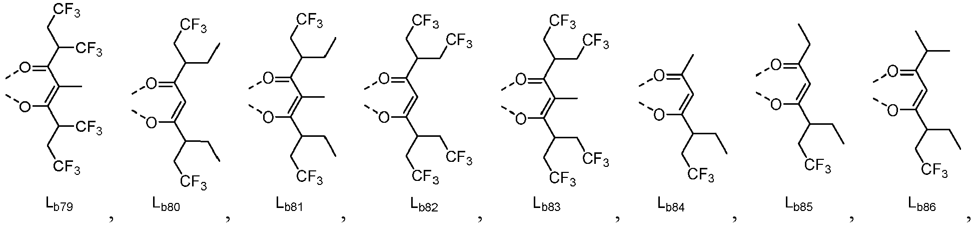 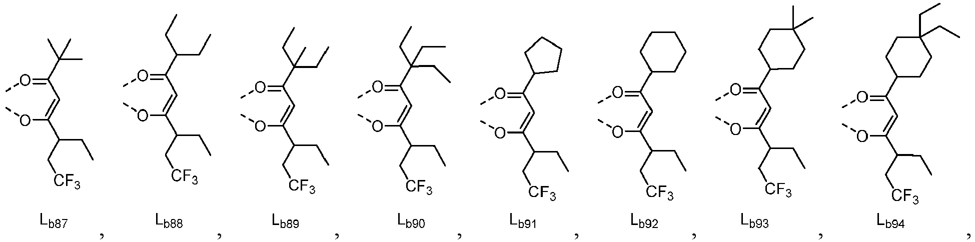 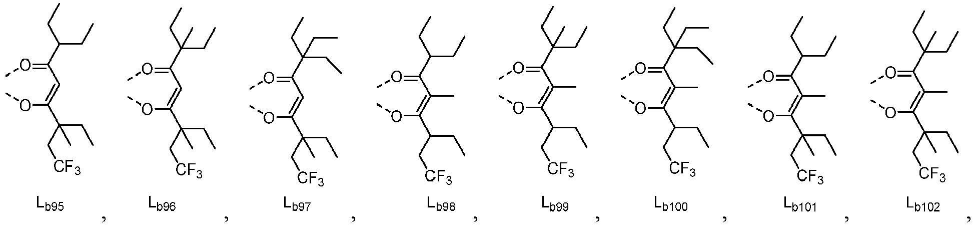 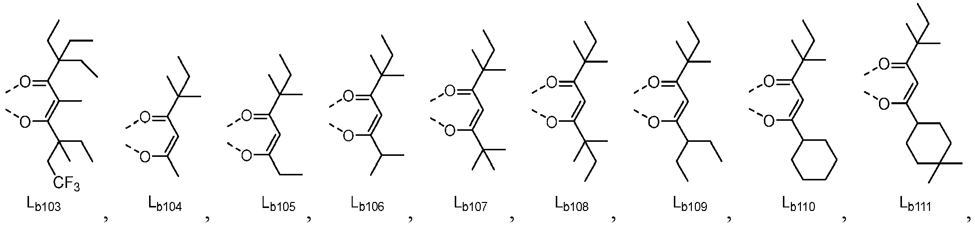 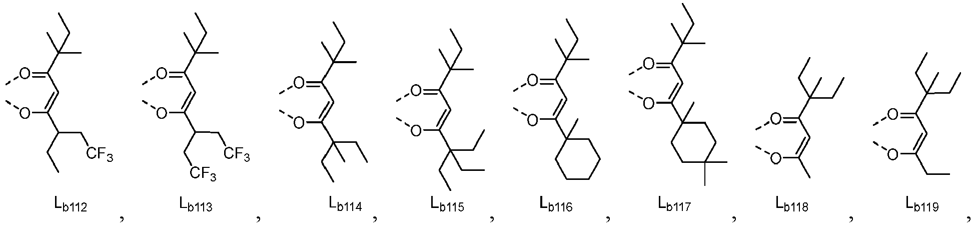 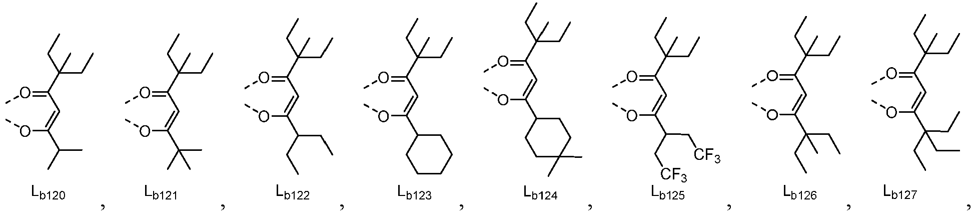 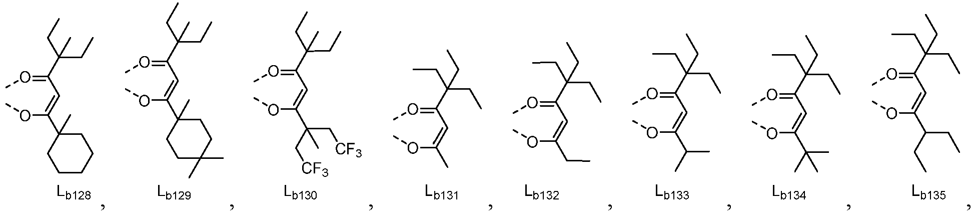 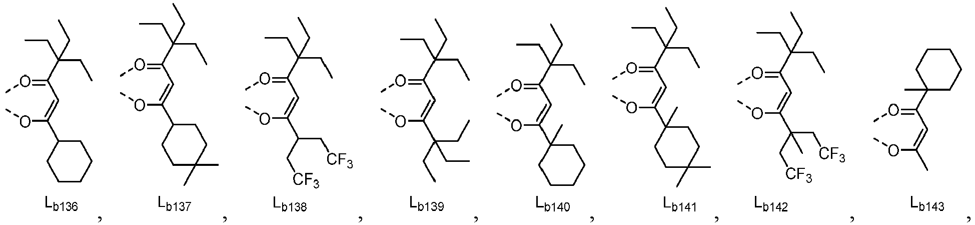 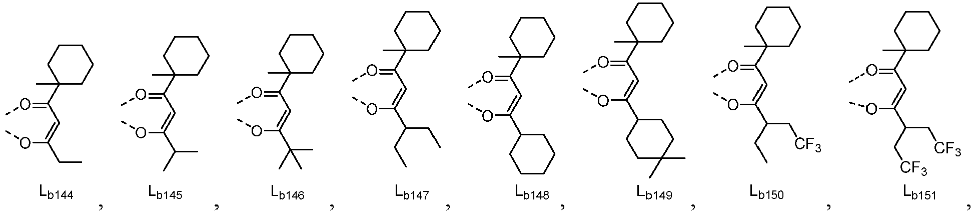 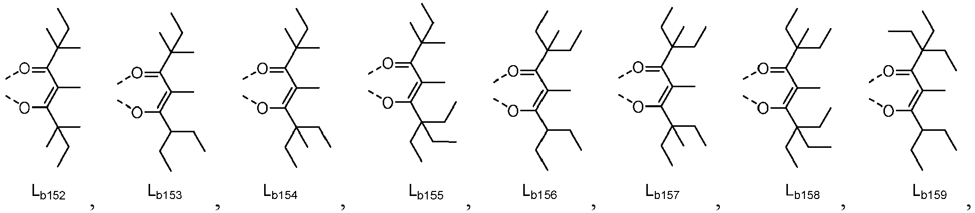 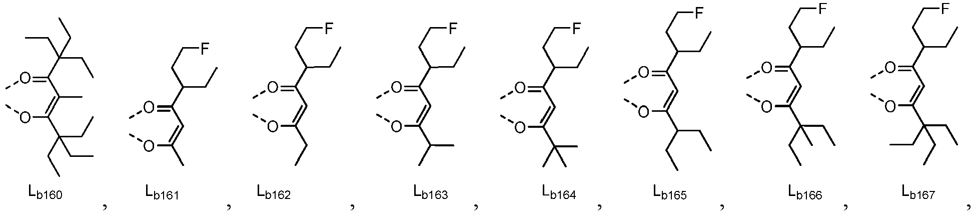 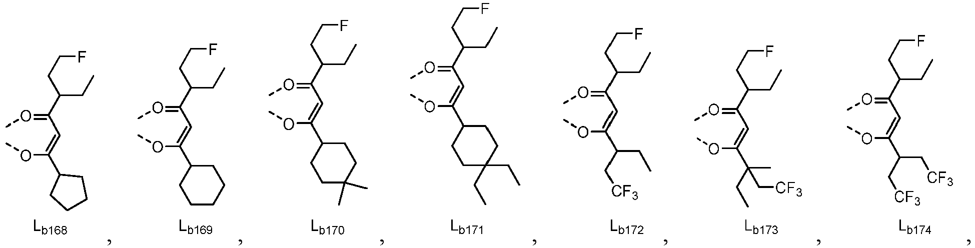 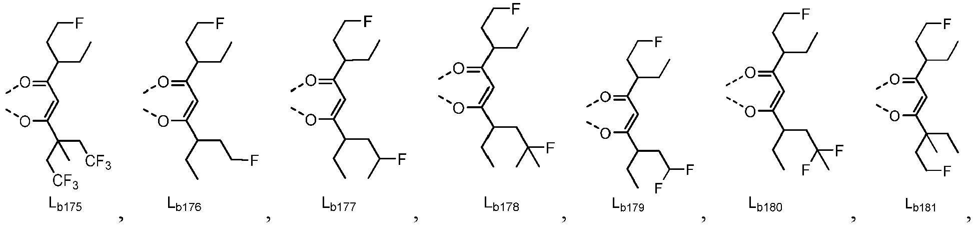 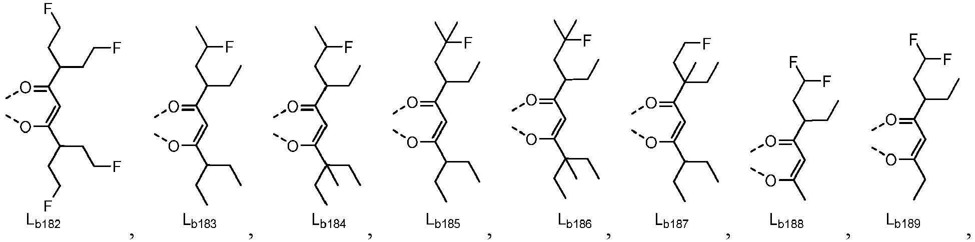 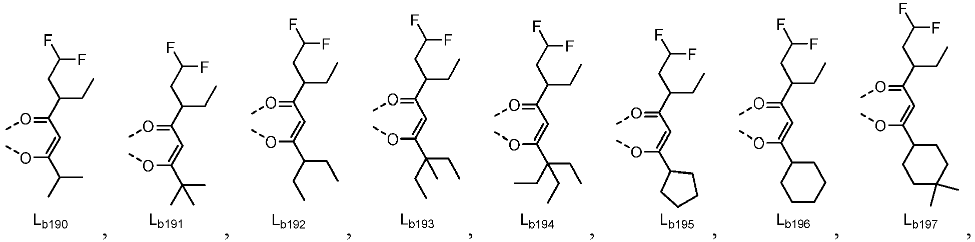 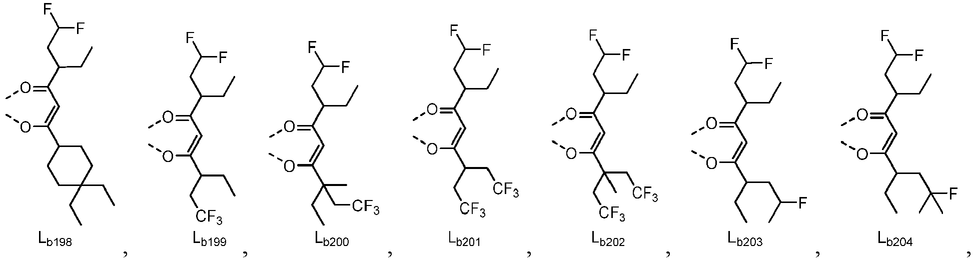 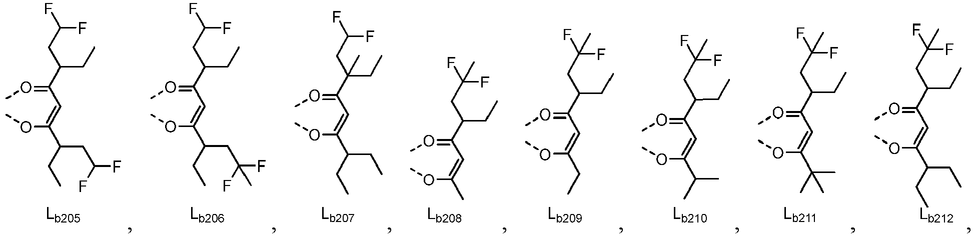 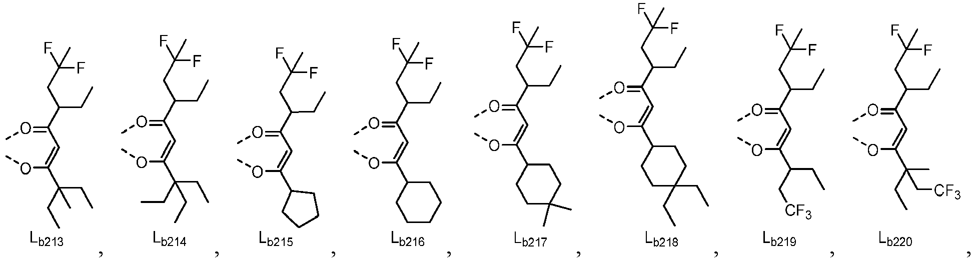 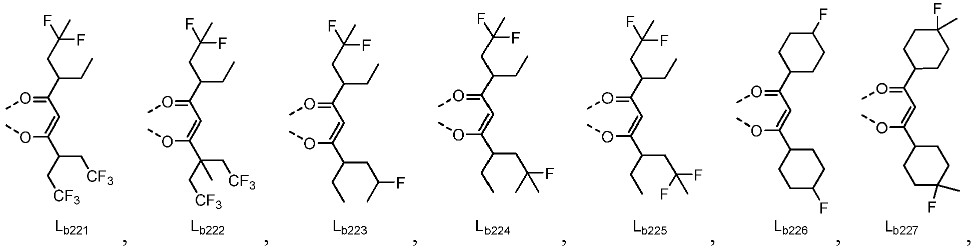 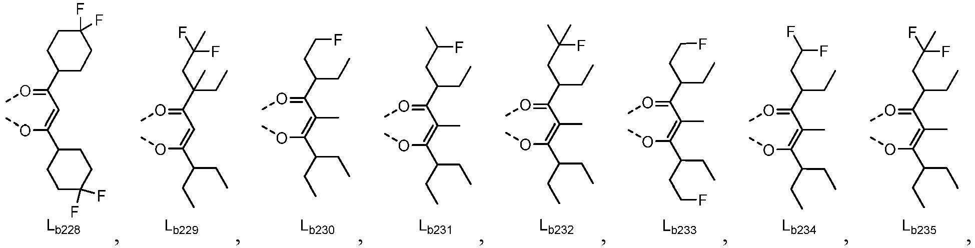 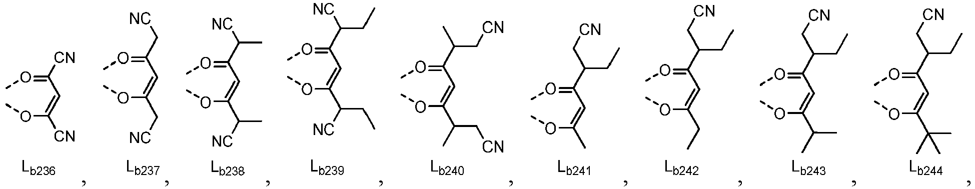 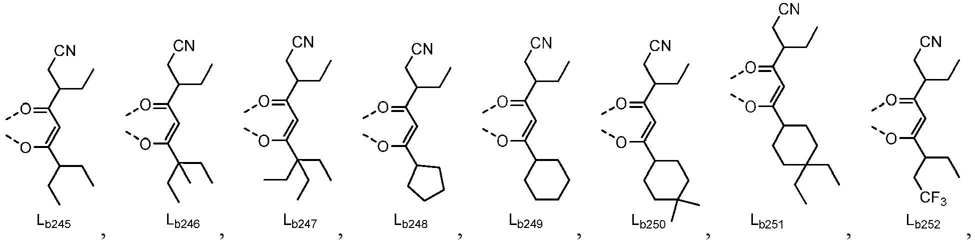 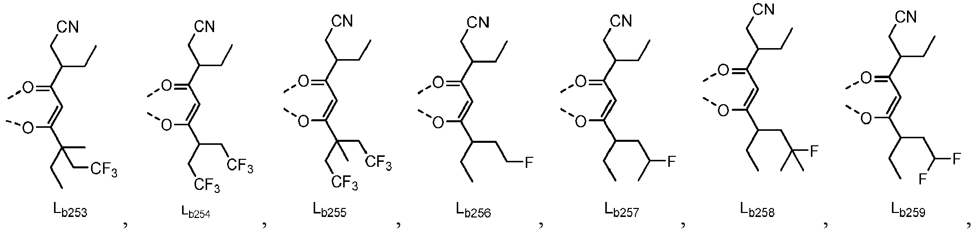 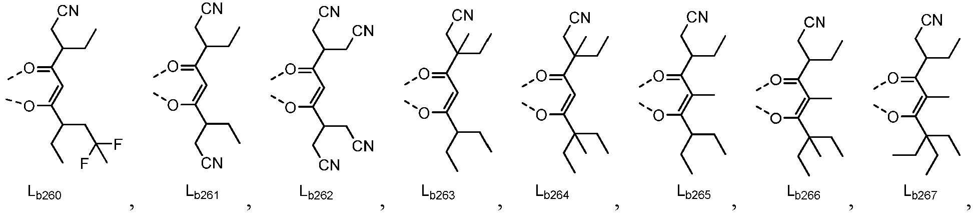 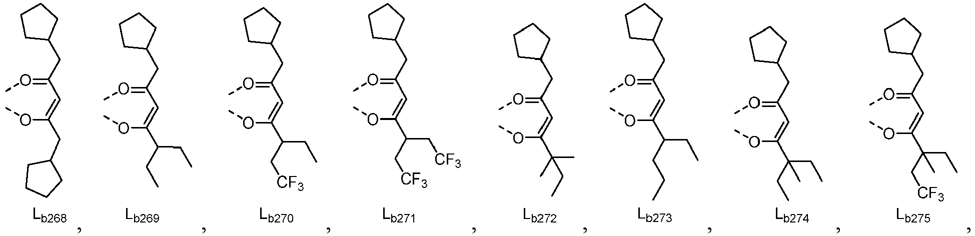 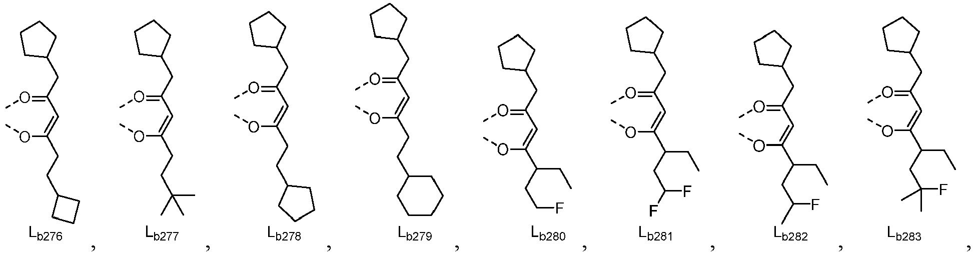 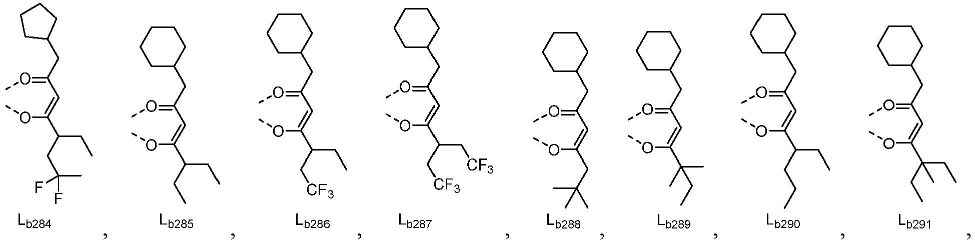 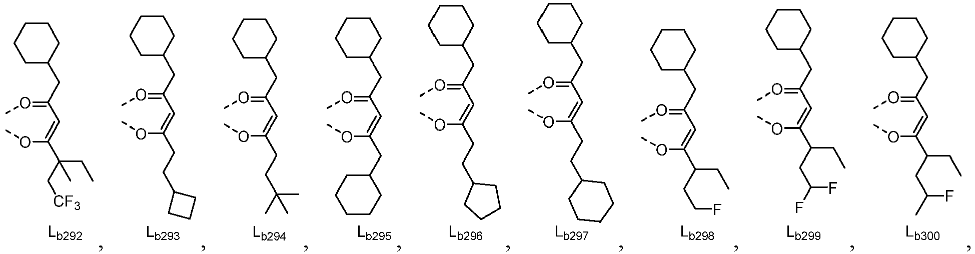 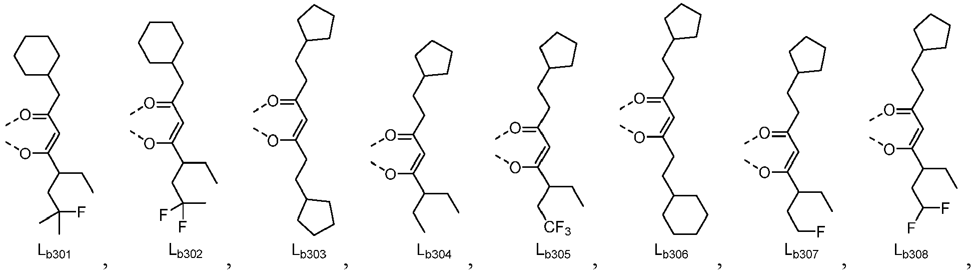 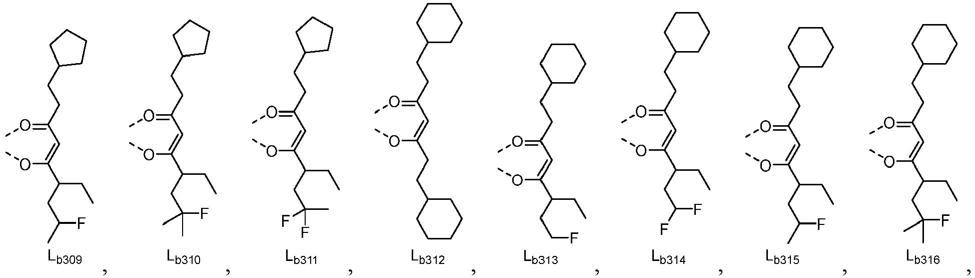 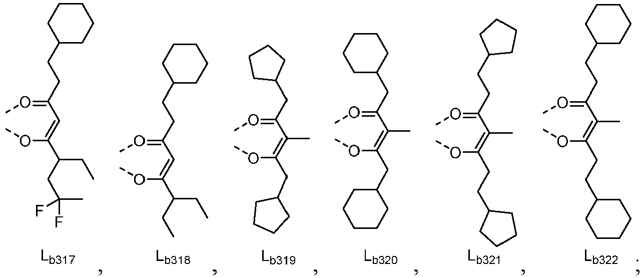 wobei L_{c} bei jedem Auftreten identisch oder unterschiedlich aus der Gruppe bestehend aus den folgenden Strukturen ausgewählt ist:

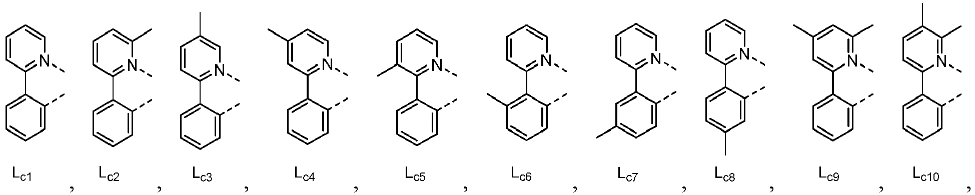

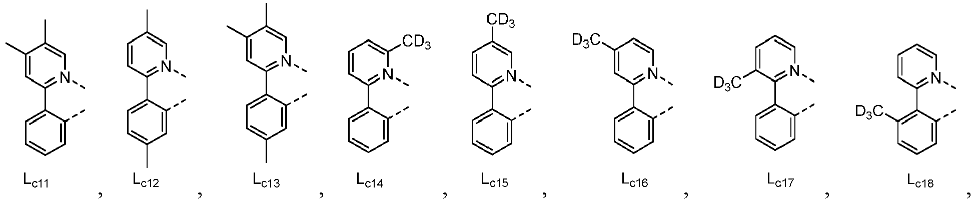

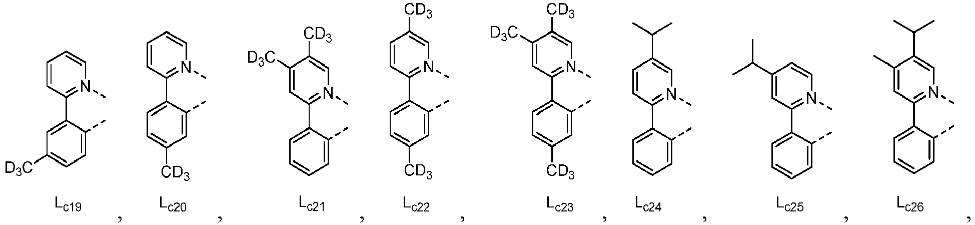

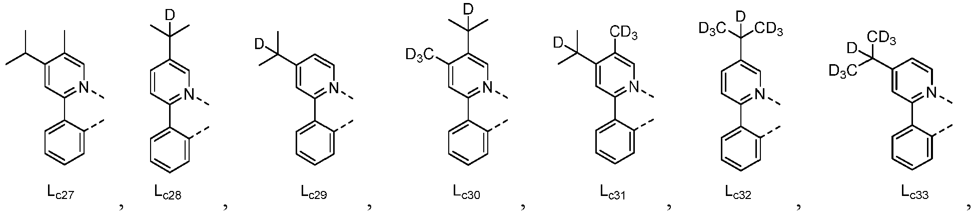

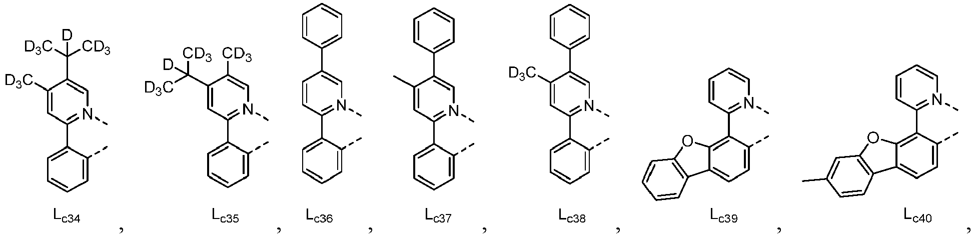

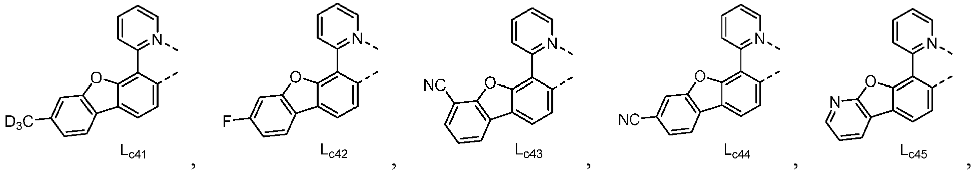

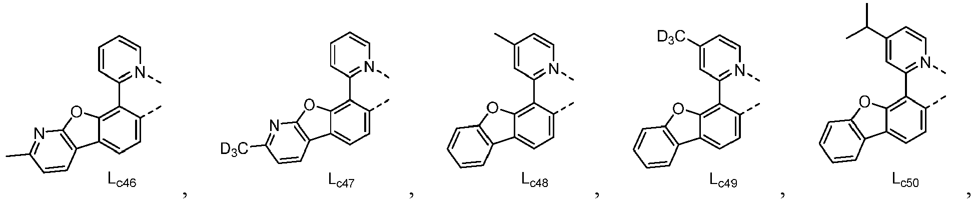

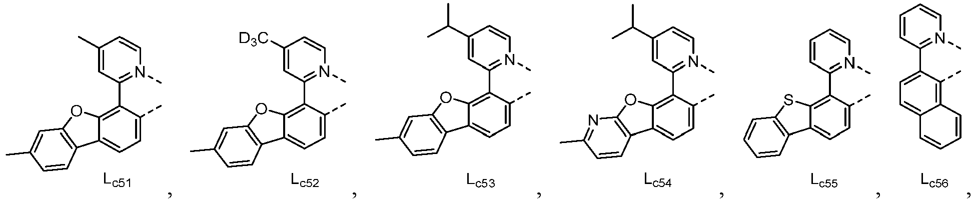

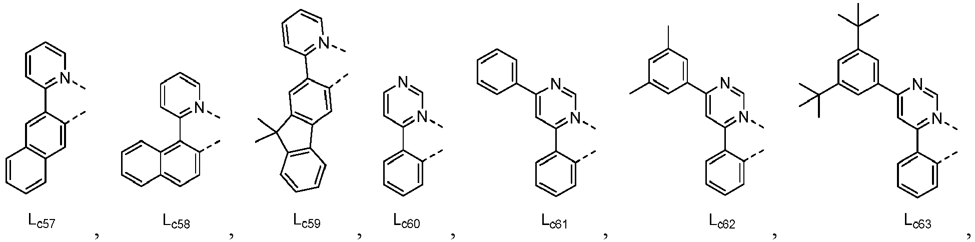

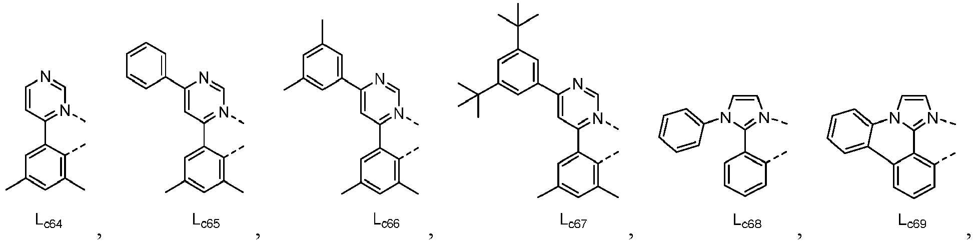

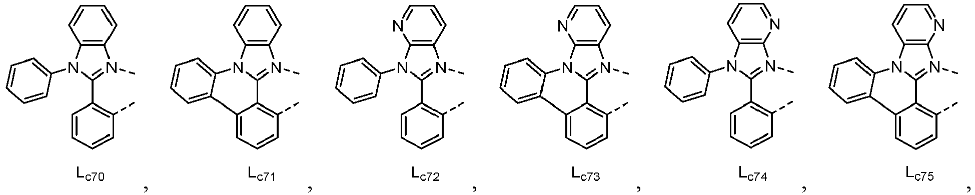

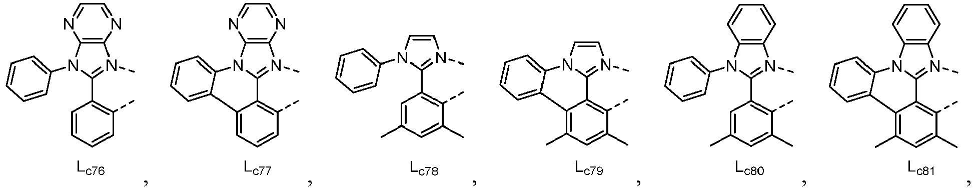

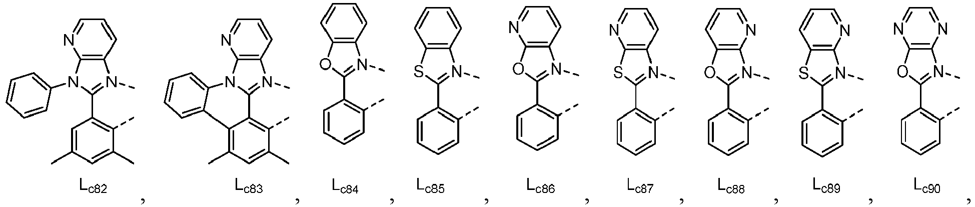

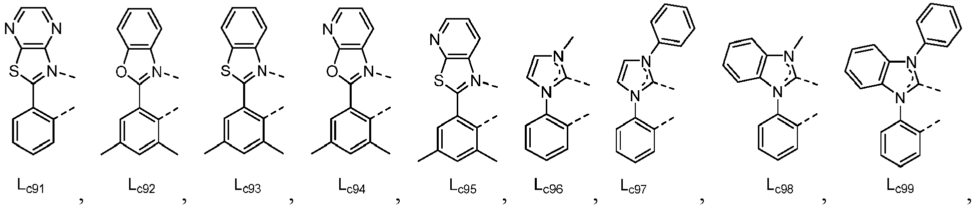

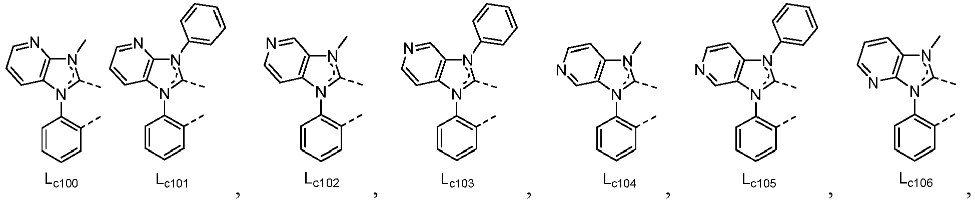

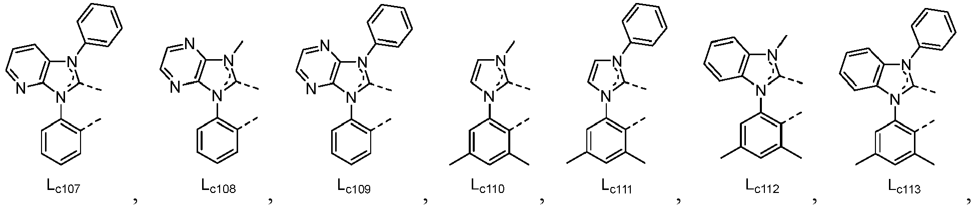

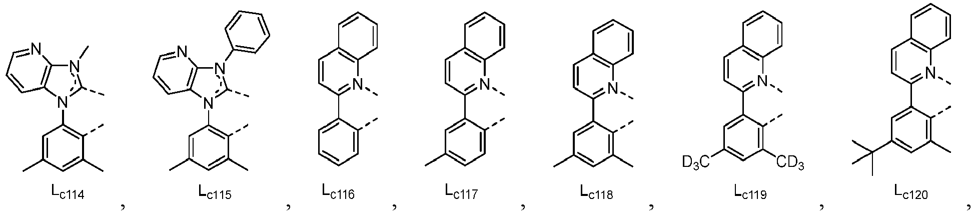

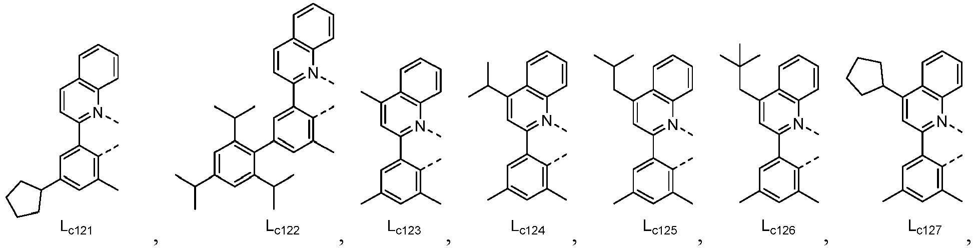

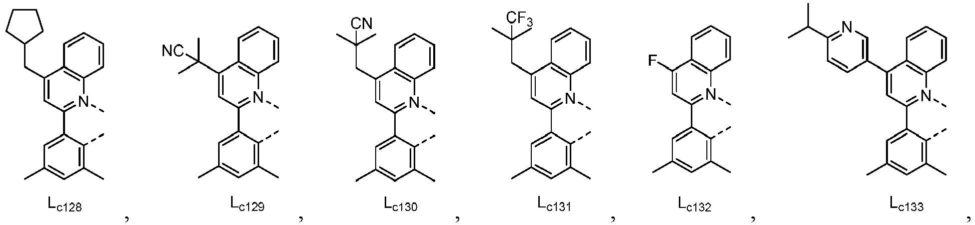

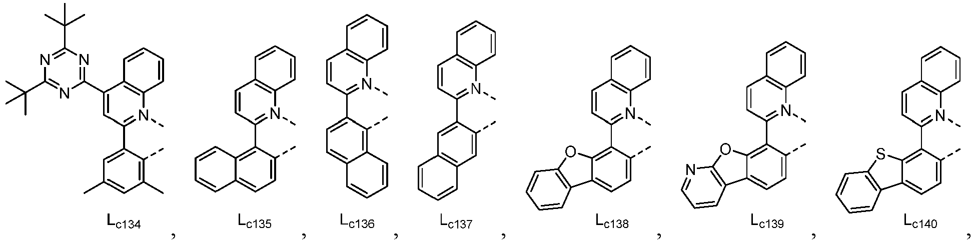

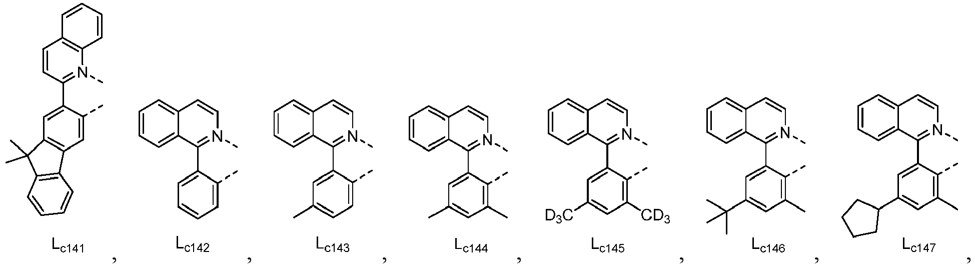

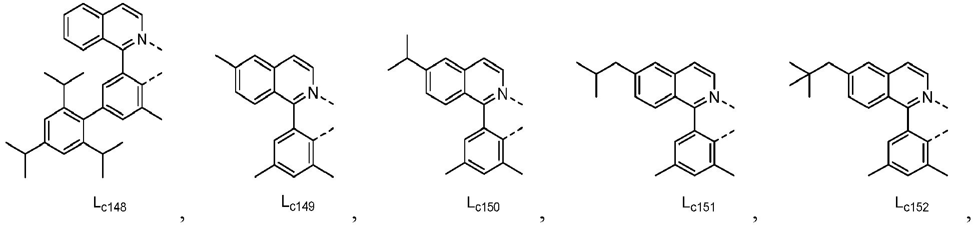

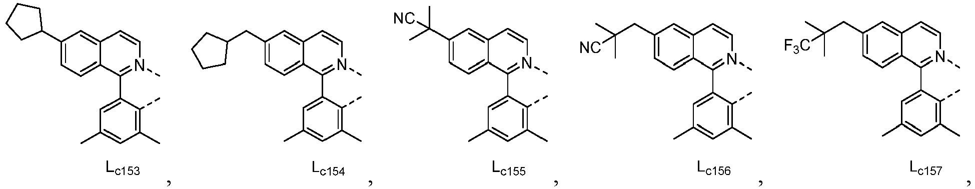

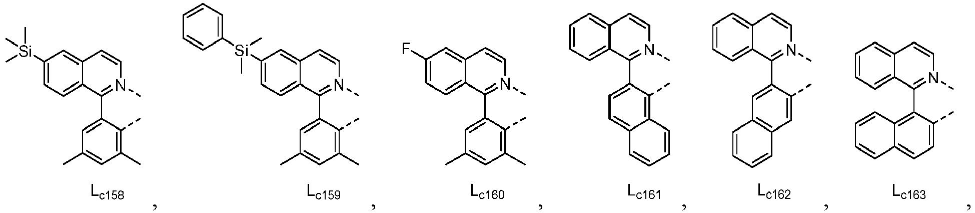

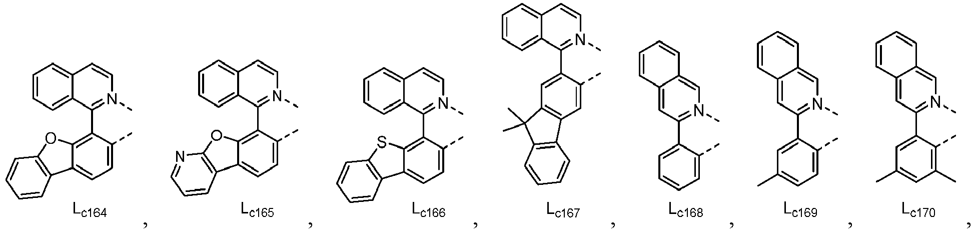

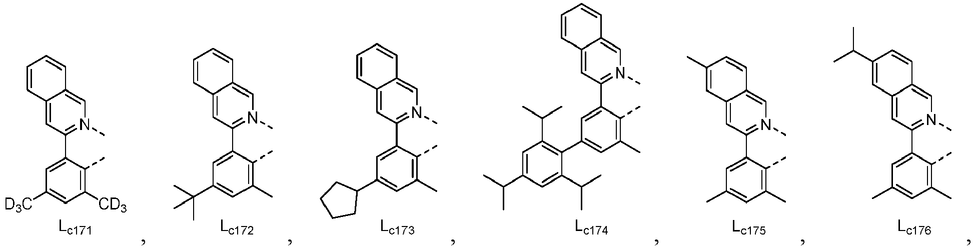

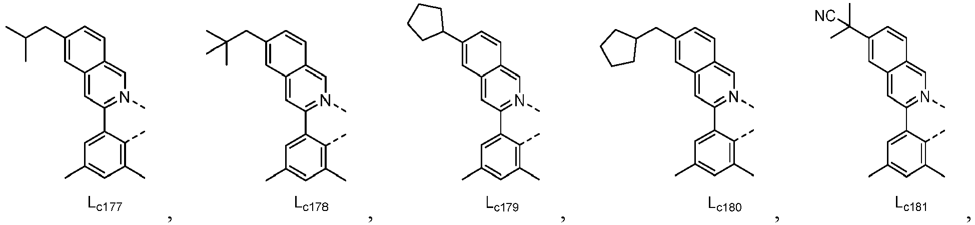

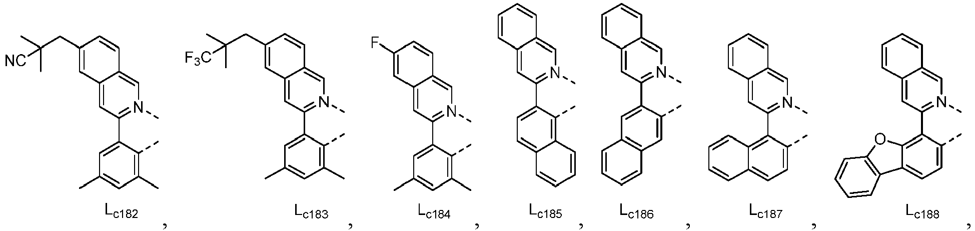

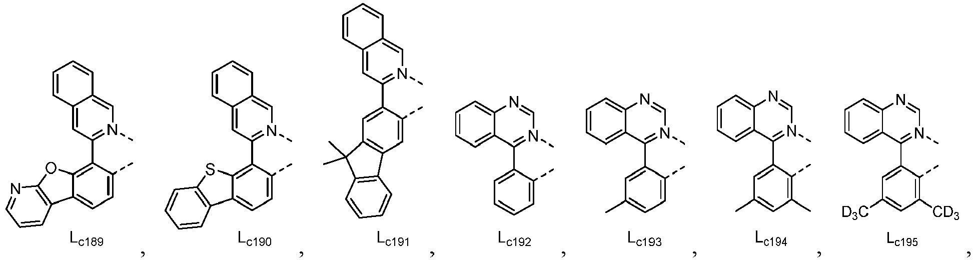

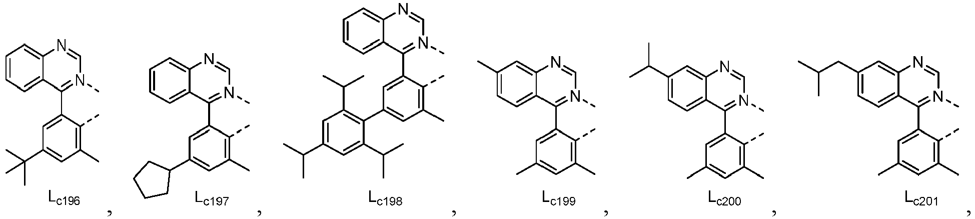

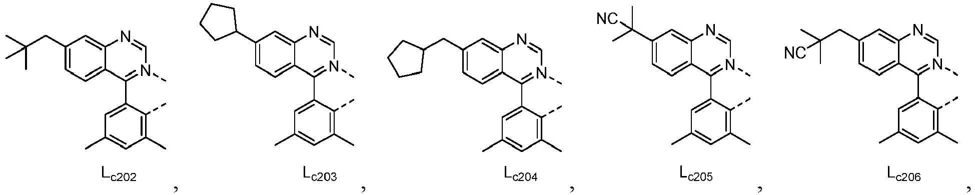

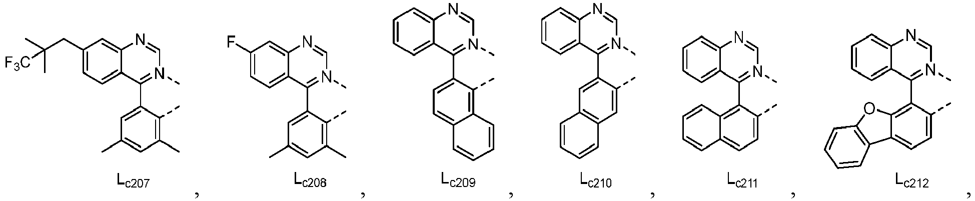

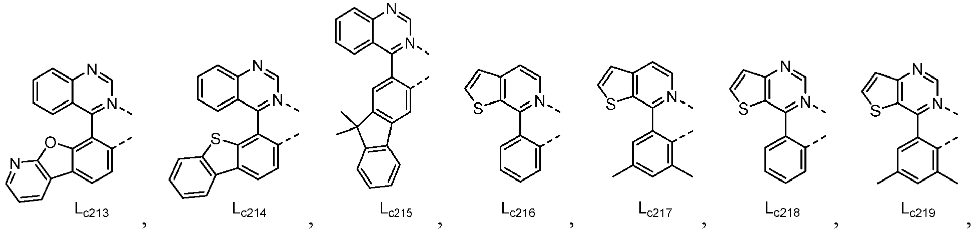

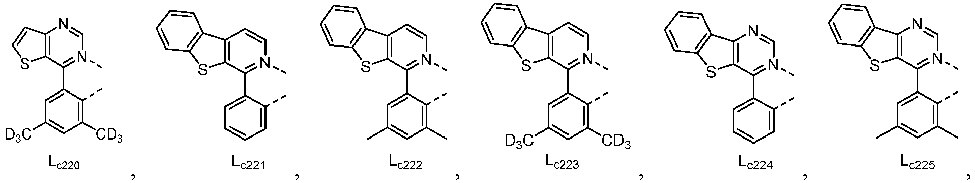

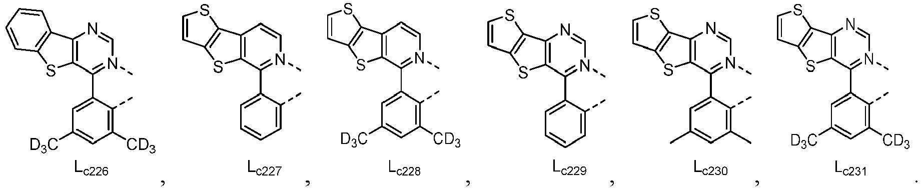

14. Metallkomplex nach Anspruch 13, wobei der Metallkomplex eine Struktur von Ir(Lₐ)₂(L_{b}) oder Ir(Lₐ)₂(L_{c}) oder Ir(Lₐ)(L_{c})₂ oder Ir(Lₐ)(L_{b})(L_{c}) hat;
wobei wenn der Metallkomplex eine Struktur von Ir(Lₐ)₂(L_{b}) hat, Lₐ bei jedem Auftreten identisch oder unterschiedlich aus einem oder zwei der Gruppe bestehend aus Lₐ₁ bis Lₐ₁₉₀₄ ausgewählt ist und L_{b} aus einem der Gruppe bestehend aus L_{b1} bis L_{b322} ausgewählt ist; wenn der Metallkomplex die Struktur Ir(Lₐ)₂(L_{c}) hat, Lₐ bei jedem Auftreten identisch oder unterschiedlich aus einem oder zwei der Gruppe bestehend aus Lₐ₁ bis Lₐ₁₉₀₄ ausgewählt ist und L_{c} aus einem der Gruppe bestehend aus L_{c1} bis L_{c231} ausgewählt ist; wenn der Metallkomplex die Struktur Ir(Lₐ)(L_{c})₂ hat, Lₐ ausgewählt ist aus einem der Gruppe bestehend aus Lₐ₁ bis Lₐ₁₉₀₄ ausgewählt ist, und L_{c} bei jedem Auftreten identisch oder unterschiedlich aus einem oder zwei der Gruppe bestehend aus L_{c1} bis L_{c231} ausgewählt ist; wenn der Metallkomplex die Struktur Ir(Lₐ)(L_{b})(L_{c}) hat, Lₐ ausgewählt ist aus einem der Gruppe bestehend aus Lₐ₁ bis Lₐ₁₉₀₄, L_{b} ausgewählt ist aus einem der Gruppe bestehend aus L_{b1} bis L_{b322}, und L_{c} ausgewählt ist aus einem der Gruppe bestehend aus L_{c1} bis L_{c231}; und
bevorzugt der Metallkomplex ausgewählt ist aus der Gruppe bestehend aus Verbindung 1 bis Verbindung 1010;
wobei Verbindung 1 bis Verbindung 800 jeweils eine Struktur von Ir(Lₐ)₂(L_{b}) haben, wobei die beiden Lₐ identisch sind und die Lₐ und L_{b} jeweils aus den in der folgenden Tabelle aufgeführten Strukturen ausgewählt sind:
| Verbindung Nr. | Lₐ | L_{b} | Verbindung Nr. | Lₐ | L_{b} |
|---|---|---|---|---|---|
| 1 | Lₐ₅ | L_{b1} | 2 | Lₐ₂₁ | L_{b1} |
| 3 | Lₐ₃₅ | L_{b1} | 4 | Lₐ₆₆ | L_{b1} |
| 5 | Lₐ₆₉ | L_{b1} | 6 | Lₐ₇₀ | L_{b1} |
| 7 | Lₐ₇₄ | L_{b1} | 8 | Lₐ₁₂₁ | L_{b1} |
| 9 | Lₐ₁₄₈ | L_{b1} | 10 | Lₐ₁₇₅ | L_{b1} |
| 11 | Lₐ₂₀₇ | L_{b1} | 12 | Lₐ₂₁₂ | L_{b1} |
| 13 | Lₐ₂₃₆ | L_{b1} | 14 | Lₐ₂₅₅ | L_{b1} |
| 15 | Lₐ₂₇₁ | L_{b1} | 16 | Lₐ₂₈₇ | L_{b1} |
| 17 | Lₐ₃₁₉ | L_{b1} | 18 | Lₐ₃₂₀ | L_{b1} |
| 19 | Lₐ₃₃₅ | L_{b1} | 20 | Lₐ₃₉₉ | L_{b1} |
| 21 | Lₐ₄₃₈ | L_{b1} | 22 | Lₐ₄₅₃ | L_{b1} |
| 23 | Lₐ₄₆₉ | L_{b1} | 24 | Lₐ₄₉₇ | L_{b1} |
| 25 | Lₐ₅₀₀ | L_{b1} | 26 | Lₐ₅₂₉ | L_{b1} |
| 27 | Lₐ₆₀₁ | L_{b1} | 28 | Lₐ₆₀₆ | L_{b1} |
| 29 | Lₐ₆₃₇ | L_{b1} | 30 | Lₐ₆₆₅ | L_{b1} |
| 31 | Lₐ₆₈₉ | L_{b1} | 32 | Lₐ₆₉₉ | L_{b1} |
| 33 | Lₐ₇₀₀ | L_{b1} | 34 | Lₐ₇₄₄ | L_{b1} |
| 35 | Lₐ₇₇₇ | L_{b1} | 36 | Lₐ₇₉₃ | L_{b1} |
| 37 | Lₐ₈₁₀ | L_{b1} | 38 | Lₐ₈₄₂ | L_{b1} |
| 39 | Lₐ₈₅₀ | L_{b1} | 40 | Lₐ₉₁₇ | L_{b1} |
| 41 | Lₐ₉₈₂ | L_{b1} | 42 | Lₐ₉₈₉ | L_{b1} |
| 43 | Lₐ₁₀₁₆ | L_{b1} | 44 | Lₐ₁₀₃₁ | L_{b1} |
| 45 | Lₐ₁₀₄₇ | L_{b1} | 46 | Lₐ₁₀₇₉ | L_{b1} |
| 47 | Lₐ₁₁₆₃ | L_{b1} | 47 | Lₐ₁₁₉₁ | L_{b1} |
| 49 | Lₐ₁₁₉₈ | L_{b1} | 50 | Lₐ₁₂₃₆ | L_{b1} |
| 51 | Lₐ₁₂₄₇ | L_{b1} | 52 | Lₐ₁₂₇₆ | L_{b1} |
| 53 | Lₐ₁₃₁₃ | L_{b1} | 54 | Lₐ₁₃₃₆ | L_{b1} |
| 55 | Lₐ₁₃₄₁ | L_{b1} | 56 | Lₐ₁₃₆₄ | L_{b1} |
| 57 | Lₐ₁₃₉₅ | L_{b1} | 58 | Lₐ₁₄₃₇ | L_{b1} |
| 59 | Lₐ₁₄₅₄ | L_{b1} | 60 | Lₐ₁₄₅₅ | L_{b1} |
| 61 | Lₐ₁₄₈₀ | L_{b1} | 62 | Lₐ₁₄₈₇ | L_{b1} |
| 63 | Lₐ₁₄₉₂ | L_{b1} | 64 | Lₐ₁₅₁₀ | L_{b1} |
| 65 | Lₐ₁₅₂₃ | L_{b1} | 66 | Lₐ₁₅₃₁ | L_{b1} |
| 67 | Lₐ₁₅₇₁ | L_{b1} | 68 | Lₐ₁₅₉₁ | L_{b1} |
| 69 | Lₐ₁₆₀₈ | L_{b1} | 70 | Lₐ₁₆₀₉ | L_{b1} |
| 71 | Lₐ₁₆₂₉ | L_{b1} | 72 | Lₐ₁₆₃₀ | L_{b1} |
| 73 | Lₐ₁₆₃₈ | L_{b1} | 74 | Lₐ₁₆₈₈ | L_{b1} |
| 75 | Lₐ₁₇₀₂ | L_{b1} | 76 | Lₐ₁₇₁₇ | L_{b1} |
| 77 | Lₐ₁₇₂₃ | L_{b1} | 78 | Lₐ₁₇₅₃ | L_{b1} |
| 79 | Lₐ₁₇₆₁ | L_{b1} | 80 | Lₐ₁₈₁₃ | L_{b1} |
| 81 | Lₐ₁₈₁₅ | L_{b1} | 82 | Lₐ₁₈₁₉ | L_{b1} |
| 83 | Lₐ₁₈₂₃ | L_{b1} | 84 | Lₐ₁₈₂₉ | L_{b1} |
| 85 | Lₐ₁₈₃₃ | L_{b1} | 86 | Lₐ₁₈₃₉ | L_{b1} |
| 87 | Lₐ₁₈₄₃ | L_{b1} | 88 | Lₐ₁₈₄₉ | L_{b1} |
| 89 | Lₐ₁₈₅₃ | L_{b1} | 90 | Lₐ₁₈₅₅ | L_{b1} |
| 91 | Lₐ₁₈₅₉ | L_{b1} | 92 | Lₐ₁₈₆₃ | L_{b1} |
| 93 | Lₐ₁₈₆₅ | L_{b1} | 94 | Lₐ₁₈₆₉ | L_{b1} |
| 95 | Lₐ₁₈₇₃ | L_{b1} | 96 | Lₐ₁₈₇₅ | L_{b1} |
| 97 | Lₐ₁₈₇₉ | L_{b1} | 98 | Lₐ₁₈₈₃ | L_{b1} |
| 99 | Lₐ₁₈₈₅ | L_{b1} | 100 | Lₐ₁₈₈₉ | L_{b1} |
| 101 | Lₐ₅ | L_{b31} | 102 | Lₐ₂₁ | L_{b31} |
| 103 | Lₐ₃₅ | L_{b31} | 104 | Lₐ₆₆ | L_{b31} |
| 105 | Lₐ₆₉ | L_{b31} | 106 | Lₐ₇₀ | L_{b31} |
| 107 | Lₐ₇₄ | L_{b31} | 108 | Lₐ₁₂₁ | L_{b31} |
| 109 | Lₐ₁₄₈ | L_{b31} | 110 | Lₐ₁₇₅ | L_{b31} |
| 111 | Lₐ₂₀₇ | L_{b31} | 112 | Lₐ₂₁₂ | L_{b31} |
| 113 | Lₐ₂₃₆ | L_{b31} | 114 | Lₐ₂₅₅ | L_{b31} |
| 115 | Lₐ₂₇₁ | L_{b31} | 116 | Lₐ₂₈₇ | L_{b31} |
| 117 | Lₐ₃₁₉ | L_{b31} | 118 | Lₐ₃₂₀ | L_{b31} |
| 119 | Lₐ₃₃₅ | L_{b31} | 120 | Lₐ₃₉₉ | L_{b31} |
| 121 | Lₐ₄₃₈ | L_{b31} | 122 | Lₐ₄₅₃ | L_{b31} |
| 123 | Lₐ₄₆₉ | L_{b31} | 124 | Lₐ₄₉₇ | L_{b31} |
| 125 | Lₐ₅₀₀ | L_{b31} | 126 | Lₐ₅₂₉ | L_{b31} |
| 127 | Lₐ₆₀₁ | L_{b31} | 128 | Lₐ₆₀₆ | L_{b31} |
| 129 | Lₐ₆₃₇ | L_{b31} | 130 | Lₐ₆₆₅ | L_{b31} |
| 131 | Lₐ₆₈₉ | L_{b31} | 132 | Lₐ₆₉₉ | L_{b31} |
| 133 | Lₐ₇₀₀ | L_{b31} | 134 | Lₐ₇₄₄ | L_{b31} |
| 135 | Lₐ₇₇₇ | L_{b31} | 136 | Lₐ₇₉₃ | L_{b31} |
| 137 | Lₐ₈₁₀ | L_{b31} | 138 | Lₐ₈₄₂ | L_{b31} |
| 139 | Lₐ₈₅₀ | L_{b31} | 140 | Lₐ₉₁₇ | L_{b31} |
| 141 | Lₐ₉₈₂ | L_{b31} | 142 | Lₐ₉₈₉ | L_{b31} |
| 143 | Lₐ₁₀₁₆ | L_{b31} | 144 | Lₐ₁₀₃₁ | L_{b31} |
| 145 | Lₐ₁₀₄₇ | L_{b31} | 146 | Lₐ₁₀₇₉ | L_{b31} |
| 147 | Lₐ₁₁₆₃ | L_{b31} | 148 | Lₐ₁₁₉₁ | L_{b31} |
| 149 | Lₐ₁₁₉₈ | L_{b31} | 150 | Lₐ₁₂₃₆ | L_{b31} |
| 151 | Lₐ₁₂₄₇ | L_{b31} | 152 | Lₐ₁₂₇₆ | L_{b31} |
| 153 | Lₐ₁₃₁₃ | L_{b31} | 154 | Lₐ₁₃₃₆ | L_{b31} |
| 155 | Lₐ₁₃₄₁ | L_{b31} | 156 | Lₐ₁₃₆₄ | L_{b31} |
| 157 | Lₐ₁₃₉₅ | L_{b31} | 158 | Lₐ₁₄₃₇ | L_{b31} |
| 159 | Lₐ₁₄₅₄ | L_{b31} | 160 | Lₐ₁₄₅₅ | L_{b31} |
| 161 | Lₐ₁₄₈₀ | L_{b31} | 162 | Lₐ₁₄₈₇ | L_{b31} |
| 163 | Lₐ₁₄₉₂ | L_{b31} | 164 | Lₐ₁₅₁₀ | L_{b31} |
| 165 | Lₐ₁₅₂₃ | L_{b31} | 166 | Lₐ₁₅₃₁ | L_{b31} |
| 167 | Lₐ₁₅₇₁ | L_{b31} | 168 | Lₐ₁₅₉₁ | L_{b31} |
| 169 | Lₐ₁₆₀₈ | L_{b31} | 170 | Lₐ₁₆₀₉ | L_{b31} |
| 171 | Lₐ₁₆₂₉ | L_{b31} | 172 | Lₐ₁₆₃₀ | L_{b31} |
| 173 | Lₐ₁₆₃₈ | L_{b31} | 174 | Lₐ₁₆₈₈ | L_{b31} |
| 175 | Lₐ₁₇₀₂ | L_{b31} | 176 | Lₐ₁₇₁₇ | L_{b31} |
| 177 | Lₐ₁₇₂₃ | L_{b31} | 178 | Lₐ₁₇₅₃ | L_{b31} |
| 179 | Lₐ₁₇₆₁ | L_{b31} | 180 | Lₐ₁₈₁₃ | L_{b31} |
| 181 | Lₐ₁₈₁₅ | L_{b31} | 182 | Lₐ₁₈₁₉ | L_{b31} |
| 183 | Lₐ₁₈₂₃ | L_{b31} | 184 | Lₐ₁₈₂₉ | L_{b31} |
| 185 | Lₐ₁₈₃₃ | L_{b31} | 186 | Lₐ₁₈₃₉ | L_{b31} |
| 187 | Lₐ₁₈₄₃ | L_{b31} | 188 | Lₐ₁₈₄₉ | L_{b31} |
| 189 | Lₐ₁₈₅₃ | L_{b31} | 190 | Lₐ₁₈₅₅ | L_{b31} |
| 191 | Lₐ₁₈₅₉ | L_{b31} | 192 | Lₐ₁₈₆₃ | L_{b31} |
| 193 | Lₐ₁₈₆₅ | L_{b31} | 194 | Lₐ₁₈₆₉ | L_{b31} |
| 195 | Lₐ₁₈₇₃ | L_{b31} | 196 | Lₐ₁₈₇₅ | L_{b31} |
| 197 | Lₐ₁₈₇₉ | L_{b31} | 198 | Lₐ₁₈₈₃ | L_{b31} |
| 199 | Lₐ₁₈₈₅ | L_{b31} | 200 | Lₐ₁₈₈₉ | L_{b31} |
| 201 | Lₐ₅ | L_{b88} | 202 | Lₐ₂₁ | L_{b88} |
| 203 | Lₐ₃₅ | L_{b88} | 204 | Lₐ₆₆ | L_{b88} |
| 205 | Lₐ₆₉ | L_{b88} | 206 | Lₐ₇₀ | L_{b88} |
| 207 | Lₐ₇₄ | L_{b88} | 208 | Lₐ₁₂₁ | L_{b88} |
| 209 | Lₐ₁₄₈ | L_{b88} | 210 | Lₐ₁₇₅ | L_{b88} |
| 211 | Lₐ₂₀₇ | L_{b88} | 212 | Lₐ₂₁₂ | L_{b88} |
| 213 | Lₐ₂₃₆ | L_{b88} | 214 | Lₐ₂₅₅ | L_{b88} |
| 215 | Lₐ₂₇₁ | L_{b88} | 216 | Lₐ₂₈₇ | L_{b88} |
| 217 | Lₐ₃₁₉ | L_{b88} | 218 | Lₐ₃₂₀ | L_{b88} |
| 219 | Lₐ₃₃₅ | L_{b88} | 220 | Lₐ₃₉₉ | L_{b88} |
| 221 | Lₐ₄₃₈ | L_{b88} | 222 | Lₐ₄₅₃ | L_{b88} |
| 223 | Lₐ₄₆₉ | L_{b88} | 224 | Lₐ₄₉₇ | L_{b88} |
| 225 | Lₐ₅₀₀ | L_{b88} | 226 | Lₐ₅₂₉ | L_{b88} |
| 227 | Lₐ₆₀₁ | L_{b88} | 228 | Lₐ₆₀₆ | L_{b88} |
| 229 | Lₐ₆₃₇ | L_{b88} | 230 | Lₐ₆₆₅ | L_{b88} |
| 231 | Lₐ₆₈₉ | L_{b88} | 232 | Lₐ₆₉₉ | L_{b88} |
| 233 | Lₐ₇₀₀ | L_{b88} | 234 | Lₐ₇₄₄ | L_{b88} |
| 235 | Lₐ₇₇₇ | L_{b88} | 236 | Lₐ₇₉₃ | L_{b88} |
| 237 | Lₐ₈₁₀ | L_{b88} | 238 | Lₐ₈₄₂ | L_{b88} |
| 239 | Lₐ₈₅₀ | L_{b88} | 240 | Lₐ₉₁₇ | L_{b88} |
| 241 | Lₐ₉₈₂ | L_{b88} | 242 | Lₐ₉₈₉ | L_{b88} |
| 243 | Lₐ₁₀₁₆ | L_{b88} | 244 | Lₐ₁₀₃₁ | L_{b88} |
| 245 | Lₐ₁₀₄₇ | L_{b88} | 246 | Lₐ₁₀₇₉ | L_{b88} |
| 247 | Lₐ₁₁₆₃ | L_{b88} | 248 | Lₐ₁₁₉₁ | L_{b88} |
| 249 | Lₐ₁₁₉₈ | L_{b88} | 250 | Lₐ₁₂₃₆ | L_{b88} |
| 251 | Lₐ₁₂₄₇ | L_{b88} | 252 | Lₐ₁₂₇₆ | L_{b88} |
| 253 | Lₐ₁₃₁₃ | L_{b88} | 254 | Lₐ₁₃₃₆ | L_{b88} |
| 255 | Lₐ₁₃₄₁ | L_{b88} | 256 | Lₐ₁₃₆₄ | L_{b88} |
| 257 | Lₐ₁₃₉₅ | L_{b88} | 258 | Lₐ₁₄₃₇ | L_{b88} |
| 259 | Lₐ₁₄₅₄ | L_{b88} | 260 | Lₐ₁₄₅₅ | L_{b88} |
| 261 | Lₐ₁₄₈₀ | L_{b88} | 262 | Lₐ₁₄₈₇ | L_{b88} |
| 263 | Lₐ₁₄₉₂ | L_{b88} | 264 | Lₐ₁₅₁₀ | L_{b88} |
| 265 | Lₐ₁₅₂₃ | L_{b88} | 266 | Lₐ₁₅₃₁ | L_{b88} |
| 267 | Lₐ₁₅₇₁ | L_{b88} | 268 | Lₐ₁₅₉₁ | L_{b88} |
| 269 | Lₐ₁₆₀₈ | L_{b88} | 270 | Lₐ₁₆₀₉ | L_{b88} |
| 271 | Lₐ₁₆₂₉ | L_{b88} | 272 | Lₐ₁₆₃₀ | L_{b88} |
| 273 | Lₐ₁₆₃₈ | L_{b88} | 274 | Lₐ₁₆₈₈ | L_{b88} |
| 275 | Lₐ₁₇₀₂ | L_{b88} | 276 | Lₐ₁₇₁₇ | L_{b88} |
| 277 | Lₐ₁₇₂₃ | L_{b88} | 278 | Lₐ₁₇₅₃ | L_{b88} |
| 279 | Lₐ₁₇₆₁ | L_{b88} | 280 | Lₐ₁₈₁₃ | L_{b88} |
| 281 | Lₐ₁₈₁₅ | L_{b88} | 282 | Lₐ₁₈₁₉ | L_{b88} |
| 283 | Lₐ₁₈₂₃ | L_{b88} | 284 | Lₐ₁₈₂₉ | L_{b88} |
| 285 | Lₐ₁₈₃₃ | L_{b88} | 286 | Lₐ₁₈₃₉ | L_{b88} |
| 287 | Lₐ₁₈₄₃ | L_{b88} | 288 | Lₐ₁₈₄₉ | L_{b88} |
| 289 | Lₐ₁₈₅₃ | L_{b88} | 290 | Lₐ₁₈₅₅ | L_{b88} |
| 291 | Lₐ₁₈₅₉ | L_{b88} | 292 | Lₐ₁₈₆₃ | L_{b88} |
| 293 | Lₐ₁₈₆₅ | L_{b88} | 294 | Lₐ₁₈₆₉ | L_{b88} |
| 295 | Lₐ₁₈₇₃ | L_{b88} | 296 | Lₐ₁₈₇₅ | L_{b88} |
| 297 | Lₐ₁₈₇₉ | L_{b88} | 298 | _{La1883} | L_{b88} |
| 299 | Lₐ₁₈₈₅ | L_{b88} | 300 | Lₐ₁₈₈₉ | L_{b88} |
| 301 | Lₐ₅ | L_{b122} | 302 | Lₐ₂₁ | L_{b122} |
| 303 | Lₐ₃₅ | L_{b122} | 304 | Lₐ₆₆ | L_{b122} |
| 305 | Lₐ₆₉ | L_{b122} | 306 | Lₐ₇₀ | L_{b122} |
| 307 | Lₐ₇₄ | L_{b122} | 308 | Lₐ₁₂₁ | L_{b122} |
| 309 | Lₐ₁₄₈ | L_{b122} | 310 | Lₐ₁₇₅ | L_{b122} |
| 311 | Lₐ₂₀₇ | L_{b122} | 312 | Lₐ₂₁₂ | L_{b122} |
| 313 | Lₐ₂₃₆ | L_{b122} | 314 | Lₐ₂₅₅ | L_{b122} |
| 315 | Lₐ₂₇₁ | L_{b122} | 316 | Lₐ₂₈₇ | L_{b122} |
| 317 | Lₐ₃₁₉ | L_{b122} | 318 | Lₐ₃₂₀ | L_{b122} |
| 319 | Lₐ₃₃₅ | L_{b122} | 320 | Lₐ₃₉₉ | L_{b122} |
| 321 | Lₐ₄₃₈ | L_{b122} | 322 | Lₐ₄₅₃ | L_{b122} |
| 323 | Lₐ₄₆₉ | L_{b122} | 324 | Lₐ₄₉₇ | L_{b122} |
| 325 | Lₐ₅₀₀ | L_{b122} | 326 | Lₐ₅₂₉ | L_{b122} |
| 327 | Lₐ₆₀₁ | L_{b122} | 328 | Lₐ₆₀₆ | L_{b122} |
| 329 | Lₐ₆₃₇ | L_{b122} | 330 | Lₐ₆₆₅ | L_{b122} |
| 331 | Lₐ₆₈₉ | L_{b122} | 332 | Lₐ₆₉₉ | L_{b122} |
| 333 | Lₐ₇₀₀ | L_{b122} | 334 | Lₐ₇₄₄ | L_{b122} |
| 335 | Lₐ₇₇₇ | L_{b122} | 336 | Lₐ₇₉₃ | L_{b122} |
| 337 | Lₐ₈₁₀ | L_{b122} | 338 | Lₐ₈₄₂ | L_{b122} |
| 339 | Lₐ₈₅₀ | L_{b122} | 340 | Lₐ₉₁₇ | L_{b122} |
| 341 | Lₐ₉₈₂ | L_{b122} | 342 | Lₐ₉₈₉ | L_{b122} |
| 343 | Lₐ₁₀₁₆ | L_{b122} | 344 | Lₐ₁₀₃₁ | L_{b122} |
| 345 | Lₐ₁₀₄₇ | L_{b122} | 346 | Lₐ₁₀₇₉ | L_{b122} |
| 347 | Lₐ₁₁₆₃ | L_{b122} | 348 | Lₐ₁₁₉₁ | L_{b122} |
| 349 | Lₐ₁₁₉₈ | L_{b122} | 350 | Lₐ₁₂₃₆ | L_{b122} |
| 351 | Lₐ₁₂₄₇ | L_{b122} | 352 | Lₐ₁₂₇₆ | L_{b122} |
| 353 | Lₐ₁₃₁₃ | L_{b122} | 354 | Lₐ₁₃₃₆ | L_{b122} |
| 355 | Lₐ₁₃₄₁ | L_{b122} | 356 | Lₐ₁₃₆₄ | L_{b122} |
| 357 | Lₐ₁₃₉₅ | L_{b122} | 358 | Lₐ₁₄₃₇ | L_{b122} |
| 359 | Lₐ₁₄₅₄ | L_{b122} | 360 | Lₐ₁₄₅₅ | L_{b122} |
| 361 | Lₐ₁₄₈₀ | L_{b122} | 362 | Lₐ₁₄₈₇ | L_{b122} |
| 363 | Lₐ₁₄₉₂ | L_{b122} | 364 | Lₐ₁₅₁₀ | L_{b122} |
| 365 | Lₐ₁₅₂₃ | L_{b122} | 366 | Lₐ₁₅₃₁ | L_{b122} |
| 367 | Lₐ₁₅₇₁ | L_{b122} | 368 | Lₐ₁₅₉₁ | L_{b122} |
| 369 | Lₐ₁₆₀₈ | L_{b122} | 370 | Lₐ₁₆₀₉ | L_{b122} |
| 371 | Lₐ₁₆₂₉ | L_{b122} | 372 | Lₐ₁₆₃₀ | L_{b122} |
| 373 | Lₐ₁₆₃₈ | L_{b122} | 374 | Lₐ₁₆₈₈ | L_{b122} |
| 375 | Lₐ₁₇₀₂ | L_{b122} | 376 | Lₐ₁₇₁₇ | L_{b122} |
| 377 | Lₐ₁₇₂₃ | L_{b122} | 378 | Lₐ₁₇₅₃ | L_{b122} |
| 379 | Lₐ₁₇₆₁ | L_{b122} | 380 | Lₐ₁₈₁₃ | L_{b122} |
| 381 | Lₐ₁₈₁₅ | L_{b122} | 382 | Lₐ₁₈₁₉ | L_{b122} |
| 383 | Lₐ₁₈₂₃ | L_{b122} | 384 | Lₐ₁₈₂₉ | L_{b122} |
| 385 | Lₐ₁₈₃₃ | L_{b122} | 386 | Lₐ₁₈₃₉ | L_{b122} |
| 387 | Lₐ₁₈₄₃ | L_{b122} | 388 | Lₐ₁₈₄₉ | L_{b122} |
| 389 | Lₐ₁₈₅₃ | L_{b122} | 390 | Lₐ₁₈₅₅ | L_{b122} |
| 391 | Lₐ₁₈₅₉ | L_{b122} | 392 | Lₐ₁₈₆₃ | L_{b122} |
| 393 | Lₐ₁₈₆₅ | L_{b122} | 394 | Lₐ₁₈₆₉ | L_{b122} |
| 395 | Lₐ₁₈₇₃ | L_{b122} | 396 | Lₐ₁₈₇₅ | L_{b122} |
| 397 | Lₐ₁₈₇₉ | L_{b122} | 398 | Lₐ₁₈₈₃ | L_{b122} |
| 399 | Lₐ₁₈₈₅ | L_{b122} | 400 | Lₐ₁₈₈₉ | L_{b122} |
| 401 | Lₐ₅ | L_{b126} | 402 | Lₐ₂₁ | L_{b126} |
| 403 | Lₐ₃₅ | L_{b126} | 404 | Lₐ₆₆ | L_{b126} |
| 405 | Lₐ₆₉ | L_{b126} | 406 | Lₐ₇₀ | L_{b126} |
| 407 | Lₐ₇₄ | L_{b126} | 408 | Lₐ₁₂₁ | L_{b126} |
| 409 | Lₐ₁₄₈ | L_{b126} | 410 | Lₐ₁₇₅ | L_{b126} |
| 411 | Lₐ₂₀₇ | L_{b126} | 412 | Lₐ₂₁₂ | L_{b126} |
| 413 | Lₐ₂₃₆ | L_{b126} | 414 | Lₐ₂₅₅ | L_{b126} |
| 415 | Lₐ₂₇₁ | L_{b126} | 416 | Lₐ₂₈₇ | L_{b126} |
| 417 | Lₐ₃₁₉ | L_{b126} | 418 | Lₐ₃₂₀ | L_{b126} |
| 419 | Lₐ₃₃₅ | L_{b126} | 420 | Lₐ₃₉₉ | L_{b126} |
| 421 | Lₐ₄₃₈ | L_{b126} | 422 | Lₐ₄₅₃ | L_{b126} |
| 423 | Lₐ₄₆₉ | L_{b126} | 424 | Lₐ₄₉₇ | L_{b126} |
| 425 | Lₐ₅₀₀ | L_{b126} | 426 | Lₐ₅₂₉ | L_{b126} |
| 427 | Lₐ₆₀₁ | L_{b126} | 428 | Lₐ₆₀₆ | L_{b126} |
| 429 | Lₐ₆₃₇ | L_{b126} | 430 | Lₐ₆₆₅ | L_{b126} |
| 431 | Lₐ₆₈₉ | L_{b126} | 432 | Lₐ₆₉₉ | L_{b126} |
| 433 | Lₐ₇₀₀ | L_{b126} | 434 | Lₐ₇₄₄ | L_{b126} |
| 435 | Lₐ₇₇₇ | L_{b126} | 436 | Lₐ₇₉₃ | L_{b126} |
| 437 | Lₐ₈₁₀ | L_{b126} | 438 | Lₐ₈₄₂ | L_{b126} |
| 439 | Lₐ₈₅₀ | L_{b126} | 440 | Lₐ₉₁₇ | L_{b126} |
| 441 | Lₐ₉₈₂ | L_{b126} | 442 | Lₐ₉₈₉ | L_{b126} |
| 443 | Lₐ₁₀₁₆ | L_{b126} | 444 | Lₐ₁₀₃₁ | L_{b126} |
| 445 | Lₐ₁₀₄₇ | L_{b126} | 446 | Lₐ₁₀₇₉ | L_{b126} |
| 447 | Lₐ₁₁₆₃ | L_{b126} | 448 | Lₐ₁₁₉₁ | L_{b126} |
| 449 | Lₐ₁₁₉₈ | L_{b126} | 450 | Lₐ₁₂₃₆ | L_{b126} |
| 451 | Lₐ₁₂₄₇ | L_{b126} | 452 | Lₐ₁₂₇₆ | L_{b126} |
| 453 | Lₐ₁₃₁₃ | L_{b126} | 454 | Lₐ₁₃₃₆ | L_{b126} |
| 455 | Lₐ₁₃₄₁ | L_{b126} | 456 | Lₐ₁₃₆₄ | L_{b126} |
| 457 | Lₐ₁₃₉₅ | L_{b126} | 458 | Lₐ₁₄₃₇ | L_{b126} |
| 459 | Lₐ₁₄₅₄ | L_{b126} | 460 | Lₐ₁₄₅₅ | L_{b126} |
| 461 | Lₐ₁₄₈₀ | L_{b126} | 462 | Lₐ₁₄₈₇ | L_{b126} |
| 463 | Lₐ₁₄₉₂ | L_{b126} | 464 | Lₐ₁₅₁₀ | L_{b126} |
| 465 | Lₐ₁₅₂₃ | L_{b126} | 466 | Lₐ₁₅₃₁ | L_{b126} |
| 467 | Lₐ₁₅₇₁ | L_{b126} | 468 | Lₐ₁₅₉₁ | L_{b126} |
| 469 | Lₐ₁₆₀₈ | L_{b126} | 470 | Lₐ₁₆₀₉ | L_{b126} |
| 471 | Lₐ₁₆₂₉ | L_{b126} | 472 | Lₐ₁₆₃₀ | L_{b126} |
| 473 | Lₐ₁₆₃₈ | L_{b126} | 474 | Lₐ₁₆₈₈ | L_{b126} |
| 475 | Lₐ₁₇₀₂ | L_{b126} | 476 | Lₐ₁₇₁₇ | L_{b126} |
| 477 | Lₐ₁₇₂₃ | L_{b126} | 478 | Lₐ₁₇₅₃ | L_{b126} |
| 479 | Lₐ₁₇₆₁ | L_{b126} | 480 | Lₐ₁₈₁₃ | L_{b126} |
| 481 | Lₐ₁₈₁₅ | L_{b126} | 482 | Lₐ₁₈₁₉ | L_{b126} |
| 483 | Lₐ₁₈₂₃ | L_{b126} | 484 | Lₐ₁₈₂₉ | L_{b126} |
| 485 | Lₐ₁₈₃₃ | L_{b126} | 486 | Lₐ₁₈₃₉ | L_{b126} |
| 487 | Lₐ₁₈₄₃ | L_{b126} | 488 | Lₐ₁₈₄₉ | L_{b126} |
| 489 | Lₐ₁₈₅₃ | L_{b126} | 490 | Lₐ₁₈₅₅ | L_{b126} |
| 491 | Lₐ₁₈₅₉ | L_{b126} | 492 | Lₐ₁₈₆₃ | L_{b126} |
| 493 | Lₐ₁₈₆₅ | L_{b126} | 494 | Lₐ₁₈₆₉ | L_{b126} |
| 495 | Lₐ₁₈₇₃ | L_{b126} | 496 | Lₐ₁₈₇₅ | L_{b126} |
| 497 | Lₐ₁₈₇₉ | L_{b126} | 498 | Lₐ₁₈₈₃ | L_{b126} |
| 499 | Lₐ₁₈₈₅ | L_{b126} | 500 | Lₐ₁₈₈₉ | L_{b126} |
| 501 | Lₐ₅ | L_{b135} | 502 | Lₐ₂₁ | L_{b135} |
| 503 | Lₐ₃₅ | L_{b135} | 504 | Lₐ₆₆ | L_{b135} |
| 505 | Lₐ₆₉ | L_{b135} | 506 | Lₐ₇₀ | L_{b135} |
| 507 | Lₐ₇₄ | L_{b135} | 508 | Lₐ₁₂₁ | L_{b135} |
| 509 | Lₐ₁₄₈ | L_{b135} | 510 | Lₐ₁₇₅ | L_{b135} |
| 511 | Lₐ₂₀₇ | L_{b135} | 512 | Lₐ₂₁₂ | L_{b135} |
| 513 | Lₐ₂₃₆ | L_{b135} | 514 | Lₐ₂₅₅ | L_{b135} |
| 515 | Lₐ₂₇₁ | L_{b135} | 516 | Lₐ₂₈₇ | L_{b135} |
| 517 | Lₐ₃₁₉ | L_{b135} | 518 | Lₐ₃₂₀ | L_{b135} |
| 519 | Lₐ₃₃₅ | L_{b135} | 520 | Lₐ₃₉₉ | L_{b135} |
| 521 | Lₐ₄₃₈ | L_{b135} | 522 | Lₐ₄₅₃ | L_{b135} |
| 523 | Lₐ₄₆₉ | L_{b135} | 524 | Lₐ₄₉₇ | L_{b135} |
| 525 | Lₐ₅₀₀ | L_{b135} | 526 | Lₐ₅₂₉ | L_{b135} |
| 527 | Lₐ₆₀₁ | L_{b135} | 528 | Lₐ₆₀₆ | L_{b135} |
| 529 | Lₐ₆₃₇ | L_{b135} | 530 | Lₐ₆₆₅ | L_{b135} |
| 531 | Lₐ₆₈₉ | L_{b135} | 532 | Lₐ₆₉₉ | L_{b135} |
| 533 | Lₐ₇₀₀ | L_{b135} | 534 | Lₐ₇₄₄ | L_{b135} |
| 535 | Lₐ₇₇₇ | L_{b135} | 536 | Lₐ₇₉₃ | L_{b135} |
| 537 | Lₐ₈₁₀ | L_{b135} | 538 | Lₐ₈₄₂ | L_{b135} |
| 539 | Lₐ₈₅₀ | L_{b135} | 540 | Lₐ₉₁₇ | L_{b135} |
| 541 | Lₐ₉₈₂ | L_{b135} | 542 | Lₐ₉₈₉ | L_{b135} |
| 543 | Lₐ₁₀₁₆ | L_{b135} | 544 | Lₐ₁₀₃₁ | L_{b135} |
| 545 | Lₐ₁₀₄₇ | L_{b135} | 546 | Lₐ₁₀₇₉ | L_{b135} |
| 547 | Lₐ₁₁₆₃ | L_{b135} | 548 | Lₐ₁₁₉₁ | L_{b135} |
| 549 | Lₐ₁₁₉₈ | L_{b135} | 550 | Lₐ₁₂₃₆ | L_{b135} |
| 551 | Lₐ₁₂₄₇ | L_{b135} | 552 | Lₐ₁₂₇₆ | L_{b135} |
| 553 | Lₐ₁₃₁₃ | L_{b135} | 554 | Lₐ₁₃₃₆ | L_{b135} |
| 555 | Lₐ₁₃₄₁ | L_{b135} | 556 | Lₐ₁₃₆₄ | L_{b135} |
| 557 | Lₐ₁₃₉₅ | L_{b135} | 558 | Lₐ₁₄₃₇ | L_{b135} |
| 559 | Lₐ₁₄₅₄ | L_{b135} | 560 | Lₐ₁₄₅₅ | L_{b135} |
| 561 | Lₐ₁₄₈₀ | L_{b135} | 562 | Lₐ₁₄₈₇ | L_{b135} |
| 563 | Lₐ₁₄₉₂ | L_{b135} | 564 | Lₐ₁₅₁₀ | L_{b135} |
| 565 | Lₐ₁₅₂₃ | L_{b135} | 566 | Lₐ₁₅₃₁ | L_{b135} |
| 567 | Lₐ₁₅₇₁ | L_{b135} | 568 | Lₐ₁₅₉₁ | L_{b135} |
| 569 | Lₐ₁₆₀₈ | L_{b135} | 570 | Lₐ₁₆₀₉ | L_{b135} |
| 571 | Lₐ₁₆₂₉ | L_{b135} | 572 | Lₐ₁₆₃₀ | L_{b135} |
| 573 | Lₐ₁₆₃₈ | L_{b135} | 574 | Lₐ₁₆₈₈ | L_{b135} |
| 575 | Lₐ₁₇₀₂ | L_{b135} | 576 | Lₐ₁₇₁₇ | L_{b135} |
| 577 | Lₐ₁₇₂₃ | L_{b135} | 578 | Lₐ₁₇₅₃ | L_{b135} |
| 579 | Lₐ₁₇₆₁ | L_{b135} | 580 | Lₐ₁₈₁₃ | L_{b135} |
| 581 | Lₐ₁₈₁₅ | L_{b135} | 582 | Lₐ₁₈₁₉ | L_{b135} |
| 583 | Lₐ₁₈₂₃ | L_{b135} | 584 | Lₐ₁₈₂₉ | L_{b135} |
| 585 | Lₐ₁₈₃₃ | L_{b135} | 586 | Lₐ₁₈₃₉ | L_{b135} |
| 587 | Lₐ₁₈₄₃ | L_{b135} | 588 | Lₐ₁₈₄₉ | L_{b135} |
| 589 | Lₐ₁₈₅₃ | L_{b135} | 590 | Lₐ₁₈₅₅ | L_{b135} |
| 591 | Lₐ₁₈₅₉ | L_{b135} | 592 | Lₐ₁₈₆₃ | L_{b135} |
| 593 | Lₐ₁₈₆₅ | L_{b135} | 594 | Lₐ₁₈₆₉ | L_{b135} |
| 595 | Lₐ₁₈₇₃ | L_{b135} | 596 | Lₐ₁₈₇₅ | L_{b135} |
| 597 | Lₐ₁₈₇₉ | L_{b135} | 598 | Lₐ₁₈₈₃ | L_{b135} |
| 599 | Lₐ₁₈₈₅ | L_{b135} | 600 | Lₐ₁₈₈₉ | L_{b135} |
| 601 | Lₐ₅ | L_{b165} | 602 | Lₐ₂₁ | L_{b165} |
| 603 | Lₐ₃₅ | L_{b165} | 604 | Lₐ₆₆ | L_{b165} |
| 605 | Lₐ₆₉ | L_{b165} | 606 | Lₐ₇₀ | L_{b165} |
| 607 | Lₐ₇₄ | L_{b165} | 608 | Lₐ₁₂₁ | L_{b165} |
| 609 | Lₐ₁₄₈ | L_{b165} | 610 | Lₐ₁₇₅ | L_{b165} |
| 611 | Lₐ₂₀₇ | L_{b165} | 612 | Lₐ₂₁₂ | L_{b165} |
| 613 | Lₐ₂₃₆ | L_{b165} | 614 | Lₐ₂₅₅ | L_{b165} |
| 615 | Lₐ₂₇₁ | L_{b165} | 616 | Lₐ₂₈₇ | L_{b165} |
| 617 | Lₐ₃₁₉ | L_{b165} | 618 | Lₐ₃₂₀ | L_{b165} |
| 619 | Lₐ₃₃₅ | L_{b165} | 620 | Lₐ₃₉₉ | L_{b165} |
| 621 | Lₐ₄₃₈ | L_{b165} | 622 | Lₐ₄₅₃ | L_{b165} |
| 623 | Lₐ₄₆₉ | L_{b165} | 624 | Lₐ₄₉₇ | L_{b165} |
| 625 | Lₐ₅₀₀ | L_{b165} | 626 | Lₐ₅₂₉ | L_{b165} |
| 627 | Lₐ₆₀₁ | L_{b165} | 628 | Lₐ₆₀₆ | L_{b165} |
| 629 | Lₐ₆₃₇ | L_{b165} | 630 | Lₐ₆₆₅ | L_{b165} |
| 631 | Lₐ₆₈₉ | L_{b165} | 632 | Lₐ₆₉₉ | L_{b165} |
| 633 | Lₐ₇₀₀ | L_{b165} | 634 | Lₐ₇₄₄ | L_{b165} |
| 635 | Lₐ₇₇₇ | L_{b165} | 636 | Lₐ₇₉₃ | L_{b165} |
| 637 | Lₐ₈₁₀ | L_{b165} | 638 | Lₐ₈₄₂ | L_{b165} |
| 639 | Lₐ₈₅₀ | L_{b165} | 640 | Lₐ₉₁₇ | L_{b165} |
| 641 | Lₐ₉₈₂ | L_{b165} | 642 | Lₐ₉₈₉ | L_{b165} |
| 643 | Lₐ₁₀₁₆ | L_{b165} | 644 | Lₐ₁₀₃₁ | L_{b165} |
| 645 | Lₐ₁₀₄₇ | L_{b165} | 646 | Lₐ₁₀₇₉ | L_{b165} |
| 647 | Lₐ₁₁₆₃ | L_{b165} | 648 | Lₐ₁₁₉₁ | L_{b165} |
| 649 | Lₐ₁₁₉₈ | L_{b165} | 650 | Lₐ₁₂₃₆ | L_{b165} |
| 651 | Lₐ₁₂₄₇ | L_{b165} | 652 | Lₐ₁₂₇₆ | L_{b165} |
| 653 | Lₐ₁₃₁₃ | L_{b165} | 654 | Lₐ₁₃₃₆ | L_{b165} |
| 655 | Lₐ₁₃₄₁ | L_{b165} | 656 | Lₐ₁₃₆₄ | L_{b165} |
| 657 | Lₐ₁₃₉₅ | L_{b165} | 658 | Lₐ₁₄₃₇ | L_{b165} |
| 659 | Lₐ₁₄₅₄ | L_{b165} | 660 | Lₐ₁₄₅₅ | L_{b165} |
| 661 | Lₐ₁₄₈₀ | L_{b165} | 662 | Lₐ₁₄₈₇ | L_{b165} |
| 663 | Lₐ₁₄₉₂ | L_{b165} | 664 | Lₐ₁₅₁₀ | L_{b165} |
| 665 | Lₐ₁₅₂₃ | L_{b165} | 666 | Lₐ₁₅₃₁ | L_{b165} |
| 667 | Lₐ₁₅₇₁ | L_{b165} | 668 | Lₐ₁₅₉₁ | L_{b165} |
| 669 | Lₐ₁₆₀₈ | L_{b165} | 670 | Lₐ₁₆₀₉ | L_{b165} |
| 671 | Lₐ₁₆₂₉ | L_{b165} | 672 | Lₐ₁₆₃₀ | L_{b165} |
| 673 | Lₐ₁₆₃₈ | L_{b165} | 674 | Lₐ₁₆₈₈ | L_{b165} |
| 675 | Lₐ₁₇₀₂ | L_{b165} | 676 | Lₐ₁₇₁₇ | L_{b165} |
| 677 | Lₐ₁₇₂₃ | L_{b165} | 678 | Lₐ₁₇₅₃ | L_{b165} |
| 679 | Lₐ₁₇₆₁ | L_{b165} | 680 | Lₐ₁₈₁₃ | L_{b165} |
| 681 | Lₐ₁₈₁₅ | L_{b165} | 682 | Lₐ₁₈₁₉ | L_{b165} |
| 683 | Lₐ₁₈₂₃ | L_{b165} | 684 | Lₐ₁₈₂₉ | L_{b165} |
| 685 | Lₐ₁₈₃₃ | L_{b165} | 686 | Lₐ₁₈₃₉ | L_{b165} |
| 687 | Lₐ₁₈₄₃ | L_{b165} | 688 | Lₐ₁₈₄₉ | L_{b165} |
| 689 | Lₐ₁₈₅₃ | L_{b165} | 690 | Lₐ₁₈₅₅ | L_{b165} |
| 691 | Lₐ₁₈₅₉ | L_{b165} | 692 | Lₐ₁₈₆₃ | L_{b165} |
| 693 | Lₐ₁₈₆₅ | L_{b165} | 694 | Lₐ₁₈₆₉ | L_{b165} |
| 695 | Lₐ₁₈₇₃ | L_{b165} | 696 | Lₐ₁₈₇₅ | L_{b165} |
| 697 | Lₐ₁₈₇₉ | L_{b165} | 698 | Lₐ₁₈₈₃ | L_{b165} |
| 699 | Lₐ₁₈₈₅ | L_{b165} | 700 | Lₐ₁₈₈₉ | L_{b165} |
| 701 | Lₐ₅ | L_{b212} | 702 | Lₐ₂₁ | L_{b212} |
| 703 | Lₐ₃₅ | L_{b212} | 704 | Lₐ₆₆ | L_{b212} |
| 705 | Lₐ₆₉ | L_{b212} | 706 | Lₐ₇₀ | L_{b212} |
| 707 | Lₐ₇₄ | L_{b212} | 708 | Lₐ₁₂₁ | L_{b212} |
| 709 | Lₐ₁₄₈ | L_{b212} | 710 | Lₐ₁₇₅ | L_{b212} |
| 711 | Lₐ₂₀₇ | L_{b212} | 712 | Lₐ₂₁₂ | L_{b212} |
| 713 | Lₐ₂₃₆ | L_{b212} | 714 | Lₐ₂₅₅ | L_{b212} |
| 715 | Lₐ₂₇₁ | L_{b212} | 716 | Lₐ₂₈₇ | L_{b212} |
| 717 | Lₐ₃₁₉ | L_{b212} | 718 | Lₐ₃₂₀ | L_{b212} |
| 719 | Lₐ₃₃₅ | L_{b212} | 720 | Lₐ₃₉₉ | L_{b212} |
| 721 | Lₐ₄₃₈ | L_{b212} | 722 | Lₐ₄₅₃ | L_{b212} |
| 723 | Lₐ₄₆₉ | L_{b212} | 724 | Lₐ₄₉₇ | L_{b212} |
| 725 | Lₐ₅₀₀ | L_{b212} | 726 | Lₐ₅₂₉ | L_{b212} |
| 727 | Lₐ₆₀₁ | L_{b212} | 728 | Lₐ₆₀₆ | L_{b212} |
| 729 | Lₐ₆₃₇ | L_{b212} | 730 | Lₐ₆₆₅ | L_{b212} |
| 731 | Lₐ₆₈₉ | L_{b212} | 732 | Lₐ₆₉₉ | L_{b212} |
| 733 | Lₐ₇₀₀ | L_{b212} | 734 | Lₐ₇₄₄ | L_{b212} |
| 735 | Lₐ₇₇₇ | L_{b212} | 736 | Lₐ₇₉₃ | L_{b212} |
| 737 | Lₐ₈₁₀ | L_{b212} | 738 | Lₐ₈₄₂ | L_{b212} |
| 739 | Lₐ₈₅₀ | L_{b212} | 740 | Lₐ₉₁₇ | L_{b212} |
| 741 | Lₐ₉₈₂ | L_{b212} | 742 | Lₐ₉₈₉ | L_{b212} |
| 743 | Lₐ₁₀₁₆ | L_{b212} | 744 | Lₐ₁₀₃₁ | L_{b212} |
| 745 | Lₐ₁₀₄₇ | L_{b212} | 746 | Lₐ₁₀₇₉ | L_{b212} |
| 747 | Lₐ₁₁₆₃ | L_{b212} | 748 | Lₐ₁₁₉₁ | L_{b212} |
| 749 | Lₐ₁₁₉₈ | L_{b212} | 750 | Lₐ₁₂₃₆ | L_{b212} |
| 751 | Lₐ₁₂₄₇ | L_{b212} | 752 | Lₐ₁₂₇₆ | L_{b212} |
| 753 | Lₐ₁₃₁₃ | L_{b212} | 754 | Lₐ₁₃₃₆ | L_{b212} |
| 755 | Lₐ₁₃₄₁ | L_{b212} | 756 | Lₐ₁₃₆₄ | L_{b212} |
| 757 | Lₐ₁₃₉₅ | L_{b212} | 758 | Lₐ₁₄₃₇ | L_{b212} |
| 759 | Lₐ₁₄₅₄ | L_{b212} | 760 | Lₐ₁₄₅₅ | L_{b212} |
| 761 | Lₐ₁₄₈₀ | L_{b212} | 762 | Lₐ₁₄₈₇ | L_{b212} |
| 763 | Lₐ₁₄₉₂ | L_{b212} | 764 | Lₐ₁₅₁₀ | L_{b212} |
| 765 | Lₐ₁₅₂₃ | L_{b212} | 766 | Lₐ₁₅₃₁ | L_{b212} |
| 767 | Lₐ₁₅₇₁ | L_{b212} | 768 | Lₐ₁₅₉₁ | L_{b212} |
| 769 | Lₐ₁₆₀₈ | L_{b212} | 770 | Lₐ₁₆₀₉ | L_{b212} |
| 771 | Lₐ₁₆₂₉ | L_{b212} | 772 | Lₐ₁₆₃₀ | L_{b212} |
| 773 | Lₐ₁₆₃₈ | L_{b212} | 774 | Lₐ₁₆₈₈ | L_{b212} |
| 775 | Lₐ₁₇₀₂ | L_{b212} | 776 | Lₐ₁₇₁₇ | L_{b212} |
| 777 | Lₐ₁₇₂₃ | L_{b212} | 778 | Lₐ₁₇₅₃ | L_{b212} |
| 779 | Lₐ₁₇₆₁ | L_{b212} | 780 | Lₐ₁₈₁₃ | L_{b212} |
| 781 | Lₐ₁₈₁₅ | L_{b212} | 782 | Lₐ₁₈₁₉ | L_{b212} |
| 783 | Lₐ₁₈₂₃ | L_{b212} | 784 | Lₐ₁₈₂₉ | L_{b212} |
| 785 | Lₐ₁₈₃₃ | L_{b212} | 786 | Lₐ₁₈₃₉ | L_{b212} |
| 787 | Lₐ₁₈₄₃ | L_{b212} | 788 | Lₐ₁₈₄₉ | L_{b212} |
| 789 | Lₐ₁₈₅₃ | L_{b212} | 790 | Lₐ₁₈₅₅ | L_{b212} |
| 791 | Lₐ₁₈₅₉ | L_{b212} | 792 | Lₐ₁₈₆₃ | L_{b212} |
| 793 | Lₐ₁₈₆₅ | L_{b212} | 794 | Lₐ₁₈₆₉ | L_{b212} |
| 795 | Lₐ₁₈₇₃ | L_{b212} | 796 | Lₐ₁₈₇₅ | L_{b212} |
| 797 | Lₐ₁₈₇₉ | L_{b212} | 798 | Lₐ₁₈₈₃ | L_{b212} |
| 799 | Lₐ₁₈₈₅ | L_{b212} | 800 | Lₐ₁₈₈₉ | L_{b212} |
; wobei Verbindung 801 bis Verbindung 1010 jeweils eine Struktur von Ir(Lₐ)₂(L_{b}) haben, wobei die beiden Lₐ unterschiedlich sind und die beiden Lₐ und L_{b} jeweils aus den in der folgenden Tabelle aufgeführten Strukturen ausgewählt sind:
| Verbindung Nr. | Lₐ | Lₐ | L_{b} | Verbindung Nr. | Lₐ | Lₐ | L_{b} |
|---|---|---|---|---|---|---|---|
| 801 | Lₐ₉₈₂ | Lₐ₆₉ | L_{b31} | 802 | Lₐ₉₈₂ | Lₐ₂₀₇ | L_{b31} |
| 803 | Lₐ₉₈₂ | Lₐ₃₁₉ | L_{b31} | 804 | Lₐ₉₈₂ | Lₐ₃₉₉ | L_{b31} |
| 805 | Lₐ₉₈₂ | Lₐ₈₄₂ | L_{b31} | 806 | Lₐ₉₈₂ | Lₐ₁₄₃₇ | L_{b31} |
| 807 | Lₐ₉₈₂ | Lₐ₁₅₇₁ | L_{b31} | 808 | Lₐ₉₈₂ | Lₐ₁₆₈₈ | L_{b31} |
| 809 | Lₐ₉₈₂ | Lₐ₉₈₉ | L_{b31} | 810 | Lₐ₉₈₂ | Lₐ₁₈₁₃ | L_{b31} |
| 811 | Lₐ₉₈₂ | Lₐ₈₄₂ | L_{b31} | 812 | Lₐ₁₈₈₉ | Lₐ₁₈₁₉ | L_{b31} |
| 813 | Lₐ₉₈₂ | Lₐ₁₈₄₉ | L_{b31} | 814 | Lₐ₉₈₂ | Lₐ₁₈₆₅ | L_{b31} |
| 815 | Lₐ₉₈₂ | Lₐ₁₈₇₅ | L_{b31} | 816 | Lₐ₃₁₉ | Lₐ₁₈₆₉ | L_{b31} |
| 817 | Lₐ₂₁₂ | Lₐ₁₅₇₁ | L_{b31} | 818 | Lₐ₁₆₈₈ | Lₐ₁₈₆₅ | L_{b31} |
| 819 | Lₐ₁₄₃₇ | Lₐ₁₈₂₉ | L_{b31} | 820 | Lₐ₁₈₆₅ | Lₐ₁₈₈₅ | L_{b31} |
| 821 | Lₐ₁₅₇₁ | Lₐ₁₈₅₅ | L_{b31} | 822 | Lₐ₉₈₉ | Lₐ₁₈₇₃ | L_{b31} |
| 823 | Lₐ₈₄₂ | Lₐ₁₃₈₄ | L_{b31} | 824 | Lₐ₁₈₃₃ | Lₐ₁₈₈₉ | L_{b31} |
| 825 | Lₐ₁₈₆₉ | Lₐ₂₄ | L_{b31} | 826 | Lₐ₁₈₈₉ | Lₐ₁₃₄ | L_{b31} |
| 827 | Lₐ₁₄₃₇ | Lₐ₂₁₂ | L_{b31} | 828 | Lₐ₁₄₃₇ | Lₐ₂₀₇ | L_{b31} |
| 829 | Lₐ₁₈₁₉ | Lₐ₁₈₂₃ | L_{b31} | 830 | Lₐ₁₈₆₃ | Lₐ₁₈₆₅ | L_{b31} |
| 831 | Lₐ₉₈₂ | Lₐ₆₉ | L_{b88} | 832 | Lₐ₉₈₂ | Lₐ₂₀₇ | L_{b88} |
| 833 | Lₐ₉₈₂ | Lₐ₃₁₉ | L_{b88} | 834 | Lₐ₉₈₂ | Lₐ₃₉₉ | L_{b88} |
| 835 | Lₐ₉₈₂ | Lₐ₈₄₂ | L_{b88} | 836 | Lₐ₉₈₂ | Lₐ₁₄₃₇ | L_{b88} |
| 837 | Lₐ₉₈₂ | Lₐ₁₅₇₁ | L_{b88} | 838 | Lₐ₉₈₂ | Lₐ₁₆₈₈ | L_{b88} |
| 839 | Lₐ₉₈₂ | Lₐ₉₈₉ | L_{b88} | 840 | Lₐ₉₈₂ | Lₐ₁₈₁₃ | L_{b88} |
| 841 | Lₐ₉₈₂ | Lₐ₈₄₂ | L_{b88} | 842 | Lₐ₁₈₈₉ | Lₐ₁₈₁₉ | L_{b88} |
| 843 | Lₐ₉₈₂ | Lₐ₁₈₄₉ | L_{b88} | 844 | Lₐ₉₈₂ | Lₐ₁₈₆₅ | L_{b88} |
| 845 | Lₐ₉₈₂ | Lₐ₁₈₇₅ | L_{b88} | 846 | Lₐ₃₁₉ | Lₐ₁₈₆₉ | L_{b88} |
| 847 | Lₐ₂₁₂ | Lₐ₁₅₇₁ | L_{b88} | 848 | Lₐ₁₆₈₈ | Lₐ₁₈₆₅ | L_{b88} |
| 849 | Lₐ₁₄₃₇ | Lₐ₁₈₂₉ | L_{b88} | 850 | Lₐ₁₈₆₅ | Lₐ₁₈₈₅ | L_{b88} |
| 851 | Lₐ₁₅₇₁ | Lₐ₁₈₅₅ | L_{b88} | 852 | Lₐ₉₈₉ | Lₐ₁₈₇₃ | L_{b88} |
| 853 | Lₐ₈₄₂ | Lₐ₁₃₈₄ | L_{b88} | 854 | Lₐ₁₈₃₃ | Lₐ₁₈₈₉ | L_{b88} |
| 855 | Lₐ₁₈₆₉ | Lₐ₂₄ | L_{b88} | 856 | Lₐ₁₈₈₉ | Lₐ₁₃₄ | L_{b88} |
| 857 | Lₐ₁₄₃₇ | Lₐ₂₁₂ | L_{b88} | 858 | Lₐ₁₄₃₇ | Lₐ₂₀₇ | L_{b88} |
| 859 | Lₐ₁₈₁₉ | Lₐ₁₈₂₃ | L_{b88} | 860 | Lₐ₁₈₆₃ | Lₐ₁₈₆₅ | L_{b88} |
| 861 | Lₐ₉₈₂ | Lₐ₆₉ | L_{b122} | 862 | Lₐ₉₈₂ | Lₐ₂₀₇ | L_{b122} |
| 863 | Lₐ₉₈₂ | Lₐ₃₁₉ | L_{b122} | 864 | Lₐ₉₈₂ | Lₐ₃₉₉ | L_{b122} |
| 865 | Lₐ₉₈₂ | Lₐ₈₄₂ | L_{b122} | 866 | Lₐ₉₈₂ | Lₐ₁₄₃₇ | L_{b122} |
| 867 | Lₐ₉₈₂ | Lₐ₁₅₇₁ | L_{b122} | 868 | Lₐ₉₈₂ | Lₐ₁₆₈₈ | L_{b122} |
| 869 | Lₐ₉₈₂ | Lₐ₉₈₉ | L_{b122} | 870 | Lₐ₉₈₂ | Lₐ₁₈₁₃ | L_{b122} |
| 871 | Lₐ₉₈₂ | Lₐ₈₄₂ | L_{b122} | 872 | Lₐ₁₈₈₉ | Lₐ₁₈₁₉ | L_{b122} |
| 873 | Lₐ₉₈₂ | Lₐ₁₈₄₉ | L_{b122} | 874 | Lₐ₉₈₂ | Lₐ₁₈₆₅ | L_{b122} |
| 875 | Lₐ₉₈₂ | Lₐ₁₈₇₅ | L_{b122} | 876 | Lₐ₃₁₉ | Lₐ₁₈₆₉ | L_{b122} |
| 877 | Lₐ₂₁₂ | Lₐ₁₅₇₁ | L_{b122} | 878 | Lₐ₁₆₈₈ | Lₐ₁₈₆₅ | L_{b122} |
| 879 | Lₐ₁₄₃₇ | Lₐ₁₈₂₉ | L_{b122} | 880 | Lₐ₁₈₆₅ | Lₐ₁₈₈₅ | L_{b122} |
| 881 | Lₐ₁₅₇₁ | Lₐ₁₈₅₅ | L_{b122} | 882 | Lₐ₉₈₉ | Lₐ₁₈₇₃ | L_{b122} |
| 883 | Lₐ₈₄₂ | Lₐ₁₃₈₄ | L_{b122} | 884 | Lₐ₁₈₃₃ | Lₐ₁₈₈₉ | L_{b122} |
| 885 | Lₐ₁₈₆₉ | Lₐ₂₄ | L_{b122} | 886 | Lₐ₁₈₈₉ | Lₐ₁₃₄ | L_{b122} |
| 887 | Lₐ₁₄₃₇ | Lₐ₂₁₂ | L_{b122} | 888 | Lₐ₁₄₃₇ | Lₐ₂₀₇ | L_{b122} |
| 889 | Lₐ₁₈₁₉ | Lₐ₁₈₂₃ | L_{b122} | 890 | Lₐ₁₈₆₃ | Lₐ₁₈₆₅ | L_{b122} |
| 891 | Lₐ₉₈₂ | Lₐ₆₉ | L_{b126} | 892 | Lₐ₉₈₂ | Lₐ₂₀₇ | L_{b126} |
| 893 | Lₐ₉₈₂ | Lₐ₃₁₉ | L_{b126} | 894 | Lₐ₉₈₂ | Lₐ₃₉₉ | L_{b126} |
| 895 | Lₐ₉₈₂ | Lₐ₈₄₂ | L_{b126} | 896 | Lₐ₉₈₂ | Lₐ₁₄₃₇ | L_{b126} |
| 897 | Lₐ₉₈₂ | Lₐ₁₅₇₁ | L_{b126} | 898 | Lₐ₉₈₂ | Lₐ₁₆₈₈ | L_{b126} |
| 899 | Lₐ₉₈₂ | Lₐ₉₈₉ | L_{b126} | 900 | Lₐ₉₈₂ | Lₐ₁₈₁₃ | L_{b126} |
| 901 | Lₐ₉₈₂ | Lₐ₈₄₂ | L_{b126} | 902 | Lₐ₁₈₈₉ | Lₐ₁₈₁₉ | L_{b126} |
| 903 | Lₐ₉₈₂ | Lₐ₁₈₄₉ | L_{b126} | 904 | Lₐ₉₈₂ | Lₐ₁₈₆₅ | L_{b126} |
| 905 | Lₐ₉₈₂ | Lₐ₁₈₇₅ | L_{b126} | 906 | Lₐ₃₁₉ | Lₐ₁₈₆₉ | L_{b126} |
| 907 | Lₐ₂₁₂ | Lₐ₁₅₇₁ | L_{b126} | 908 | Lₐ₁₆₈₈ | Lₐ₁₈₆₅ | L_{b126} |
| 909 | Lₐ₁₄₃₇ | Lₐ₁₈₂₉ | L_{b126} | 910 | Lₐ₁₈₆₅ | Lₐ₁₈₈₅ | L_{b126} |
| 911 | Lₐ₁₅₇₁ | Lₐ₁₈₅₅ | L_{b126} | 912 | Lₐ₉₈₉ | Lₐ₁₈₇₃ | L_{b126} |
| 913 | Lₐ₈₄₂ | Lₐ₁₃₈₄ | L_{b126} | 914 | Lₐ₁₈₃₃ | Lₐ₁₈₈₉ | L_{b126} |
| 915 | Lₐ₁₈₆₉ | Lₐ₂₄ | L_{b126} | 916 | Lₐ₁₈₈₉ | Lₐ₁₃₄ | L_{b126} |
| 917 | Lₐ₁₄₃₇ | Lₐ₂₁₂ | L_{b126} | 918 | Lₐ₁₄₃₇ | Lₐ₂₀₇ | L_{b126} |
| 919 | Lₐ₁₈₁₉ | Lₐ₁₈₂₃ | L_{b126} | 920 | Lₐ₁₈₆₃ | Lₐ₁₈₆₅ | L_{b126} |
| 921 | Lₐ₉₈₂ | Lₐ₆₉ | L_{b135} | 922 | Lₐ₉₈₂ | Lₐ₂₀₇ | L_{b135} |
| 923 | Lₐ₉₈₂ | Lₐ₃₁₉ | L_{b135} | 924 | Lₐ₉₈₂ | Lₐ₃₉₉ | L_{b135} |
| 925 | Lₐ₉₈₂ | Lₐ₈₄₂ | L_{b135} | 926 | Lₐ₉₈₂ | Lₐ₁₄₃₇ | L_{b135} |
| 927 | Lₐ₉₈₂ | Lₐ₁₅₇₁ | L_{b135} | 928 | Lₐ₉₈₂ | Lₐ₁₆₈₈ | L_{b135} |
| 929 | Lₐ₉₈₂ | Lₐ₉₈₉ | L_{b135} | 930 | Lₐ₉₈₂ | Lₐ₁₈₁₃ | L_{b135} |
| 931 | Lₐ₉₈₂ | Lₐ₈₄₂ | L_{b135} | 932 | Lₐ₁₈₈₉ | Lₐ₁₈₁₉ | L_{b135} |
| 933 | Lₐ₉₈₂ | Lₐ₁₈₄₉ | L_{b135} | 934 | Lₐ₉₈₂ | Lₐ₁₈₆₅ | L_{b135} |
| 935 | Lₐ₉₈₂ | Lₐ₁₈₇₅ | L_{b135} | 936 | Lₐ₃₁₉ | Lₐ₁₈₆₉ | L_{b135} |
| 937 | Lₐ₂₁₂ | Lₐ₁₅₇₁ | L_{b135} | 938 | Lₐ₁₆₈₈ | Lₐ₁₈₆₅ | L_{b135} |
| 939 | Lₐ₁₄₃₇ | Lₐ₁₈₂₉ | L_{b135} | 940 | Lₐ₁₈₆₅ | Lₐ₁₈₈₅ | L_{b135} |
| 941 | Lₐ₁₅₇₁ | Lₐ₁₈₅₅ | L_{b135} | 942 | Lₐ₉₈₉ | Lₐ₁₈₇₃ | L_{b135} |
| 943 | Lₐ₈₄₂ | Lₐ₁₃₈₄ | L_{b135} | 944 | Lₐ₁₈₃₃ | Lₐ₁₈₈₉ | L_{b135} |
| 945 | Lₐ₁₈₆₉ | Lₐ₂₄ | L_{b135} | 946 | Lₐ₁₈₈₉ | Lₐ₁₃₄ | L_{b135} |
| 947 | Lₐ₁₄₃₇ | Lₐ₂₁₂ | L_{b135} | 948 | Lₐ₁₄₃₇ | Lₐ₂₀₇ | L_{b135} |
| 949 | Lₐ₁₈₁₉ | Lₐ₁₈₂₃ | L_{b135} | 950 | Lₐ₁₈₆₃ | Lₐ₁₈₆₅ | L_{b135} |
| 951 | Lₐ₉₈₂ | Lₐ₆₉ | L_{b165} | 952 | Lₐ₉₈₂ | Lₐ₂₀₇ | L_{b165} |
| 953 | Lₐ₉₈₂ | Lₐ₃₁₉ | L_{b165} | 954 | Lₐ₉₈₂ | Lₐ₃₉₉ | L_{b165} |
| 955 | Lₐ₉₈₂ | Lₐ₈₄₂ | L_{b165} | 956 | Lₐ₉₈₂ | Lₐ₁₄₃₇ | L_{b165} |
| 957 | Lₐ₉₈₂ | Lₐ₁₅₇₁ | L_{b165} | 958 | Lₐ₉₈₂ | Lₐ₁₆₈₈ | L_{b165} |
| 959 | Lₐ₉₈₂ | Lₐ₉₈₉ | L_{b165} | 960 | Lₐ₉₈₂ | Lₐ₁₈₁₃ | L_{b165} |
| 961 | Lₐ₉₈₂ | Lₐ₈₄₂ | L_{b165} | 962 | Lₐ₁₈₈₉ | Lₐ₁₈₁₉ | L_{b165} |
| 963 | Lₐ₉₈₂ | Lₐ₁₈₄₉ | L_{b165} | 964 | Lₐ₉₈₂ | Lₐ₁₈₆₅ | L_{b165} |
| 965 | Lₐ₉₈₂ | Lₐ₁₈₇₅ | L_{b165} | 966 | Lₐ₃₁₉ | Lₐ₁₈₆₉ | L_{b165} |
| 967 | Lₐ₂₁₂ | Lₐ₁₅₇₁ | L_{b165} | 968 | Lₐ₁₆₈₈ | Lₐ₁₈₆₅ | L_{b165} |
| 969 | Lₐ₁₄₃₇ | Lₐ₁₈₂₉ | L_{b165} | 970 | Lₐ₁₈₆₅ | Lₐ₁₈₈₅ | L_{b165} |
| 971 | Lₐ₁₅₇₁ | Lₐ₁₈₅₅ | L_{b165} | 972 | Lₐ₉₈₉ | Lₐ₁₈₇₃ | L_{b165} |
| 973 | Lₐ₈₄₂ | Lₐ₁₃₈₄ | L_{b165} | 974 | Lₐ₁₈₃₃ | Lₐ₁₈₈₉ | L_{b165} |
| 975 | Lₐ₁₈₆₉ | Lₐ₂₄ | L_{b165} | 976 | Lₐ₁₈₈₉ | Lₐ₁₃₄ | L_{b165} |
| 977 | Lₐ₁₄₃₇ | Lₐ₂₁₂ | L_{b165} | 978 | Lₐ₁₄₃₇ | Lₐ₂₀₇ | L_{b165} |
| 979 | Lₐ₁₈₁₉ | Lₐ₁₈₂₃ | L_{b165} | 980 | Lₐ₁₈₆₃ | Lₐ₁₈₆₅ | L_{b165} |
| 981 | Lₐ₉₈₂ | Lₐ₆₉ | L_{b212} | 982 | Lₐ₉₈₂ | Lₐ₂₀₇ | L_{b212} |
| 983 | Lₐ₉₈₂ | Lₐ₃₁₉ | L_{b212} | 984 | Lₐ₉₈₂ | Lₐ₃₉₉ | L_{b212} |
| 985 | Lₐ₉₈₂ | Lₐ₈₄₂ | L_{b212} | 986 | Lₐ₉₈₂ | Lₐ₁₄₃₇ | L_{b212} |
| 987 | Lₐ₉₈₂ | Lₐ₁₅₇₁ | L_{b212} | 988 | Lₐ₉₈₂ | Lₐ₁₆₈₈ | L_{b212} |
| 989 | Lₐ₉₈₂ | Lₐ₉₈₉ | L_{b212} | 990 | Lₐ₉₈₂ | Lₐ₁₈₁₃ | L_{b212} |
| 991 | Lₐ₉₈₂ | Lₐ₈₄₂ | L_{b212} | 992 | Lₐ₁₈₈₉ | Lₐ₁₈₁₉ | L_{b212} |
| 993 | Lₐ₉₈₂ | Lₐ₁₈₄₉ | L_{b212} | 994 | Lₐ₉₈₂ | Lₐ₁₈₆₅ | L_{b212} |
| 995 | Lₐ₉₈₂ | Lₐ₁₈₇₅ | L_{b212} | 996 | Lₐ₃₁₉ | Lₐ₁₈₆₉ | L_{b212} |
| 997 | Lₐ₂₁₂ | Lₐ₁₅₇₁ | L_{b212} | 998 | Lₐ₁₆₈₈ | Lₐ₁₈₆₅ | L_{b212} |
| 999 | Lₐ₁₄₃₇ | Lₐ₁₈₂₉ | L_{b212} | 1000 | Lₐ₁₈₆₅ | Lₐ₁₈₈₅ | L_{b212} |
| 1001 | Lₐ₁₅₇₁ | Lₐ₁₈₅₅ | L_{b212} | 1002 | Lₐ₉₈₉ | Lₐ₁₈₇₃ | L_{b212} |
| 1003 | Lₐ₈₄₂ | Lₐ₁₃₈₄ | L_{b212} | 1004 | Lₐ₁₈₃₃ | Lₐ₁₈₈₉ | L_{b212} |
| 1005 | Lₐ₁₈₆₉ | Lₐ₂₄ | L_{b212} | 1006 | Lₐ₁₈₈₉ | Lₐ₁₃₄ | L_{b212} |
| 1007 | Lₐ₁₄₃₇ | Lₐ₂₁₂ | L_{b212} | 1008 | Lₐ₁₄₃₇ | Lₐ₂₀₇ | L_{b212} |
| 1009 | Lₐ₁₈₁₉ | Lₐ₁₈₂₃ | L_{b212} | 1010 | Lₐ₁₈₆₃ | Lₐ₁₈₆₅ | L_{b212} |

15. Elektrolumineszenzvorrichtung umfassend:
eine Anode,
eine Kathode und
eine organische Schicht, die zwischen der Anode und der Kathode angeordnet ist, wobei die organische Schicht den Metallkomplex nach einem der Ansprüche 1 bis 14 umfasst;
bevorzugt ist die organische Schicht eine lichtemittierende Schicht und der Metallkomplex ein lichtemittierendes Material;
bevorzugt strahlt die Elektrolumineszenzvorrichtung rotes oder weißes Licht aus;
besonders bevorzugt umfasst das mindestens eine Host-Material mindestens eine chemische Gruppe ausgewählt aus der Gruppe bestehend aus: Benzol, Pyridin, Pyrimidin, Triazin, Carbazol, Azacarbazol, Indolocarbazol, Dibenzothiophen, Aza-Dibenzothiophen, Dibenzofuran, Azadibenzofuran, Dibenzoselenophen, Triphenylen, Azatriphenylen, Fluoren, Silafluoren, Naphthalin, Chinolin, Isochinolin, Chinazolin, Chinoxalin, Phenanthren, Azaphenanthren und Kombinationen davon.

16. Verbindungskombination umfassend den Metallkomplex nach einem der Ansprüche 1 bis 14.

## Revendications

1. Complexe métallique comprenant un métal M et un ligand Lₐ coordonné au métal M, dans lequel le métal M est choisi parmi un métal de masse atomique relative supérieure à 40, et le ligand Lₐ a une structure représentée par la formule 1 : 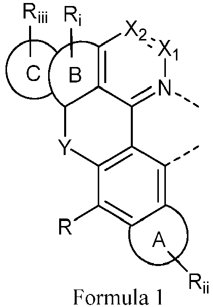
dans lequel le noyau A et le noyau B sont chacun indépendamment choisis parmi un noyau carbocyclique insaturé de cinq chaînons, un noyau aromatique ayant 6 à 30 atomes de carbone ou un noyau hétéroaromatique ayant 3 à 30 atomes de carbone ; et le noyau C est choisi parmi un noyau aromatique ayant 6 à 30 atomes de carbone ou un noyau hétéroaromatique ayant 6 à 30 atomes de cycle ;
Rᵢ et Rᵢᵢ représentent, à chaque occurrence, de manière identique ou différente, une mono-substitution, une pluralité de substitutions ou une non-substitution ; et Rᵢᵢᵢ représente, à chaque occurrence de manière identique ou différente, une mono-substitution ou une pluralité de substitutions ;
Y est choisi parmi SiR_{y}R_{y}, GeR_{y}R_{y}, O, S ou Se ;
lorsque deux R_{y} sont présents en même temps, les deux R_{y} peuvent être identiques ou différents ;
X₁ et X₂ sont, à chaque occurrence, de manière identique ou différente, choisis parmi CRₓ ou N,
R, Rᵢ, Rᵢᵢ, Rₓ et R_{y} sont, à chaque occurrence, de manière identique ou différente, choisis parmi le groupe constitué de : hydrogène, deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ;
Rᵢᵢᵢ est, à chaque occurrence, de manière identique ou différente, choisi parmi le groupe constitué de : deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ;
dans lequel l'alkyle substitué, le cycloalkyle substitué, l'hétéroalkyle substitué, le groupe hétérocyclique substitué, l'arylalkyle substitué, l'alcoxy substitué, l'aryloxy substitué, l'alcényle substitué, l'aryle substitué, l'hétéroaryle substitué, l'alkylsilyle substitué, l'arylsilyle substitué, l'alkylgermanyle substitué, l'arylgermanyle substitué et l'amino substitué sont substitués par un ou plusieurs groupes choisis parmi le groupe constitué de deutérium, halogène, alkyle non substitué ayant 1 à 20 atomes de carbone, cycloalkyle non substitué ayant 3 à 20 atomes de carbone de cycle, hétéroalkyle non substitué ayant 1 à 20 atomes de carbone, un groupe hétérocyclique non substitué ayant 3 à 20 atomes de carbone, arylalkyle non substitué ayant 7 à 30 atomes de carbone, alcoxy non substitué ayant 1 à 20 atomes de carbone, aryloxy non substitué ayant 6 à 30 atomes de carbone, alcényle non substitué ayant 2 à 20 atomes de carbone, alcynyle non substitué ayant 2 à 20 atomes de carbone, aryle non substitué ayant 6 à 30 atomes de carbone, hétéroaryle non substitué ayant 3 à 30 atomes de carbone, alkylsilyle non substitué ayant 3 à 20 atomes de carbone, groupe arylsilyle non substitué ayant 6 à 20 atomes de carbone, groupe alkylgermanyle non substitué ayant 3 à 20 atomes de carbone, groupe arylgermanyle non substitué ayant 6 à 20 atomes de carbone, amino non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ; et
les substituants adjacents Rᵢ, Rₓ, R_{y}, R, Rᵢᵢ et Rᵢᵢᵢ sont éventuellement liés pour former un noyau.

2. Complexe métallique selon la revendication 1, dans lequel le noyau A et/ou le noyau B sont chacun indépendamment choisis parmi un noyau carbocyclique insaturé de cinq chaînons, un noyau aromatique ayant 6 à 18 atomes de carbone ou un noyau hétéroaromatique ayant 3 à 18 atomes de carbone ; et le noyau C est choisi parmi un noyau aromatique ayant 6 à 18 atomes de carbone ou un noyau hétéroaromatique ayant 6 à 18 atomes de cycle ; et
préférentiellement, le noyau A et/ou le noyau B sont chacun indépendamment choisis parmi un noyau carbocyclique insaturé de cinq chaînons, un noyau aromatique ayant 6 à 10 atomes de carbone ou un noyau hétéroaromatique ayant 3 à 10 atomes de carbone ; et le noyau C est choisi parmi un noyau aromatique ayant 6 à 10 atomes de carbone ou un noyau hétéroaromatique ayant 6 à 10 atomes de cycle.

3. Complexe métallique selon la revendication 1 ou 2, dans lequel Lₐ est choisi parmi une structure représentée par l'une quelconque des formules 2 à 17 : 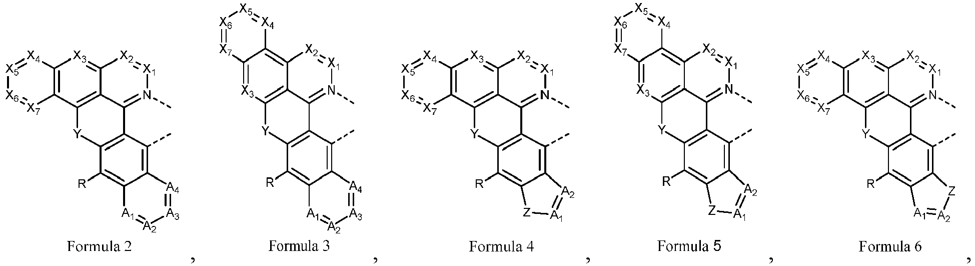 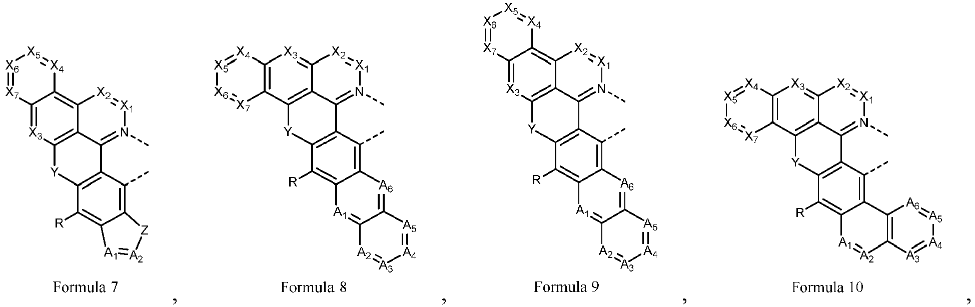 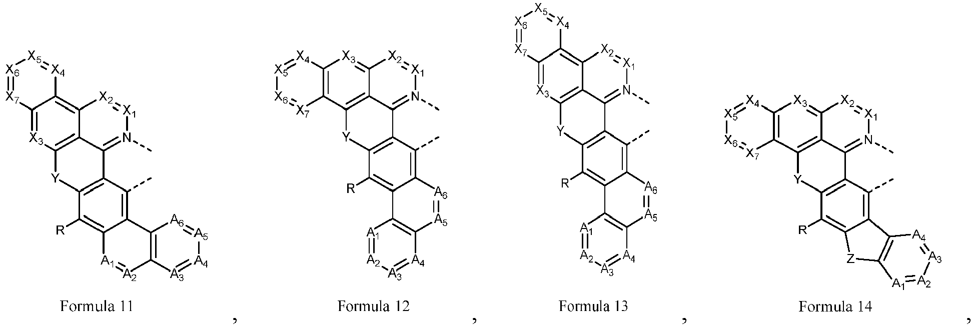 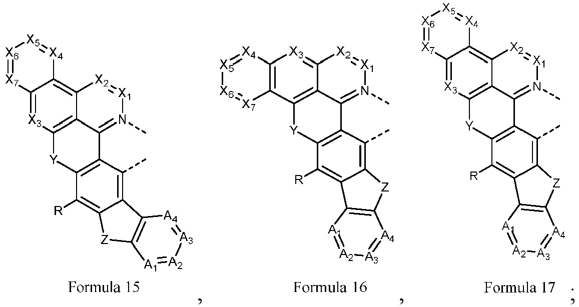 dans lequel
dans les formules 2 à 17, X₁ et X₂ sont, à chaque occurrence, de manière identique ou différente, choisis parmi CRₓ ou N ; préférentiellement, X₁ est choisi parmi CRₓ ; X₃ est choisi parmi CRᵢ ou N ; A₁ à A₆ sont, à chaque occurrence, de manière identique ou différente, choisis parmi CRᵢᵢ ou N ; X₄ à X₇ sont, à chaque occurrence, de manière identique ou différente, choisis parmi CH, CRᵢᵢᵢ ou N, et au moins l'un parmi X₄ à X₇ est choisi parmi CRᵢᵢᵢ ;
Z est, à chaque occurrence, de manière identique ou différente, choisi parmi CRᵢᵥRᵢᵥ, SiRᵢᵥRᵢᵥ, PRᵢᵥ, O, S ou NRᵢᵥ ; lorsque deux Rᵢᵥ sont présents en même temps, les deux Rᵢᵥ sont identiques ou différents ;
Y est choisi parmi SiR_{y}R_{y}, O, S ou Se ; lorsque deux R_{y} sont présents en même temps, les deux R_{y} sont identiques ou différents ; préférentiellement, Y est choisi parmi O ou S ;
R, Rₓ, R_{y}, Rᵢ, Rᵢᵢ et Rᵢᵥ sont, à chaque occurrence, de manière identique ou différente, choisis parmi le groupe constitué de : hydrogène, deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ;
Rᵢᵢᵢ est, à chaque occurrence, de manière identique ou différente, choisi parmi le groupe constitué de : deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ;
les substituants adjacents Rᵢ, Rₓ, R_{y}, R, Rᵢᵢ, Rᵢᵢᵢ et Rᵢᵥ sont éventuellement liés pour former un noyau.
préférentiellement, Lₐ est choisi parmi une structure représentée par la formule 2 ou la formule 3 ; et
plus préférentiellement, Lₐ est choisi parmi une structure représentée par la formule 3.

4. Complexe métallique selon la revendication 3, dans lequel, dans les formules 2 à 17, au moins l'un parmi X₁ à Xₙ et/ou A₁ à Aₘ est choisi parmi N, où Xₙ correspond au groupe avec le plus grand numéro de série parmi X₁ à X₇ dans l'une quelconque des formules 2 à 17, et Aₘ correspond au groupe avec le plus grand numéro de série parmi A₁ à A₆ dans l'une quelconque des formules 2 à 17 ;
préférentiellement, dans les formules 2 à 17, au moins l'un parmi X₁ à Xₙ est choisi parmi N, où Xₙ correspond au groupe avec le plus grand numéro de série parmi X₁ à X₇ dans l'une quelconque des formules 2 à 17 ; et
plus préférentiellement, X₂ est N.

5. Complexe métallique selon la revendication 3, dans lequel, dans les formules 2 à 17, X₁ et X₂ sont chacun indépendamment choisis parmi CRₓ ; X₃ est choisi parmi CR; ; A₁ à A₆ sont chacun indépendamment choisis parmi CRᵢᵢ, X₄ à X₇ sont, à chaque occurrence de manière identique ou différente, choisis parmi CH ou CRᵢᵢᵢ, et au moins l'un parmi X₄ à X₇ est choisi parmi CRᵢᵢᵢ ; les substituants adjacents Rₓ, Rᵢ, Rᵢᵢ et Rᵢᵢᵢ sont éventuellement liés pour former un noyau ;
préférentiellement les Rₓ, Rᵢ et Rᵢᵢ sont, à chaque occurrence, de manière identique ou différente, choisis parmi le groupe constitué de : hydrogène, deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, un groupe cyano et des combinaisons de ceux-ci ;
le Rᵢᵢᵢ est, à chaque occurrence, de manière identique ou différente, choisi parmi le groupe constitué de : deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, un groupe cyano et des combinaisons de ceux-ci ;
plus préférentiellement, au moins l'un ou deux parmi Rₓ, Rᵢ et Rᵢᵢ est(sont), à chaque occurrence, de manière identique ou différente, choisi(s) parmi le groupe constitué de : deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, un groupe cyano et des combinaisons de ceux-ci ; et
Rᵢᵢᵢ est, à chaque occurrence, de manière identique ou différente, choisi parmi le groupe constitué de : deutérium, fluor, méthyle, éthyle, isopropyle, isobutyle, t-butyle, néopentyle, cyclopentyle, cyclopentylméthyle, cyclohexyle, norbornyle, adamantyle, triméthylsilyle, isopropyldiméthylsilyle, phényldiméthylsilyle, trifluorométhyle, un groupe cyano, phényle et des combinaisons de ceux-ci.

6. Complexe métallique selon l'une quelconque des revendications 3 à 5, dans lequel, dans les formules 2 à 17, au moins l'un ou deux parmi A₁ à A₆ est(sont) choisi(s) parmi CRᵢᵢ, et le Rᵢᵢ est, à chaque occurrence, de manière identique ou différente, choisi parmi deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, un groupe cyano ou une combinaison de ceux-ci ;
X₃ est choisi parmi CRᵢ, et le Rᵢ est, à chaque occurrence, de manière identique ou différente, choisi parmi hydrogène, deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, un groupe cyano ou une combinaison de ceux-ci ;
préférentiellement, le Rᵢ est, à chaque occurrence, de manière identique ou différente, choisi parmi le groupe constitué de : hydrogène, deutérium, fluor, méthyle, éthyle, isopropyle, isobutyle, t-butyle, néopentyle, cyclopentyle, cyclopentylméthyle, cyclohexyle, norbornyle, adamantyle, triméthylsilyle, isopropyldiméthylsilyle, phényldiméthylsilyle, trifluorométhyle, un groupe cyano, phényle et des combinaisons de ceux-ci ; et
le Rᵢᵢ est, à chaque occurrence, de manière identique ou différente, choisi parmi le groupe constitué de : deutérium, fluor, méthyle, éthyle, isopropyle, isobutyle, t-butyle, néopentyle, cyclopentyle, cyclopentylméthyle, cyclohexyle, norbornyle, adamantyle, triméthylsilyle, isopropyldiméthylsilyle, phényldiméthylsilyle, trifluorométhyle, un groupe cyano, phényle et des combinaisons de ceux-ci.

7. Complexe métallique selon l'une quelconque des revendications 3 à 6, dans lequel dans les formules 2 à 17, R est choisi parmi hydrogène, deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone ou une combinaison de ceux-ci ; et
préférentiellement, le R est choisi parmi hydrogène, deutérium, fluor, méthyle, éthyle, isopropyle, isobutyle, t-butyle, cyclopentyle, cyclopentylméthyle, cyclohexyle, néopentyle, méthyle deutéré, éthyle deutéré, isopropyle deutéré, isobutyle deutéré, t-butyle deutéré, cyclopentyle deutéré, cyclopentylméthyle deutéré, cyclohexyle deutéré, néopentyle deutéré, triméthylsilyle ou une combinaison de ceux-ci.

8. Complexe métallique selon l'une quelconque des revendications 1 à 7, dans lequel le ligand Lₐ a une structure représentée par la formule 18 : 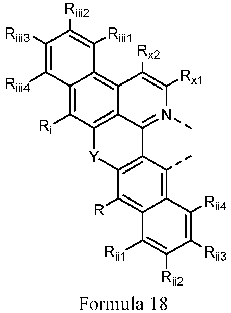
dans lequel, dans la formule 18, Y est choisi parmi O ou S ;
Rₓ₁, Rₓ₂, Rᵢ, Rᵢᵢ₁, Rᵢᵢ₂, Rᵢᵢ₃, Rᵢᵢ₄, R, Rᵢᵢᵢ₁, Rᵢᵢᵢ₂, Rᵢᵢᵢ₃ et Rᵢᵢᵢ₄ sont, à chaque occurrence, de manière identique ou différente, choisis parmi le groupe constitué de : hydrogène, deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ; au moins l'un parmi Rᵢᵢᵢ₁, Rᵢᵢᵢ₂, Rᵢᵢᵢ₃ et Rᵢᵢᵢ₄ est, à chaque occurrence, de manière identique ou différente, choisi parmi le groupe constitué de : deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ;
préférentiellement, un ou deux des Rₓ₁ et Rₓ₂ et/ou au moins l'un ou deux parmi Rᵢᵢ₁, Rᵢᵢ₂, Rᵢᵢ₃ et Rᵢᵢ₄ est(sont), à chaque occurrence, de manière identique ou différente, choisi(s) parmi deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone ou une combinaison de ceux-ci ; R est choisi parmi halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone ou une combinaison de ceux-ci ; au moins l'un ou deux parmi Rᵢᵢᵢ₁, Rᵢᵢᵢ₂, Rᵢᵢᵢ₃ et Rᵢᵢᵢ₄ est(sont), à chaque occurrence, de manière identique ou différente, choisi(s) parmi le groupe constitué de : deutérium, halogène, alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone et des combinaisons de ceux-ci ;
plus préférentiellement, un ou deux des Rₓ₁ et Rₓ₂ et/ou au moins l'un ou deux parmi Rᵢᵢ₁, Rᵢᵢ₂, Rᵢᵢ₃ et Rᵢᵢ₄ est(sont), à chaque occurrence, de manière identique ou différente, choisi(s) parmi un groupe alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone ou une combinaison de ceux-ci ; R est choisi parmi un groupe alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, ou une combinaison de ceux-ci ; et
au moins l'un ou deux parmi Rᵢᵢᵢ₁, Rᵢᵢᵢ₂, Rᵢᵢᵢ₃ et Rᵢᵢᵢ₄ est(sont), à chaque occurrence, de manière identique ou différente, choisi(s) parmi le groupe constitué de : alkyle substitué ou non substitué ayant 1 à 20 atomes de carbone, cycloalkyle substitué ou non substitué ayant 3 à 20 atomes de carbone de cycle, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone et des combinaisons de ceux-ci.

9. Complexe métallique selon la revendication 8, dans lequel, dans la formule 18, au moins l'un parmi Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ et R est, à chaque occurrence, de manière identique ou différente, choisi parmi le groupe consitué de : alkyle substitué ou non substitué ayant 3 à 20 atomes de carbone, cycloalkyle substitué ou non substitué ayant 3 à 20 atomes de carbone de cycle, alkylsilyle substitué ou non substitué ayant 3 à 20 atomes de carbone et combinaisons de ceux-ci ; et
préférentiellement, au moins l'un parmi Rₓ₁, Rₓ₂, Rᵢᵢᵢ₁, Rᵢᵢᵢ₂, Rᵢᵢᵢ₃, Rᵢᵢᵢ₄, Rᵢᵢ₁, Rᵢᵢ₂, Rᵢᵢ₃, Rᵢᵢ₄ et R est, à chaque occurrence, de manière identique ou différente, choisi parmi le groupe constitué de : alkyle substitué ou non substitué ayant 3 à 10 atomes de carbone, cycloalkyle substitué ou non substitué ayant 3 à 10 atomes de carbone de cycle et combinaisons de ceux-ci.

10. Complexe métallique selon l'une quelconque des revendications 1 à 9, dans lequel Lₐ est, à chaque occurrence, de manière identique ou différente, choisi parmi le groupe constitué des structures suivantes : 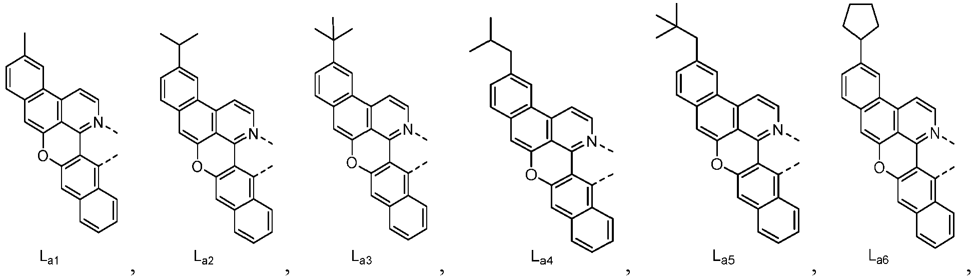 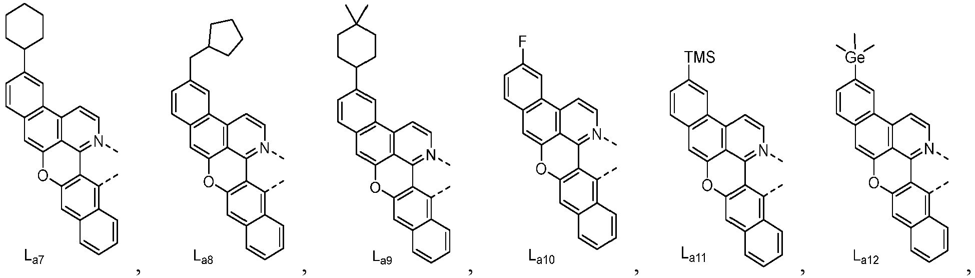 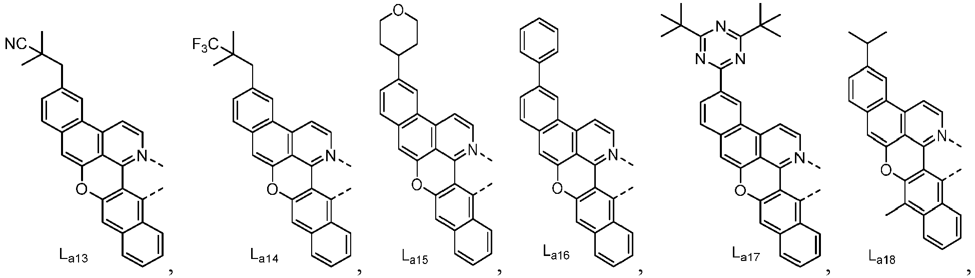 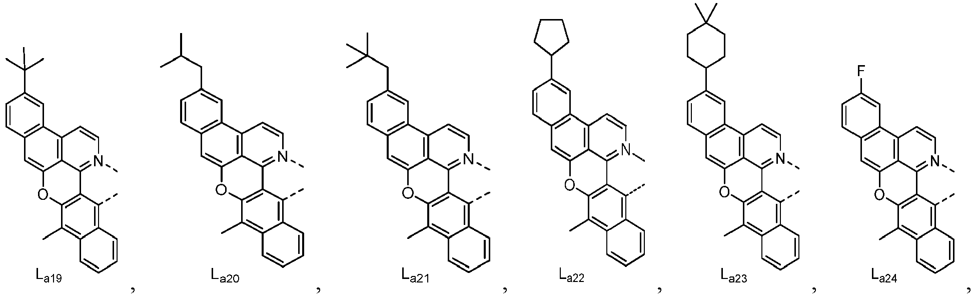 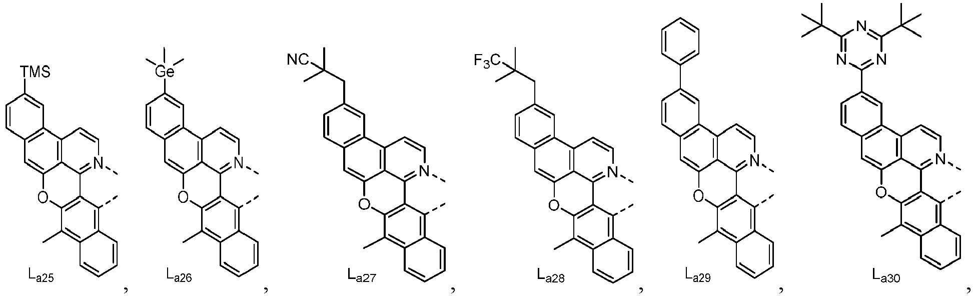 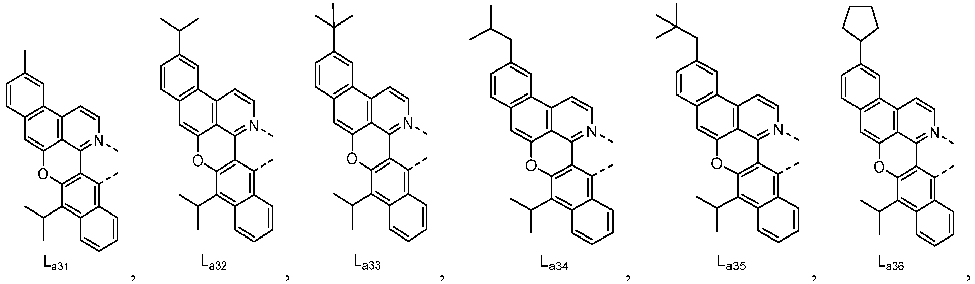 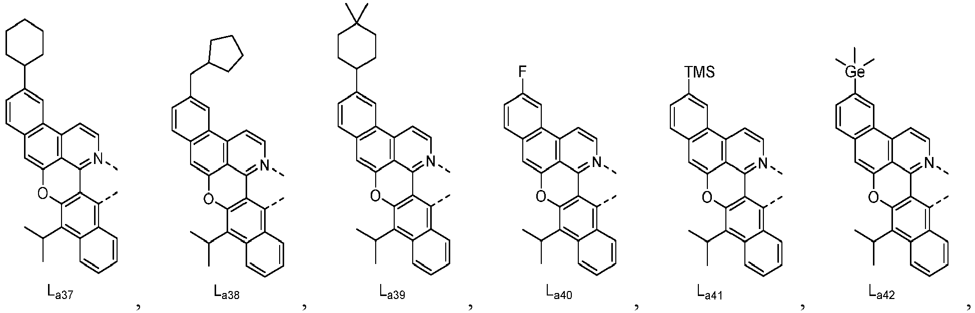 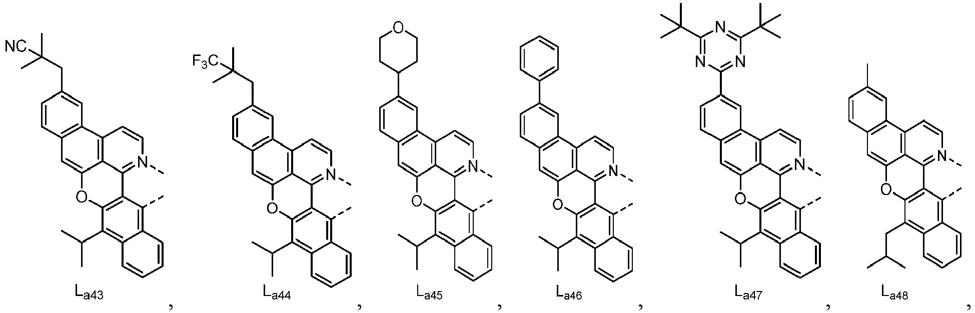 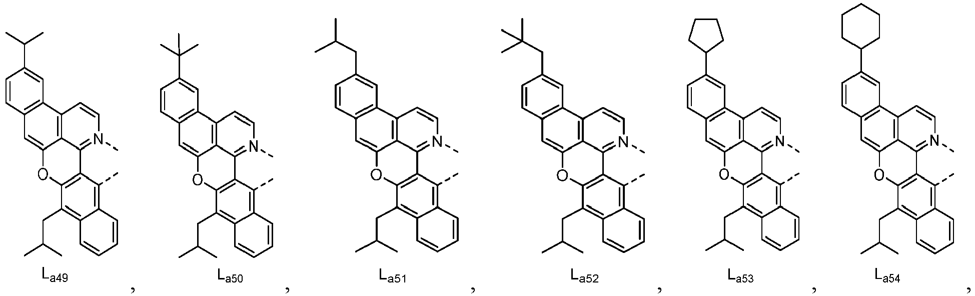 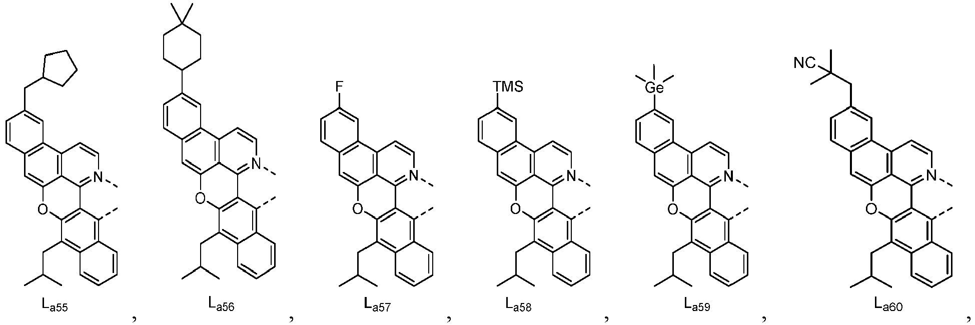 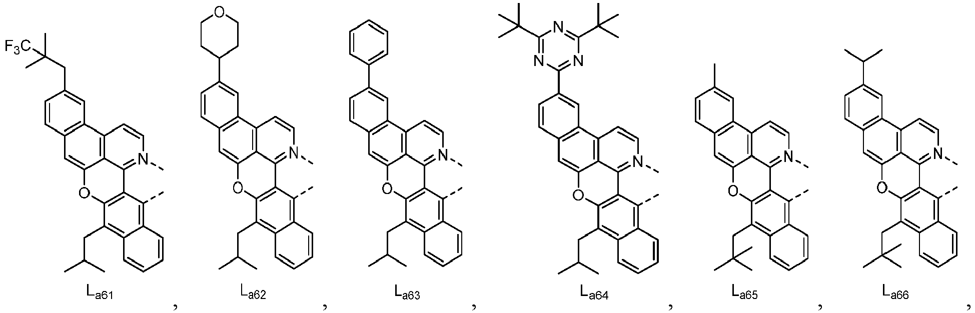 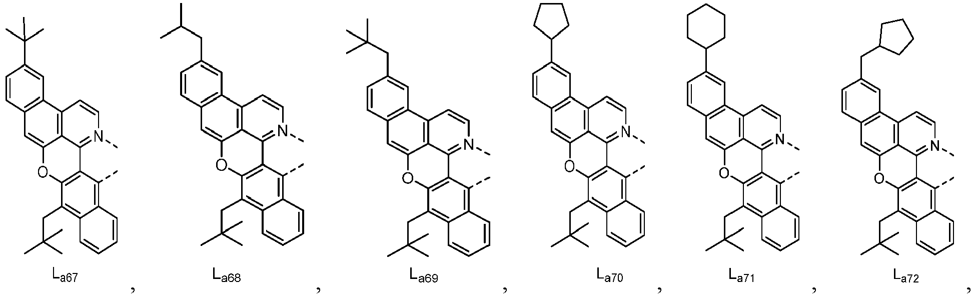 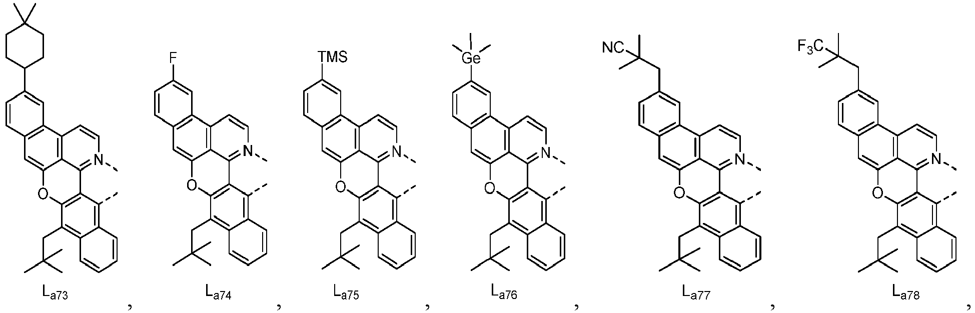 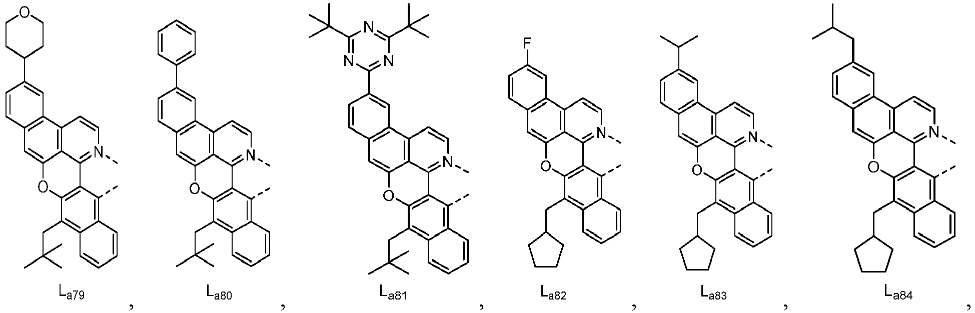 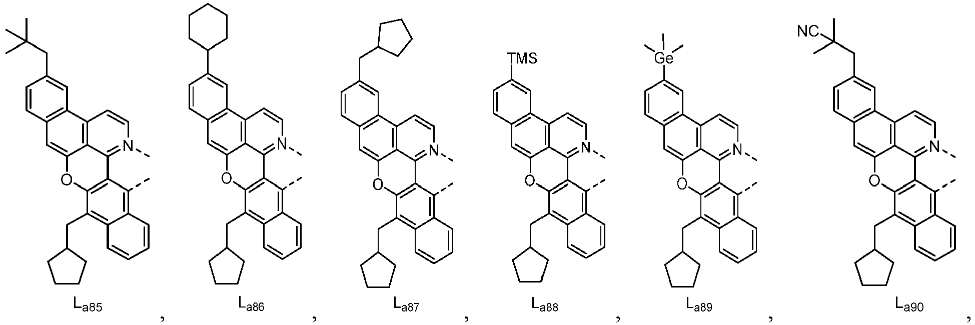 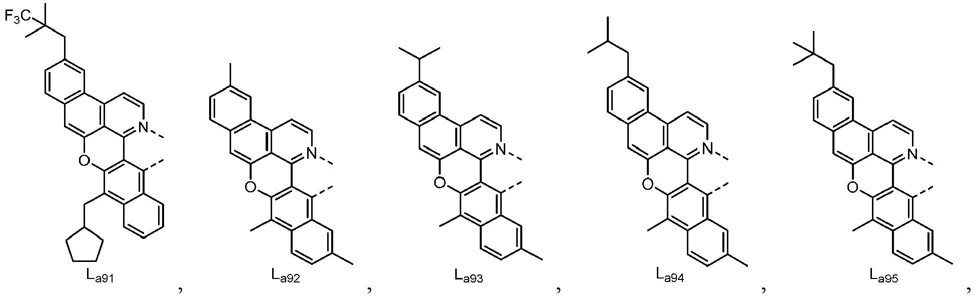 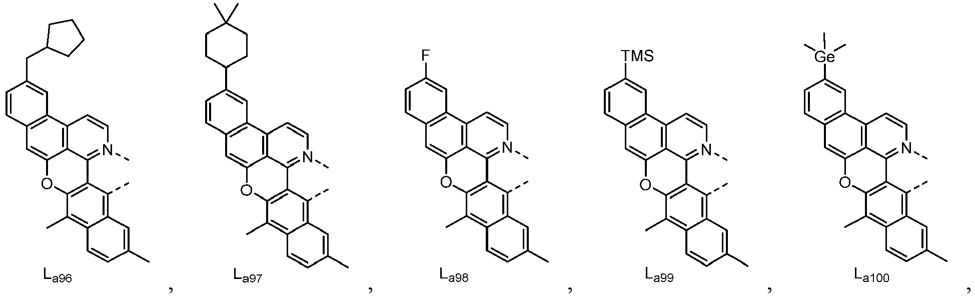 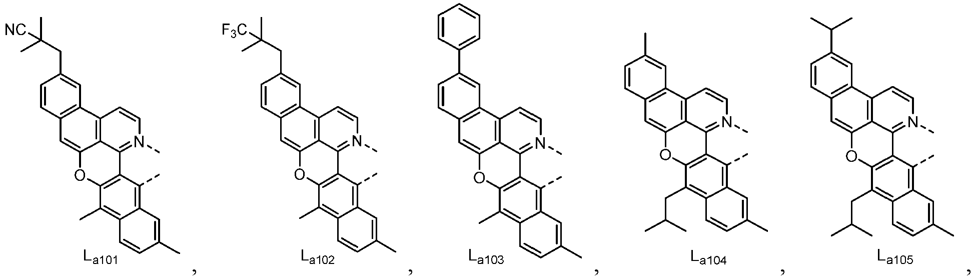 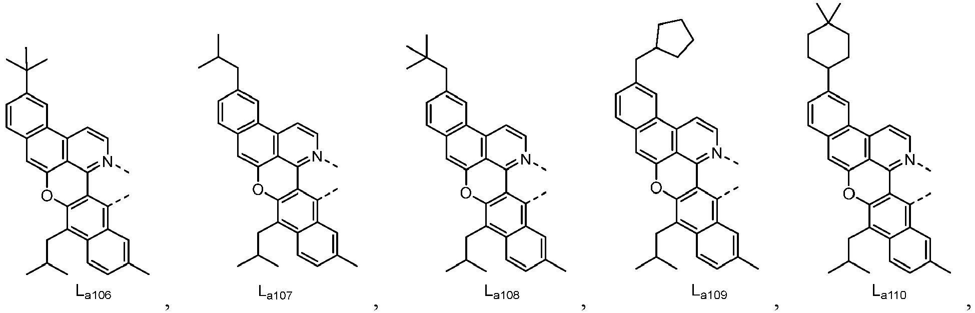 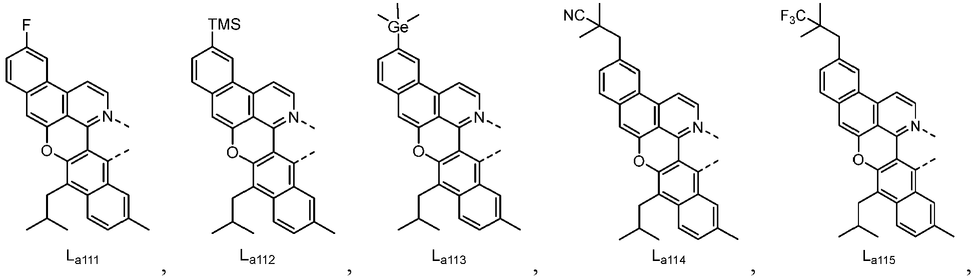 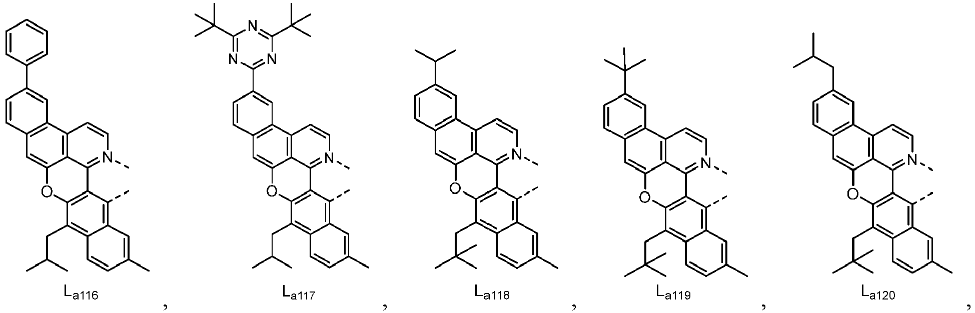 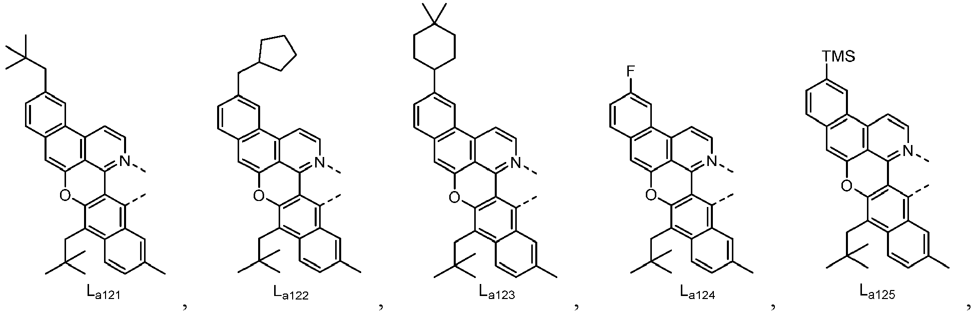 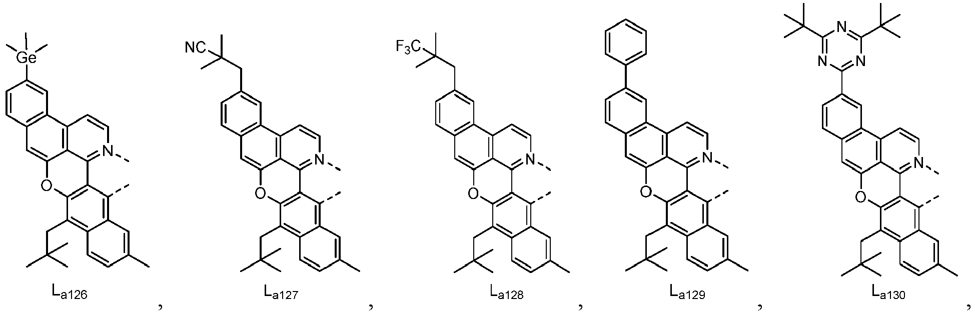 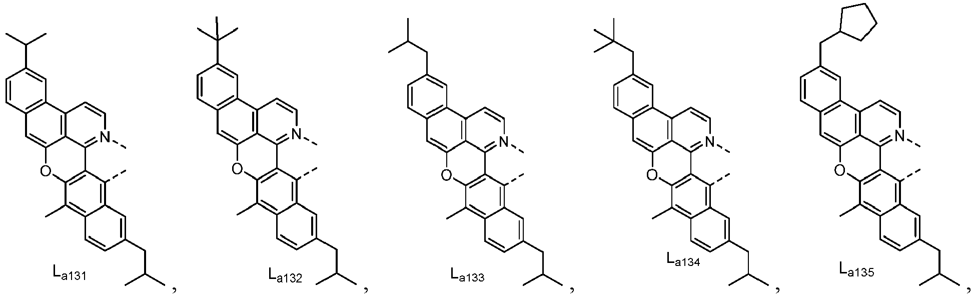 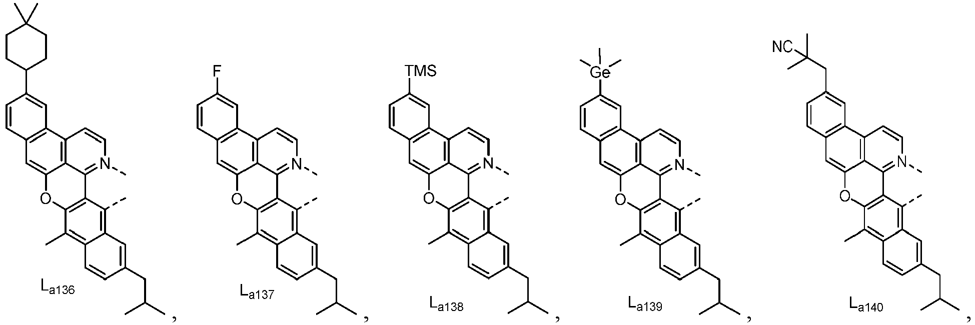 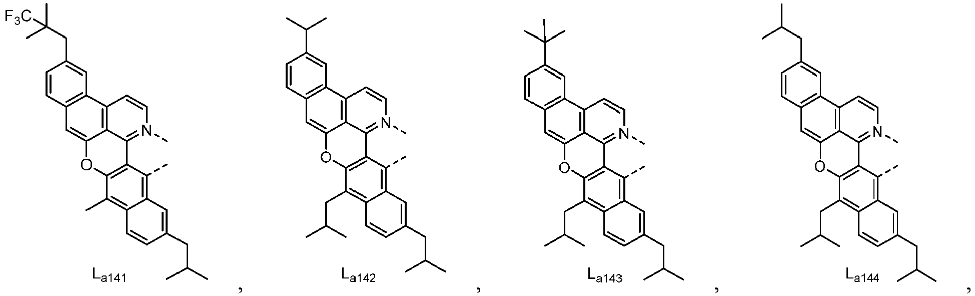 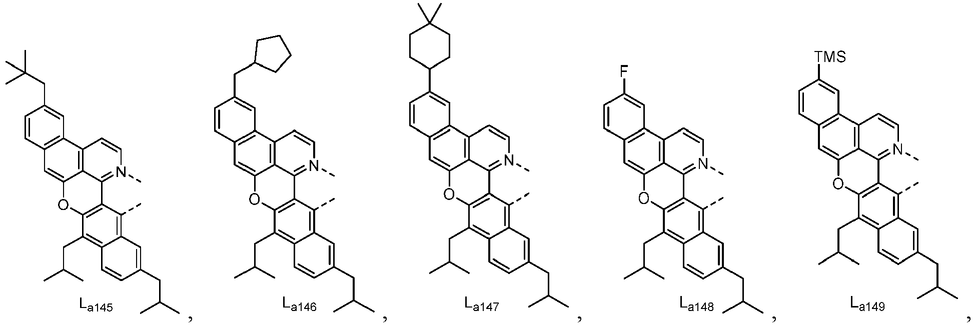 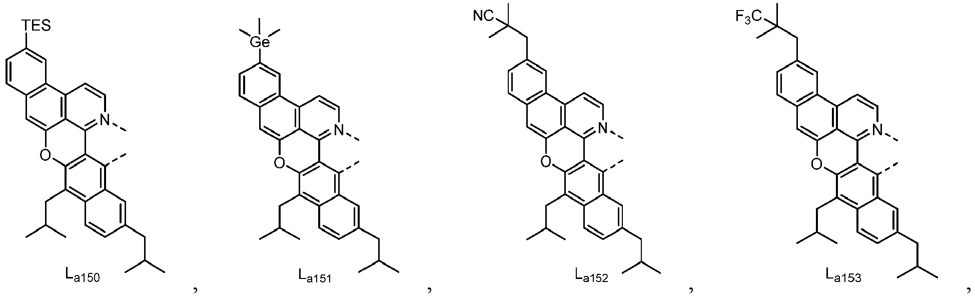 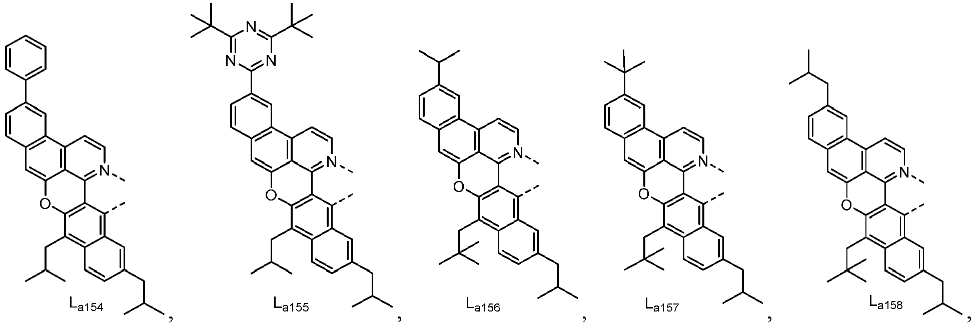 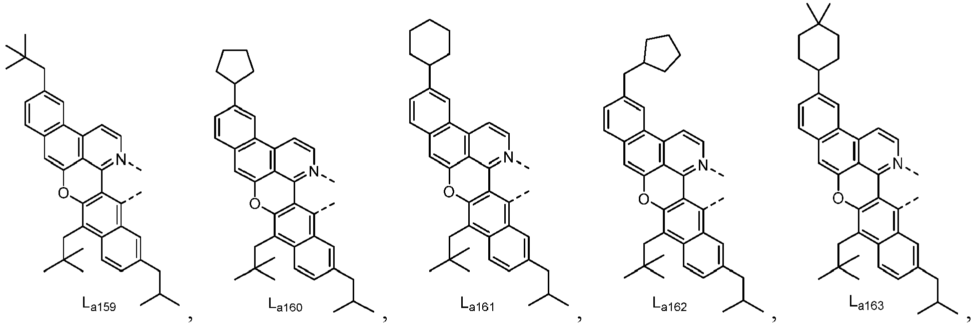 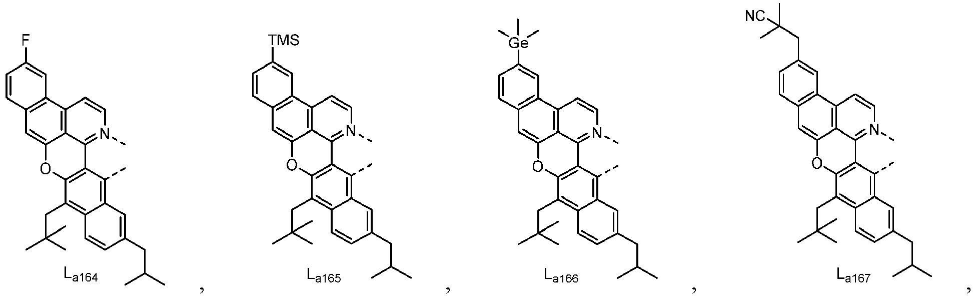 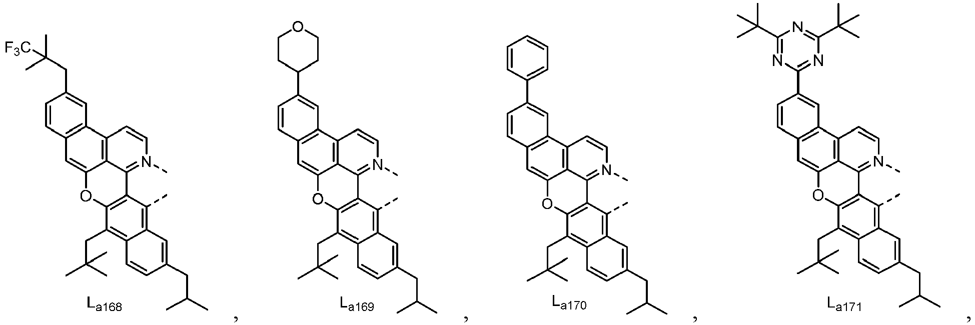 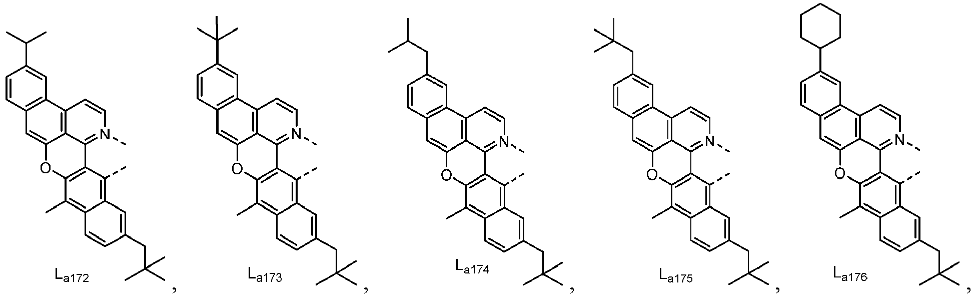 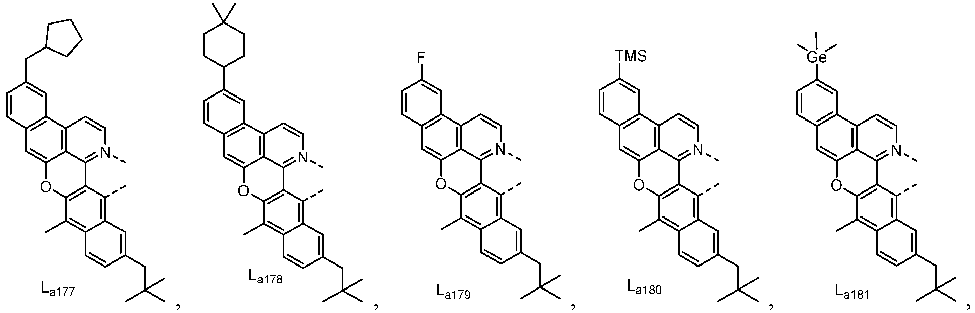 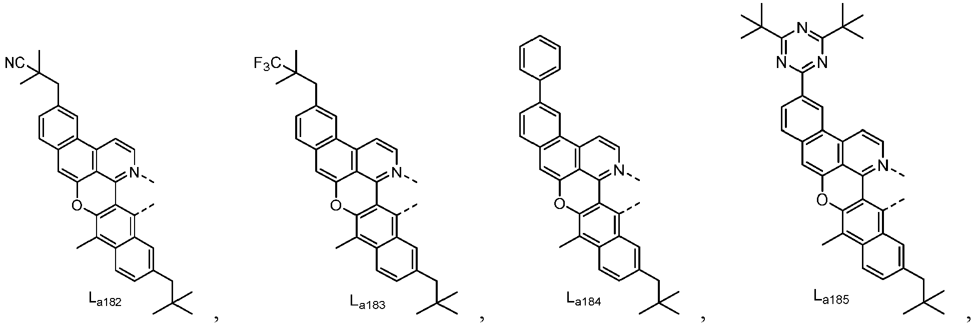 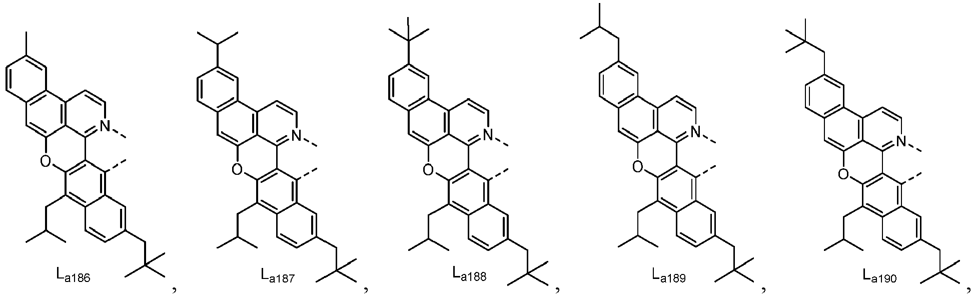 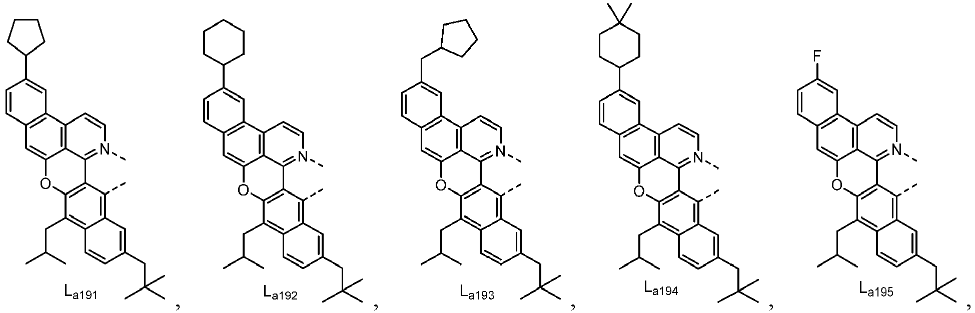 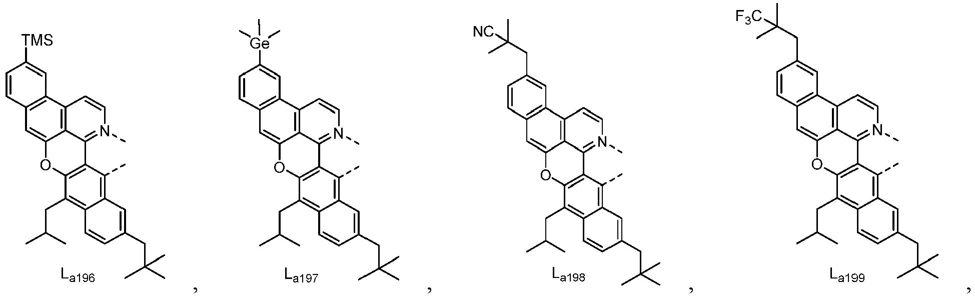 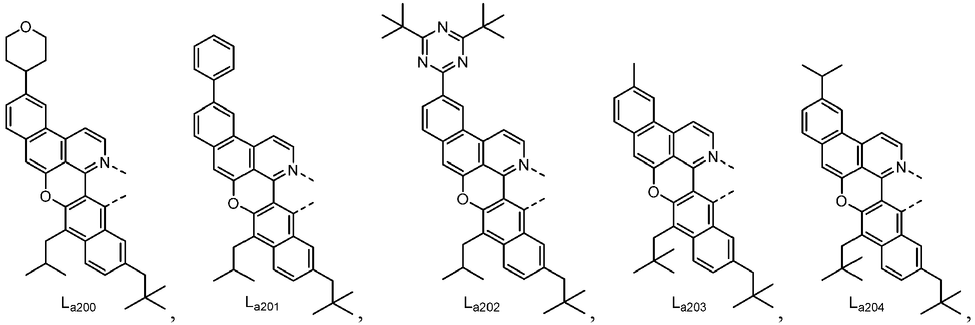 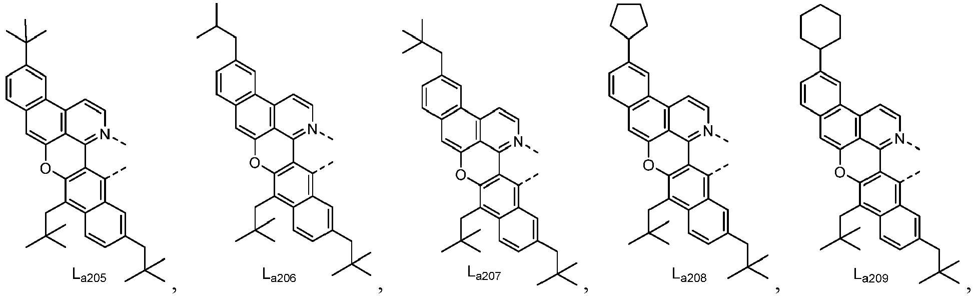 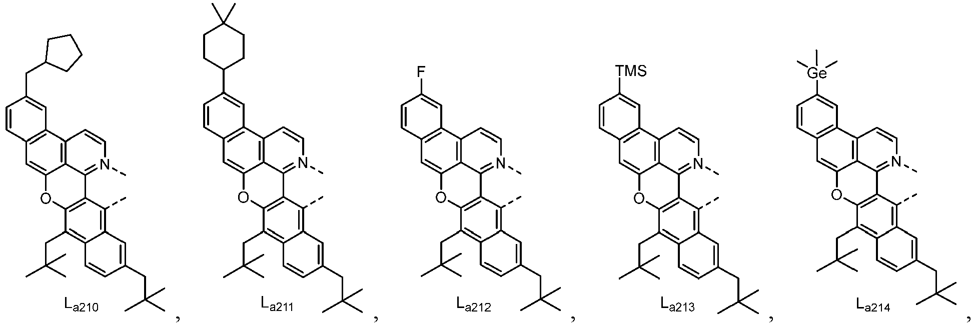 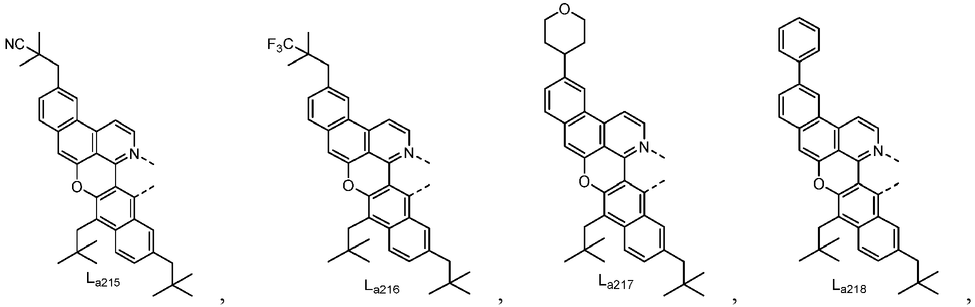 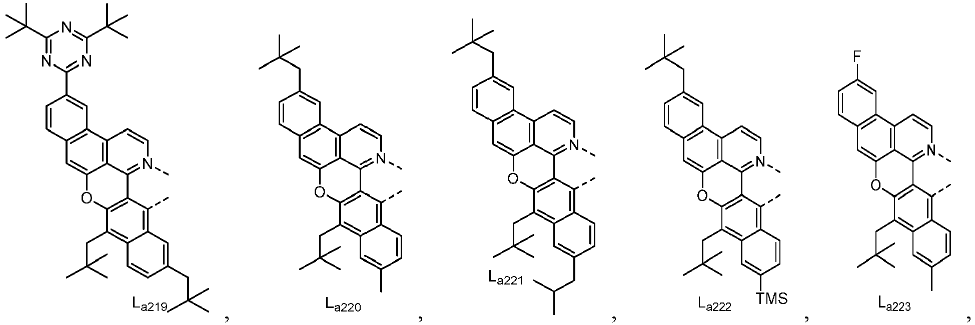 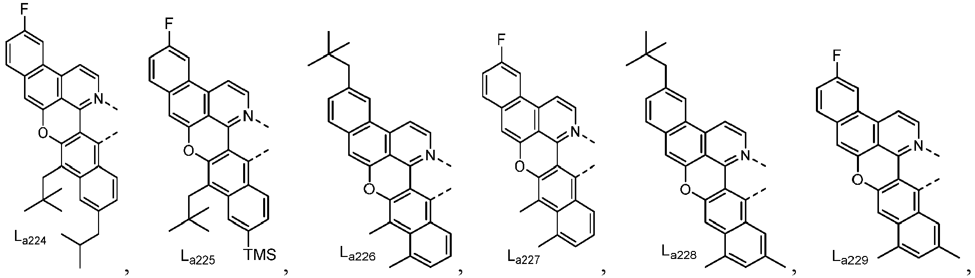 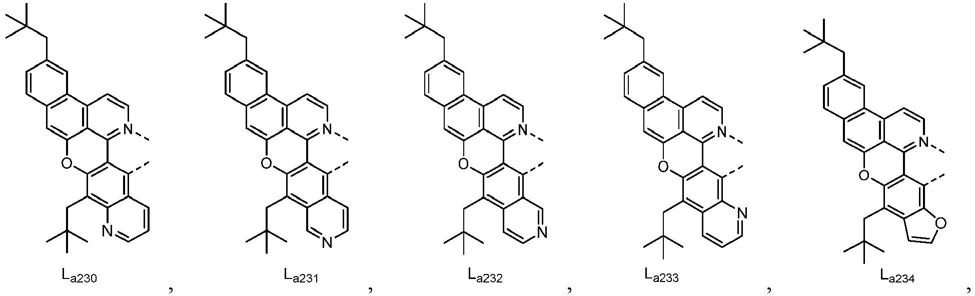 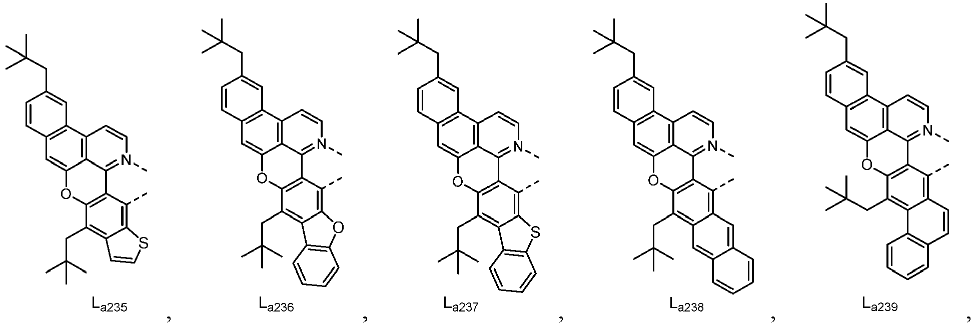 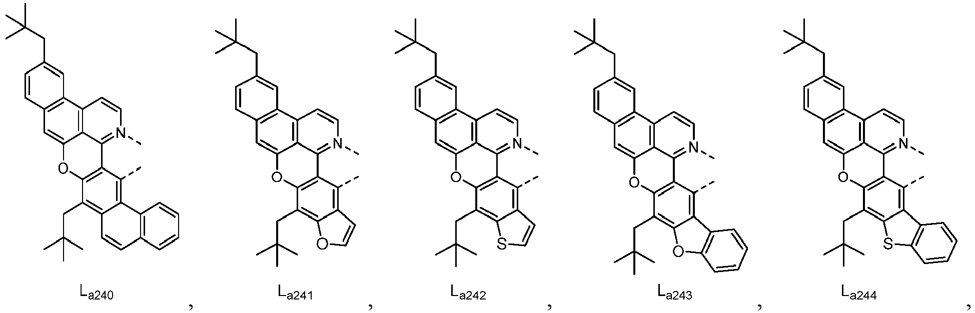 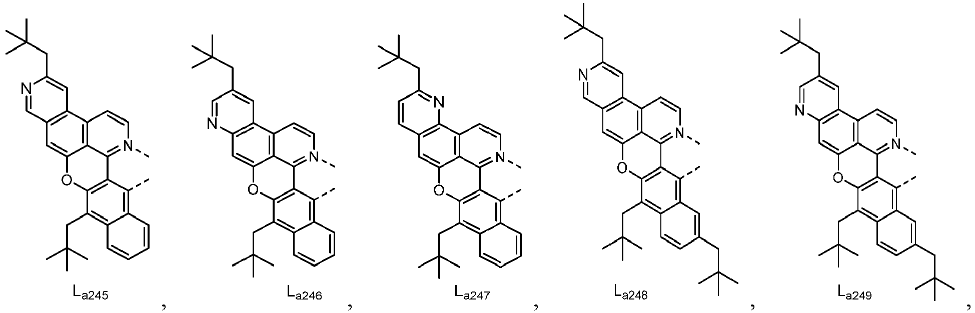 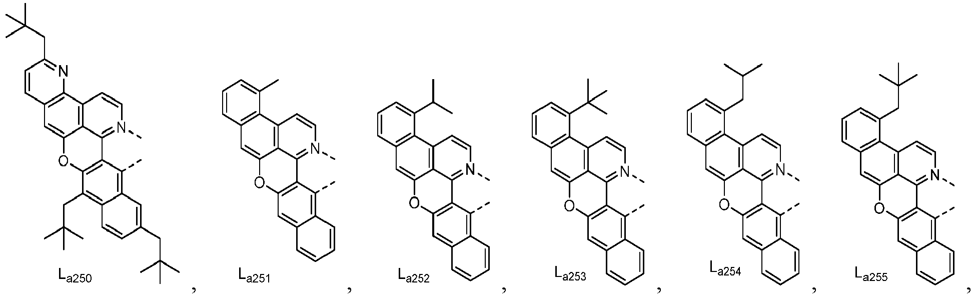 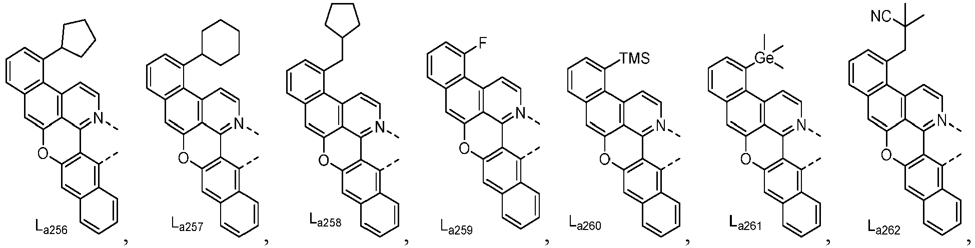 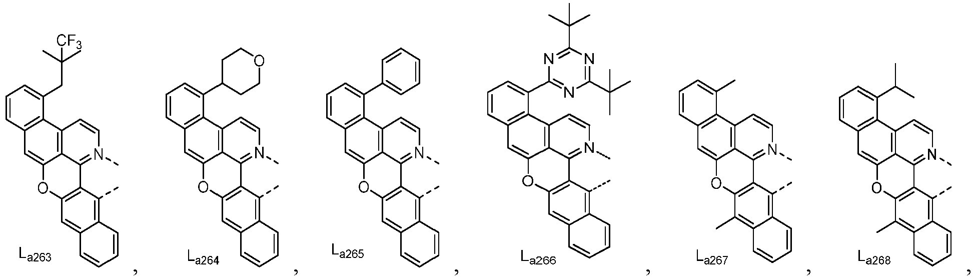 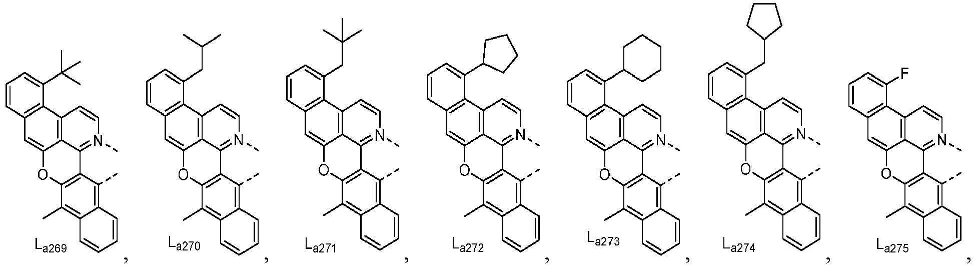 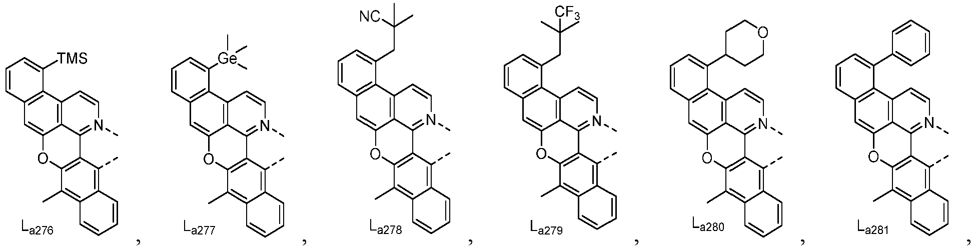 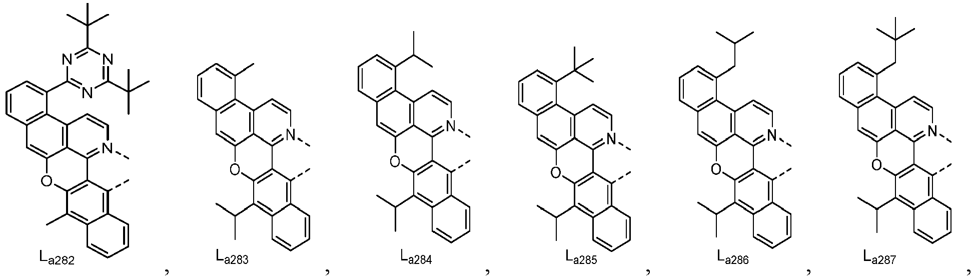 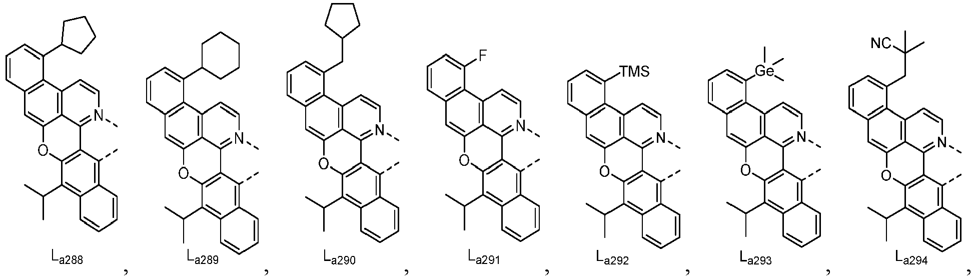 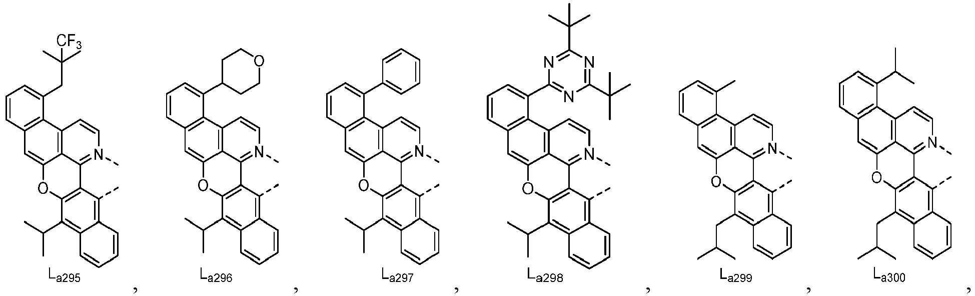 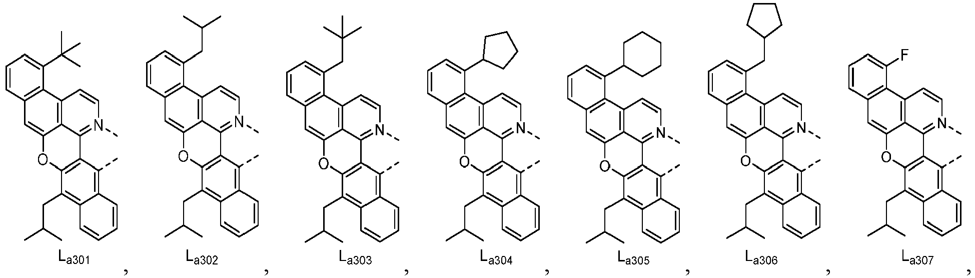 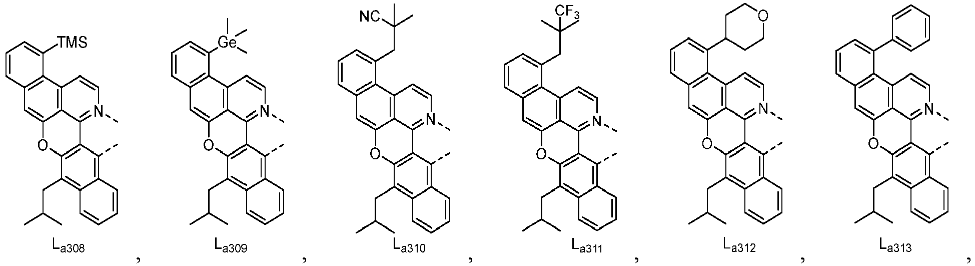 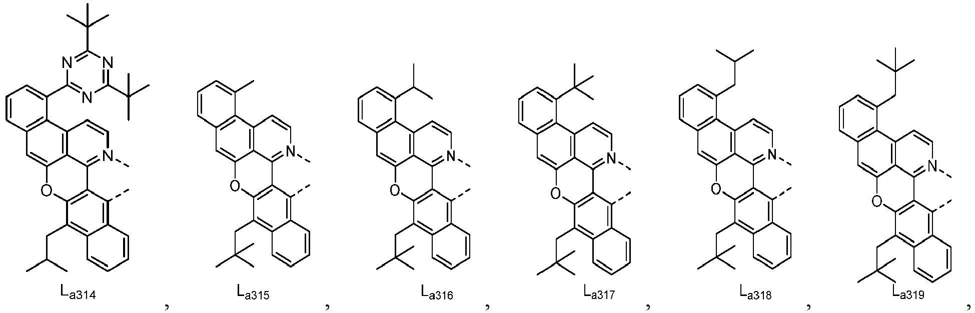 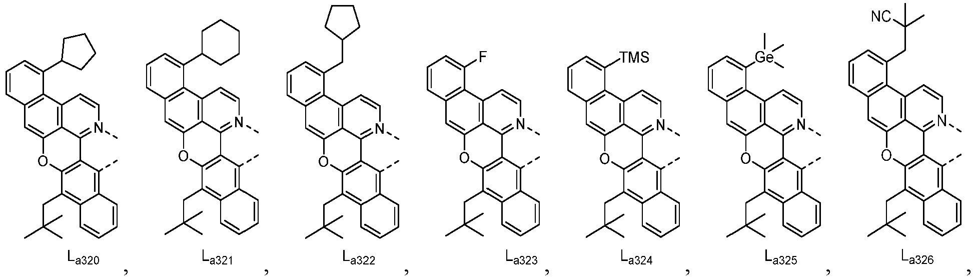 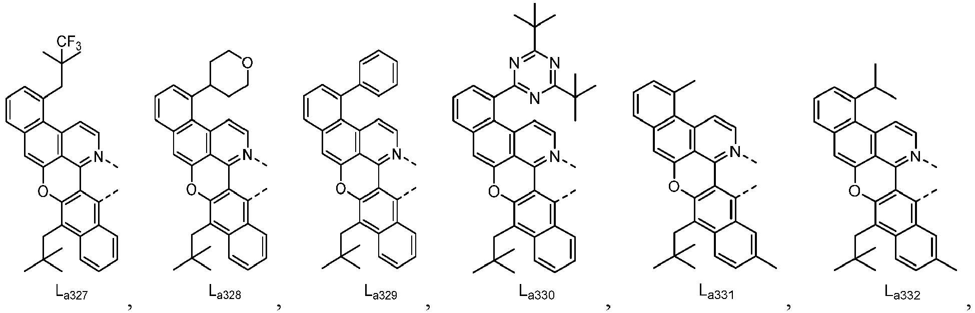 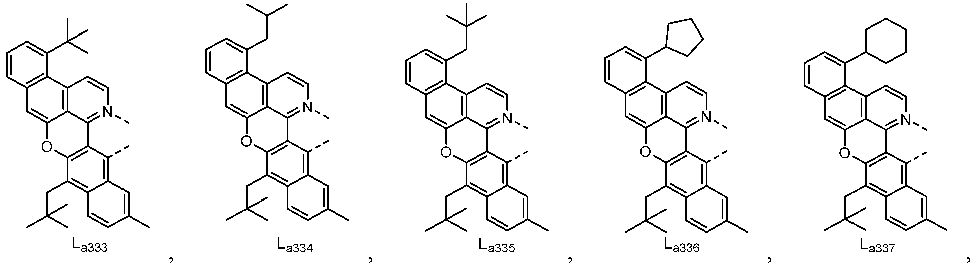 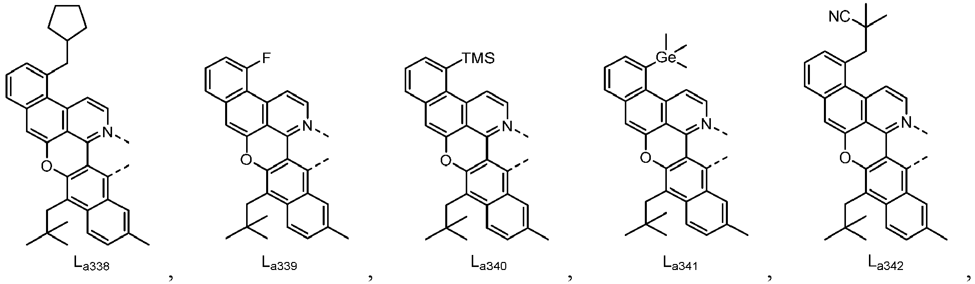 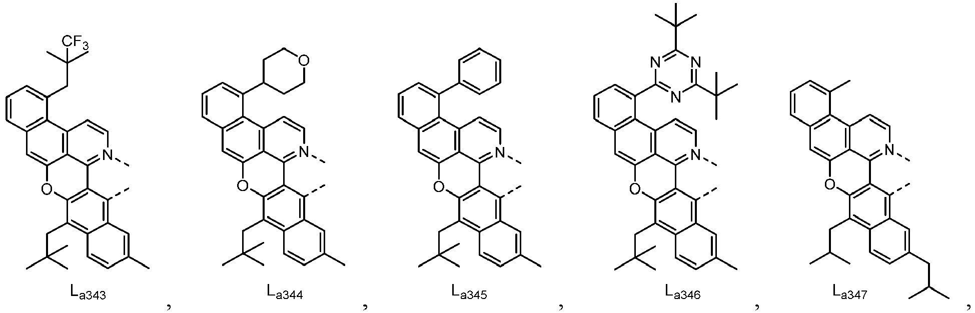 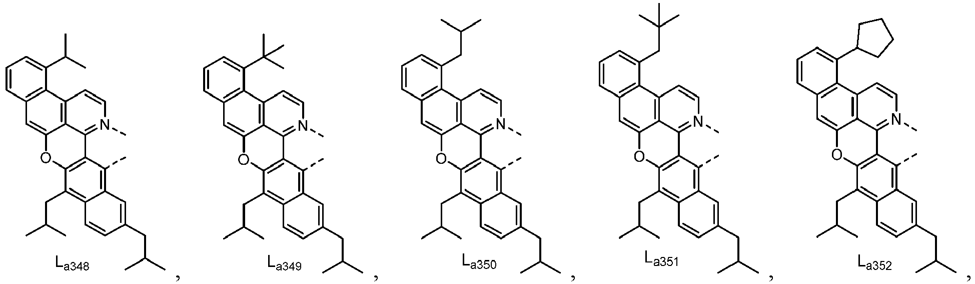 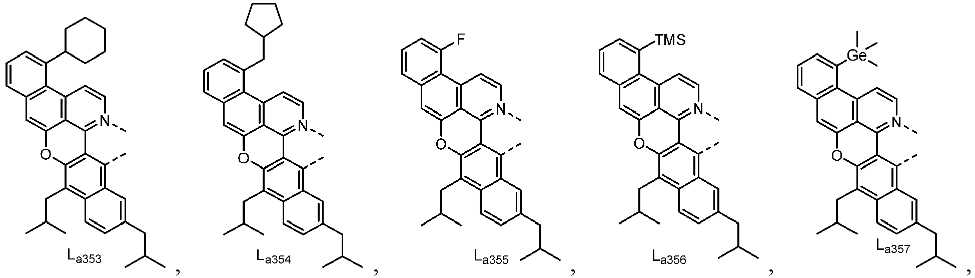 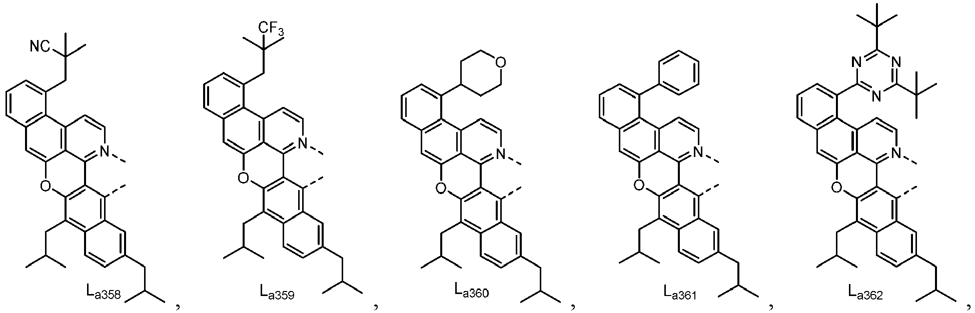 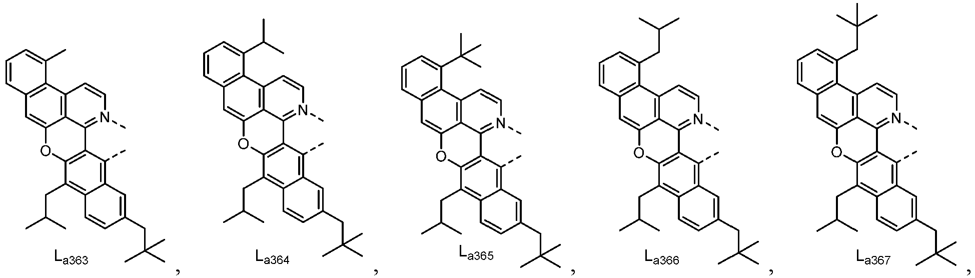 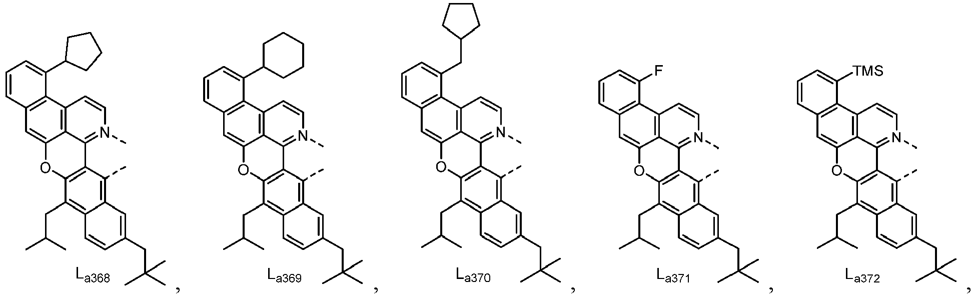 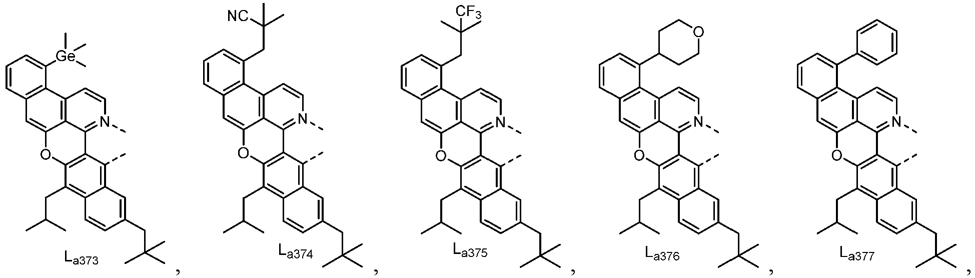 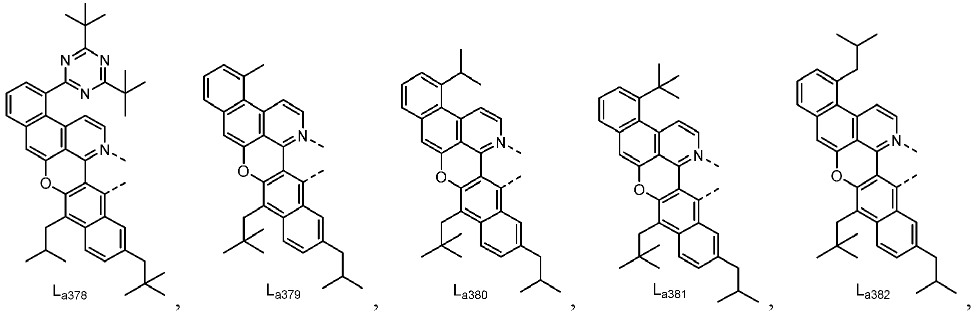 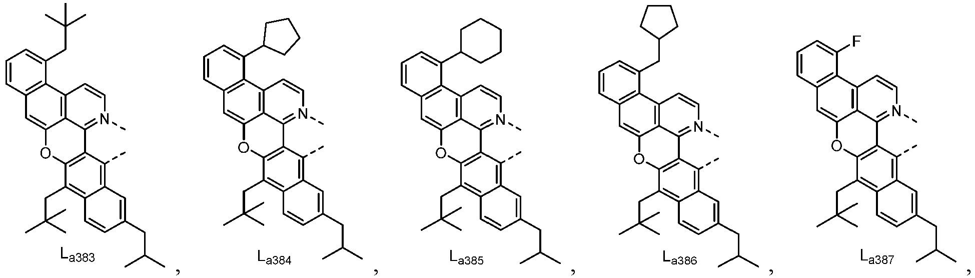 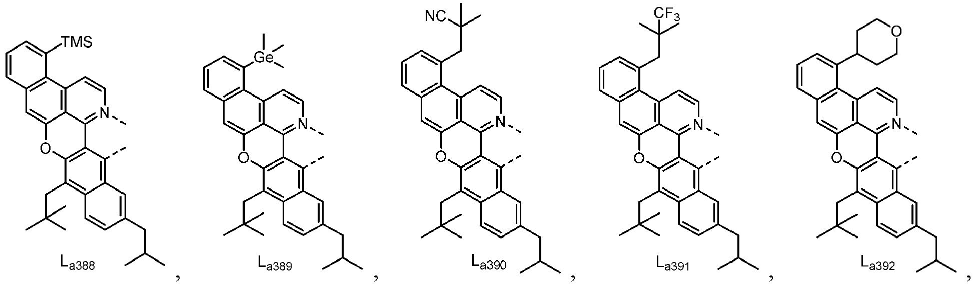 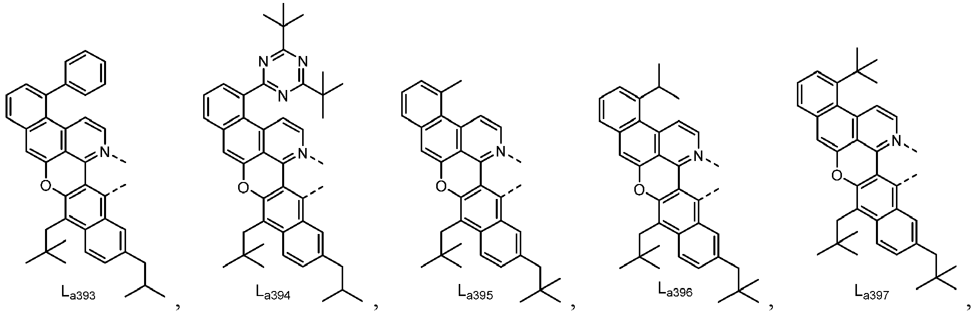 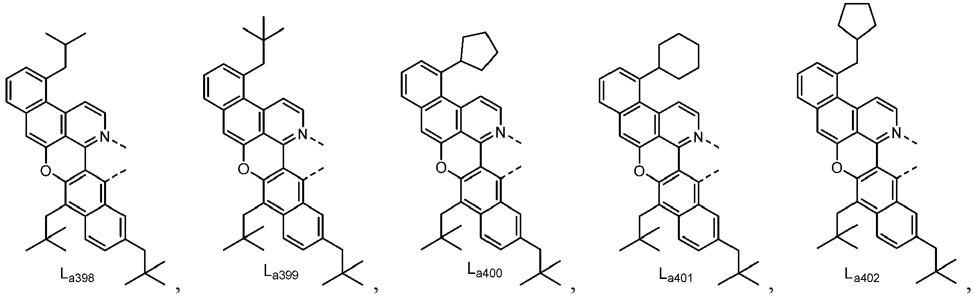 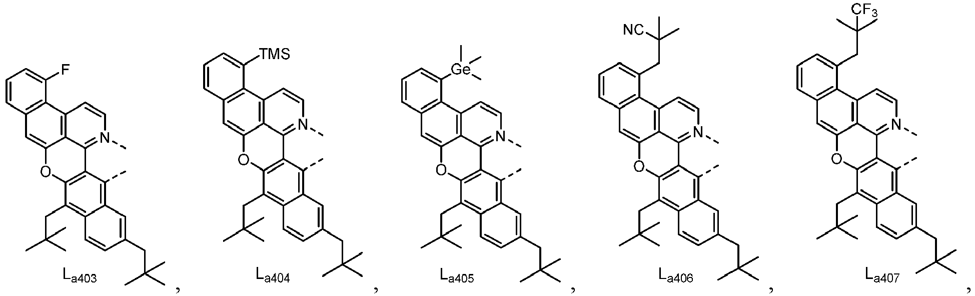 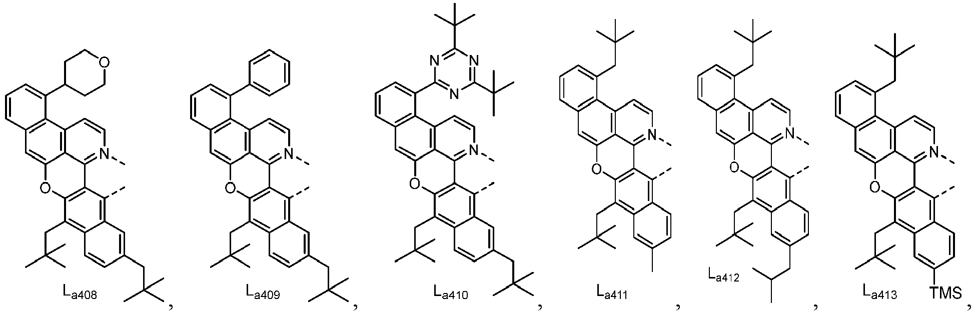 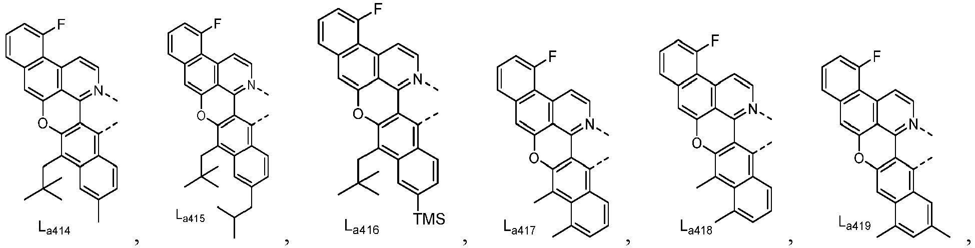 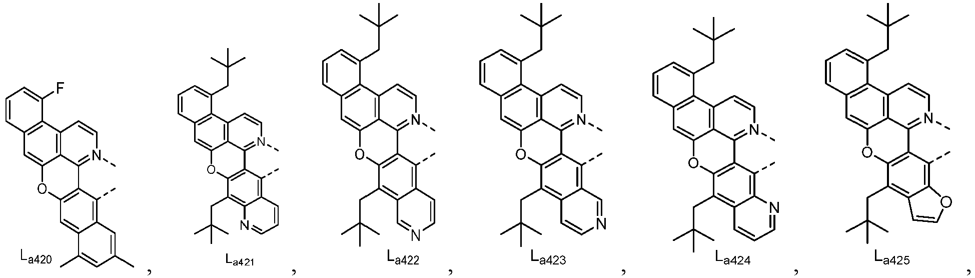 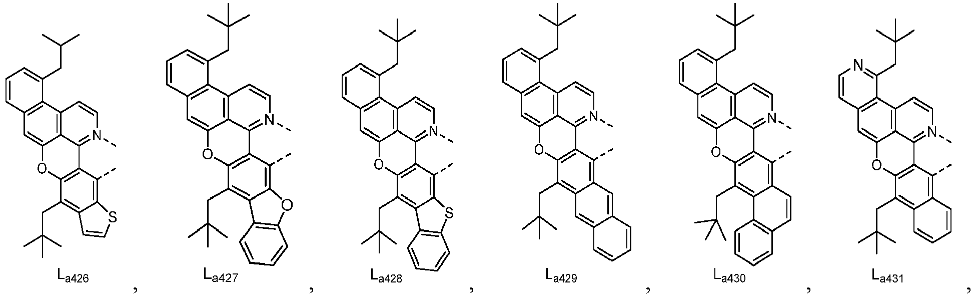 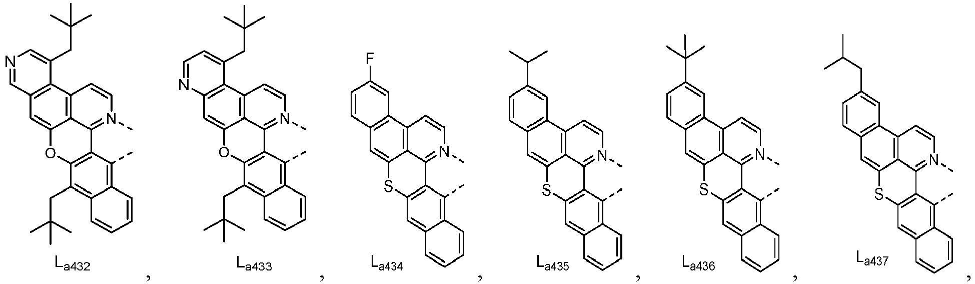 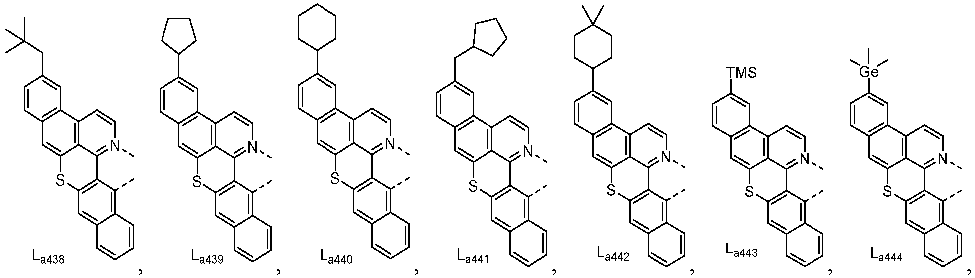 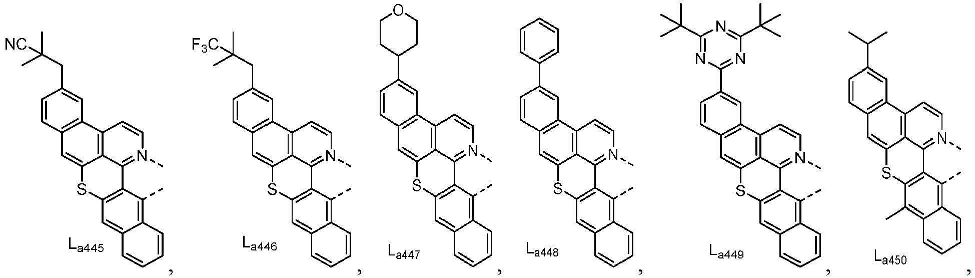 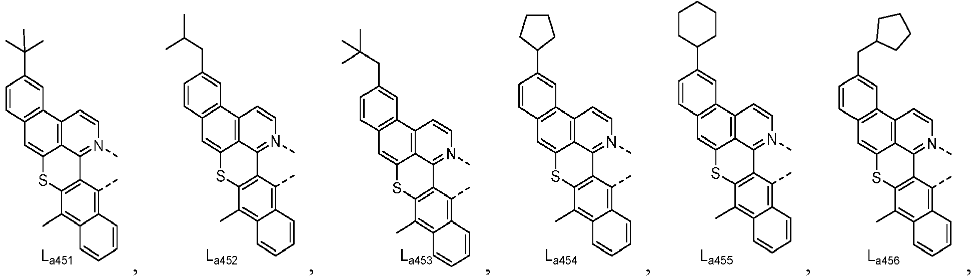 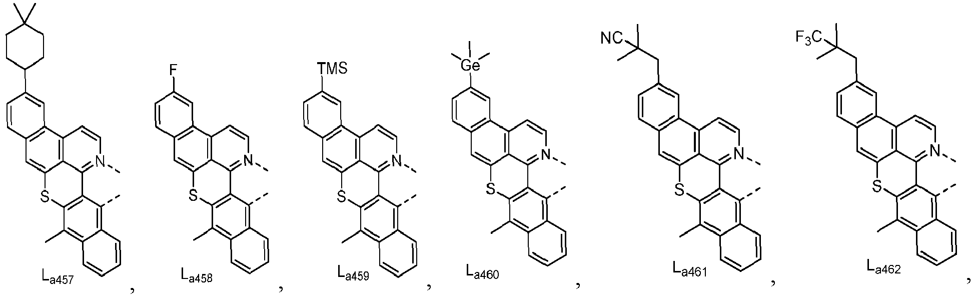 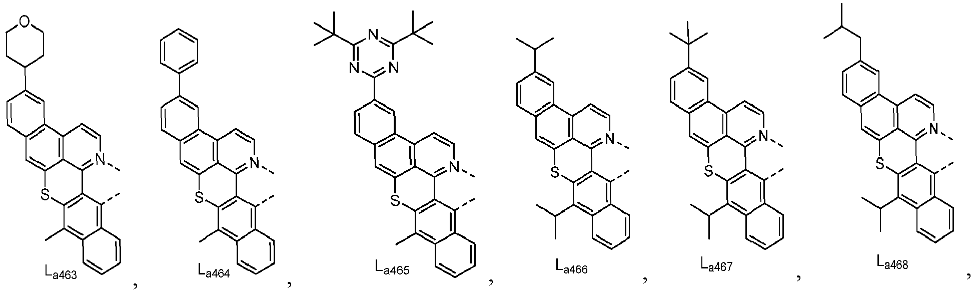 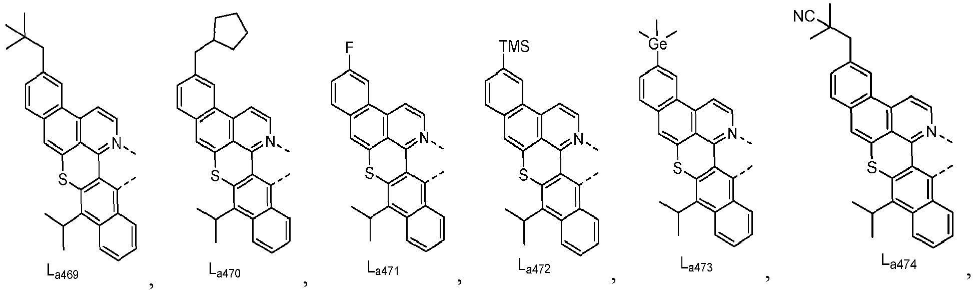 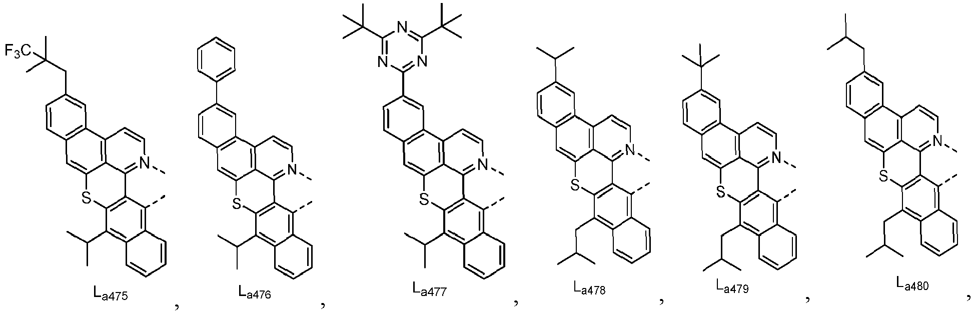 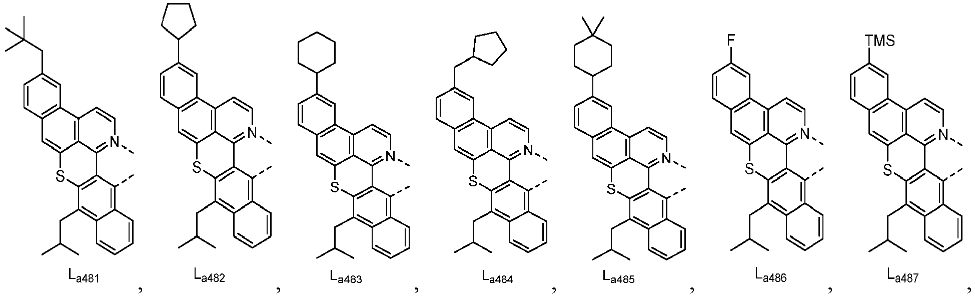 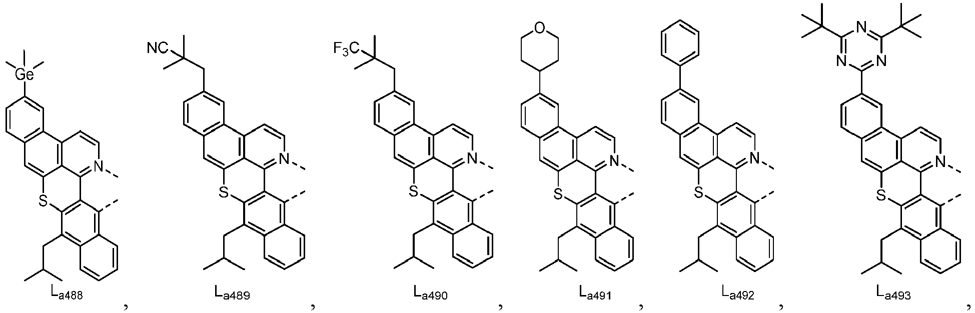 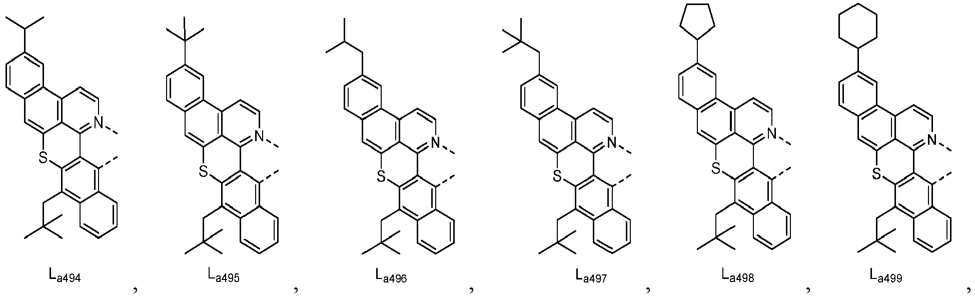 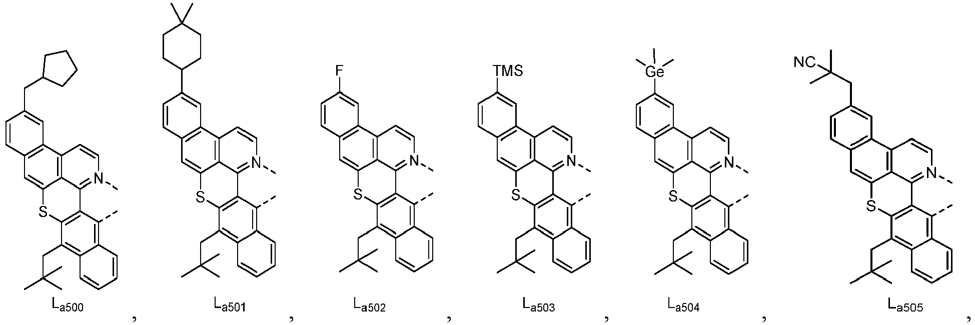 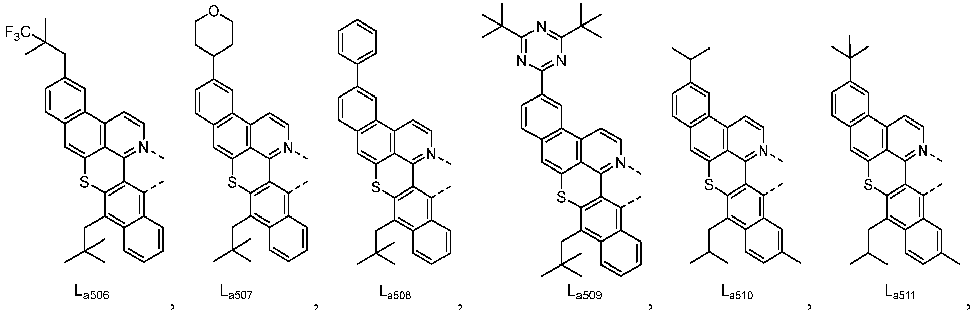 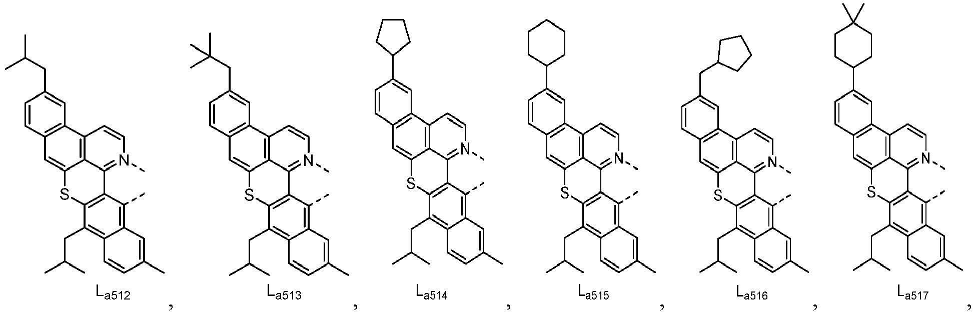 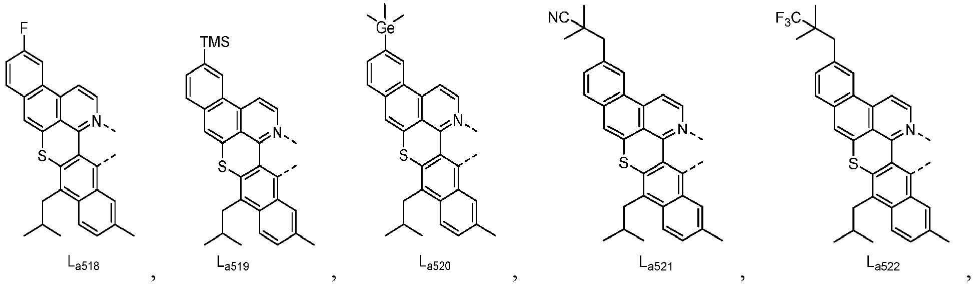 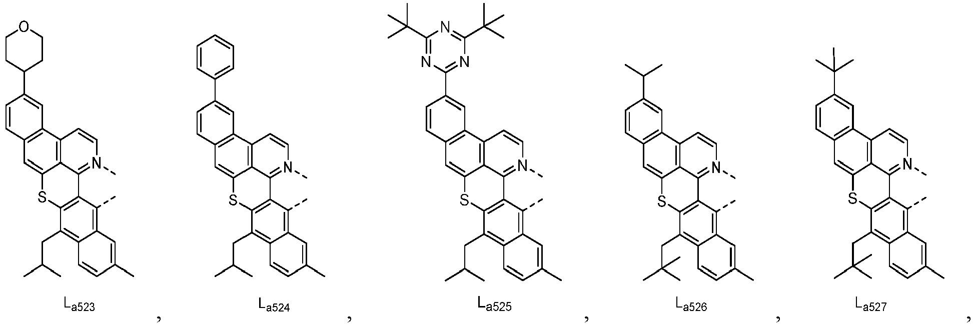 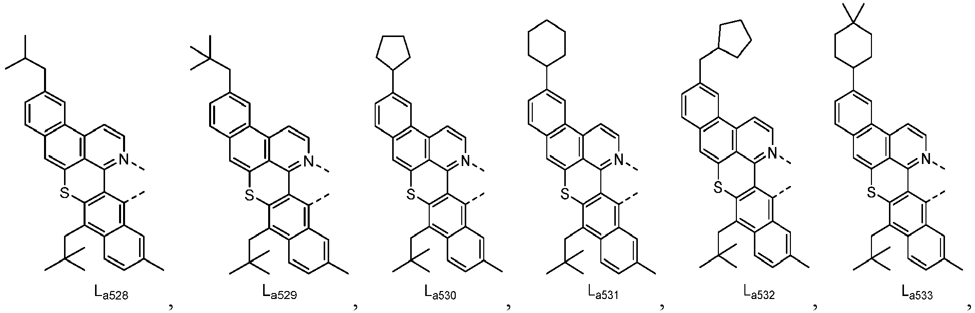 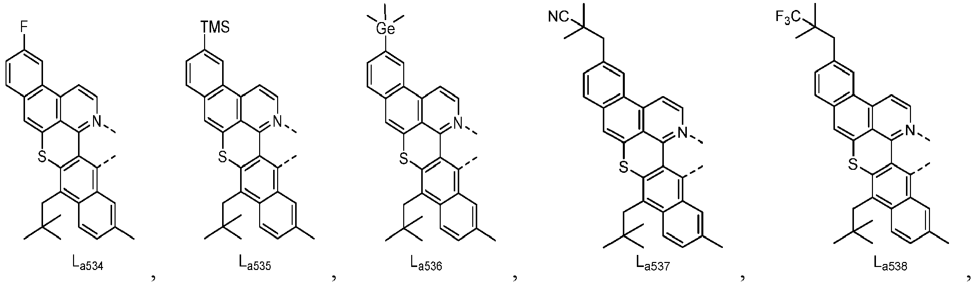 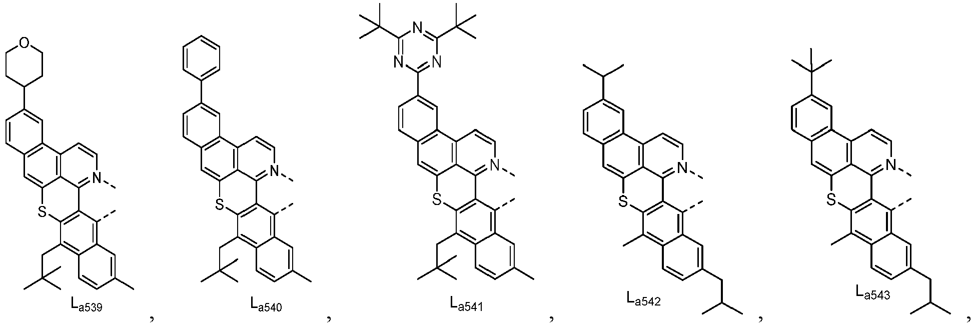 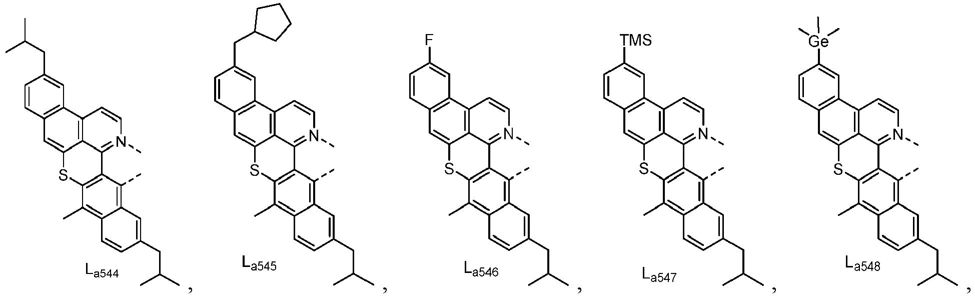 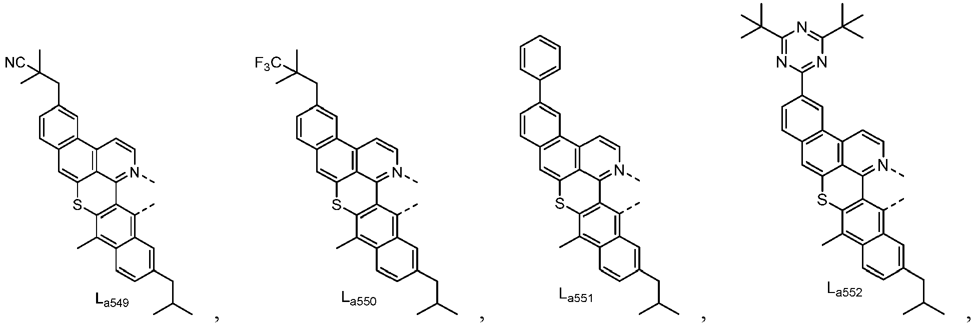 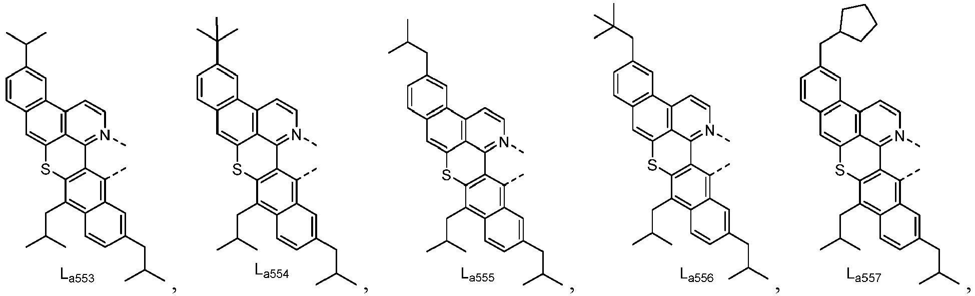 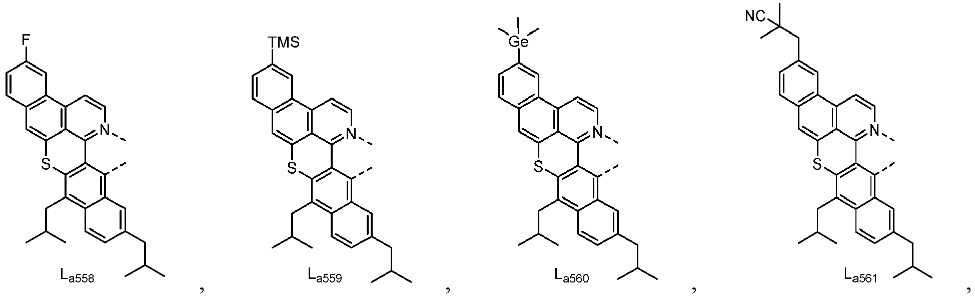 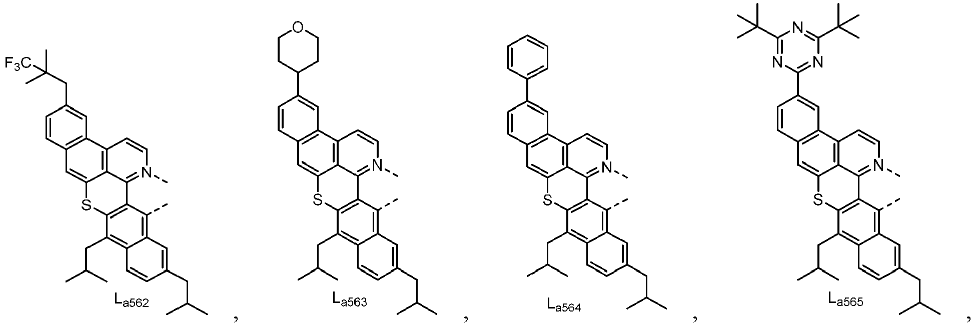 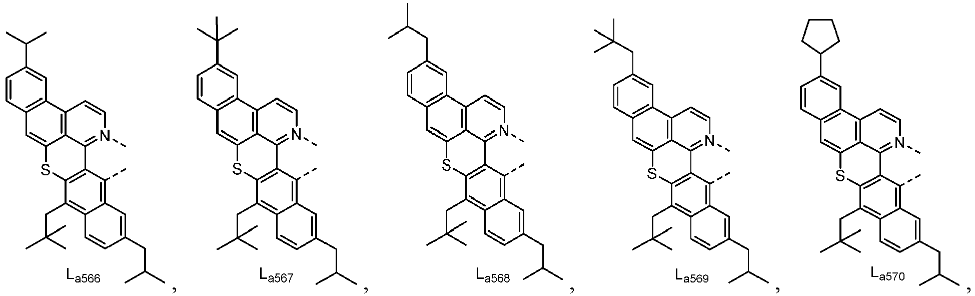 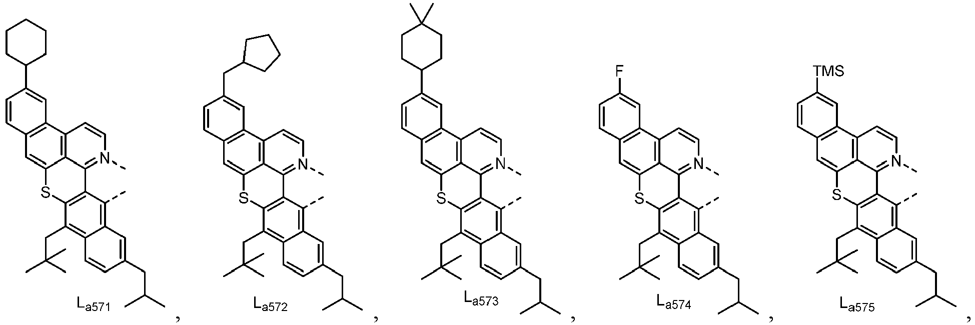 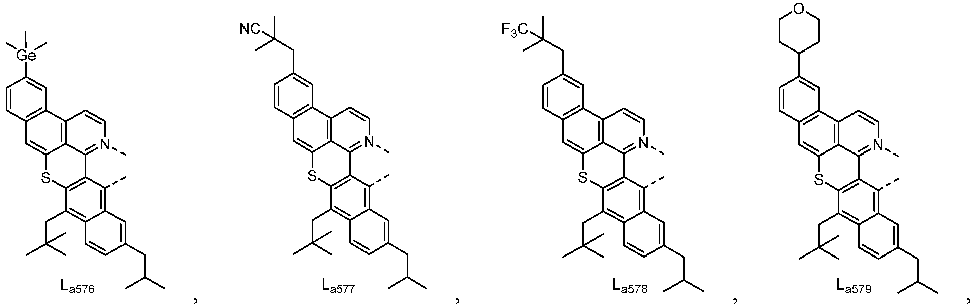 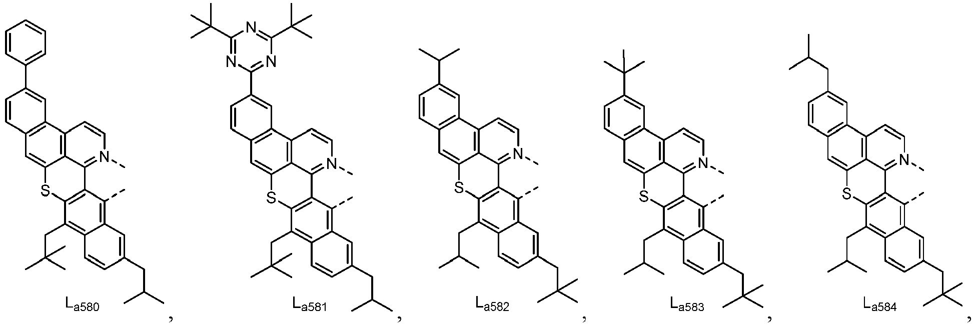 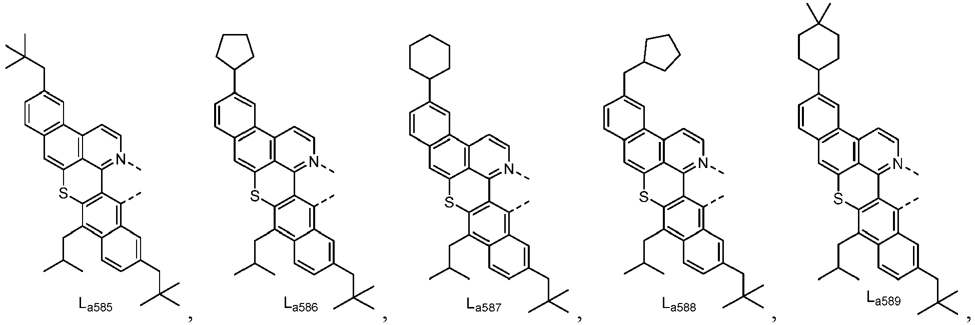 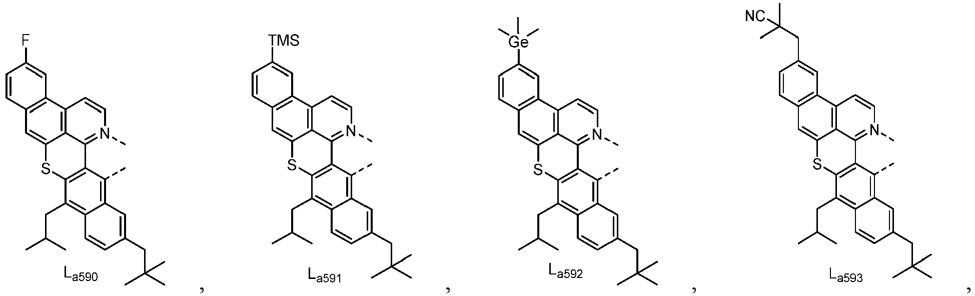 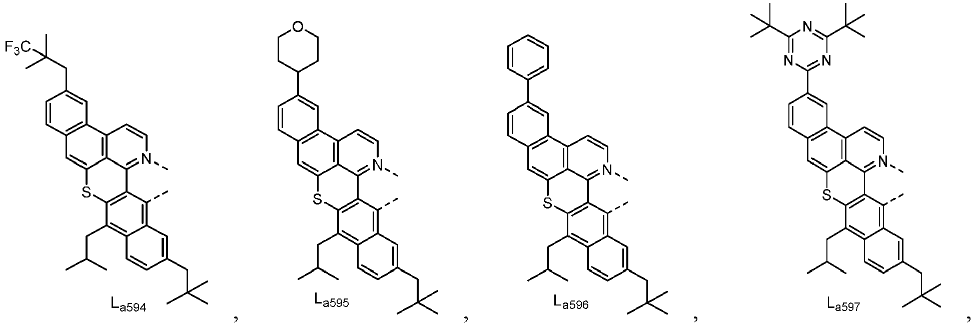 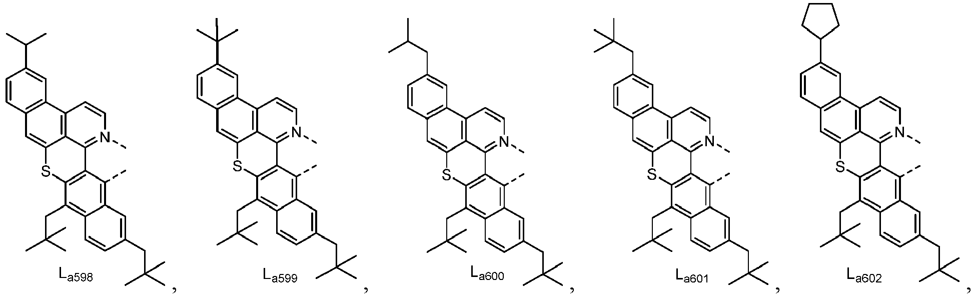 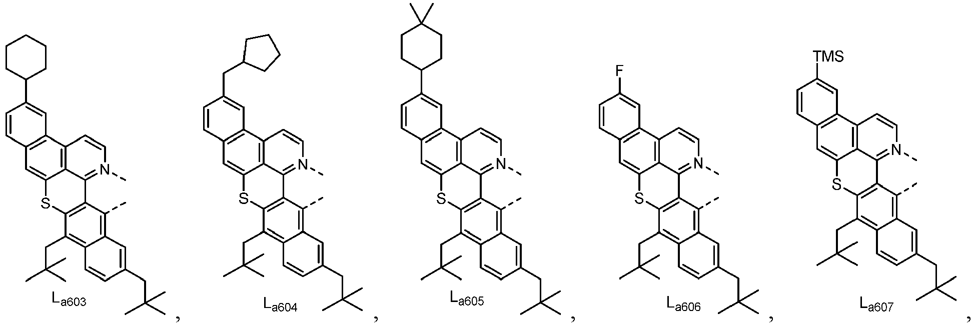 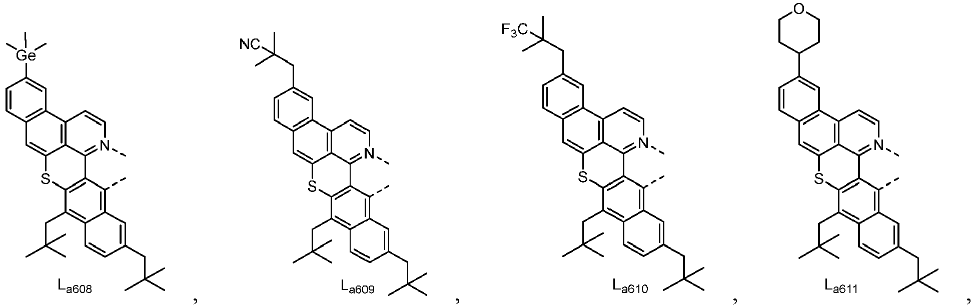 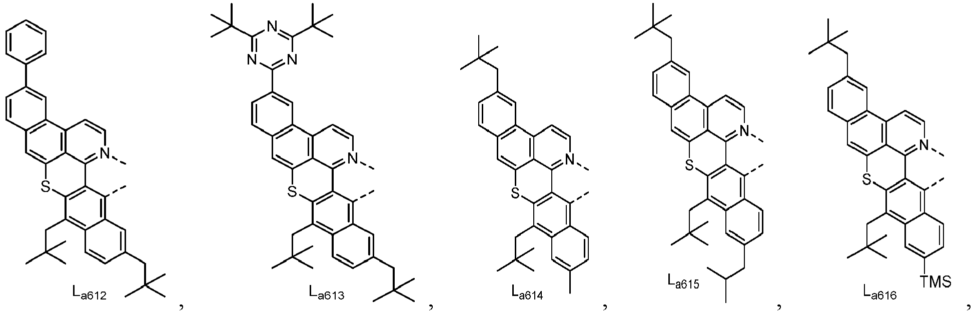 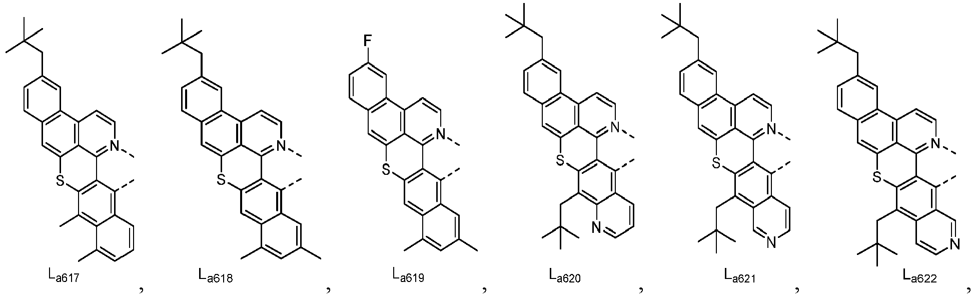 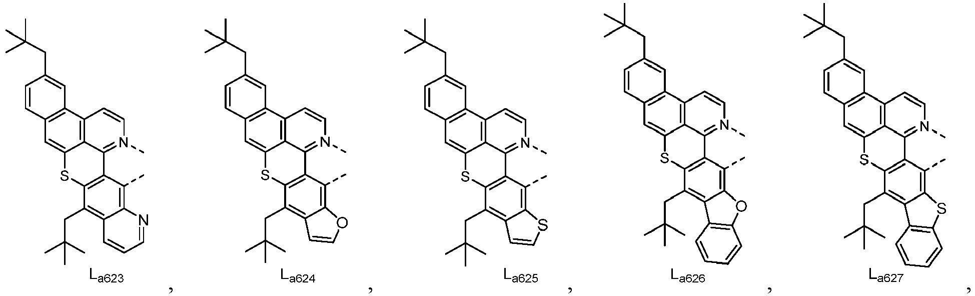 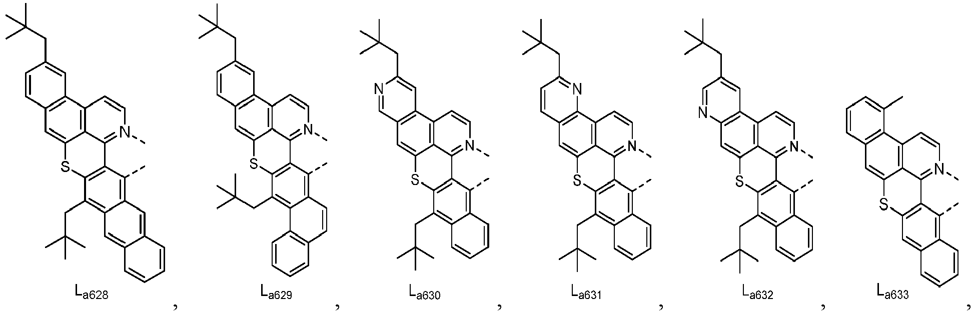 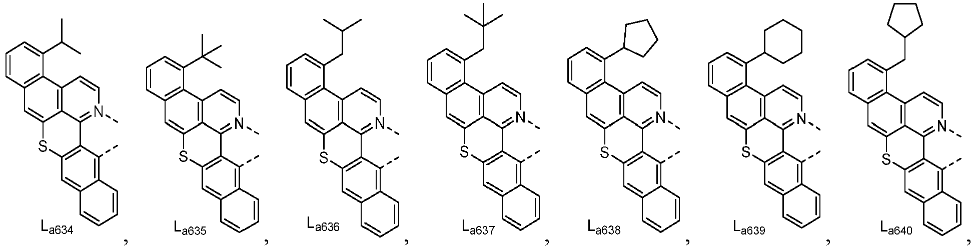 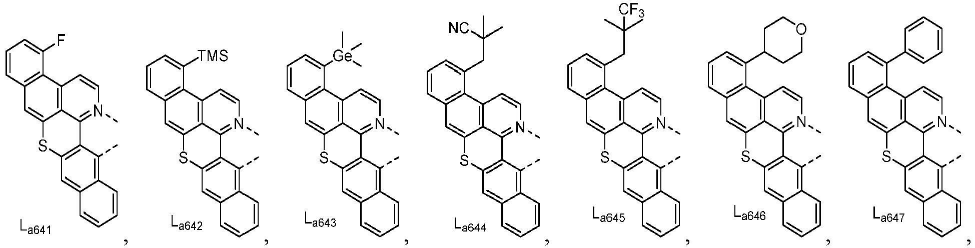 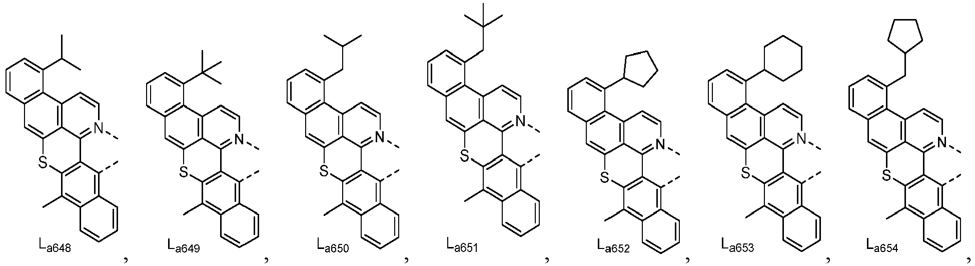 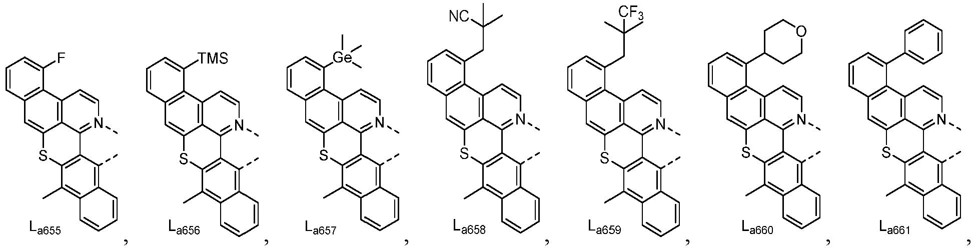 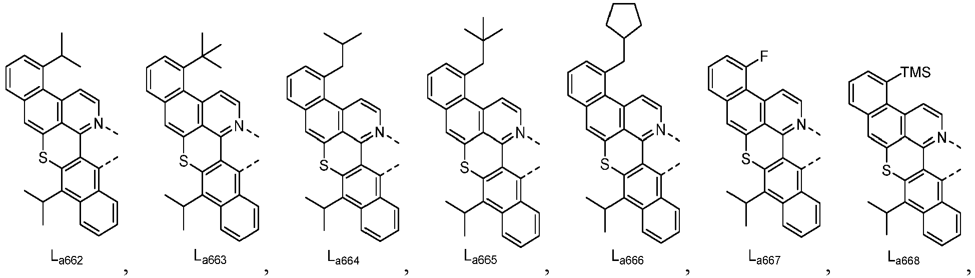 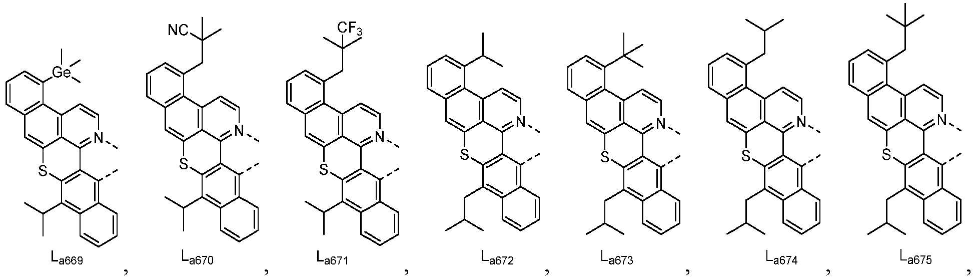 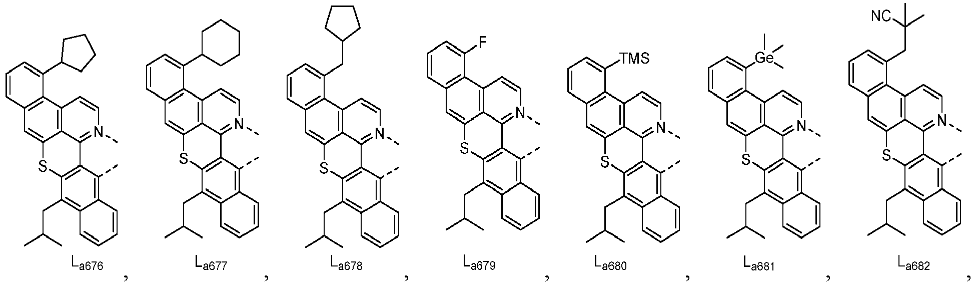 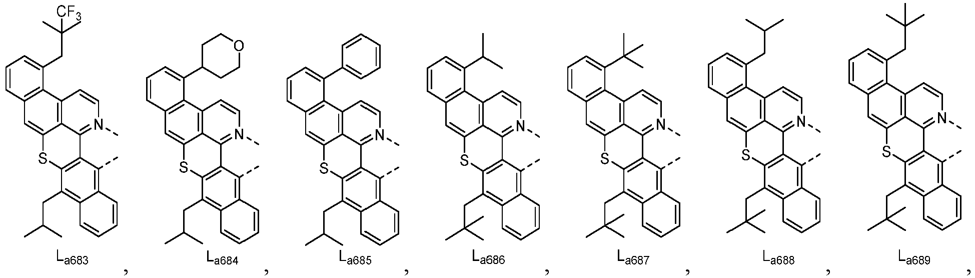 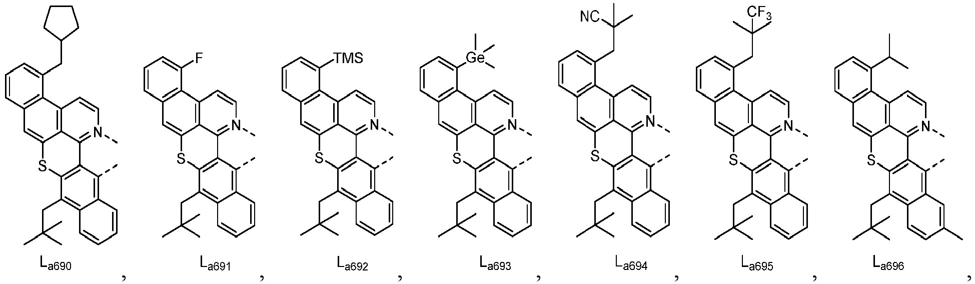 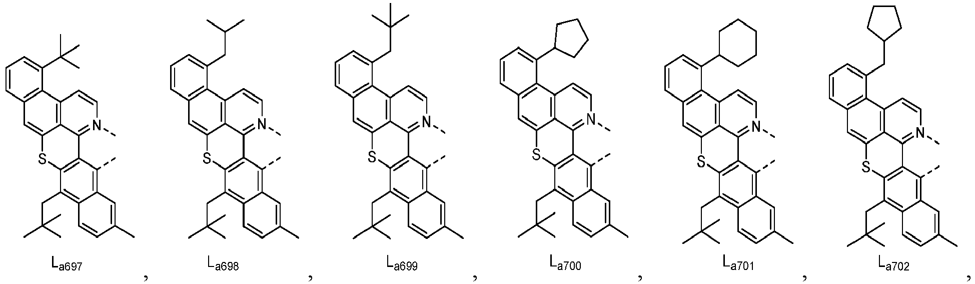 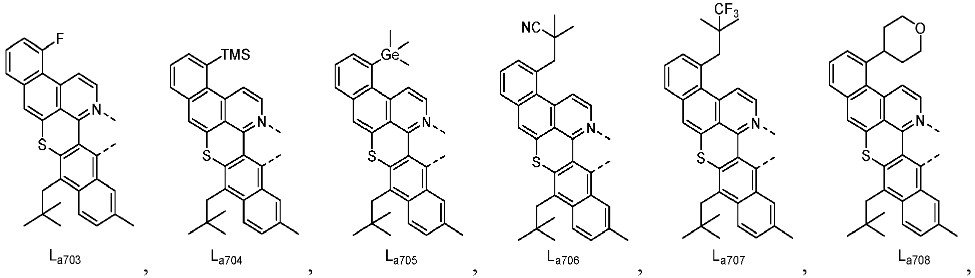 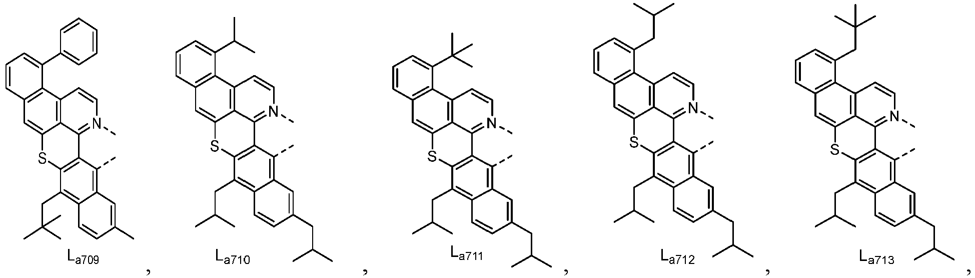 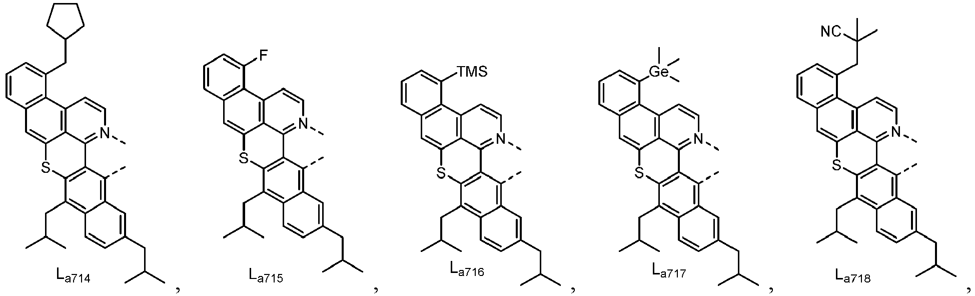 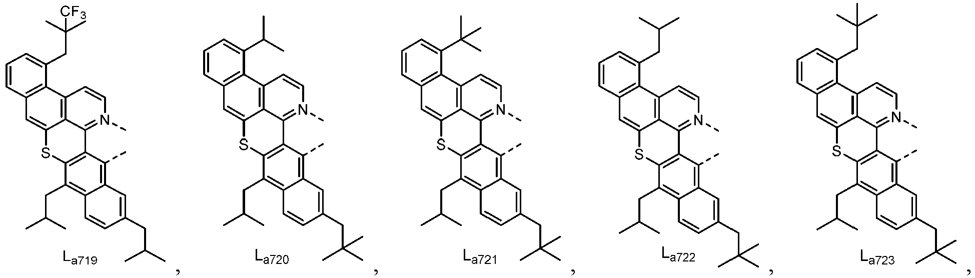 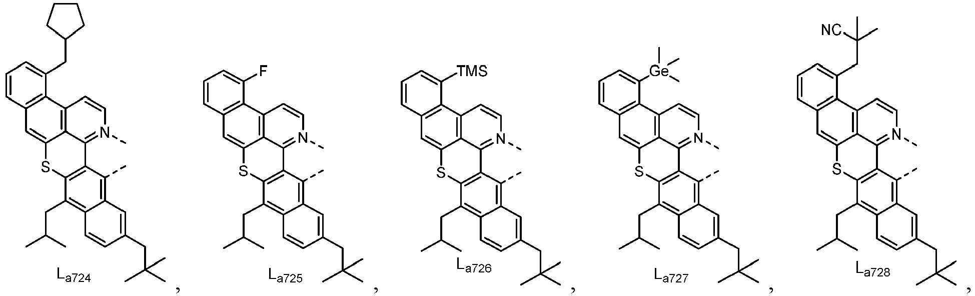 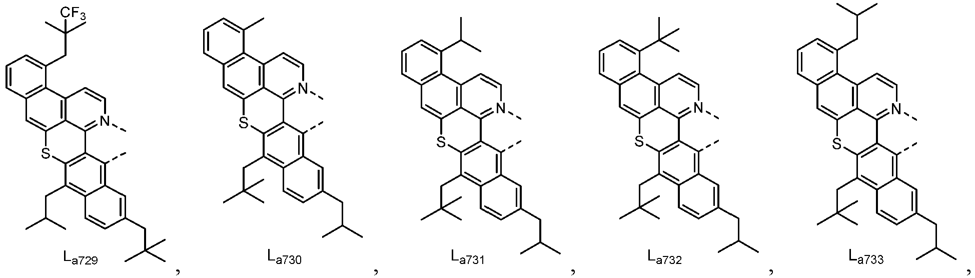 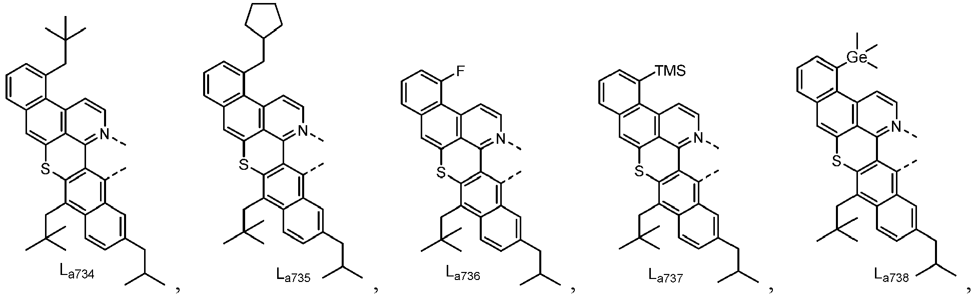 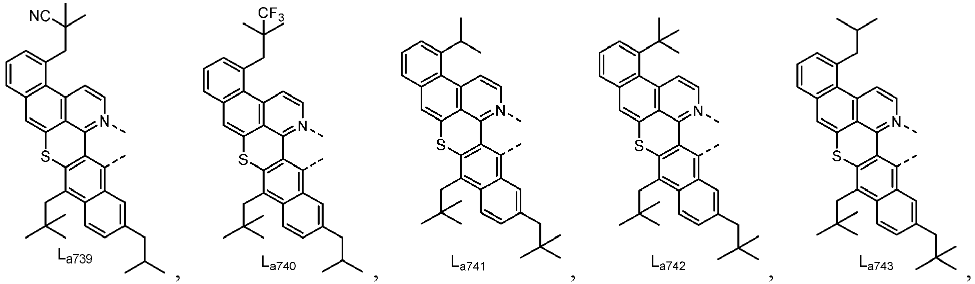 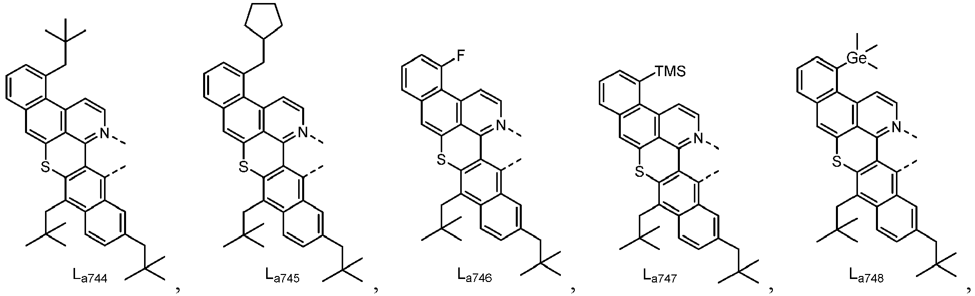 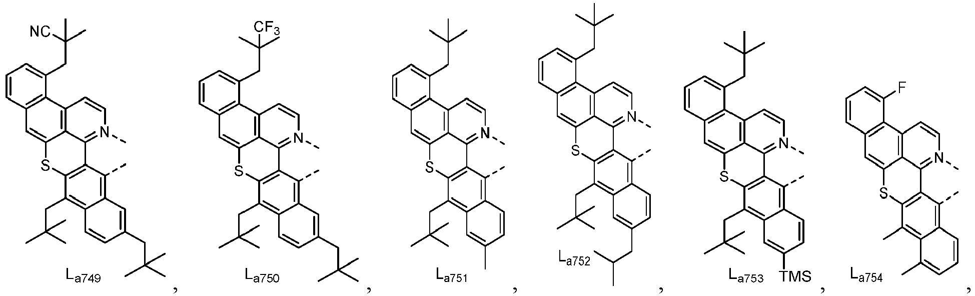 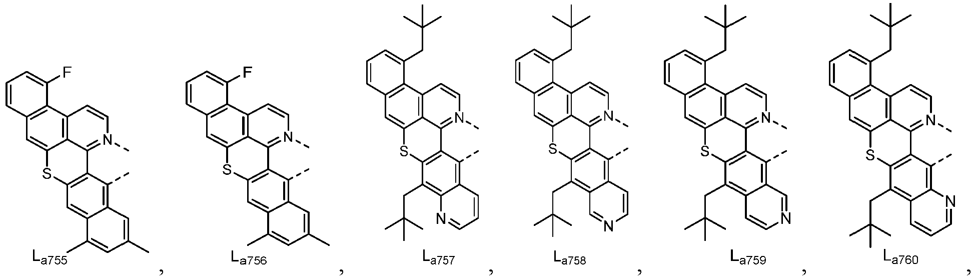 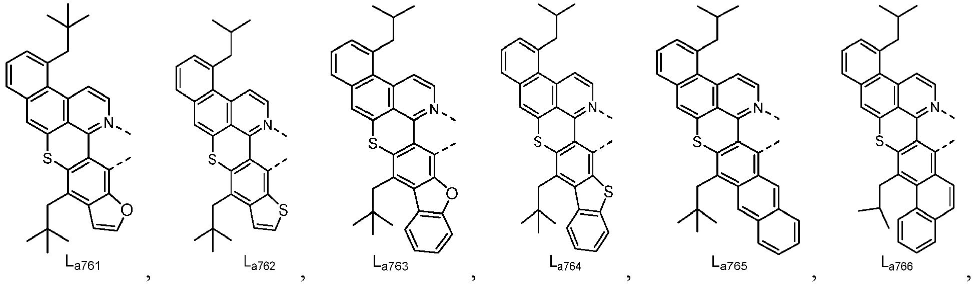 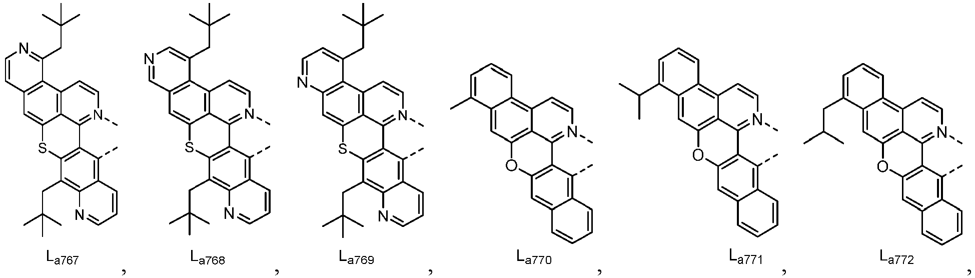 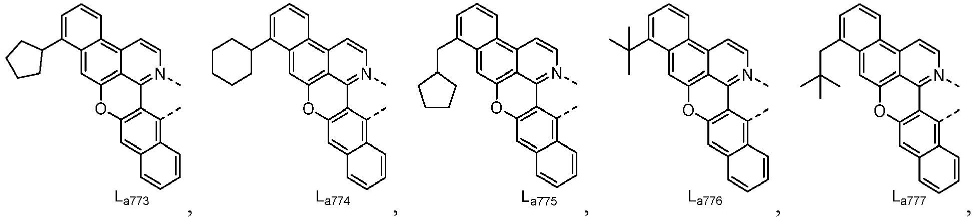 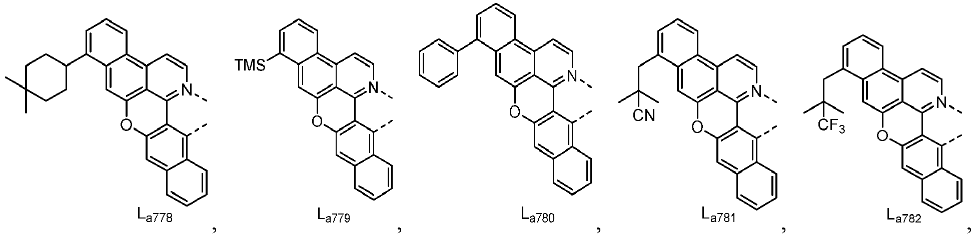 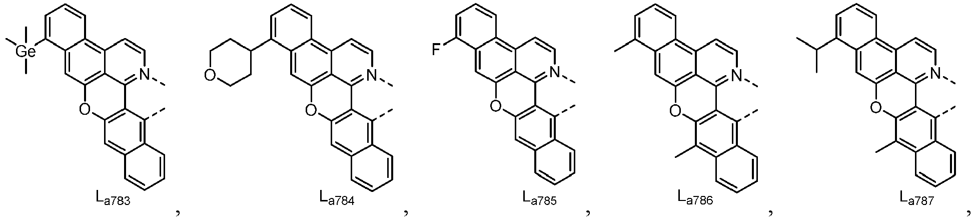 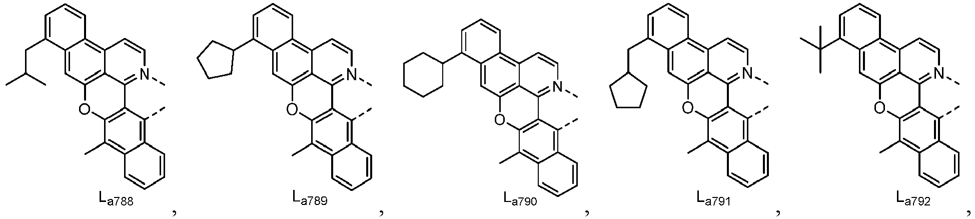 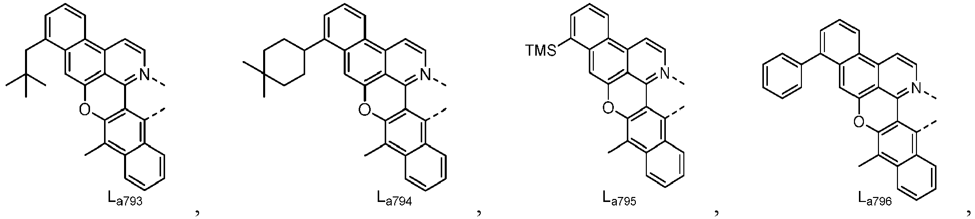 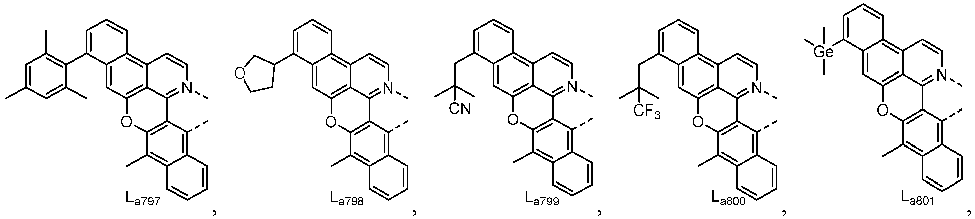 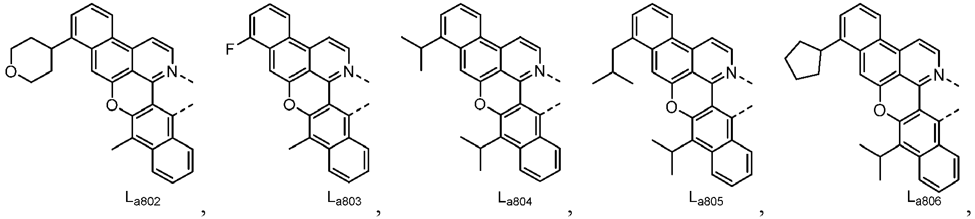 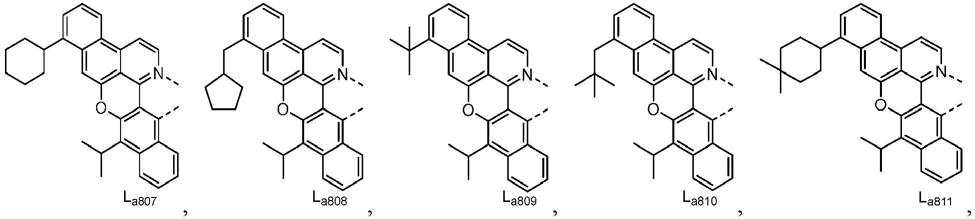 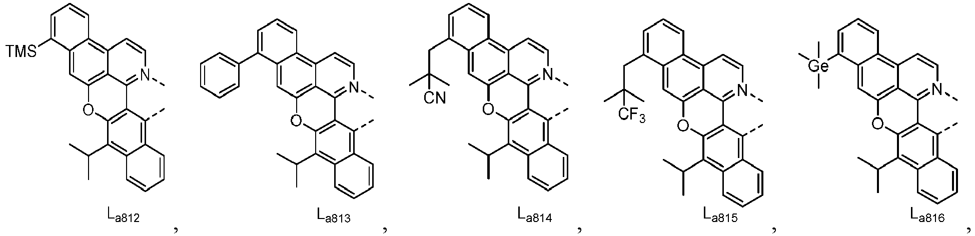 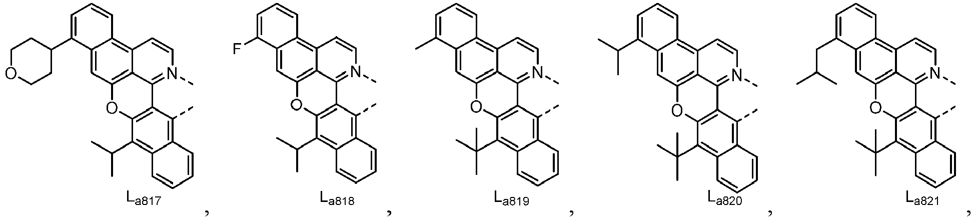 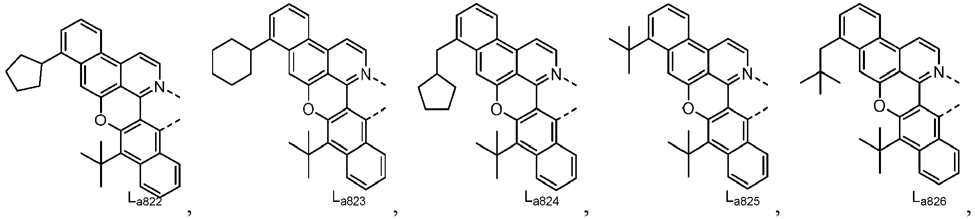 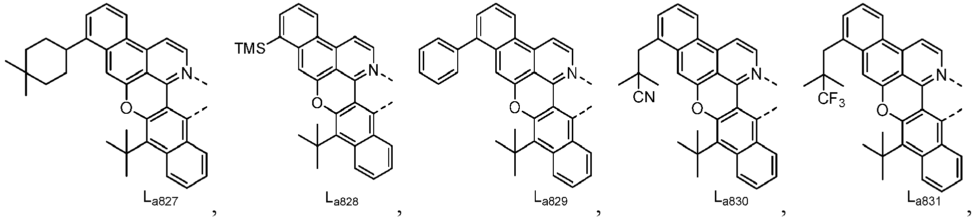 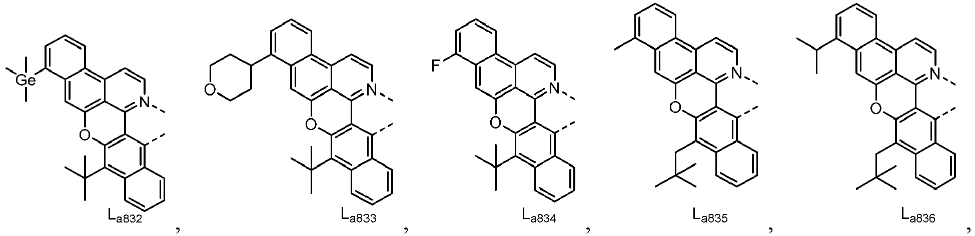 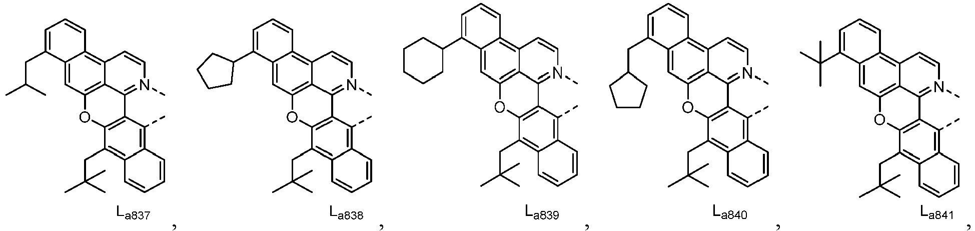 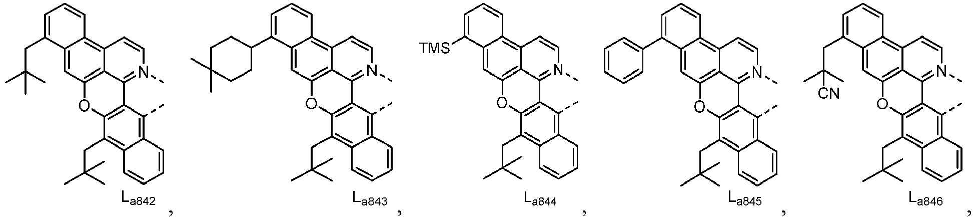 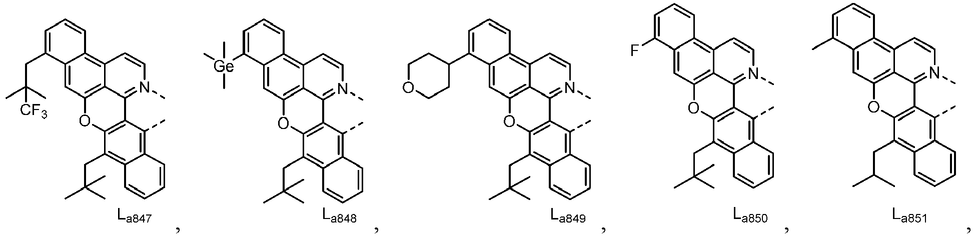 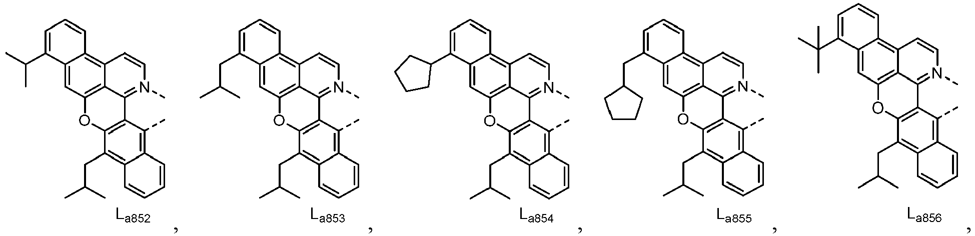 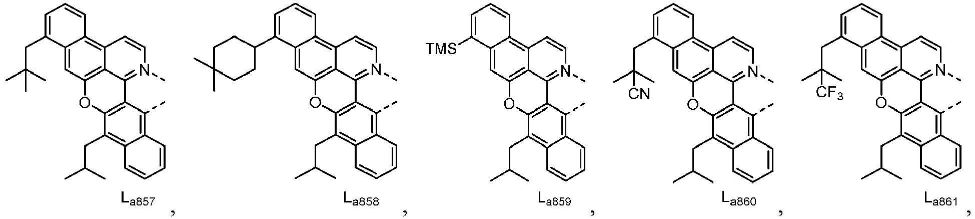 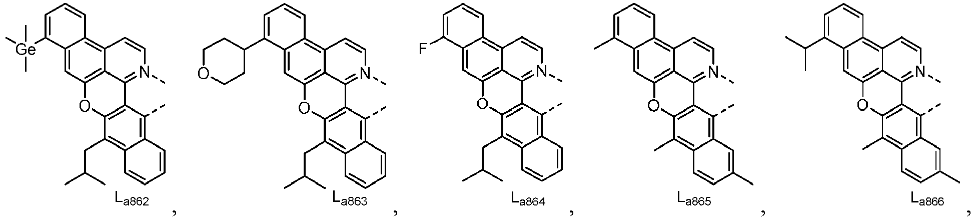 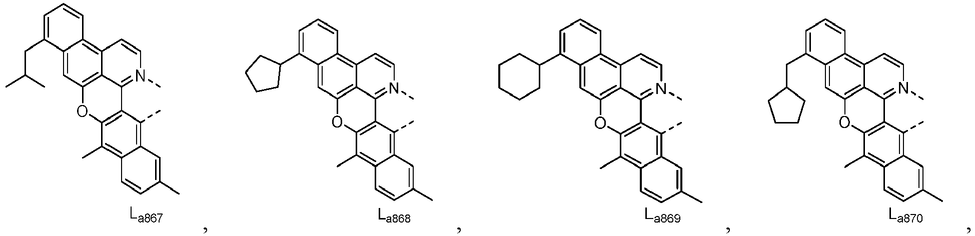 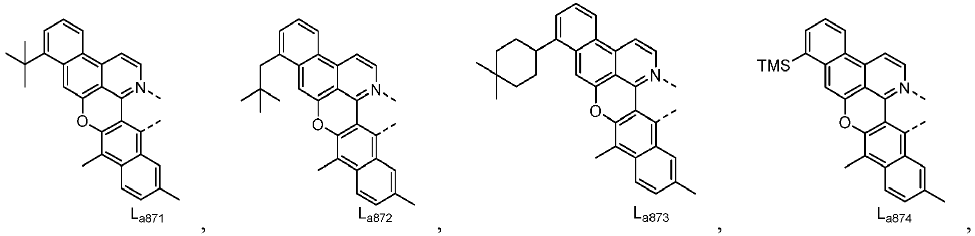 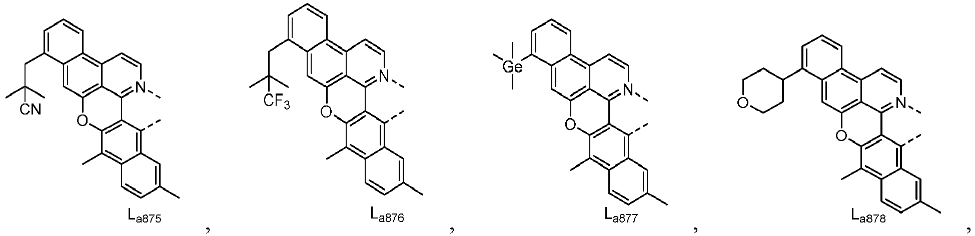 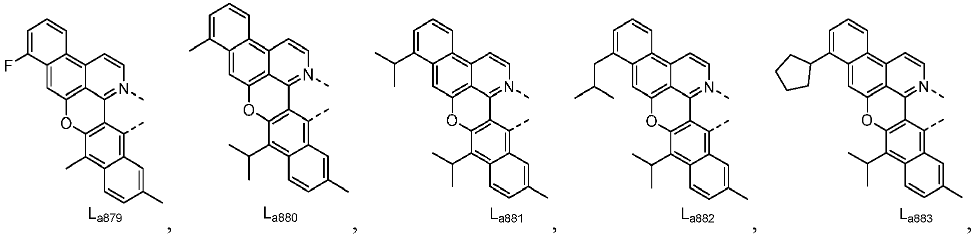 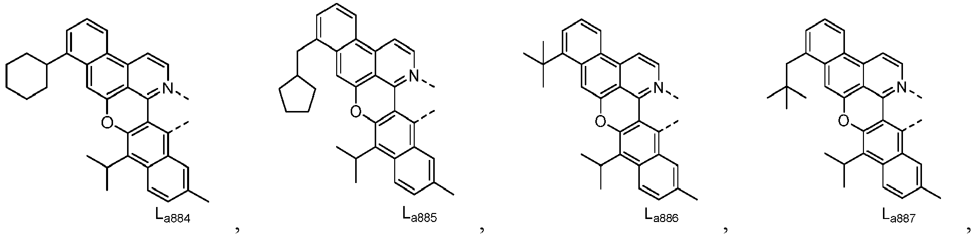 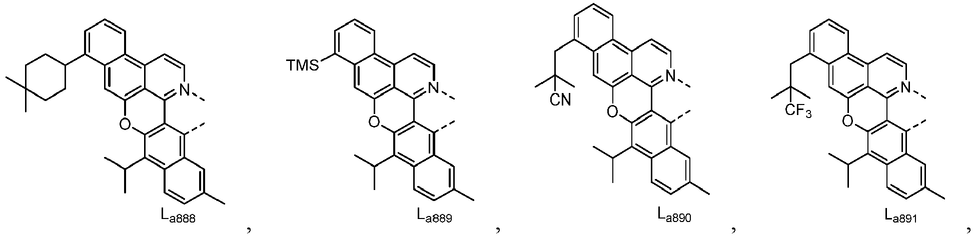 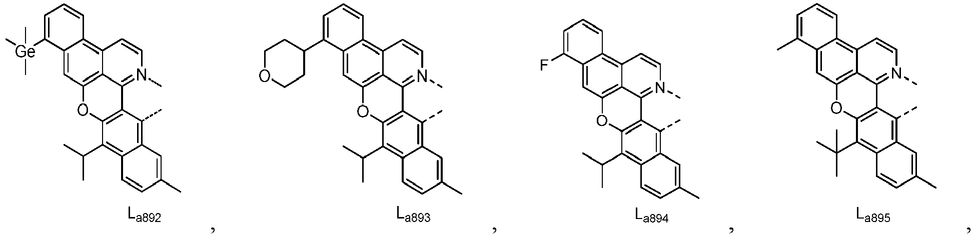 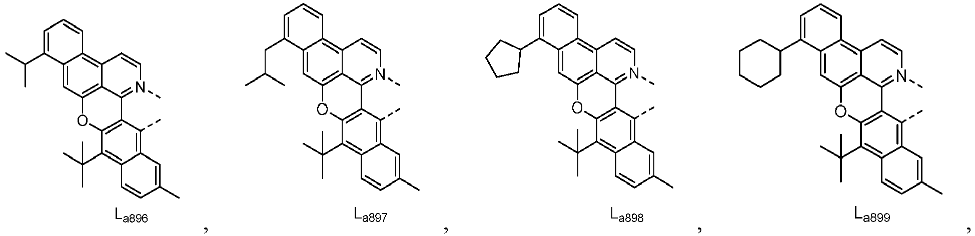 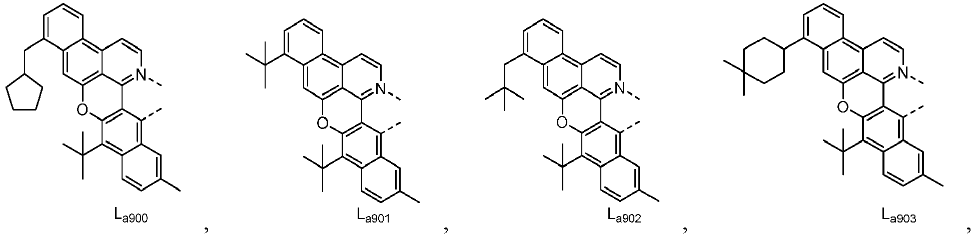 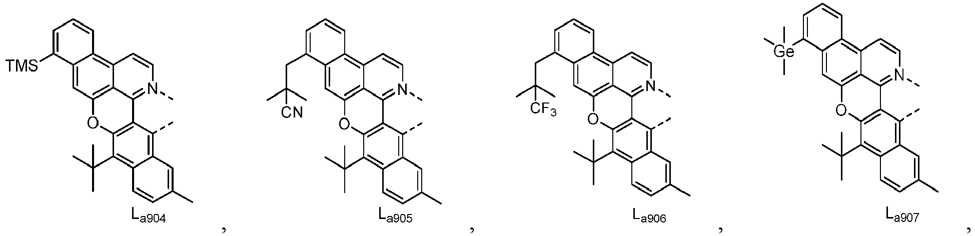 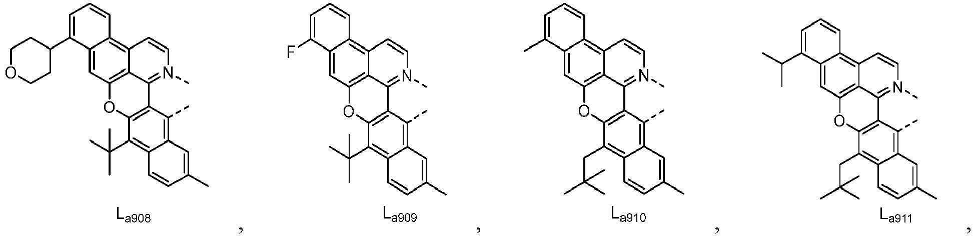 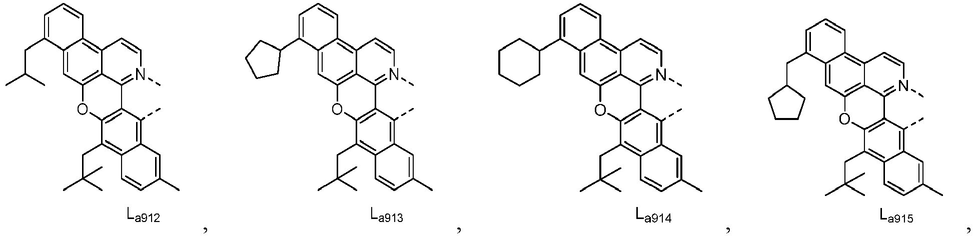 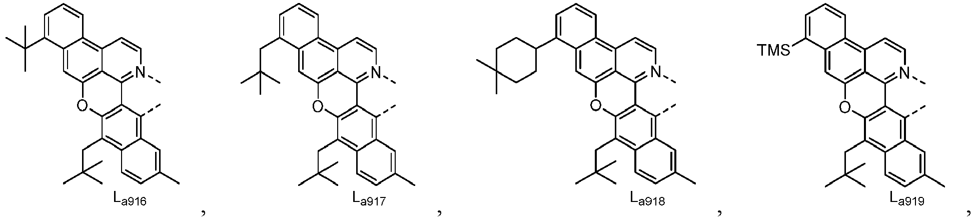 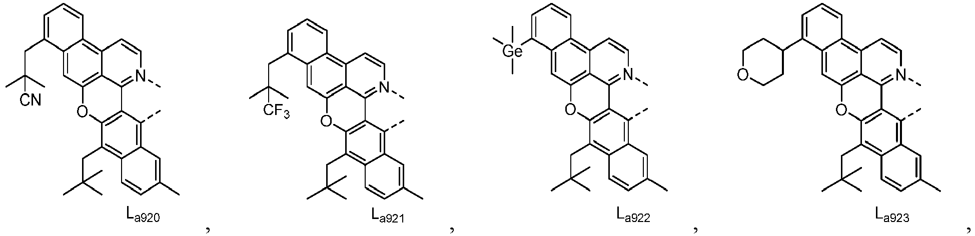 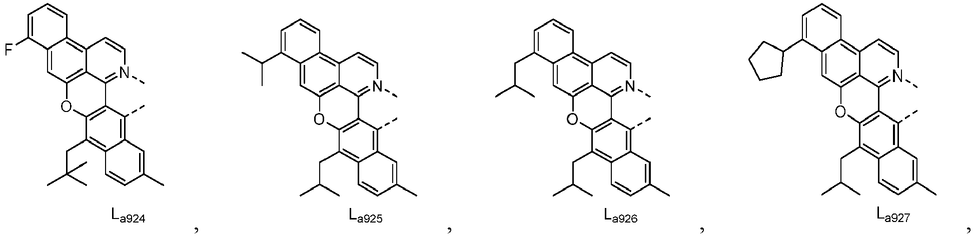 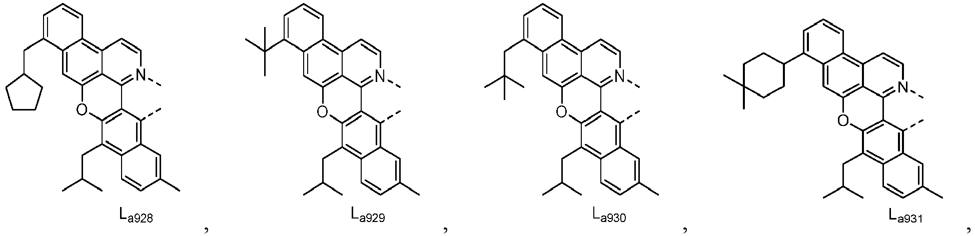 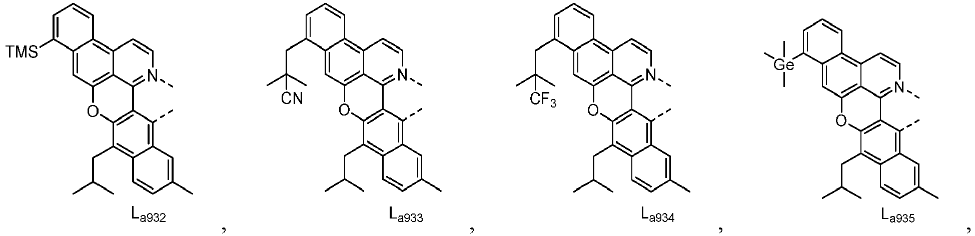 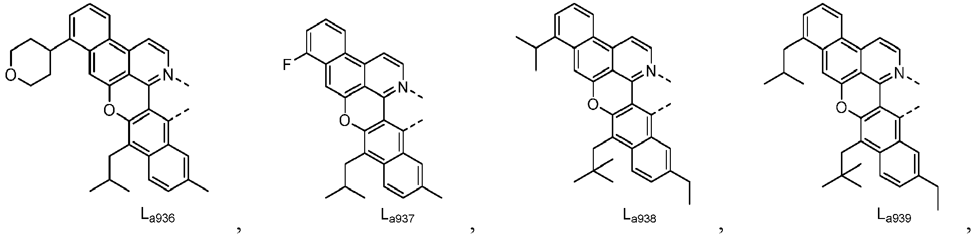 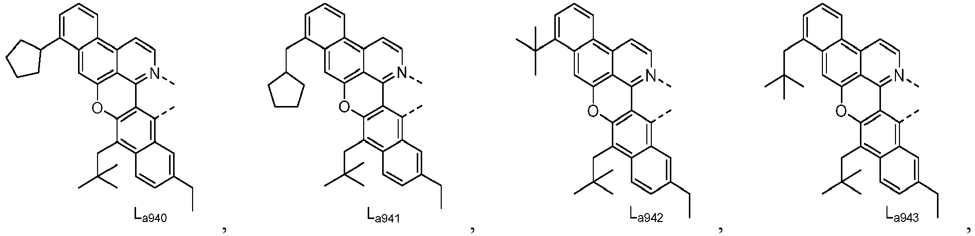 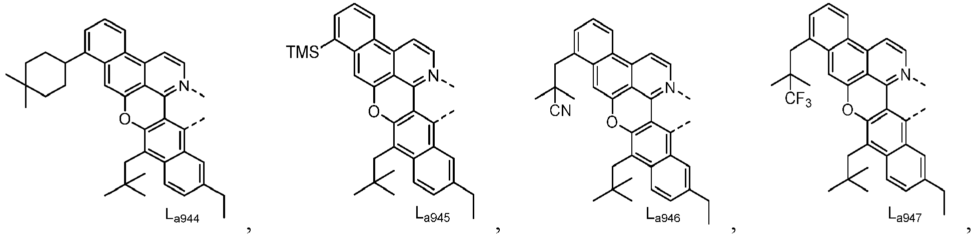 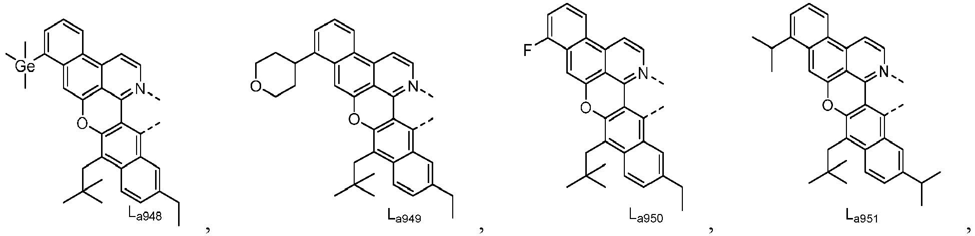 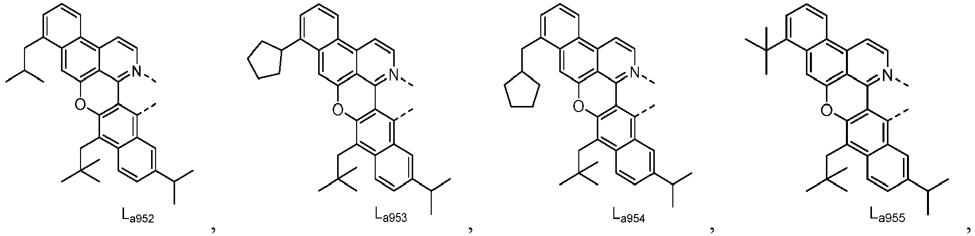 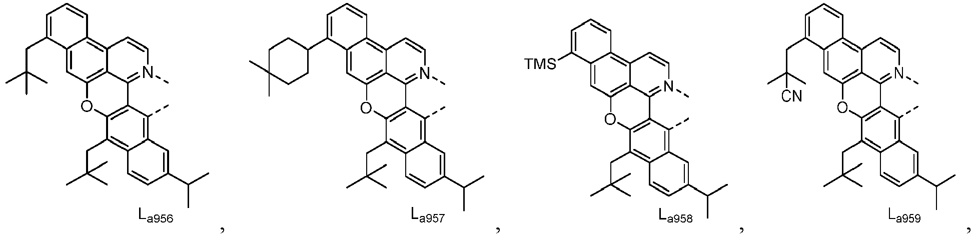 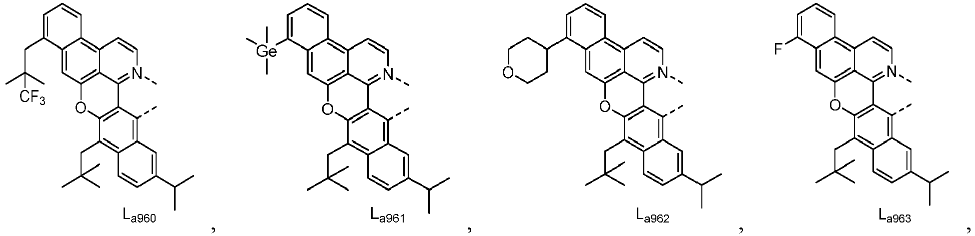 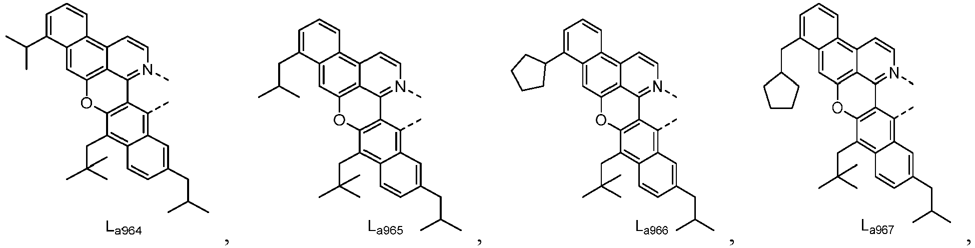 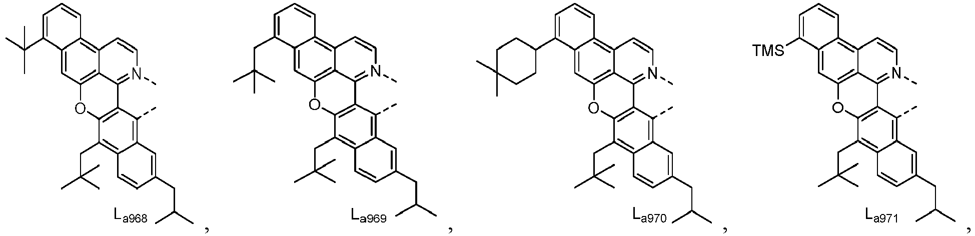 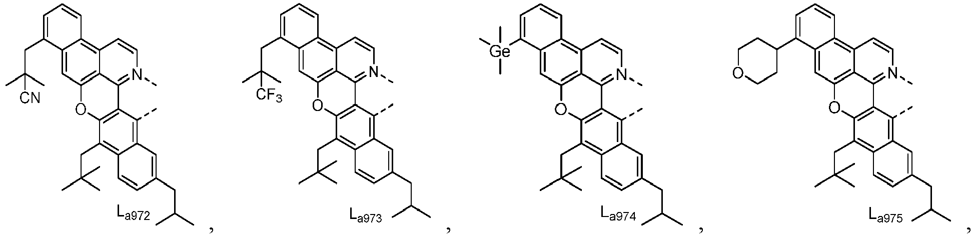 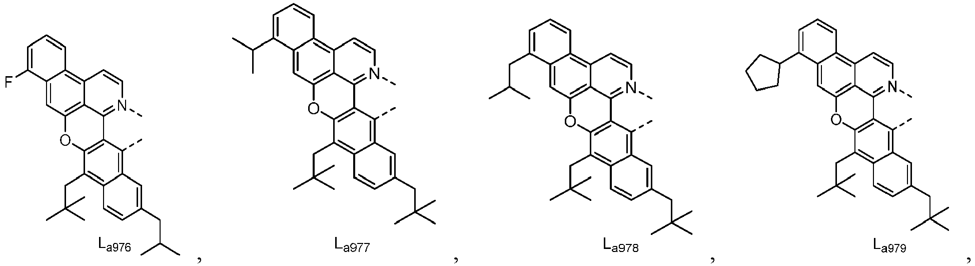 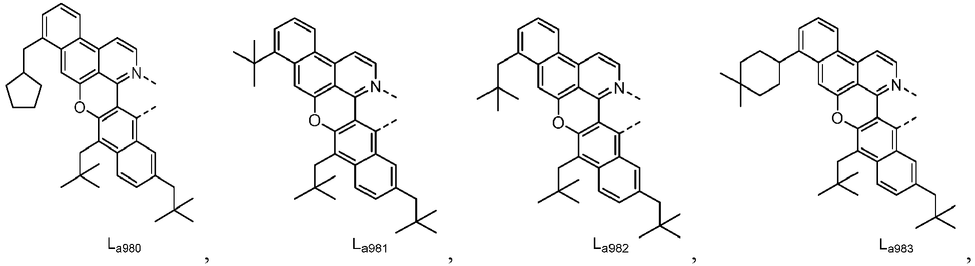 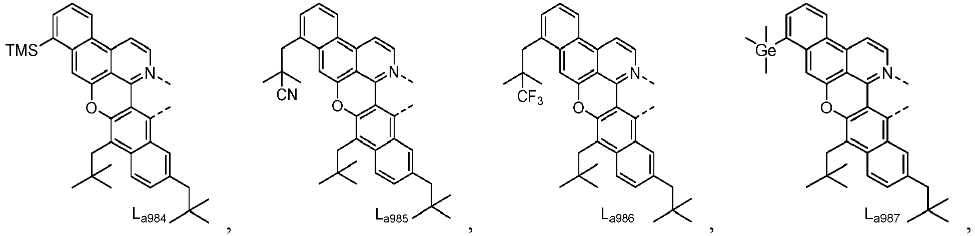 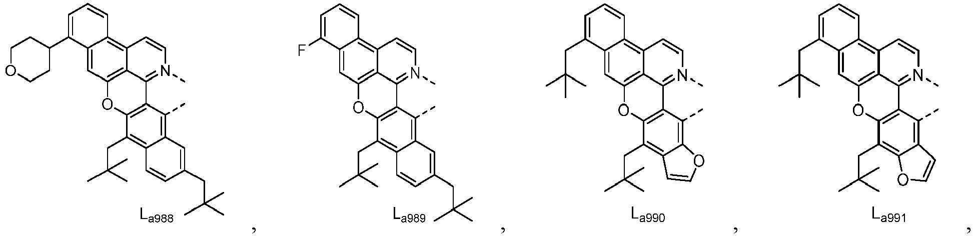 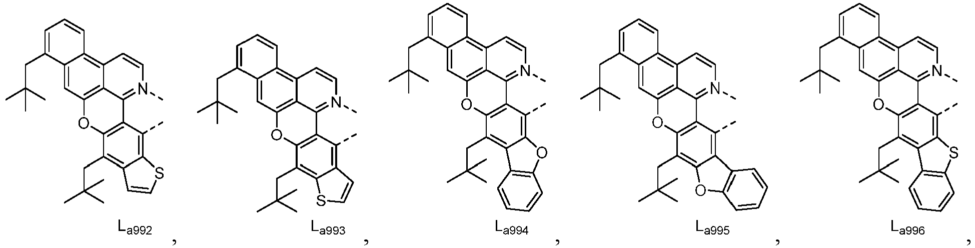 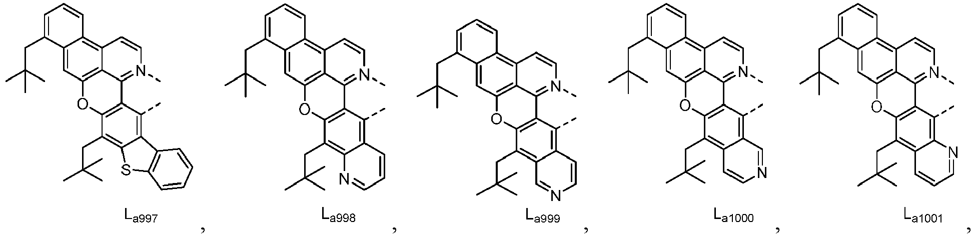 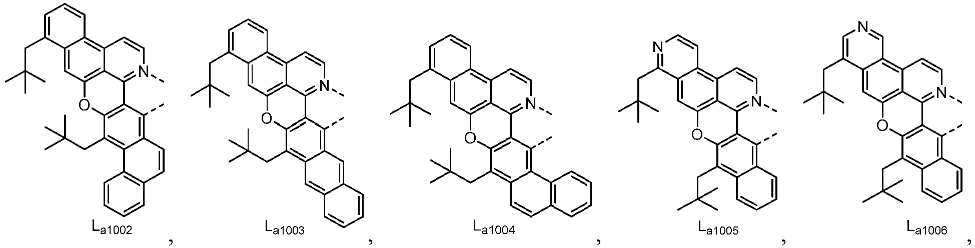 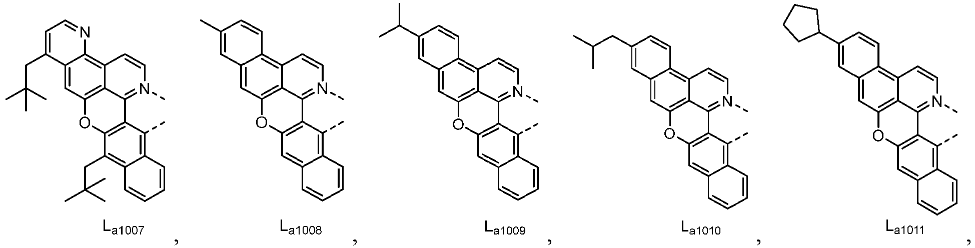 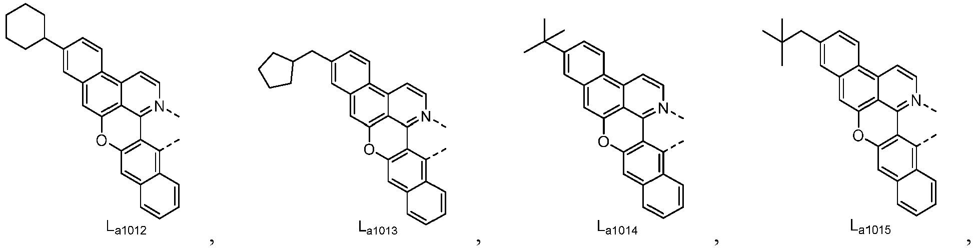 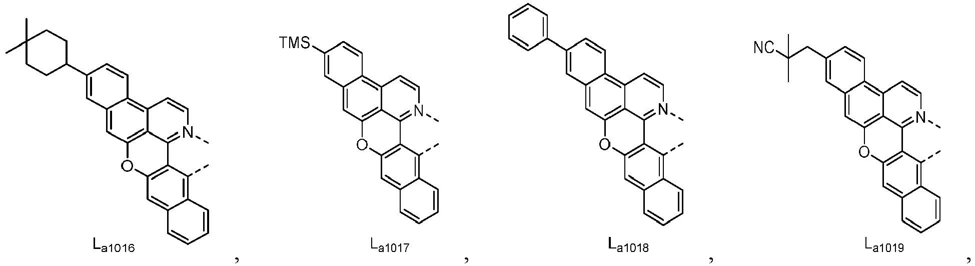 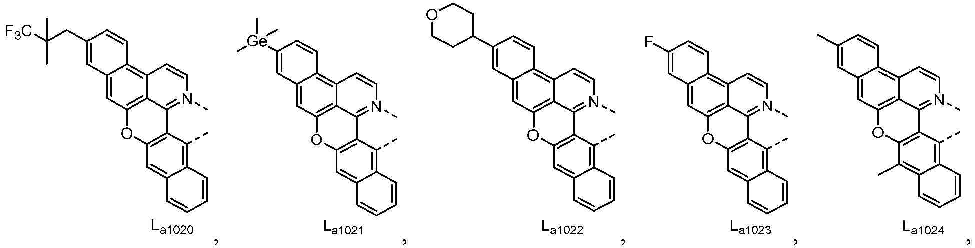 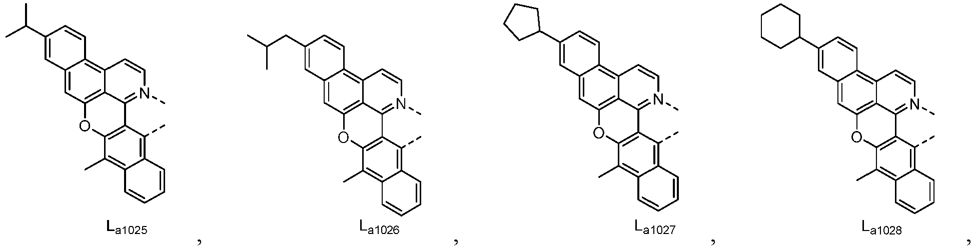 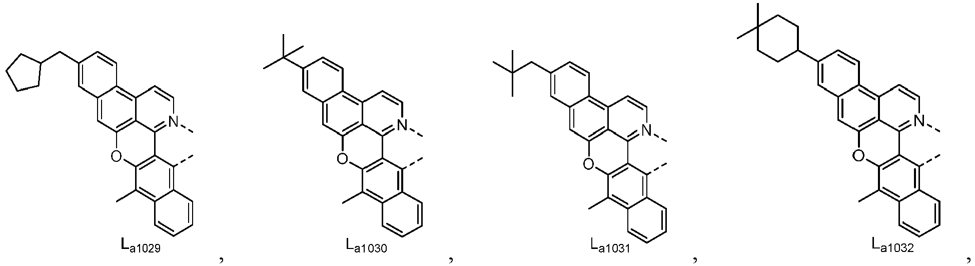 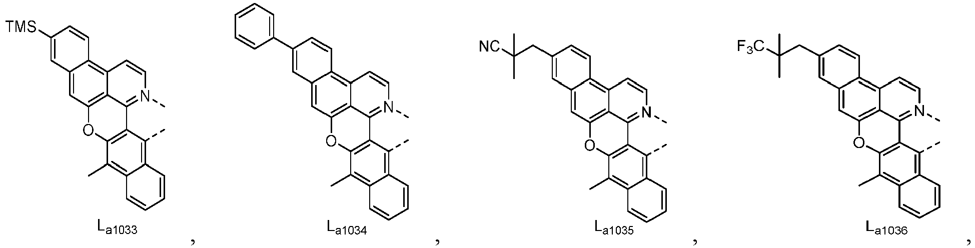 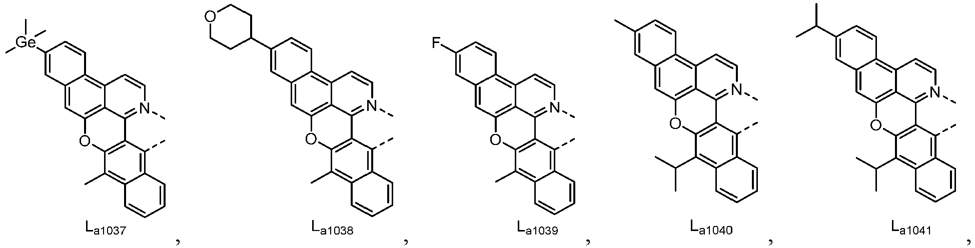 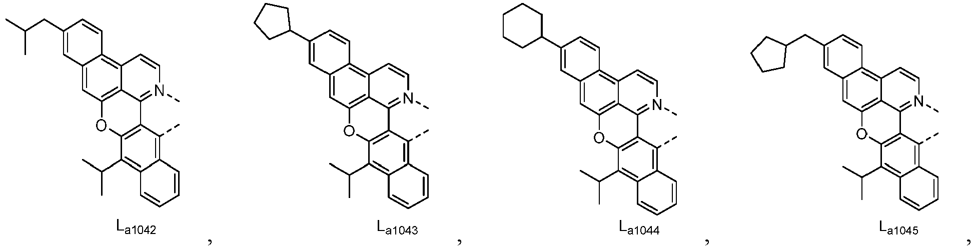 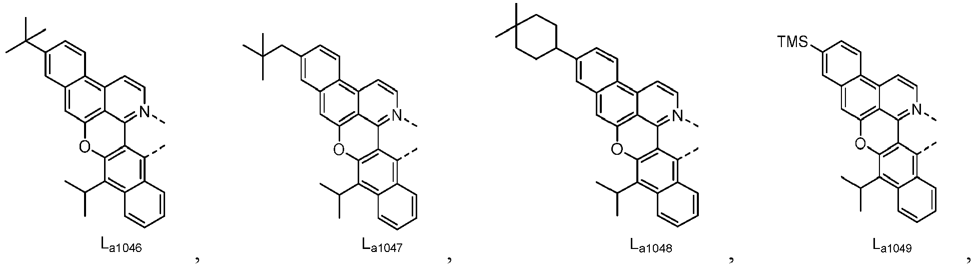 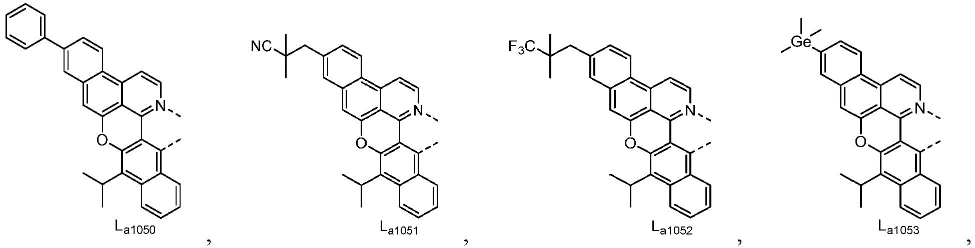 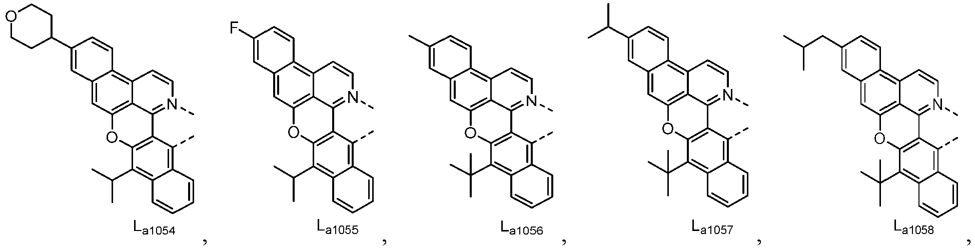 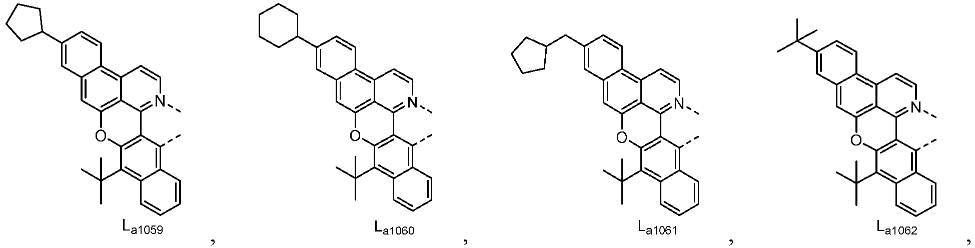 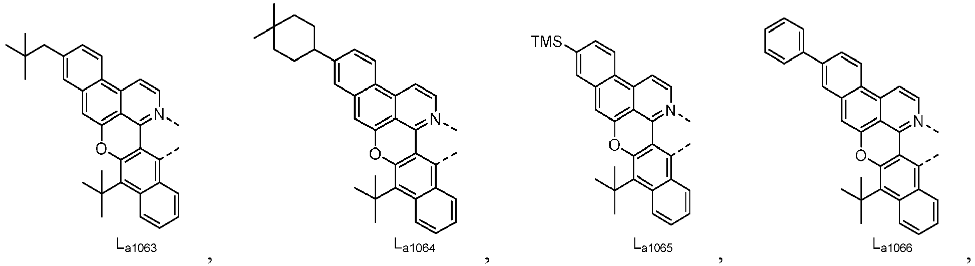 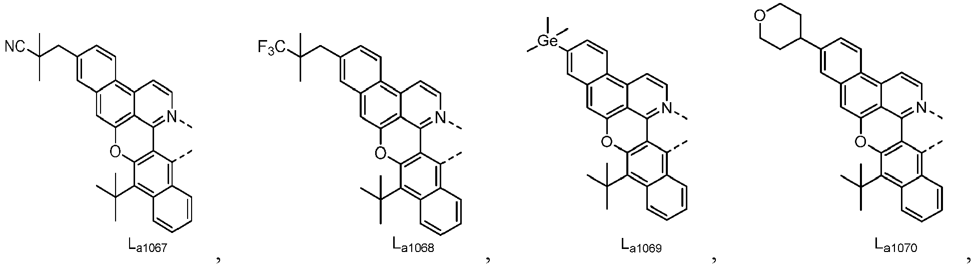 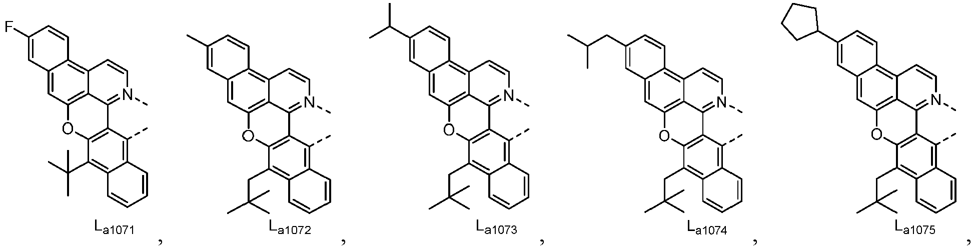 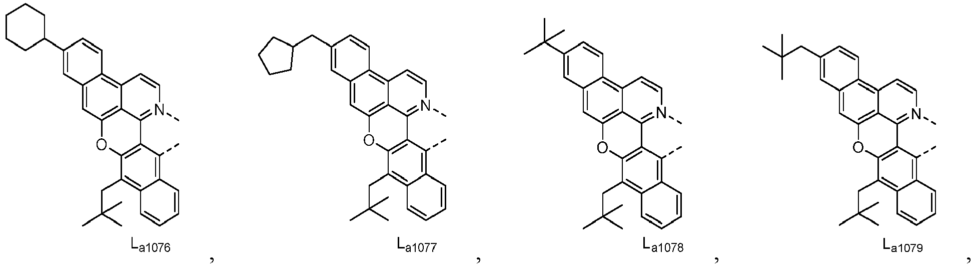 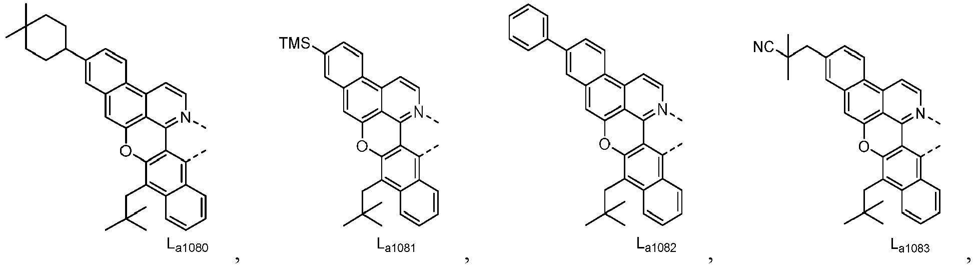 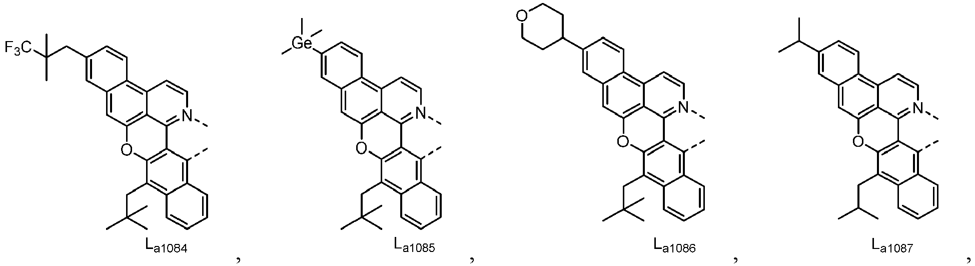 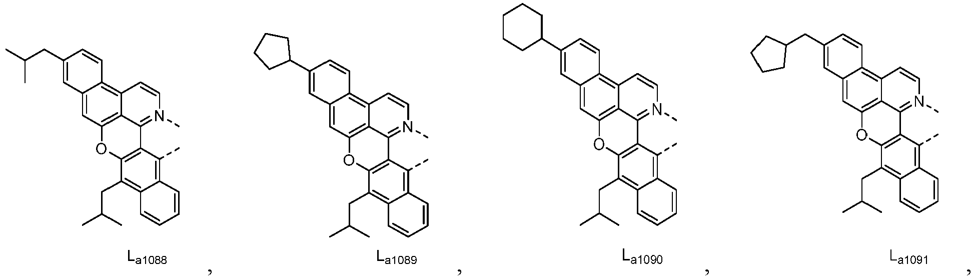 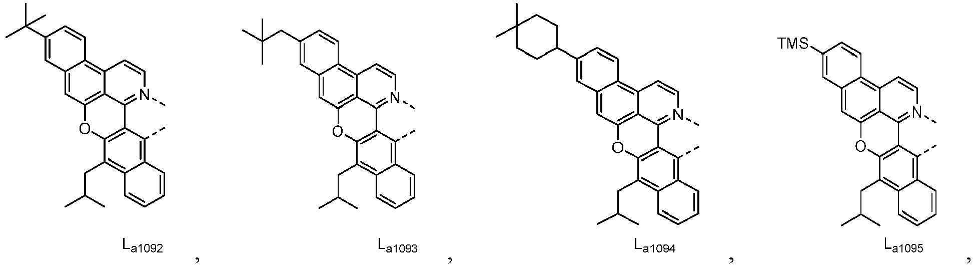 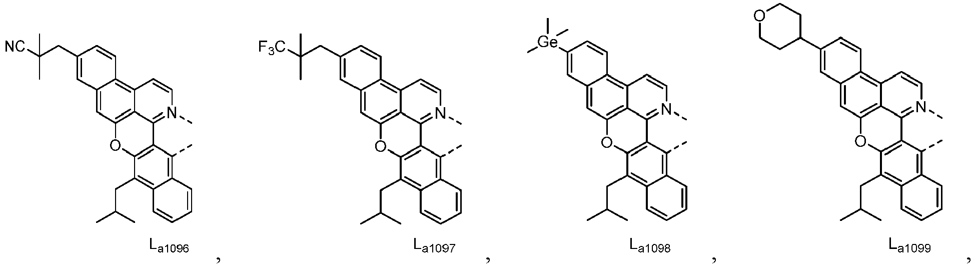 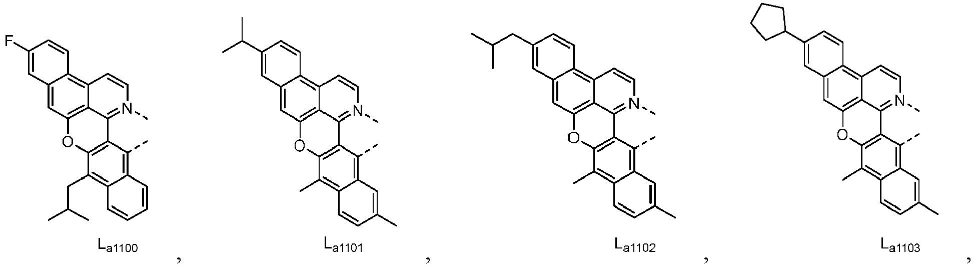 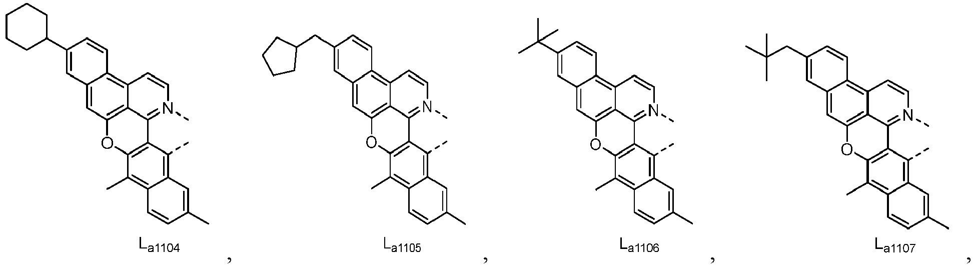 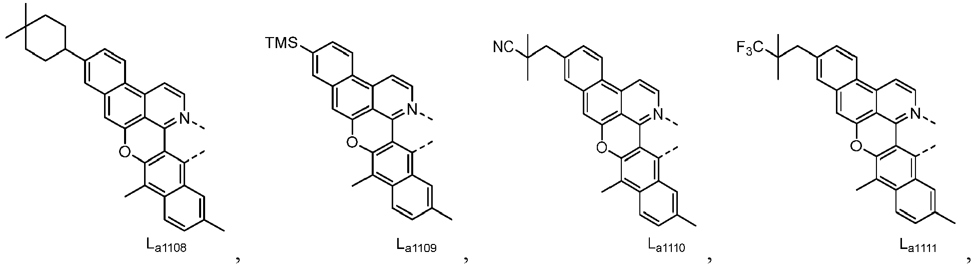 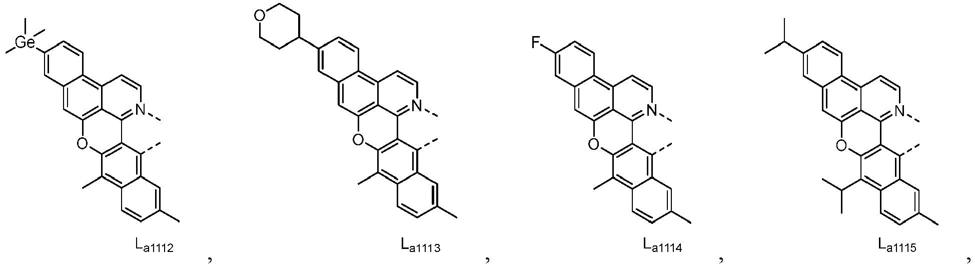 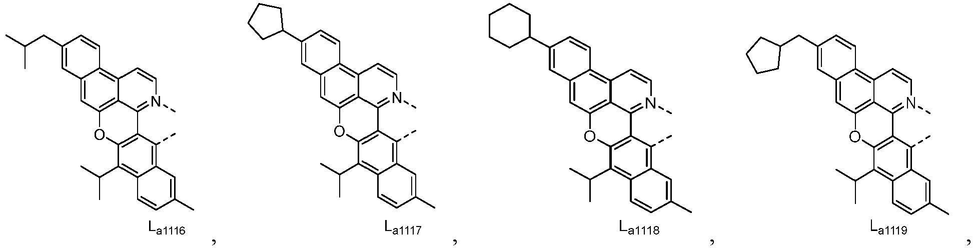 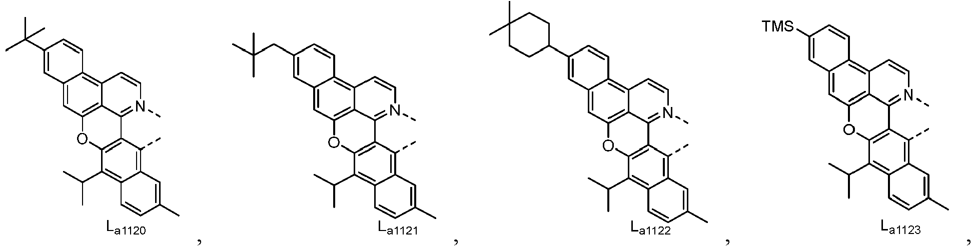 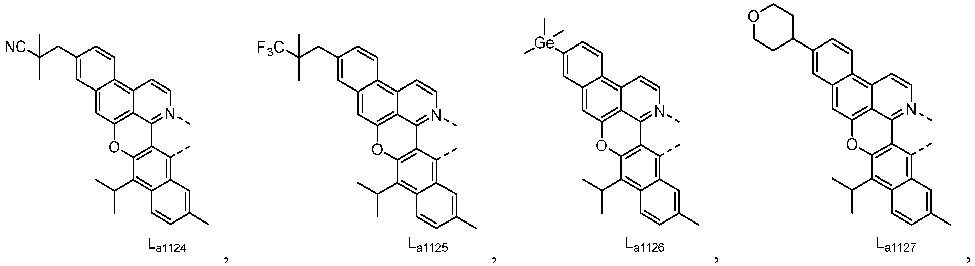 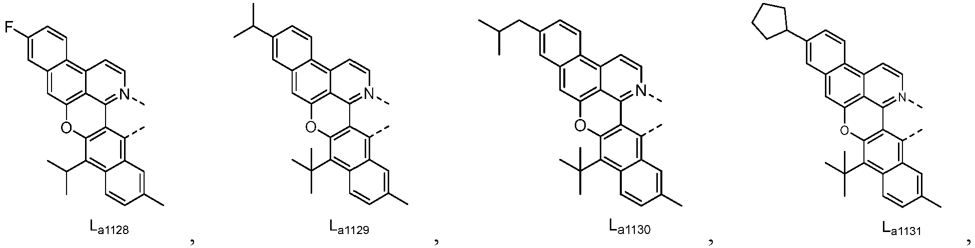 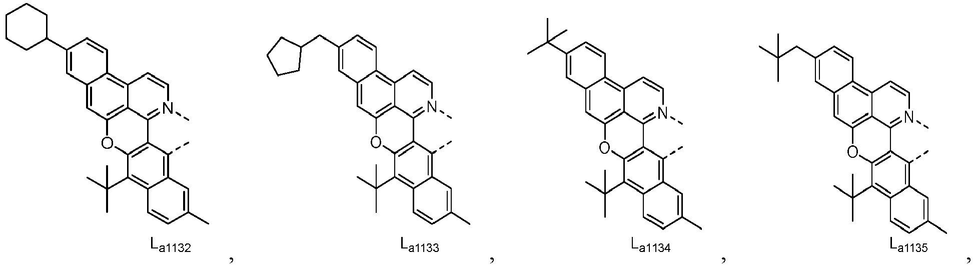 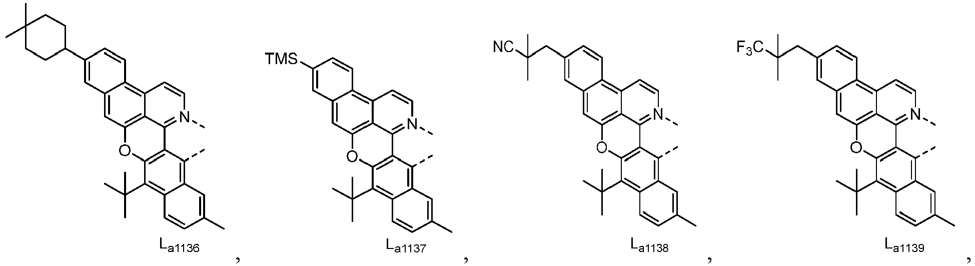 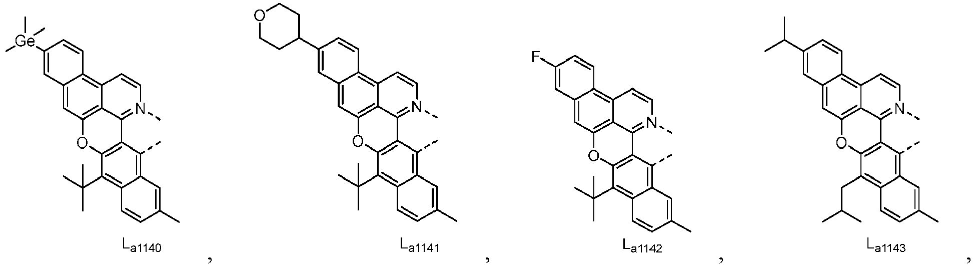 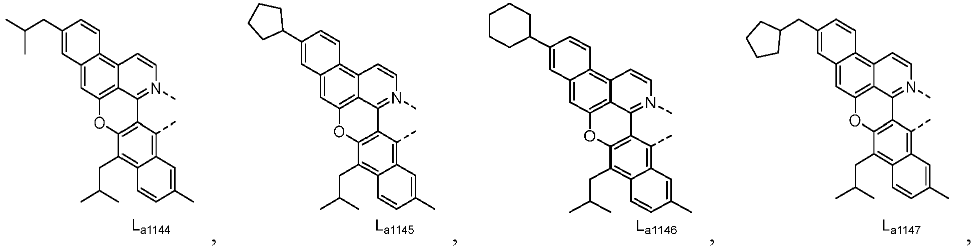 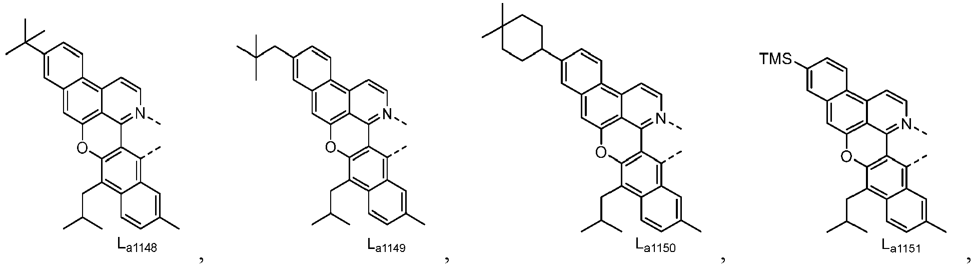 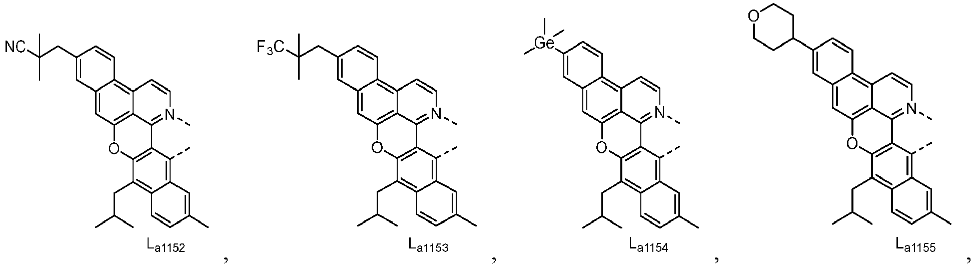 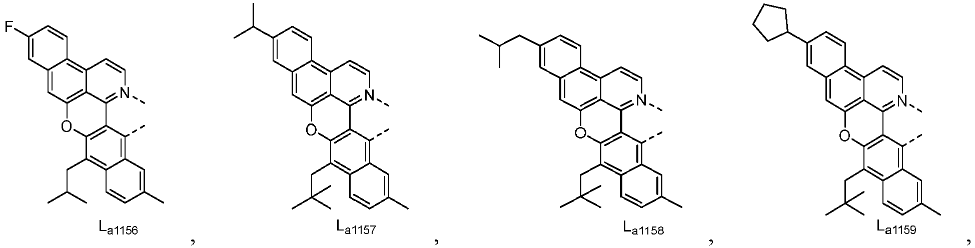 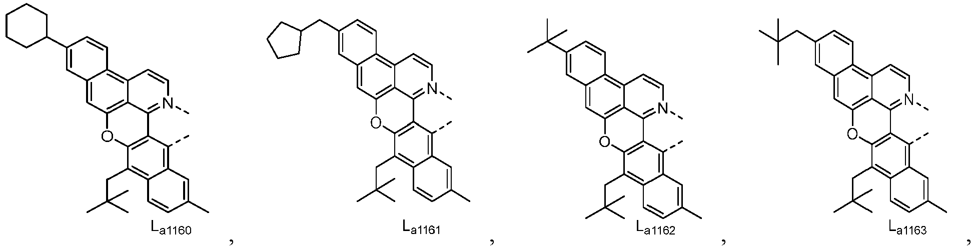 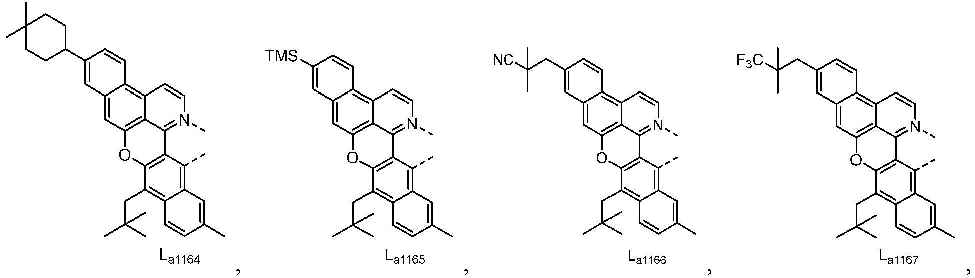 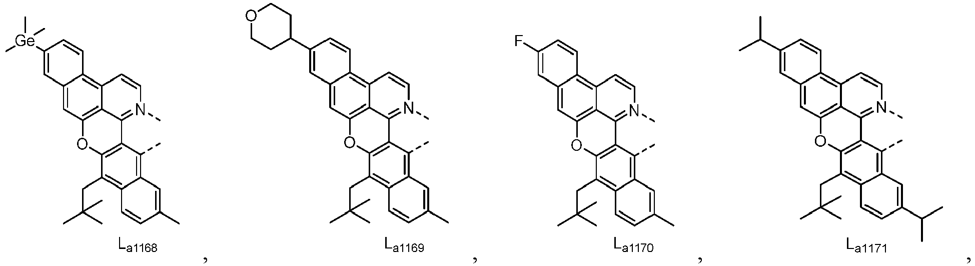 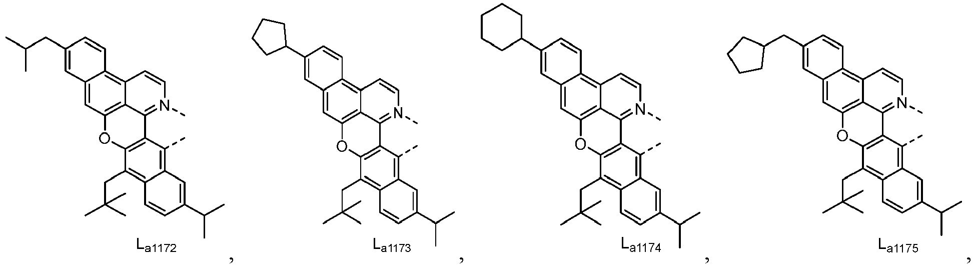 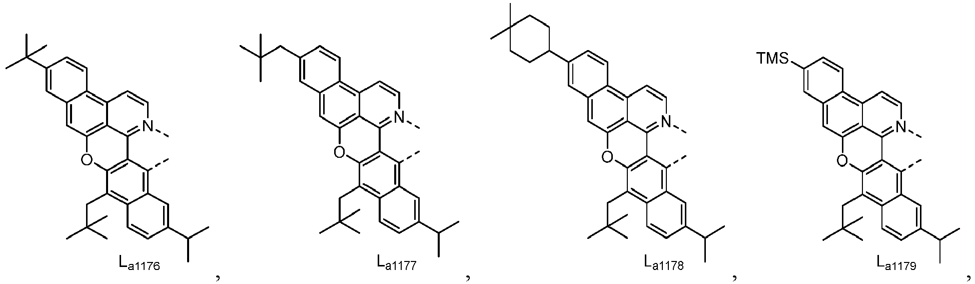 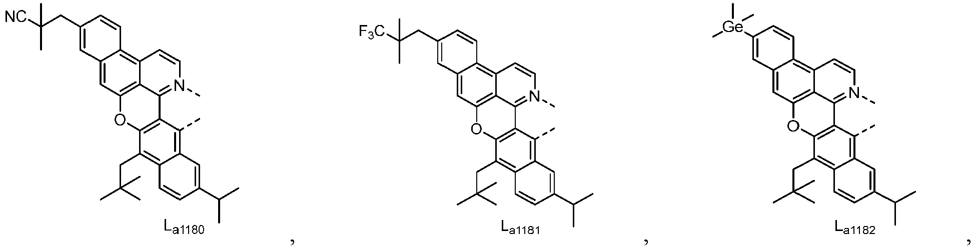 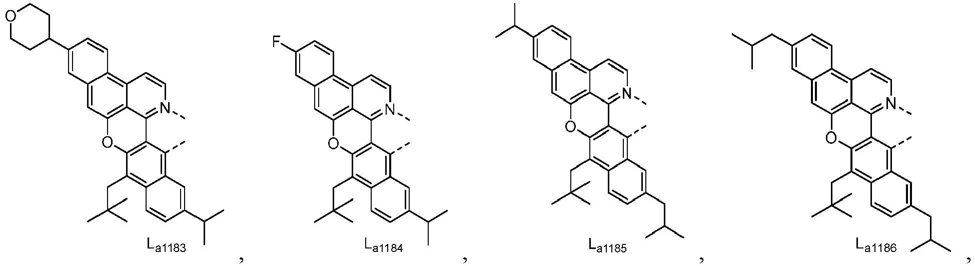 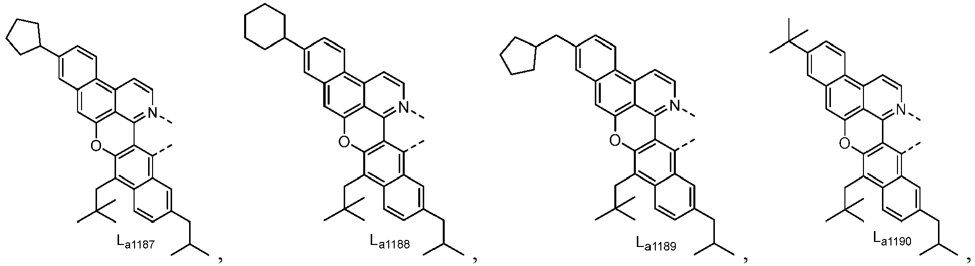 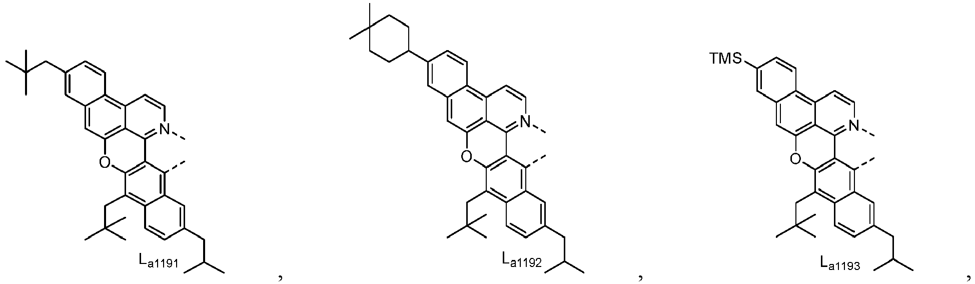 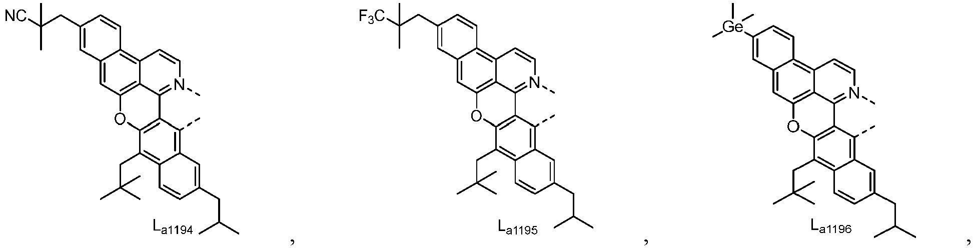 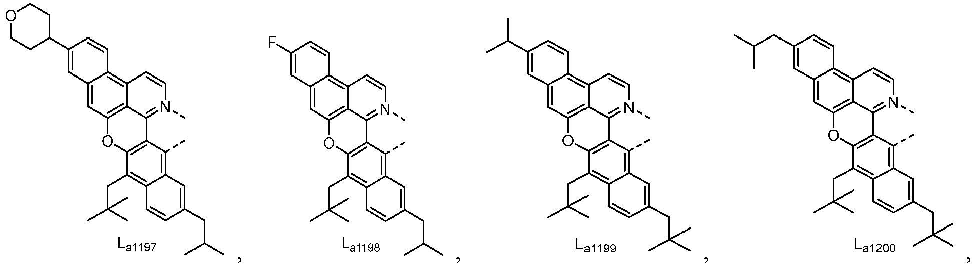 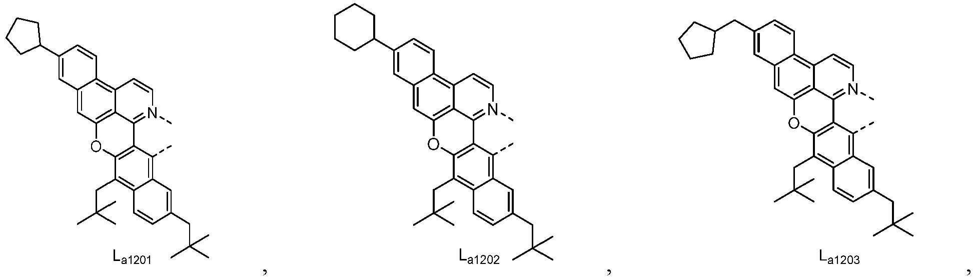 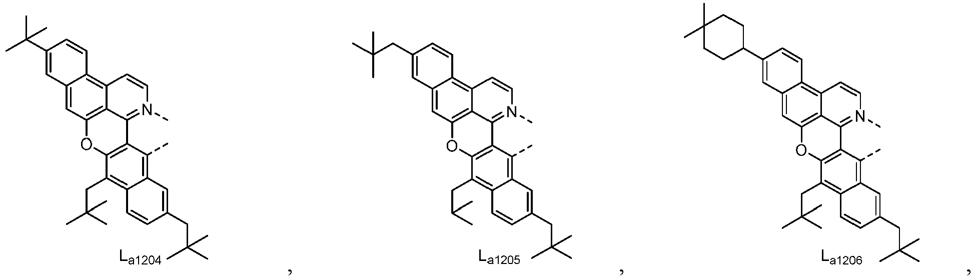 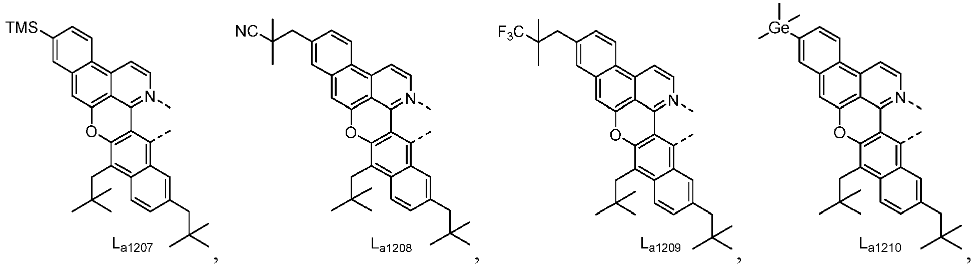 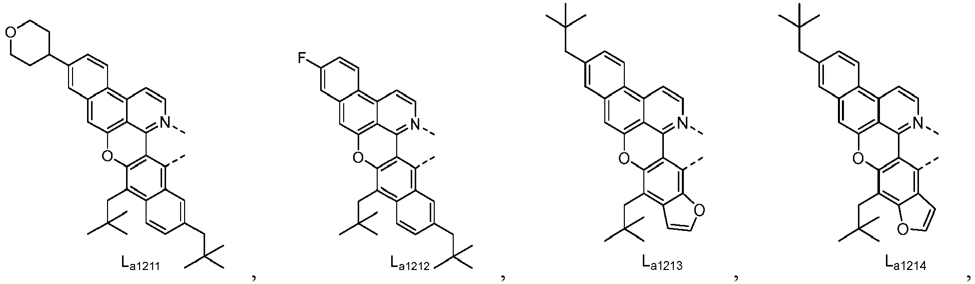 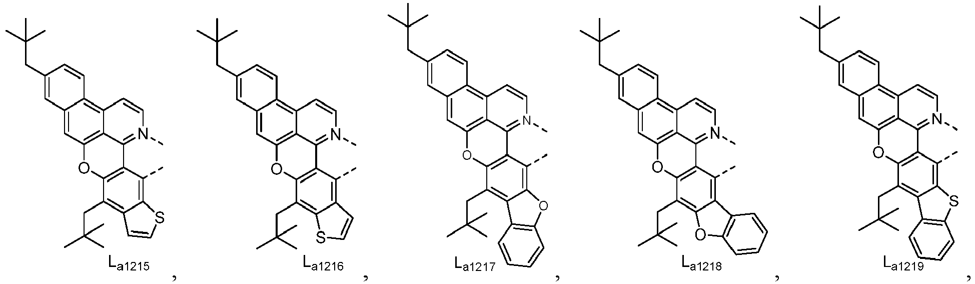 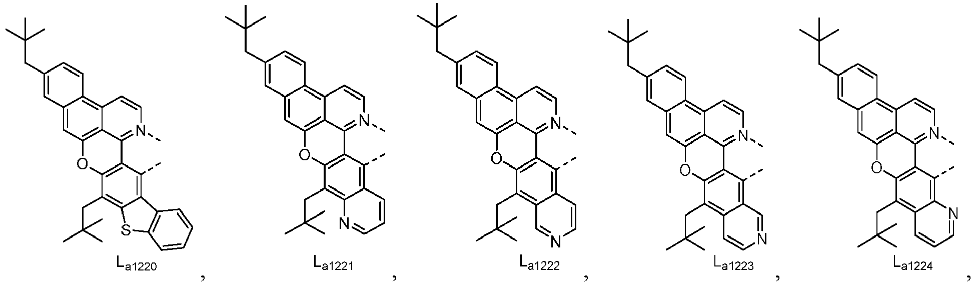 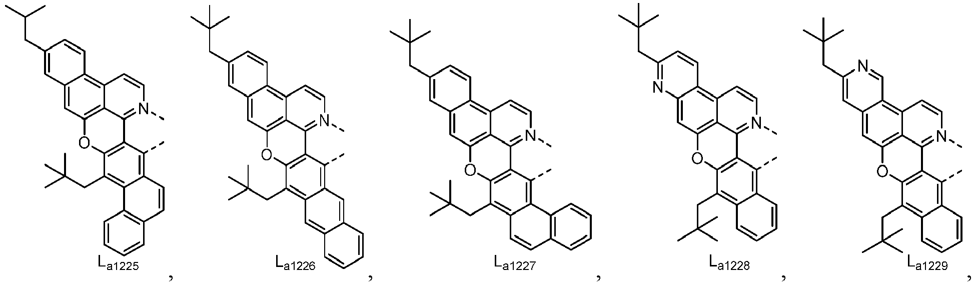 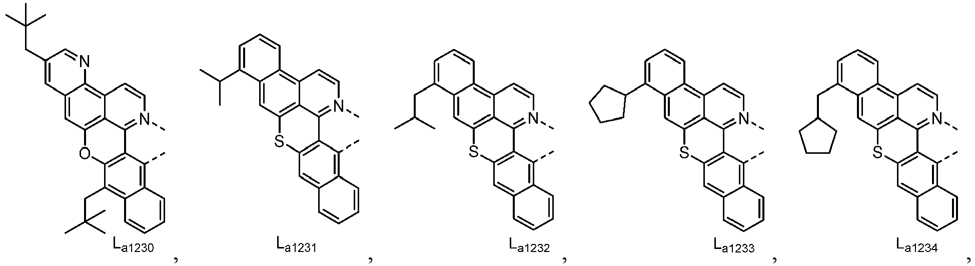 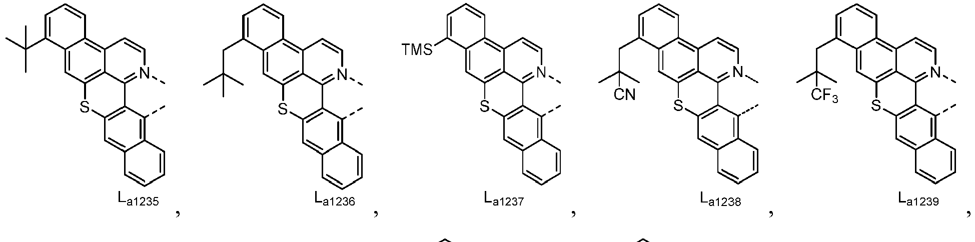 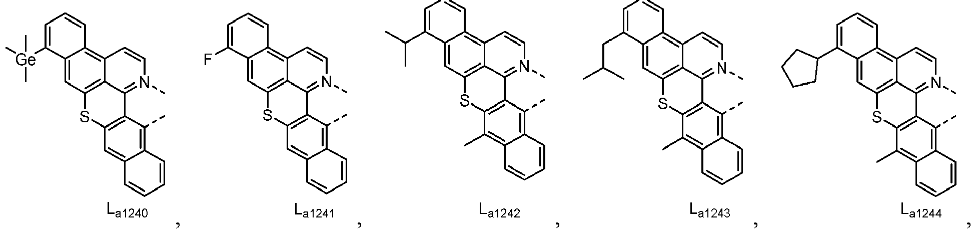 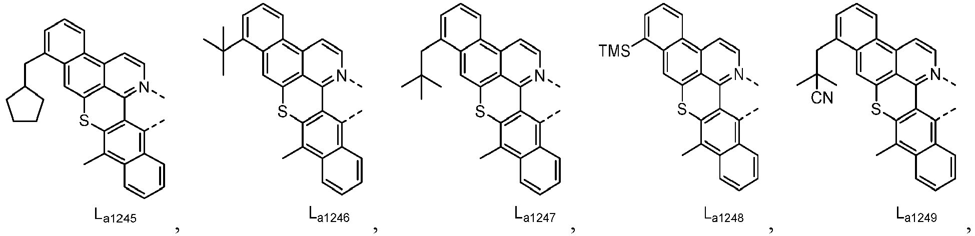 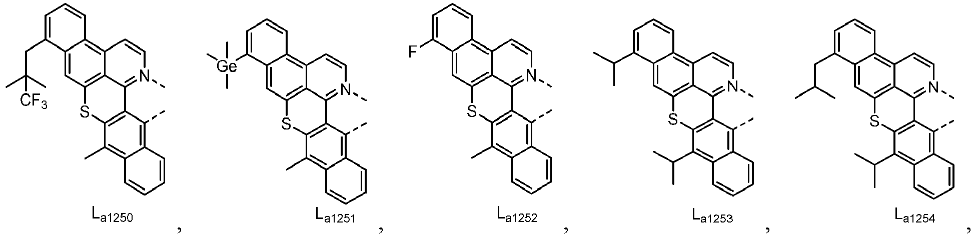 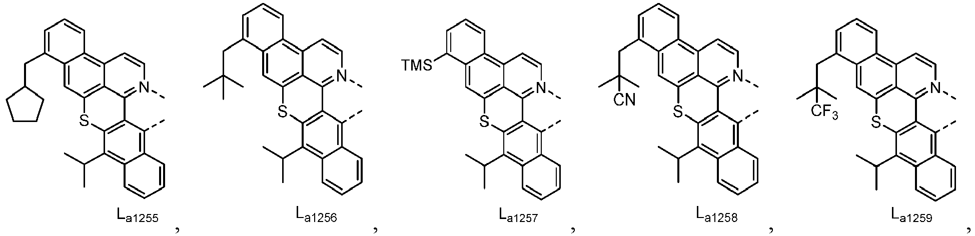 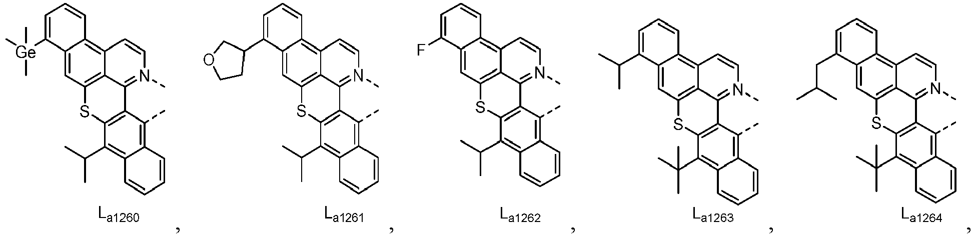 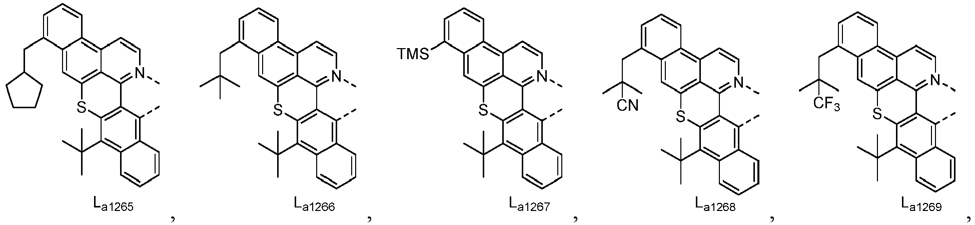 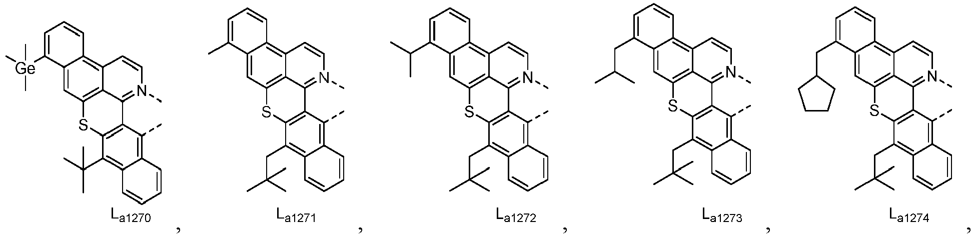 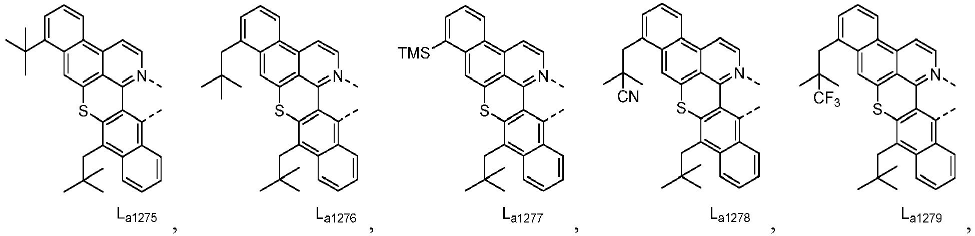 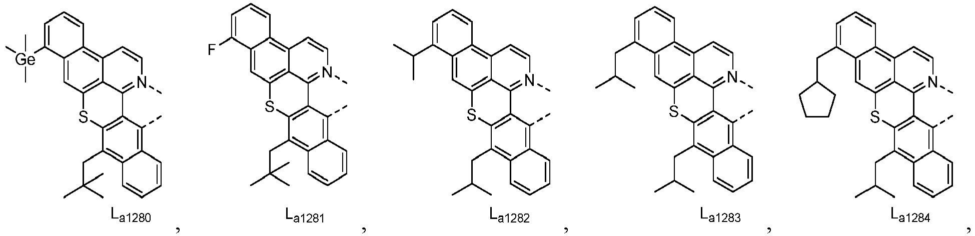 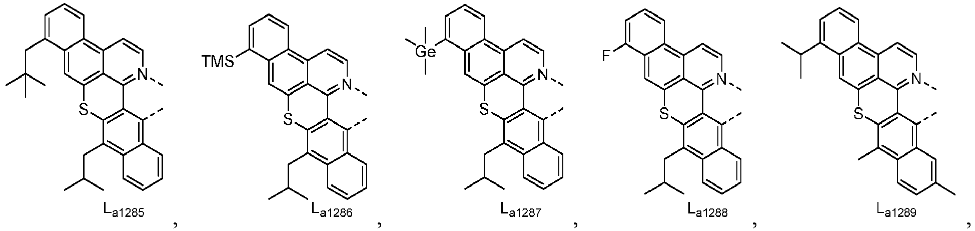 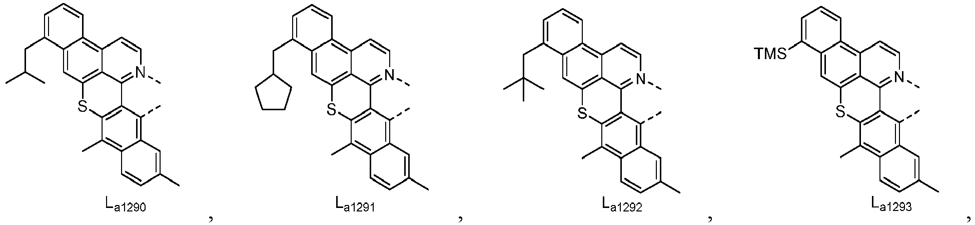 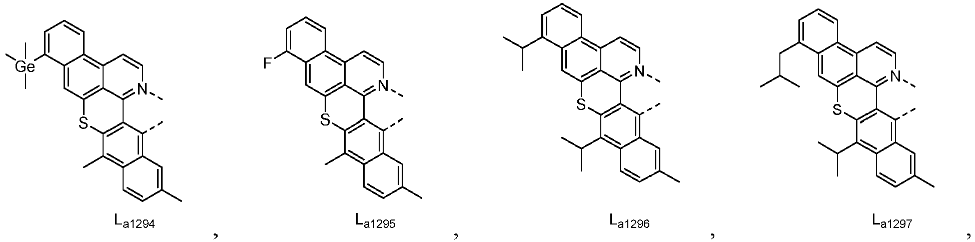 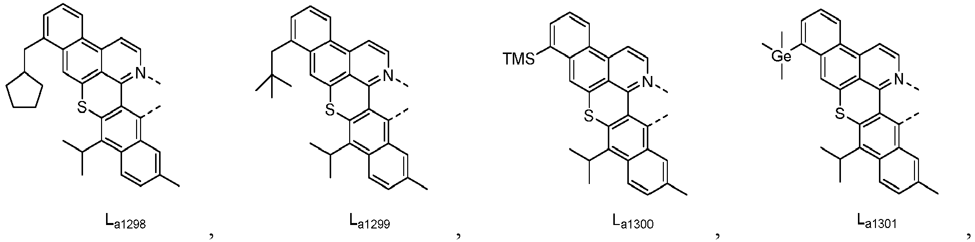 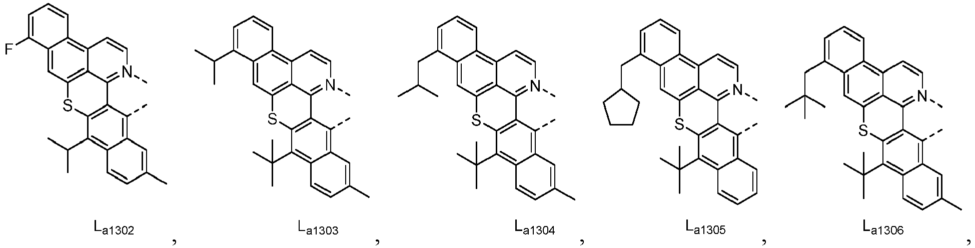 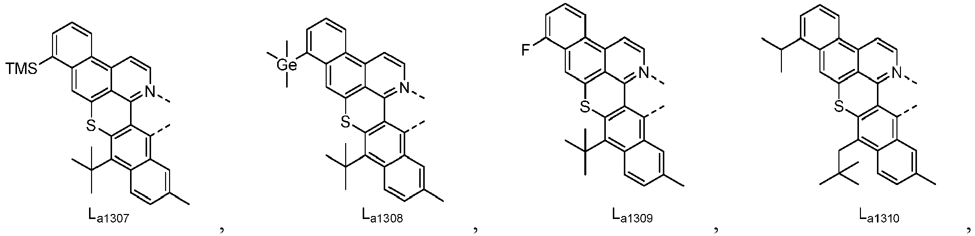 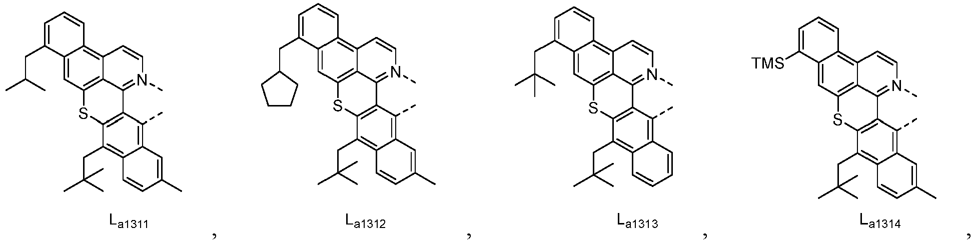 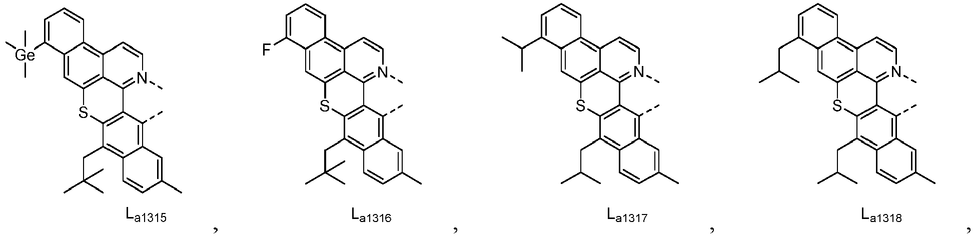 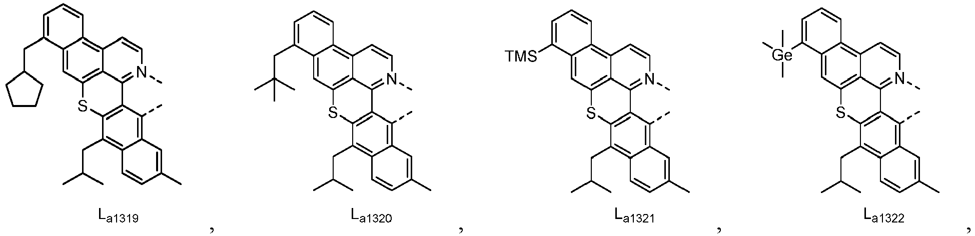 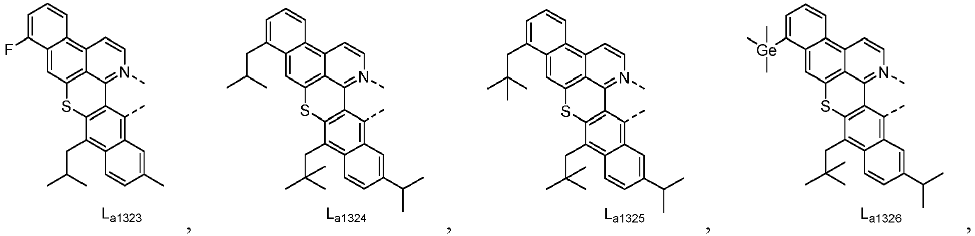 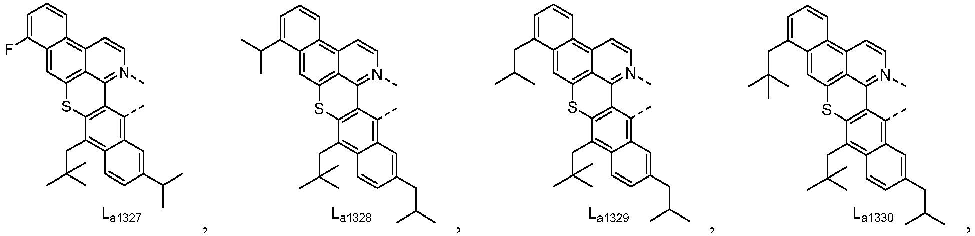 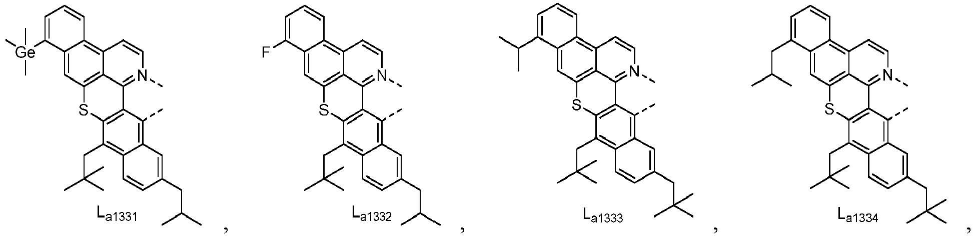 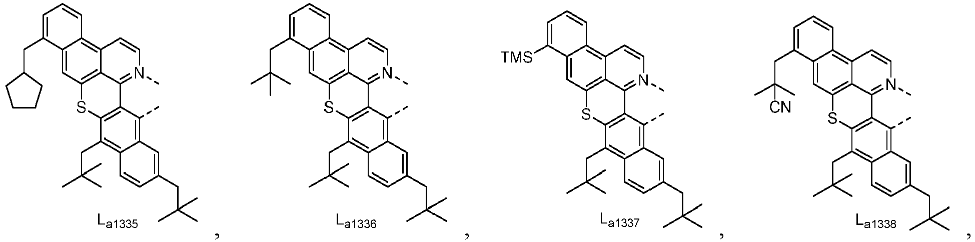 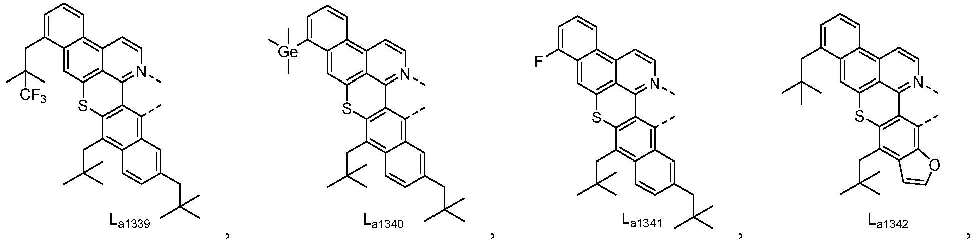 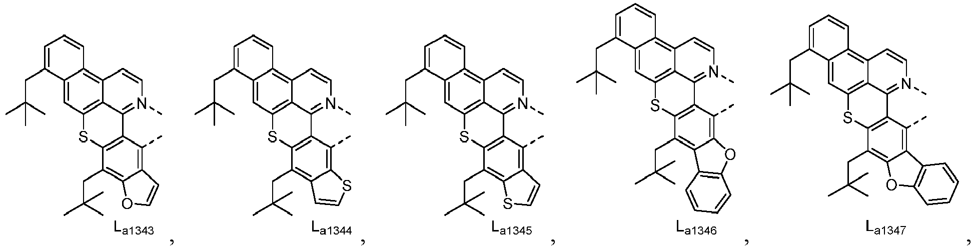 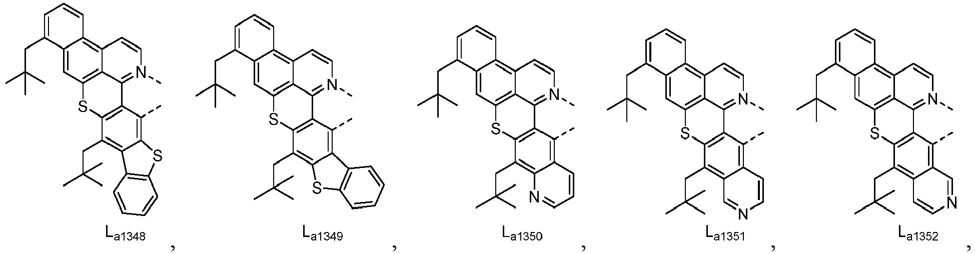 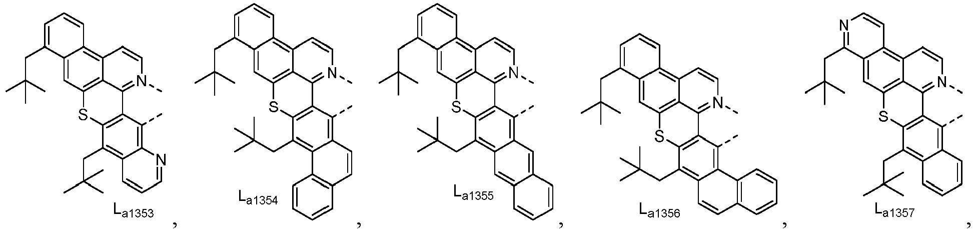 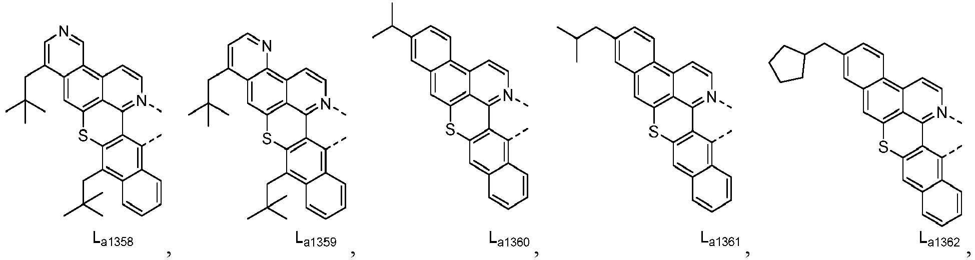 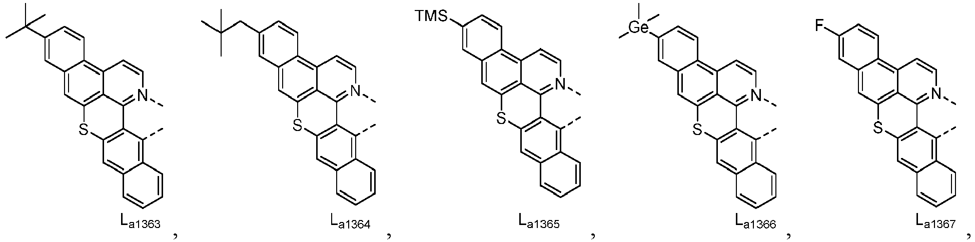 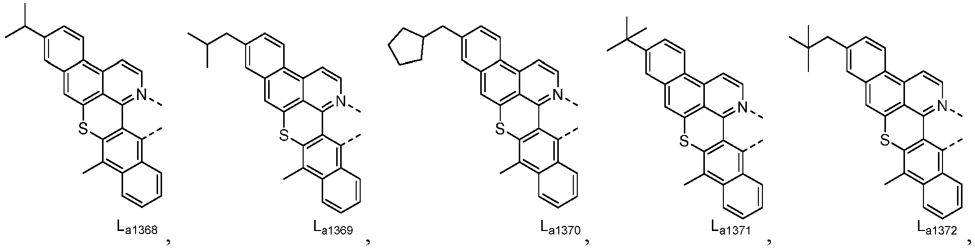 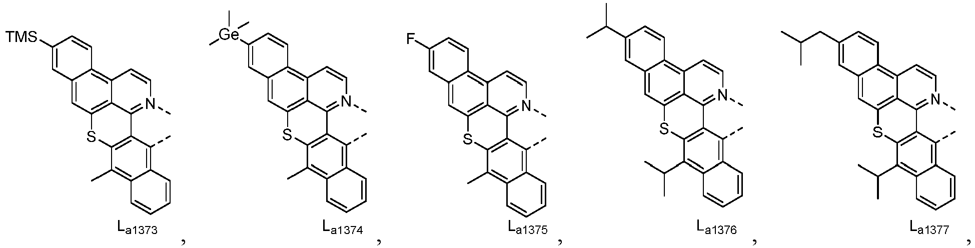 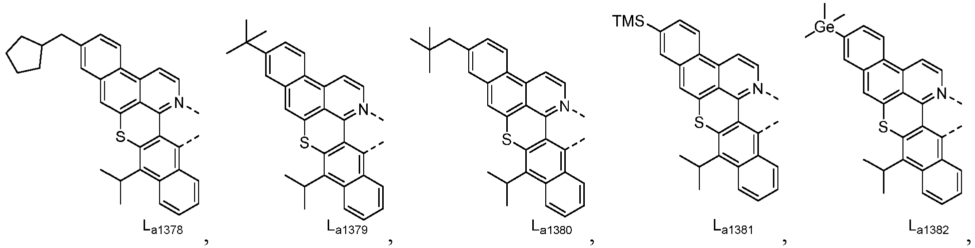 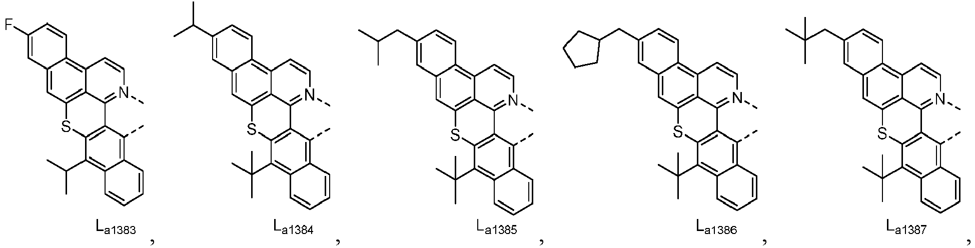 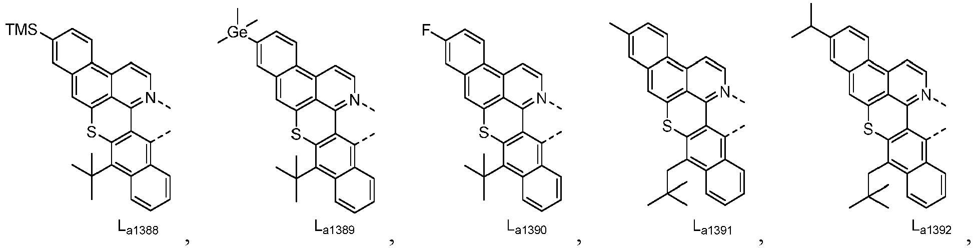 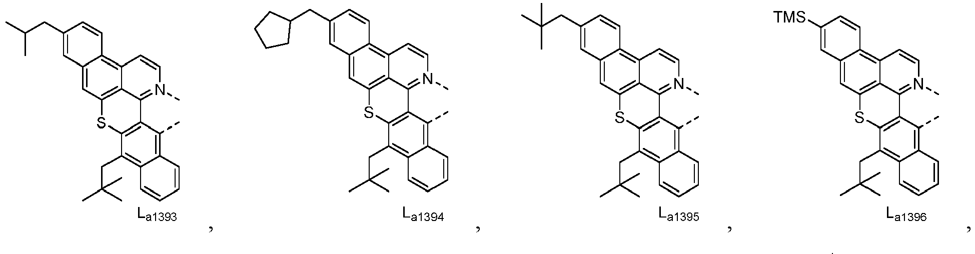 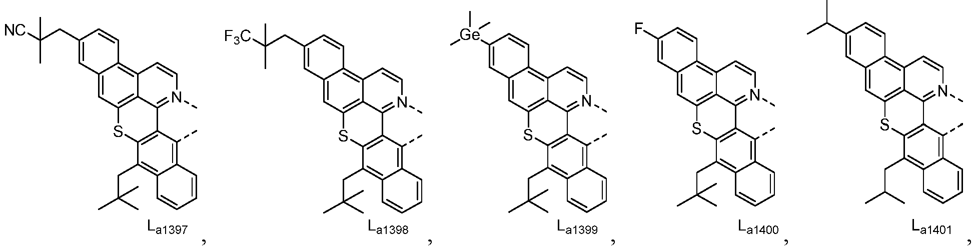 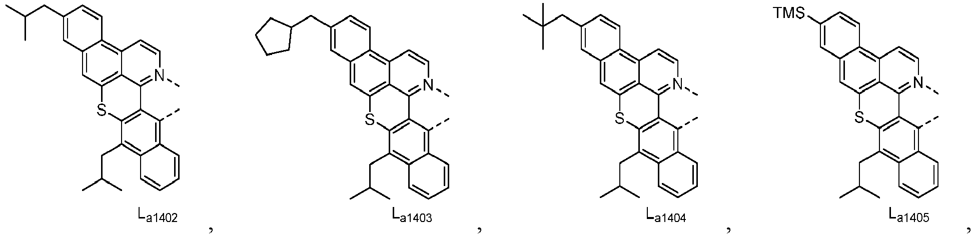 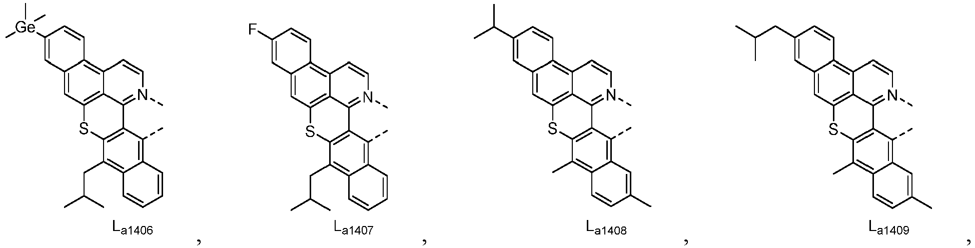 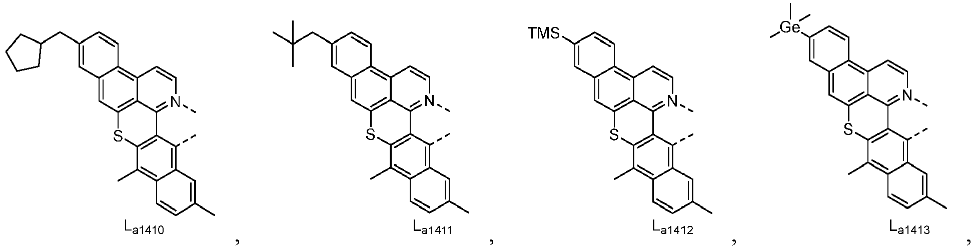 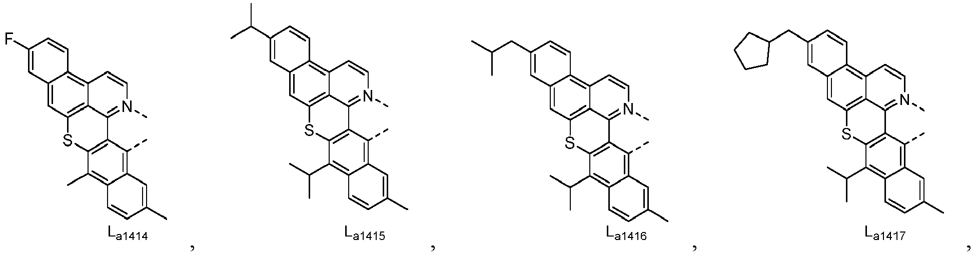 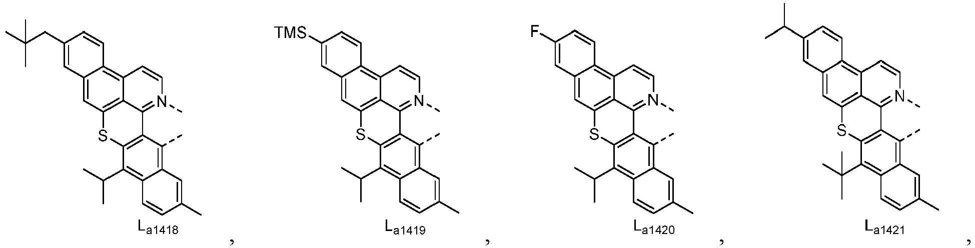 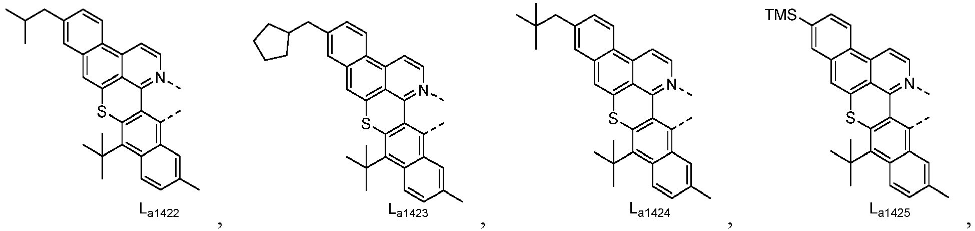 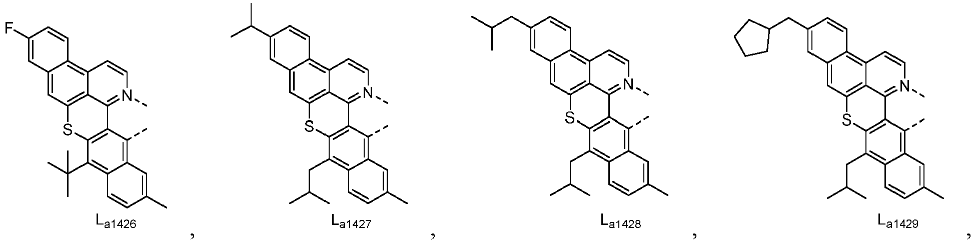 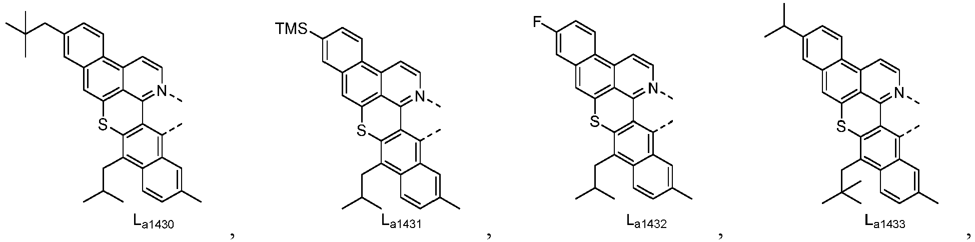 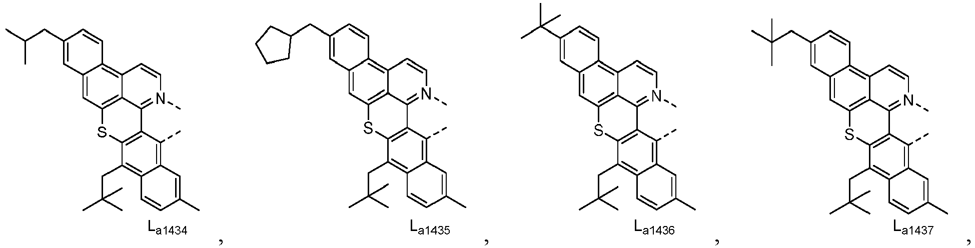 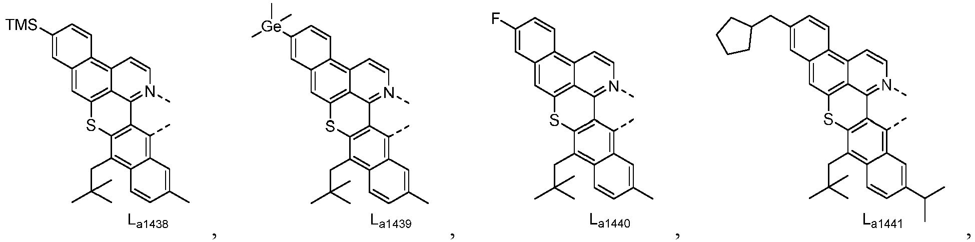 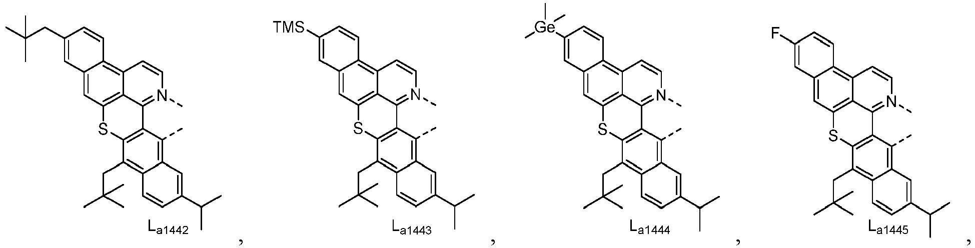 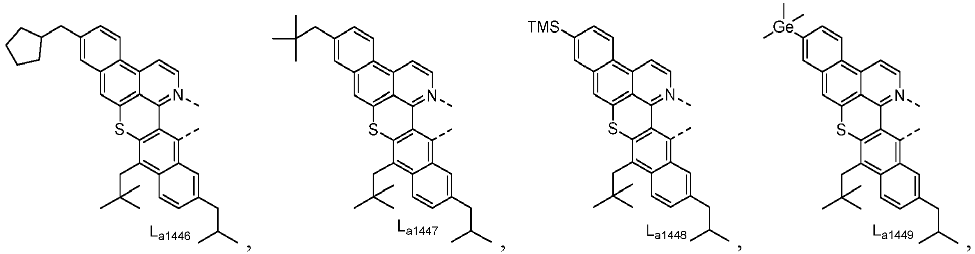 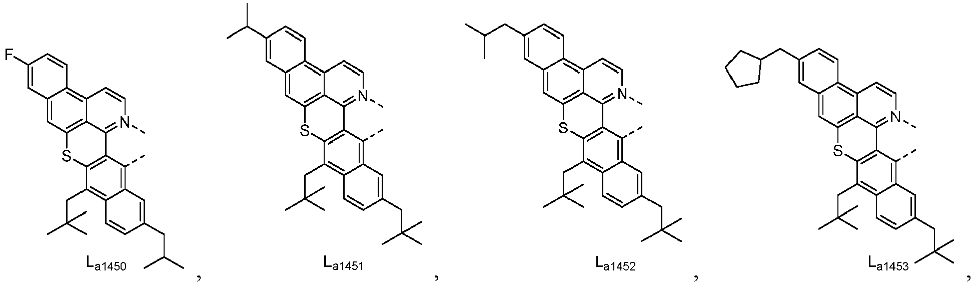 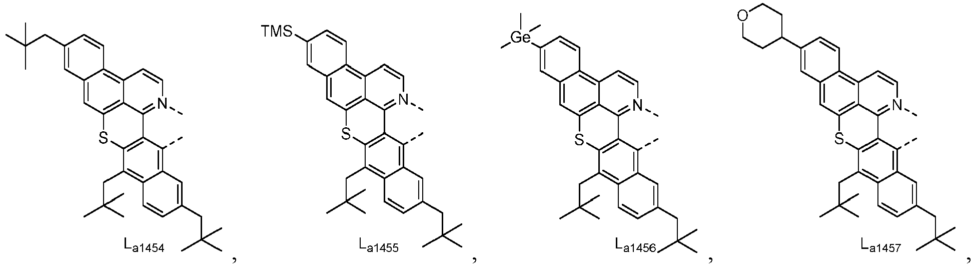 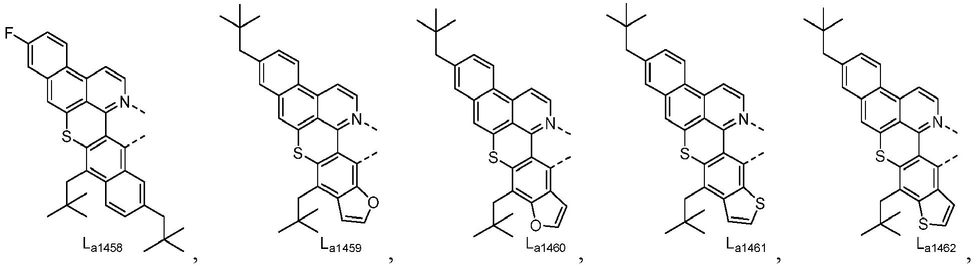 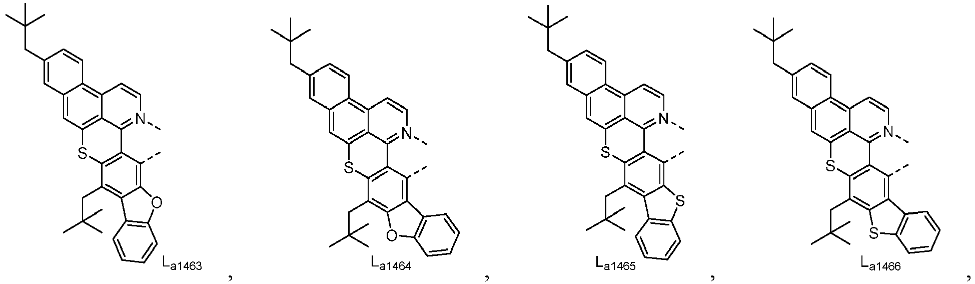 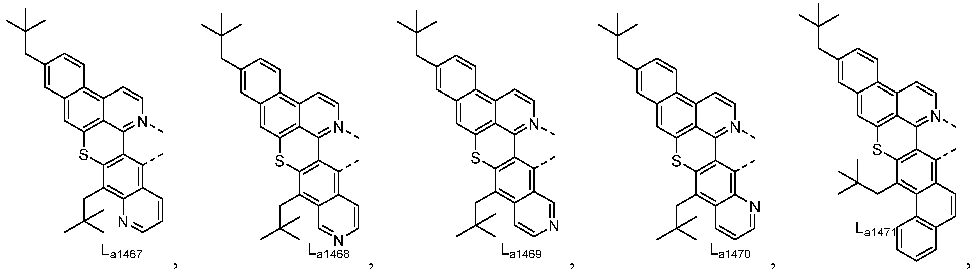 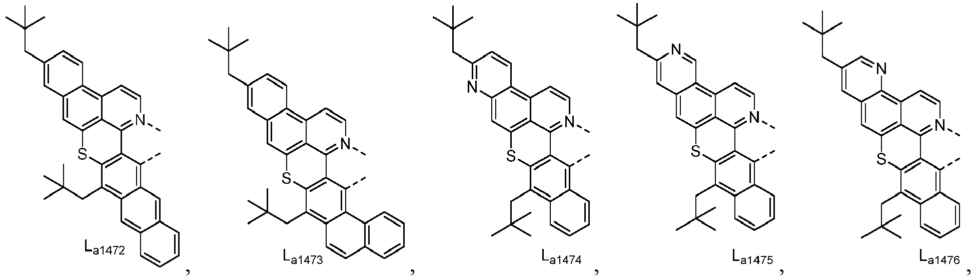 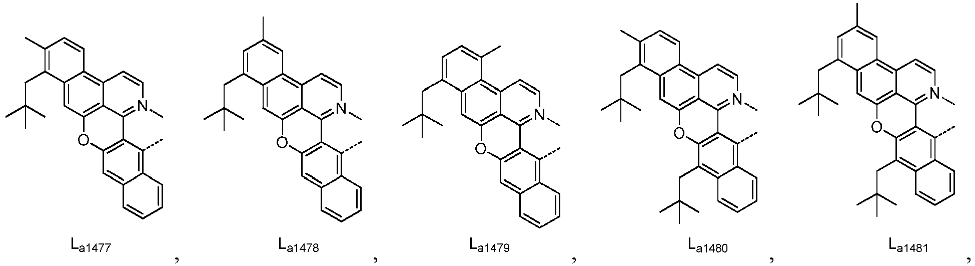 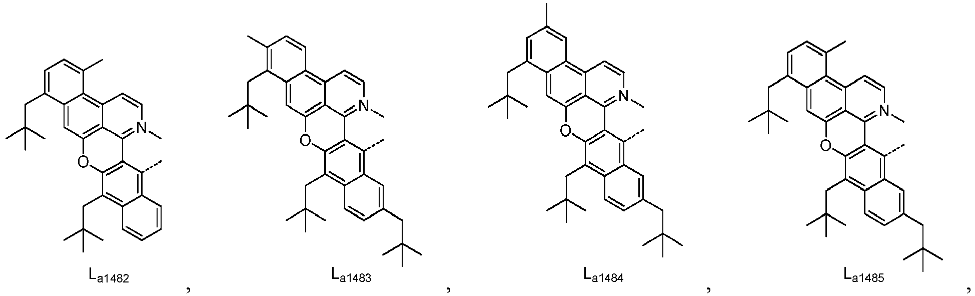 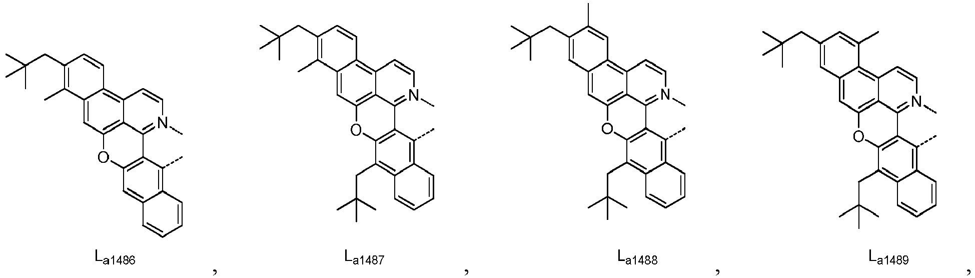 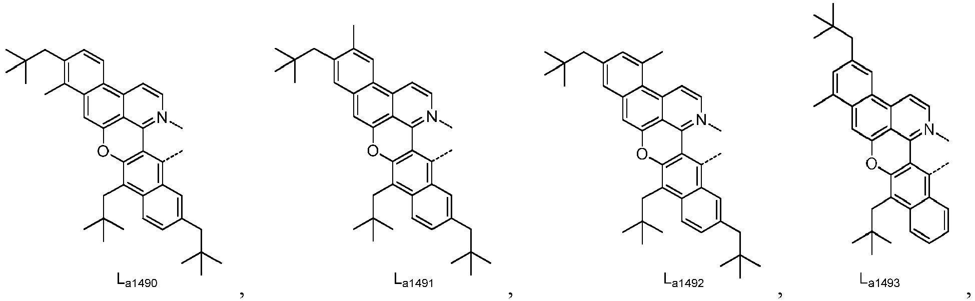 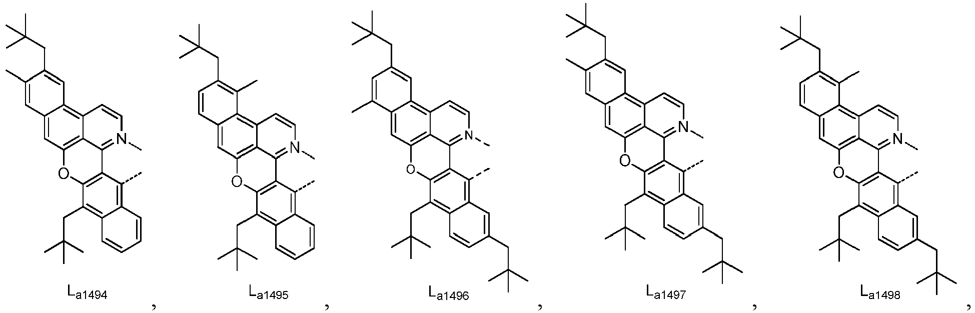 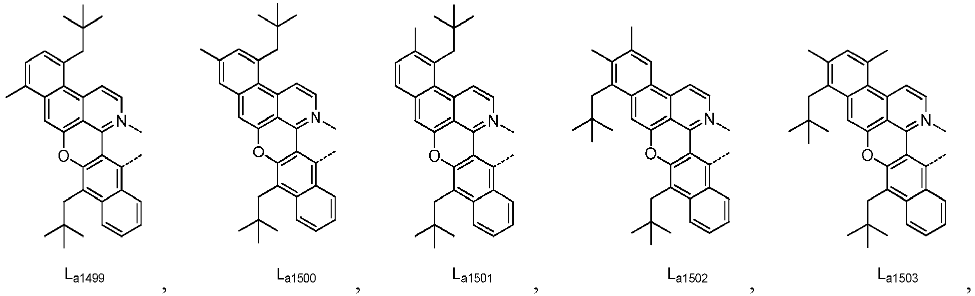 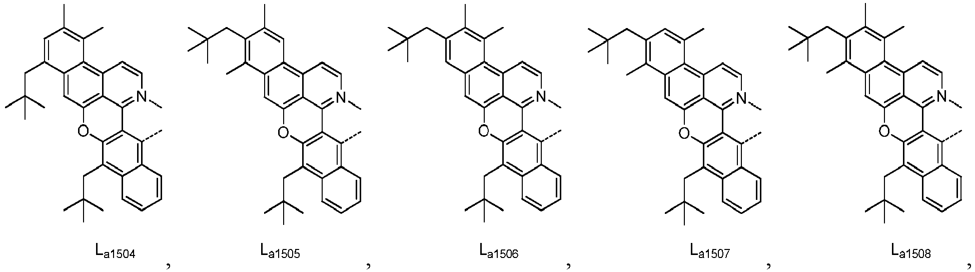 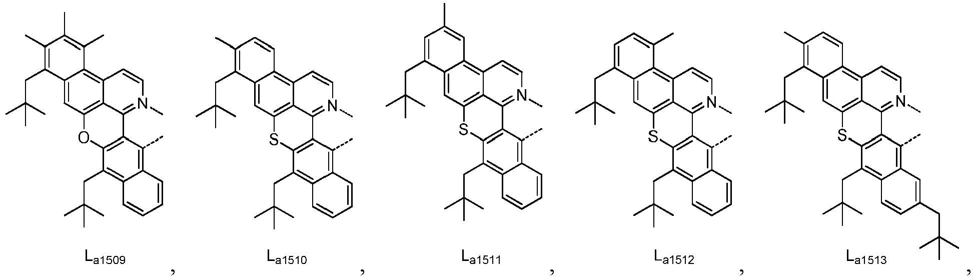 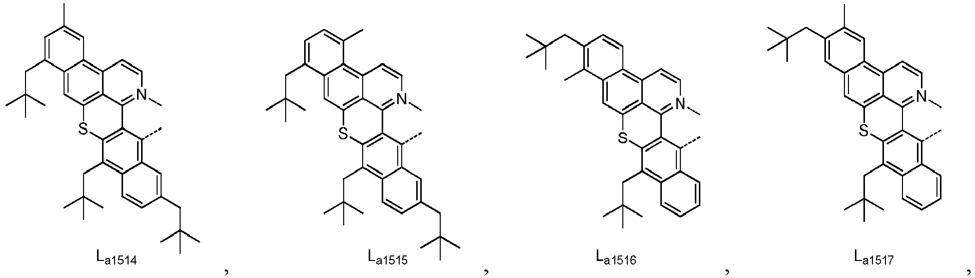 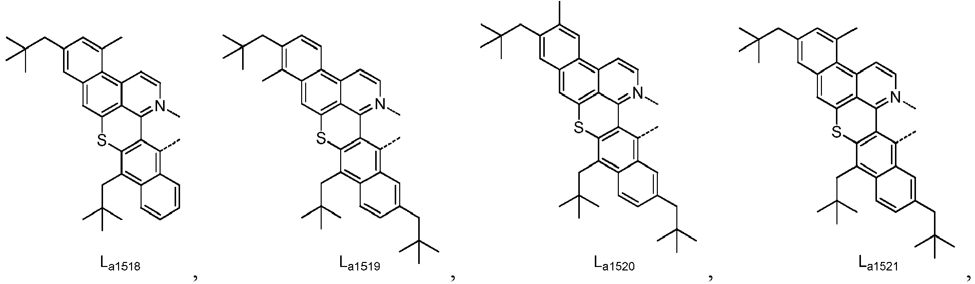 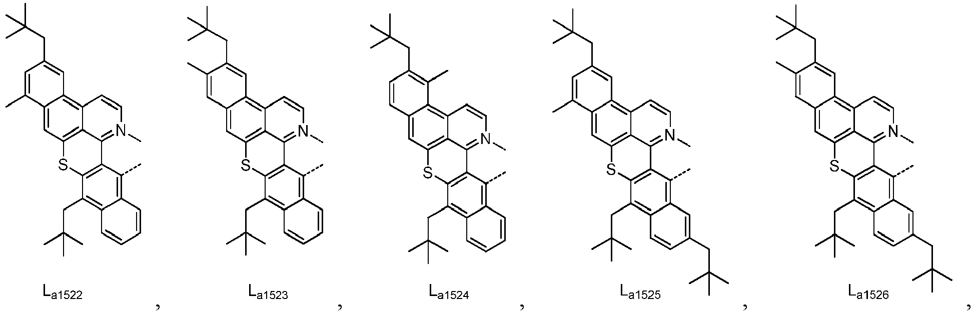 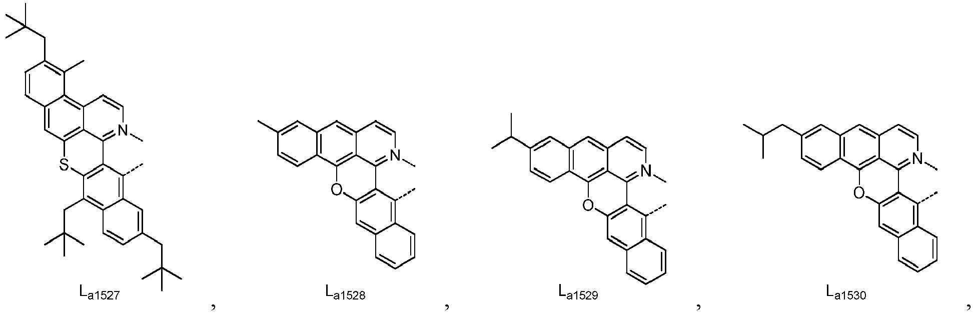 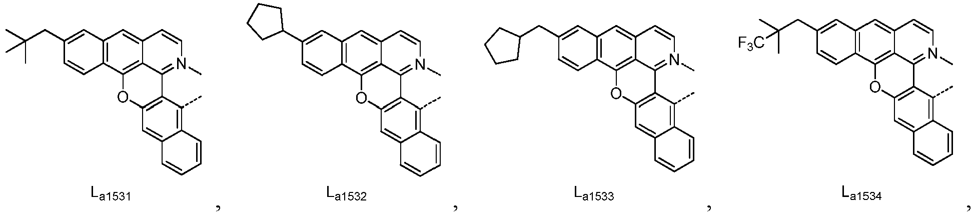 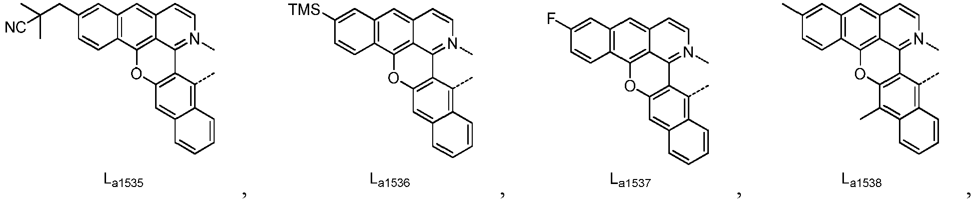 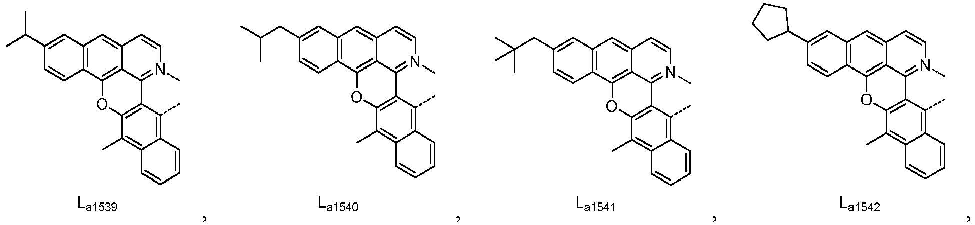 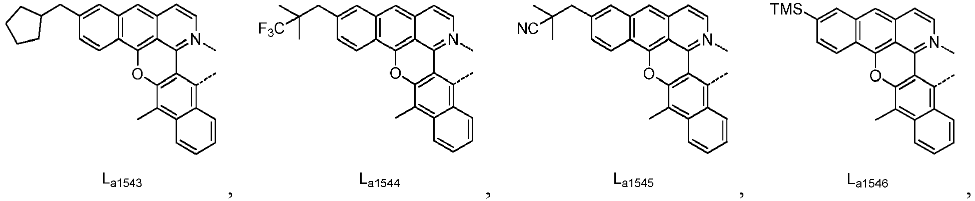 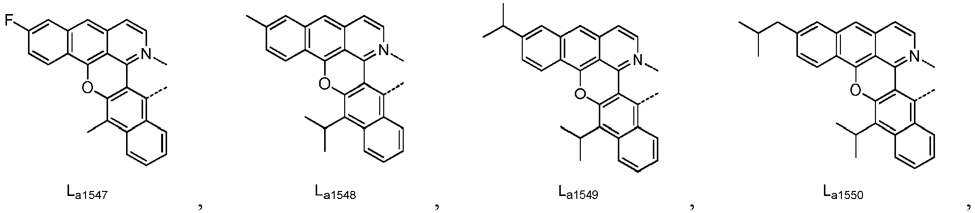 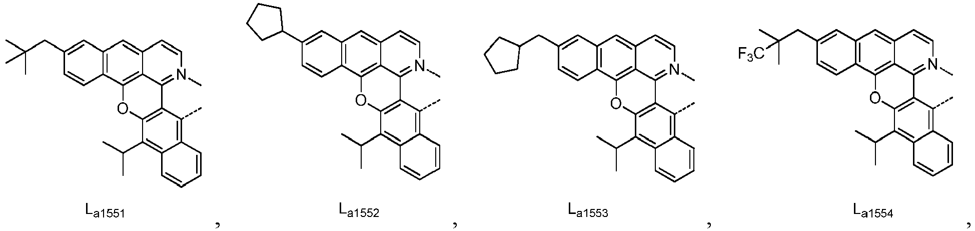 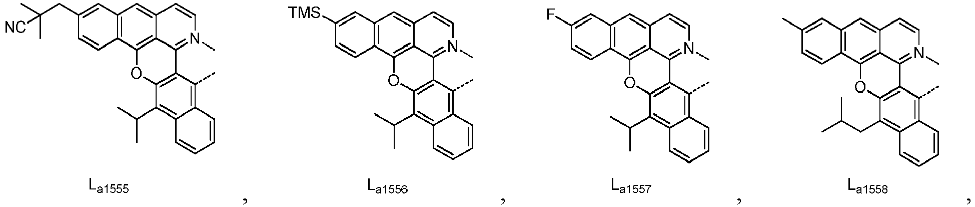 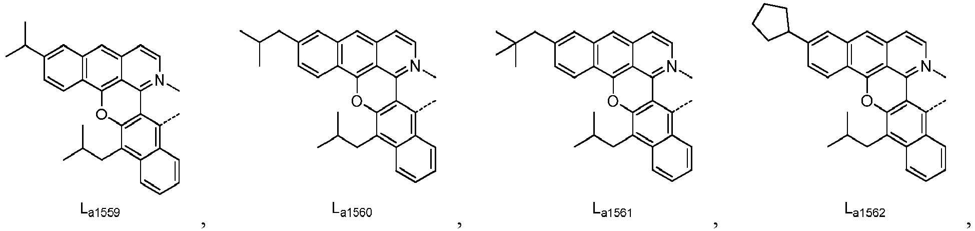 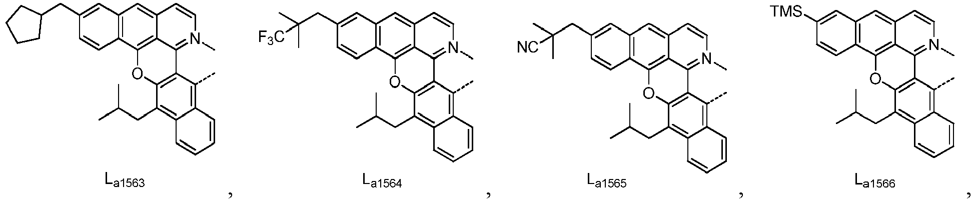 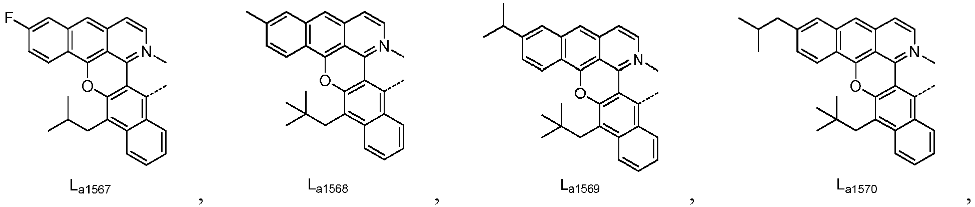 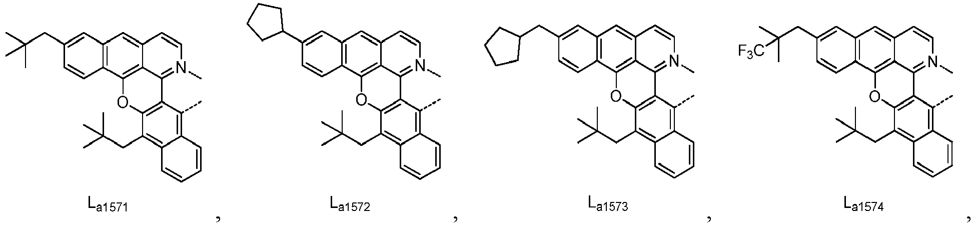 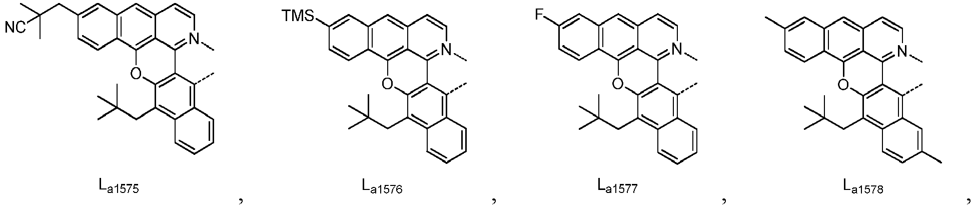 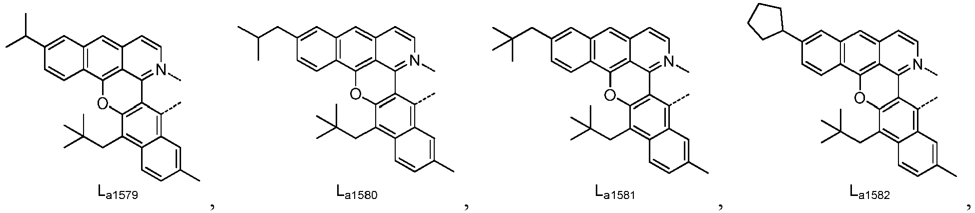 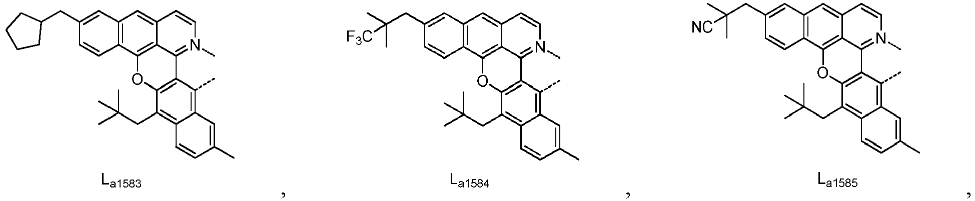 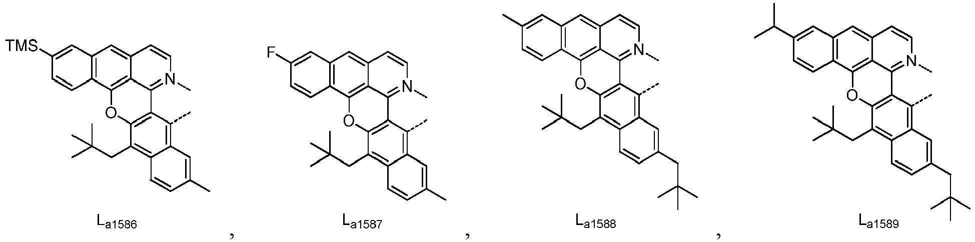 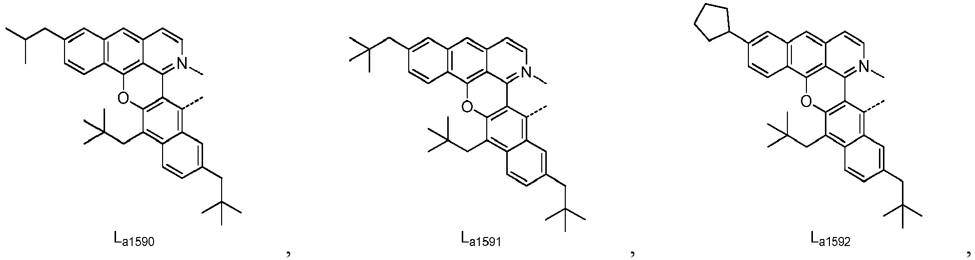 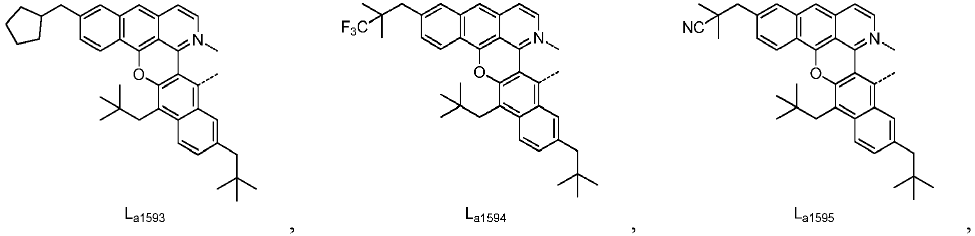 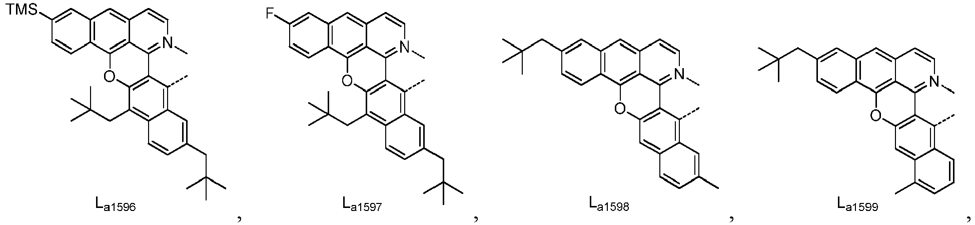 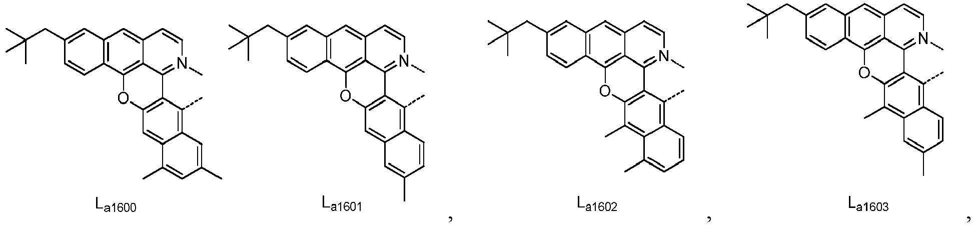 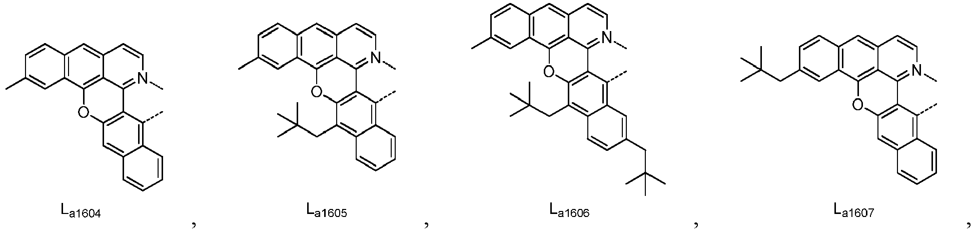 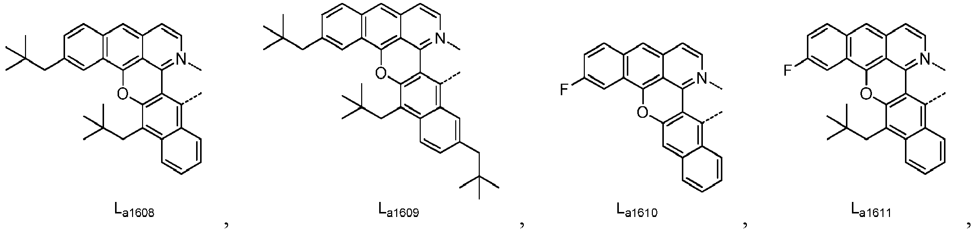 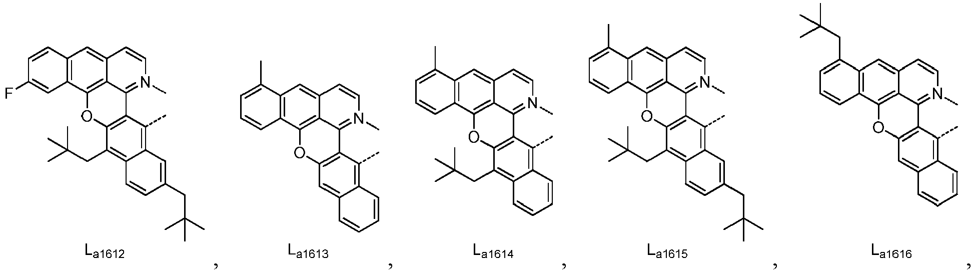 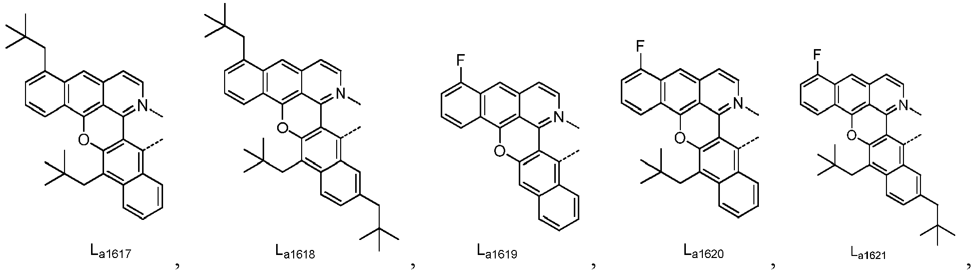 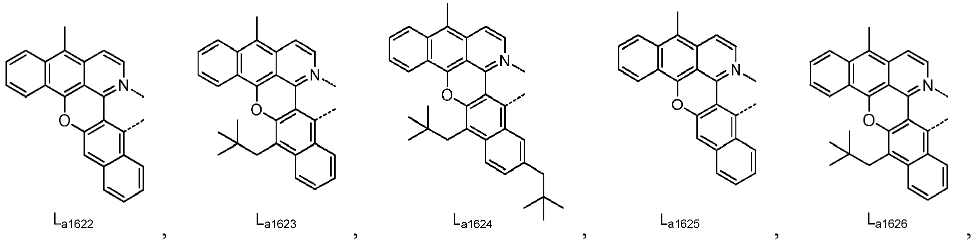 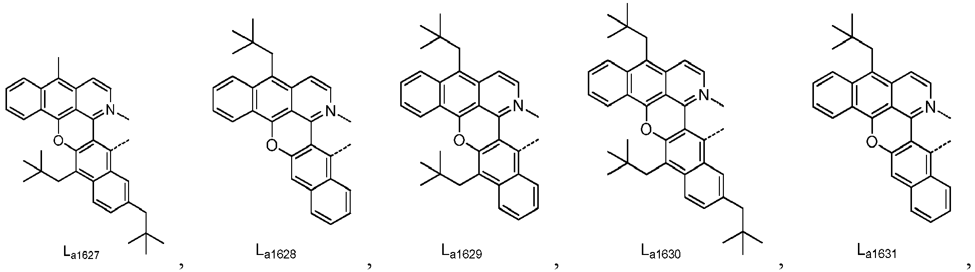 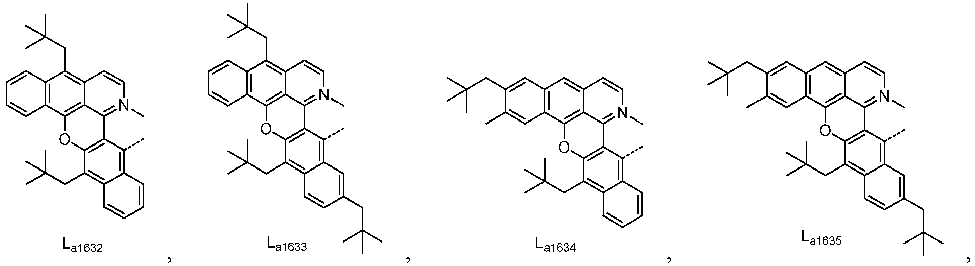 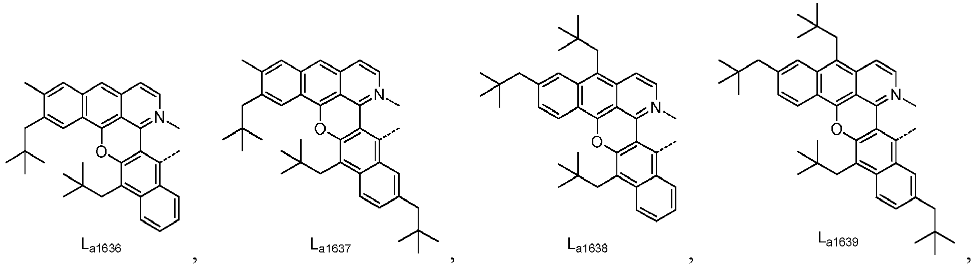 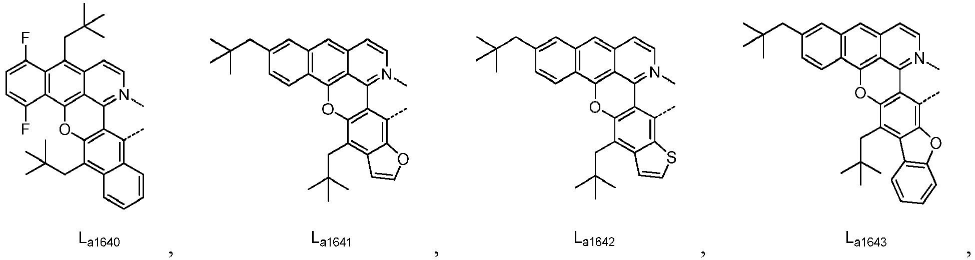 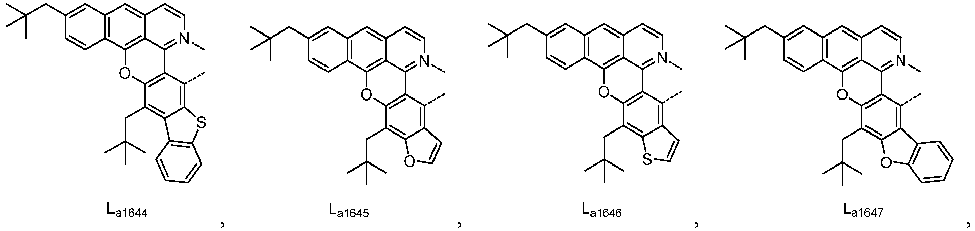 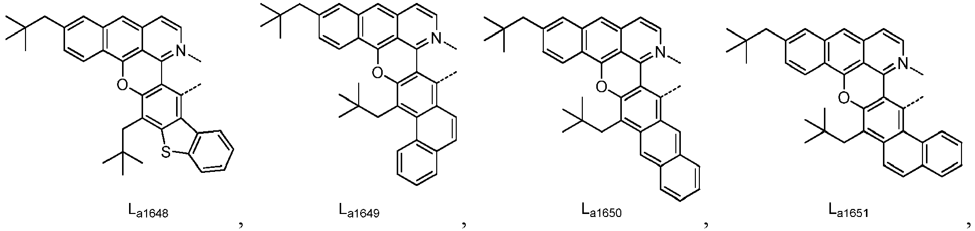 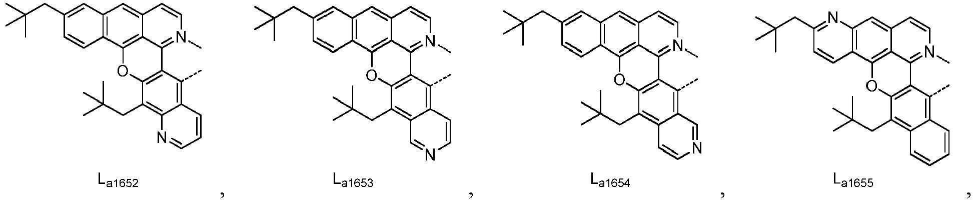 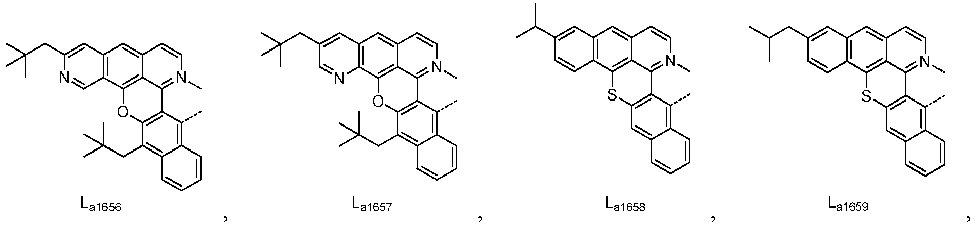 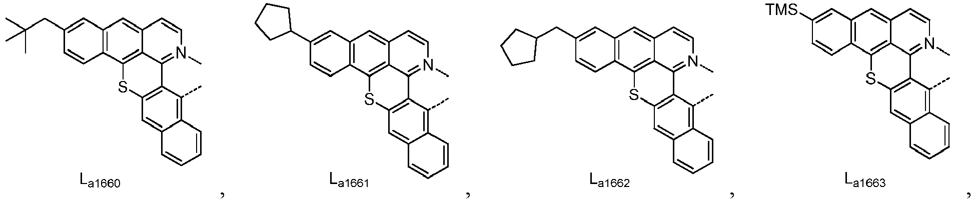 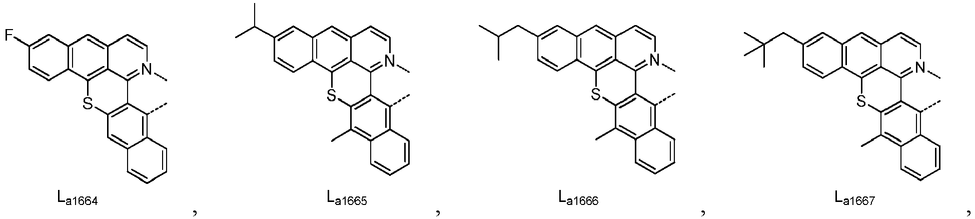 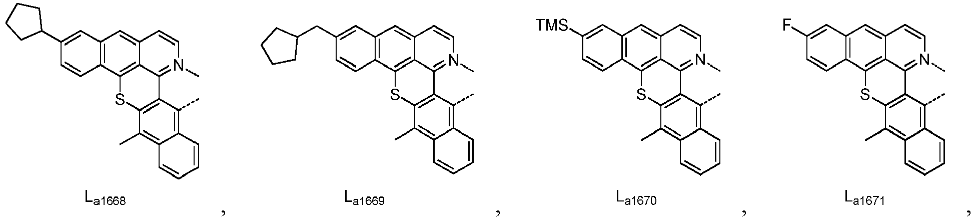 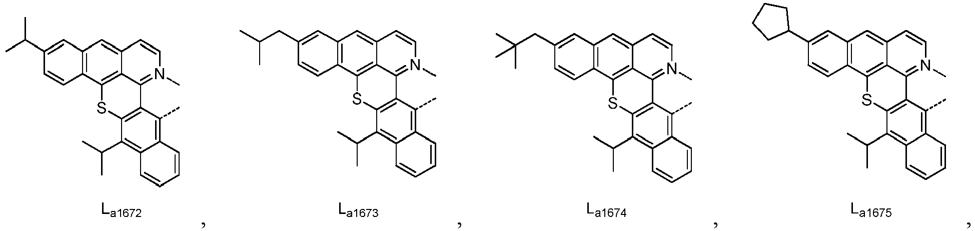 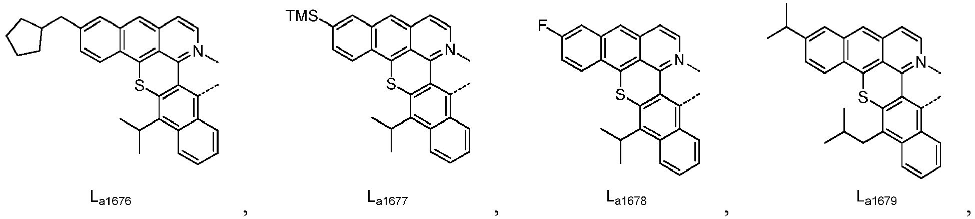 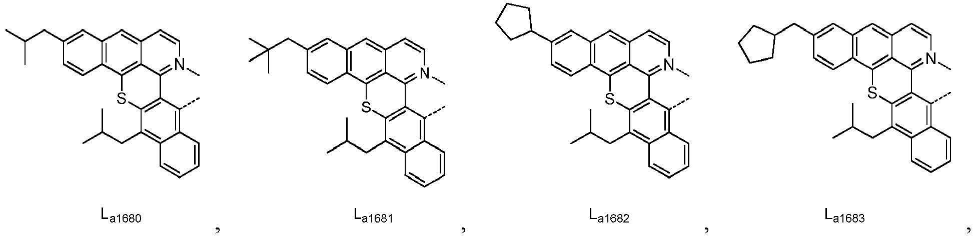 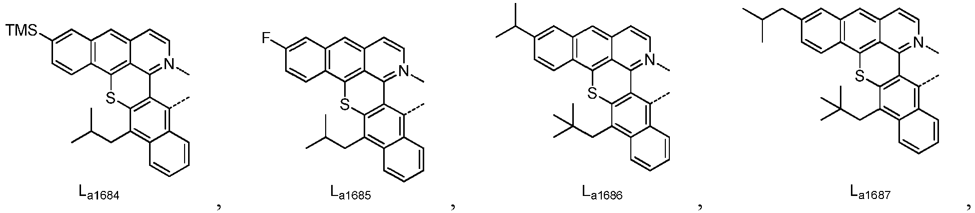 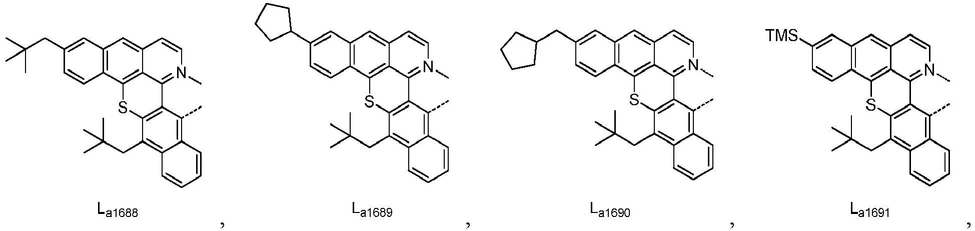 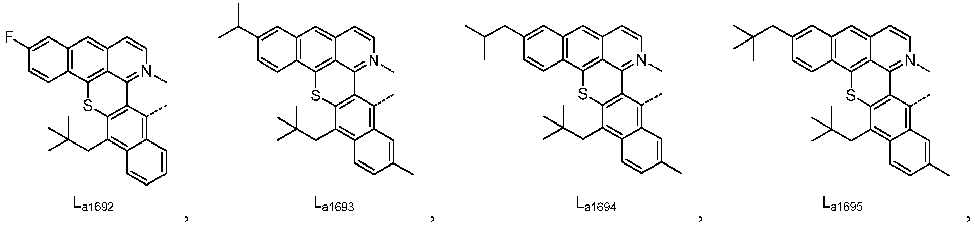 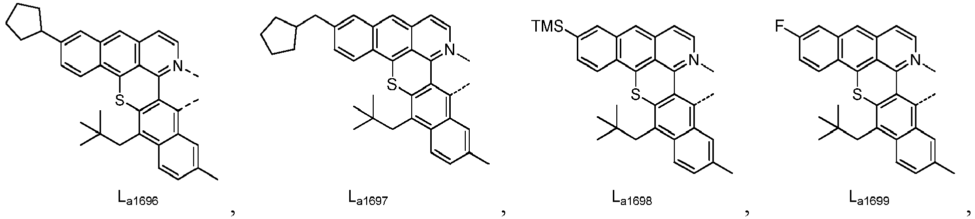 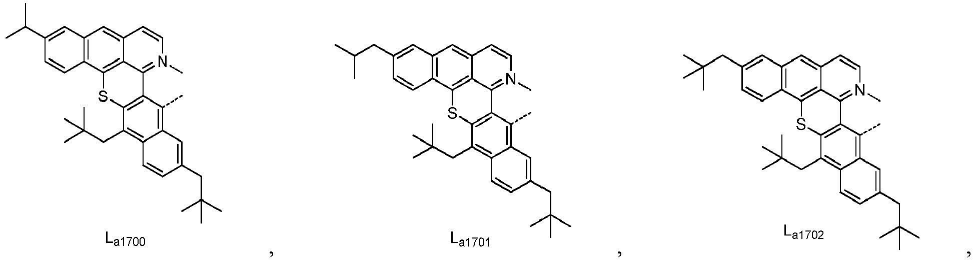 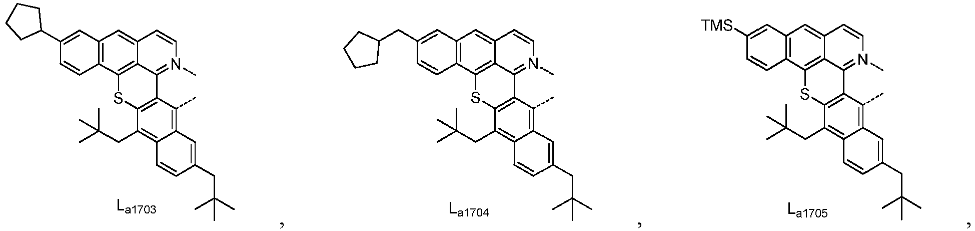 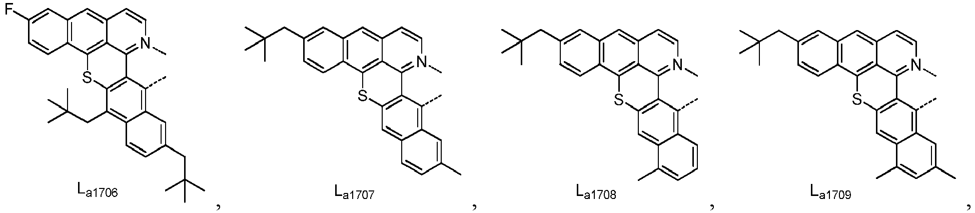 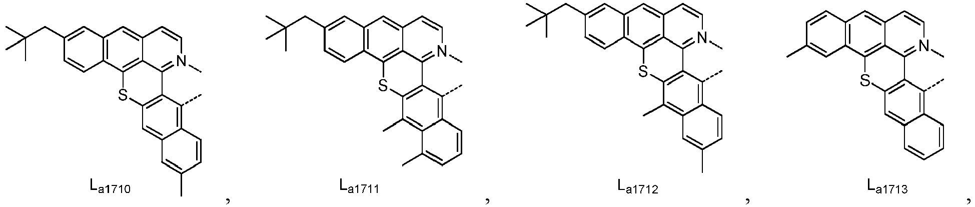 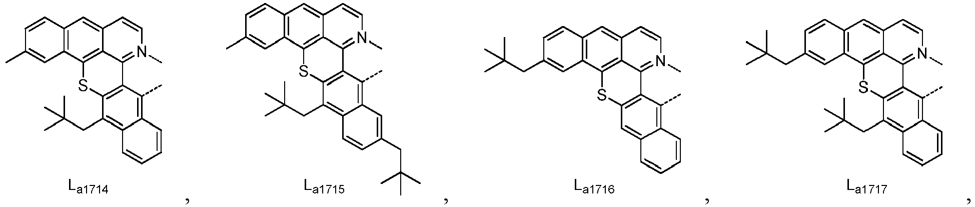 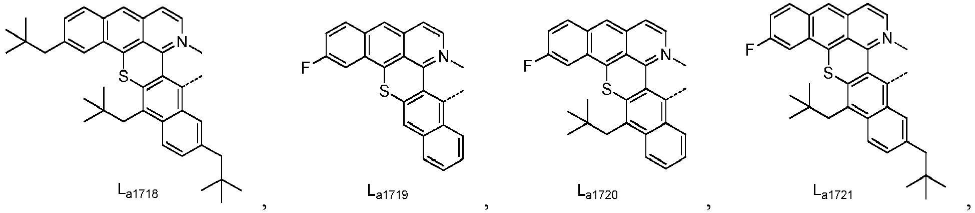 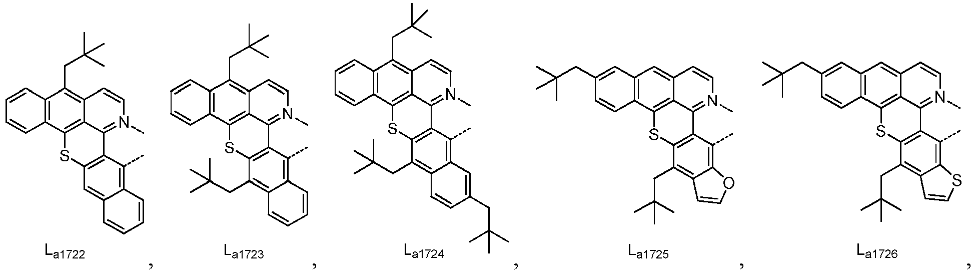 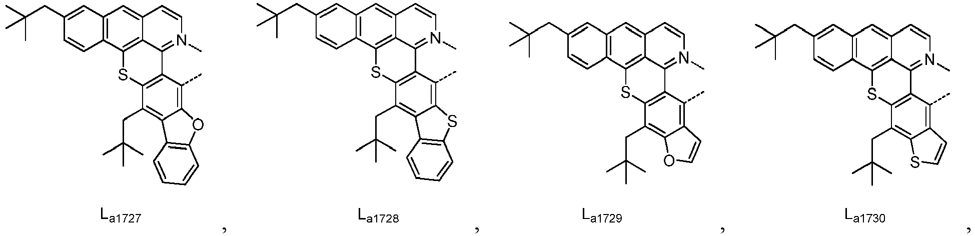 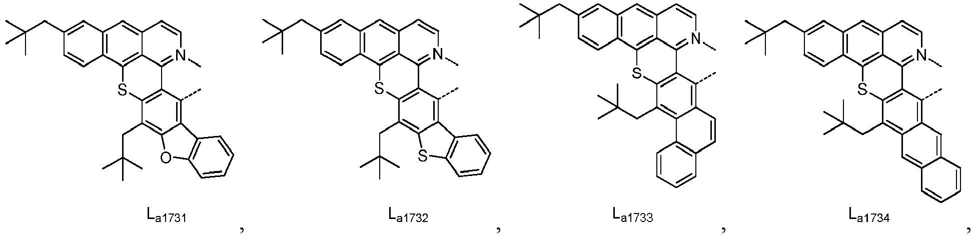 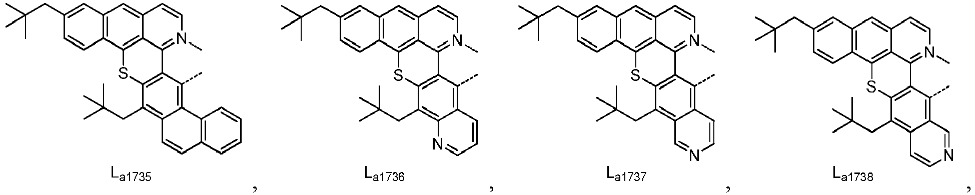 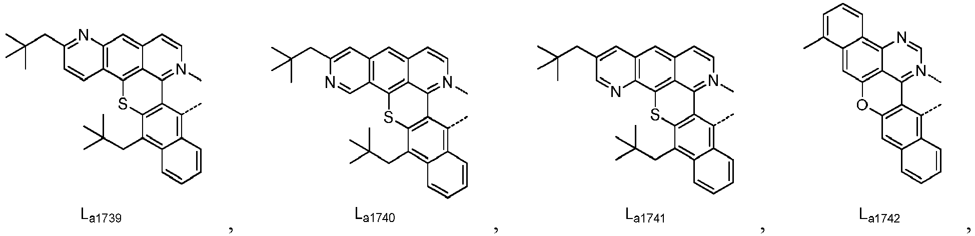 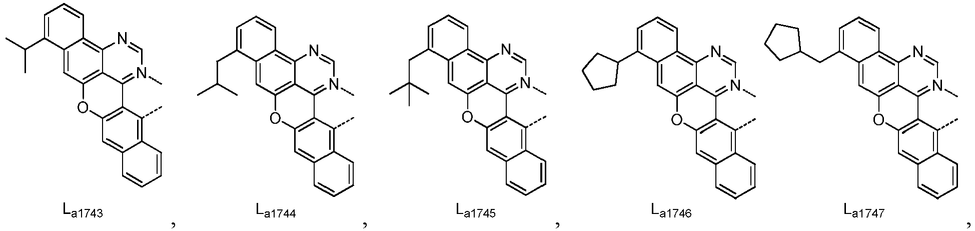 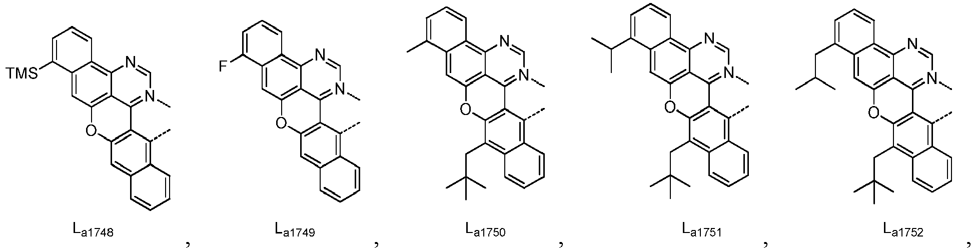 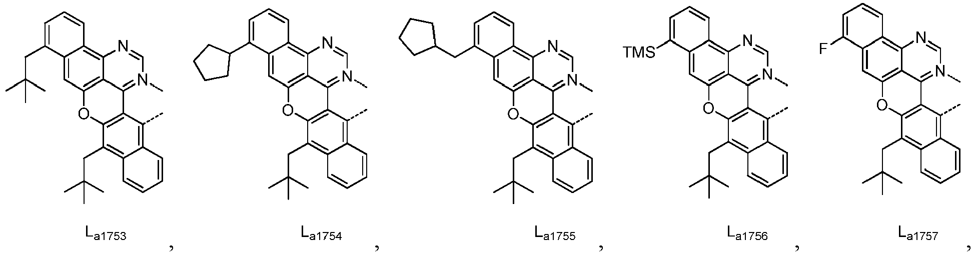 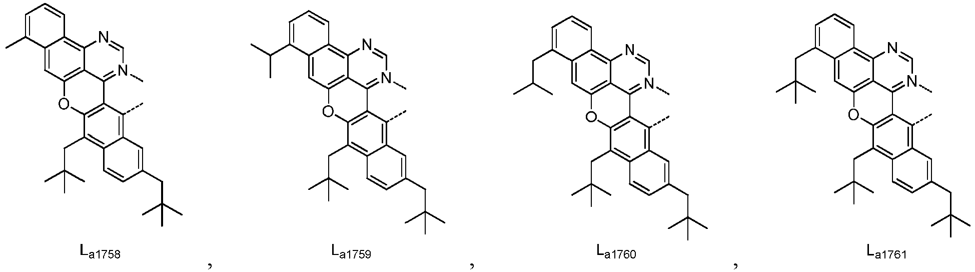 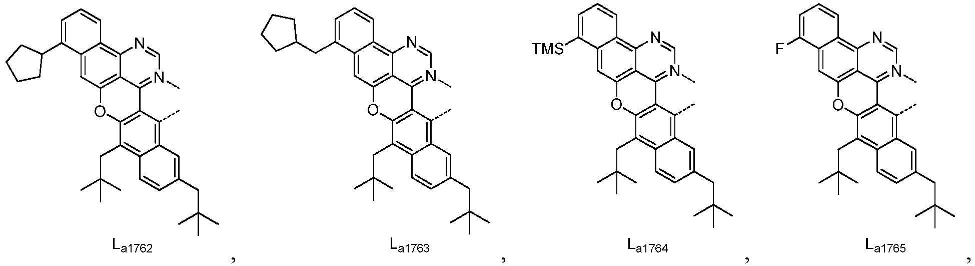 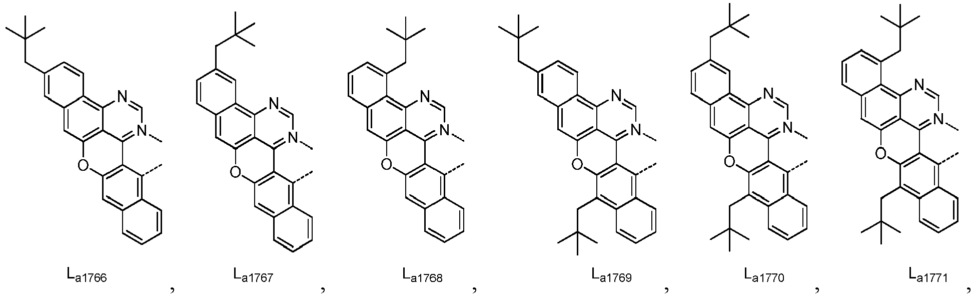 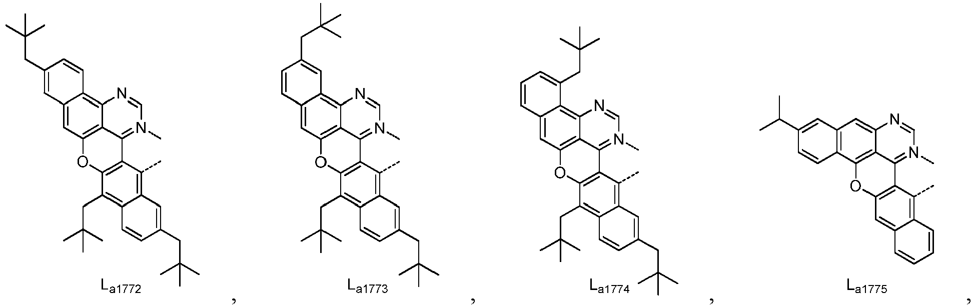 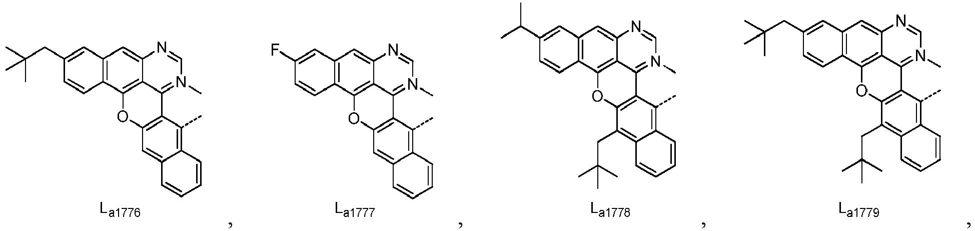 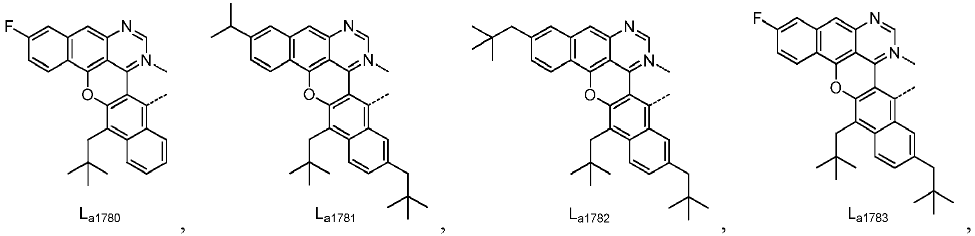 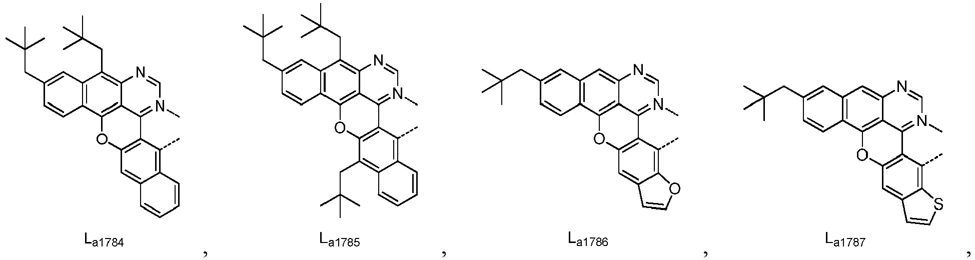 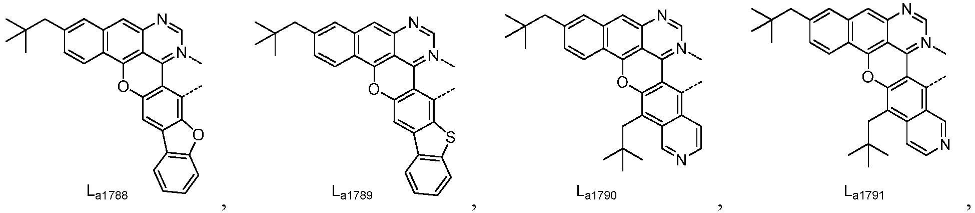 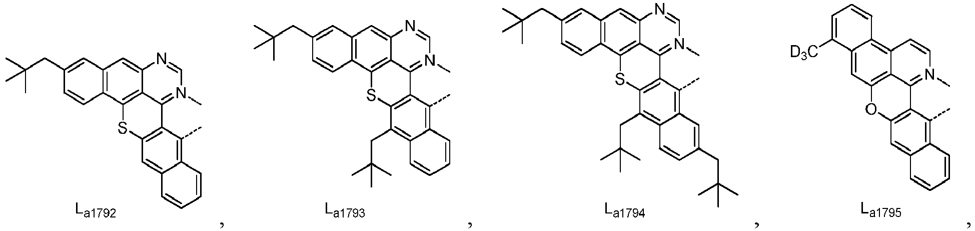 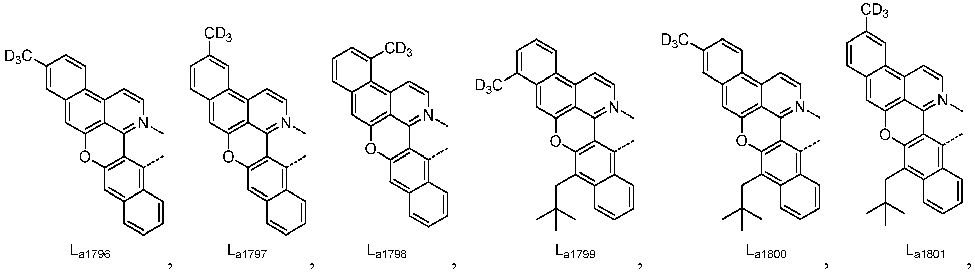 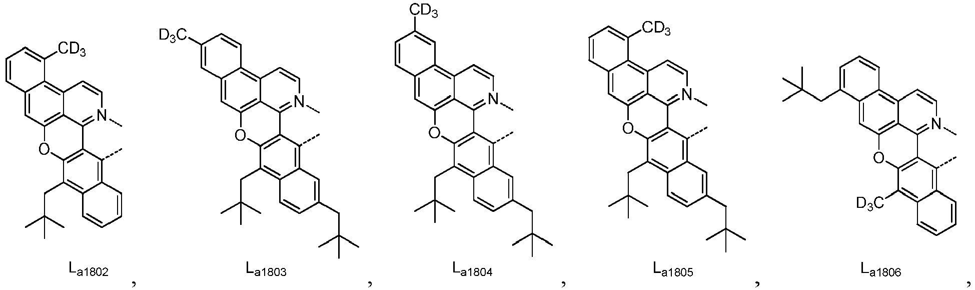 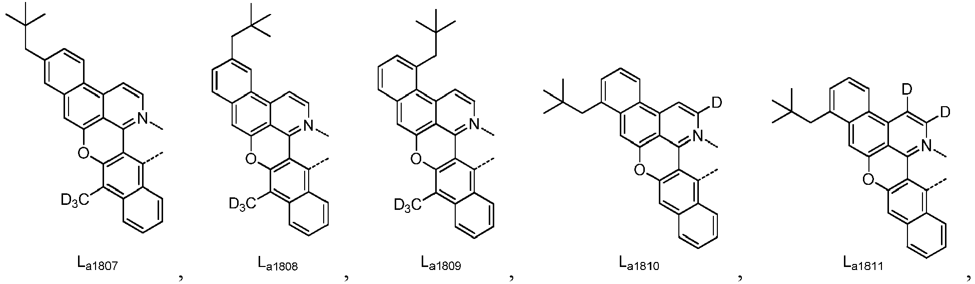 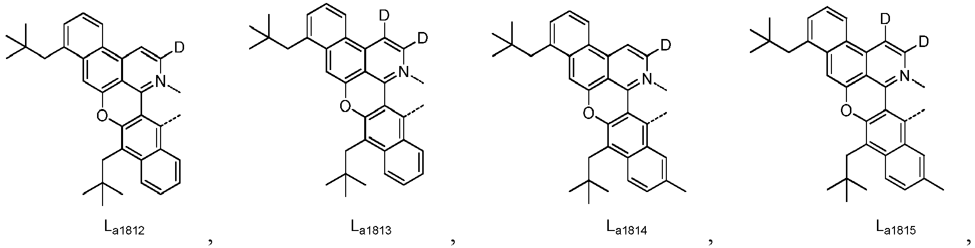 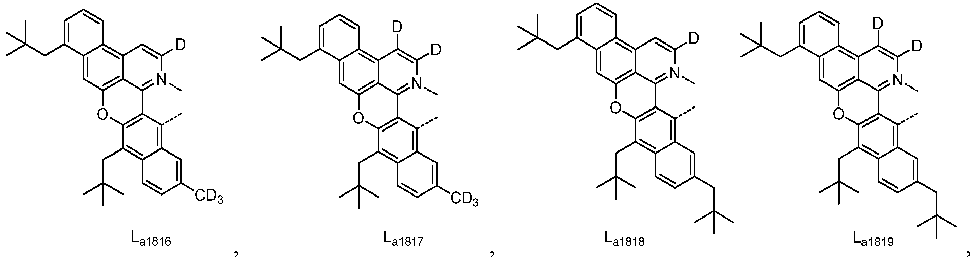 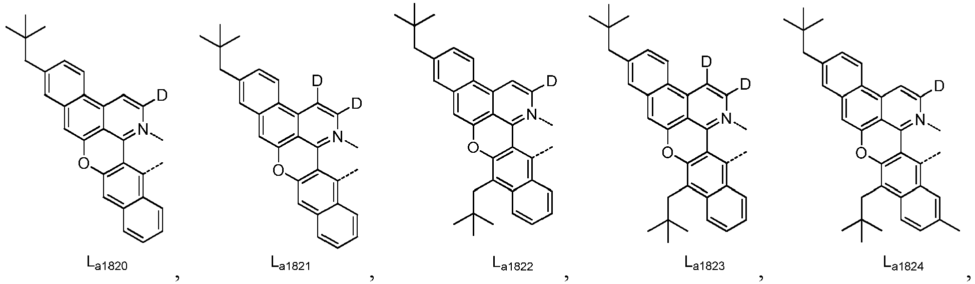 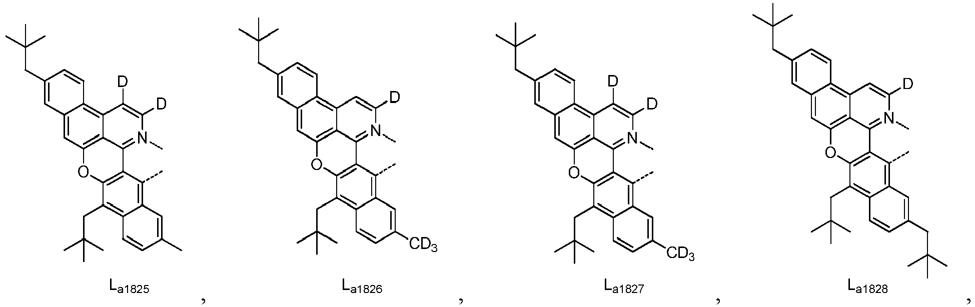 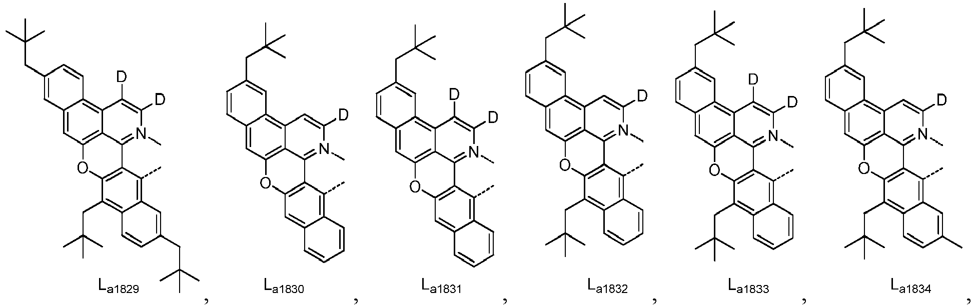 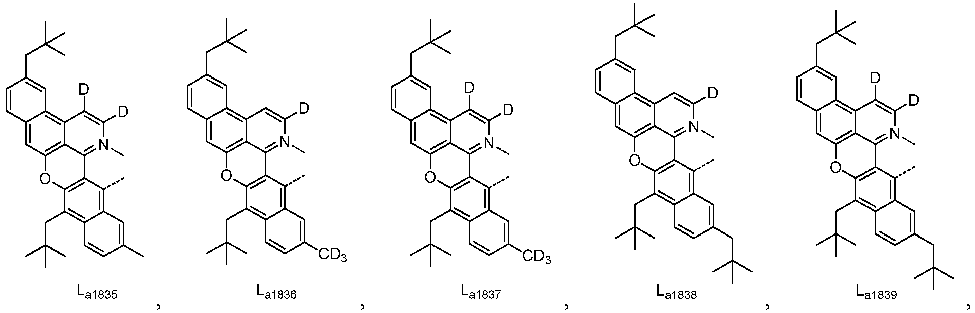 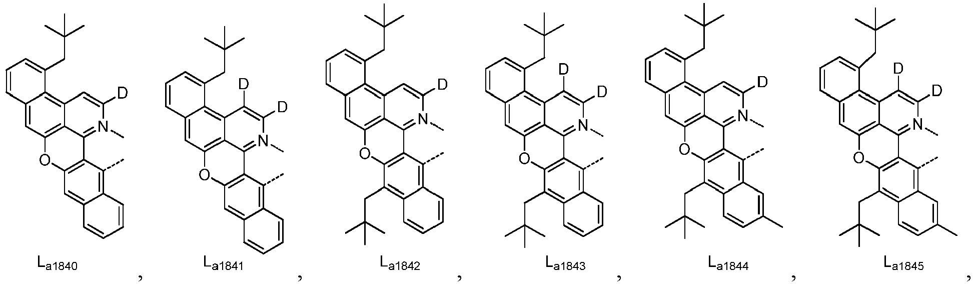 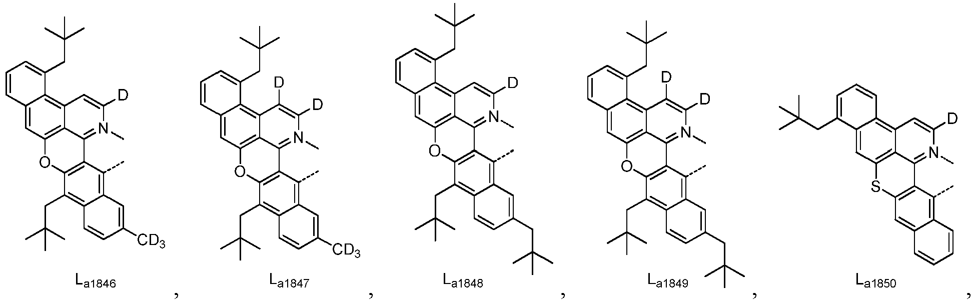 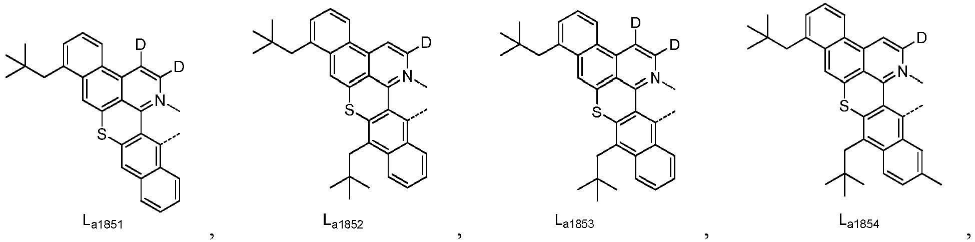 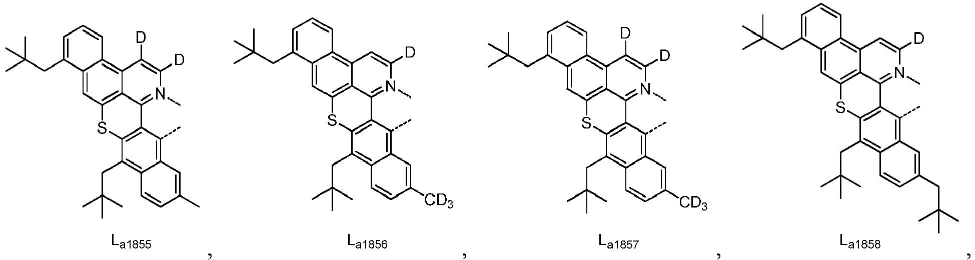 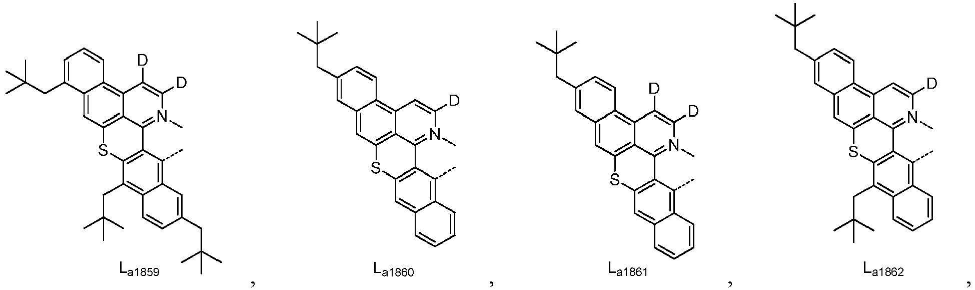 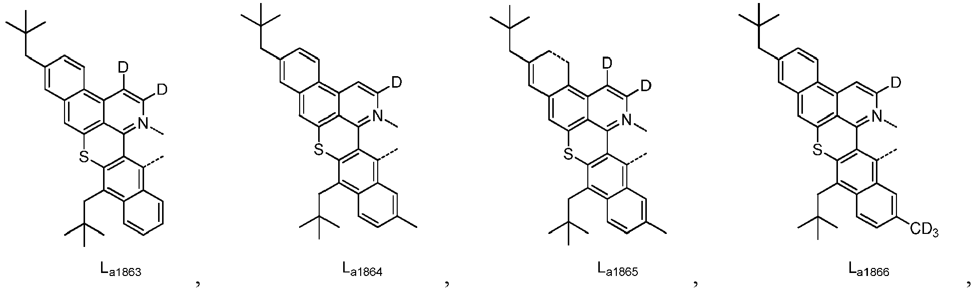 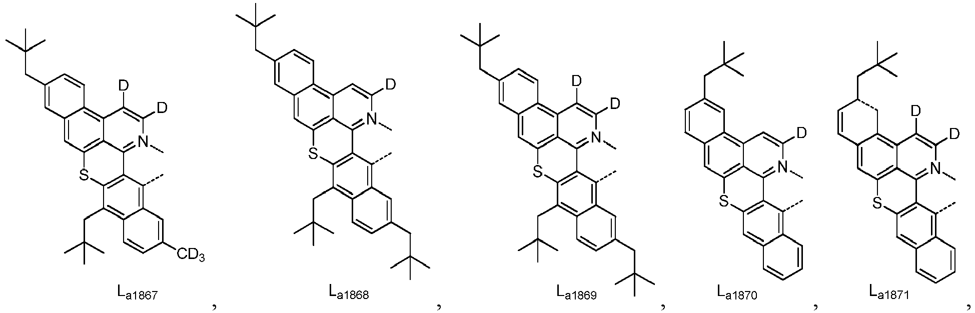 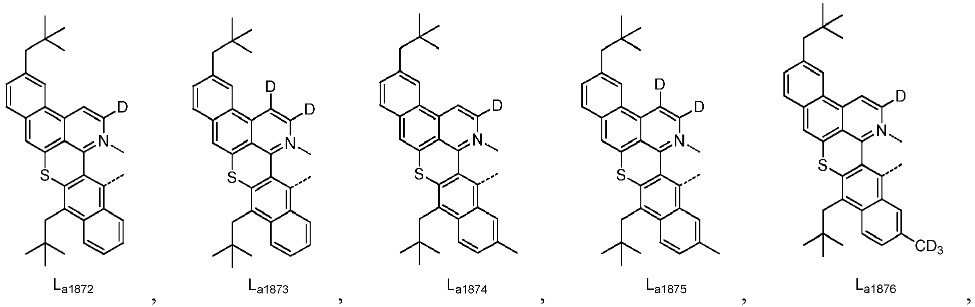 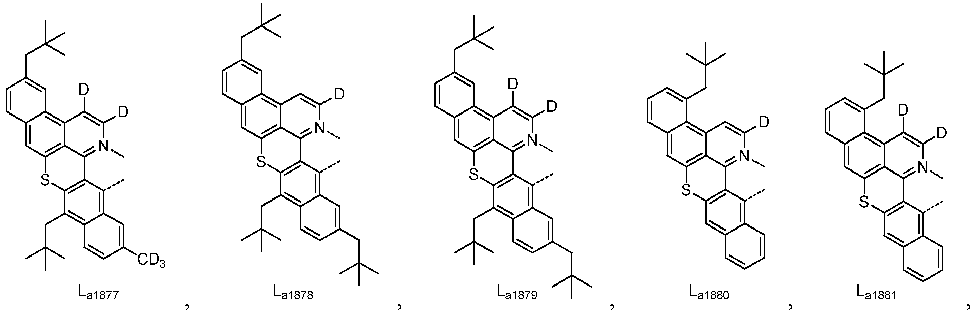 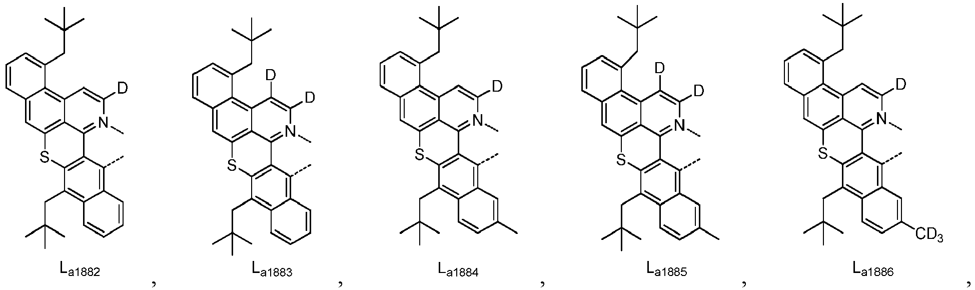 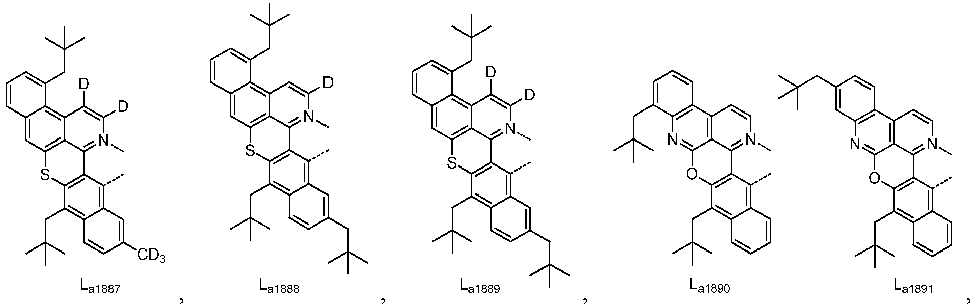 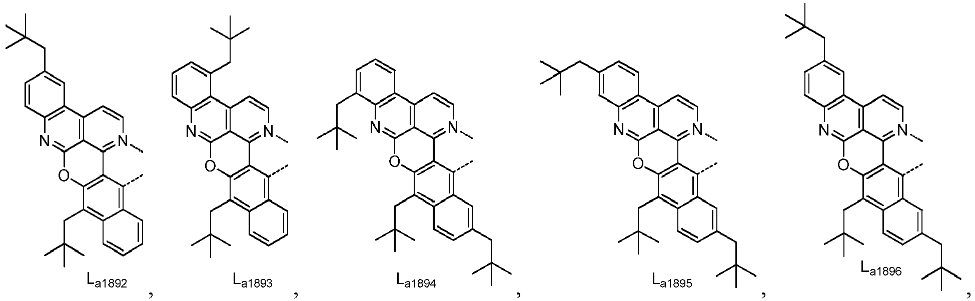 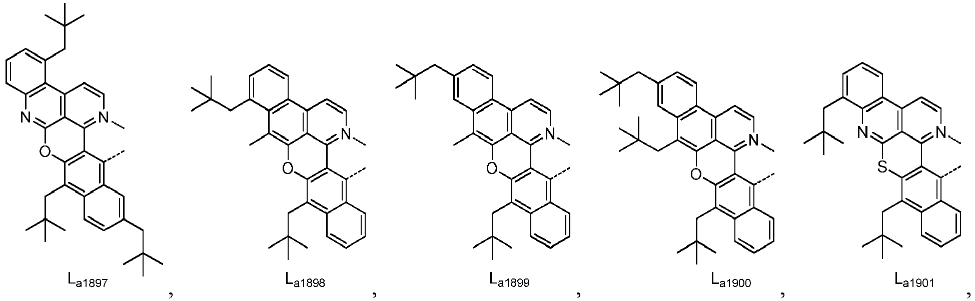 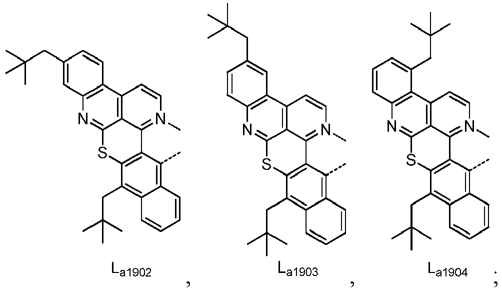
dans lequel, dans les structures ci-dessus, TMS est triméthylsilyle ; et
éventuellement, les hydrogènes dans les structures de Lₐ₁ à Lₐ₁₉₀₄ sont partiellement ou totalement remplacés par du deutérium.

11. Complexe métallique selon l'une quelconque des revendications 1 à 10, dans lequel le complexe métallique a une structure de type M(Lₐ)ₘ(L_{b})ₙ(L_{c})_{q} ;
dans lequel le métal M est choisi parmi un métal de masse atomique relative supérieure à 40 ; préférentiellement, le métal M est choisi parmi Ir, Rh, Re, Os, Pt, Au ou Cu ; plus préférentiellement, le métal M est choisi parmi Ir, Pt ou Os ;
Lₐ, L_{b} et L_{c} sont respectivement un premier ligand, un deuxième ligand et un troisième ligand du complexe ; m est égal à 1, 2 ou 3, n est égal à 0, 1 ou 2, q est égal à 0, 1 ou 2, et m+n+q est égal à un état d'oxydation du métal M ; lorsque m est supérieur à 1, une pluralité de Lₐ sont identiques ou différents ; lorsque n est égal à 2, deux L_{b} sont identiques ou différents ; lorsque q est égal à 2, deux L_{c} sont identiques ou différents ;
Lₐ, L_{b} et L_{c} sont éventuellement liés pour former un ligand multidenté ;
L_{b} et L_{c} sont, à chaque occurrence, de manière identique ou différente, choisis parmi le groupe constitué des structures suivantes : 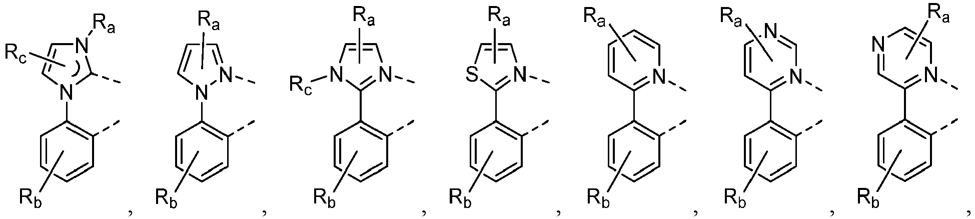 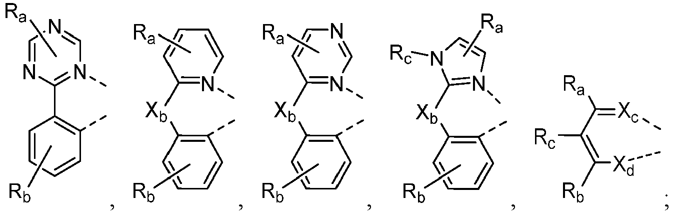
où Rₐ, R_{b} et R_{c} représentent, à chaque occurrence, de manière identique ou différente, une mono-substitution, une pluralité de substitutions ou une non-substitution ;
X_{b} est, à chaque occurrence, de manière identique ou différente, choisis parmi le groupe constitué de : O, S, Se, NR_{N1} et CR_{C1}R_{C2} ;
X_{c} et X_{d} sont, à chaque occurrence, de manière identique ou différente, choisis parmi le groupe constitué de : O, S, Se et NR_{N2} ;
Rₐ, R_{b}, R_{c}, R_{N1}, R_{N2}, R_{C1} et R_{C2} sont, à chaque occurrence, de manière identique ou différente, choisis parmi le groupe constitué de : hydrogène, deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ; et
les substituants adjacents Rₐ, R_{b}, R_{c}, R_{N1}, R_{N2}, R_{C1} et R_{C2} sont éventuellement liés pour former un noyau.

12. Complexe métallique selon la revendication 11, dans lequel le complexe métallique a une formule générale de type Ir(Lₐ)ₘ(L_{b})₃₋ₘ et une structure représentée par la formule 1-1 ou la formule 1-2 : 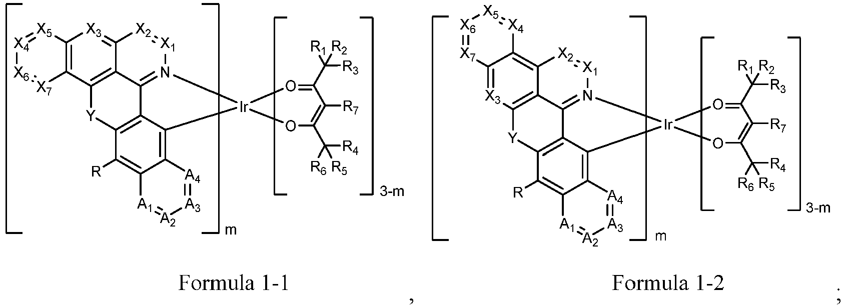 dans lequel
m est 1 ou 2 ;
X₁ et X₂ sont, à chaque occurrence, de manière identique ou différente, choisis parmi CRₓ ou N ; X₃ est, à chaque occurrence, de manière identique ou différente, choisi parmi CRᵢ ou N ; A₁ à A₄ sont, à chaque occurrence, de manière identique ou différente, choisis parmi CRᵢᵢ ou N ; X₄ à X₇ sont, à chaque occurrence, de manière identique ou différente, choisis parmi CH, CRᵢᵢᵢ ou N, et au moins l'un des X₄ à X₇ est choisi parmi CRᵢᵢᵢ ;
Y est choisi parmi SiR_{y}R_{y}, O, S ou Se ; lorsque deux R_{y} sont présents en même temps, les deux R_{y} sont identiques ou différents ;
R, Rₓ, R_{y}, Rᵢ, Rᵢᵢ, R₁, R₂, R₃, R₄, R₅, R₆ et R₇ sont, à chaque occurrence, de manière identique ou différente, choisis parmi le groupe constitué de : hydrogène, deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ;
Rᵢᵢᵢ est, à chaque occurrence, de manière identique ou différente, choisi parmi le groupe constitué de : deutérium, halogène, alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, un groupe hétérocyclique substitué ou non substitué ayant 3 à 20 atomes de cycle, arylalkyle substitué ou non substitué ayant 7 à 30 atomes de carbone, alcoxy substitué ou non substitué ayant 1 à 20 atomes de carbone, aryloxy substitué ou non substitué ayant 6 à 30 atomes de carbone, alcényle substitué ou non substitué ayant 2 à 20 atomes de carbone, aryle substitué ou non substitué ayant 6 à 30 atomes de carbone, hétéroaryle substitué ou non substitué ayant 3 à 30 atomes de carbone, alkylsilyle substitué ou non substitué ayant 3 à 20 atomes de carbone, arylsilyle substitué ou non substitué ayant 6 à 20 atomes de carbone, alkylgermanyle substitué ou non substitué ayant 3 à 20 atomes de carbone, arylgermanyle substitué ou non substitué ayant 6 à 20 atomes de carbone, amino substitué ou non substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ; et
les substituants adjacents R, Rₓ, R_{y}, Rᵢ, Rᵢᵢ et Rᵢᵢᵢ sont éventuellement liés pour former un noyau.
les substituants adjacents R₁, R₂, R₃, R₄, R₅, R₆ et R₇ sont éventuellement liés pour former un noyau.
préférentiellement, au moins l'un ou deux parmi R₁ à R₃ est(sont), à chaque occurrence, de manière identique ou différente, choisi(s) parmi un groupe alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone, ou une combinaison de ceux-ci ; et/ou au moins l'un ou deux parmi R₄ à R₆ est(sont), à chaque occurrence, de manière identique ou différente, choisi(s) parmi un groupe alkyle substitué ou non substitué ayant 1 à 20 atomes de carbone, cycloalkyle substitué ou non substitué ayant 3 à 20 atomes de carbone de cycle, hétéroalkyle substitué ou non substitué ayant 1 à 20 atomes de carbone ou une combinaison de ceux-ci ; et
plus préférentiellement, au moins deux des R₁ à R₃ sont, à chaque occurrence, de manière identique ou différente, choisis parmi un groupe alkyle substitué ou non substitué ayant 2 à 20 atomes de carbone, cycloalkyle substitué ou non substitué ayant 3 à 20 atomes de carbone de cycle, hétéroalkyle substitué ou non substitué ayant 2 à 20 atomes de carbone, ou une combinaison de ceux-ci ; et/ou au moins deux des R₄ à R₆ sont, à chaque occurrence, de manière identique ou différente, choisis parmi un groupe alkyle substitué ou non substitué ayant 2 à 20 atomes de carbone, cycloalkyle substitué ou non substitué ayant 3 à 20 atomes de carbone de cycle, hétéroalkyle substitué ou non substitué ayant 2 à 20 atomes de carbone ou une combinaison de ceux-ci.

13. Complexe métallique selon l'une quelconque des revendications 10 à 11, dans lequel L_{b} est, à chaque occurrence, de manière identique ou différente, choisi parmi le groupe constitué des structures suivantes : 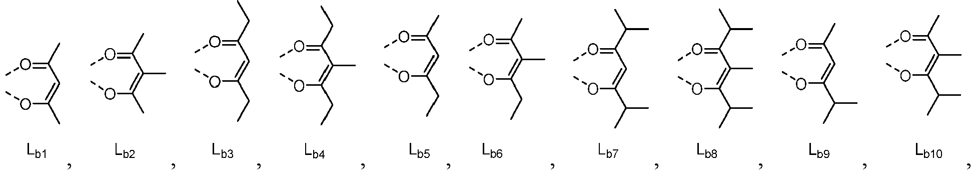 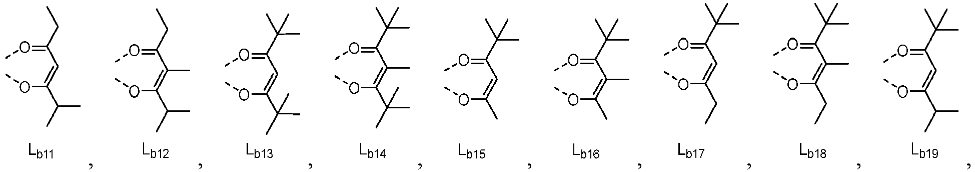 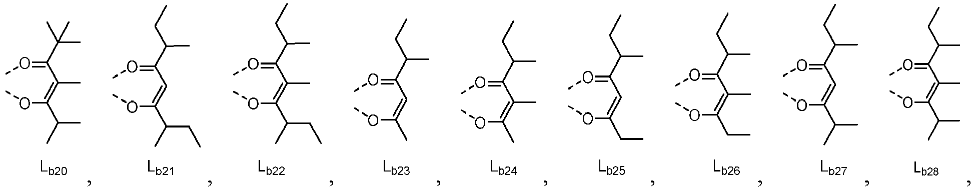 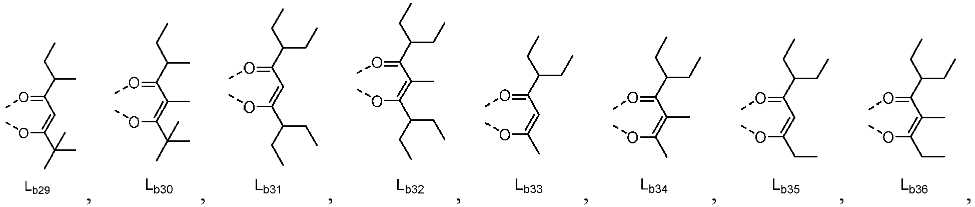 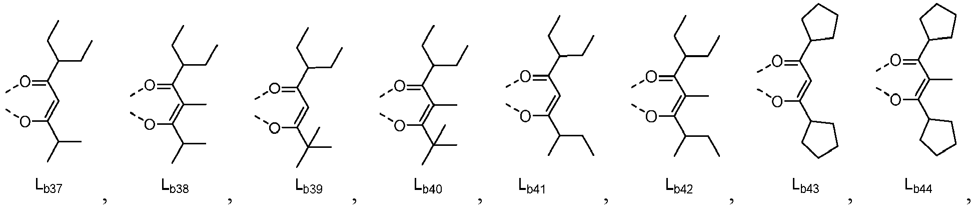 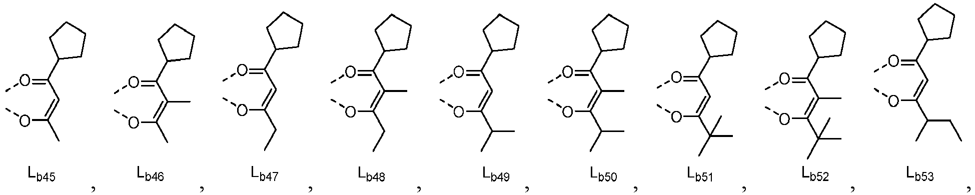 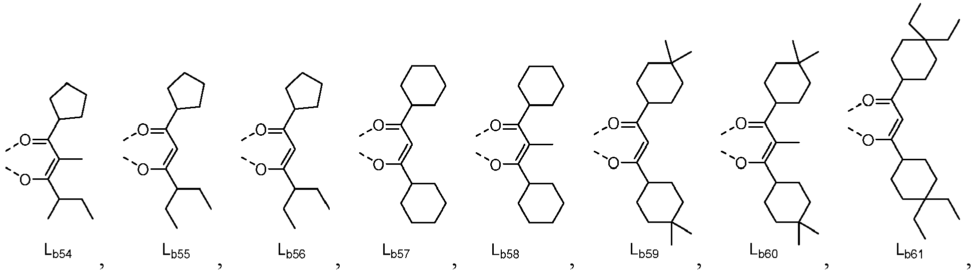 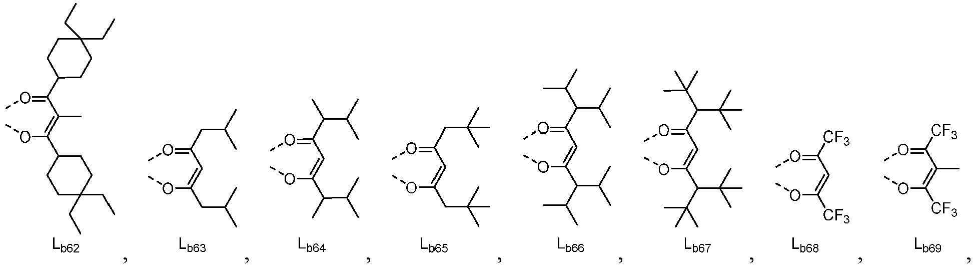 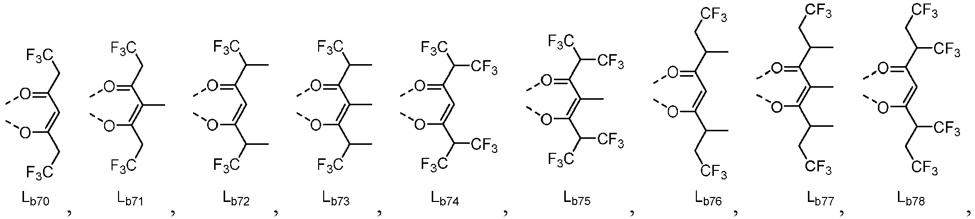 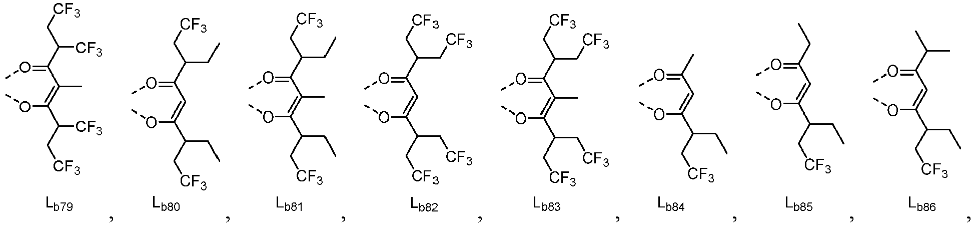 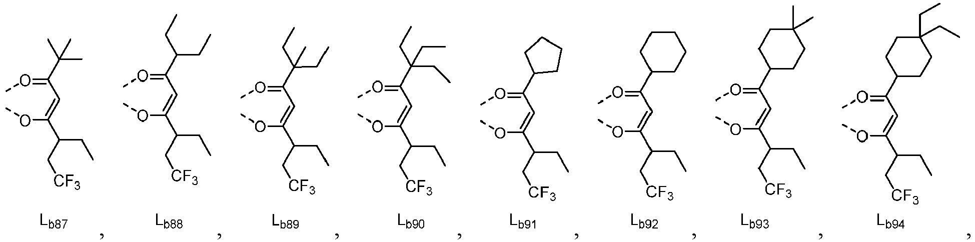 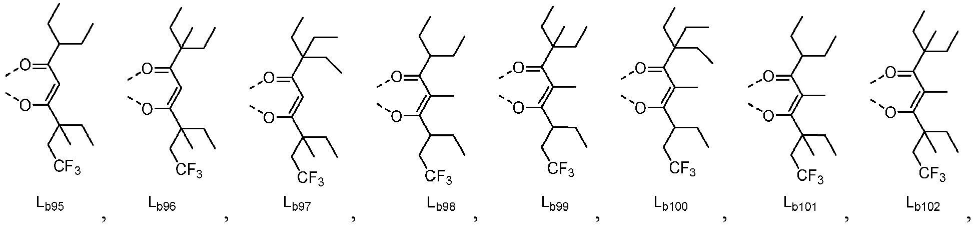 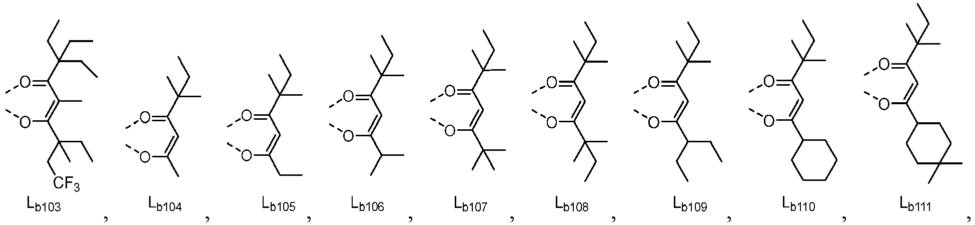 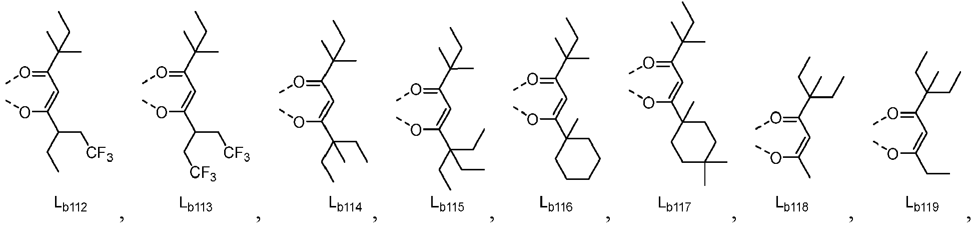 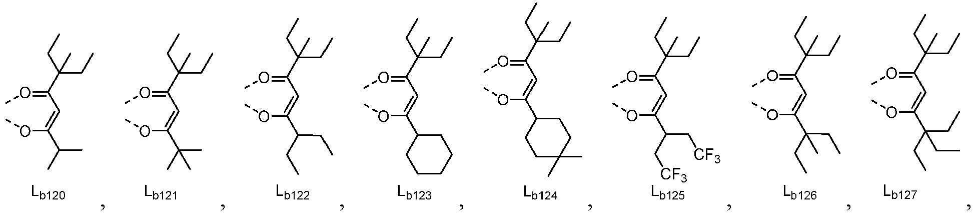 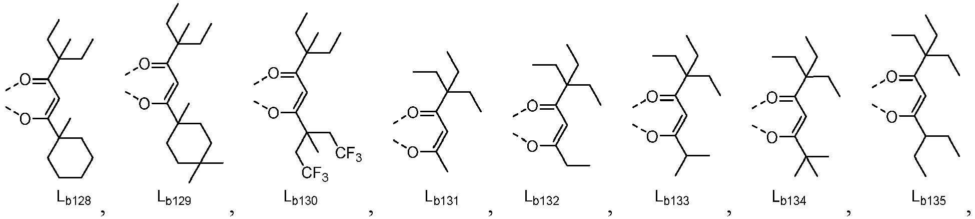 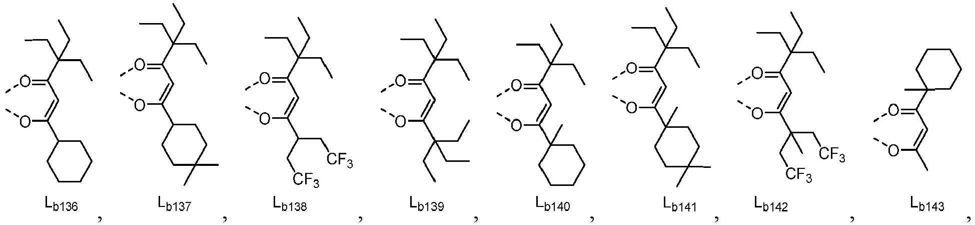 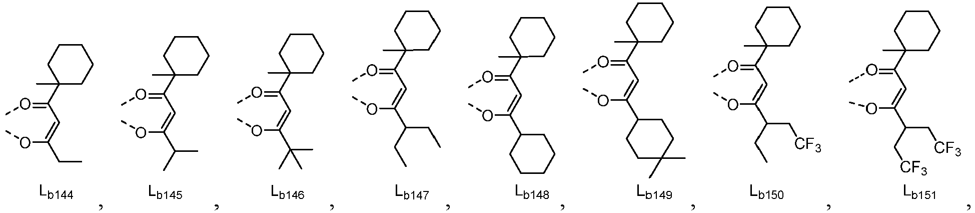 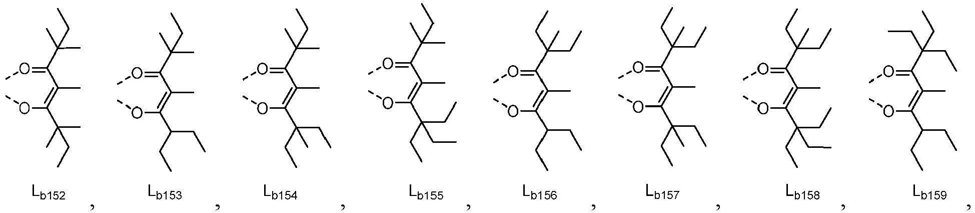 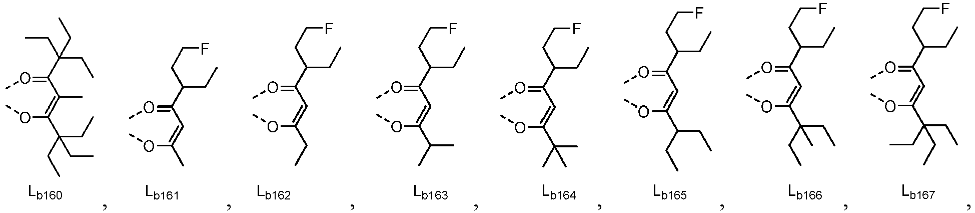 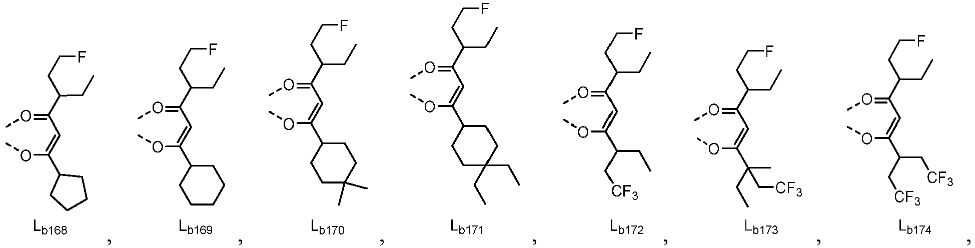 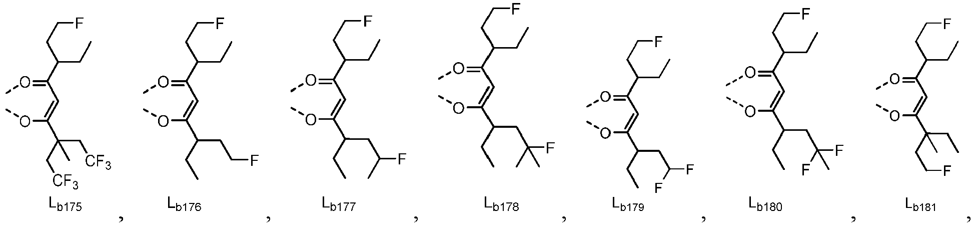 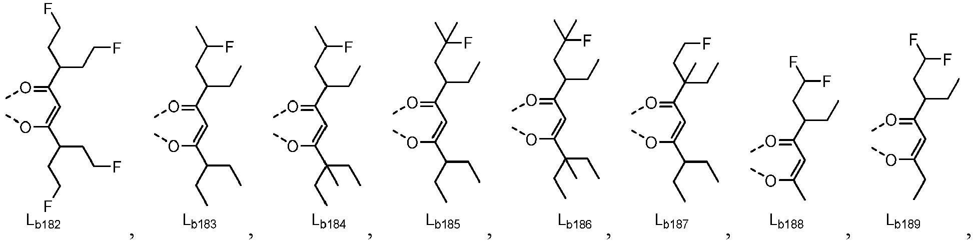 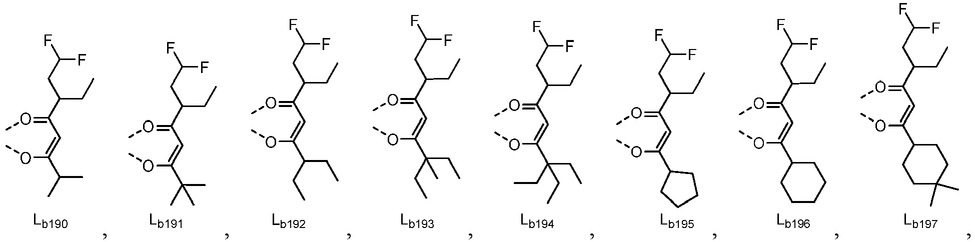 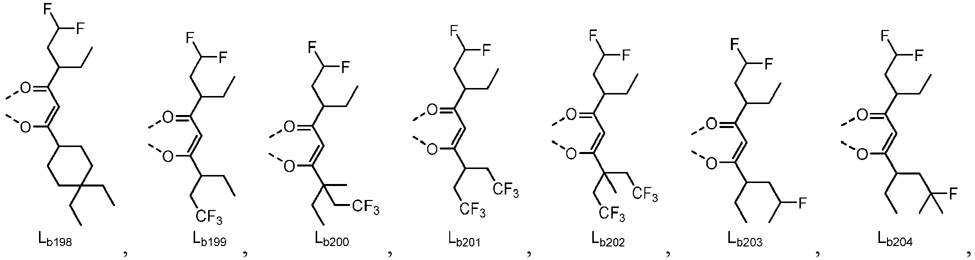 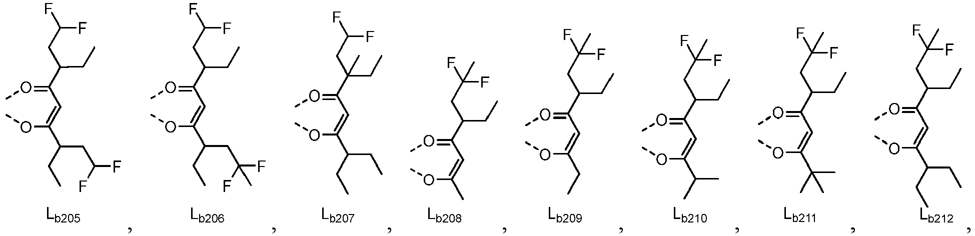 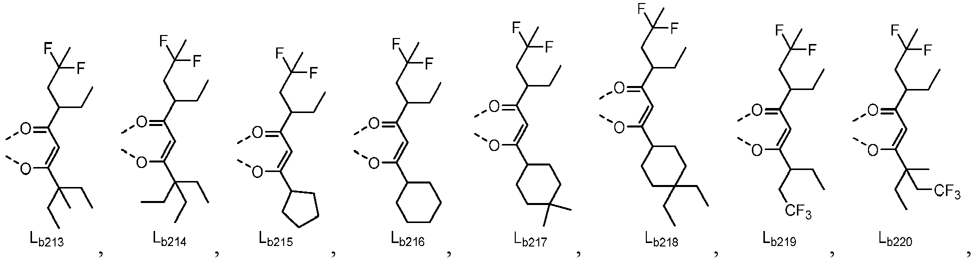 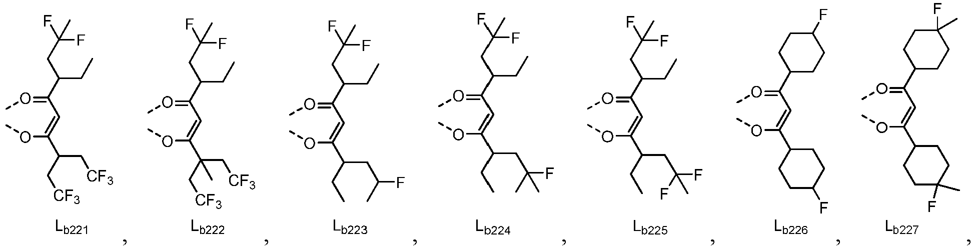 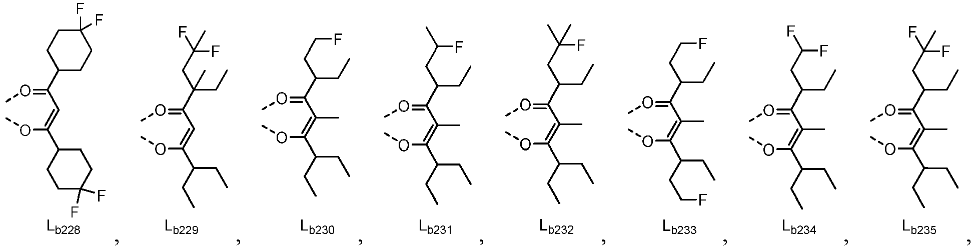 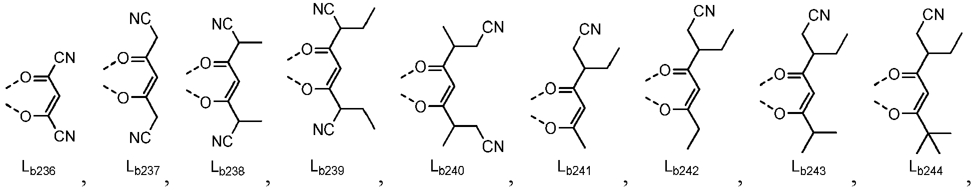 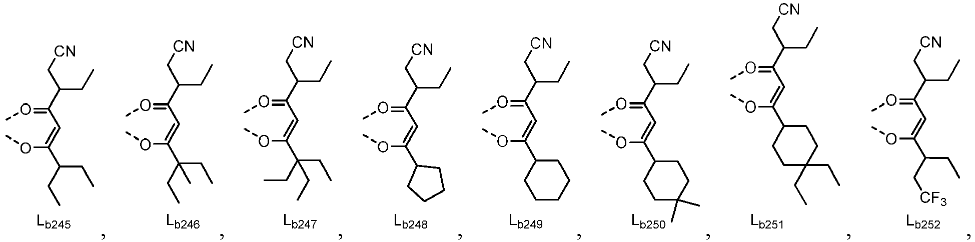 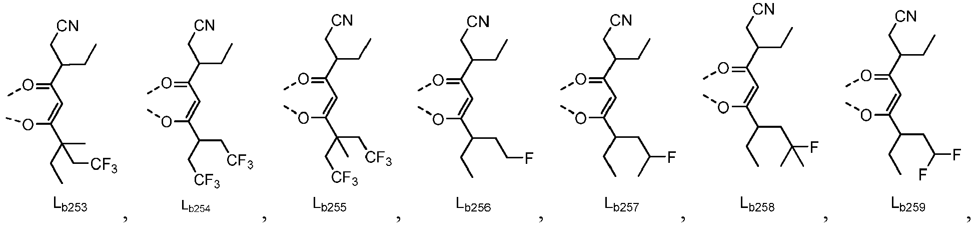 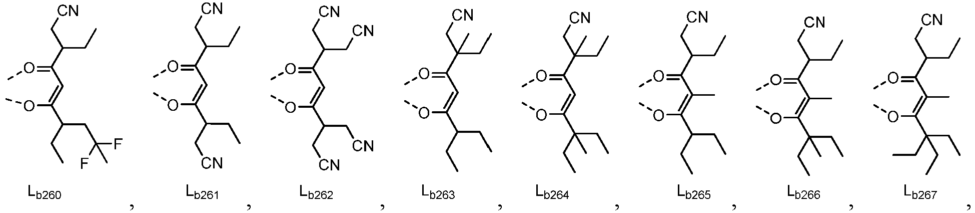 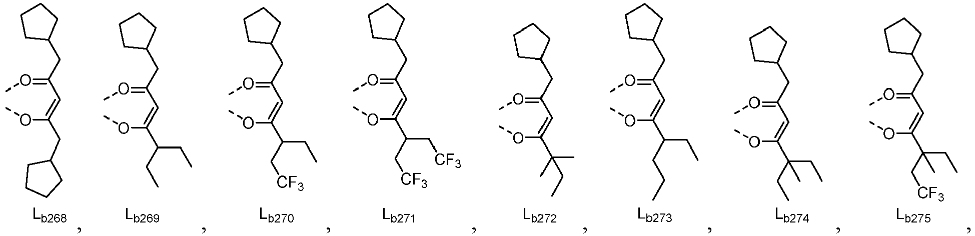 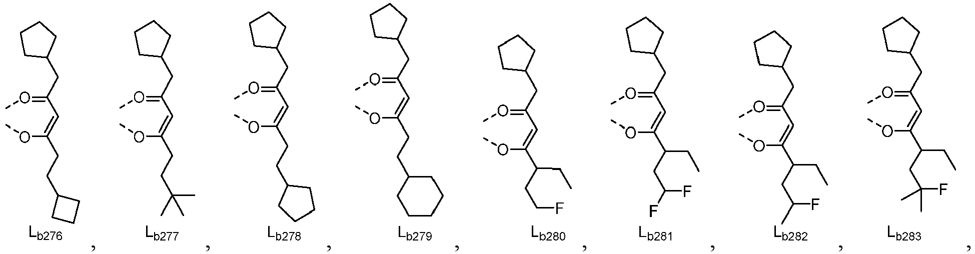 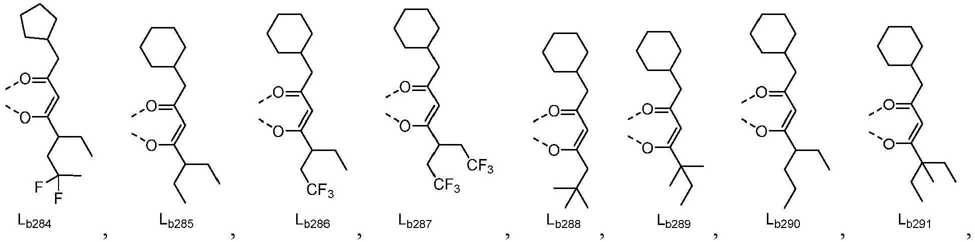 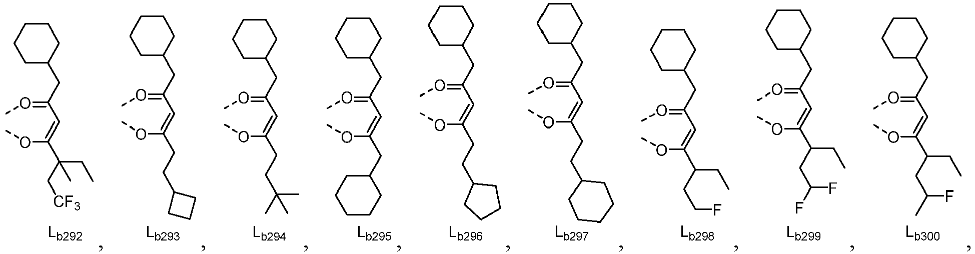 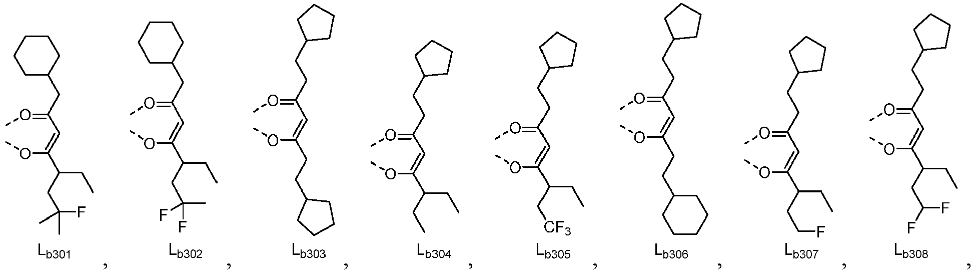 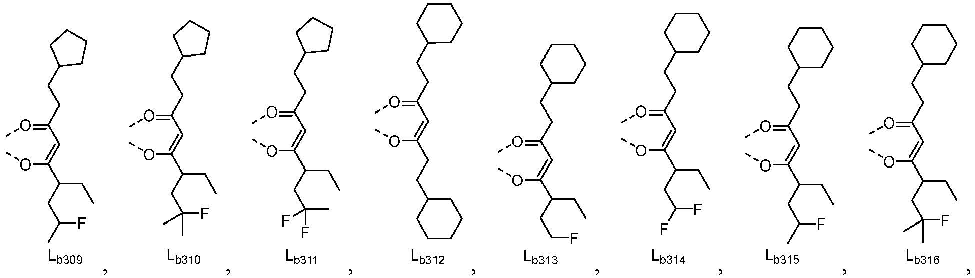 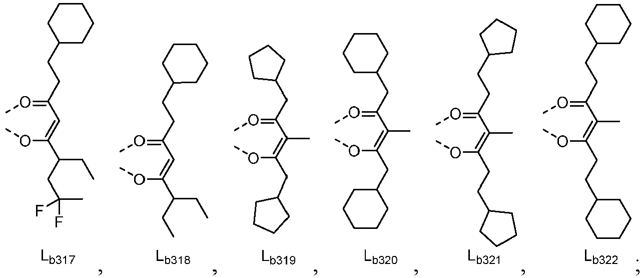 dans lequel L_{c} est, à chaque occurrence, de manière identique ou différente, choisi parmi le groupe constitué des structures suivantes :

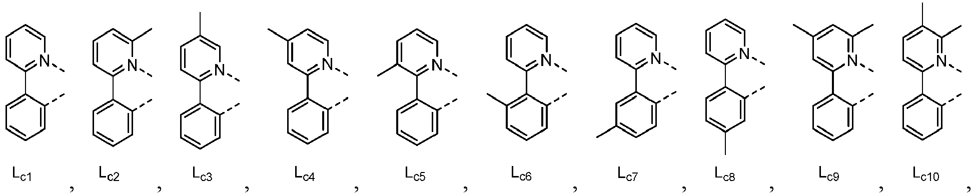

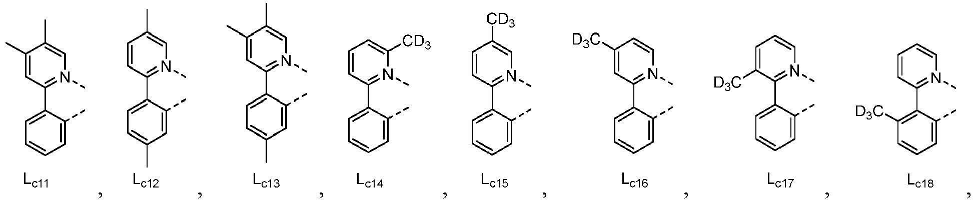

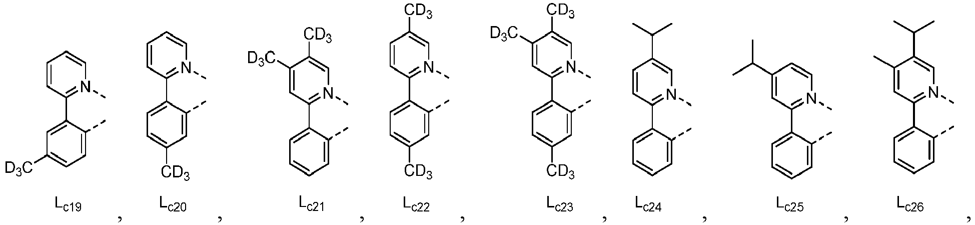

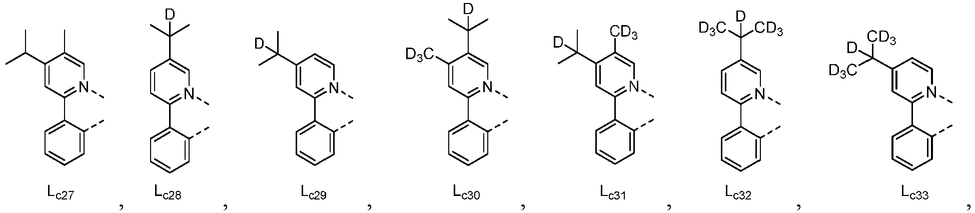

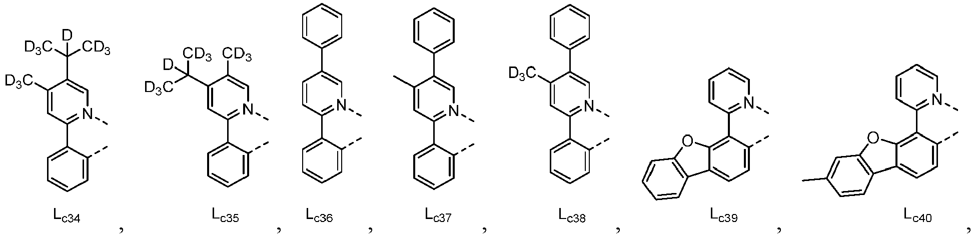

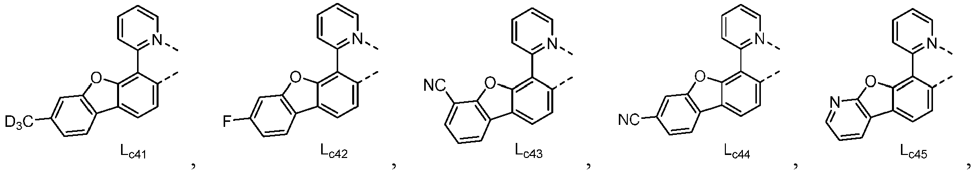

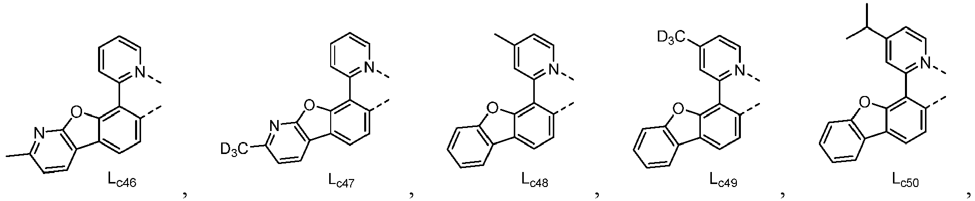

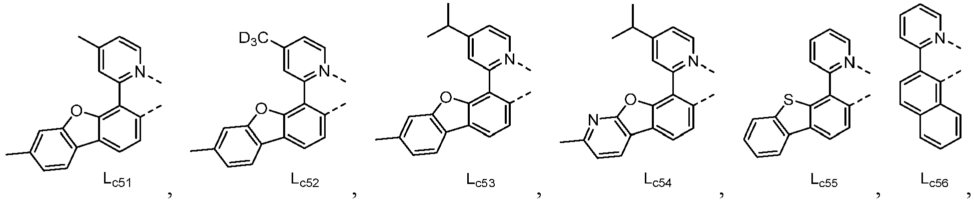

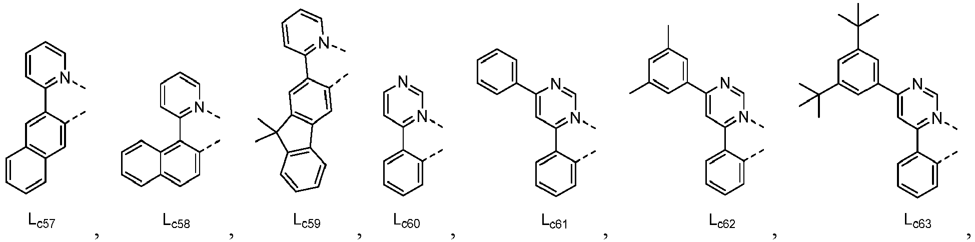

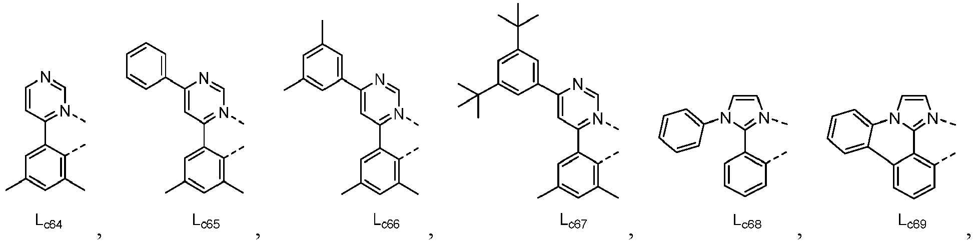

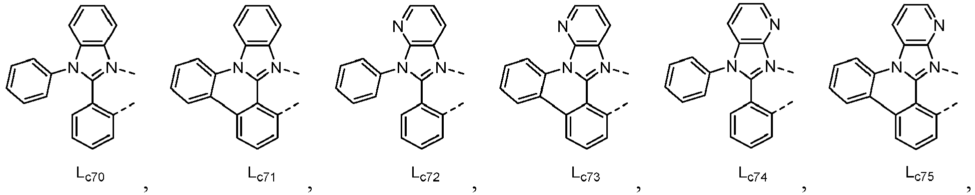

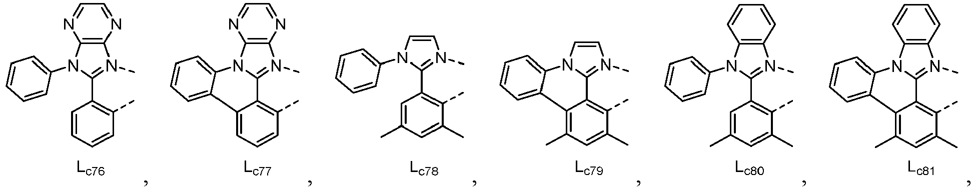

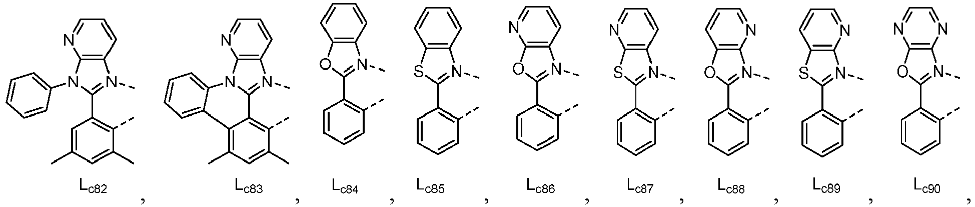

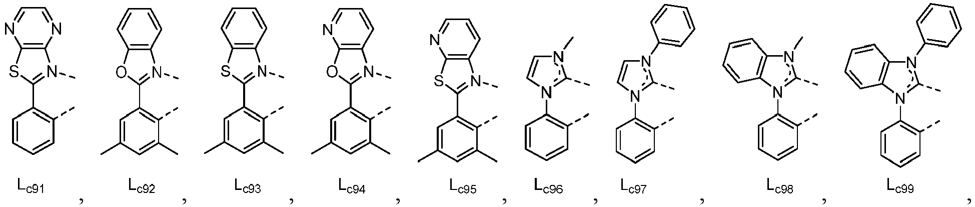

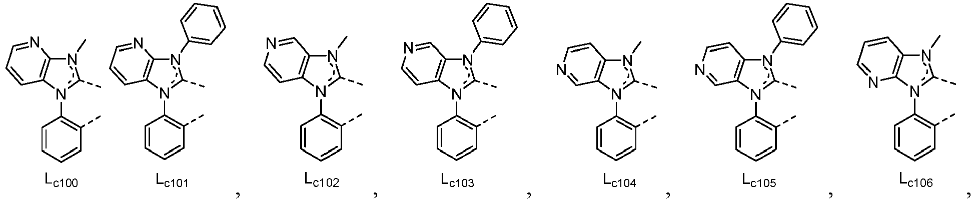

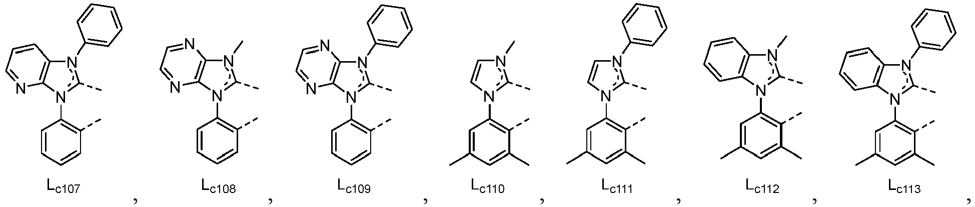

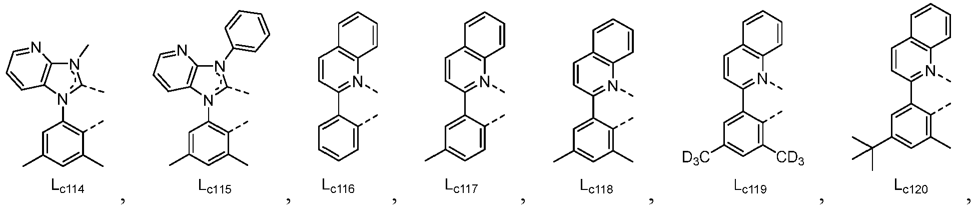

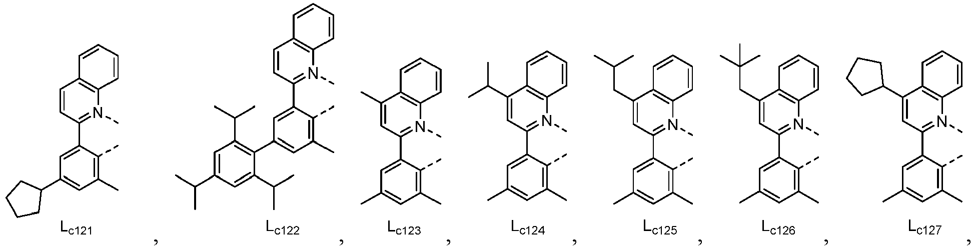

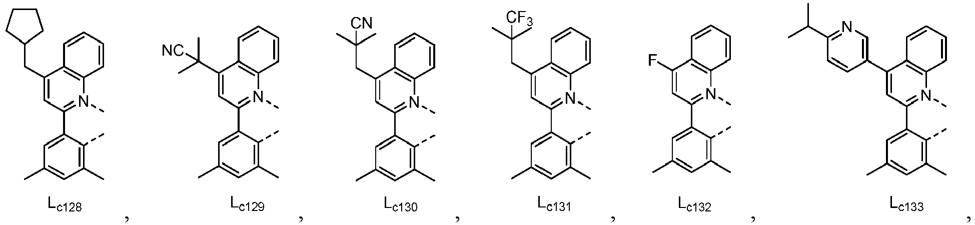

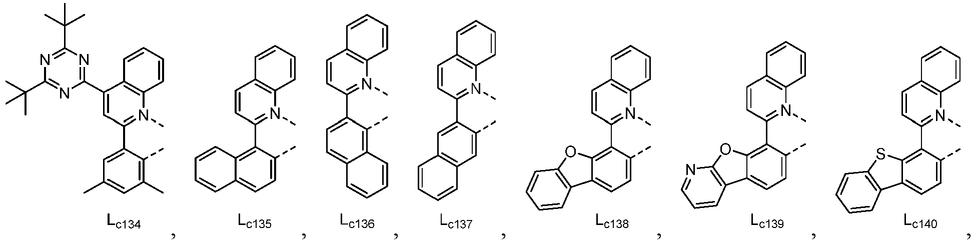

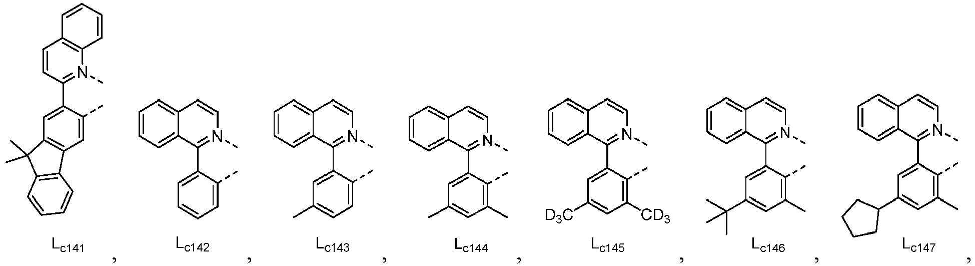

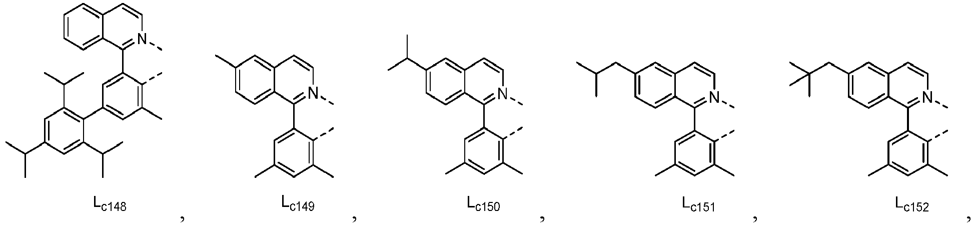

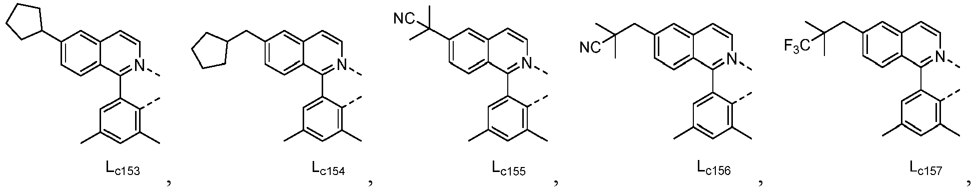

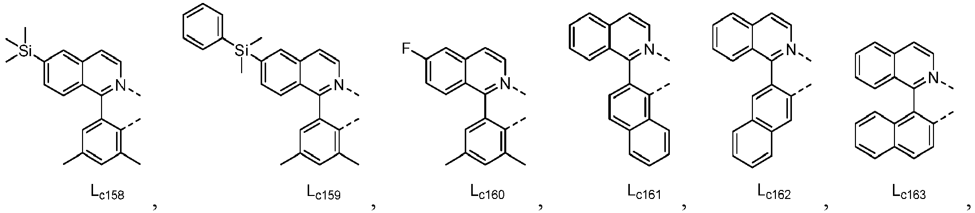

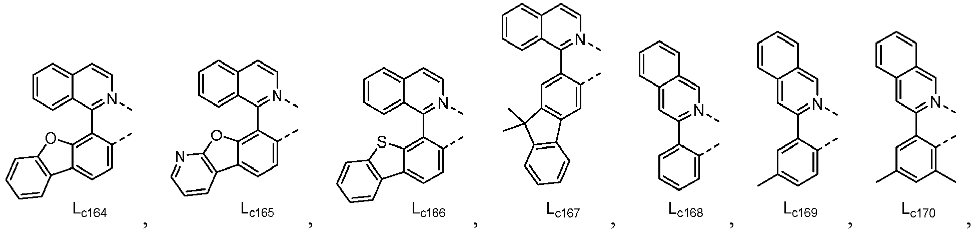

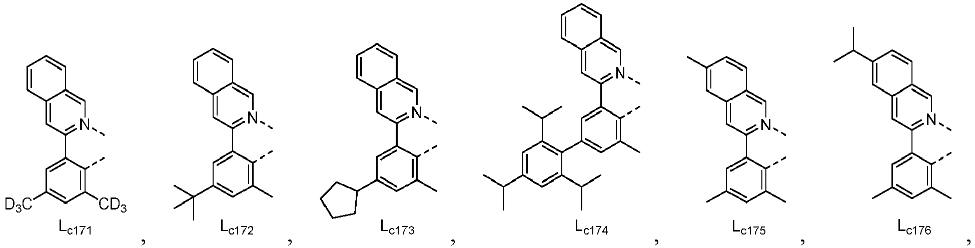

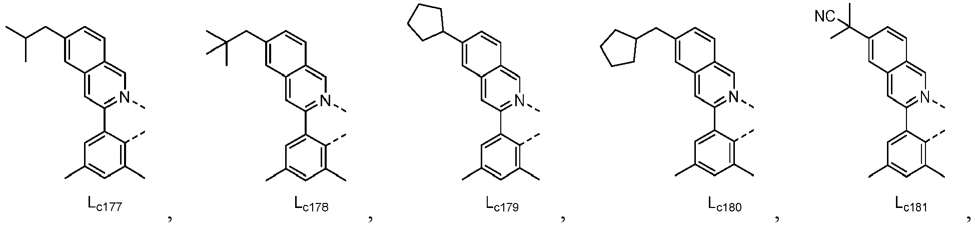

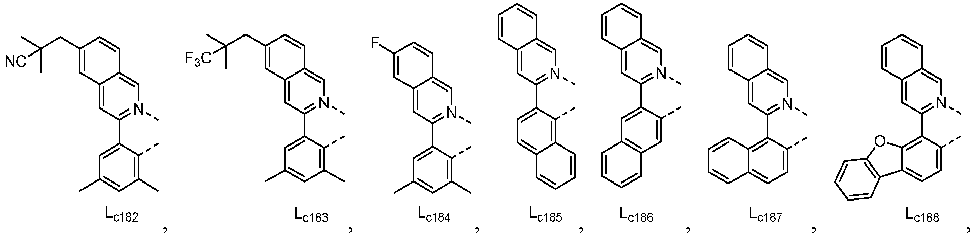

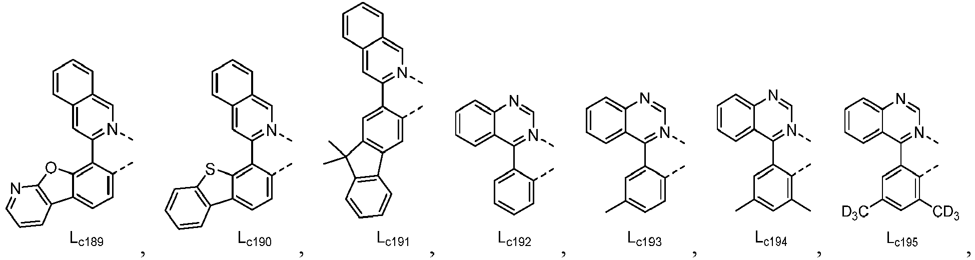

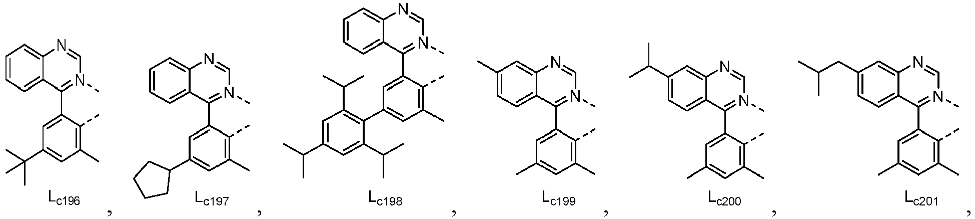

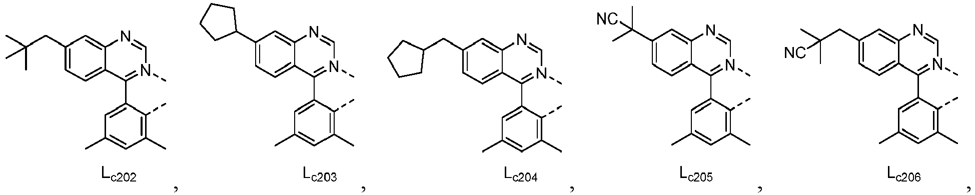

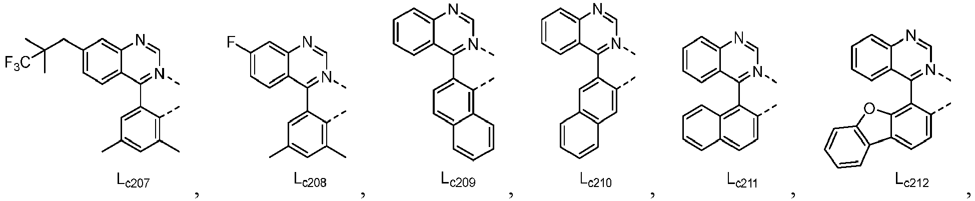

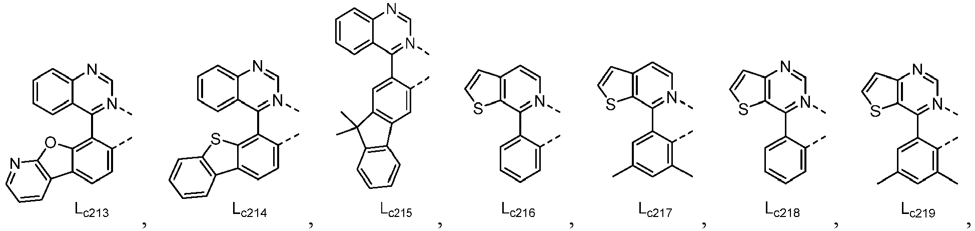

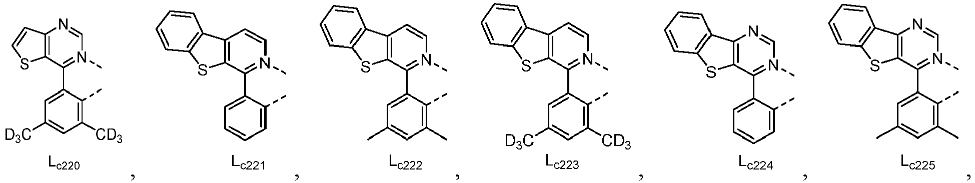

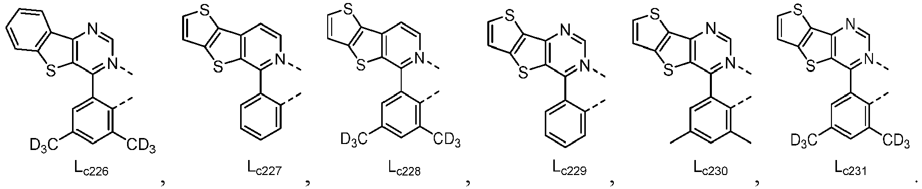

14. Complexe métallique selon la revendication 13, dans lequel le complexe métallique a une structure de type Ir(Lₐ)₂(L_{b}) ou Ir(Lₐ)₂(L_{c}) ou Ir(Lₐ)(L_{c})₂ ou Ir(Lₐ)(L_{b})(L_{c}) ;
dans lequel, lorsque le complexe métallique a une structure de type Ir(Lₐ)₂(L_{b}), Lₐ est, à chaque occurrence, de manière identique ou différente, choisi parmi un élément quelconque ou deux éléments quelconques du groupe constitué de Lₐ₁ à Lₐ₁₉₀₄, et L_{b} est choisi parmi un élément quelconque du groupe constitué de L_{b1} à L_{b322} ; lorsque le complexe métallique a une structure de type Ir(Lₐ)₂(L_{c}), Lₐ est, à chaque occurrence, de manière identique ou différente, choisi parmi un élément quelconque ou deux éléments quelconques du groupe constitué de Lₐ₁ à Lₐ₁₉₀₄, et L_{c} est choisi parmi un élément quelconque du groupe constitué de L_{c1} à L_{c231} ; lorsque le complexe métallique a une structure de type Ir(Lₐ)(L_{c})₂, Lₐ est choisi parmi un élément quelconque du groupe constitué de Lₐ₁ à Lₐ₁₉₀₄, et L_{c} est, à chaque occurrence, de manière identique ou différente, choisi parmi un élément quelconque ou deux éléments quelconques du groupe constitué de L_{c1} à L_{c231} ; lorsque le complexe métallique a une structure de type Ir(Lₐ)(L_{b})(L_{c}), Lₐ est choisi parmi un élément quelconque du groupe constitué de Lₐ₁ à Lₐ₁₉₀₄, L_{b} est choisi parmi un élément quelconque du groupe constitué de L_{b1} à L_{b322}, et L_{c} est choisi parmi un élément quelconque du groupe constitué de L_{c1} à L_{c231} ; et
préférentiellement, le complexe métallique est choisi parmi le groupe constitué des composés 1 à 1010 ;
dans lequel les composés 1 à 800 ont chacun une structure de type Ir(Lₐ)₂(L_{b}), où les deux Lₐ sont identiques et les Lₐ et L_{b} sont respectivement choisis parmi les structures listées dans le tableau suivant :
| Composé n° | Lₐ | L_{b} | Composé n° | Lₐ | L_{b} |
|---|---|---|---|---|---|
| 1 | Lₐ₅ | L_{b1} | 2 | Lₐ₂₁ | L_{b1} |
| 3 | Lₐ₃₅ | L_{b1} | 4 | Lₐ₆₆ | L_{b1} |
| 5 | Lₐ₆₉ | L_{b1} | 6 | Lₐ₇₀ | L_{b1} |
| 7 | Lₐ₇₄ | L_{b1} | 8 | Lₐ₁₂₁ | L_{b1} |
| 9 | Lₐ₁₄₈ | L_{b1} | 10 | Lₐ₁₇₅ | L_{b1} |
| 11 | Lₐ₂₀₇ | L_{b1} | 12 | Lₐ₂₁₂ | L_{b1} |
| 13 | Lₐ₂₃₆ | L_{b1} | 14 | Lₐ₂₅₅ | L_{b1} |
| 15 | Lₐ₂₇₁ | L_{b1} | 16 | Lₐ₂₈₇ | L_{b1} |
| 17 | Lₐ₃₁₉ | L_{b1} | 18 | Lₐ₃₂₀ | L_{b1} |
| 19 | Lₐ₃₃₅ | L_{b1} | 20 | Lₐ₃₉₉ | L_{b1} |
| 21 | Lₐ₄₃₈ | L_{b1} | 22 | Lₐ₄₅₃ | L_{b1} |
| 23 | Lₐ₄₆₉ | L_{b1} | 24 | Lₐ₄₉₇ | L_{b1} |
| 25 | Lₐ₅₀₀ | L_{b1} | 26 | Lₐ₅₂₉ | L_{b1} |
| 27 | Lₐ₆₀₁ | L_{b1} | 28 | Lₐ₆₀₆ | L_{b1} |
| 29 | Lₐ₆₃₇ | L_{b1} | 30 | Lₐ₆₆₅ | L_{b1} |
| 31 | Lₐ₆₈₉ | L_{b1} | 32 | Lₐ₆₉₉ | L_{b1} |
| 33 | Lₐ₇₀₀ | L_{b1} | 34 | Lₐ₇₄₄ | L_{b1} |
| 35 | Lₐ₇₇₇ | L_{b1} | 36 | Lₐ₇₉₃ | L_{b1} |
| 37 | Lₐ₈₁₀ | L_{b1} | 38 | Lₐ₈₄₂ | L_{b1} |
| 39 | Lₐ₈₅₀ | L_{b1} | 40 | Lₐ₉₁₇ | L_{b1} |
| 41 | Lₐ₉₈₂ | L_{b1} | 42 | Lₐ₉₈₉ | L_{b1} |
| 43 | Lₐ₁₀₁₆ | L_{b1} | 44 | Lₐ₁₀₃₁ | L_{b1} |
| 45 | Lₐ₁₀₄₇ | L_{b1} | 46 | Lₐ₁₀₇₉ | L_{b1} |
| 47 | Lₐ₁₁₆₃ | L_{b1} | 47 | Lₐ₁₁₉₁ | L_{b1} |
| 49 | Lₐ₁₁₉₈ | L_{b1} | 50 | Lₐ₁₂₃₆ | L_{b1} |
| 51 | Lₐ₁₂₄₇ | L_{b1} | 52 | Lₐ₁₂₇₆ | L_{b1} |
| 53 | Lₐ₁₃₁₃ | L_{b1} | 54 | Lₐ₁₃₃₆ | L_{b1} |
| 55 | Lₐ₁₃₄₁ | L_{b1} | 56 | Lₐ₁₃₆₄ | L_{b1} |
| 57 | Lₐ₁₃₉₅ | L_{b1} | 58 | Lₐ₁₄₃₇ | L_{b1} |
| 59 | Lₐ₁₄₅₄ | L_{b1} | 60 | Lₐ₁₄₅₅ | L_{b1} |
| 61 | Lₐ₁₄₈₀ | L_{b1} | 62 | Lₐ₁₄₈₇ | L_{b1} |
| 63 | Lₐ₁₄₉₂ | L_{b1} | 64 | Lₐ₁₅₁₀ | L_{b1} |
| 65 | Lₐ₁₅₂₃ | L_{b1} | 66 | Lₐ₁₅₃₁ | L_{b1} |
| 67 | Lₐ₁₅₇₁ | L_{b1} | 68 | Lₐ₁₅₉₁ | L_{b1} |
| 69 | Lₐ₁₆₀₈ | L_{b1} | 70 | Lₐ₁₆₀₉ | L_{b1} |
| 71 | Lₐ₁₆₂₉ | L_{b1} | 72 | Lₐ₁₆₃₀ | L_{b1} |
| 73 | Lₐ₁₆₃₈ | L_{b1} | 74 | Lₐ₁₆₈₈ | L_{b1} |
| 75 | Lₐ₁₇₀₂ | L_{b1} | 76 | Lₐ₁₇₁₇ | L_{b1} |
| 77 | Lₐ₁₇₂₃ | L_{b1} | 78 | Lₐ₁₇₅₃ | L_{b1} |
| 79 | Lₐ₁₇₆₁ | L_{b1} | 80 | Lₐ₁₈₁₃ | L_{b1} |
| 81 | Lₐ₁₈₁₅ | L_{b1} | 82 | Lₐ₁₈₁₉ | L_{b1} |
| 83 | Lₐ₁₈₂₃ | L_{b1} | 84 | Lₐ₁₈₂₉ | L_{b1} |
| 85 | Lₐ₁₈₃₃ | L_{b1} | 86 | Lₐ₁₈₃₉ | L_{b1} |
| 87 | Lₐ₁₈₄₃ | L_{b1} | 88 | Lₐ₁₈₄₉ | L_{b1} |
| 89 | Lₐ₁₈₅₃ | L_{b1} | 90 | Lₐ₁₈₅₅ | L_{b1} |
| 91 | Lₐ₁₈₅₉ | L_{b1} | 92 | Lₐ₁₈₆₃ | L_{b1} |
| 93 | Lₐ₁₈₆₅ | L_{b1} | 94 | Lₐ₁₈₆₉ | L_{b1} |
| 95 | Lₐ₁₈₇₃ | L_{b1} | 96 | Lₐ₁₈₇₅ | L_{b1} |
| 97 | Lₐ₁₈₇₉ | L_{b1} | 98 | Lₐ₁₈₈₃ | L_{b1} |
| 99 | Lₐ₁₈₈₅ | L_{b1} | 100 | Lₐ₁₈₈₉ | L_{b1} |
| 101 | Lₐ₅ | L_{b31} | 102 | Lₐ₂₁ | L_{b31} |
| 103 | Lₐ₃₅ | L_{b31} | 104 | Lₐ₆₆ | L_{b31} |
| 105 | Lₐ₆₉ | L_{b31} | 106 | Lₐ₇₀ | L_{b31} |
| 107 | Lₐ₇₄ | L_{b31} | 108 | Lₐ₁₂₁ | L_{b31} |
| 109 | Lₐ₁₄₈ | L_{b31} | 110 | Lₐ₁₇₅ | L_{b31} |
| 111 | Lₐ₂₀₇ | L_{b31} | 112 | Lₐ₂₁₂ | L_{b31} |
| 113 | Lₐ₂₃₆ | L_{b31} | 114 | Lₐ₂₅₅ | L_{b31} |
| 115 | Lₐ₂₇₁ | L_{b31} | 116 | Lₐ₂₈₇ | L_{b31} |
| 117 | Lₐ₃₁₉ | L_{b31} | 118 | Lₐ₃₂₀ | L_{b31} |
| 119 | Lₐ₃₃₅ | L_{b31} | 120 | Lₐ₃₉₉ | L_{b31} |
| 121 | Lₐ₄₃₈ | L_{b31} | 122 | Lₐ₄₅₃ | L_{b31} |
| 123 | Lₐ₄₆₉ | L_{b31} | 124 | Lₐ₄₉₇ | L_{b31} |
| 125 | Lₐ₅₀₀ | L_{b31} | 126 | Lₐ₅₂₉ | L_{b31} |
| 127 | Lₐ₆₀₁ | L_{b31} | 128 | Lₐ₆₀₆ | L_{b31} |
| 129 | Lₐ₆₃₇ | L_{b31} | 130 | Lₐ₆₆₅ | L_{b31} |
| 131 | Lₐ₆₈₉ | L_{b31} | 132 | Lₐ₆₉₉ | L_{b31} |
| 133 | Lₐ₇₀₀ | L_{b31} | 134 | Lₐ₇₄₄ | L_{b31} |
| 135 | Lₐ₇₇₇ | L_{b31} | 136 | Lₐ₇₉₃ | L_{b31} |
| 137 | Lₐ₈₁₀ | L_{b31} | 138 | Lₐ₈₄₂ | L_{b31} |
| 139 | Lₐ₈₅₀ | L_{b31} | 140 | Lₐ₉₁₇ | L_{b31} |
| 141 | Lₐ₉₈₂ | L_{b31} | 142 | Lₐ₉₈₉ | L_{b31} |
| 143 | Lₐ₁₀₁₆ | L_{b31} | 144 | Lₐ₁₀₃₁ | L_{b31} |
| 145 | Lₐ₁₀₄₇ | L_{b31} | 146 | Lₐ₁₀₇₉ | L_{b31} |
| 147 | Lₐ₁₁₆₃ | L_{b31} | 148 | Lₐ₁₁₉₁ | L_{b31} |
| 149 | Lₐ₁₁₉₈ | L_{b31} | 150 | Lₐ₁₂₃₆ | L_{b31} |
| 151 | Lₐ₁₂₄₇ | L_{b31} | 152 | Lₐ₁₂₇₆ | L_{b31} |
| 153 | Lₐ₁₃₁₃ | L_{b31} | 154 | Lₐ₁₃₃₆ | L_{b31} |
| 155 | Lₐ₁₃₄₁ | _{Lb31} | 156 | Lₐ₁₃₆₄ | L_{b31} |
| 157 | Lₐ₁₃₉₅ | L_{b31} | 158 | Lₐ₁₄₃₇ | L_{b31} |
| 159 | Lₐ₁₄₅₄ | L_{b31} | 160 | Lₐ₁₄₅₅ | L_{b31} |
| 161 | Lₐ₁₄₈₀ | L_{b31} | 162 | Lₐ₁₄₈₇ | L_{b31} |
| 163 | Lₐ₁₄₉₂ | L_{b31} | 164 | Lₐ₁₅₁₀ | L_{b31} |
| 165 | Lₐ₁₅₂₃ | L_{b31} | 166 | Lₐ₁₅₃₁ | L_{b31} |
| 167 | Lₐ₁₅₇₁ | L_{b31} | 168 | Lₐ₁₅₉₁ | L_{b31} |
| 169 | Lₐ₁₆₀₈ | L_{b31} | 170 | Lₐ₁₆₀₉ | L_{b31} |
| 171 | Lₐ₁₆₂₉ | L_{b31} | 172 | Lₐ₁₆₃₀ | L_{b31} |
| 173 | Lₐ₁₆₃₈ | L_{b31} | 174 | Lₐ₁₆₈₈ | L_{b31} |
| 175 | Lₐ₁₇₀₂ | L_{b31} | 176 | Lₐ₁₇₁₇ | L_{b31} |
| 177 | Lₐ₁₇₂₃ | L_{b31} | 178 | Lₐ₁₇₅₃ | L_{b31} |
| 179 | Lₐ₁₇₆₁ | L_{b31} | 180 | Lₐ₁₈₁₃ | L_{b31} |
| 181 | Lₐ₁₈₁₅ | L_{b31} | 182 | Lₐ₁₈₁₉ | L_{b31} |
| 183 | Lₐ₁₈₂₃ | L_{b31} | 184 | Lₐ₁₈₂₉ | L_{b31} |
| 185 | Lₐ₁₈₃₃ | L_{b31} | 186 | Lₐ₁₈₃₉ | L_{b31} |
| 187 | Lₐ₁₈₄₃ | L_{b31} | 188 | Lₐ₁₈₄₉ | L_{b31} |
| 189 | Lₐ₁₈₅₃ | L_{b31} | 190 | Lₐ₁₈₅₅ | L_{b31} |
| 191 | Lₐ₁₈₅₉ | L_{b31} | 192 | Lₐ₁₈₆₃ | L_{b31} |
| 193 | Lₐ₁₈₆₅ | L_{b31} | 194 | Lₐ₁₈₆₉ | L_{b31} |
| 195 | Lₐ₁₈₇₃ | L_{b31} | 196 | Lₐ₁₈₇₅ | L_{b31} |
| 197 | Lₐ₁₈₇₉ | L_{b31} | 198 | Lₐ₁₈₈₃ | L_{b31} |
| 199 | Lₐ₁₈₈₅ | L_{b31} | 200 | Lₐ₁₈₈₉ | L_{b31} |
| 201 | Lₐ₅ | L_{b88} | 202 | Lₐ₂₁ | L_{b88} |
| 203 | Lₐ₃₅ | L_{b88} | 204 | Lₐ₆₆ | L_{b88} |
| 205 | Lₐ₆₉ | L_{b88} | 206 | Lₐ₇₀ | L_{b88} |
| 207 | Lₐ₇₄ | L_{b88} | 208 | Lₐ₁₂₁ | L_{b88} |
| 209 | Lₐ₁₄₈ | L_{b88} | 210 | Lₐ₁₇₅ | L_{b88} |
| 211 | Lₐ₂₀₇ | L_{b88} | 212 | Lₐ₂₁₂ | L_{b88} |
| 213 | Lₐ₂₃₆ | L_{b88} | 214 | Lₐ₂₅₅ | L_{b88} |
| 215 | Lₐ₂₇₁ | L_{b88} | 216 | Lₐ₂₈₇ | L_{b88} |
| 217 | Lₐ₃₁₉ | L_{b88} | 218 | Lₐ₃₂₀ | L_{b88} |
| 219 | Lₐ₃₃₅ | L_{b88} | 220 | Lₐ₃₉₉ | L_{b88} |
| 221 | Lₐ₄₃₈ | L_{b88} | 222 | Lₐ₄₅₃ | L_{b88} |
| 223 | Lₐ₄₆₉ | L_{b88} | 224 | Lₐ₄₉₇ | L_{b88} |
| 225 | Lₐ₅₀₀ | L_{b88} | 226 | Lₐ₅₂₉ | L_{b88} |
| 227 | Lₐ₆₀₁ | L_{b88} | 228 | Lₐ₆₀₆ | L_{b88} |
| 229 | Lₐ₆₃₇ | L_{b88} | 230 | Lₐ₆₆₅ | L_{b88} |
| 231 | Lₐ₆₈₉ | L_{b88} | 232 | Lₐ₆₉₉ | L_{b88} |
| 233 | Lₐ₇₀₀ | L_{b88} | 234 | Lₐ₇₄₄ | L_{b88} |
| 235 | Lₐ₇₇₇ | L_{b88} | 236 | Lₐ₇₉₃ | L_{b88} |
| 237 | Lₐ₈₁₀ | L_{b88} | 238 | Lₐ₈₄₂ | L_{b88} |
| 239 | Lₐ₈₅₀ | L_{b88} | 240 | Lₐ₉₁₇ | L_{b88} |
| 241 | Lₐ₉₈₂ | L_{b88} | 242 | Lₐ₉₈₉ | L_{b88} |
| 243 | Lₐ₁₀₁₆ | L_{b88} | 244 | Lₐ₁₀₃₁ | L_{b88} |
| 245 | Lₐ₁₀₄₇ | L_{b88} | 246 | Lₐ₁₀₇₉ | L_{b88} |
| 247 | Lₐ₁₁₆₃ | L_{b88} | 248 | Lₐ₁₁₉₁ | L_{b88} |
| 249 | Lₐ₁₁₉₈ | L_{b88} | 250 | Lₐ₁₂₃₆ | L_{b88} |
| 251 | Lₐ₁₂₄₇ | L_{b88} | 252 | Lₐ₁₂₇₆ | L_{b88} |
| 253 | Lₐ₁₃₁₃ | L_{b88} | 254 | Lₐ₁₃₃₆ | L_{b88} |
| 255 | Lₐ₁₃₄₁ | L_{b88} | 256 | Lₐ₁₃₆₄ | L_{b88} |
| 257 | Lₐ₁₃₉₅ | L_{b88} | 258 | Lₐ₁₄₃₇ | L_{b88} |
| 259 | Lₐ₁₄₅₄ | L_{b88} | 260 | Lₐ₁₄₅₅ | L_{b88} |
| 261 | Lₐ₁₄₈₀ | L_{b88} | 262 | Lₐ₁₄₈₇ | L_{b88} |
| 263 | Lₐ₁₄₉₂ | L_{b88} | 264 | Lₐ₁₅₁₀ | L_{b88} |
| 265 | Lₐ₁₅₂₃ | L_{b88} | 266 | Lₐ₁₅₃₁ | L_{b88} |
| 267 | Lₐ₁₅₇₁ | L_{b88} | 268 | Lₐ₁₅₉₁ | L_{b88} |
| 269 | Lₐ₁₆₀₈ | L_{b88} | 270 | Lₐ₁₆₀₉ | L_{b88} |
| 271 | Lₐ₁₆₂₉ | L_{b88} | 272 | Lₐ₁₆₃₀ | L_{b88} |
| 273 | Lₐ₁₆₃₈ | L_{b88} | 274 | Lₐ₁₆₈₈ | L_{b88} |
| 275 | Lₐ₁₇₀₂ | L_{b88} | 276 | Lₐ₁₇₁₇ | L_{b88} |
| 277 | Lₐ₁₇₂₃ | L_{b88} | 278 | Lₐ₁₇₅₃ | L_{b88} |
| 279 | Lₐ₁₇₆₁ | L_{b88} | 280 | Lₐ₁₈₁₃ | L_{b88} |
| 281 | Lₐ₁₈₁₅ | L_{b88} | 282 | Lₐ₁₈₁₉ | L_{b88} |
| 283 | Lₐ₁₈₂₃ | L_{b88} | 284 | Lₐ₁₈₂₉ | L_{b88} |
| 285 | Lₐ₁₈₃₃ | L_{b88} | 286 | Lₐ₁₈₃₉ | L_{b88} |
| 287 | Lₐ₁₈₄₃ | L_{b88} | 288 | Lₐ₁₈₄₉ | L_{b88} |
| 289 | Lₐ₁₈₅₃ | L_{b88} | 290 | Lₐ₁₈₅₅ | L_{b88} |
| 291 | Lₐ₁₈₅₉ | L_{b88} | 292 | Lₐ₁₈₆₃ | L_{b88} |
| 293 | Lₐ₁₈₆₅ | L_{b88} | 294 | Lₐ₁₈₆₉ | L_{b88} |
| 295 | Lₐ₁₈₇₃ | L_{b88} | 296 | Lₐ₁₈₇₅ | L_{b88} |
| 297 | Lₐ₁₈₇₉ | L_{b88} | 298 | Lₐ₁₈₈₃ | L_{b88} |
| 299 | Lₐ₁₈₈₅ | L_{b88} | 300 | Lₐ₁₈₈₉ | L_{b88} |
| 301 | Lₐ₅ | L_{b122} | 302 | Lₐ₂₁ | L_{b122} |
| 303 | Lₐ₃₅ | L_{b122} | 304 | Lₐ₆₆ | L_{b122} |
| 305 | Lₐ₆₉ | L_{b122} | 306 | Lₐ₇₀ | L_{b122} |
| 307 | Lₐ₇₄ | L_{b122} | 308 | Lₐ₁₂₁ | L_{b122} |
| 309 | Lₐ₁₄₈ | L_{b122} | 310 | Lₐ₁₇₅ | L_{b122} |
| 311 | Lₐ₂₀₇ | L_{b122} | 312 | Lₐ₂₁₂ | L_{b122} |
| 313 | Lₐ₂₃₆ | L_{b122} | 314 | Lₐ₂₅₅ | L_{b122} |
| 315 | Lₐ₂₇₁ | L_{b122} | 316 | Lₐ₂₈₇ | L_{b122} |
| 317 | Lₐ₃₁₉ | L_{b122} | 318 | Lₐ₃₂₀ | L_{b122} |
| 319 | Lₐ₃₃₅ | L_{b122} | 320 | Lₐ₃₉₉ | L_{b122} |
| 321 | Lₐ₄₃₈ | L_{b122} | 322 | Lₐ₄₅₃ | L_{b122} |
| 323 | Lₐ₄₆₉ | L_{b122} | 324 | Lₐ₄₉₇ | L_{b122} |
| 325 | Lₐ₅₀₀ | L_{b122} | 326 | Lₐ₅₂₉ | L_{b122} |
| 327 | Lₐ₆₀₁ | L_{b122} | 328 | Lₐ₆₀₆ | L_{b122} |
| 329 | Lₐ₆₃₇ | L_{b122} | 330 | Lₐ₆₆₅ | L_{b122} |
| 331 | Lₐ₆₈₉ | L_{b122} | 332 | Lₐ₆₉₉ | L_{b122} |
| 333 | Lₐ₇₀₀ | L_{b122} | 334 | Lₐ₇₄₄ | L_{b122} |
| 335 | Lₐ₇₇₇ | L_{b122} | 336 | Lₐ₇₉₃ | L_{b122} |
| 337 | Lₐ₈₁₀ | L_{b122} | 338 | Lₐ₈₄₂ | L_{b122} |
| 339 | Lₐ₈₅₀ | L_{b122} | 340 | Lₐ₉₁₇ | L_{b122} |
| 341 | Lₐ₉₈₂ | L_{b122} | 342 | Lₐ₉₈₉ | L_{b122} |
| 343 | Lₐ₁₀₁₆ | L_{b122} | 344 | Lₐ₁₀₃₁ | L_{b122} |
| 345 | Lₐ₁₀₄₇ | L_{b122} | 346 | Lₐ₁₀₇₉ | L_{b122} |
| 347 | Lₐ₁₁₆₃ | L_{b122} | 348 | Lₐ₁₁₉₁ | L_{b122} |
| 349 | Lₐ₁₁₉₈ | L_{b122} | 350 | Lₐ₁₂₃₆ | L_{b122} |
| 351 | Lₐ₁₂₄₇ | L_{b122} | 352 | Lₐ₁₂₇₆ | L_{b122} |
| 353 | Lₐ₁₃₁₃ | L_{b122} | 354 | Lₐ₁₃₃₆ | L_{b122} |
| 355 | Lₐ₁₃₄₁ | L_{b122} | 356 | Lₐ₁₃₆₄ | L_{b122} |
| 357 | Lₐ₁₃₉₅ | L_{b122} | 358 | Lₐ₁₄₃₇ | L_{b122} |
| 359 | Lₐ₁₄₅₄ | L_{b122} | 360 | Lₐ₁₄₅₅ | L_{b122} |
| 361 | Lₐ₁₄₈₀ | L_{b122} | 362 | Lₐ₁₄₈₇ | L_{b122} |
| 363 | Lₐ₁₄₉₂ | L_{b122} | 364 | Lₐ₁₅₁₀ | L_{b122} |
| 365 | Lₐ₁₅₂₃ | L_{b122} | 366 | Lₐ₁₅₃₁ | L_{b122} |
| 367 | Lₐ₁₅₇₁ | L_{b122} | 368 | Lₐ₁₅₉₁ | L_{b122} |
| 369 | Lₐ₁₆₀₈ | L_{b122} | 370 | Lₐ₁₆₀₉ | L_{b122} |
| 371 | Lₐ₁₆₂₉ | L_{b122} | 372 | Lₐ₁₆₃₀ | L_{b122} |
| 373 | Lₐ₁₆₃₈ | L_{b122} | 374 | Lₐ₁₆₈₈ | L_{b122} |
| 375 | Lₐ₁₇₀₂ | L_{b122} | 376 | Lₐ₁₇₁₇ | L_{b122} |
| 377 | Lₐ₁₇₂₃ | L_{b122} | 378 | Lₐ₁₇₅₃ | L_{b122} |
| 379 | Lₐ₁₇₆₁ | L_{b122} | 380 | Lₐ₁₈₁₃ | L_{b122} |
| 381 | Lₐ₁₈₁₅ | L_{b122} | 382 | Lₐ₁₈₁₉ | L_{b122} |
| 383 | Lₐ₁₈₂₃ | L_{b122} | 384 | Lₐ₁₈₂₉ | L_{b122} |
| 385 | Lₐ₁₈₃₃ | L_{b122} | 386 | Lₐ₁₈₃₉ | L_{b122} |
| 387 | Lₐ₁₈₄₃ | L_{b122} | 388 | Lₐ₁₈₄₉ | L_{b122} |
| 389 | Lₐ₁₈₅₃ | L_{b122} | 390 | Lₐ₁₈₅₅ | L_{b122} |
| 391 | Lₐ₁₈₅₉ | L_{b122} | 392 | Lₐ₁₈₆₃ | L_{b122} |
| 393 | Lₐ₁₈₆₅ | L_{b122} | 394 | Lₐ₁₈₆₉ | L_{b122} |
| 395 | Lₐ₁₈₇₃ | L_{b122} | 396 | Lₐ₁₈₇₅ | L_{b122} |
| 397 | Lₐ₁₈₇₉ | L_{b122} | 398 | Lₐ₁₈₈₃ | L_{b122} |
| 399 | Lₐ₁₈₈₅ | L_{b122} | 400 | Lₐ₁₈₈₉ | L_{b122} |
| 401 | Lₐ₅ | L_{b126} | 402 | Lₐ₂₁ | L_{b126} |
| 403 | Lₐ₃₅ | L_{b126} | 404 | Lₐ₆₆ | L_{b126} |
| 405 | Lₐ₆₉ | L_{b126} | 406 | Lₐ₇₀ | L_{b126} |
| 407 | Lₐ₇₄ | L_{b126} | 408 | Lₐ₁₂₁ | L_{b126} |
| 409 | Lₐ₁₄₈ | L_{b126} | 410 | Lₐ₁₇₅ | L_{b126} |
| 411 | Lₐ₂₀₇ | L_{b126} | 412 | Lₐ₂₁₂ | L_{b126} |
| 413 | Lₐ₂₃₆ | L_{b126} | 414 | Lₐ₂₅₅ | L_{b126} |
| 415 | Lₐ₂₇₁ | L_{b126} | 416 | Lₐ₂₈₇ | L_{b126} |
| 417 | Lₐ₃₁₉ | L_{b126} | 418 | Lₐ₃₂₀ | L_{b126} |
| 419 | Lₐ₃₃₅ | L_{b126} | 420 | Lₐ₃₉₉ | L_{b126} |
| 421 | Lₐ₄₃₈ | L_{b126} | 422 | Lₐ₄₅₃ | L_{b126} |
| 423 | Lₐ₄₆₉ | L_{b126} | 424 | Lₐ₄₉₇ | L_{b126} |
| 425 | Lₐ₅₀₀ | L_{b126} | 426 | Lₐ₅₂₉ | L_{b126} |
| 427 | Lₐ₆₀₁ | L_{b126} | 428 | Lₐ₆₀₆ | L_{b126} |
| 429 | Lₐ₆₃₇ | L_{b126} | 430 | Lₐ₆₆₅ | L_{b126} |
| 431 | Lₐ₆₈₉ | L_{b126} | 432 | Lₐ₆₉₉ | L_{b126} |
| 433 | Lₐ₇₀₀ | L_{b126} | 434 | Lₐ₇₄₄ | L_{b126} |
| 435 | Lₐ₇₇₇ | L_{b126} | 436 | Lₐ₇₉₃ | L_{b126} |
| 437 | Lₐ₈₁₀ | L_{b126} | 438 | Lₐ₈₄₂ | L_{b126} |
| 439 | Lₐ₈₅₀ | L_{b126} | 440 | Lₐ₉₁₇ | L_{b126} |
| 441 | Lₐ₉₈₂ | L_{b126} | 442 | Lₐ₉₈₉ | L_{b126} |
| 443 | Lₐ₁₀₁₆ | L_{b126} | 444 | Lₐ₁₀₃₁ | L_{b126} |
| 445 | Lₐ₁₀₄₇ | L_{b126} | 446 | Lₐ₁₀₇₉ | L_{b126} |
| 447 | Lₐ₁₁₆₃ | L_{b126} | 448 | Lₐ₁₁₉₁ | L_{b126} |
| 449 | Lₐ₁₁₉₈ | L_{b126} | 450 | Lₐ₁₂₃₆ | L_{b126} |
| 451 | Lₐ₁₂₄₇ | L_{b126} | 452 | Lₐ₁₂₇₆ | L_{b126} |
| 453 | Lₐ₁₃₁₃ | L_{b126} | 454 | Lₐ₁₃₃₆ | L_{b126} |
| 455 | Lₐ₁₃₄₁ | L_{b126} | 456 | Lₐ₁₃₆₄ | L_{b126} |
| 457 | Lₐ₁₃₉₅ | L_{b126} | 458 | Lₐ₁₄₃₇ | L_{b126} |
| 459 | Lₐ₁₄₅₄ | L_{b126} | 460 | Lₐ₁₄₅₅ | L_{b126} |
| 461 | Lₐ₁₄₈₀ | L_{b126} | 462 | Lₐ₁₄₈₇ | L_{b126} |
| 463 | Lₐ₁₄₉₂ | L_{b126} | 464 | Lₐ₁₅₁₀ | L_{b126} |
| 465 | Lₐ₁₅₂₃ | L_{b126} | 466 | Lₐ₁₅₃₁ | L_{b126} |
| 467 | Lₐ₁₅₇₁ | L_{b126} | 468 | Lₐ₁₅₉₁ | L_{b126} |
| 469 | Lₐ₁₆₀₈ | L_{b126} | 470 | Lₐ₁₆₀₉ | L_{b126} |
| 471 | Lₐ₁₆₂₉ | L_{b126} | 472 | Lₐ₁₆₃₀ | L_{b126} |
| 473 | Lₐ₁₆₃₈ | L_{b126} | 474 | Lₐ₁₆₈₈ | L_{b126} |
| 475 | Lₐ₁₇₀₂ | L_{b126} | 476 | Lₐ₁₇₁₇ | L_{b126} |
| 477 | Lₐ₁₇₂₃ | L_{b126} | 478 | Lₐ₁₇₅₃ | L_{b126} |
| 479 | Lₐ₁₇₆₁ | L_{b126} | 480 | Lₐ₁₈₁₃ | L_{b126} |
| 481 | Lₐ₁₈₁₅ | L_{b126} | 482 | Lₐ₁₈₁₉ | L_{b126} |
| 483 | Lₐ₁₈₂₃ | L_{b126} | 484 | Lₐ₁₈₂₉ | L_{b126} |
| 485 | Lₐ₁₈₃₃ | L_{b126} | 486 | Lₐ₁₈₃₉ | L_{b126} |
| 487 | Lₐ₁₈₄₃ | L_{b126} | 488 | Lₐ₁₈₄₉ | L_{b126} |
| 489 | Lₐ₁₈₅₃ | L_{b126} | 490 | Lₐ₁₈₅₅ | L_{b126} |
| 491 | Lₐ₁₈₅₉ | L_{b126} | 492 | Lₐ₁₈₆₃ | L_{b126} |
| 493 | Lₐ₁₈₆₅ | L_{b126} | 494 | Lₐ₁₈₆₉ | L_{b126} |
| 495 | Lₐ₁₈₇₃ | L_{b126} | 496 | Lₐ₁₈₇₅ | L_{b126} |
| 497 | Lₐ₁₈₇₉ | L_{b126} | 498 | Lₐ₁₈₈₃ | L_{b126} |
| 499 | Lₐ₁₈₈₅ | L_{b126} | 500 | Lₐ₁₈₈₉ | L_{b126} |
| 501 | Lₐ₅ | L_{b135} | 502 | Lₐ₂₁ | L_{b135} |
| 503 | Lₐ₃₅ | L_{b135} | 504 | Lₐ₆₆ | L_{b135} |
| 505 | Lₐ₆₉ | L_{b135} | 506 | Lₐ₇₀ | L_{b135} |
| 507 | Lₐ₇₄ | L_{b135} | 508 | Lₐ₁₂₁ | L_{b135} |
| 509 | Lₐ₁₄₈ | L_{b135} | 510 | Lₐ₁₇₅ | L_{b135} |
| 511 | Lₐ₂₀₇ | L_{b135} | 512 | Lₐ₂₁₂ | L_{b135} |
| 513 | Lₐ₂₃₆ | L_{b135} | 514 | Lₐ₂₅₅ | L_{b135} |
| 515 | Lₐ₂₇₁ | L_{b135} | 516 | Lₐ₂₈₇ | L_{b135} |
| 517 | Lₐ₃₁₉ | L_{b135} | 518 | Lₐ₃₂₀ | L_{b135} |
| 519 | Lₐ₃₃₅ | L_{b135} | 520 | Lₐ₃₉₉ | L_{b135} |
| 521 | Lₐ₄₃₈ | L_{b135} | 522 | Lₐ₄₅₃ | L_{b135} |
| 523 | Lₐ₄₆₉ | L_{b135} | 524 | Lₐ₄₉₇ | L_{b135} |
| 525 | Lₐ₅₀₀ | L_{b135} | 526 | Lₐ₅₂₉ | L_{b135} |
| 527 | Lₐ₆₀₁ | L_{b135} | 528 | Lₐ₆₀₆ | L_{b135} |
| 529 | Lₐ₆₃₇ | L_{b135} | 530 | Lₐ₆₆₅ | L_{b135} |
| 531 | Lₐ₆₈₉ | L_{b135} | 532 | Lₐ₆₉₉ | L_{b135} |
| 533 | Lₐ₇₀₀ | L_{b135} | 534 | Lₐ₇₄₄ | L_{b135} |
| 535 | Lₐ₇₇₇ | L_{b135} | 536 | Lₐ₇₉₃ | L_{b135} |
| 537 | Lₐ₈₁₀ | L_{b135} | 538 | Lₐ₈₄₂ | L_{b135} |
| 539 | Lₐ₈₅₀ | L_{b135} | 540 | Lₐ₉₁₇ | L_{b135} |
| 541 | Lₐ₉₈₂ | L_{b135} | 542 | Lₐ₉₈₉ | L_{b135} |
| 543 | Lₐ₁₀₁₆ | L_{b135} | 544 | Lₐ₁₀₃₁ | L_{b135} |
| 545 | Lₐ₁₀₄₇ | L_{b135} | 546 | Lₐ₁₀₇₉ | L_{b135} |
| 547 | Lₐ₁₁₆₃ | L_{b135} | 548 | Lₐ₁₁₉₁ | L_{b135} |
| 549 | Lₐ₁₁₉₈ | L_{b135} | 550 | Lₐ₁₂₃₆ | L_{b135} |
| 551 | Lₐ₁₂₄₇ | L_{b135} | 552 | Lₐ₁₂₇₆ | L_{b135} |
| 553 | Lₐ₁₃₁₃ | L_{b135} | 554 | Lₐ₁₃₃₆ | L_{b135} |
| 555 | Lₐ₁₃₄₁ | L_{b135} | 556 | Lₐ₁₃₆₄ | L_{b135} |
| 557 | Lₐ₁₃₉₅ | L_{b135} | 558 | Lₐ₁₄₃₇ | L_{b135} |
| 559 | Lₐ₁₄₅₄ | L_{b135} | 560 | Lₐ₁₄₅₅ | L_{b135} |
| 561 | Lₐ₁₄₈₀ | L_{b135} | 562 | Lₐ₁₄₈₇ | L_{b135} |
| 563 | Lₐ₁₄₉₂ | L_{b135} | 564 | Lₐ₁₅₁₀ | L_{b135} |
| 565 | Lₐ₁₅₂₃ | L_{b135} | 566 | Lₐ₁₅₃₁ | L_{b135} |
| 567 | Lₐ₁₅₇₁ | L_{b135} | 568 | Lₐ₁₅₉₁ | L_{b135} |
| 569 | Lₐ₁₆₀₈ | L_{b135} | 570 | Lₐ₁₆₀₉ | L_{b135} |
| 571 | Lₐ₁₆₂₉ | L_{b135} | 572 | Lₐ₁₆₃₀ | L_{b135} |
| 573 | Lₐ₁₆₃₈ | L_{b135} | 574 | Lₐ₁₆₈₈ | L_{b135} |
| 575 | Lₐ₁₇₀₂ | L_{b135} | 576 | Lₐ₁₇₁₇ | L_{b135} |
| 577 | Lₐ₁₇₂₃ | L_{b135} | 578 | Lₐ₁₇₅₃ | L_{b135} |
| 579 | Lₐ₁₇₆₁ | L_{b135} | 580 | Lₐ₁₈₁₃ | L_{b135} |
| 581 | Lₐ₁₈₁₅ | L_{b135} | 582 | Lₐ₁₈₁₉ | L_{b135} |
| 583 | Lₐ₁₈₂₃ | L_{b135} | 584 | Lₐ₁₈₂₉ | L_{b135} |
| 585 | Lₐ₁₈₃₃ | L_{b135} | 586 | Lₐ₁₈₃₉ | L_{b135} |
| 587 | Lₐ₁₈₄₃ | L_{b135} | 588 | Lₐ₁₈₄₉ | L_{b135} |
| 589 | Lₐ₁₈₅₃ | L_{b135} | 590 | Lₐ₁₈₅₅ | L_{b135} |
| 591 | Lₐ₁₈₅₉ | L_{b135} | 592 | Lₐ₁₈₆₃ | L_{b135} |
| 593 | Lₐ₁₈₆₅ | L_{b135} | 594 | Lₐ₁₈₆₉ | L_{b135} |
| 595 | Lₐ₁₈₇₃ | L_{b135} | 596 | Lₐ₁₈₇₅ | L_{b135} |
| 597 | Lₐ₁₈₇₉ | L_{b135} | 598 | Lₐ₁₈₈₃ | L_{b135} |
| 599 | Lₐ₁₈₈₅ | L_{b135} | 600 | Lₐ₁₈₈₉ | L_{b135} |
| 601 | Lₐ₅ | L_{b165} | 602 | Lₐ₂₁ | L_{b165} |
| 603 | Lₐ₃₅ | L_{b165} | 604 | Lₐ₆₆ | L_{b165} |
| 605 | Lₐ₆₉ | L_{b165} | 606 | Lₐ₇₀ | L_{b165} |
| 607 | Lₐ₇₄ | L_{b165} | 608 | Lₐ₁₂₁ | L_{b165} |
| 609 | Lₐ₁₄₈ | L_{b165} | 610 | Lₐ₁₇₅ | L_{b165} |
| 611 | Lₐ₂₀₇ | L_{b165} | 612 | Lₐ₂₁₂ | L_{b165} |
| 613 | Lₐ₂₃₆ | L_{b165} | 614 | Lₐ₂₅₅ | L_{b165} |
| 615 | Lₐ₂₇₁ | L_{b165} | 616 | Lₐ₂₈₇ | L_{b165} |
| 617 | Lₐ₃₁₉ | L_{b165} | 618 | Lₐ₃₂₀ | L_{b165} |
| 619 | Lₐ₃₃₅ | L_{b165} | 620 | Lₐ₃₉₉ | L_{b165} |
| 621 | Lₐ₄₃₈ | L_{b165} | 622 | Lₐ₄₅₃ | L_{b165} |
| 623 | Lₐ₄₆₉ | L_{b165} | 624 | Lₐ₄₉₇ | L_{b165} |
| 625 | Lₐ₅₀₀ | L_{b165} | 626 | Lₐ₅₂₉ | L_{b165} |
| 627 | Lₐ₆₀₁ | L_{b165} | 628 | Lₐ₆₀₆ | L_{b165} |
| 629 | Lₐ₆₃₇ | L_{b165} | 630 | Lₐ₆₆₅ | L_{b165} |
| 631 | Lₐ₆₈₉ | L_{b165} | 632 | Lₐ₆₉₉ | L_{b165} |
| 633 | Lₐ₇₀₀ | L_{b165} | 634 | Lₐ₇₄₄ | L_{b165} |
| 635 | Lₐ₇₇₇ | L_{b165} | 636 | Lₐ₇₉₃ | L_{b165} |
| 637 | Lₐ₈₁₀ | L_{b165} | 638 | Lₐ₈₄₂ | L_{b165} |
| 639 | Lₐ₈₅₀ | L_{b165} | 640 | Lₐ₉₁₇ | L_{b165} |
| 641 | Lₐ₉₈₂ | L_{b165} | 642 | Lₐ₉₈₉ | L_{b165} |
| 643 | Lₐ₁₀₁₆ | L_{b165} | 644 | Lₐ₁₀₃₁ | L_{b165} |
| 645 | Lₐ₁₀₄₇ | L_{b165} | 646 | Lₐ₁₀₇₉ | L_{b165} |
| 647 | Lₐ₁₁₆₃ | L_{b165} | 648 | Lₐ₁₁₉₁ | L_{b165} |
| 649 | Lₐ₁₁₉₈ | L_{b165} | 650 | Lₐ₁₂₃₆ | L_{b165} |
| 651 | Lₐ₁₂₄₇ | L_{b165} | 652 | Lₐ₁₂₇₆ | L_{b165} |
| 653 | Lₐ₁₃₁₃ | L_{b165} | 654 | Lₐ₁₃₃₆ | L_{b165} |
| 655 | Lₐ₁₃₄₁ | L_{b165} | 656 | Lₐ₁₃₆₄ | L_{b165} |
| 657 | Lₐ₁₃₉₅ | L_{b165} | 658 | Lₐ₁₄₃₇ | L_{b165} |
| 659 | Lₐ₁₄₅₄ | L_{b165} | 660 | Lₐ₁₄₅₅ | L_{b165} |
| 661 | Lₐ₁₄₈₀ | L_{b165} | 662 | Lₐ₁₄₈₇ | L_{b165} |
| 663 | Lₐ₁₄₉₂ | L_{b165} | 664 | Lₐ₁₅₁₀ | L_{b165} |
| 665 | Lₐ₁₅₂₃ | L_{b165} | 666 | Lₐ₁₅₃₁ | L_{b165} |
| 667 | Lₐ₁₅₇₁ | L_{b165} | 668 | Lₐ₁₅₉₁ | L_{b165} |
| 669 | Lₐ₁₆₀₈ | L_{b165} | 670 | Lₐ₁₆₀₉ | L_{b165} |
| 671 | Lₐ₁₆₂₉ | L_{b165} | 672 | Lₐ₁₆₃₀ | L_{b165} |
| 673 | Lₐ₁₆₃₈ | L_{b165} | 674 | Lₐ₁₆₈₈ | L_{b165} |
| 675 | Lₐ₁₇₀₂ | L_{b165} | 676 | Lₐ₁₇₁₇ | L_{b165} |
| 677 | Lₐ₁₇₂₃ | L_{b165} | 678 | Lₐ₁₇₅₃ | L_{b165} |
| 679 | Lₐ₁₇₆₁ | L_{b165} | 680 | Lₐ₁₈₁₃ | L_{b165} |
| 681 | Lₐ₁₈₁₅ | L_{b165} | 682 | Lₐ₁₈₁₉ | L_{b165} |
| 683 | Lₐ₁₈₂₃ | L_{b165} | 684 | Lₐ₁₈₂₉ | L_{b165} |
| 685 | Lₐ₁₈₃₃ | L_{b165} | 686 | Lₐ₁₈₃₉ | L_{b165} |
| 687 | Lₐ₁₈₄₃ | L_{b165} | 688 | Lₐ₁₈₄₉ | L_{b165} |
| 689 | Lₐ₁₈₅₃ | L_{b165} | 690 | Lₐ₁₈₅₅ | L_{b165} |
| 691 | Lₐ₁₈₅₉ | L_{b165} | 692 | Lₐ₁₈₆₃ | L_{b165} |
| 693 | Lₐ₁₈₆₅ | L_{b165} | 694 | Lₐ₁₈₆₉ | L_{b165} |
| 695 | Lₐ₁₈₇₃ | L_{b165} | 696 | Lₐ₁₈₇₅ | L_{b165} |
| 697 | Lₐ₁₈₇₉ | L_{b165} | 698 | Lₐ₁₈₈₃ | L_{b165} |
| 699 | Lₐ₁₈₈₅ | L_{b165} | 700 | Lₐ₁₈₈₉ | L_{b165} |
| 701 | Lₐ₅ | L_{b212} | 702 | Lₐ₂₁ | L_{b212} |
| 703 | Lₐ₃₅ | L_{b212} | 704 | Lₐ₆₆ | L_{b212} |
| 705 | Lₐ₆₉ | L_{b212} | 706 | Lₐ₇₀ | L_{b212} |
| 707 | Lₐ₇₄ | L_{b212} | 708 | Lₐ₁₂₁ | L_{b212} |
| 709 | Lₐ₁₄₈ | L_{b212} | 710 | Lₐ₁₇₅ | L_{b212} |
| 711 | Lₐ₂₀₇ | L_{b212} | 712 | Lₐ₂₁₂ | L_{b212} |
| 713 | Lₐ₂₃₆ | L_{b212} | 714 | Lₐ₂₅₅ | L_{b212} |
| 715 | Lₐ₂₇₁ | L_{b212} | 716 | Lₐ₂₈₇ | L_{b212} |
| 717 | Lₐ₃₁₉ | L_{b212} | 718 | Lₐ₃₂₀ | L_{b212} |
| 719 | Lₐ₃₃₅ | L_{b212} | 720 | Lₐ₃₉₉ | L_{b212} |
| 721 | Lₐ₄₃₈ | L_{b212} | 722 | Lₐ₄₅₃ | L_{b212} |
| 723 | Lₐ₄₆₉ | L_{b212} | 724 | Lₐ₄₉₇ | L_{b212} |
| 725 | Lₐ₅₀₀ | L_{b212} | 726 | Lₐ₅₂₉ | L_{b212} |
| 727 | Lₐ₆₀₁ | L_{b212} | 728 | Lₐ₆₀₆ | L_{b212} |
| 729 | Lₐ₆₃₇ | L_{b212} | 730 | Lₐ₆₆₅ | L_{b212} |
| 731 | Lₐ₆₈₉ | L_{b212} | 732 | Lₐ₆₉₉ | L_{b212} |
| 733 | Lₐ₇₀₀ | L_{b212} | 734 | Lₐ₇₄₄ | L_{b212} |
| 735 | Lₐ₇₇₇ | L_{b212} | 736 | Lₐ₇₉₃ | L_{b212} |
| 737 | Lₐ₈₁₀ | L_{b212} | 738 | Lₐ₈₄₂ | L_{b212} |
| 739 | Lₐ₈₅₀ | L_{b212} | 740 | Lₐ₉₁₇ | L_{b212} |
| 741 | Lₐ₉₈₂ | L_{b212} | 742 | Lₐ₉₈₉ | L_{b212} |
| 743 | Lₐ₁₀₁₆ | L_{b212} | 744 | Lₐ₁₀₃₁ | L_{b212} |
| 745 | Lₐ₁₀₄₇ | L_{b212} | 746 | Lₐ₁₀₇₉ | L_{b212} |
| 747 | Lₐ₁₁₆₃ | L_{b212} | 748 | Lₐ₁₁₉₁ | L_{b212} |
| 749 | Lₐ₁₁₉₈ | L_{b212} | 750 | Lₐ₁₂₃₆ | L_{b212} |
| 751 | Lₐ₁₂₄₇ | L_{b212} | 752 | Lₐ₁₂₇₆ | L_{b212} |
| 753 | Lₐ₁₃₁₃ | L_{b212} | 754 | Lₐ₁₃₃₆ | L_{b212} |
| 755 | Lₐ₁₃₄₁ | L_{b212} | 756 | Lₐ₁₃₆₄ | L_{b212} |
| 757 | Lₐ₁₃₉₅ | L_{b212} | 758 | Lₐ₁₄₃₇ | L_{b212} |
| 759 | Lₐ₁₄₅₄ | L_{b212} | 760 | Lₐ₁₄₅₅ | L_{b212} |
| 761 | Lₐ₁₄₈₀ | L_{b212} | 762 | Lₐ₁₄₈₇ | L_{b212} |
| 763 | Lₐ₁₄₉₂ | L_{b212} | 764 | Lₐ₁₅₁₀ | L_{b212} |
| 765 | Lₐ₁₅₂₃ | L_{b212} | 766 | Lₐ₁₅₃₁ | L_{b212} |
| 767 | Lₐ₁₅₇₁ | L_{b212} | 768 | Lₐ₁₅₉₁ | L_{b212} |
| 769 | Lₐ₁₆₀₈ | L_{b212} | 770 | Lₐ₁₆₀₉ | L_{b212} |
| 771 | Lₐ₁₆₂₉ | L_{b212} | 772 | Lₐ₁₆₃₀ | L_{b212} |
| 773 | Lₐ₁₆₃₈ | L_{b212} | 774 | Lₐ₁₆₈₈ | L_{b212} |
| 775 | Lₐ₁₇₀₂ | L_{b212} | 776 | Lₐ₁₇₁₇ | L_{b212} |
| 777 | Lₐ₁₇₂₃ | L_{b212} | 778 | Lₐ₁₇₅₃ | L_{b212} |
| 779 | Lₐ₁₇₆₁ | L_{b212} | 780 | Lₐ₁₈₁₃ | L_{b212} |
| 781 | Lₐ₁₈₁₅ | L_{b212} | 782 | Lₐ₁₈₁₉ | L_{b212} |
| 783 | Lₐ₁₈₂₃ | L_{b212} | 784 | Lₐ₁₈₂₉ | L_{b212} |
| 785 | Lₐ₁₈₃₃ | L_{b212} | 786 | Lₐ₁₈₃₉ | L_{b212} |
| 787 | Lₐ₁₈₄₃ | L_{b212} | 788 | Lₐ₁₈₄₉ | L_{b212} |
| 789 | Lₐ₁₈₅₃ | L_{b212} | 790 | Lₐ₁₈₅₅ | L_{b212} |
| 791 | Lₐ₁₈₅₉ | L_{b212} | 792 | Lₐ₁₈₆₃ | L_{b212} |
| 793 | Lₐ₁₈₆₅ | L_{b212} | 794 | Lₐ₁₈₆₉ | L_{b212} |
| 795 | Lₐ₁₈₇₃ | L_{b212} | 796 | Lₐ₁₈₇₅ | L_{b212} |
| 797 | Lₐ₁₈₇₉ | L_{b212} | 798 | Lₐ₁₈₈₃ | L_{b212} |
| 799 | Lₐ₁₈₈₅ | L_{b212} | 800 | Lₐ₁₈₈₉ | L_{b212} |
; dans lequel les composés 801 à 1010 ont chacun une structure de type Ir(Lₐ)₂(L_{b}), où les deux Lₐ sont différents et les deux Lₐ et L_{b} sont respectivement choisis parmi les structures listées dans le tableau suivant :
| Composé n°. | Lₐ | Lₐ | L_{b} | Composé n°. | Lₐ | Lₐ | L_{b} |
|---|---|---|---|---|---|---|---|
| 801 | Lₐ₉₈₂ | Lₐ₆₉ | L_{b31} | 802 | Lₐ₉₈₂ | Lₐ₂₀₇ | L_{b31} |
| 803 | Lₐ₉₈₂ | Lₐ₃₁₉ | L_{b31} | 804 | Lₐ₉₈₂ | Lₐ₃₉₉ | L_{b31} |
| 805 | Lₐ₉₈₂ | Lₐ₈₄₂ | L_{b31} | 806 | Lₐ₉₈₂ | Lₐ₁₄₃₇ | L_{b31} |
| 807 | Lₐ₉₈₂ | Lₐ₁₅₇₁ | L_{b31} | 808 | Lₐ₉₈₂ | Lₐ₁₆₈₈ | L_{b31} |
| 809 | Lₐ₉₈₂ | Lₐ₉₈₉ | L_{b31} | 810 | Lₐ₉₈₂ | Lₐ₁₈₁₃ | L_{b31} |
| 811 | Lₐ₉₈₂ | Lₐ₈₄₂ | L_{b31} | 812 | Lₐ₁₈₈₉ | Lₐ₁₈₁₉ | L_{b31} |
| 813 | Lₐ₉₈₂ | Lₐ₁₈₄₉ | L_{b31} | 814 | Lₐ₉₈₂ | Lₐ₁₈₆₅ | L_{b31} |
| 815 | Lₐ₉₈₂ | Lₐ₁₈₇₅ | L_{b31} | 816 | Lₐ₃₁₉ | Lₐ₁₈₆₉ | L_{b31} |
| 817 | Lₐ₂₁₂ | Lₐ₁₅₇₁ | L_{b31} | 818 | Lₐ₁₆₈₈ | Lₐ₁₈₆₅ | L_{b31} |
| 819 | Lₐ₁₄₃₇ | Lₐ₁₈₂₉ | L_{b31} | 820 | Lₐ₁₈₆₅ | Lₐ₁₈₈₅ | L_{b31} |
| 821 | Lₐ₁₅₇₁ | Lₐ₁₈₅₅ | L_{b31} | 822 | Lₐ₉₈₉ | Lₐ₁₈₇₃ | L_{b31} |
| 823 | Lₐ₈₄₂ | Lₐ₁₃₈₄ | L_{b31} | 824 | Lₐ₁₈₃₃ | Lₐ₁₈₈₉ | L_{b31} |
| 825 | Lₐ₁₈₆₉ | Lₐ₂₄ | L_{b31} | 826 | Lₐ₁₈₈₉ | Lₐ₁₃₄ | L_{b31} |
| 827 | Lₐ₁₄₃₇ | Lₐ₂₁₂ | L_{b31} | 828 | Lₐ₁₄₃₇ | Lₐ₂₀₇ | L_{b31} |
| 829 | Lₐ₁₈₁₉ | Lₐ₁₈₂₃ | L_{b31} | 830 | Lₐ₁₈₆₃ | Lₐ₁₈₆₅ | L_{b31} |
| 831 | Lₐ₉₈₂ | Lₐ₆₉ | L_{b88} | 832 | Lₐ₉₈₂ | Lₐ₂₀₇ | L_{b88} |
| 833 | Lₐ₉₈₂ | Lₐ₃₁₉ | L_{b88} | 834 | Lₐ₉₈₂ | Lₐ₃₉₉ | L_{b88} |
| 835 | Lₐ₉₈₂ | Lₐ₈₄₂ | L_{b88} | 836 | Lₐ₉₈₂ | Lₐ₁₄₃₇ | L_{b88} |
| 837 | Lₐ₉₈₂ | Lₐ₁₅₇₁ | L_{b88} | 838 | Lₐ₉₈₂ | Lₐ₁₆₈₈ | L_{b88} |
| 839 | Lₐ₉₈₂ | Lₐ₉₈₉ | L_{b88} | 840 | Lₐ₉₈₂ | Lₐ₁₈₁₃ | L_{b88} |
| 841 | Lₐ₉₈₂ | Lₐ₈₄₂ | L_{b88} | 842 | Lₐ₁₈₈₉ | Lₐ₁₈₁₉ | L_{b88} |
| 843 | Lₐ₉₈₂ | Lₐ₁₈₄₉ | L_{b88} | 844 | Lₐ₉₈₂ | Lₐ₁₈₆₅ | L_{b88} |
| 845 | Lₐ₉₈₂ | Lₐ₁₈₇₅ | L_{b88} | 846 | Lₐ₃₁₉ | Lₐ₁₈₆₉ | L_{b88} |
| 847 | Lₐ₂₁₂ | Lₐ₁₅₇₁ | L_{b88} | 848 | Lₐ₁₆₈₈ | Lₐ₁₈₆₅ | L_{b88} |
| 849 | Lₐ₁₄₃₇ | Lₐ₁₈₂₉ | L_{b88} | 850 | Lₐ₁₈₆₅ | Lₐ₁₈₈₅ | L_{b88} |
| 851 | Lₐ₁₅₇₁ | Lₐ₁₈₅₅ | L_{b88} | 852 | Lₐ₉₈₉ | Lₐ₁₈₇₃ | L_{b88} |
| 853 | Lₐ₈₄₂ | Lₐ₁₃₈₄ | L_{b88} | 854 | Lₐ₁₈₃₃ | Lₐ₁₈₈₉ | L_{b88} |
| 855 | Lₐ₁₈₆₉ | Lₐ₂₄ | L_{b88} | 856 | Lₐ₁₈₈₉ | Lₐ₁₃₄ | L_{b88} |
| 857 | Lₐ₁₄₃₇ | Lₐ₂₁₂ | L_{b88} | 858 | Lₐ₁₄₃₇ | Lₐ₂₀₇ | L_{b88} |
| 859 | Lₐ₁₈₁₉ | Lₐ₁₈₂₃ | L_{b88} | 860 | Lₐ₁₈₆₃ | Lₐ₁₈₆₅ | L_{b88} |
| 861 | Lₐ₉₈₂ | Lₐ₆₉ | L_{b122} | 862 | Lₐ₉₈₂ | Lₐ₂₀₇ | L_{b122} |
| 863 | Lₐ₉₈₂ | Lₐ₃₁₉ | L_{b122} | 864 | Lₐ₉₈₂ | Lₐ₃₉₉ | L_{b122} |
| 865 | Lₐ₉₈₂ | Lₐ₈₄₂ | L_{b122} | 866 | Lₐ₉₈₂ | Lₐ₁₄₃₇ | L_{b122} |
| 867 | Lₐ₉₈₂ | Lₐ₁₅₇₁ | L_{b122} | 868 | Lₐ₉₈₂ | Lₐ₁₆₈₈ | L_{b122} |
| 869 | Lₐ₉₈₂ | Lₐ₉₈₉ | L_{b122} | 870 | Lₐ₉₈₂ | Lₐ₁₈₁₃ | L_{b122} |
| 871 | Lₐ₉₈₂ | Lₐ₈₄₂ | L_{b122} | 872 | Lₐ₁₈₈₉ | Lₐ₁₈₁₉ | L_{b122} |
| 873 | Lₐ₉₈₂ | Lₐ₁₈₄₉ | L_{b122} | 874 | Lₐ₉₈₂ | Lₐ₁₈₆₅ | L_{b122} |
| 875 | Lₐ₉₈₂ | Lₐ₁₈₇₅ | L_{b122} | 876 | Lₐ₃₁₉ | Lₐ₁₈₆₉ | L_{b122} |
| 877 | Lₐ₂₁₂ | Lₐ₁₅₇₁ | L_{b122} | 878 | Lₐ₁₆₈₈ | Lₐ₁₈₆₅ | L_{b122} |
| 879 | Lₐ₁₄₃₇ | Lₐ₁₈₂₉ | L_{b122} | 880 | Lₐ₁₈₆₅ | Lₐ₁₈₈₅ | L_{b122} |
| 881 | Lₐ₁₅₇₁ | Lₐ₁₈₅₅ | L_{b122} | 882 | Lₐ₉₈₉ | Lₐ₁₈₇₃ | L_{b122} |
| 883 | Lₐ₈₄₂ | Lₐ₁₃₈₄ | L_{b122} | 884 | Lₐ₁₈₃₃ | Lₐ₁₈₈₉ | L_{b122} |
| 885 | Lₐ₁₈₆₉ | Lₐ₂₄ | L_{b122} | 886 | Lₐ₁₈₈₉ | Lₐ₁₃₄ | L_{b122} |
| 887 | Lₐ₁₄₃₇ | Lₐ₂₁₂ | L_{b122} | 888 | Lₐ₁₄₃₇ | Lₐ₂₀₇ | L_{b122} |
| 889 | Lₐ₁₈₁₉ | Lₐ₁₈₂₃ | L_{b122} | 890 | Lₐ₁₈₆₃ | Lₐ₁₈₆₅ | L_{b122} |
| 891 | Lₐ₉₈₂ | Lₐ₆₉ | L_{b126} | 892 | Lₐ₉₈₂ | Lₐ₂₀₇ | L_{b126} |
| 893 | Lₐ₉₈₂ | Lₐ₃₁₉ | L_{b126} | 894 | Lₐ₉₈₂ | Lₐ₃₉₉ | L_{b126} |
| 895 | Lₐ₉₈₂ | Lₐ₈₄₂ | L_{b126} | 896 | Lₐ₉₈₂ | Lₐ₁₄₃₇ | L_{b126} |
| 897 | Lₐ₉₈₂ | Lₐ₁₅₇₁ | L_{b126} | 898 | Lₐ₉₈₂ | Lₐ₁₆₈₈ | L_{b126} |
| 899 | Lₐ₉₈₂ | Lₐ₉₈₉ | L_{b126} | 900 | Lₐ₉₈₂ | Lₐ₁₈₁₃ | L_{b126} |
| 901 | Lₐ₉₈₂ | Lₐ₈₄₂ | L_{b126} | 902 | Lₐ₁₈₈₉ | Lₐ₁₈₁₉ | L_{b126} |
| 903 | Lₐ₉₈₂ | Lₐ₁₈₄₉ | L_{b126} | 904 | Lₐ₉₈₂ | Lₐ₁₈₆₅ | L_{b126} |
| 905 | Lₐ₉₈₂ | Lₐ₁₈₇₅ | L_{b126} | 906 | Lₐ₃₁₉ | Lₐ₁₈₆₉ | L_{b126} |
| 907 | Lₐ₂₁₂ | Lₐ₁₅₇₁ | L_{b126} | 908 | Lₐ₁₆₈₈ | Lₐ₁₈₆₅ | L_{b126} |
| 909 | Lₐ₁₄₃₇ | Lₐ₁₈₂₉ | L_{b126} | 910 | Lₐ₁₈₆₅ | Lₐ₁₈₈₅ | L_{b126} |
| 911 | Lₐ₁₅₇₁ | Lₐ₁₈₅₅ | L_{b126} | 912 | Lₐ₉₈₉ | Lₐ₁₈₇₃ | L_{b126} |
| 913 | Lₐ₈₄₂ | Lₐ₁₃₈₄ | L_{b126} | 914 | Lₐ₁₈₃₃ | _{La1889} | L_{b126} |
| 915 | Lₐ₁₈₆₉ | Lₐ₂₄ | L_{b126} | 916 | Lₐ₁₈₈₉ | Lₐ₁₃₄ | L_{b126} |
| 917 | Lₐ₁₄₃₇ | Lₐ₂₁₂ | L_{b126} | 918 | Lₐ₁₄₃₇ | Lₐ₂₀₇ | L_{b126} |
| 919 | Lₐ₁₈₁₉ | Lₐ₁₈₂₃ | L_{b126} | 920 | Lₐ₁₈₆₃ | Lₐ₁₈₆₅ | L_{b126} |
| 921 | Lₐ₉₈₂ | Lₐ₆₉ | L_{b135} | 922 | Lₐ₉₈₂ | Lₐ₂₀₇ | L_{b135} |
| 923 | Lₐ₉₈₂ | Lₐ₃₁₉ | L_{b135} | 924 | Lₐ₉₈₂ | Lₐ₃₉₉ | L_{b135} |
| 925 | Lₐ₉₈₂ | Lₐ₈₄₂ | L_{b135} | 926 | Lₐ₉₈₂ | Lₐ₁₄₃₇ | L_{b135} |
| 927 | Lₐ₉₈₂ | Lₐ₁₅₇₁ | L_{b135} | 928 | Lₐ₉₈₂ | Lₐ₁₆₈₈ | L_{b135} |
| 929 | Lₐ₉₈₂ | Lₐ₉₈₉ | L_{b135} | 930 | Lₐ₉₈₂ | Lₐ₁₈₁₃ | L_{b135} |
| 931 | Lₐ₉₈₂ | Lₐ₈₄₂ | L_{b135} | 932 | Lₐ₁₈₈₉ | Lₐ₁₈₁₉ | L_{b135} |
| 933 | Lₐ₉₈₂ | Lₐ₁₈₄₉ | L_{b135} | 934 | Lₐ₉₈₂ | Lₐ₁₈₆₅ | L_{b135} |
| 935 | Lₐ₉₈₂ | Lₐ₁₈₇₅ | L_{b135} | 936 | Lₐ₃₁₉ | Lₐ₁₈₆₉ | L_{b135} |
| 937 | Lₐ₂₁₂ | Lₐ₁₅₇₁ | L_{b135} | 938 | Lₐ₁₆₈₈ | Lₐ₁₈₆₅ | L_{b135} |
| 939 | Lₐ₁₄₃₇ | Lₐ₁₈₂₉ | L_{b135} | 940 | Lₐ₁₈₆₅ | Lₐ₁₈₈₅ | L_{b135} |
| 941 | Lₐ₁₅₇₁ | Lₐ₁₈₅₅ | L_{b135} | 942 | Lₐ₉₈₉ | Lₐ₁₈₇₃ | L_{b135} |
| 943 | Lₐ₈₄₂ | Lₐ₁₃₈₄ | L_{b135} | 944 | Lₐ₁₈₃₃ | Lₐ₁₈₈₉ | L_{b135} |
| 945 | Lₐ₁₈₆₉ | Lₐ₂₄ | L_{b135} | 946 | Lₐ₁₈₈₉ | Lₐ₁₃₄ | L_{b135} |
| 947 | Lₐ₁₄₃₇ | Lₐ₂₁₂ | L_{b135} | 948 | Lₐ₁₄₃₇ | Lₐ₂₀₇ | L_{b135} |
| 949 | Lₐ₁₈₁₉ | Lₐ₁₈₂₃ | L_{b135} | 950 | Lₐ₁₈₆₃ | Lₐ₁₈₆₅ | L_{b135} |
| 951 | Lₐ₉₈₂ | Lₐ₆₉ | L_{b165} | 952 | Lₐ₉₈₂ | Lₐ₂₀₇ | L_{b165} |
| 953 | Lₐ₉₈₂ | Lₐ₃₁₉ | L_{b165} | 954 | Lₐ₉₈₂ | Lₐ₃₉₉ | L_{b165} |
| 955 | Lₐ₉₈₂ | Lₐ₈₄₂ | L_{b165} | 956 | Lₐ₉₈₂ | Lₐ₁₄₃₇ | L_{b165} |
| 957 | Lₐ₉₈₂ | Lₐ₁₅₇₁ | L_{b165} | 958 | Lₐ₉₈₂ | Lₐ₁₆₈₈ | L_{b165} |
| 959 | Lₐ₉₈₂ | Lₐ₉₈₉ | L_{b165} | 960 | Lₐ₉₈₂ | Lₐ₁₈₁₃ | L_{b165} |
| 961 | Lₐ₉₈₂ | Lₐ₈₄₂ | L_{b165} | 962 | Lₐ₁₈₈₉ | Lₐ₁₈₁₉ | L_{b165} |
| 963 | Lₐ₉₈₂ | Lₐ₁₈₄₉ | L_{b165} | 964 | Lₐ₉₈₂ | Lₐ₁₈₆₅ | L_{b165} |
| 965 | Lₐ₉₈₂ | Lₐ₁₈₇₅ | L_{b165} | 966 | Lₐ₃₁₉ | Lₐ₁₈₆₉ | L_{b165} |
| 967 | Lₐ₂₁₂ | Lₐ₁₅₇₁ | L_{b165} | 968 | Lₐ₁₆₈₈ | Lₐ₁₈₆₅ | L_{b165} |
| 969 | Lₐ₁₄₃₇ | Lₐ₁₈₂₉ | L_{b165} | 970 | Lₐ₁₈₆₅ | Lₐ₁₈₈₅ | L_{b165} |
| 971 | Lₐ₁₅₇₁ | Lₐ₁₈₅₅ | L_{b165} | 972 | Lₐ₉₈₉ | Lₐ₁₈₇₃ | L_{b165} |
| 973 | Lₐ₈₄₂ | Lₐ₁₃₈₄ | L_{b165} | 974 | Lₐ₁₈₃₃ | Lₐ₁₈₈₉ | L_{b165} |
| 975 | Lₐ₁₈₆₉ | Lₐ₂₄ | L_{b165} | 976 | Lₐ₁₈₈₉ | Lₐ₁₃₄ | L_{b165} |
| 977 | Lₐ₁₄₃₇ | Lₐ₂₁₂ | L_{b165} | 978 | Lₐ₁₄₃₇ | Lₐ₂₀₇ | L_{b165} |
| 979 | Lₐ₁₈₁₉ | Lₐ₁₈₂₃ | L_{b165} | 980 | Lₐ₁₈₆₃ | Lₐ₁₈₆₅ | L_{b165} |
| 981 | Lₐ₉₈₂ | Lₐ₆₉ | L_{b212} | 982 | Lₐ₉₈₂ | Lₐ₂₀₇ | L_{b212} |
| 983 | Lₐ₉₈₂ | Lₐ₃₁₉ | L_{b212} | 984 | Lₐ₉₈₂ | Lₐ₃₉₉ | L_{b212} |
| 985 | Lₐ₉₈₂ | Lₐ₈₄₂ | L_{b212} | 986 | Lₐ₉₈₂ | Lₐ₁₄₃₇ | L_{b212} |
| 987 | Lₐ₉₈₂ | Lₐ₁₅₇₁ | L_{b212} | 988 | Lₐ₉₈₂ | Lₐ₁₆₈₈ | L_{b212} |
| 989 | Lₐ₉₈₂ | Lₐ₉₈₉ | L_{b212} | 990 | Lₐ₉₈₂ | Lₐ₁₈₁₃ | L_{b212} |
| 991 | Lₐ₉₈₂ | Lₐ₈₄₂ | L_{b212} | 992 | Lₐ₁₈₈₉ | Lₐ₁₈₁₉ | L_{b212} |
| 993 | Lₐ₉₈₂ | Lₐ₁₈₄₉ | L_{b212} | 994 | Lₐ₉₈₂ | Lₐ₁₈₆₅ | L_{b212} |
| 995 | Lₐ₉₈₂ | Lₐ₁₈₇₅ | L_{b212} | 996 | Lₐ₃₁₉ | Lₐ₁₈₆₉ | L_{b212} |
| 997 | Lₐ₂₁₂ | Lₐ₁₅₇₁ | L_{b212} | 998 | Lₐ₁₆₈₈ | Lₐ₁₈₆₅ | L_{b212} |
| 999 | Lₐ₁₄₃₇ | Lₐ₁₈₂₉ | L_{b212} | 1000 | Lₐ₁₈₆₅ | Lₐ₁₈₈₅ | L_{b212} |
| 1001 | Lₐ₁₅₇₁ | Lₐ₁₈₈₅ | L_{b212} | 1002 | Lₐ₉₈₉ | Lₐ₁₈₇₃ | L_{b212} |
| 1003 | Lₐ₈₄₂ | Lₐ₁₃₈₄ | L_{b212} | 1004 | Lₐ₁₈₃₃ | Lₐ₁₈₈₉ | L_{b212} |
| 1005 | Lₐ₁₈₆₉ | Lₐ₂₄ | L_{b212} | 1006 | Lₐ₁₈₈₉ | Lₐ₁₃₄ | L_{b212} |
| 1007 | Lₐ₁₄₃₇ | Lₐ₂₁₂ | L_{b212} | 1008 | Lₐ₁₄₃₇ | Lₐ₂₀₇ | L_{b212} |
| 1009 | Lₐ₁₈₁₉ | Lₐ₁₈₂₃ | L_{b212} | 1010 | Lₐ₁₈₆₃ | Lₐ₁₈₆₅ | L_{b212} |

15. Dispositif électroluminescent, comprenant :
une anode,
une cathode et
une couche organique disposée entre l'anode et la cathode, dans lequel la couche organique comprend le complexe métallique selon l'une quelconque des revendications 1 à 14 ;
préférentiellement, la couche organique est une couche émettrice de lumière et le complexe métallique est un matériau émetteur de lumière ;
préférentiellement, le dispositif électroluminescent émet de la lumière rouge ou de la lumière blanche ;
plus préférentiellement, l'au moins un matériau hôte comprend au moins un groupe chimique choisi parmi le groupe constitué de : benzène, pyridine, pyrimidine, triazine, carbazole, azacarbazole, indolocarbazole, dibenzothiophène, aza-dibenzothiophène, dibenzofurane, azadibenzofurane, dibenzosélénophène, triphénylène, azatriphénylène, fluorène, silafluorène, naphtalène, quinoléine, isoquinoléine, quinazoline, quinoxaline, phénanthrène, azaphénanthrène et des combinaisons de ceux-ci.

16. Combinaison de composés, comprenant le complexe métallique selon l'une quelconque des revendications 1 à 14.
